# EUROPEAN PATENT APPLICATION

(11) **EP 4 477 656 A2**
(43) Date of publication of application: **18.12.2024**
(21) Application number: 24177268.0
(22) Date of filing: 22.05.2024
(51) Int. Cl.: C07F 15/00, C09K 11/06, H10K 85/30

(54) **ORGANIC ELECTROLUMINESCENT MATERIALS AND DEVICES**

(30) Priority: 26.05.2023 US 202363504507 P; 24.07.2023 US 202363515210 P; 15.08.2023 US 202318449951; 28.08.2023 US 202318457006; 29.08.2023 US 202318239358; 30.08.2023 US 202363579652 P; 23.10.2023 US 202363592426 P; 06.12.2023 US 202363606898 P; 13.12.2023 US 202318537854; 31.01.2024 US 202463627131 P; 02.04.2024 US 202463573092 P; 11.04.2024 US 202463632798 P; 25.04.2024 US 202463638792 P; 08.05.2024 US 202418657918; 08.05.2024 US 202418657900; 17.05.2024 US 202418666935
(71) Applicant: Universal Display Corporation, Ewing, NJ 08618 (US)
(72) Inventor: SHIH, Wei-Chun, Ewing, NJ, 08618 (US); DYATKIN, Alexey Borisovich, Ewing, NJ, 08618 (US); WENDT, Harvey, Ewing, NJ, 08618 (US); YEAGER, Walter, Ewing, NJ, 08618 (US); COLE, Marcus, Ewing, NJ, 08618 (US); FLEETHAM, Tyler, Ewing, NJ, 08618 (US); BOUDREAULT, Pierre-Luc T, Ewing, NJ, 08618 (US); JI, Zhiqiang, Ewing, NJ, 08618 (US)
(74) Representative: Maiwald GmbH

(57) **Abstract**

A compound having a formula of Ir(L_{A})ₙ(L_{B})ₘ(L_{C})ₒ, wherein first ligand L_{A} comprises a structure of Formula I, 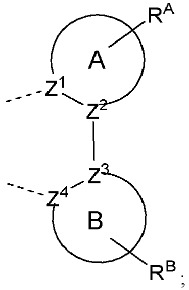 L_{B} comprises a structure of Formula IIA, 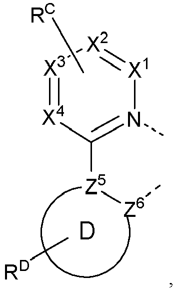 or Formula IIB, 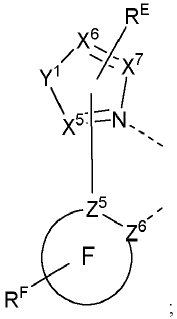 and Lc is a bidentate ligand. In these structures, n is 1 or 2, m is 1 or 2, o is 0 or 1, and m + n + o = 3; each of moiety A, moiety D, and moiety F is a monocyclic ring or polycyclic fused ring system; moiety B is a polycyclic fused ring system; each of Z¹ to Z⁶ and X¹ to X⁷ is C or N; Y¹ is O, S, Se, Te, P, Si, and Ge; and each R^{A}, R^{B}, R^{C}, R^{D}, R^{E}, and R^{F} is hydrogen or a General Substituent. Formulations, OLEDs, and consumer products containing the compound are also provided.

## Description

### CROSS-REFERENCE TO RELATED APPLICATIONS

This application is a continuation-in-part of United States patent Applications No. 18/537,854, filed on December 13, 2023, No. 18/239,358, filed on August 29, 2023, No. 18/457,006, filed on August 28, 2023, and No. 18/449,951, filed on August 15, 2023, No. 18/657,918, filed on May 8, 2024, and No. 18/657,900, filed on May 8, 2024, the entire contents of which are incorporated herein by reference. This application also claims priority under 35 U.S.C. § 119(e) to United States Provisional Applications No. 63/638,792, filed on April 25, 2024, No. 63/632,798, filed on April 11, 2024, No. 63/573,092, filed on April 2, 2024, No. 63/627,131, filed on January 31, 2024, No. 63/606,898, filed on December 6, 2023, No. 63/592,426, filed on October 23, 2023, No. 63/579,652, filed on August 30, 2023, No. 63/515,210, filed on July 24, 2023, and No. 63/504,507, filed on May 26, 2023, the entire contents of which are incorporated herein by reference.

### FIELD

The present disclosure generally relates to organic or metal coordination compounds and formulations and their various uses including as emitters, sensitizers, charge transporters, or exciton transporters in devices such as organic light emitting diodes and related electronic devices and consumer products.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, organic scintillators, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as displays, illumination, and backlighting.

One application for emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

### SUMMARY

In one aspect, the present disclosure provides a compound having a formula of Ir(L_{A})ₙ(L_{B})ₘ(L_{C})ₒ, wherein first ligand L_{A} comprises a structure of Formula I, 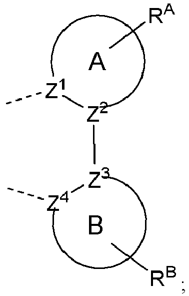 L_{B} comprises a structure of Formula IIA, 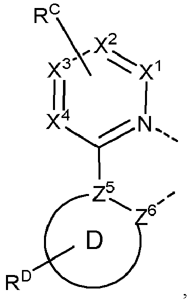 or Formula IIB, 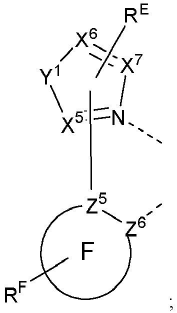 and Lc is a bidentate ligand. In these structures:
n is 1 or 2, m is 1 or 2, o is 0 or 1, and m + n + o = 3;
each of moiety A, moiety D, and moiety F is independently a monocyclic ring or a polycyclic fused ring system, wherein the monocyclic ring or each ring of the polycyclic fused ring system is independently a 5-membered to 10-membered carbocyclic or heterocyclic ring;
moiety B is a polycyclic fused ring system, wherein each ring of moiety B is independently a 5-membered to 10-membered carbocyclic or heterocyclic ring;
each of Z¹ to Z⁶ and X¹ to X⁷ is independently C or N;
Y¹ is selected from the group consisting of O, S, Se, Te, P, Si, and Ge;
each of R^{A}, R^{B}, R^{C}, R^{D}, R^{E}, and R^{F} independently represents mono to the maximum allowable substitutions, or no substitutions;
each R^{A}, R^{B}, R^{C}, R^{D}, R^{E}, and R^{F} is independently hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and any two substituents may be joined or fused to form a ring;

provided that
   (1) when L_{B} has a structure of Formula IIA and moiety D is a monocyclic 6-membered aromatic ring, then at least one of X¹ , X², X³, and X⁴ is N; and
   (2) the compound is not 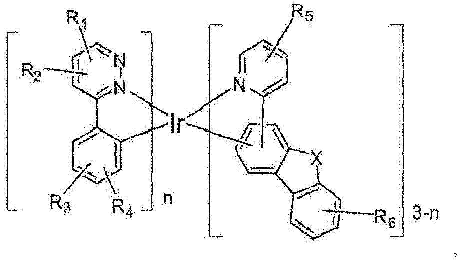 where each of R₁ to R₈ is independently H, alkyl, or aryl; X is N, O, S, or C₁ to C₄-alkyl; and no two of R₁ to R₈ are joined or fused to form a ring.

In another aspect, the present disclosure provides a formulation comprising a compound having a first ligand L_{A} comprising a structure of Formula I as described herein.

In yet another aspect, the present disclosure provides an OLED having an organic layer comprising a compound having a first ligand L_{A} comprising a structure of Formula I as described herein.

In yet another aspect, the present disclosure provides a consumer product comprising an OLED with an organic layer comprising a compound having a first ligand L_{A} comprising a structure of Formula I as described herein.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

### A. Terminology

Unless otherwise specified, the below terms used herein are defined as follows:

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

Layers, materials, regions, and devices may be described herein in reference to the color of light they emit. In general, as used herein, an emissive region that is described as producing a specific color of light may include one or more emissive layers disposed over each other in a stack.

As used herein, a "NIR", "red", "green", "blue", "yellow" layer, material, region, or device refers to a layer, a material, a region, or a device that emits light in the wavelength range of about 700-1500 nm, 580-700 nm, 500-600 nm, 400-500 nm, 540-600 nm, respectively, or a layer, a material, a region, or a device that has a highest peak in its emission spectrum in the respective wavelength region. In some arrangements, separate regions, layers, materials, or devices may provide separate "deep blue" and "light blue" emissions. As used herein, the "deep blue" emission component refers to an emission having a peak emission wavelength that is at least about 4 nm less than the peak emission wavelength of the "light blue" emission component. Typically, a "light blue" emission component has a peak emission wavelength in the range of about 465-500 nm, and a "deep blue" emission component has a peak emission wavelength in the range of about 400-470 nm, though these ranges may vary for some configurations.

In some arrangements, a color altering layer that converts, modifies, or shifts the color of the light emitted by another layer to an emission having a different wavelength is provided. Such a color altering layer can be formulated to shift wavelength of the light emitted by the other layer by a defined amount, as measured by the difference in the wavelength of the emitted light and the wavelength of the resulting light. In general, there are two classes of color altering layers: color filters that modify a spectrum by removing light of unwanted wavelengths, and color changing layers that convert photons of higher energy to lower energy. For example, a "red" color filter can be present in order to filter an input light to remove light having a wavelength outside the range of about 580-700 nm. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material, region, or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| **Color** | **CIE Shape Parameters** |
|---|---|
| Central Red | Locus: [0.6270,0.3725];[0.7347,0.2653]; |
| | Interior: [0.5086,0.2657] |
| Central Green | Locus: [0.0326,0.3530];[0.3731,0.6245]; |
| | Interior: [0.2268,0.3321 |
| Central Blue | Locus: [0.1746,0.0052];[0.0326,0.3530]; |
| | Interior: [0.2268,0.3321] |
| Central Yellow | Locus: [0.3731,0.6245];[0.6270,0.3725]; |
| | Interior: [0.3700,0.4087];[0.2886,0.4572] |

The terms "halo," "halogen," and "halide" are used interchangeably and refer to fluorine, chlorine, bromine, and iodine.

The term "acyl" refers to a substituted carbonyl group (-C(O)-Rₛ).

The term "ester" refers to a substituted oxycarbonyl (-O-C(O)-Rₛ or -C(O)-O-Rₛ) group.

The term "ether" refers to an -ORₛ group.

The terms "sulfanyl" or "thio-ether" are used interchangeably and refer to a -SRₛ group.

The term "selenyl" refers to a -SeRₛ group.

The term "sulfinyl" refers to a -S(O)-Rₛ group.

The term "sulfonyl" refers to a -SO₂-Rₛ group.

The term "phosphino" refers to a group containing at least one phosphorus atom bonded to the relevant structure. Common examples of phosphino groups include, but are not limited to, groups such as a -P(Rₛ)₂ group or a -PO(Rₛ)₂ group, wherein each Rₛ can be same or different.

The term "silyl" refers to a group containing at least one silicon atom bonded to the relevant structure. Common examples of silyl groups include, but are not limited to, groups such as a -Si(Rₛ)₃ group, wherein each Rₛ can be same or different.

The term "germyl" refers to a group containing at least one germanium atom bonded to the relevant structure. Common examples of germyl groups include, but are not limited to, groups such as a -Ge(Rₛ)₃ group, wherein each Rₛ can be same or different.

The term "boryl" refers to a group containing at least one boron atom bonded to the relevant structure. Common examples of boryl groups include, but are not limited to, groups such as a -B(Rₛ)₂ group or its Lewis adduct -B(Rₛ)₃ group, wherein Rₛ can be same or different.

In each of the above, Rₛ can be hydrogen or a substituent selected from the group consisting of the general substituents as defined in this application. Preferred Rₛ is selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. More preferably Rₛ is selected from the group consisting of alkyl, cycloalkyl, aryl, heteroaryl, and combination thereof.

The term "alkyl" refers to and includes both straight and branched chain alkyl groups having an alkyl carbon atom bonded to the relevant structure. Preferred alkyl groups are those containing from one to fifteen carbon atoms, preferably one to nine carbon atoms, and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group can be further substituted.

The term "cycloalkyl" refers to and includes monocyclic, polycyclic, and spiro alkyl groups having a ring alkyl carbon atom bonded to the relevant structure. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group can be further substituted.

The terms "heteroalkyl" or "heterocycloalkyl" refer to an alkyl or a cycloalkyl group, respectively, having at least one carbon atom replaced by a heteroatom. Optionally the at least one heteroatom is selected from O, S, N, P, B, Si, Ge and Se, preferably, O, S or N. Additionally, the heteroalkyl or heterocycloalkyl group can be further substituted.

The term "alkenyl" refers to and includes both straight and branched chain alkene groups. Alkenyl groups are essentially alkyl groups that include at least one carbon-carbon double bond in the alkyl chain with one carbon atom from the carbon-carbon double bond that is bonded to the relevant structure. Cycloalkenyl groups are essentially cycloalkyl groups that include at least one carbon-carbon double bond in the cycloalkyl ring. The term "heteroalkenyl" as used herein refers to an alkenyl group having at least one carbon atom replaced by a heteroatom. Optionally the at least one heteroatom is selected from O, S, N, P, B, Si, Ge, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group can be further substituted.

The term "alkynyl" refers to and includes both straight and branched chain alkyne groups. Alkynyl groups are essentially alkyl groups that include at least one carbon-carbon triple bond in the alkyl chain with one carbon atom from the carbon-carbon triple bond that is bonded to the relevant structure. Preferred alkynyl groups are those containing two to fifteen carbon atoms. Additionally, the alkynyl group can be further substituted.

The terms "aralkyl" or "arylalkyl" are used interchangeably and refer to an aryl-substituted alkyl group having an alkyl carbon atom bonded to the relevant structure. Additionally, the aralkyl group can be further substituted.

The term "heterocyclic group" refers to and includes aromatic and non-aromatic cyclic groups containing at least one heteroatom. Optionally the at least one heteroatom is selected from O, S, Se, N, P, B, Si, Ge, and Se, preferably, O, S, N, or B. Hetero-aromatic cyclic groups may be used interchangeably with heteroaryl. Preferred hetero-non-aromatic cyclic groups are those containing 3 to 10 ring atoms, preferably those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be further substituted or fused.

The term "aryl" refers to and includes both single-ring and polycyclic aromatic hydrocarbyl groups. The polycyclic rings may have two or more rings in which two carbons are common to two adjoining rings (the rings are "fused"). Preferred aryl groups are those containing six to thirty carbon atoms, preferably six to twenty-four carbon atoms, six to eighteen carbon atoms, and more preferably six to twelve carbon atoms. Especially preferred is an aryl group having six carbons, ten carbons, twelve carbons, fourteen carbons, or eighteen carbons. Suitable aryl groups include phenyl, biphenyl, triphenyl, triphenylene, tetraphenylene, naphthalene, anthracene, phenalene, phenanthrene, pyrene, chrysene, perylene, and azulene, preferably phenyl, biphenyl, triphenyl, triphenylene, and naphthalene. Additionally, the aryl group can be further substituted or fused, such as, without limitation, fluorene.

The term "heteroaryl" refers to and includes both single-ring aromatic groups and polycyclic aromatic ring systems that include at least one heteroatom. The heteroatoms include, but are not limited to O, S, Se, N, P, B, Si, Ge, and Se. In many instances, O, S, N, or B are the preferred heteroatoms. Hetero-single ring aromatic systems are preferably single rings with 5 or 6 ring atoms, and the ring can have from one to six heteroatoms. The hetero-polycyclic ring systems can have two or more aromatic rings in which two atoms are common to two adjoining rings (the rings are "fused") wherein at least one of the rings is a heteroaryl. The hetero-polycyclic aromatic ring systems can have from one to six heteroatoms per ring of the polycyclic aromatic ring system. Preferred heteroaryl groups are those containing three to thirty carbon atoms, preferably three to twenty-four carbon atoms, three to eighteen carbon atoms, and more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, selenophenodipyridine, azaborine, borazine, 5l²,9l²-diaza-13b-boranaphtho[2,3,4-*de*]anthracene, 5λ²-benzo[*d*]benzo[4,5]imidazo[3,2-*a*]imidazole, and 5,9-dioxa-13b-boranaphtho[3,2,1-*de*]anthracene; preferably dibenzothiophene, dibenzofuran, dibenzoselenophene, carbazole, indolocarbazole, imidazole, pyridine, triazine, benzimidazole, 5l²,9l²-diaza-13b-boranaphtho[2,3,4-*de*]anthracene, 5λ²-benzo[*d*]benzo[4,5]imidazo[3,2-*a*]imidazole, and 5,9-dioxa-13b-boranaphtho[3,2,1-*de*]anthracene. Additionally, the heteroaryl group can be further substituted or fused.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, benzimidazole, 5l²,9l²-diaza-13b-boranaphtho[2,3,4-*de*]anthracene, 5λ²-benzo[*d*]benzo[4,5]imidazo[3,2-*a*]imidazole, 5,9-dioxa-13b-boranaphtho[3,2,1-*de*]anthracene, and the respective aza-analogs of each thereof are of particular interest.

In many instances, the General Substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the Preferred General Substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the More Preferred General Substituents are selected from the group consisting of deuterium, fluorine, alkyl, cycloalkyl, alkoxy, aryloxy, amino, silyl, germyl, boryl, aryl, heteroaryl, nitrile, sulfanyl, and combinations thereof.

In some instances, the Even More Preferred General Substituents are selected from the group consisting of deuterium, fluorine, alkyl, cycloalkyl, silyl, aryl, heteroaryl, nitrile, and combinations thereof.

In yet other instances, the Most Preferred General Substituents are selected from the group consisting of deuterium, alkyl, cycloalkyl, aryl, heteroaryl, and combinations thereof.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for all available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

As used herein, any specifically listed substituent, such as, without limitation, methyl, phenyl, pyridyl, etc. includes undeuterated, partially deuterated, and fully deuterated versions thereof. Similarly, classes of substituents such as, without limitation, alkyl, aryl, cycloalkyl, heteroaryl, etc. also include undeuterated, partially deuterated, and fully deuterated versions thereof. Unless otherwise specified, atoms in chemical structures without valences fully filled by H or D should be considered to include undeuterated, partially deuterated, and fully deuterated versions thereof. For example, the chemical structure of 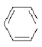 implies to include C₆H₆, C₆D₆, C₆H₃D₃, and any other partially deuterated variants thereof. Some common basic partially or fully deuterated group include, without limitation, CD₃, CD₂C(CH₃)₃, C(CD₃)₃, and C₆D₅.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instances, a pair of substituents in the molecule can be optionally joined or fused into a ring. The preferred ring is a five to nine-membered carbocyclic or heterocyclic ring, includes both instances where the portion of the ring formed by the pair of substituents is saturated and where the portion of the ring formed by the pair of substituents is unsaturated. In yet other instances, a pair of adjacent substituents can be optionally joined or fused into a ring. As used herein, "adjacent" means that the two substituents involved can be on the same ring next to each other, or on two neighboring rings having the two closest available substitutable positions, such as 2, 2' positions in a biphenyl, or 1, 8 position in a naphthalene.

### B. The Compounds of the Present Disclosure

The metal complexes disclosed herein comprise an uncommon ancillary ligand are disclosed. Such complexes exhibit saturated color in the photoluminescent and electroluminescent spectra. A saturated color is crucial for obtaining high efficiency in an OLED device.

In one aspect, the present disclosure provides a compound having a formula of Ir(L_{A})ₙ(L_{B})ₘ(L_{C})ₒ, wherein first ligand L_{A} comprises a structure of Formula I, 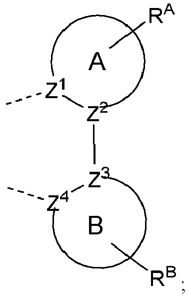 L_{B} comprises a structure of Formula IIA, 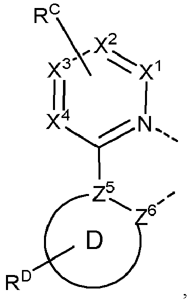 or Formula IIB, 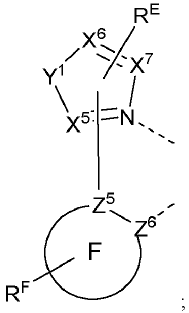 and Lc is a bidentate ligand. In these structures:
n is 1 or 2, m is 1 or 2, o is 0 or 1, and m + n + o = 3;
each of moiety A, moiety D, and moiety F is independently a monocyclic ring or a polycyclic fused ring system, wherein the monocyclic ring or each ring of the polycyclic fused ring system is independently a 5-membered to 10-membered carbocyclic or heterocyclic ring;
moiety B is a polycyclic fused ring system, wherein each ring of moiety B is independently a 5-membered to 10-membered carbocyclic or heterocyclic ring;
each of Z¹ to Z⁶ and X¹ to X⁷ is independently C or N;
Y¹ is selected from the group consisting of O, S, Se, Te, P, Si, and Ge;
each of R^{A}, R^{B}, R^{C}, R^{D}, R^{E}, and R^{F} independently represents mono to the maximum allowable substitutions, or no substitutions;
each R^{A}, R^{B}, R^{C}, R^{D}, R^{E}, and R^{F} is independently hydrogen or a substituent selected from the group consisting of the General Substituents defined herein; and
any two substituents may be joined or fused to form a ring.

In some embodiments, if L_{B} has a structure of Formula IIA and moiety D is a monocyclic 6-membered aromatic ring, then at least one of X¹, X², X³, and X⁴ is N. In some embodiments, L_{B} has a structure of Formula IIA, moiety D is a monocyclic 6-membered aromatic ring, and at least one of X¹, X², X³, and X⁴ is N.

In some embodiments, the compound is not 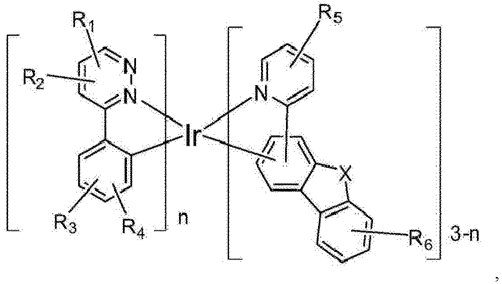 where each of R₁ to R₈ is independently H, alkyl, or aryl; X is N, O, S, or C₁ to C₄-alkyl; and no two of R₁ to R₈ are joined or fused to form a ring.

In some embodiments, L_{A} has a structure of Formula I. In some embodiments, L_{A} consists essentially of Formula I.

In some embodiments, L_{B} has a structure of Formula IIA. In some embodiments, L_{A} consists essentially of Formula IIA.

In some embodiments, L_{B} has a structure of Formula IIB. In some embodiments, L_{A} consists essentially of Formula IIB.

In some embodiments, at least one R^{A}, R^{B}, R^{C}, R^{D}, R^{E}, and R^{F} is partially or fully deuterated. In some embodiments, at least one R^{A} is partially or fully deuterated. In some embodiments, at least one R^{B} is partially or fully deuterated. In some embodiments, at least one R^{C} is partially or fully deuterated. In some embodiments, at least one R^{D} is partially or fully deuterated. In some embodiments, at least one R^{E} is partially or fully deuterated. In some embodiments, at least one R^{F} is partially or fully deuterated.

In some embodiments, each of moieties A and D is independently a monocyclic ring or a polycyclic fused ring system, wherein the monocyclic ring or each ring of the polycyclic fused ring system is independently a 5-membered or 6-membered carbocyclic or heterocyclic ring.

In some embodiments, each of moieties A and D is independently a monocyclic ring or a polycyclic fused ring system, wherein the monocyclic ring or each ring of the polycyclic fused ring system is independently a 5-membered or 6-membered aryl or heteroaryl ring.

In some embodiments, moiety B is a polycyclic fused ring system, wherein each ring of moiety B is independently a 5-membered or 6-membered carbocyclic or heterocyclic ring.

In some embodiments, moiety B is a polycyclic fused ring system, wherein each ring of moiety B is independently a 5-membered or 6-membered aryl or heteroaryl ring.

In some embodiments, when L_{B} has a structure of Formula IIA, each of X¹ , X², X³, and X⁴ is carbon, and moiety D is a bicyclic fused ring system consisting of a 6-membered aromatic ring fused to a 5-membered ring wherein the 6-membered ring is the ring chelating to the metal.

In some embodiments, when L_{B} has a structure of Formula IIA, moiety D is a bicyclic fused ring system consisting of a 6-membered aromatic ring fused to a 5-membered ring wherein the 6-membered ring is the ring chelating to the metal, and at least one of X¹ , X², X³, and X⁴ is nitrogen. In some such embodiments, exactly one of X¹, X², X³, and X⁴ is nitrogen.

In some embodiments, if L_{B} has a structure of Formula IIA and moiety D is not a bicyclic fused ring system consisting of a 6-membered aromatic ring fused to a 5 membered ring, then at least one of X¹ , X², X³, and X⁴ is N. In some embodiments, L_{B} has a structure of Formula IIA, moiety D is not a bicyclic fused ring system consisting of a 6-membered aromatic ring fused to a 5 membered ring, and at least one of X¹, X², X³, and X⁴ is N.

In some embodiments, each R^{A}, R^{B}, R^{C}, R^{D}, R^{E}, and R^{F} is independently hydrogen or a substituent selected from the group consisting of the Preferred General Substituents defined herein. In some embodiments, each R^{A}, R^{B}, R^{C}, R^{D}, R^{E}, and R^{F} is independently hydrogen or a substituent selected from the group consisting of the More Preferred General Substituents defined herein. In some embodiments, each R^{A}, R^{B}, R^{C}, R^{D}, R^{E}, and R^{F} is independently hydrogen or a substituent selected from the group consisting of the Most Preferred General Substituents defined herein.

In some embodiments, moiety A is selected from the group consisting of the structures in the following Cyclic Moiety List: benzene, pyridine, pyrimidine, pyridazine, pyrazine, triazine, imidazole, imidazole derived carbene, pyrazole, pyrrole, oxazole, furan, thiophene, thiazole, triazole, naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene. In some embodiments, the aza variant includes one N on a benzo ring. In some embodiments, the aza variant includes one N on a benzo ring and the N is coordinated to the Ir atom.

In some embodiments, moiety A is a monocyclic ring. In some embodiments, moiety A is selected from the group consisting of benzene, pyridine, pyrimidine, pyridazine, pyrazine, triazine, imidazole, imidazole derived carbene, pyrazole, pyrrole, oxazole, furan, thiophene, thiazole, and triazole.

In some embodiments, moiety A is pyridine, pyrimidine, pyridazine, pyrazine, triazine, or imidazole. In some embodiments, moiety A is pyridine. In some embodiments, moiety A is pyrimidine. In some embodiments, moiety A is pyridazine. In some embodiments, moiety A is pyrazine. In some embodiments, moiety A is triazine. In some embodiments, moiety A is imidazole.

In some embodiments, moiety A is a polycyclic fused ring system. In some embodiments, moiety A is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

In some embodiments, moiety A is quinoline, isoquinoline, quinazoline, quinoxaline, or benzimidazole. In some embodiments, moiety A is quinoline. In some embodiments, moiety A is isoquinoline. In some embodiments, moiety A is quinazoline. In some embodiments, moiety A is quinoxaline. In some embodiments, moiety A is benzimidazole.

In some embodiments, moiety B comprises at least three rings fused together. In some embodiments, moiety B comprises at least 4 rings fused together. In some embodiments, moiety B comprises at least 5 rings fused together]

In some embodiments, moiety B is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene. In some embodiments, moiety B is naphthalene, dibenzofuran, aza-dibenzofuran. In some embodiments, moiety B is naphthalene. In some embodiments, moiety B is dibenzofuran. In some embodiments, moiety B is aza-dibenzofuran.

In some embodiments, moiety B comprises moiety B1 annulated by moiety B2, wherein moiety B1 comprising the ring containing Z⁴; wherein each of moiety B1 and moiety B2 is independently selected from the group consisting of the Cyclic Moiety List defined herein.

In some embodiments, moiety B1 is dibenzofuran.

In some embodiments, moiety B2 is benzene, oxazole, or naphthalene. In some embodiments, moiety B2 is benzene. In some embodiments, moiety B2 is oxazole. In some embodiments, moiety B2 is naphthalene.

In some embodiments, the ring containing Z⁴ is benzene.

In some embodiments, Z¹ is N and each of Z², Z³, and Z⁴ is C. In some embodiments, Z² is N and each of Z¹, Z³, and Z⁴ is C.

In some embodiments, Z⁵ and Z⁶ are C. In some embodiments, Z⁵ is N and Z⁶ is C.

In some embodiments, the ring containing Z¹ has at least 2 nitrogen ring atoms. In some embodiments, the ring containing Z¹ has at least 3 nitrogen ring atoms.

In some embodiments, L_{B} comprises a structure of Formula IIA.

In some embodiments where L_{B} comprises a structure of Formula IIA, moiety D is selected from the group consisting of the Cyclic Moiety List defined herein.

In some embodiments where L_{B} comprises a structure of Formula IIA, moiety D is a monocyclic ring. In some embodiments where L_{B} comprises a structure of Formula IIA, moiety D is selected from the group consisting of benzene, pyridine, pyrimidine, pyridazine, pyrazine, triazine, imidazole, imidazole derived carbene, pyrazole, pyrrole, oxazole, furan, thiophene, thiazole, and triazole. In some embodiments, moiety D is benzene.

In some embodiment where L_{B} comprises a structure of Formula IIA, moiety D is a polycyclic fused ring system. In some such embodiments, moiety D is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

In some embodiment where L_{B} comprises a structure of Formula IIA, moiety D is benzofuran, benzothiophene, benzothiazole, benzoxazole, or dibenzofuran. In some such embodiments, moiety D is benzofuran. In some embodiments, moiety D is benzothiophene. In some embodiments, moiety D is benzothiazole. In some embodiments, moiety D is benzoxazole. In some embodiments, moiety D is dibenzofuran.

In some embodiments, at least one of moiety A, moiety B, moiety D, and moiety F can independently be a polycyclic fused ring structure. In some embodiments, at least one of moiety A, moiety B, moiety D, and moiety F can independently be a polycyclic fused ring structure comprising at least two fused rings. In some embodiments, the polycyclic fused ring structure has one 6-membered ring and one 5-membered ring. In some such embodiments, either the 5-membered ring or the 6-membered ring can coordinate to the Ir atom. In some embodiments, the polycyclic fused ring structure has two 6-membered rings. In some embodiments, at least one of moiety A, moiety B, moiety D, and moiety F can independently be selected from the group consisting of benzofuran, benzothiophene, benzoselenophene, naphthalene, and aza-variants thereof.

In some embodiments, at least one of moiety A, moiety B, moiety D, and moiety F can independently be a polycyclic fused ring structure comprising at least three fused rings. In some embodiments, the polycyclic fused ring structure has two 6-membered rings and one 5-membered ring. In some such embodiments, the 5-membered ring is fused to the ring coordinated to the Ir atom and the second 6-membered ring is fused to the 5-membered ring. In some embodiments, at least one of moiety A, moiety B, moiety D, and moiety F can independently be selected from the group consisting of dibenzofuran, dibenzothiophene, dibenzoselenophene, and aza-variants thereof. In some such embodiments, at least one of moiety A, moiety B, moiety D, and moiety F can independently be further substituted at the ortho- or meta-position of the O, S, or Se atom by a substituent selected from the group consisting of deuterium, fluorine, nitrile, alkyl, cycloalkyl, aryl, heteroaryl, and combinations thereof. In some such embodiments, the aza-variants contain exactly one N atom at the 6-position (ortho to the O, S, or Se) with a substituent at the 7-position (meta to the O, S, or Se).

In some embodiments, at least one of moiety A, moiety B, moiety D, and moiety F can independently be a polycyclic fused ring structure comprising at least four fused rings. In some embodiments, the polycyclic fused ring structure comprises three 6-membered rings and one 5-membered ring. In some such embodiments, the 5-membered ring is fused to the ring coordinated to the Ir atom, the second 6-membered ring is fused to the 5-membered ring, and the third 6-membered ring is fused to the second 6-membered ring. In some such embodiments, the third 6-membered ring is further substituted by a substituent selected from the group consisting of deuterium, fluorine, nitrile, alkyl, cycloalkyl, aryl, heteroaryl, and combinations thereof.

In some embodiments, at least one of moiety A, moiety B, moiety D, and moiety F can independently be a polycyclic fused ring structure comprising at least five fused rings. In some embodiments, the polycyclic fused ring structure comprises four 6-membered rings and one 5-membered ring or three 6-membered rings and two 5-membered rings. In some embodiments comprising two 5-membered rings, the 5-membered rings are fused together. In some embodiments comprising two 5-membered rings, the 5-membered rings are separated by at least one 6-membered ring. In some embodiments with one 5-membered ring, the 5-membered ring is fused to the ring coordinated to the Ir atom, the second 6-membered ring is fused to the 5-membered ring, the third 6-membered ring is fused to the second 6-membered ring, and the fourth 6-membered ring is fused to the third 6-membered ring.

In some embodiments, at least one of moiety A, moiety B, moiety D, and moiety F can independently be an aza version of the polycyclic fused rings described above. In some such embodiments, at least one of moiety A, moiety B, moiety D, and moiety F can independently contain exactly one aza N atom. In some such embodiments, at least one of moiety A, moiety B, moiety D, and moiety F contains exactly two aza N atoms, which can be in one ring, or in two different rings. In some such embodiments, the ring having aza N atom is separated by at least two other rings from the Ir atom. In some such embodiments, the ring having aza N atom is separated by at least three other rings from the Ir atom. In some such embodiments, each of the ortho positions of the aza N atom is substituted.

In some embodiments where L_{B} comprises a structure of Formula IIA, each of X¹, X², X³, and X⁴ is C.

In some embodiments where L_{B} comprises a structure of Formula IIA, at least one of X¹, X², X³, or X⁴ is N. In some embodiments, at least two of X¹, X², X³, or X⁴ is N.

In some embodiments where L_{B} comprises a structure of Formula IIA, X¹ is N. In some embodiments where L_{B} comprises a structure of Formula IIA, X¹ is C.

In some embodiments where L_{B} comprises a structure of Formula IIA, X² is N. In some embodiments where L_{B} comprises a structure of Formula IIA, X² is C.

In some embodiments where L_{B} comprises a structure of Formula IIA, X³ is N. In some embodiments where L_{B} comprises a structure of Formula IIA, X³ is C.

In some embodiments where L_{B} comprises a structure of Formula IIA, X⁴ is N. In some embodiments where L_{B} comprises a structure of Formula IIA, X⁴ is C.

In some embodiments where L_{B} comprises a structure of Formula IIAA: 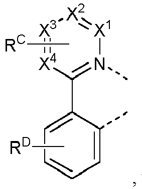 wherein at least one of X¹ to X⁴ is N. In some embodiments, exactly one of X¹ to X⁴ is N. In some embodiments, X¹ is N. In some embodiments, X² is N. In some embodiments, X³ is N. In some embodiments, X⁴ is N. In some embodiments, at least one of R^{C} is a tertiary alkyl, silyl or germyl. In some embodiments, at least one of R^{C} is a tertiary alkyl. In some embodiments, X³ is C and the R^{C} attached thereto is a tertiary alkyl, silyl or germyl. In some embodiments, X¹ to X³ is C, X⁴ is N, and the R^{C} attached to X³ is a tertiary alkyl, silyl or germyl. In some embodiments, X¹ to X³ is C, X⁴ is N, and the R^{C} attached to X² is a tertiary alkyl, silyl or germyl. In some embodiments, at least one of R^{D} is a tertiary alkyl, silyl, or germyl. In some embodiments, tertiary alkyl is tert-butyl. In some embodiments, at least one pair of R^{C}, one pair of R^{D}, or one pair of R^{C} and R^{D} are joined or fused into a ring.

In some embodiments, L_{B} comprises a structure of Formula IIB.

In some embodiments where L_{B} comprises a structure of Formula IIB, each of X⁵ to X⁷ is independently carbon. In some such embodiments, one of X⁵ to X⁷ is N. In some such embodiments, L_{B} comprises structure of Formula IIC:

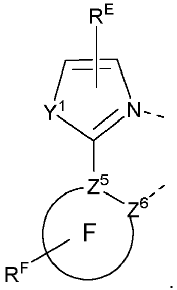

In some embodiments where L_{B} comprises a structure of Formula IIB, moiety F is selected from the group consisting of the Cyclic Moiety List defined herein.

In some embodiments where L_{B} comprises a structure of Formula IIB, moiety F is a monocyclic ring. In some embodiments, moiety F is selected from the group consisting of benzene, pyridine, pyrimidine, pyridazine, pyrazine, triazine, imidazole, imidazole derived carbene, pyrazole, pyrrole, oxazole, furan, thiophene, thiazole, and triazole. In some embodiments, moiety F is benzene.

In some embodiments where L_{B} comprises a structure of Formula IIB, moiety F is a polycyclic fused ring system. In some embodiments, moiety F is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

In some embodiments where L_{B} comprises a structure of Formula IIB, moiety F is benzofuran, benzothiophene, benzothiazole, benzoxazole, or dibenzofuran. In some embodiments, moiety F is benzofuran. In some embodiments, moiety F is benzothiophene. In some embodiments, moiety F is benzothiazole. In some embodiments, moiety F is benzoxazole. In some embodiments, moiety F is dibenzofuran.

In some embodiments where L_{B} comprises a structure of Formula IIB, Y¹ is O, S, or Se. In some embodiments, Y¹ is O. In some embodiments, Y¹ is S. In some embodiments, Y¹ is Se.

In some embodiments where L_{B} comprises a structure of Formula IIB, Y¹ is Te. In some embodiments, Y¹ is P. In some embodiments, Y¹ is Si or Ge. In some embodiments, Y¹ is Si. In some embodiments, Y¹ is Ge.

In some embodiments where L_{B} comprises a structure of Formula IIB, n is 1, m is 1, and o is 1.

In some embodiments where L_{B} comprises a structure of Formula IIB, n is 1 and m is 2.

In some embodiments where L_{B} comprises a structure of Formula IIB, n is 2 and m is 1.

In some embodiments where L_{B} comprises a structure of Formula IIB, if o is 0, X¹ is N, each of X² to X⁴ is C, and moiety D is a non-fused benzene ring, then ring A is not pyridine. In some such embodiments, o is 0, X¹ is N, each of X² to X⁴ is C, moiety D is a non-fused benzene ring, and ring A is not pyridine.

In some embodiments where L_{B} comprises a structure of Formula IIB, o is 0, X¹ is N, each of X² to X⁴ is C, moiety D is a non-fused benzene ring, and moiety A is not pyridine. In some such embodiments, moiety A is quinoline, isoquinoline, quinazoline, quinoxaline, benzimidazole, pyrimidine, pyridazine, pyrazine, triazine, or imidazole. In some such embodiments, moiety A is quinoline. In some such embodiments, moiety A is isoquinoline. In some such embodiments, moiety A is quinazoline. In some such embodiments, moiety A is quinoxaline.

In some embodiments, the first ligand L_{A} comprises an electron-withdrawing group selected from the group consisting of the following EWG1 LIST: F, CF₃, CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeOzCF₃, OSeO₂CF₃, OCN, SCN, SeCN, NC, ⁺N(R^{k2})₃, (R^{k2})₂CCN, (R^{k2})₂CCF₃, CNC(CF₃)₂, BR^{k3}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate, 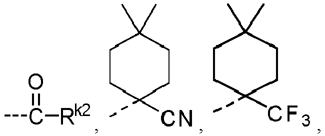 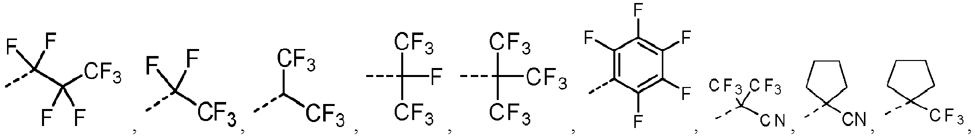 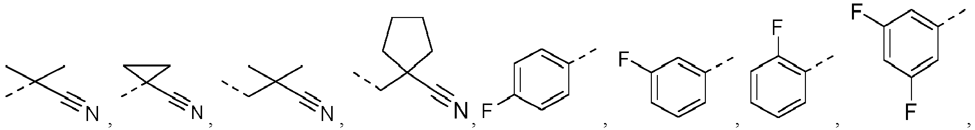 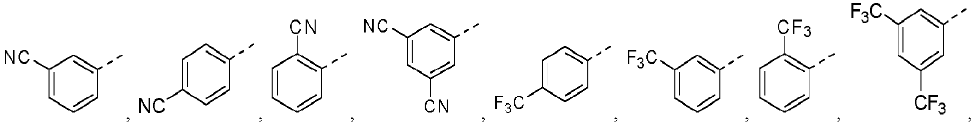 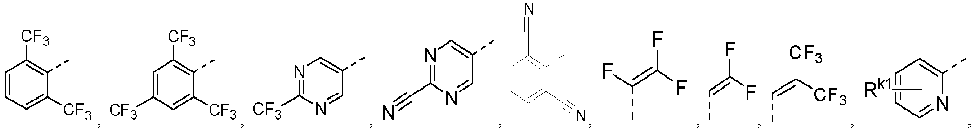 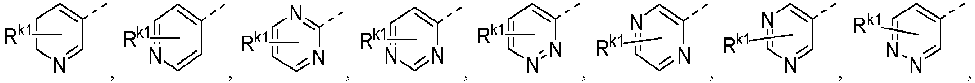 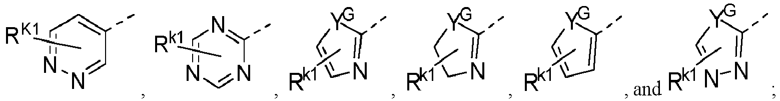
wherein each R^{k1} represents mono to the maximum allowable substitution, or no substitutions;
wherein Y^{G} is selected from the group consisting of BRₑ, NRₑ, PRₑ, O, S, Se, C=O, S=O, SO₂, CRₑR_{f}, SiRₑR_{f}, and GeRₑR_{f}; and
wherein each of R^{k1}, R^{k2}, R^{k3}, Rₑ, and R_{f} is independently a hydrogen or a substituent selected from the group consisting of the General Substituents defined herein.

In some embodiments, the first ligand L_{A} comprises an electron-withdrawing group selected from the group consisting of the structures of the following EWG2 List:

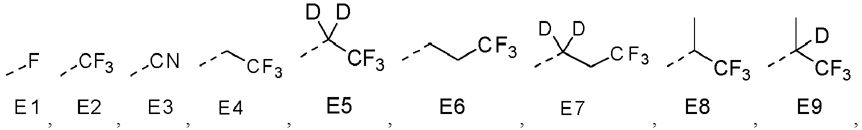

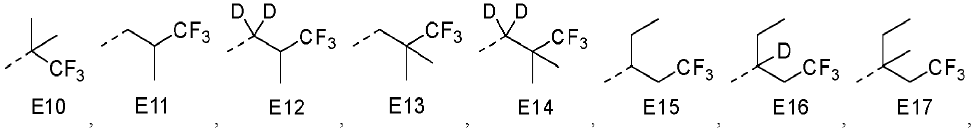

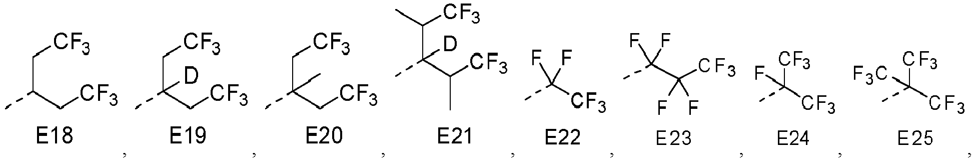

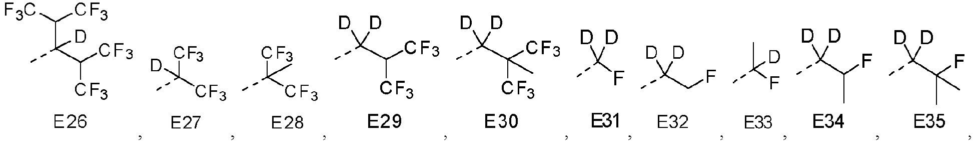

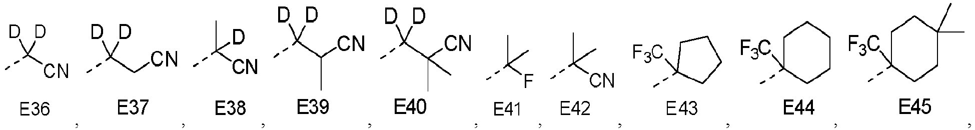

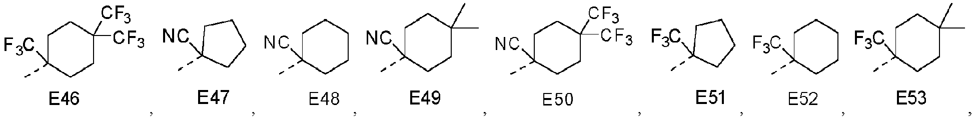

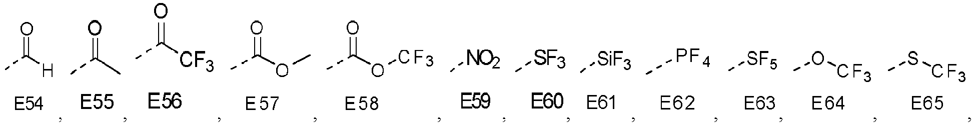

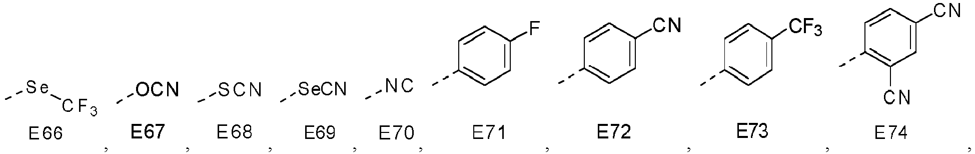

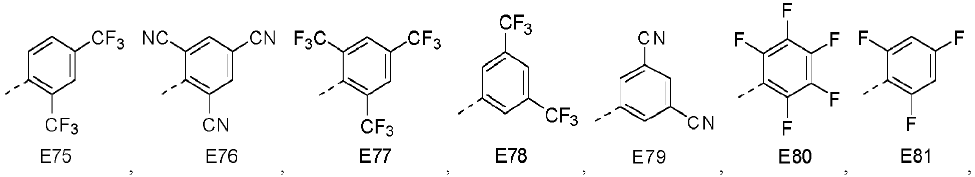

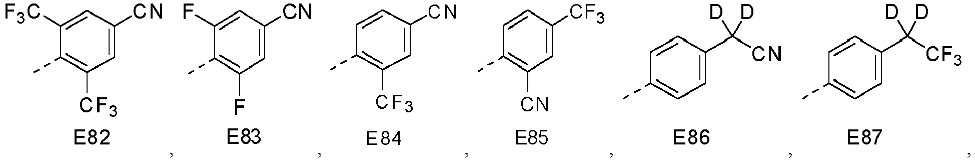

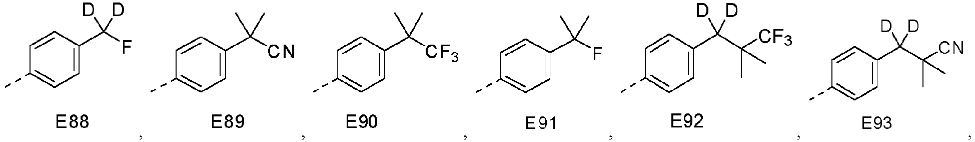

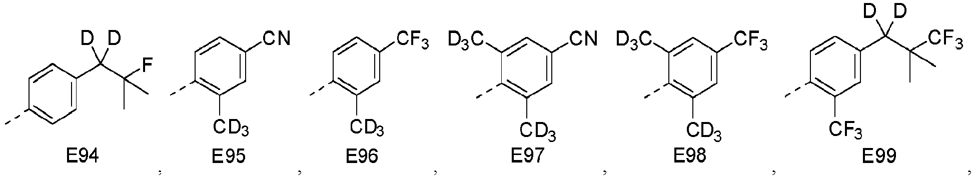

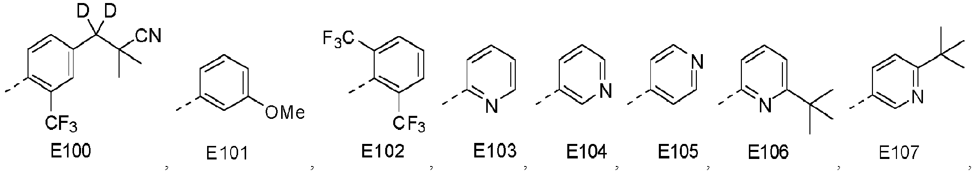

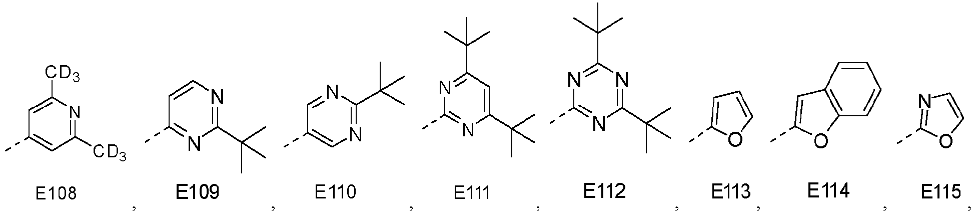

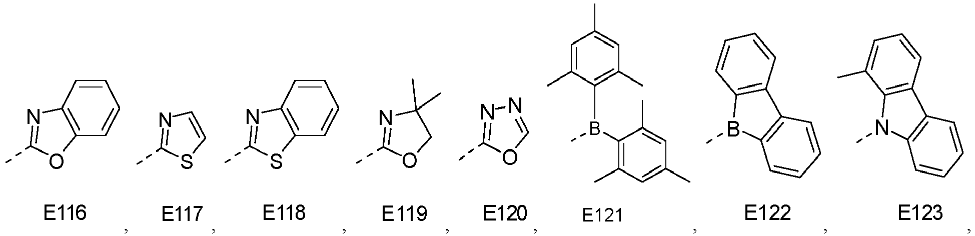

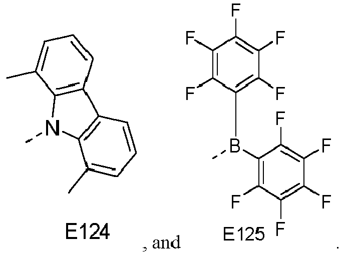

In some embodiments, the first ligand L_{A} comprises an electron-withdrawing group selected from the group consisting of the structures of the following EWG3 LIST:

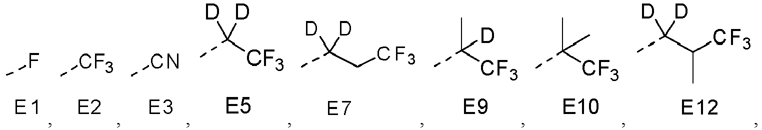

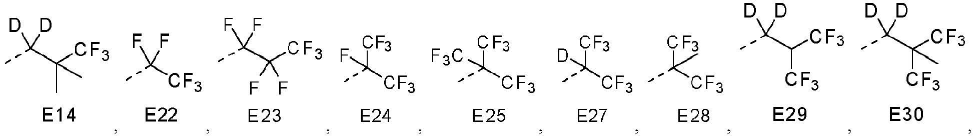

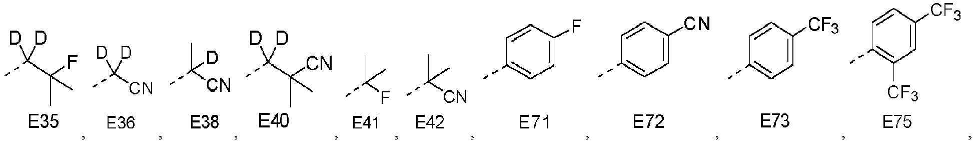

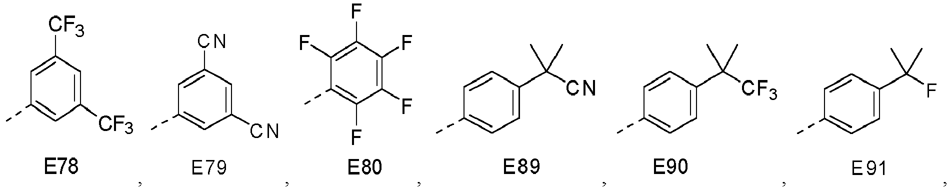

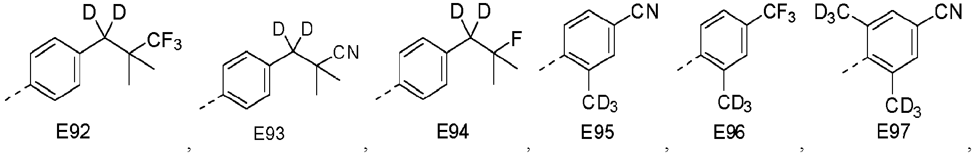

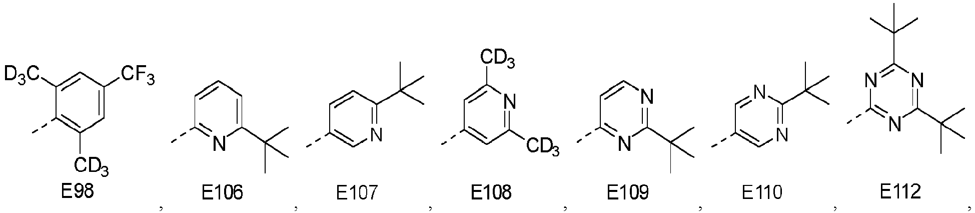

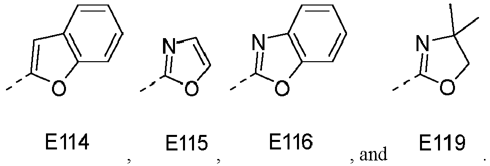

In some embodiments, the first ligand L_{A} comprises an electron-withdrawing group selected from the group consisting of the structures of the following EWG4 LIST:

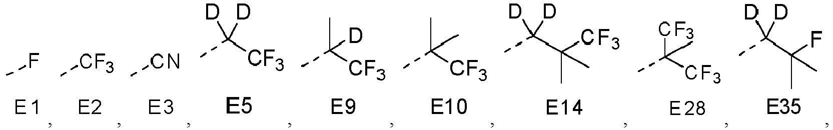

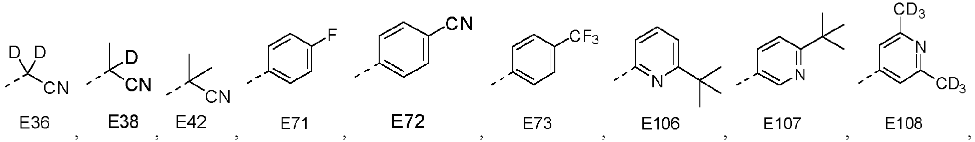

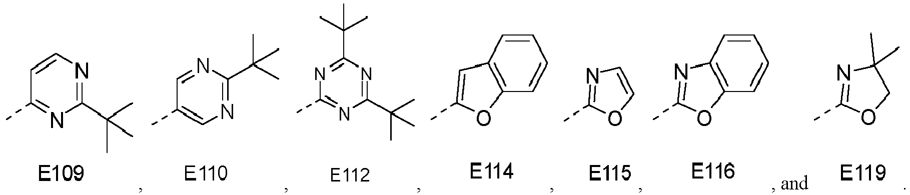

In some embodiments, the compound comprises an electron-withdrawing group that is a π-electron deficient electron-withdrawing group. In some embodiments, the π-electron deficient electron-withdrawing group is selected from the group consisting of the structures of the following Pi-EWG LIST: CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, BR^{k2}R^{k3}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano-containing aryl, cyano-containing heteroaryl, isocyanate, 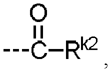 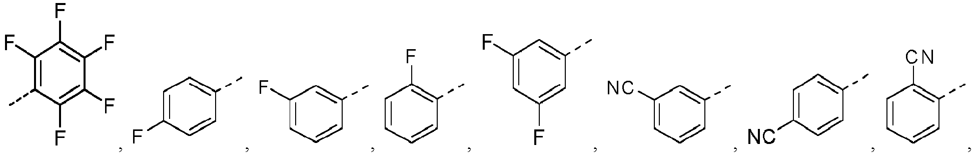 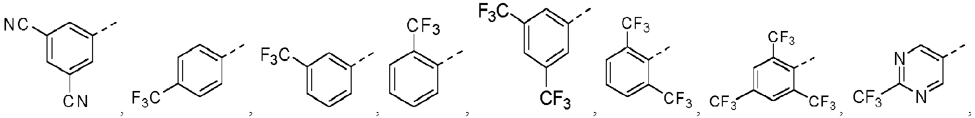 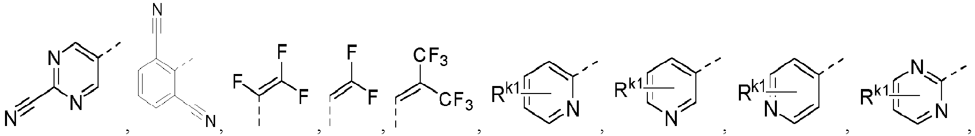 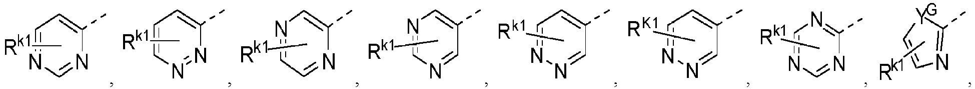 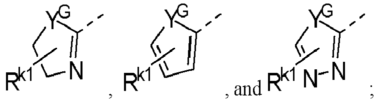 wherein the variables are the same as previously defined.

In some embodiments, the compound comprises an electron-withdrawing group from the EWG1 LIST as defined herein. In some embodiments, the compound comprises an electron-withdrawing group from the EWG2 LIST as defined herein. In some embodiments, the compound comprises an electron-withdrawing group from the EWG3 LIST as defined herein. In some embodiments, the compound comprises an electron-withdrawing group from the EWG4 LIST as defined herein. In some embodiments, the compound comprises an electron-withdrawing group from the Pi-EWG LIST as defined herein.

In some embodiments, at least one R^{A} is or comprises an electron-withdrawing group from the EWG1 LIST as defined herein. In some embodiments, at least one R^{A} is or comprises an electron-withdrawing group from the EWG2 LIST as defined herein. In some embodiments, at least one R^{A} is or comprises an electron-withdrawing group from the EWG3 LIST as defined herein. In some embodiments, at least one R^{A} is or comprises an electron-withdrawing group from the EWG4 LIST as defined herein. In some embodiments, at least one R^{A} is or comprises an electron-withdrawing group from the Pi-EWG LIST as defined herein.

In some embodiments, at least one R^{B} is or comprises an electron-withdrawing group from the EWG1 LIST as defined herein. In some embodiments, at least one R^{B} is or comprises an electron-withdrawing group from the EWG2 LIST as defined herein. In some embodiments, at least one R^{B} is or comprises an electron-withdrawing group from the EWG3 LIST as defined herein. In some embodiments, at least one R^{B} is or comprises an electron-withdrawing group from the EWG4 LIST as defined herein. In some embodiments, at least one R^{B} is or comprises an electron-withdrawing group from the Pi-EWG LIST as defined herein.

In some embodiments, L_{B} comprises an electron-withdrawing group from the EWG1 LIST as defined herein. In some embodiments, L_{B} comprises an electron-withdrawing group from the EWG2 LIST as defined herein. In some embodiments, L_{B} comprises an electron-withdrawing group from the EWG3 LIST as defined herein. In some embodiments, L_{B} comprises an electron-withdrawing group from the EWG4 LIST as defined herein. In some embodiments, L_{B} comprises an electron-withdrawing group from the Pi-EWG LIST as defined herein.

In some embodiments where L_{B} has a structure of Formula IIA, at least one R^{C} is or comprises an electron-withdrawing group from the EWG1 LIST as defined herein. In some embodiments, at least one R^{C} is or comprises an electron-withdrawing group from the EWG2 LIST as defined herein. In some embodiments, at least one R^{C} is or comprises an electron-withdrawing group from the EWG3 LIST as defined herein. In some embodiments, at least one R^{C} is or comprises an electron-withdrawing group from the EWG4 LIST as defined herein. In some embodiments, at least one R^{C} is or comprises an electron-withdrawing group from the Pi-EWG LIST as defined herein.

In some embodiments where L_{B} has a structure of Formula IIA, at least one R^{D} is or comprises an electron-withdrawing group from the EWG1 LIST as defined herein. In some embodiments, at least one R^{D} is or comprises an electron-withdrawing group from the EWG2 LIST as defined herein. In some embodiments, at least one R^{D} is or comprises an electron-withdrawing group from the EWG3 LIST as defined herein. In some embodiments, at least one R^{D} is or comprises an electron-withdrawing group from the EWG4 LIST as defined herein. In some embodiments, at least one R^{D} is or comprises an electron-withdrawing group from the Pi-EWG LIST as defined herein.

In some embodiments where L_{B} has a structure of Formula IIB, at least one R^{E} is or comprises an electron-withdrawing group from the EWG1 LIST as defined herein. In some embodiments, at least one R^{E} is or comprises an electron-withdrawing group from the EWG2 LIST as defined herein. In some embodiments, at least one R^{E} is or comprises an electron-withdrawing group from the EWG3 LIST as defined herein. In some embodiments, at least one R^{E} is or comprises an electron-withdrawing group from the EWG4 LIST as defined herein. In some embodiments, at least one R^{E} is or comprises an electron-withdrawing group from the Pi-EWG LIST as defined herein.

In some embodiments where L_{B} has a structure of Formula IIB, at least one R^{F} is or comprises an electron-withdrawing group from the EWG1 LIST as defined herein. In some embodiments, at least one R^{F} is or comprises an electron-withdrawing group from the EWG2 LIST as defined herein. In some embodiments, at least one R^{F} is or comprises an electron-withdrawing group from the EWG3 LIST as defined herein. In some embodiments, at least one R^{F} is or comprises an electron-withdrawing group from the EWG4 LIST as defined herein. In some embodiments, at least one R^{F} is or comprises an electron-withdrawing group from the Pi-EWG LIST as defined herein.

In some embodiments, Lc comprises an electron-withdrawing group from the EWG1 LIST as defined herein. In some embodiments, Lc comprises an electron-withdrawing group from the EWG2 LIST as defined herein. In some embodiments, Lc comprises an electron-withdrawing group from the EWG3 LIST as defined herein. In some embodiments, Lc comprises an electron-withdrawing group from the EWG4 LIST as defined herein. In some embodiments, Lc comprises an electron-withdrawing group from the Pi-EWG LIST as defined herein.

In some embodiments, at least one R^{A} is not hydrogen. In some embodiments, at least one R^{A} comprises at least one C atom. In some embodiments, at least one R^{A} comprises a substituent selected from the group consisting of alkyl, cycloalkyl, aryl, heteroaryl, and combinations thereof.

In some embodiments, at least one R^{A} is substituted aryl. In some such embodiments, at least one atom of the aryl adjacent to the bond with moiety A comprises at least one carbon. In some such embodiments, at least one atom of the aryl adjacent to the bond with moiety A comprises alkyl or aryl. In some such embodiments, each atom of the aryl adjacent to the bond with moiety A independently comprises at least one carbon. In some such embodiments, each atom of the aryl adjacent to the bond with moiety A independently comprises alkyl or aryl.

In some embodiments, at least two R^{A} independently comprise at least one C atom.

In some embodiments, at least one R^{B} is not hydrogen. In some embodiments, at least one R^{B} comprises at least one C atom. In some embodiments, at least one R^{B} comprises a substituent selected from the group consisting of alkyl, cycloalkyl, aryl, heteroaryl, and combinations thereof. In some embodiments, at least one R^{B} comprises an electron-withdrawing group.

In some embodiments, at least one R^{C} is not hydrogen. In some embodiments, at least one R^{C} comprises at least one C atom. In some embodiments, at least one R^{C} comprises a substituent selected from the group consisting of alkyl, cycloalkyl, aryl, heteroaryl, and combinations thereof. In some embodiments, at least one R^{C} comprises an electron-withdrawing group.

In some embodiments, at least one R^{C} or R^{D} is not hydrogen or deuterium. In some embodiments, at least one R^{C} or R^{D} comprises at least one C atom. In some embodiments, at least one R^{C} or R^{D} comprises a substituent selected from the group consisting of alkyl, cycloalkyl, aryl, heteroaryl, and combinations thereof.

In some embodiments, at least one R^{D} is not hydrogen. In some embodiments, at least one R^{D} comprises at least one C atom. In some embodiments, at least one R^{D} comprises a substituent selected from the group consisting of alkyl, cycloalkyl, aryl, heteroaryl, and combinations thereof. In some embodiments, at least one R^{D} comprises an electron-withdrawing group.

In some embodiments, at least one R^{E} is not hydrogen. In some embodiments, at least one R^{E} comprises at least one C atom. In some embodiments, at least one R^{E} comprises a substituent selected from the group consisting of alkyl, cycloalkyl, aryl, heteroaryl, and combinations thereof. In some embodiments, at least one R^{E} comprises an electron-withdrawing group.

In some embodiments, at least one R^{F} is not hydrogen. In some embodiments, at least one R^{F} comprises at least one C atom. In some embodiments, at least one R^{F} comprises a substituent selected from the group consisting of alkyl, cycloalkyl, aryl, heteroaryl, and combinations thereof. In some embodiments, at least one R^{F} comprises an electron-withdrawing group.

In some embodiments, ligand L_{A} is selected from the group consisting of the structures of the following LIST 1: 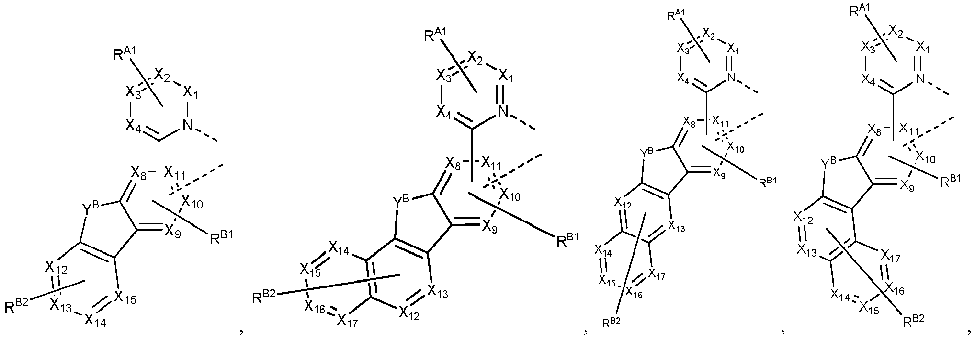 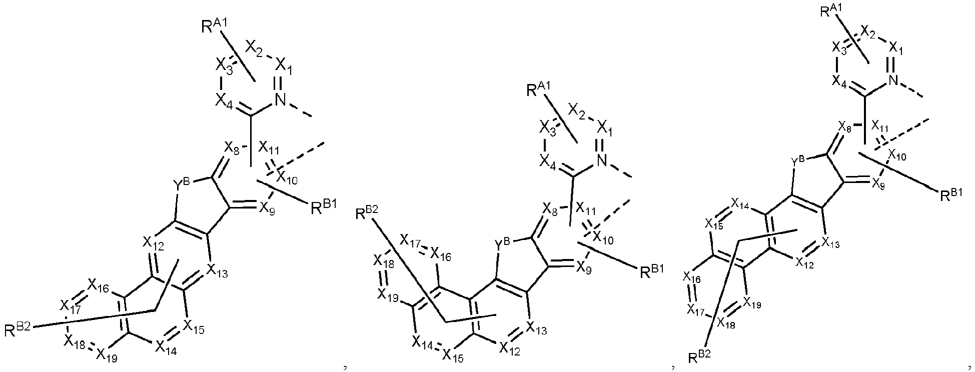 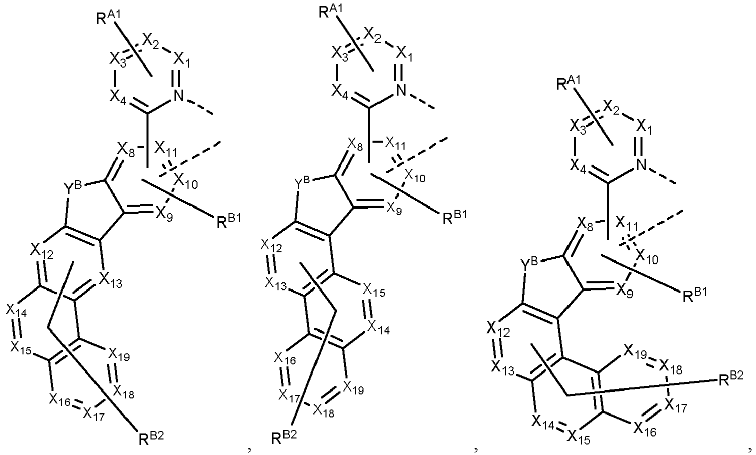 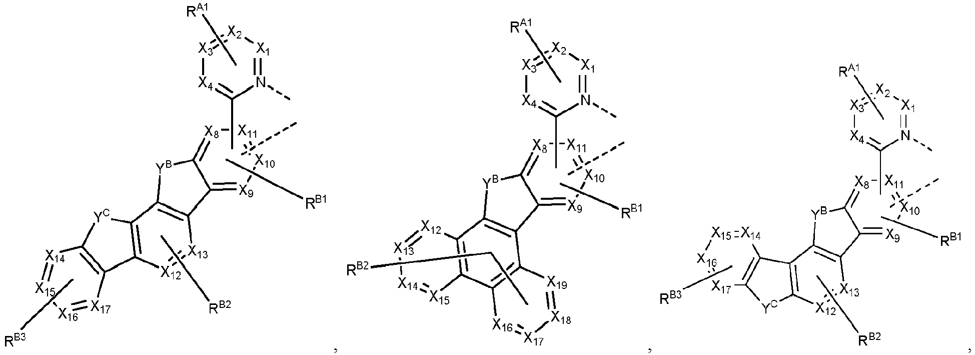 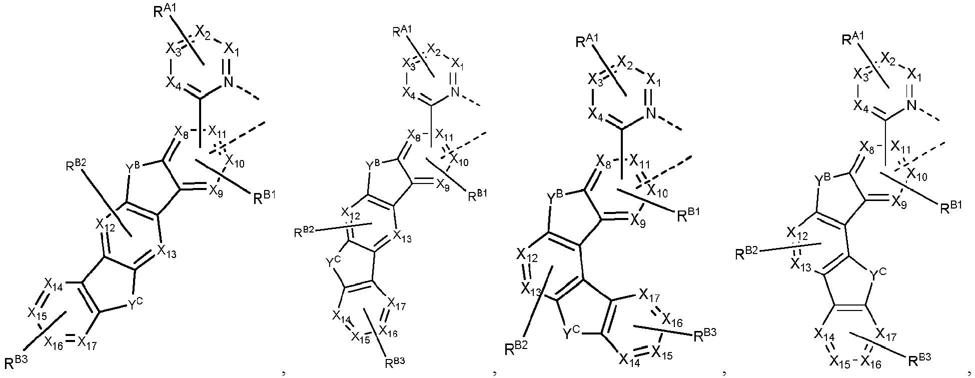 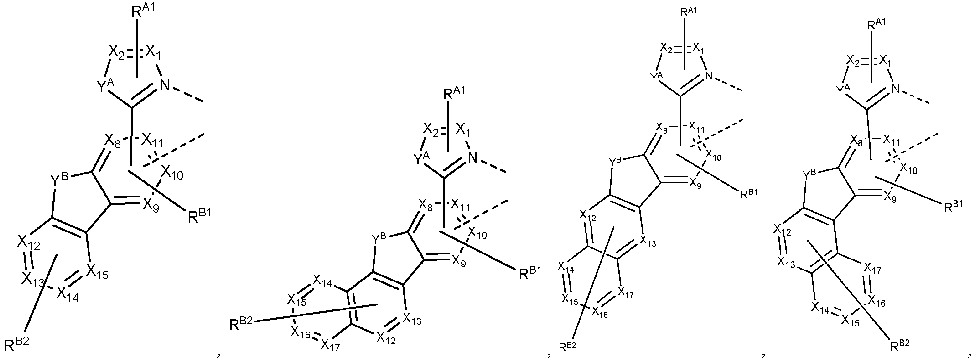 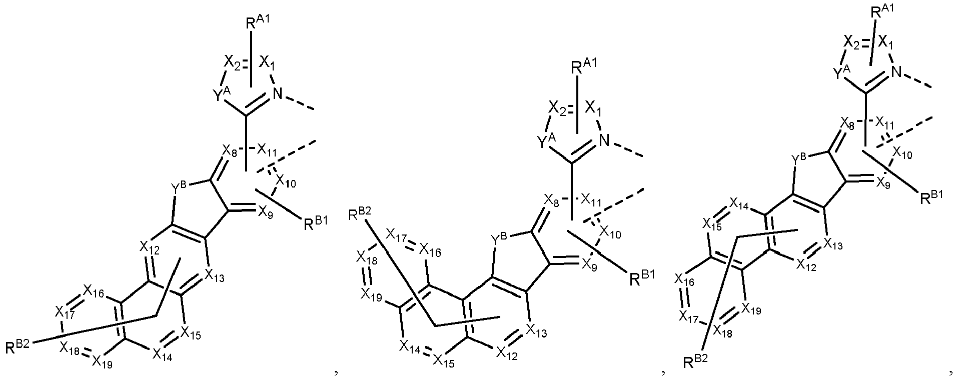 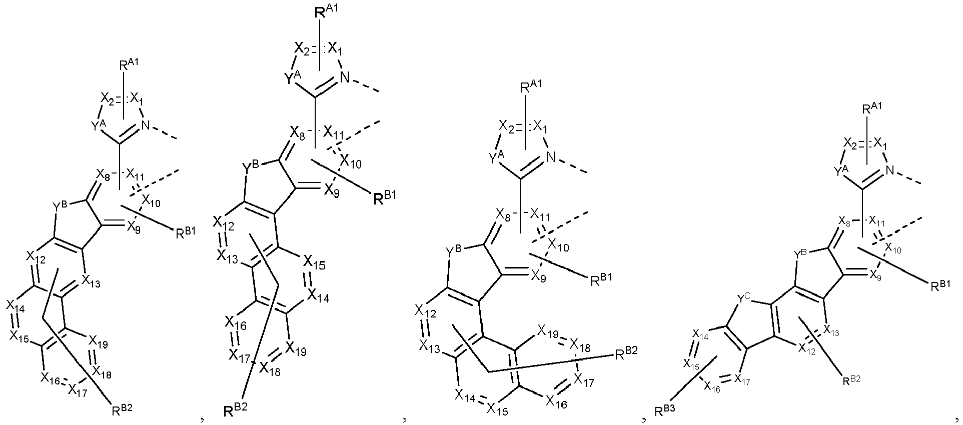 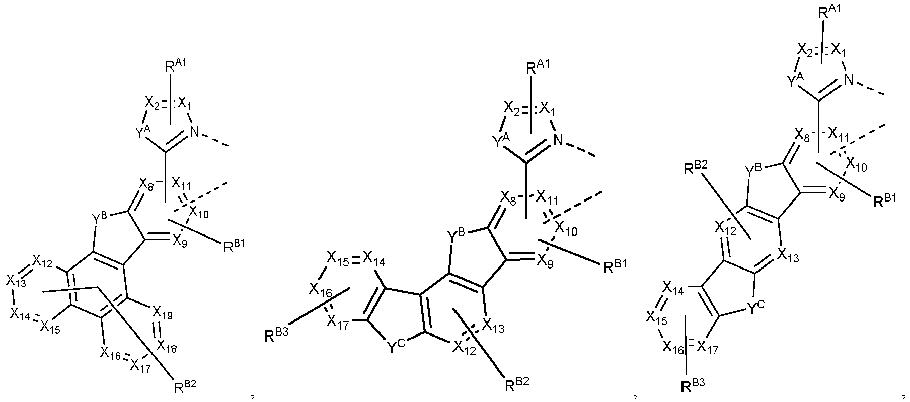 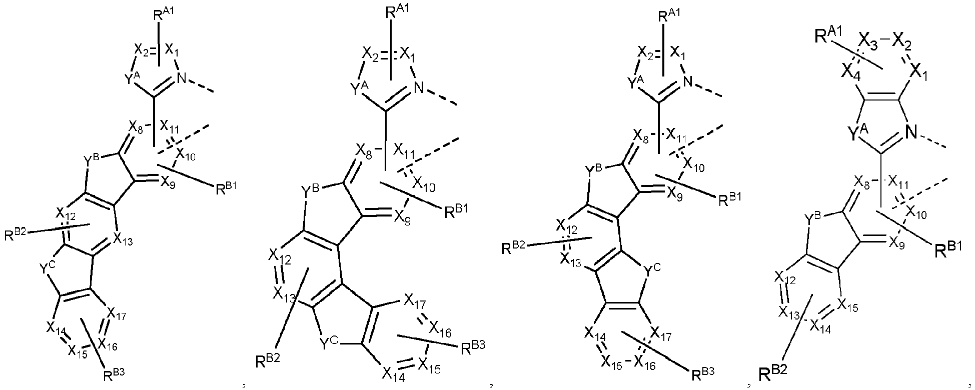 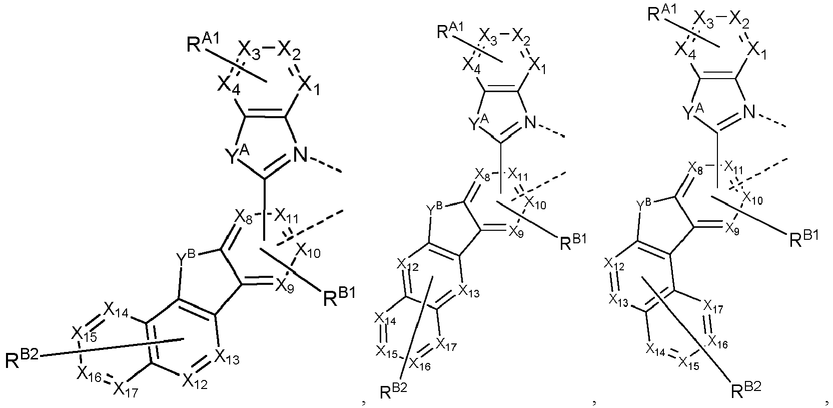 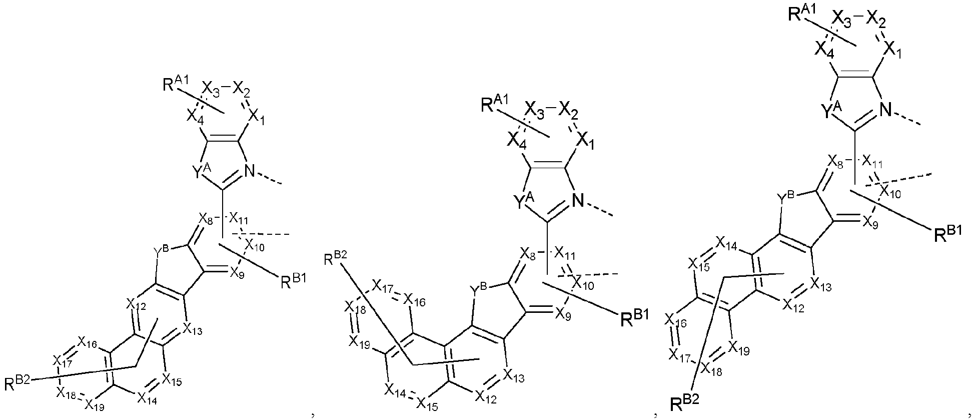 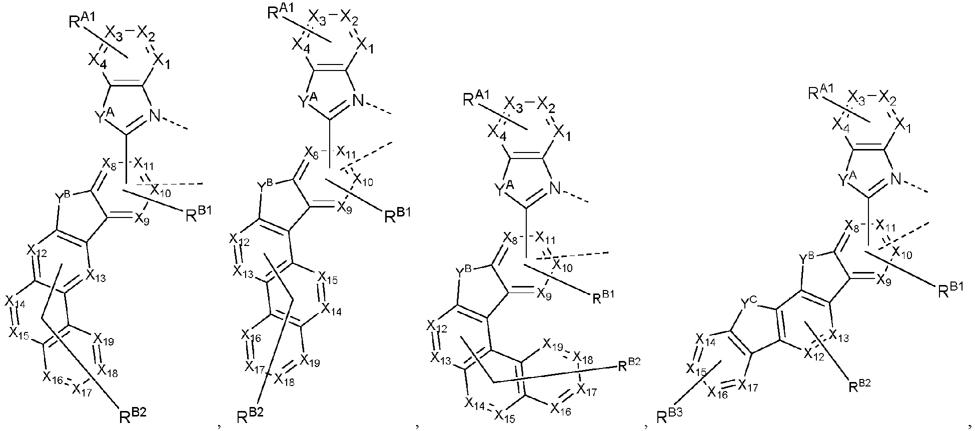 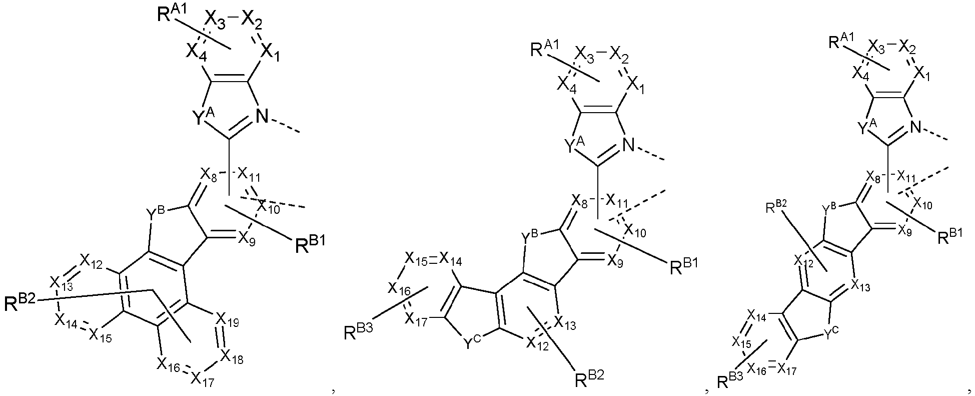 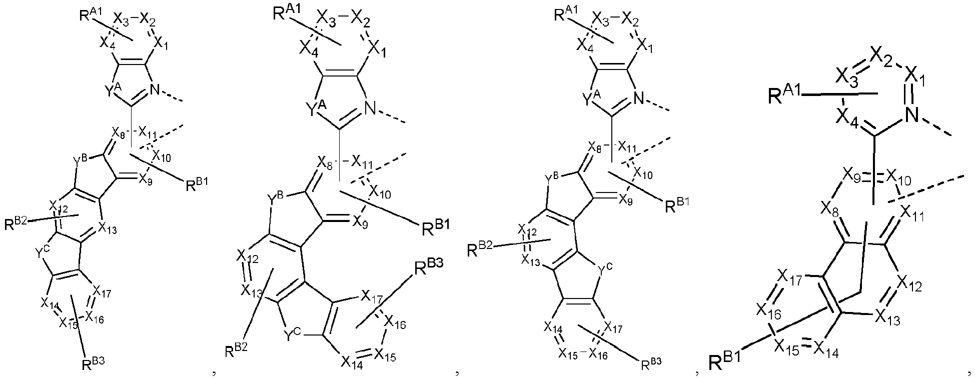 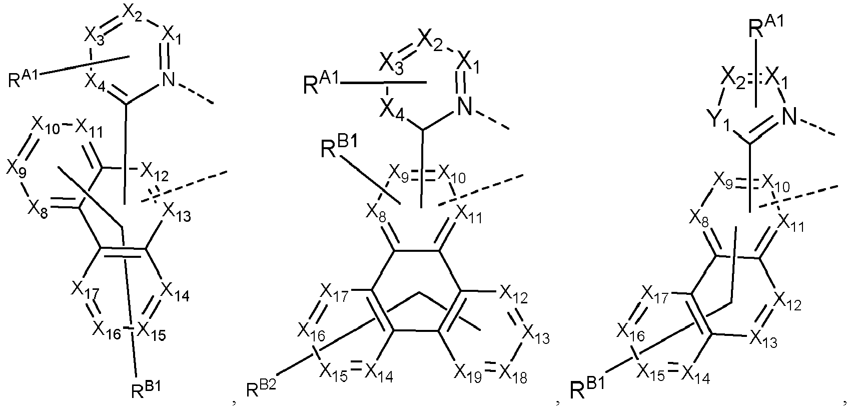 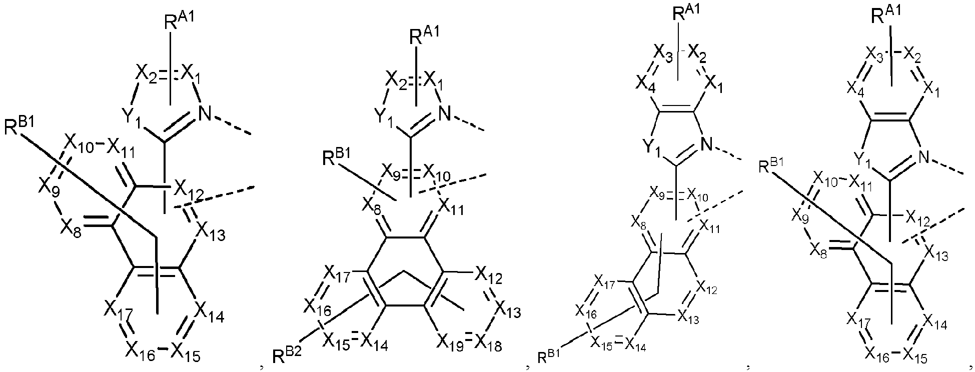 and 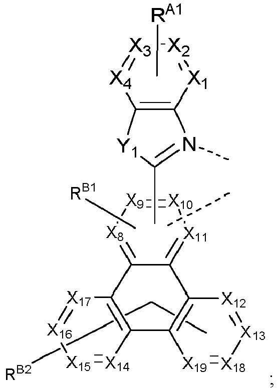 wherein:
each of X₁ to X₁₉ is independently C or N;
each of Y₁, Y^{A}, Y^{B}, and Y^{C} is independently selected from the group consisting of BRₑ, NRₑ, PRₑ, O, S, Se, C=O, S=O, SO₂, CRₑR_{f}, SiRₑR_{f}, and GeRₑR_{f};
each of R^{A1}, R^{B1}, R^{B2}, and R^{B3} independently represents from mono to the maximum possible number of substitutions, or no substitutions;
each R^{A1}, R^{B1}, R^{B2}, R^{B3}, Rₑ, and R_{f} is independently a hydrogen or a substituent selected from the group consisting of the General Substituents defined herein; and
any two substituents can be joined or fused to form a ring.

In some embodiments, where ligand L_{A} is selected from LIST 1, at least one of R^{A1}, R^{B1}, R^{B2}, or R^{B3} is partially or fully deuterated. In some embodiments, at least one R^{A1} is partially or fully deuterated. In some embodiments, at least one R^{B1} is partially or fully deuterated. In some embodiments, at least one R^{B2} is partially or fully deuterated. In some embodiments, at least one R^{B3} is partially or fully deuterated. In some embodiments, at least one Rₑ or Rε is partially or fully deuterated.

In some embodiments where ligand L_{A} is selected from LIST 1, at least one R^{A1} is or comprises an electron-withdrawing group from the EWG1 LIST as defined herein. In some embodiments, at least one R^{A1} is or comprises an electron-withdrawing group from the EWG2 LIST as defined herein. In some embodiments, at least one R^{A1} is or comprises an electron-withdrawing group from the EWG3 LIST as defined herein. In some embodiments, at least one R^{A1} is or comprises an electron-withdrawing group from the EWG4 LIST as defined herein. In some embodiments, at least one R^{A1} is or comprises an electron-withdrawing group from the Pi-EWG LIST as defined herein.

In some embodiments where ligand L_{A} is selected from LIST 1, at least one R^{B1} is or comprises an electron-withdrawing group from the EWG1 LIST as defined herein. In some embodiments, at least one R^{B1} is or comprises an electron-withdrawing group from the EWG2 LIST as defined herein. In some embodiments, at least one R^{B1} is or comprises an electron-withdrawing group from the EWG3 LIST as defined herein. In some embodiments, at least one R^{B1} is or comprises an electron-withdrawing group from the EWG4 LIST as defined herein. In some embodiments, at least one R^{B1} is or comprises an electron-withdrawing group from the Pi-EWG LIST as defined herein.

In some embodiments where ligand L_{A} is selected from LIST 1, at least one R^{B2} is or comprises an electron-withdrawing group from the EWG1 LIST as defined herein. In some embodiments, at least one R^{B2} is or comprises an electron-withdrawing group from the EWG2 LIST as defined herein. In some embodiments, at least one R^{B2} is or comprises an electron-withdrawing group from the EWG3 LIST as defined herein. In some embodiments, at least one R^{B2} is or comprises an electron-withdrawing group from the EWG4 LIST as defined herein. In some embodiments, at least one R^{B2} is or comprises an electron-withdrawing group from the Pi-EWG LIST as defined herein.

In some embodiments where ligand L_{A} is selected from LIST 1, at least one R^{B3} is or comprises an electron-withdrawing group from the EWG1 LIST as defined herein. In some embodiments, at least one R^{B3} is or comprises an electron-withdrawing group from the EWG2 LIST as defined herein. In some embodiments, at least one R^{B3} is or comprises an electron-withdrawing group from the EWG3 LIST as defined herein. In some embodiments, at least one R^{B3} is or comprises an electron-withdrawing group from the EWG4 LIST as defined herein. In some embodiments, at least one R^{B3} is or comprises an electron-withdrawing group from the Pi-EWG LIST as defined herein.

In some embodiments where ligand L_{A} is selected from LIST 1, at least one Rₑ or Rε is or comprises an electron-withdrawing group from the EWG1 LIST as defined herein. In some embodiments, at least one Rₑ or Rε is or comprises an electron-withdrawing group from the EWG2 LIST as defined herein. In some embodiments, at least one Rₑ or R_{f} is or comprises an electron-withdrawing group from the EWG3 LIST as defined herein. In some embodiments, at least one Rₑ or R_{f} is or comprises an electron-withdrawing group from the EWG4 LIST as defined herein. In some embodiments, at least one Rₑ or Rε is or comprises an electron-withdrawing group from the Pi-EWG LIST as defined herein.

In some embodiments, the ligand L_{A} is selected from the group consisting of the structures of the following LIST 2: 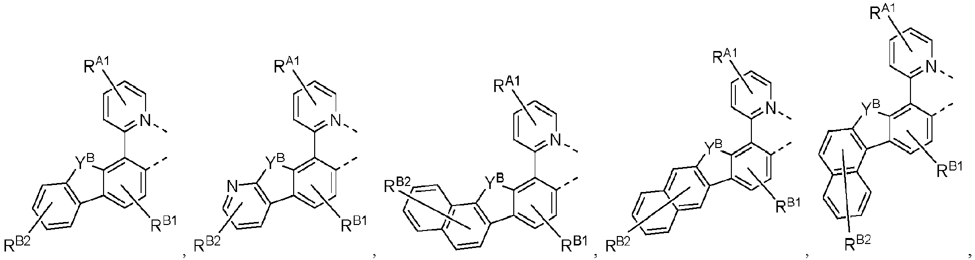 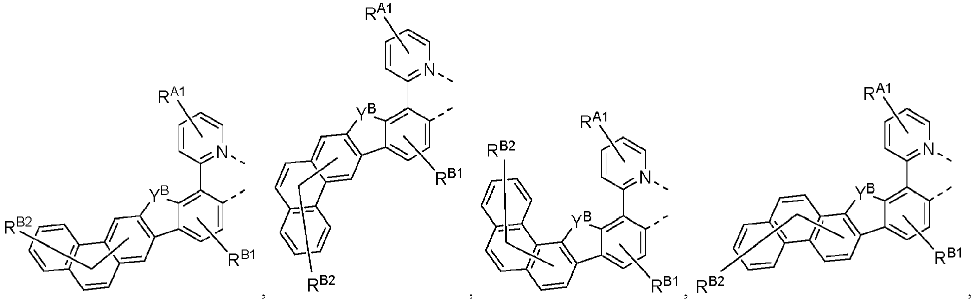 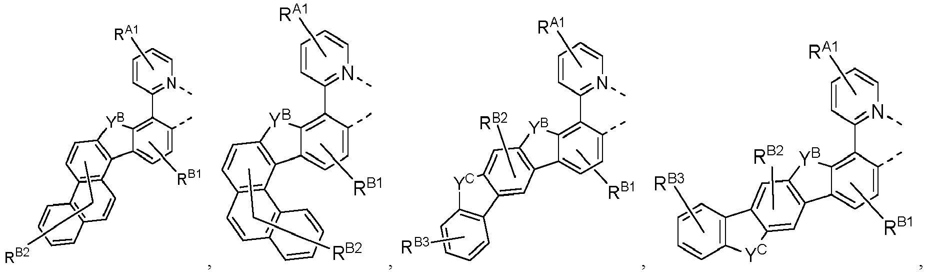 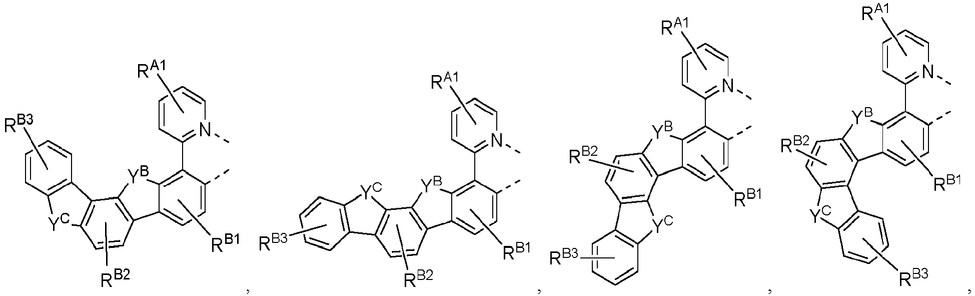 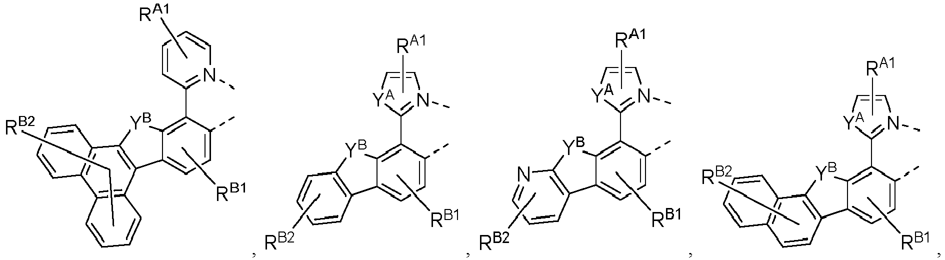 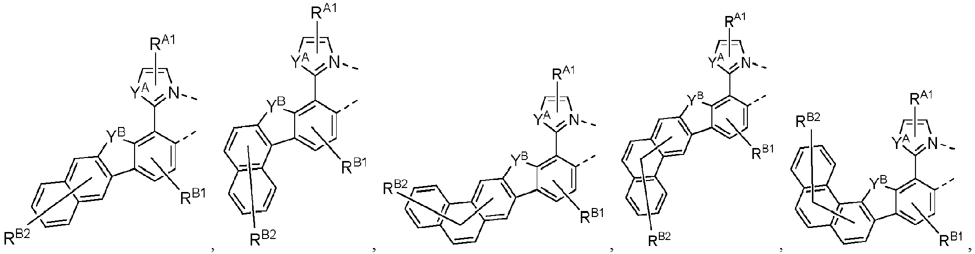 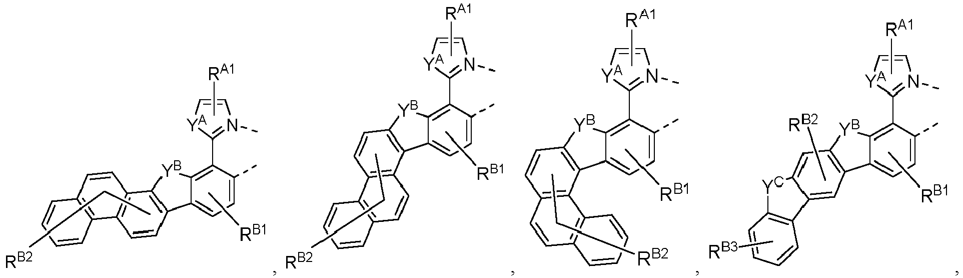 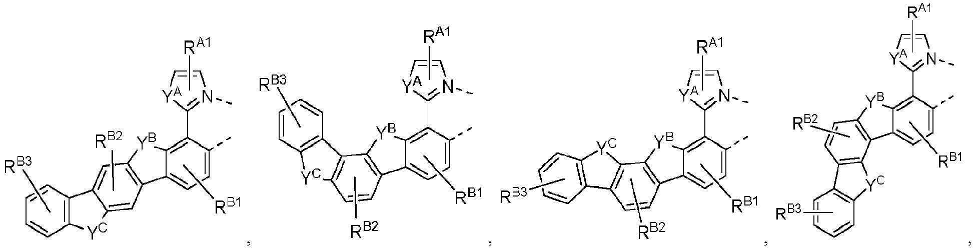 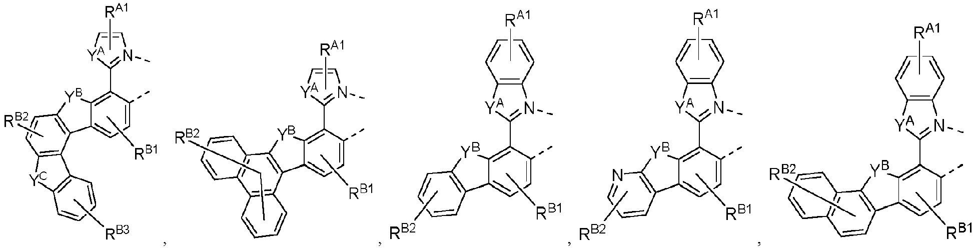 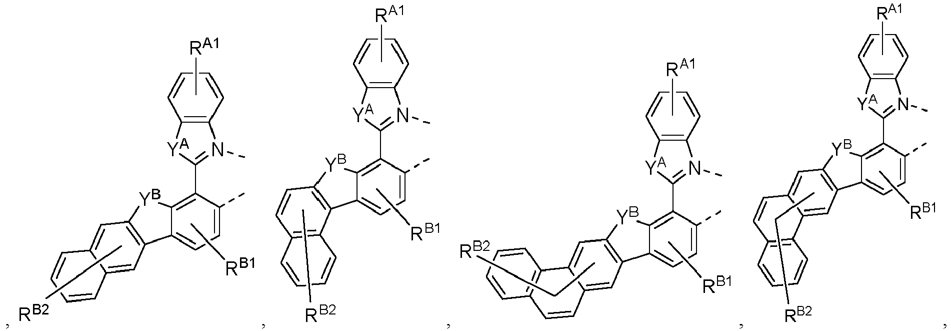 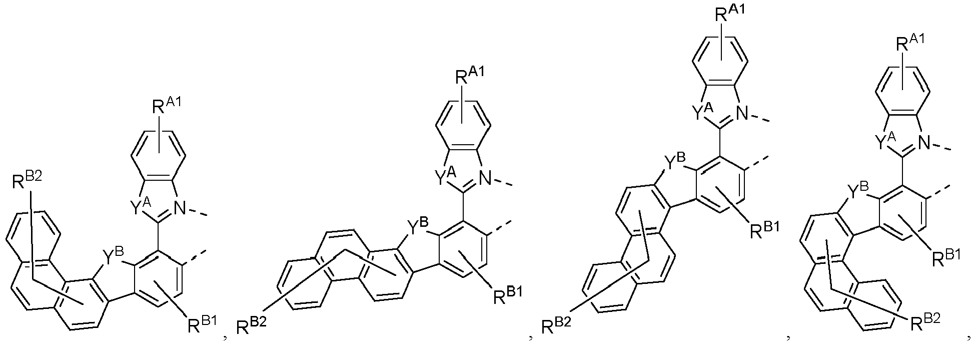 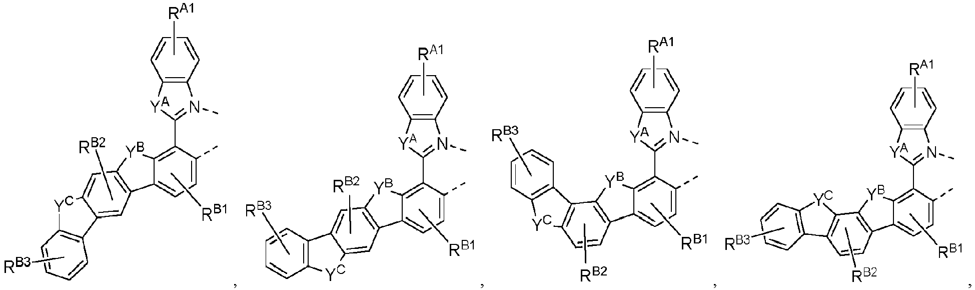 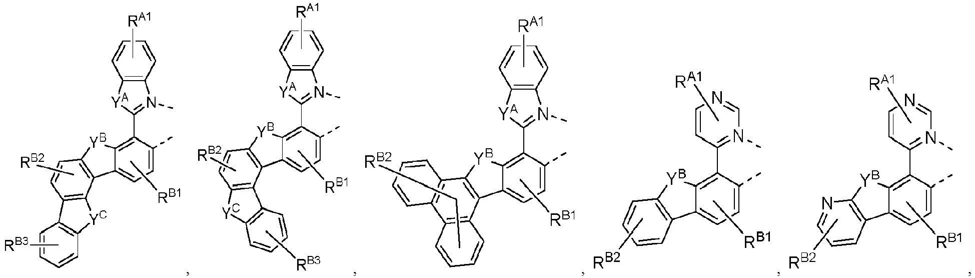 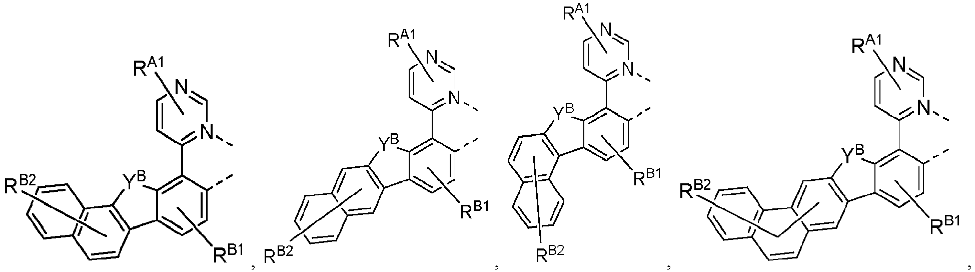 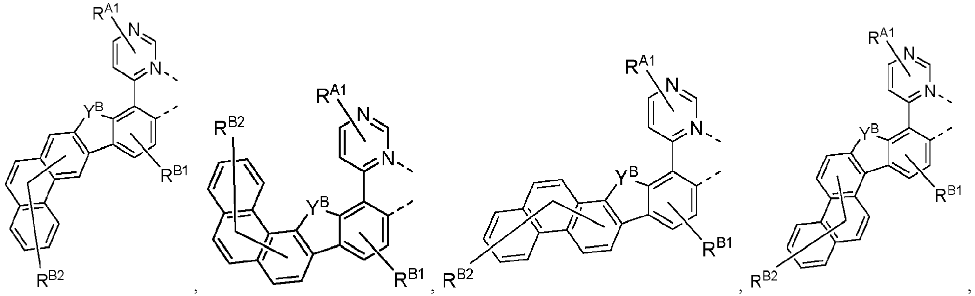 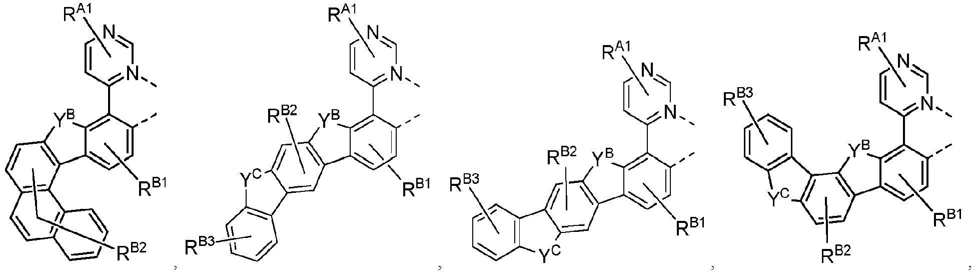 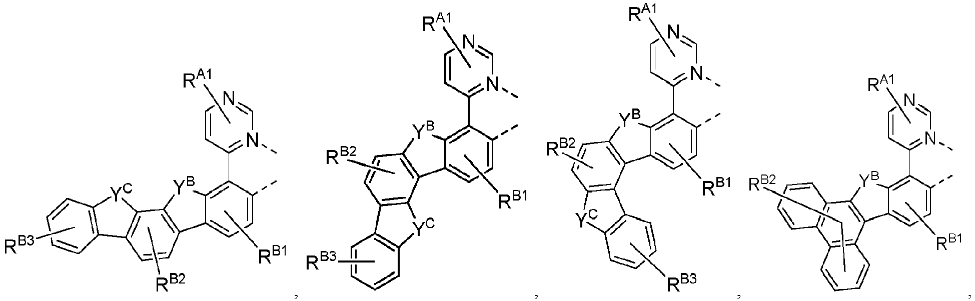 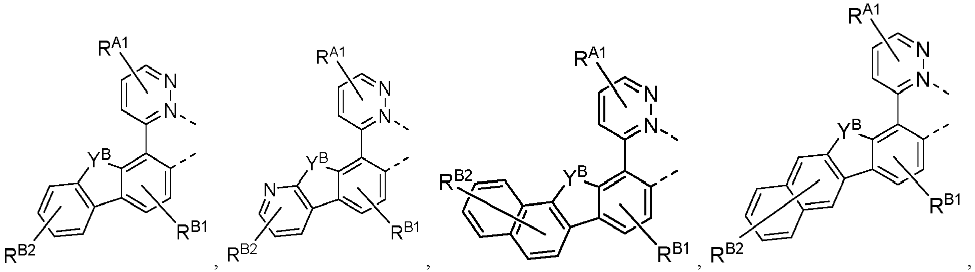 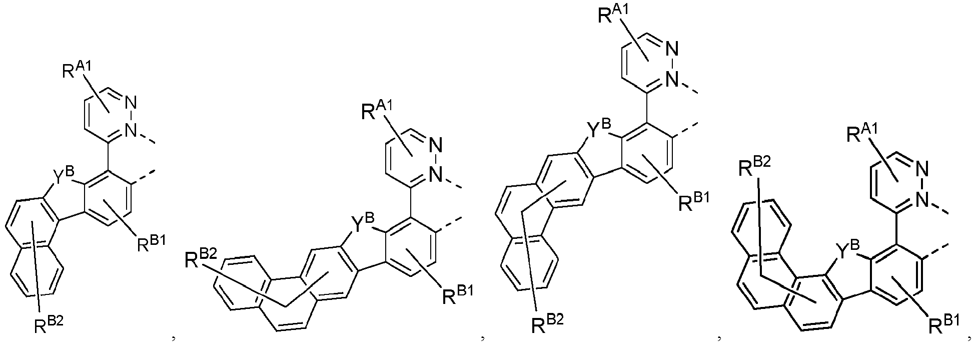 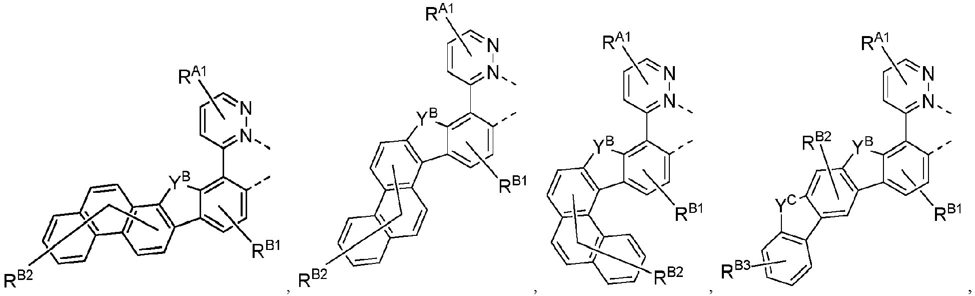 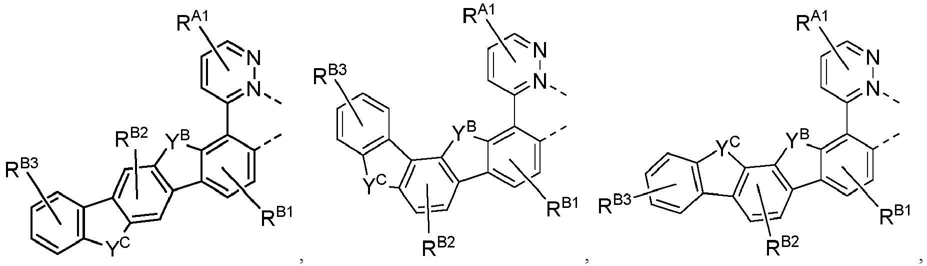 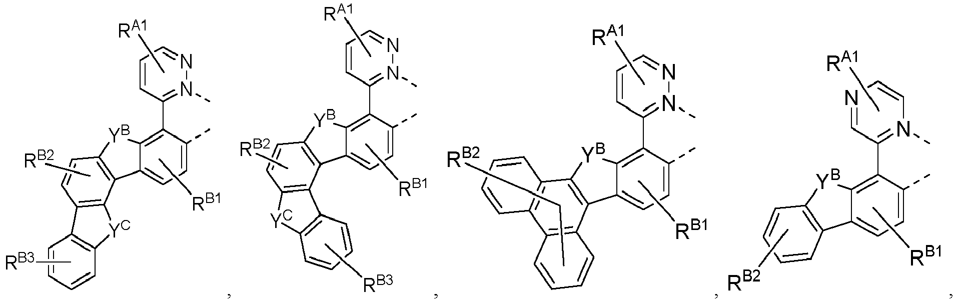 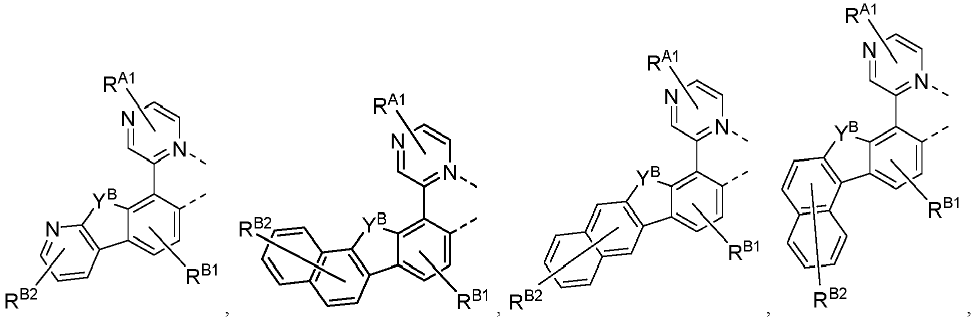 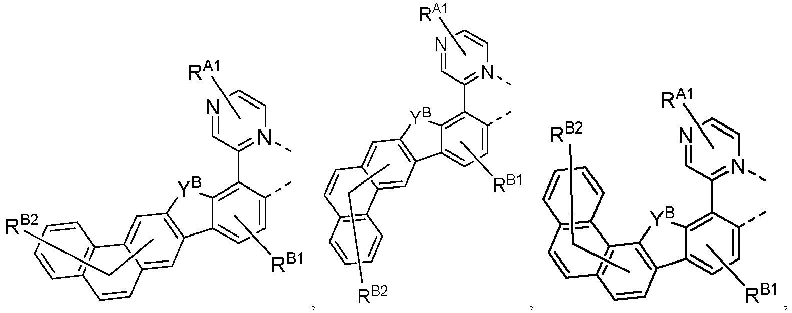 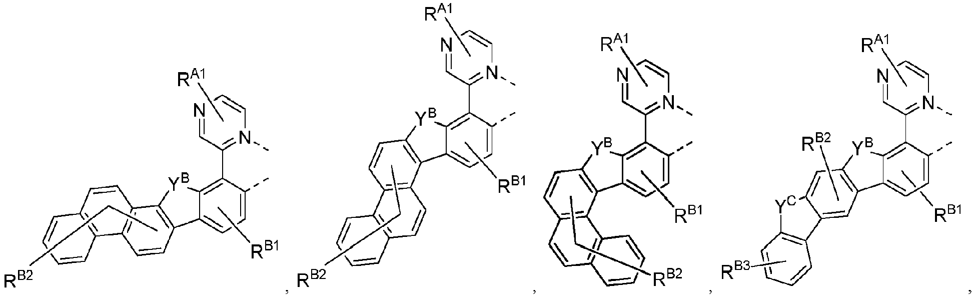 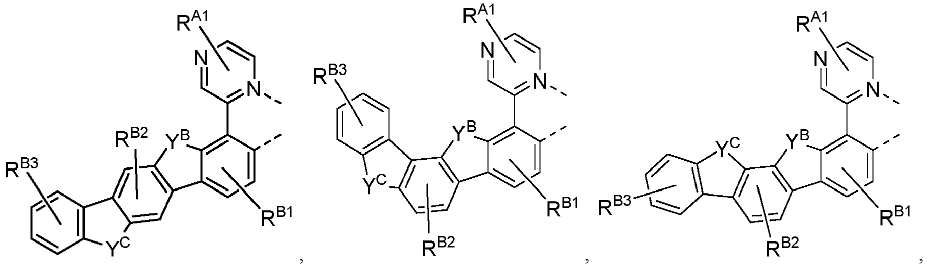 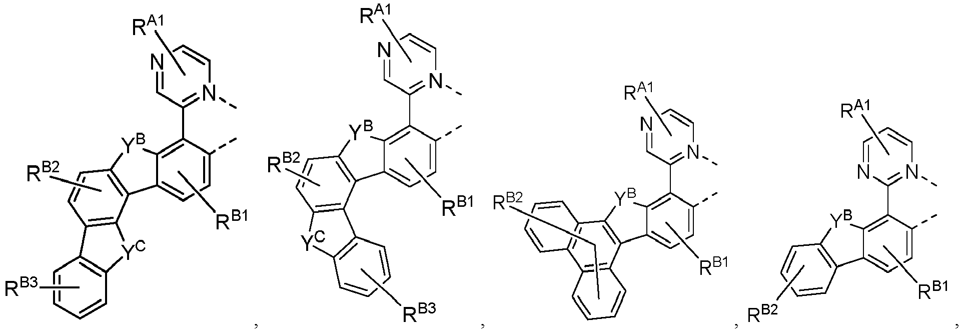 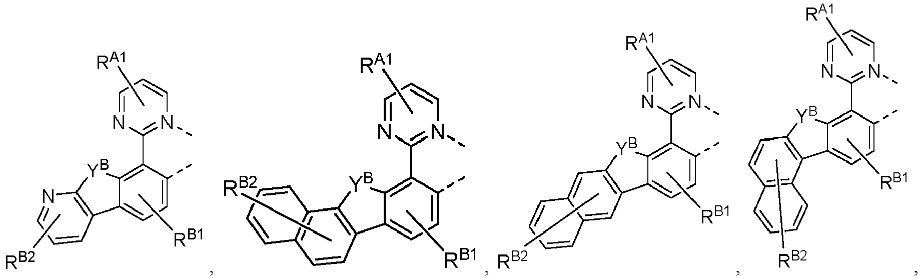 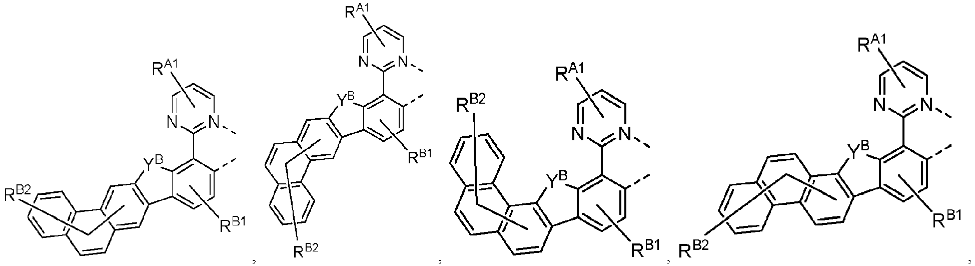 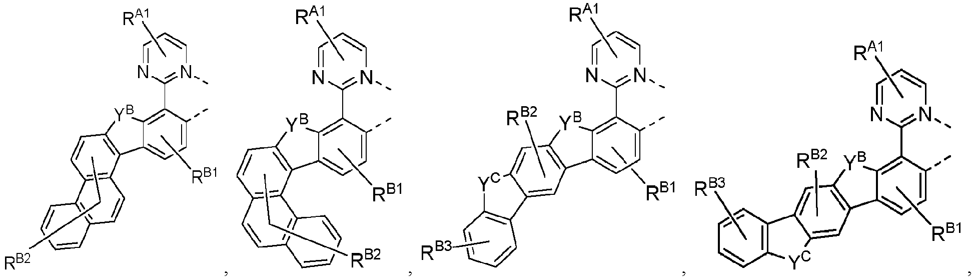 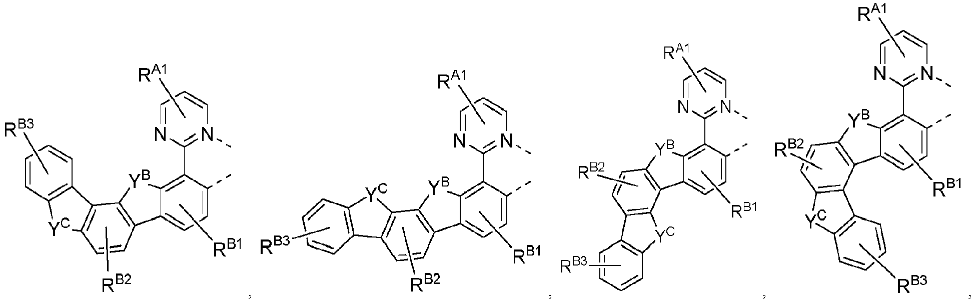 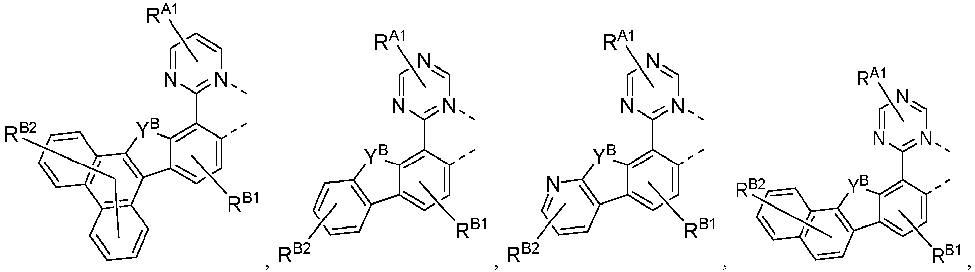 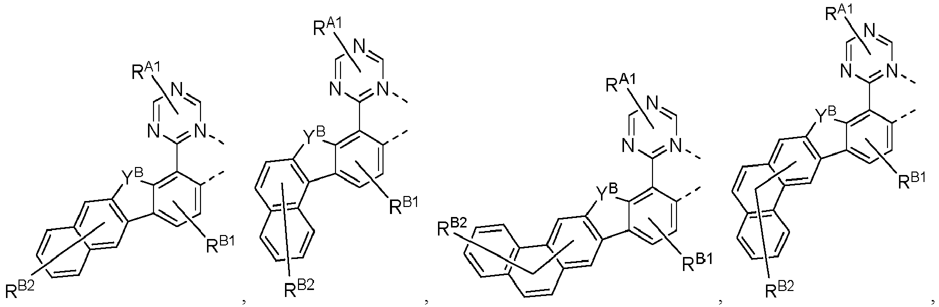 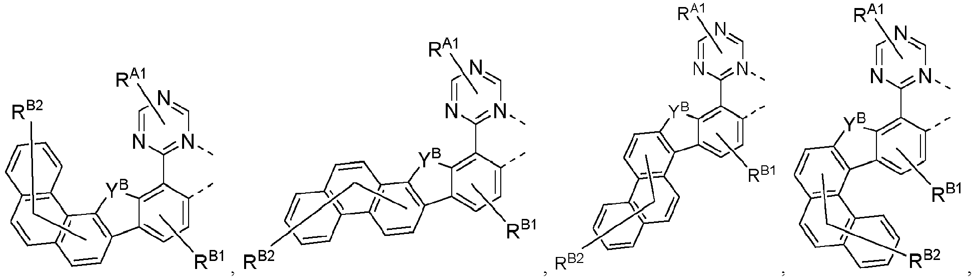 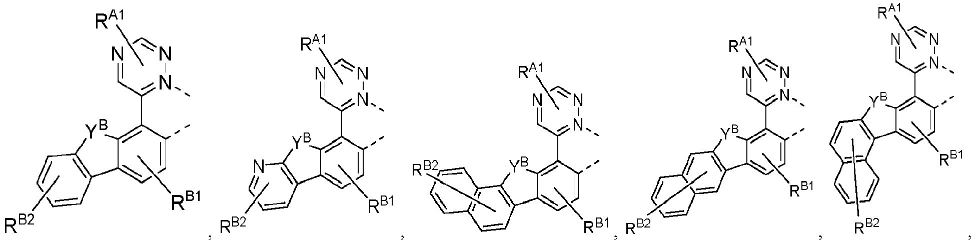 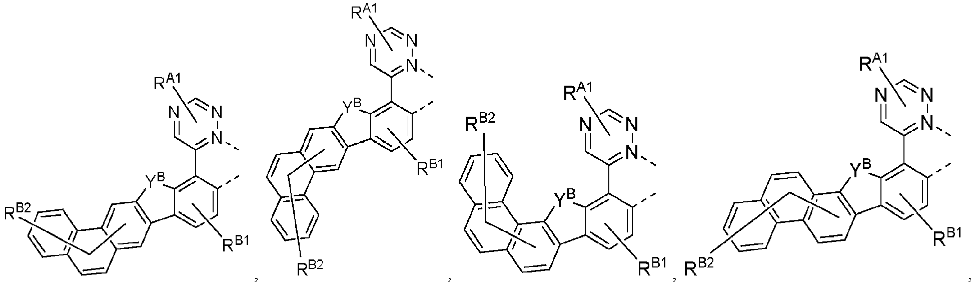 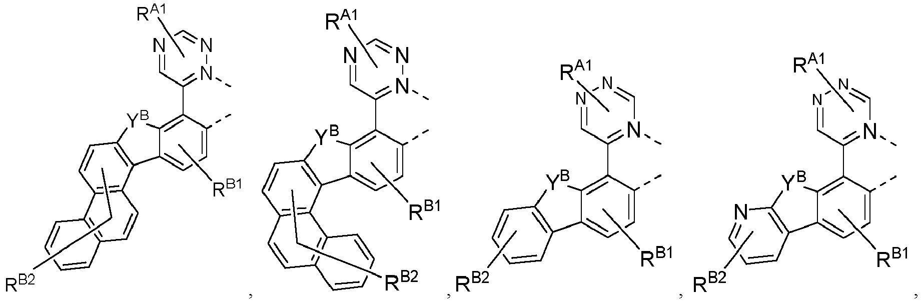 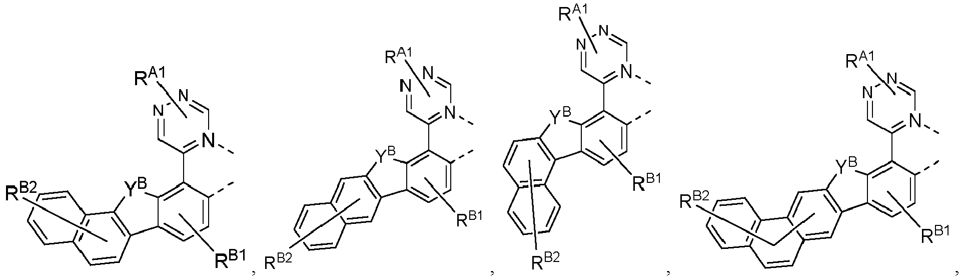 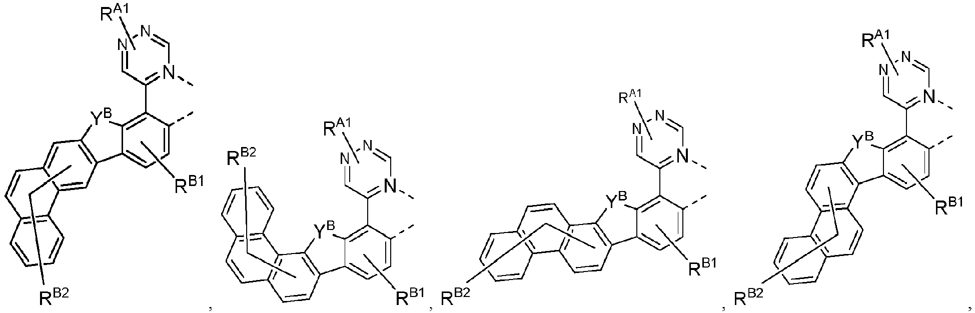 and 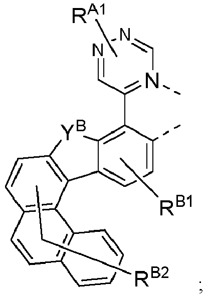 wherein:
each of Y^{A}, Y^{B}, and Y^{C} is independently selected from the group consisting of BRₑ, NRₑ, PRₑ, O, S, Se, C=O, S=O, SO₂, CRₑR_{f}, SiRₑR_{f}, and GeRₑR_{f};
each R^{A1}, R^{B1}, R^{B2}, and R^{B3} independently represent from mono to the maximum possible number of substitutions, or no substitution;
each R^{A1}, R^{B1}, R^{B2}, R^{B3}, Rₑ, and R_{f} is independently a hydrogen or a substituent selected from the group consisting of the General Substituents defined herein; and
any two substituents can be joined or fused to form a ring.

In some embodiments, where ligand L_{A} is selected from LIST 2, at least one of R^{A1}, R^{B1}, R^{B2}, or R^{B3} is partially or fully deuterated. In some embodiments, at least one R^{A1} is partially or fully deuterated. In some embodiments, at least one R^{B1} is partially or fully deuterated. In some embodiments, at least one R^{B2} is partially or fully deuterated. In some embodiments, at least one R^{B3} is partially or fully deuterated. In some embodiments, at least one Rₑ or Rε is partially or fully deuterated.

In some embodiments where ligand L_{A} is selected from LIST 2, at least one R^{A1} is or comprises an electron-withdrawing group from the EWG1 LIST as defined herein. In some embodiments, at least one R^{A1} is or comprises an electron-withdrawing group from the EWG2 LIST as defined herein. In some embodiments, at least one R^{A1} is or comprises an electron-withdrawing group from the EWG3 LIST as defined herein. In some embodiments, at least one R^{A1} is or comprises an electron-withdrawing group from the EWG4 LIST as defined herein. In some embodiments, at least one R^{A1} is or comprises an electron-withdrawing group from the Pi-EWG LIST as defined herein.

In some embodiments where ligand L_{A} is selected from LIST 2, at least one R^{B1} is or comprises an electron-withdrawing group from the EWG1 LIST as defined herein. In some embodiments, at least one R^{B1} is or comprises an electron-withdrawing group from the EWG2 LIST as defined herein. In some embodiments, at least one R^{B1} is or comprises an electron-withdrawing group from the EWG3 LIST as defined herein. In some embodiments, at least one R^{B1} is or comprises an electron-withdrawing group from the EWG4 LIST as defined herein. In some embodiments, at least one R^{B1} is or comprises an electron-withdrawing group from the Pi-EWG LIST as defined herein.

In some embodiments where ligand L_{A} is selected from LIST 2, at least one R^{B2} is or comprises an electron-withdrawing group from the EWG1 LIST as defined herein. In some embodiments, at least one R^{B2} is or comprises an electron-withdrawing group from the EWG2 LIST as defined herein. In some embodiments, at least one R^{B2} is or comprises an electron-withdrawing group from the EWG3 LIST as defined herein. In some embodiments, at least one R^{B2} is or comprises an electron-withdrawing group from the EWG4 LIST as defined herein. In some embodiments, at least one R^{B2} is or comprises an electron-withdrawing group from the Pi-EWG LIST as defined herein.

In some embodiments where ligand L_{A} is selected from LIST 2, at least one R^{B3} is or comprises an electron-withdrawing group from the EWG1 LIST as defined herein. In some embodiments, at least one R^{B3} is or comprises an electron-withdrawing group from the EWG2 LIST as defined herein. In some embodiments, at least one R^{B3} is or comprises an electron-withdrawing group from the EWG3 LIST as defined herein. In some embodiments, at least one R^{B3} is or comprises an electron-withdrawing group from the EWG4 LIST as defined herein. In some embodiments, at least one R^{B3} is or comprises an electron-withdrawing group from the Pi-EWG LIST as defined herein.

In some embodiments where ligand L_{A} is selected from LIST 2, at least one Rₑ or R_{f} is or comprises an electron-withdrawing group from the EWG1 LIST as defined herein. In some embodiments, at least one Rₑ or R_{f} is or comprises an electron-withdrawing group from the EWG2 LIST as defined herein. In some embodiments, at least one Rₑ or R_{f} is or comprises an electron-withdrawing group from the EWG3 LIST as defined herein. In some embodiments, at least one Rₑ or R_{f} is or comprises an electron-withdrawing group from the EWG4 LIST as defined herein. In some embodiments, at least one Rₑ or R_{f} is or comprises an electron-withdrawing group from the Pi-EWG LIST as defined herein.

In some embodiments, the ligand L_{A} is selected from L_{Ai}(R*m*)(R*n*)(R*o*)(R*p*), wherein i is an integer from 1 to 114, and each *Rm,* R*n*, Ro, and R*p* is independently selected from the group consisting of R1 to R115; wherein each of L_{A1}(R1)(R1)(R1)(R1) to L_{A114}(R115)(R1 15)(R115)(R1 15) is defined in the following LIST 3:

| Compound | Structure of compound | Compound | Structure of compound |
|---|---|---|---|
| L_{A1}(R*m*)(R*n*)(R*o*)(R*p*), wherein L_{A1}(R1)(R1)(R1)(R1) to L_{A1}(R115)(R115)(R11 5)(R115) have the structure | 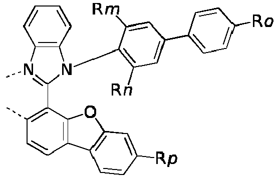 | L_{A2}(R*m*)(R*n*)(R*o*)( R*p*), wherein L_{A2}(R1)(R1)(R1)(R 1) to L_{A2}(R115)(R115)(R 115)(R115) have the structure | 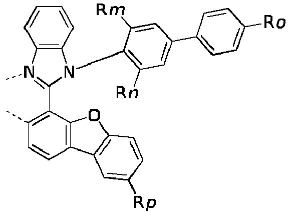 |
| L_{A3}(R*m*)(R*n*)(R*o*)(R*p*), wherein L_{A3}(R1)(R1)(R1)(R1) to L_{A3}(R115)(R115)(R11 5)(R115) have the structure | 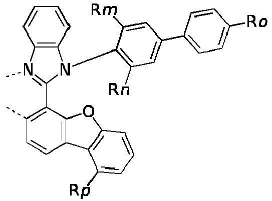 | L_{A4}(R*m*)(R*n*)(R*o*)( R*p*), wherein L_{A4}(R1)(R1)(R1)(R 1) to L_{A4}(R115)(R115)(R 115)(R115) have the structure | 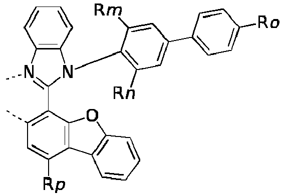 |
| L_{A5}(R*m*)(R*n*)(R*o*)(R*p*), wherein L_{A5}(R1)(R1)(R1)(R1) to L_{A5}(R115)(R115)(R11 5)(R115) have the structure | 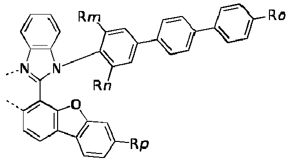 | L_{A6}(R*m*)(R*n*)(R*o*)( R*p*), wherein L_{A6}(R1)(R1)(R1)(R 1) to L_{A6}(R115)(R115)(R 115)(R115) have the structure | 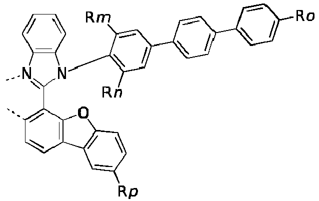 |
| L_{A7}(R*m*)(R*n*)(R*o*)(R*p*), wherein L_{A7}(R1)(R1)(R1)(R1) to L_{A7}(R115)(R115)(R11 5)(R115) have the structure | 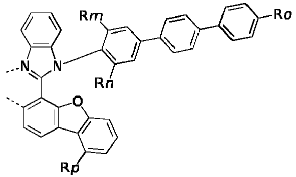 | L_{A8}(R*m*)(R*n*)(R*o*)( R*p*), wherein L_{A8}(R1)(R1)(R1)(R 1) to L_{A8}(R115)(R115)(R 115)(R115) have the structure | 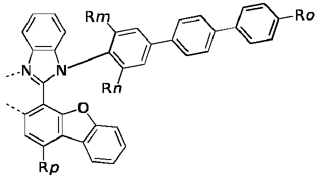 |
| L_{A9}(R*m*)(R*n*)(R*o*)(R*p*), wherein L_{A9}(R1)(R1)(R1)(R1) to L_{A9}(R115)(R115)(R11 5)(R115) have the structure | 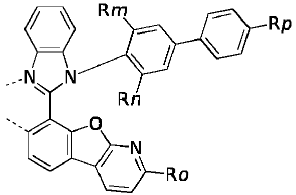 | L_{A10}(R*m*)(R*n*)(R*o*)( R*p*), wherein L_{A10}(R1)(R1)(R1)( R1) to L_{A10}(R115)(R115)( R115)(R115) have the structure | 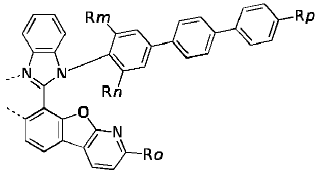 |
| L_{A11}(R*m*)(R*n*)(R*o*)(R*p*), wherein L_{A11}(R1)(R1XR1)(R1) to L_{A11}(R115)(R115)(R11 5)(R115) have the structure | 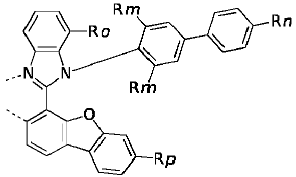 | L_{A12}(R*m*)(R*n*)(R*o*)( R*p*), wherein L_{A12}(R1)(R1)(R1)( R1) to L_{A12}(R115)(R115)( R115)(R115) have the structure | 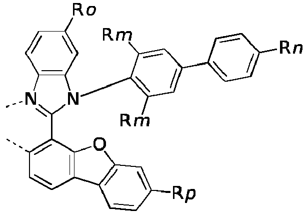 |
| L_{A13}(R*m*)(R*n*)(R*o*)(R*p*), wherein L_{A13}(R1)(R1)(R1)(R1) to L_{A13}(R115)(R115)(R1 15)(R115) have the structure | 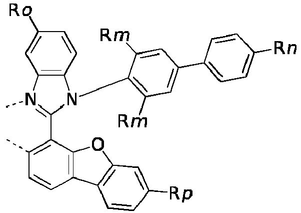 | L_{A14}(R*m*)(R*n*)(R*o*)( R*p*), wherein L_{A14}(R1)(R1)(R1)( R1) to L_{A14}(R115)(R115)( R115)(R115) have the structure | 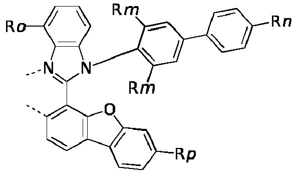 |
| L_{A15}(R*m*)(R*n*)(R*o*)(R*p* ), wherein L_{A15}(R1)(R1)(R1)(R1) to L_{A15}(R115)(R115)(R1 15)(R115) have the structure | 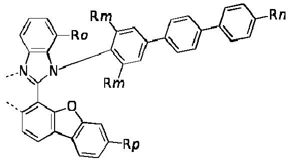 | L_{A16}(R*m*)(R*n*)(R*o*)( R*p*), wherein L_{A16}(R1)(R1)(R1)( R1) to L_{A16}(R115)(R115)( R115)(R115) have the structure | 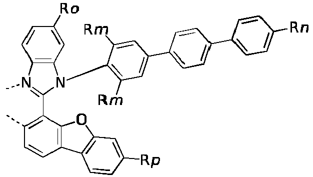 |
| L_{A17}(R*m*)(R*n*)(R*o*)(R*p* ), wherein L_{A17}(R1)(R1)(R1)(R1) to L_{A17}(R115)(R115)(R1 15)(R115) have the structure | 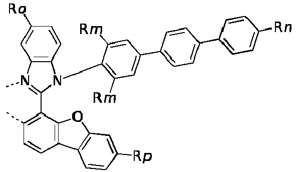 | L_{A18}(R*m*)(R*n*)(R*o*)( R*p*), wherein L_{A18}(R1)(R1)(R1)( R1) to L_{A18}(R115)(R115)( R115)(R115) have the structure | 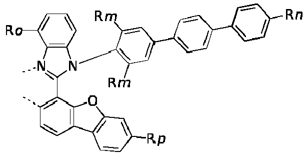 |
| L_{A19}(R*m*)(R*n*)(R*o*)(R*p* ), wherein L_{A19}(R1)(R1)(R1)(R1) to L_{A19}(R115)(R115)(Rl 15)(R115) have the structure | 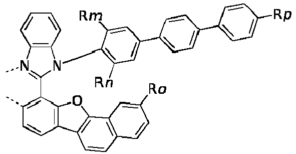 | L_{A20}(R*m*)(R*n*)(R*o*)( R*p*), wherein L_{A20}(R1)(R1)(R1)( R1) to L_{A20}(R115)(R115)( R115)(R115) have the structure | 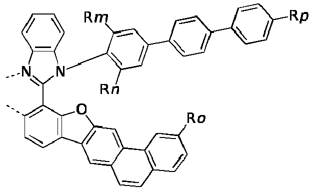 |
| L_{A21}(R*m*)(R*n*)(R*o*)(R*p* ), wherein L_{A21}(R1)(R1)(R1)(R1) to L_{A21}(R115)(R115)(R1 15)(R115) have the structure | 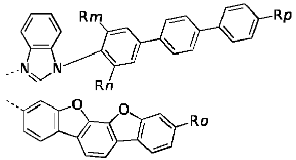 | L_{A22}(R*m*)(R*n*)(R*o*)( R*p*), wherein L_{A22}(R1)(R1)(R1)( R1) to L_{A22}(R115)(R115)( R115)(R115) have the structure | 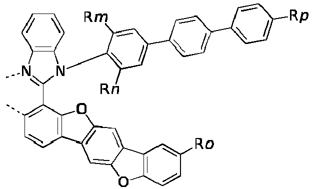 |
| L_{A23}(R*m*)(R*n*)(R*o*)(R*p* ), wherein L_{A23}(R1)(R1)(R1)(R1) to L_{A23}(R115)(R115)(R1 15)(R115) have the structure | 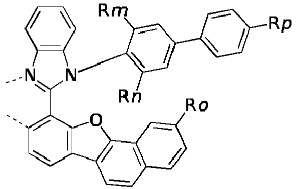 | L_{A24}(R*m*)(R*n*)(R*o*)( R*p*), wherein L_{A24}(R1)(R1)(R1)( R1) to L_{A24}(R115)(R115)( R115)(R115) have the structure | 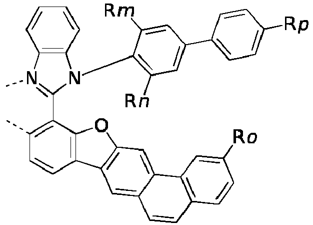 |
| L_{A25}(R*m*)(R*n*)(R*o*)(R*p* ), wherein L_{A25}(R1)(R1)(R1)(R1) to L_{A25}(R115)(R115)(R1 15)(R115) have the structure | 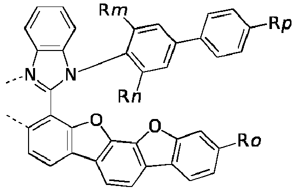 | L_{A26}(R*m*)(R*n*)(R*o*)( R*p*), wherein L_{A26}(R1)(R1)(R1)( R1) to L_{A26}(R115)(R115)( R115)(R115) have the structure | 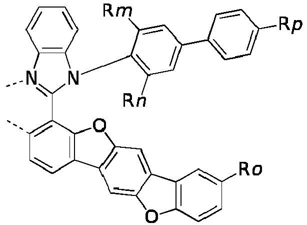 |
| L_{A27}(R*m*)(R*n*)(R*o*)(R*p* ), wherein L_{A27}(R1)(R1)(R1)(R1) to L_{A27}(R115)(R115)(R1 15)(R115) have the structure | 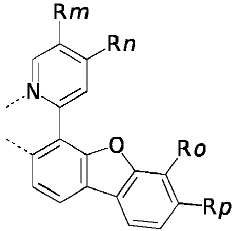 | L_{A28}(R*m*)(R*n*)(R*o*)( R*p*), wherein L_{A28}(R1)(R1)(R1)( R1) to L_{A28}(R115)(R115)( R115)(R115) have the structure | 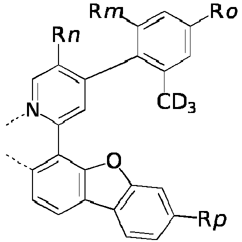 |
| L_{A29}(R*m*)(R*n*)(R*o*)(R*p* ), wherein L_{A29}(R1)(R1)(R1)(R1) to L_{A29}(R115)(R115)(R1 15)(R115) have the structure | 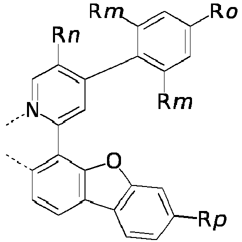 | L_{A30}(R*m*)(R*n*)(R*o*)( R*p*), wherein L_{A30}(R1)(R1)(R1)( R1) to L_{A30}(R115)(R115)( R115)(R115) have the structure | 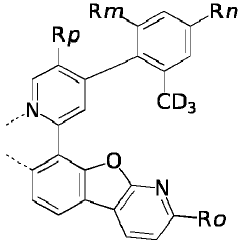 |
| L_{A31}(R*m*)(R*n*)(R*o*)(R*p* ), wherein L_{A31}(R1)(R1)(R1)(R1) to L_{A31}(R115)(R115)(R1 15)(R115) have the structure | 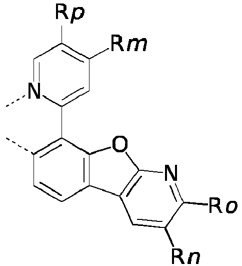 | L_{A32}(R*m*)(R*n*)(R*o*)( R*p*), wherein L_{A32}(R1)(R1)(R1)( R1) to L_{A32}(R115)(R115)( R115)(R115) have the structure | 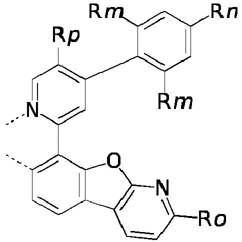 |
| L_{A33}(R*m*)(R*n*)(R*o*)(R*p* ), wherein L_{A33}(R1)(R1)(R1)(R1) to L_{A33}(R115)(R115)(R1 15)(R115) have the structure | 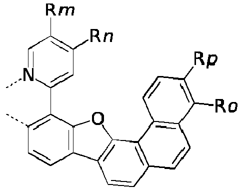 | L_{A34}(R*m*)(R*n*)(R*o*)( R*p*), wherein L_{A34}(R1)(R1)(R1)( R1) to L_{A34}(R115)(R115)( R115)(R115) have the structure | 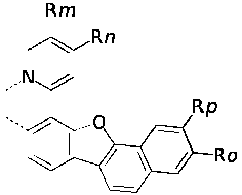 |
| L_{A35}(R*m*)(R*n*)(R*o*)(R*p* ), wherein L_{A35}(R1)(R1)(R1)(R1) to L_{A35}(R115)(R115)(R1 15)(R115) have the structure | 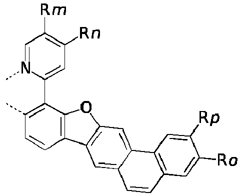 | L_{A36}(R*m*)(R*n*)(R*o*)( R*p*), wherein L_{A36}(R1)(R1)(R1)( R1) to L_{A36}(R115)(R115)( R115)(R115) have the structure | 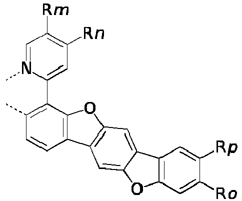 |
| L_{A37}(R*m*)(R*n*)(R*o*)(R*p* ), wherein L_{A37}(R1)(R1)(R1)(R1) to L_{A37}(R115)(R115)(R1 15)(R115) have the structure | 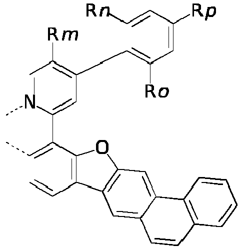 | L_{A38}(R*m*)(R*n*)(R*o*)( R*p*), wherein L_{A38}(R1)(R1)(R1)( R1) to L_{A38}(R115)(R115)( R115)(R115) have the structure | 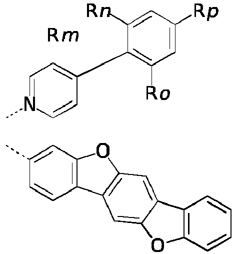 |
| L_{A39}(R*m*)(R*n*)(R*o*)(R*p* ), wherein L_{A39}(R1)(R1)(R1)(R1) to L_{A39}(R115)(R115)(R1 15)(R115) have the structure | 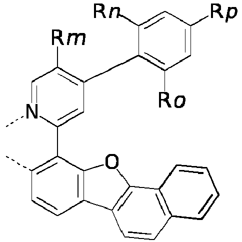 | L_{A40}(R*m*)(R*n*)(R*o*)( R*p*), wherein L_{A40}(R1)(R1)(R1)( R1) to L_{A40}(R115)(R115)( R115)(R115) have the structure | 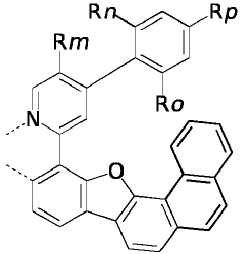 |
| L_{A41}(R*m*)(R*n*)(R*o*)(R*p* ), wherein L_{A41}(R1)(R1)(R1)(R1) to L_{A41}(R115)(R115)(R1 15)(R115) have the structure | 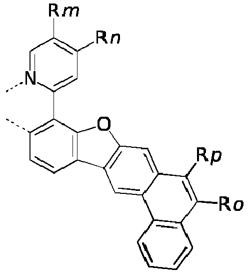 | L_{A42}(R*m*)(R*n*)(R*o*)( R*p*), wherein L_{A42}(R1)(R1)(R1)( R1) to L_{A42}(R115)(R115)( R115)(R115) have the structure | 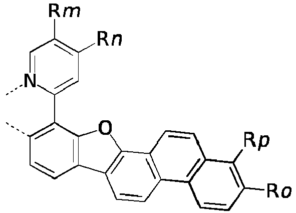 |
| L_{A43}(R*m*)(R*n*)(R*o*)(R*p* ), wherein L_{A43}(R1)(R1)(R1)(R1) to L_{A43}(R115)(R115)(R1 15)(R115) have the structure | 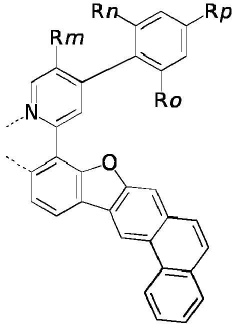 | L_{A44}(R*m*)(R*n*)(R*o*)( R*p*), wherein L_{A44}(R1)(R1)(R1)( R1) to L_{A44}(R115)(R115)( R115)(R115) have the structure | 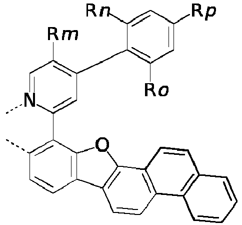 |
| L_{A45}(R*m*)(R*n*)(R*o*)(R*p* ), wherein L_{A45}(R1)(R1)(R1)(R1) to L_{A45}(R115)(R115)(R1 15)(R115) have the structure | 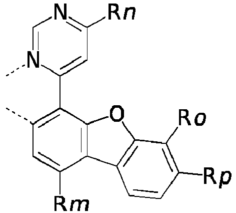 | L_{A46}(R*m*)(R*n*)(R*o*)( R*p*), wherein L_{A46}(R1)(R1)(R1)( R1) to L_{A46}(R115)(R115)( R115)(R115) have the structure | 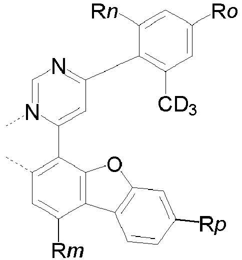 |
| L_{A47}(R*m*)(R*n*)(R*o*)(R*p* ), wherein L_{A47}(R1)(R1)(R1)(R1) to L_{A47}(R115)(R115)(R1 15)(R115) have the structure | 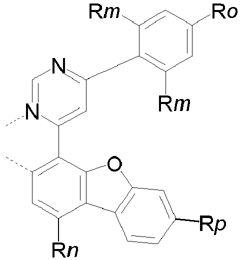 | L_{A48}(R*m*)(R*n*)(R*o*)( R*p*)*,* wherein L_{A48}(R1)(R1)(R1)( R1) to L_{A48}(R115)(R115)( R115)(R115) have the structure | 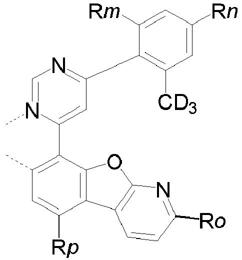 |
| L_{A49}(R*m*)(R*n*)(R*o*) (R*p*), wherein L_{A49}(R1)(R1)(R1)(R1) to L_{A49}(R115)(R115)(R1 15)(R115) have the structure | 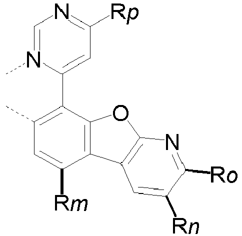 | L_{A50}(R*m*)(R*n*)(R*o*)( R*p*), wherein L_{A50}(R1)(R1)(R1)( R1) to L_{A50}(R115)(R115)( R115)(R115) have the structure | 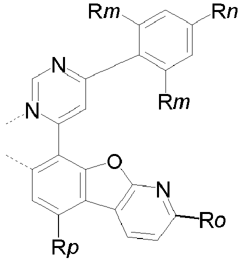 |
| L_{A51}(R*m*)(R*n*)(R*o*)(R*p* ), wherein L_{A51}(R1)(R1)(R1)(R1) to L_{A51}(R115)(R115)(R1 15)(R115) have the structure | 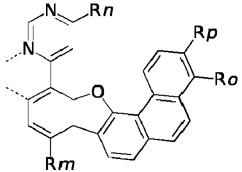 | L_{A52}(R*m*)(R*n*)(R*o*)( R*p*), wherein L_{A52}(R1)(R1)(R1)( R1) to L_{A52}(R115)(R115)( R115)(R115) have the structure | 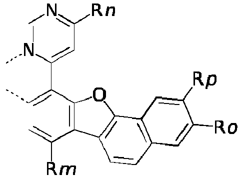 |
| L_{A53}(R*m*)(R*n*)(R*o*)(R*p* ), wherein L_{A53}(R1)(R1)(R1)(R1) to L_{A53}(R115)(R115)(R1 15)(R115) have the structure | 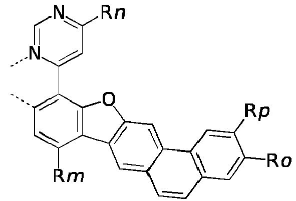 | L_{A54}(R*m*)(R*n*)(R*o*)( R*p*), wherein L_{A54}(R1)(R1)(R1)( R1) to L_{A54}(R115)(R115)( R115)(R115) have the structure | 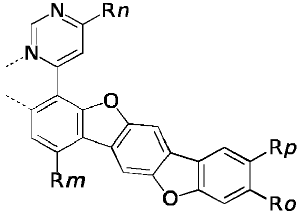 |
| L_{A55}(R*m*)(R*n*)(R*o*)(R*p* ), wherein L_{A55}(R1)(R1)(R1)(R1) to L_{A55}(R115)(R115)(R1 15)(R115) have the structure | 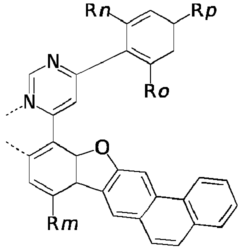 | L_{A56}(R*m*)(R*n*)(R*o*)( R*p*), wherein L_{A36}(R1)(R1)(R1)( R1) to L_{A56}(R115)(R115)( R115)(R115) have the structure | 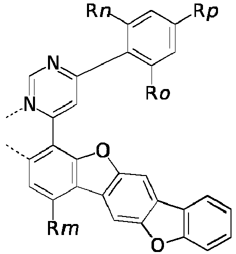 |
| L_{A57}(R*m*)(R*n*)(R*o*)(R*p* ), wherein L_{A57}(R1)(R1)(R1)(R1) to L_{A57}(R115)(R115)(R1 15)(R115) have the structure | 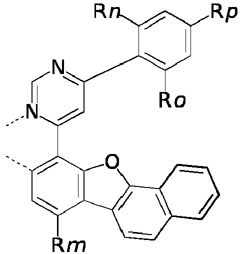 | L_{A58}(R*m*)(R*n*)(R*o*)( R*p*), wherein L_{A58}(R1)(R1)(R1)( R1) to L_{A58}(R115)(R115)( R115)(R115) have the structure | 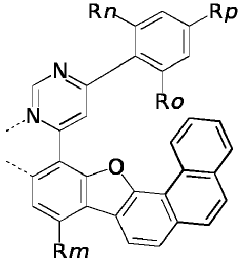 |
| L_{A59}(R*m*)(R*n*)(R*o*)(R*p* ), wherein L_{A59}(R1)(R1)(R1)(R1) to L_{A59}(R115)(R115)(R1 15)(R115) have the structure | 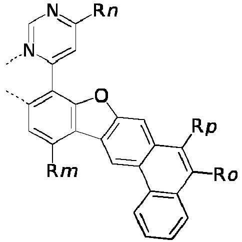 | L_{A60}(R*m*)(R*n*)(R*o*)( R*p*), wherein L_{A60}(R1)(R1)(R1)( R1) to L_{A60}(R115)(R115)( R115)(R115) have the structure | 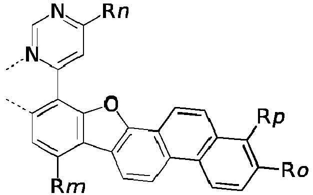 |
| L_{A61}(R*m*)(R*n*)(R*o*)(R*p* ), wherein L_{A61}(R1)(R1)(R1)(R1) to L_{A61}(R115)(R115)(R1 15)(R115) have the structure | 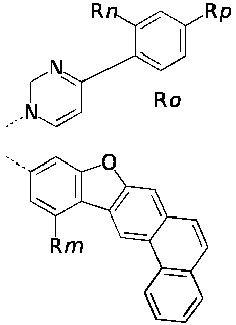 | L_{A62}(R*m*)(R*n*)(R*o*)( R*p*), wherein L_{A62}(R1)(R1)(R1)( R1) to L_{A62}(R115)(R115)( R115)(R115) have the structure | 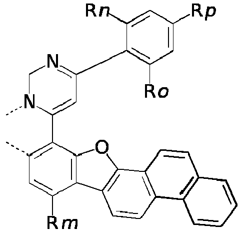 |
| L_{A63}(R*m*)(R*n*)(R*o*)(R*p* ), wherein L_{A63}(R1)(R1)(R1)(R1) to L_{A63}(R115)(R115)(R1 15)(R115) have the structure | 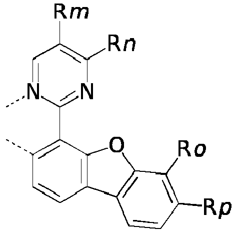 | L_{A64}(R*m*)(R*n*)(R*o*)( R*p*), wherein L_{A64}(R1)(R1)(R1)( R1) to L_{A64}(R115)(R115)( R115)(R115) have the structure | 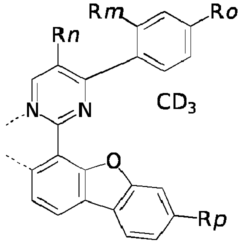 |
| L_{A65}(R*m*)(R*n*)(R*o*)(R*p* ), wherein L_{A65}(R1)(R1)(R1)(R1) to L_{A65}(R115)(R115)(R1 15)(R115) have the structure | 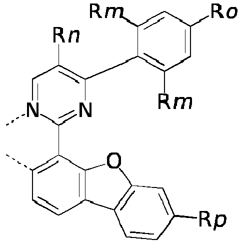 | L_{A66}(R*m*)(R*n*)(R*o*)( Rp*)*, wherein L_{A66}(R1)(R1)(R1)( R1) to L_{A66}(R115)(R115)( R115)(R115) have the structure | 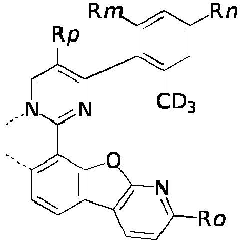 |
| L_{A67}(R*m*)(R*n*)(R*o*)(R*p* ), wherein L_{A67}(R1)(R1)(R1)(R1) to L_{A67}(R115)(R115)(R1 15)(R115) have the structure | 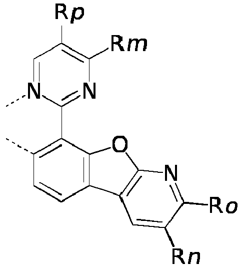 | L_{A68}(R*m*)(R*n*)(R*o*)( R*p*), wherein L_{A68}(R1)(R1)(R1)( R1) to L_{A68}(R115)(R115)( R115)(R115) have the structure | 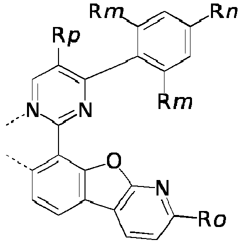 |
| L_{A69}(R*m*)(R*n*)(R*o*)(R*p* ), wherein L_{A69}(R1)(R1)(R1)(R1) to L_{A69}(R115)(R115)(R1 15)(R115) have the structure | 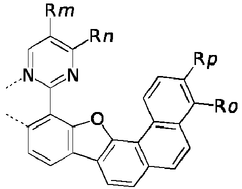 | L_{A70}(R*m*)(R*n*)(R*o*)( R*p*), wherein L_{A70}(R1)(R1)(R1)( R1) to L_{A70}(R115)(R115)( R115)(R115) have the structure | 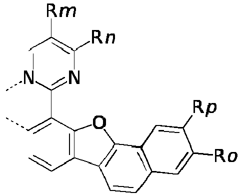 |
| L_{A71}(R*m*)(R*n*)(R*o*)(R*p* ), wherein L_{A71}(R1)(R1)(R1)(R1) to L_{A71}(R115)(R115)(R1 15)(R115) have the structure | 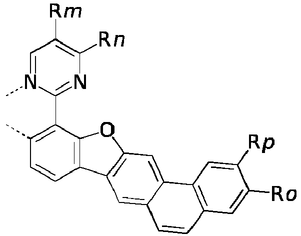 | L_{A72}(R*m*)(R*n*)(R*o*)( R*p*), wherein L_{A72}(R1)(R1)(R1)( R1) to L_{A72}(R115)(R115)( R115)(R115) have the structure | 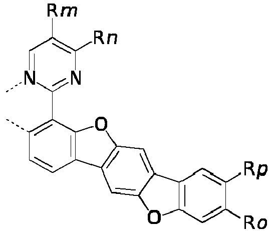 |
| L_{A73}(R*m*)(R*n*)(R*o*)(R*p* ), wherein L_{A73}(R1)(R1)(R1)(R1) to L_{A73}(R115)(R115)(R1 15)(R115) have the structure | 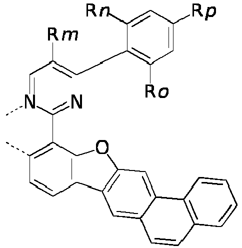 | L_{A74}(R*m*)(R*n*)(R*o*)( R*p*), wherein L_{A74}(R1)(R1)(R1)( R1) to L_{A74}(R115)(R115)( R115)(R115) have the structure | 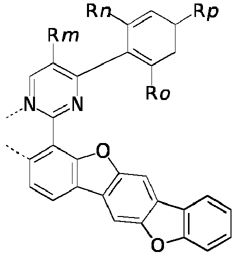 |
| L_{A75}(R*m*)(R*n*)(R*o*)(R*p* ), wherein L_{A75}(R1)(R1)(R1)(R1) to L_{A75}(R115)(R115)(R1 15)(R115) have the structure | 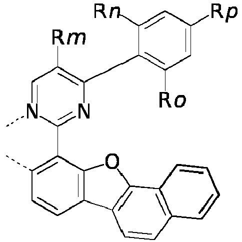 | L_{A76}(R*m*)(R*n*)(R*o*)( R*p*), wherein L_{A76}(R1)(R1)(R1)( R1) to L_{A76}(R115)(R115)( R115)(R115) have the structure | 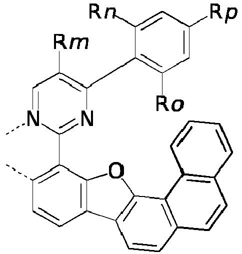 |
| L_{A77}(R*m*)(R*n*)(R*o*)(R*p* ), wherein L_{A77}(R1)(R1)(R1)(R1) to L_{A77}(R115)(R115)(R1 15)(R115) have the structure | 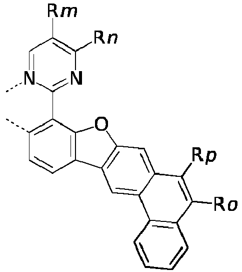 | L_{A78}(R*m*)(R*n*)(R*o*)( R*p*), wherein L_{A78}(R1)(R1)(R1)( R1) to L_{A78}(R115)(R115)( R115)(R115) have the structure | 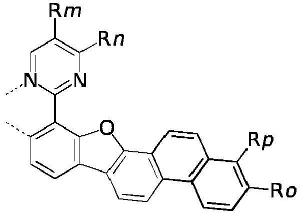 |
| L_{A79}(R*m*)(R*n*)(R*o*)(R*p* ), wherein L_{A79}(R1)(R1)(R1)(R1) to L_{A79}(R115)(R115)(R1 15)(R115) have the structure | 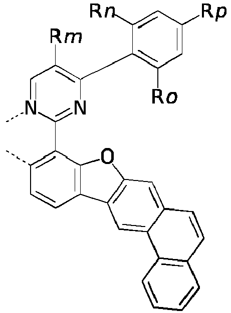 | L_{A80}(R*m*)(R*n*)(R*o*)( R*p*), wherein L_{A80}(R1)(R1)(R1)( R1) to L_{A80}(R115)(R115)( R115)(R115) have the structure | 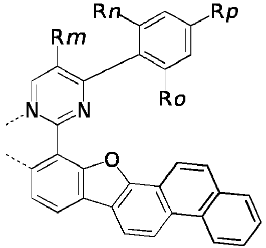 |
| L_{A81}(R*m*)(R*n*)(R*o*)(R*p* ), wherein L_{A81}(R1)(R1)(R1)(R1) to L_{A81}(R115)(R115)(R1 15)(R115) have the structure | 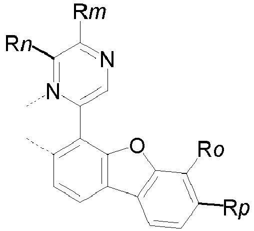 | L_{A82}(R*m*)(R*n*)(R*o*)( R*p*), wherein L_{A82}(R1)(R1)(R1)( R1) to L_{A82}(R115)(R115)( R115)(R115) have the structure | 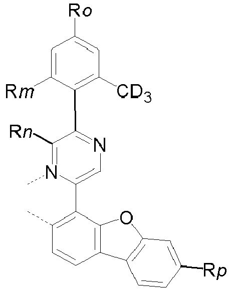 |
| L_{A83}(R*m*)(R*n*)(R*o*)(R*p* ), wherein L_{A83}(R1)(R1)(R1)(R1) to L_{A83}(R115)(R115)(R1 15)(R115) have the structure | 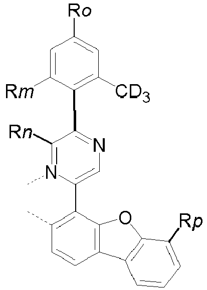 | L_{A84}(R*m*)(R*n*)(R*o*)( R*p*), wherein L_{A84}(R1)(R1)(R1)( R1) to L_{A84}(R115)(R115)( R115)(R115) have the structure | 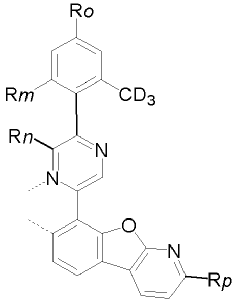 |
| L_{A85}(R*m*)(R*n*)(R*o*)(R*p* ), wherein L_{A85}(R1)(R1)(R1)(R1) to L_{A85}(R115)(R115)(R1 15)(R115) have the structure | 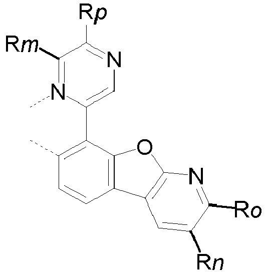 | L_{A86}(R*m*)(R*n*)(R*o*)( R*p*), wherein L_{A36}(R1)(R1)(R1)( R1) to L_{A86}(R115)(R115)( R115)(R115) have the structure | 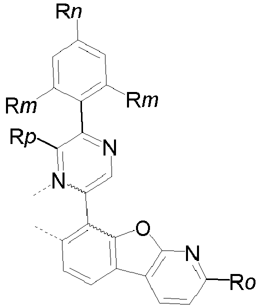 |
| L_{A87}(R*m*)(R*n*)(R*o*)(R*p* ), wherein L_{A87}(R1)(R1)(R1)(R1) to L_{A87}(R115)(R115)(R1 15)(R115) have the structure | 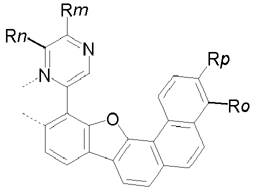 | L_{A88}(R*m*)(R*n*)(R*o*)( R*p*), wherein L_{A88}(R1)(R1)(R1)( R1) to L_{A88}(R115)(R115)( R115)(R115) have the structure | 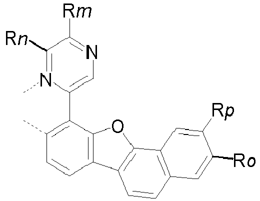 |
| L_{A89}(R*m*)(R*n*)(R*o*)(R*p* ), wherein L_{A89}(R1)(R1)(R1)(R1) to L_{A89}(R115)(R115)(R1 15)(R115) have the structure | 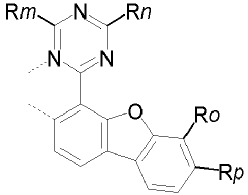 | L_{A90}(R*m*)(R*n*)(R*o*)( R*p*), wherein L_{A90}(R1)(R1)(R1)( R1) to L_{A90}(R115)(R115)( R115)(R115) have the structure | 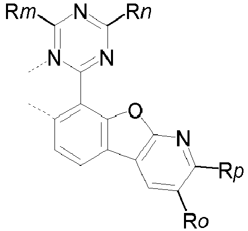 |
| L_{A91}(R*m*)(R*n*)(R*o*)(R*p* ), wherein L_{A91}(R1)(R1)(R1)(R1) to L_{A91}(R115)(R115)(R1 15)(R115) have the structure | 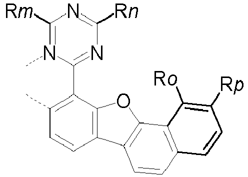 | L_{A92}(R*m*)(R*n*)(R*o*)( R*p*), wherein L_{A92}(R1)(R1)(R1)( R1) to L_{A92}(R115)(R115)( R115)(R115) have the structure | 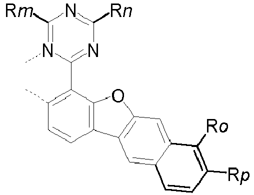 |
| L_{A93}(R*m*)(R*n*)(R*o*)(R*p* ), wherein L_{A93}(R1)(R1)(R1)(R1) to L_{A93}(R115)(R115)(R1 15)(R115) have the structure | 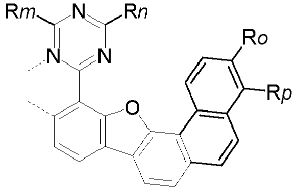 | L_{A94}(R*m*)(R*n*)(R*o*)( R*p*), wherein L_{A94}(R1)(R1)(R1)( R1) to L_{A94}(R115)(R115)( R115)(R115) have the structure | 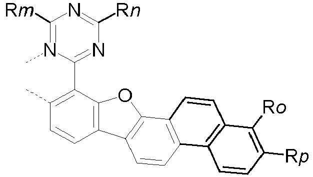 |
| L_{A95}(R*m*)(R*n*)(R*o*)(R*p* ), wherein L_{A95}(R1)(R1)(R1)(R1) to L_{A95}(R115)(R115)(R1 15)(R115) have the structure | 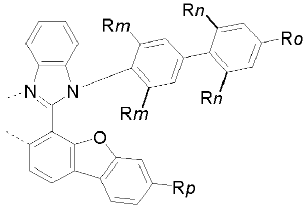 | L_{A96}(R*m*)(R*n*)(R*o*)( R*p*), wherein L_{A96}(R1)(R1)(R1)( R1) to L_{A96}(R115)(R115)( R115)(R115) have the structure | 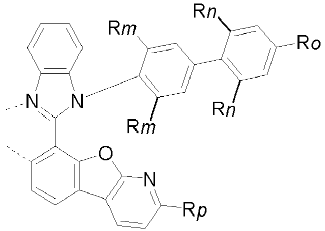 |
| L_{A97}(R*m*)(R*n*)(R*o*)(R*p* ), wherein L_{A97}(R1)(R1)(R1)(R1) to L_{A97}(R115)(R115)(R1 15)(R115) have the structure | 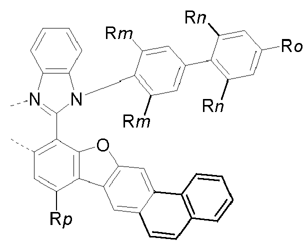 | L_{A98}(R*m*)(R*n*)(R*o*)( R*p*), wherein L_{A98}(R1)(R1)(R1)( R1) to L_{A98}(R115)(R115)( R115)(R115) have the structure | 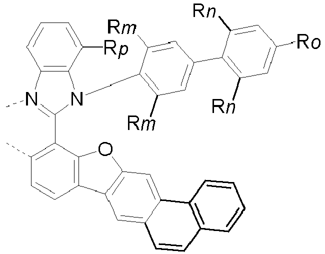 |
| L_{A99}(R*m*)(R*n*)(R*o*)(R*p* ), wherein L_{A99}(R1)(R1)(R1)(R1) to L_{A99}(R115)(R115)(R1 15)(R115) have the structure | 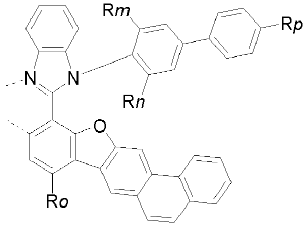 | L_{A100}(R*m*)(R*n*)(R*o*) (R*p*), wherein L_{A100}(R1)(R1)(R1)( R1) to L_{A100}(R115)(R115)( R115)(R115) have the structure | 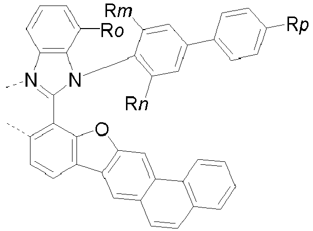 |
| L_{A101}(R*m*)(R*n*)(R*o*)(R *p*), wherein L_{A101}(R1)(R1)(R1)(R1 ) to L_{A101}(R115)(R115)(R1 15)(R115) have the structure | 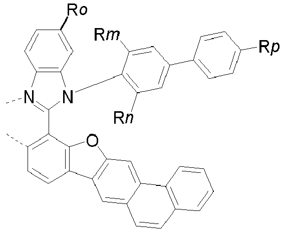 | L_{A102}(R*m*)(R*n*)(R*o*) (R*p*), wherein L_{A102}(R1)(R1)(R1)( R1) to L_{A102}(R115)(R115)( R115)(R115) have the structure | 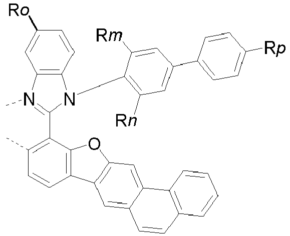 |
| L_{A103}(R*m*)(R*n*)(R*o*)(R *p*), wherein L_{A103}(R1)(R1)(R1)(R1 ) to L_{A13}(R115)(R115)(R1 15)(R115) have the structure | 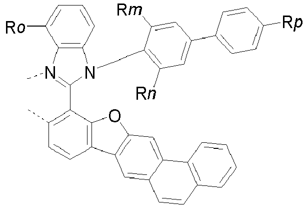 | L_{A104}(R*m*)(R*n*)(R*o*) (R*p*), wherein L_{A104}(R1)(R1)(R1)( R1) to L_{A104}(R115)(R115)( R115)(R115) have the structure | 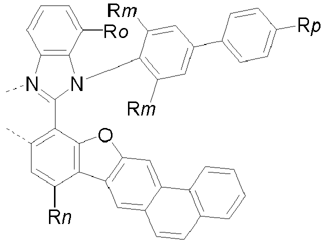 |
| L_{A104}(R*m*)(R*n*)(R*o*)(R *p*), wherein L_{A105}(R1)(R1)(R1)(R1 ) to L_{A105}(R115)(R115)(R1 15)(R115) have the structure | 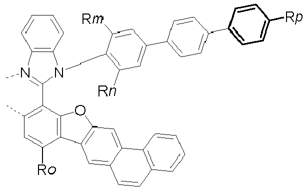 | L_{A106}(R*m*)(R*n*)(R*o*) (R*p*), wherein L_{A106}(R1)(R1)(R1)( R1) to L_{A106}(R115)(R115)( R115)(R115) have the structure | 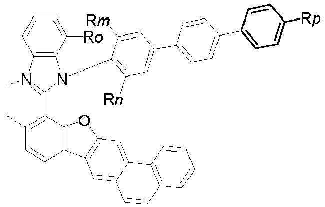 |
| L_{A107}(R*m*)(R*n*)(R*o*)(R *p*), wherein L_{A107}(R1)(R1)(R1)(R1 ) to L_{A107}(R115)(R115)(R1 15)(R115) have the structure | 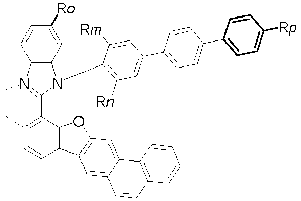 | L_{A108}(R*m*)(R*n*)(R*o*) (R*p*), wherein L_{A108}(R1)(R1)(R1)( R1) to L_{A108}(R115)(R115)( R115)(R115) have the structure | 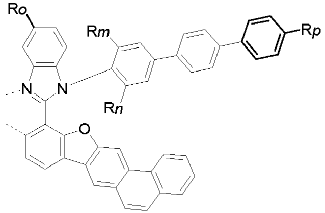 |
| L_{A109}(R*m*)(R*n*)(R*o*)(R *p*), wherein L_{A109}(R1)(R1)(R1)(R1 ) to L_{A109}(R115)(R115)(R1 15)(R115) have the structure | 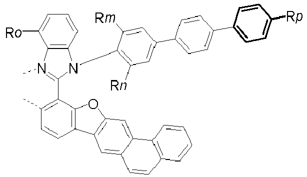 | L_{A110}(R*m*)(R*n*)(R*o*) (R*p*), wherein L_{A110}(R1)(R1)(R1)( R1) to L_{A110}(R115)(R115)( R115)(R115) have the structure | 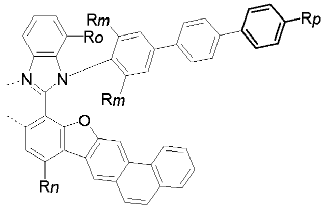 |
| L_{A111}(R*m*)(R*n*)(R*o*)(R*p* ), wherein L_{A111}(R1)(R1)(R1)(R1 ) to L_{A111}(R115)(R115)(R1 15)(R115) have the structure | 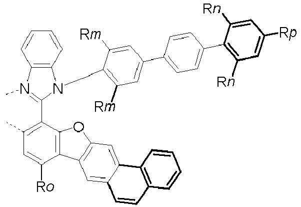 | L_{A112}(R*m*)(R*n*)(R*o*) (R*p*), wherein L_{A112}(R1)(R1)(R1)( R1) to L_{A112}(R115)(R115)( R115)(R115) have the structure | 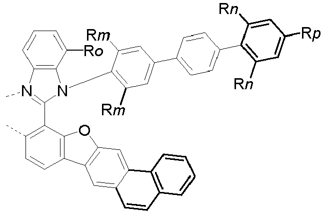 |
| L_{A113}(R*m*)(R*n*)(R*o*)(R*p* ), wherein L_{A113}(R1)(R1)(R1)(R1 ) to L_{A113}(R115)(R115)(R1 15)(R115) have the structure | 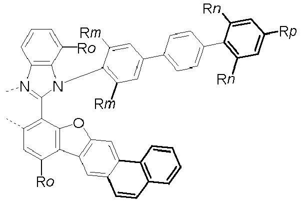 | L_{A114}(R*m*)(R*n*)(R*o*) (R*p*), wherein L_{A114}(R1)(R1)(R1)( R1) to L_{A114}(R115)(R115)( R115)(R115) have the structure | 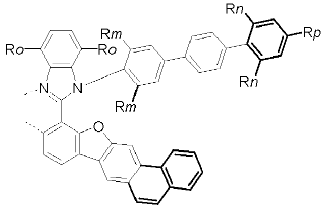 |

wherein R1 to R115 each have the structures defined in the following LIST 4:

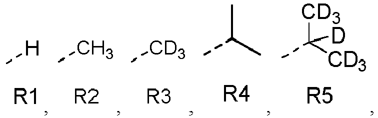

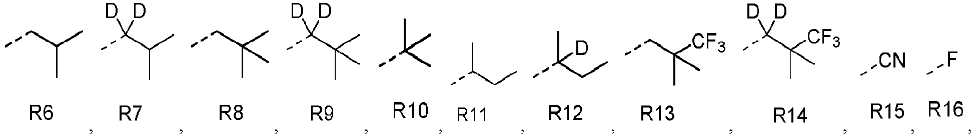

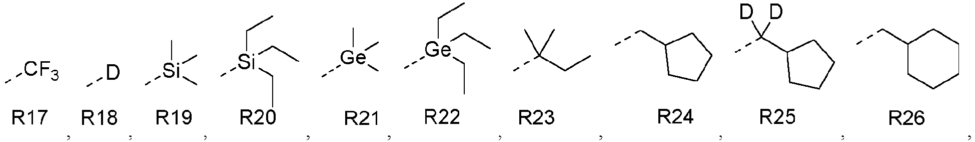

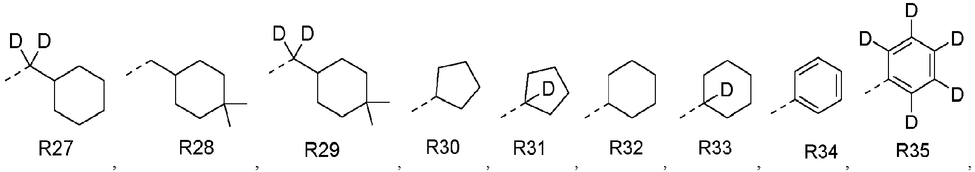

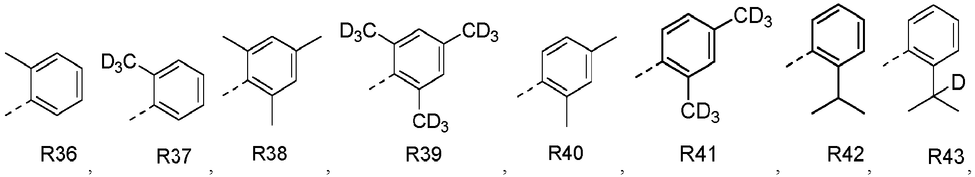

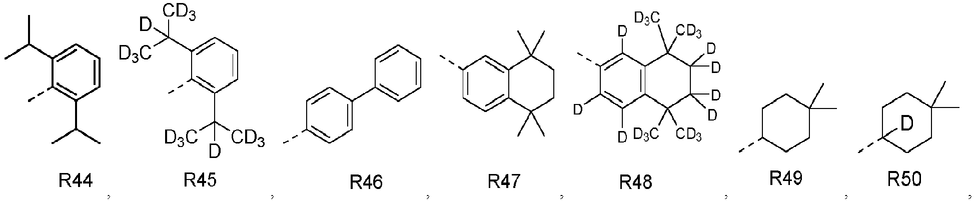

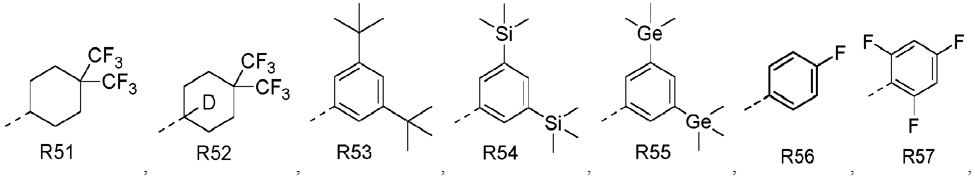

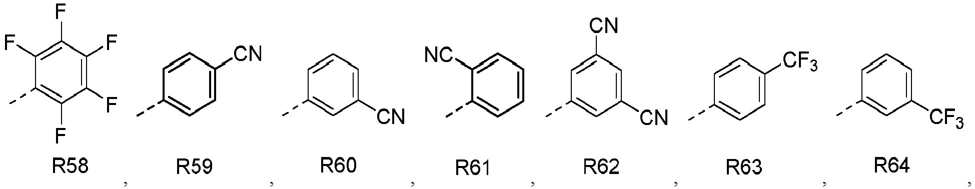

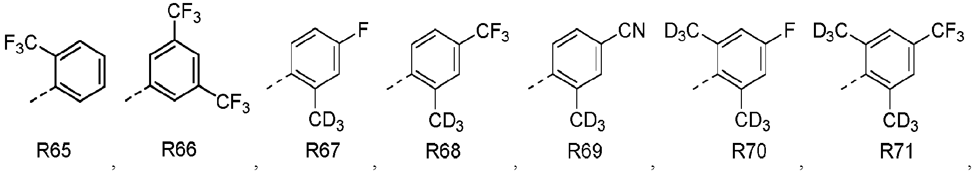

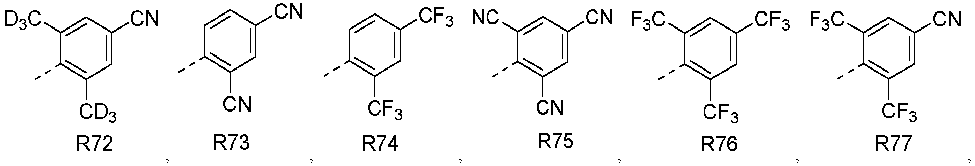

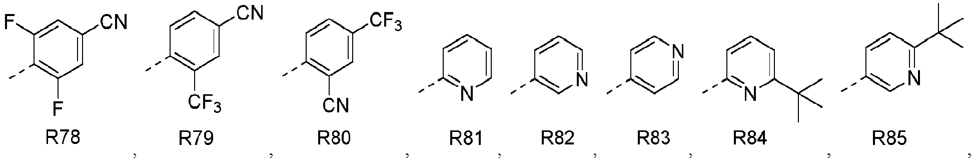

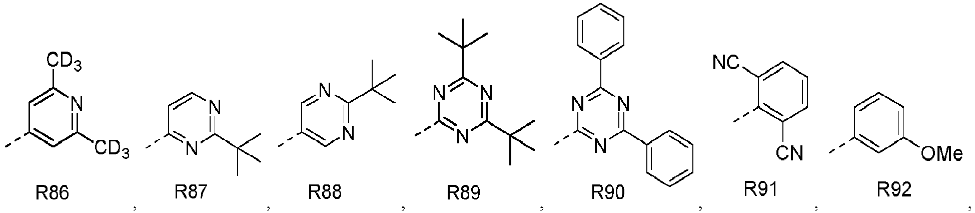

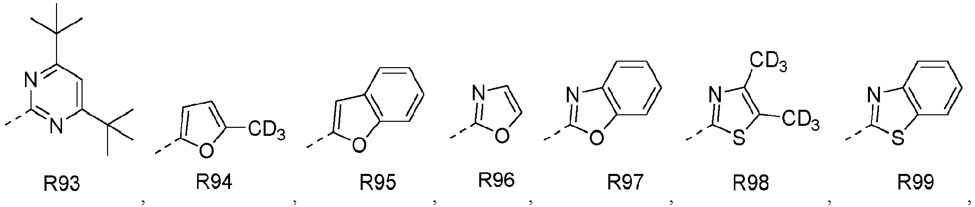

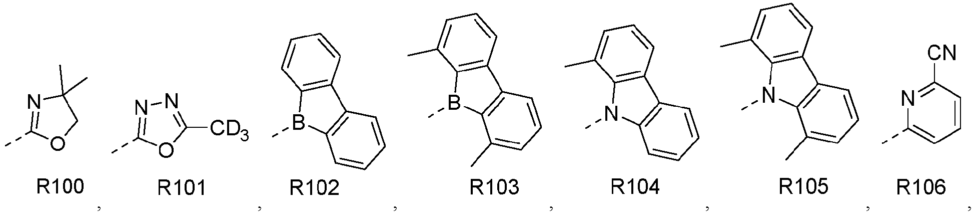

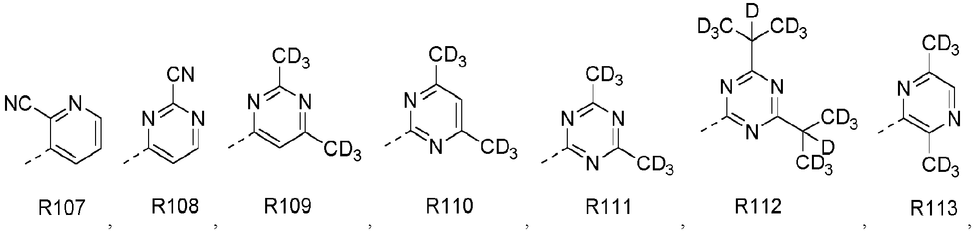

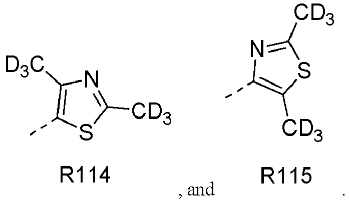

In some embodiments, ligand L_{B} is selected from the group consisting of the structures of the following LIST 5: 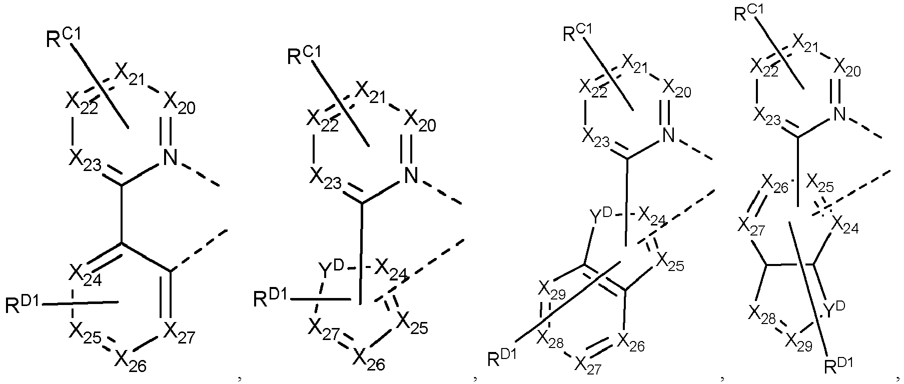 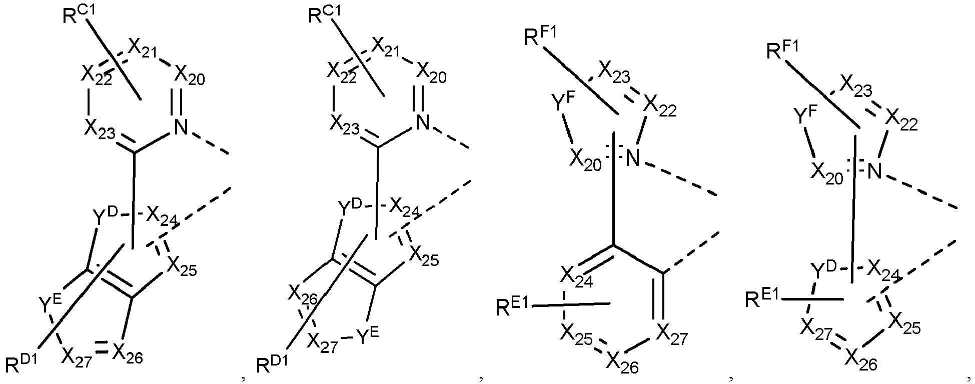 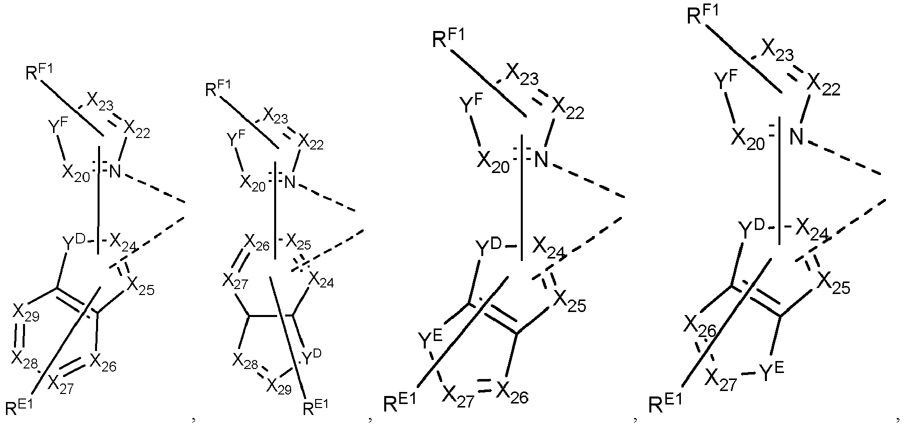 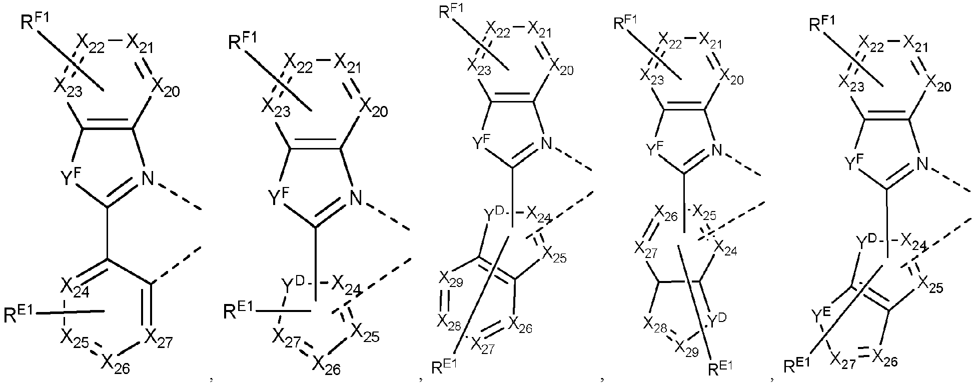 , and 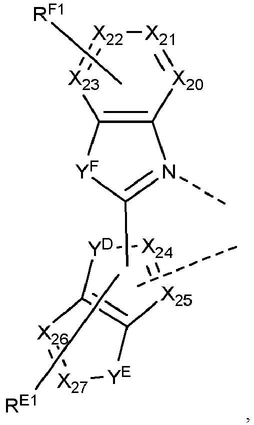 wherein:
each of X₂₀ to X₂₉ is independently C or N;
each of Y^{D}, Y^{E}, and Y^{F} is independently selected from the group consisting of BRₑ, NRₑ, PRₑ, O, S, Se, C=O, S=O, SO₂, CRₑR_{f}, SiRₑR_{f}, and GeRₑR_{f};
each of R^{C1}, R^{D1}, R^{E1}, and R^{F1} independently represents from mono to the maximum possible number of substitutions, or no substitutions;
each R^{C1}, R^{D1}, R^{E1}, R^{F1}, Rₑ, and Rε is independently a hydrogen or a substituent selected from the group consisting of the General Substituents defined herein; and
any two substituents can be joined or fused to form a ring.

In some embodiments, where ligand L_{A} is selected from LIST 5, at least one of R^{C1}, R^{D1}, R^{E1}, or R^{F1} is partially or fully deuterated. In some embodiments, at least one R^{C1} is partially or fully deuterated. In some embodiments, at least one R^{D1} is partially or fully deuterated. In some embodiments, at least one R^{E1} is partially or fully deuterated. In some embodiments, at least one R^{F1} is partially or fully deuterated. In some embodiments, at least one Rₑ or Rε is partially or fully deuterated.

In some embodiments where ligand L_{A} is selected from LIST 5, at least one R^{C1} is or comprises an electron-withdrawing group from the EWG1 LIST as defined herein. In some embodiments, at least one R^{C1} is or comprises an electron-withdrawing group from the EWG2 LIST as defined herein. In some embodiments, at least one R^{C1} is or comprises an electron-withdrawing group from the EWG3 LIST as defined herein. In some embodiments, at least one R^{C1} is or comprises an electron-withdrawing group from the EWG4 LIST as defined herein. In some embodiments, at least one R^{C1} is or comprises an electron-withdrawing group from the Pi-EWG LIST as defined herein.

In some embodiments where ligand L_{A} is selected from LIST 5, at least one R^{D1} is or comprises an electron-withdrawing group from the EWG1 LIST as defined herein. In some embodiments, at least one R^{D1} is or comprises an electron-withdrawing group from the EWG2 LIST as defined herein. In some embodiments, at least one R^{D1} is or comprises an electron-withdrawing group from the EWG3 LIST as defined herein. In some embodiments, at least one R^{D1} is or comprises an electron-withdrawing group from the EWG4 LIST as defined herein. In some embodiments, at least one R^{D1} is or comprises an electron-withdrawing group from the Pi-EWG LIST as defined herein.

In some embodiments where ligand L_{A} is selected from LIST 5, at least one R^{E1} is or comprises an electron-withdrawing group from the EWG1 LIST as defined herein. In some embodiments, at least one R^{E1} is or comprises an electron-withdrawing group from the EWG2 LIST as defined herein. In some embodiments, at least one R^{E1} is or comprises an electron-withdrawing group from the EWG3 LIST as defined herein. In some embodiments, at least one R^{E1} is or comprises an electron-withdrawing group from the EWG4 LIST as defined herein. In some embodiments, at least one R^{E1} is or comprises an electron-withdrawing group from the Pi-EWG LIST as defined herein.

In some embodiments where ligand L_{A} is selected from LIST 5, at least one R^{F1} is or comprises an electron-withdrawing group from the EWG1 LIST as defined herein. In some embodiments, at least one R^{F1} is or comprises an electron-withdrawing group from the EWG2 LIST as defined herein. In some embodiments, at least one R^{F1} is or comprises an electron-withdrawing group from the EWG3 LIST as defined herein. In some embodiments, at least one R^{F1} is or comprises an electron-withdrawing group from the EWG4 LIST as defined herein. In some embodiments, at least one R^{F1} is or comprises an electron-withdrawing group from the Pi-EWG LIST as defined herein.

In some embodiments where ligand L_{A} is selected from LIST 5, at least one Rₑ or Rε is or comprises an electron-withdrawing group from the EWG1 LIST as defined herein. In some embodiments, at least one Rₑ or R_{f} is or comprises an electron-withdrawing group from the EWG2 LIST as defined herein. In some embodiments, at least one Rₑ or R_{f} is or comprises an electron-withdrawing group from the EWG3 LIST as defined herein. In some embodiments, at least one Rₑ or R_{f} is or comprises an electron-withdrawing group from the EWG4 LIST as defined herein. In some embodiments, at least one Rₑ or R_{f} is or comprises an electron-withdrawing group from the Pi-EWG LIST as defined herein.

In some embodiments, the ligand L_{B} is selected from the group consisting of the structures of the following LIST 6: 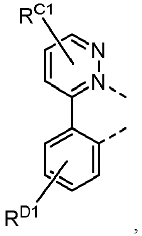 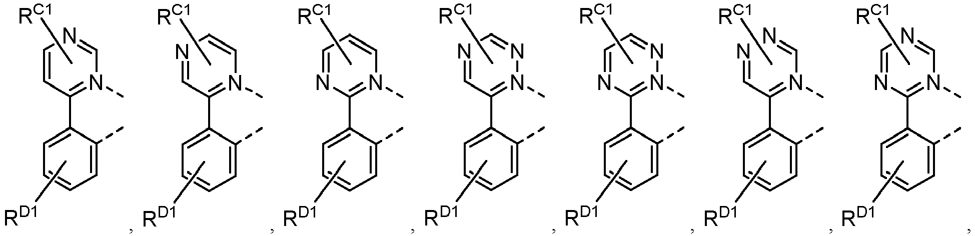 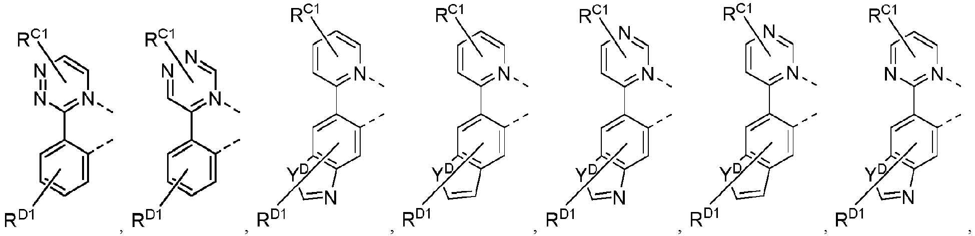 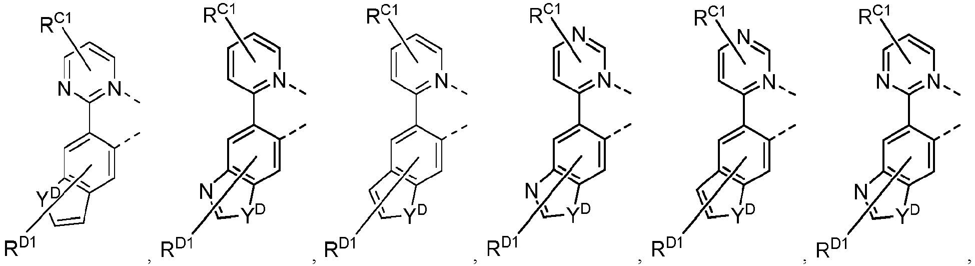 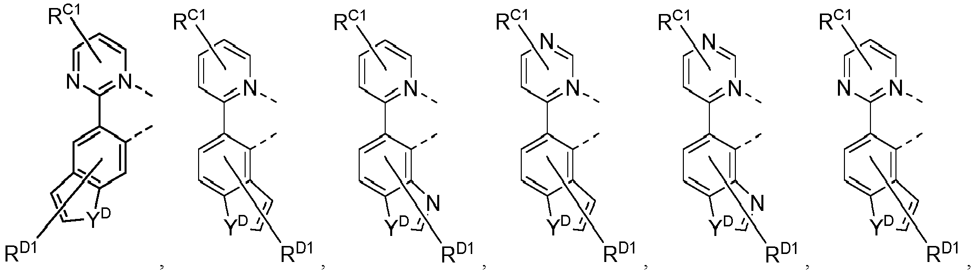 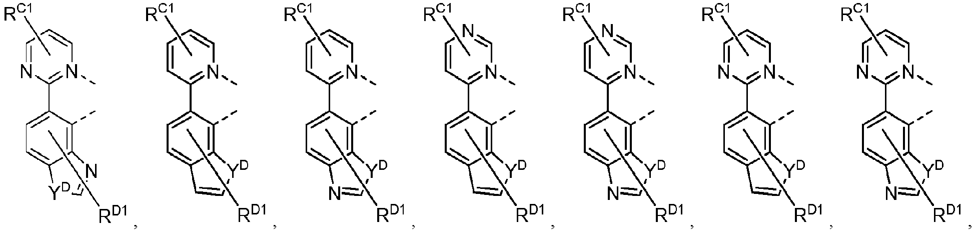 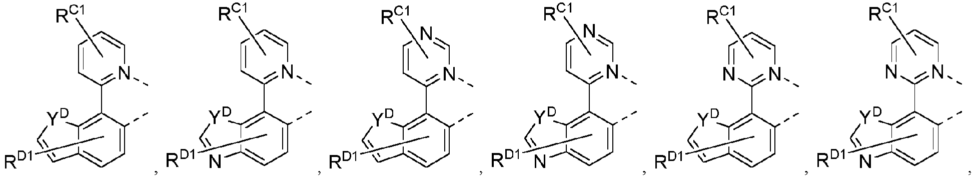 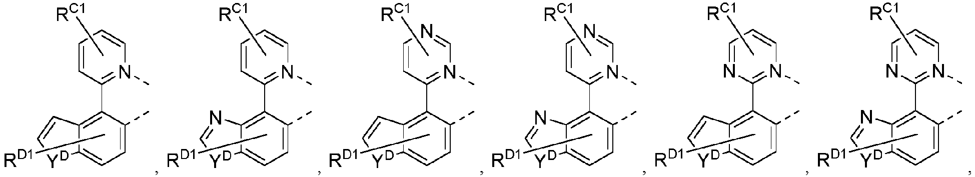 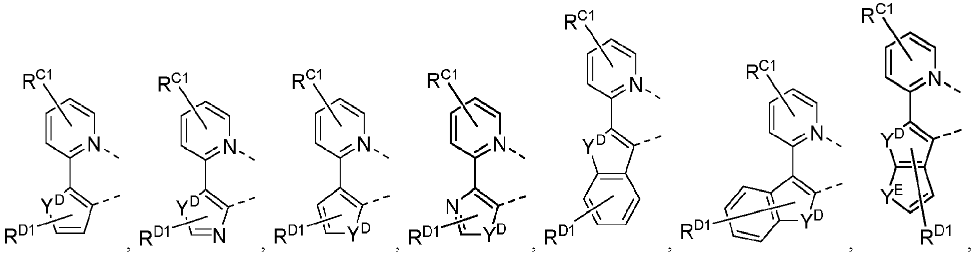 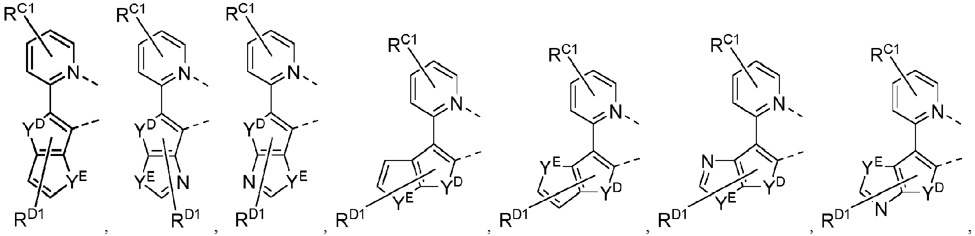 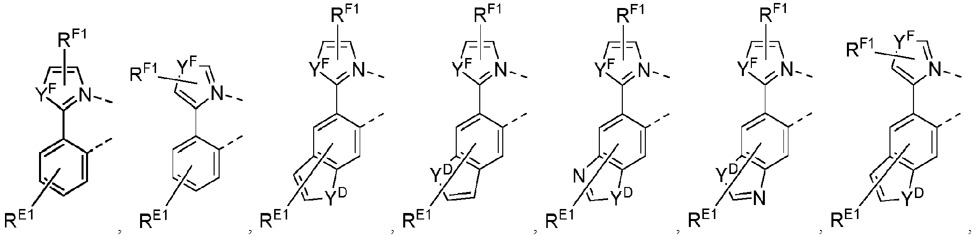 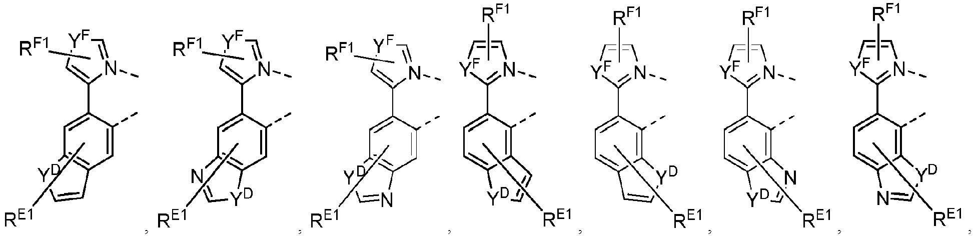 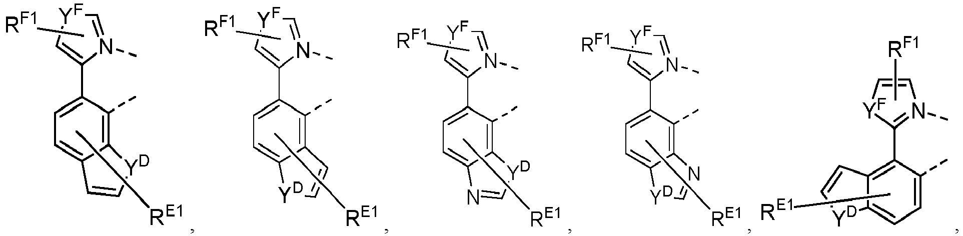 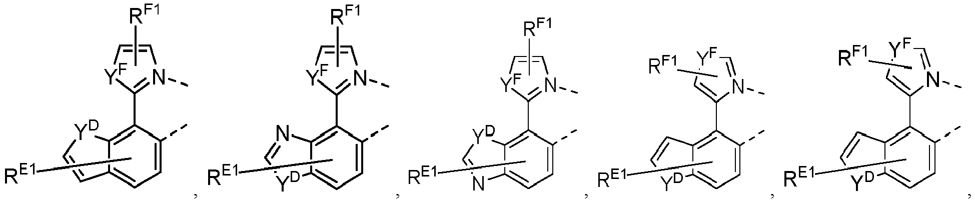 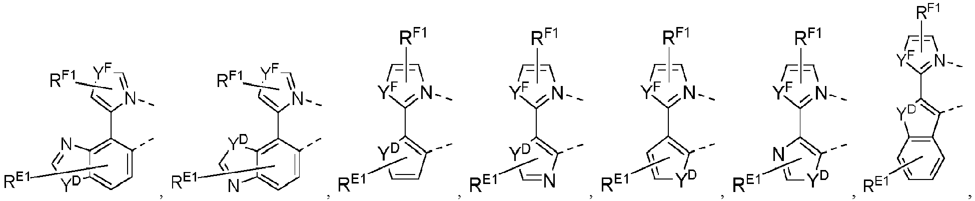 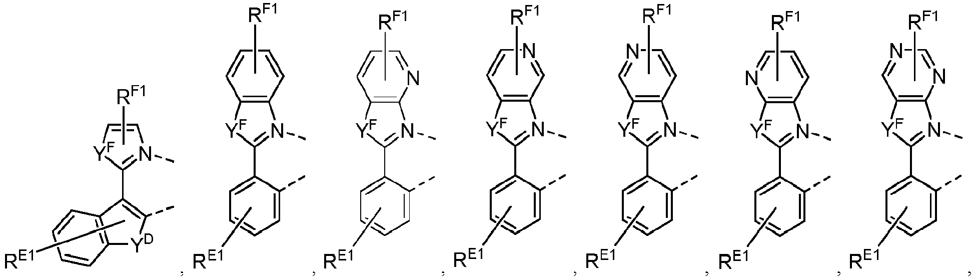 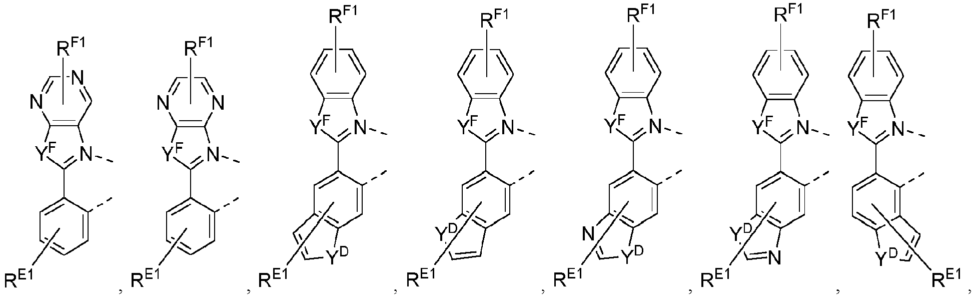 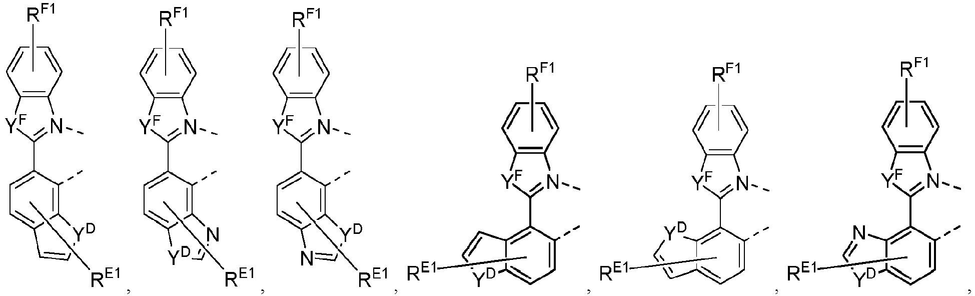 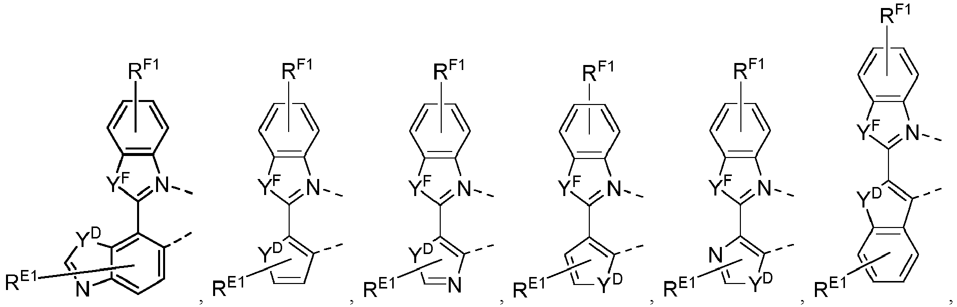 and 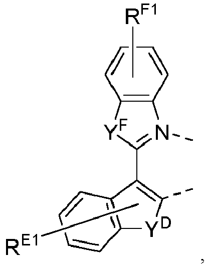 wherein:
each of Y^{D}, Y^{E}, and Y^{F} is independently selected from the group consisting of BRₑ, NRₑ, PRₑ, O, S, Se, C=O, S=O, SO₂, CRₑR_{f}, SiRₑR_{f}, and GeRₑR_{f};
each of R^{C1}, R^{D1}, R^{E1}, and R^{F1} independently represents from mono to the maximum possible number of substitutions, or no substitutions;
each R^{C1}, R^{D1}, R^{E1}, R^{F1}, Rₑ, and Rε is independently a hydrogen or a substituent selected from the group consisting of the General Substituents defined herein; and
any two substituents can be joined or fused to form a ring.

In some embodiments, where ligand L_{A} is selected from LIST 6, at least one of R^{C1}, R^{D1}, R^{E1}, or R^{F1} is partially or fully deuterated. In some embodiments, at least one R^{C1} is partially or fully deuterated. In some embodiments, at least one R^{D1} is partially or fully deuterated. In some embodiments, at least one R^{E1} is partially or fully deuterated. In some embodiments, at least one R^{F1} is partially or fully deuterated. In some embodiments, at least one Rₑ or Rε is partially or fully deuterated.

In some embodiments where ligand L_{A} is selected from LIST 6, at least one R^{C1} is or comprises an electron-withdrawing group from the EWG1 LIST as defined herein. In some embodiments, at least one R^{C1} is or comprises an electron-withdrawing group from the EWG2 LIST as defined herein. In some embodiments, at least one R^{C1} is or comprises an electron-withdrawing group from the EWG3 LIST as defined herein. In some embodiments, at least one R^{C1} is or comprises an electron-withdrawing group from the EWG4 LIST as defined herein. In some embodiments, at least one R^{C1} is or comprises an electron-withdrawing group from the Pi-EWG LIST as defined herein.

In some embodiments where ligand L_{A} is selected from LIST 6, at least one R^{D1} is or comprises an electron-withdrawing group from the EWG1 LIST as defined herein. In some embodiments, at least one R^{D1} is or comprises an electron-withdrawing group from the EWG2 LIST as defined herein. In some embodiments, at least one R^{D1} is or comprises an electron-withdrawing group from the EWG3 LIST as defined herein. In some embodiments, at least one R^{D1} is or comprises an electron-withdrawing group from the EWG4 LIST as defined herein. In some embodiments, at least one R^{D1} is or comprises an electron-withdrawing group from the Pi-EWG LIST as defined herein.

In some embodiments where ligand L_{A} is selected from LIST 6, at least one R^{E1} is or comprises an electron-withdrawing group from the EWG1 LIST as defined herein. In some embodiments, at least one R^{E1} is or comprises an electron-withdrawing group from the EWG2 LIST as defined herein. In some embodiments, at least one R^{E1} is or comprises an electron-withdrawing group from the EWG3 LIST as defined herein. In some embodiments, at least one R^{E1} is or comprises an electron-withdrawing group from the EWG4 LIST as defined herein. In some embodiments, at least one R^{E1} is or comprises an electron-withdrawing group from the Pi-EWG LIST as defined herein.

In some embodiments where ligand L_{A} is selected from LIST 6, at least one R^{F1} is or comprises an electron-withdrawing group from the EWG1 LIST as defined herein. In some embodiments, at least one R^{F1} is or comprises an electron-withdrawing group from the EWG2 LIST as defined herein. In some embodiments, at least one R^{F1} is or comprises an electron-withdrawing group from the EWG3 LIST as defined herein. In some embodiments, at least one R^{F1} is or comprises an electron-withdrawing group from the EWG4 LIST as defined herein. In some embodiments, at least one R^{F1} is or comprises an electron-withdrawing group from the Pi-EWG LIST as defined herein.

In some embodiments where ligand L_{A} is selected from LIST 6, at least one Rₑ or Rε is or comprises an electron-withdrawing group from the EWG1 LIST as defined herein. In some embodiments, at least one Rₑ or R_{f} is or comprises an electron-withdrawing group from the EWG2 LIST as defined herein. In some embodiments, at least one Rₑ or R_{f} is or comprises an electron-withdrawing group from the EWG3 LIST as defined herein. In some embodiments, at least one Rₑ or R_{f} is or comprises an electron-withdrawing group from the EWG4 LIST as defined herein. In some embodiments, at least one Rₑ or R_{f} is or comprises an electron-withdrawing group from the Pi-EWG LIST as defined herein.

In some embodiments, the ligand L_{B} is selected from L_{Bw}(R^{G})(R^{H})(R^{J})(R^{K}), wherein w is an integer from 1 to 92, and each R^{G}, R^{H}, R^{J}, and R^{K} is independently selected from the group consisting of R1 to R115; wherein each of L_{B1}(R1)(R1)(R1)(R1) to L_{B92}(R115)(R115)(R115)(R115) is defined in the following LIST 7:

| L_{B} | Structure of L_{B} | L_{B} | Structure of L_{B} | L_{B} | Structure of L_{B} |
|---|---|---|---|---|---|
| L_{B1}(R^{G})(R^{H})(R^{J})( R^{K}), wherein L_{B1}(R1)(R1)(R1)( R1) to L_{B1}(R115)(R115)( R115)(R115) have the structure | 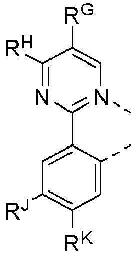 | L_{B2}(R^{G})(R^{H})(R^{J})( R^{K}), wherein L_{B2}(R1)(R1)(R1)( R1) to L_{B2}(R115)(R115)( R115)(R115) have the structure | 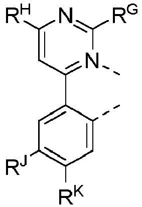 | L_{B3}(R^{G})(R^{H})(R^{J})( R^{K}), wherein L_{B3}(R1)(R1)(R1)( R1) to L_{B3}(R115)(R115)( R115)(R115) have the structure | 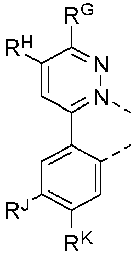 |
| L_{B4}(R^{G})(R^{H})(R^{J})( R^{K}), wherein L_{B4}(R1)(R1)(R1)( R1) to L_{B4}(R115)(R115)( R115)(R115) have the structure | 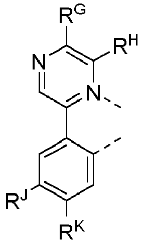 | L_{B5}(R^{G})(R^{H})(R^{J})( R^{K}), wherein L_{B5}(R1)(R1)(R1)( R1) to L_{B5}(R115)(R115)( R115)(R115) have the structure | 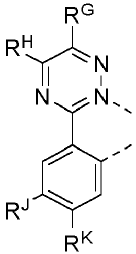 | L_{B6}(R^{G})(R^{H})(R^{J})( R^{K}), wherein L_{B6}(R1)(R1)(R1)( R1) to L_{B6}(R115)(R115)( R115)(R115) have the structure | 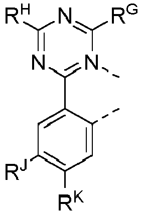 |
| L_{B7}(R^{G})(R^{H})(R^{J})( R^{K}), wherein L_{B7}(R1)(R1)(R1)( R1) to L_{B7}(R115)(R115)( R115)(R115) have the structure | 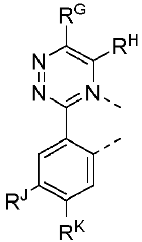 | L_{B8}(R^{G})(R^{H})(R^{J})( R^{K}), wherein L_{B8}(R1)(R1)(R1)( R1) to L_{B8}(R115)(R115)( R115)(R115) have the structure | 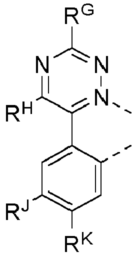 | L_{B9}(R^{G})(R^{H})(R^{J})( R^{K}), wherein L_{B9}(R1)(R1)(R1)( R1) to L_{B9}(R115)(R115)( R115)(R115) have the structure | 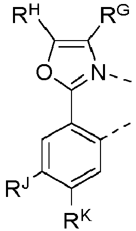 |
| L_{B10}(R^{G})(R^{H})(R^{J})( R^{K}), wherein L_{B10}(R1)(R1)(R1) (R1) to L_{B10}(R115)(R115) (R115)(R115) have the structure | 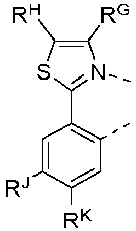 | L_{B11}(R^{G})(R^{H})(R^{J})( R^{K}), wherein L_{B11}(R1)(R1)(R1) (R1) to L_{B11}(R115)(R115) (R115)(R115) have the structure | 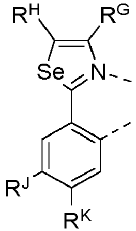 | L_{B12}(R^{G})(R^{H})(R^{J})( R^{K}), wherein L_{B12}(R1)(R1)(R1) (R1) to L_{B12}(R115)(R115) (R115)(R115) have the structure | 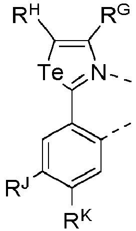 |
| L_{B13}(R^{G})(R^{H})(^{RJ})( R^{K}), wherein Lais(Rl)(Rl)(Rl) (R1) to L_{B13}(R115)(R115) (R115)(R115) have the structure | 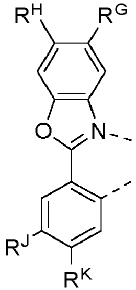 | L_{B14}(R^{G})(R^{H})(R^{J})( R^{K}), wherein L_{B14}(R1)(R1)(R1) (R1) to L_{B14}(R115)(R115) (R115)(R115) have the structure | 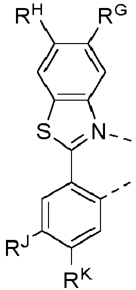 | L_{B15}(R^{G})(R^{H})(R^{J})( R^{K}), wherein L_{B15}(R1)(R1)(R1) (R1) to L_{B15}(R115)(R115) (R115)(R115) have the structure | 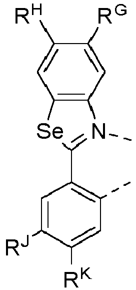 |
| L_{B16}(R^{G})(R^{H})(R^{J})( R^{K}), wherein L_{B16}(R1)(R1)(R1) (R1) to L_{B16}(R115)(R115) (R115)(R115) have the structure | 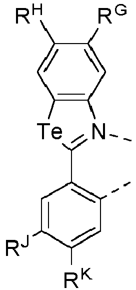 | L_{B17}(R^{G})(R^{H})(R^{J})( R^{K}), wherein L_{B17}(R1)(R1)(R1) (R1) to L_{B17}(R115)(R115) (R115)(R115) have the structure | 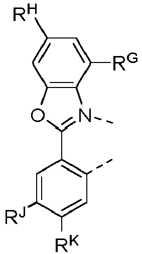 | L_{B18}(R^{G})(R^{H})(R^{J})( R^{K}), wherein L_{B18}(R1)(R1)(R1) (R1) to L_{B18}(R115)(R115) (R115)(R115) have the structure | 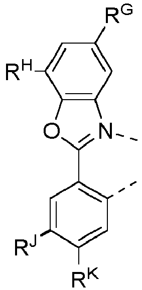 |
| L_{B19}(R^{G})(R^{H})(R^{J})( R^{K}), wherein L_{B19}(R1)(R1)(R1) (R1) to L_{B19}(R115)(R115) (R115)(R115) have the structure | 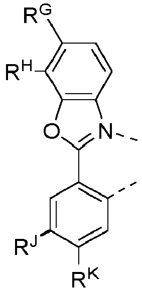 | L_{B20}(R^{G})(R^{H})(R^{J})( R^{K}), wherein L_{B20}(R1)(R1)(R1) (R1) to L_{B20}(R115)(R115) (R115)(R115) have the structure | 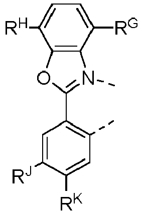 | L_{B21}(R^{G})(R^{H})(R^{J})( R^{K}), wherein L_{B21}(R1)(R1)(R1) (R1) to L_{B21}(R115)(R115) (R115)(R115) have the structure | 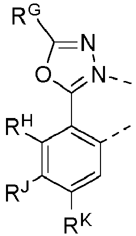 |
| L_{B22}(R^{G})(R^{H})(R^{J})( R^{K}), wherein L_{B22}(R1)(R1)(R1) (R1) to L_{B22}(R115)(R115) (R115)(R115) have the structure | 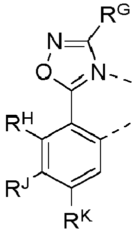 | L_{B23}(R^{G})(R^{H})(R^{J})( R^{K}), wherein L_{B23}(R1)(R1)(R1) (R1) to L_{B23}(R115)(R115) (R115)(R115) have the structure | 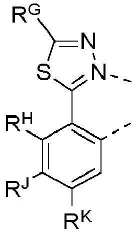 | L_{B24}(R^{G})(R^{H})(R^{J})( R^{K}), wherein L_{B24}(R1)(R1)(R1) (R1) to L_{B24}(R115)(R115) (R115)(R115) have the structure | 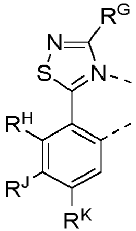 |
| L_{B25}(R^{G})(R^{H})(R^{J})( R^{K}), wherein L_{B25}(R1)(R1)(R1) (R1) to L_{B25}(R115)(R115) (R115)(R115) have the structure | 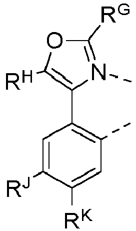 | L_{B26}(R^{G})(R^{H})(R^{J})( R^{K}), wherein L_{B26}(R1)(R1)(R1) (R1) to L_{B26}(R115)(R115) (R115)(R115) have the structure | 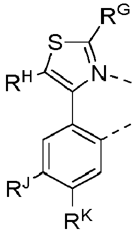 | L_{B27}(R^{G})(R^{H})(R^{J})( R^{K}), wherein L_{B27}(R1)(R1)(R1) (R1) to L_{B27}(R115)(R115) (R115)(R115) have the structure | 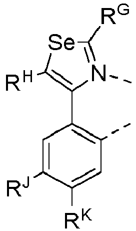 |
| L_{B28}(R^{G})(R^{H})(R^{J})( R^{K}), wherein L_{B28}(R1)(R1)(R1) (R1) to L_{B28}(R115)(R115) (R115)(R115) have the structure | 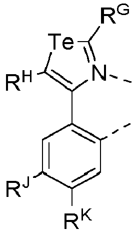 | L_{B29}(R^{G})(R^{H})(R^{J})( R^{K}), wherein L_{B29}(R1)(R1)(R1) (R1) to L_{B29}(R115)(R115) (R115)(R115) have the structure | 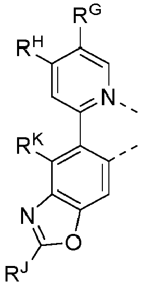 | L_{B30}(R^{G})(R^{H})(R^{J})( R^{K}), wherein L_{B30}(R1)(R1)(R1) (R1) to L_{B30}(R115)(R115) (R115)(R115) have the structure | 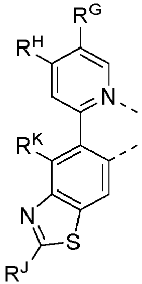 |
| L_{B31}(R^{G})(R^{H})(R^{J})( R^{K}), wherein L_{B31}(R1)(R1)(R1) (R1) to L_{B31}(R115)(R115) (R115)(R115) have the structure | 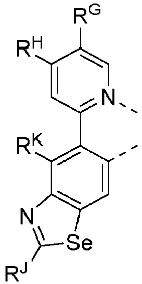 | L_{B32}(R^{G})(R^{H})(R^{J})( R^{K}), wherein L_{B32}(R1)(R1)(R1) (R1) to L_{B32}(R115)(R115) (R115)(R115) have the structure | 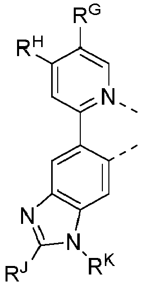 | L_{B33}(R^{G})(R^{H})(R^{J})( R^{K}), wherein L_{B33}(R1)(R1)(R1) (R1) to L_{B33}(R115)(R115) (R115)(R115) have the structure | 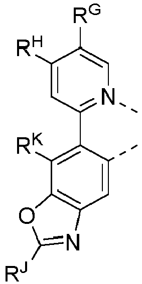 |
| L_{B34}(R^{G})(R^{H})(R^{J})( R^{K}), wherein L_{B34}(R1)(R1)(R1) (R1) to L_{B34}(R115)(R115) (R115)(R115) have the structure | 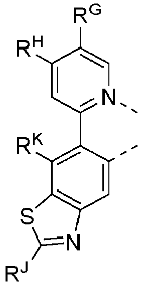 | L_{B35}(R^{G})(R^{H})(R^{J})( R^{K}), wherein L_{B35}(R1)(R1)(R1) (R1) to L_{B35}(R115)(R115) (R115)(R115) have the structure | 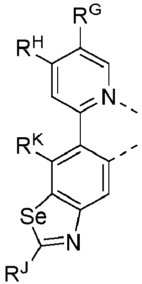 | L_{B36}(R^{G})(R^{H})(R^{J})( R^{K}), wherein L_{B36}(R1)(R1)(R1) (R1) to L_{B36}(R115)(R115) (R115)(R115) have the structure | 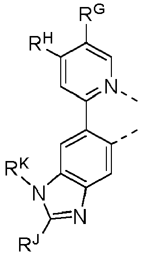 |
| L_{B37}(R^{G})(R^{H})(R^{J})( R^{K}), wherein L_{B37}(R1)(R1)(R1) (R1) to L_{B37}(R115)(R115) (R115)(R115) have the structure | 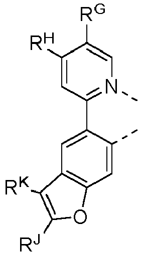 | L_{B38}(R^{G})(R^{H})(R^{J})( R^{K}), wherein L_{B38}(R1)(R1)(R1) (R1) to L_{B38}(R115)(R115) (R115)(R115) have the structure | 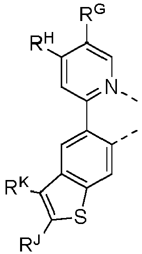 | L_{B39}(R^{G})(R^{H})(R^{J})( R^{K}), wherein L_{B39}(R1)(R1)(R1) (R1) to L_{B39}(R115)(R115) (R115)(R115) have the structure | 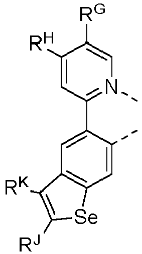 |
| L_{B40}(R^{G})(R^{H})(R^{J})( R^{K}), wherein L_{B40}(R1)(R1)(R1) (R1) to L_{B40}(R115)(R115) (R115)(R115) have the structure | 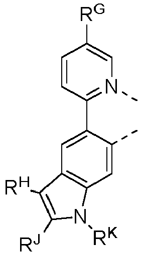 | L_{B41}(R^{G})(R^{H})(R^{J})( R^{K}), wherein L_{B41}(R1)(R1)(R1) (R1) to L_{B41}(R115)(R115) (R115)(R115) have the structure | 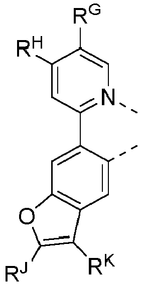 | L_{B42}(R^{G})(R^{H})(R^{J})( R^{K}), wherein L_{B42}(R1)(R1)(R1) (R1) to L_{B42}(R115)(R115) (R115)(R115) have the structure | 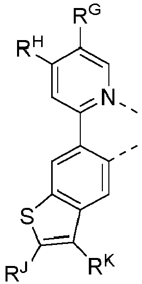 |
| L_{B43}(R^{G})(R^{H})(R^{J})( R^{K}), wherein L_{B43}(R1)(R1)(R1) (R1) to L_{B43}(R115)(R115) (R115)(R115) have the structure | 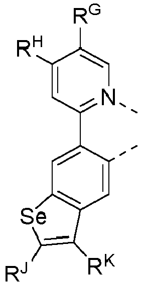 | L_{B44}(R^{G})(R^{H})(R^{J})( R^{K}), wherein L_{B44}(R1)(R1)(R1) (R1) to L_{B44}(R115)(R115) (R115)(R115) have the structure | 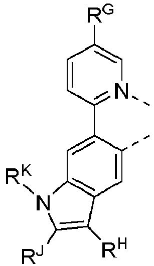 | L_{B45}(R^{G})(R^{H})(R^{J})( R^{K}), wherein L_{B45}(R1)(R1)(R1) (R1) to L_{B45}(R115)(R115) (R115)(R115) have the structure | 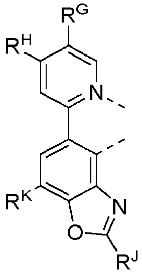 |
| L_{B46}(R^{G})(R^{H})(R^{J})( R^{K}), wherein L_{B46}(R1)(R1)(R1) (R1) to L_{B46}(R115)(R115) (R115)(R115) have the structure | 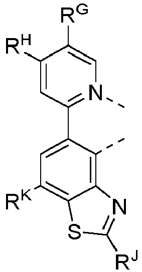 | L_{B47}(R^{G})(R^{H})(R^{J})( R^{K}), wherein L_{B47}(R1)(R1)(R1) (R1) to L_{B47}(R115)(R115) (R115)(R115) have the structure | 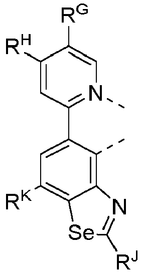 | L_{B48}(R^{G})(R^{H})(R^{J})( R^{K}), wherein L_{B48}(R1)(R1)(R1) (R1) to L_{B48}(R115)(R115) (R115)(R115) have the structure | 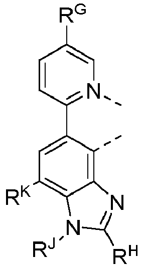 |
| L_{B49}(R^{G})(R^{H})(R^{J})( R^{K}), wherein L_{B49}(R1)(R1)(R1) (R1) to L_{B49}(R115)(R115) (R115)(R115) have the structure | 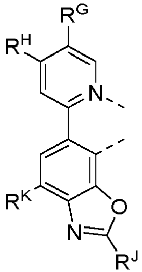 | L_{B50}(R^{G})(R^{H})(R^{J})( R^{K}), wherein L_{B50}(R1)(R1)(R1) (R1) to L_{B50}(R115)(R115) (R115)(R115) have the structure | 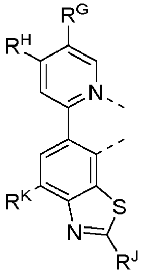 | L_{B51}(R^{G})(R^{H})(R^{J})( R^{K}), wherein L_{B51}(R1)(R1)(R1) (R1) to L_{B51}(R115)(R115) (R115)(R115) have the structure | 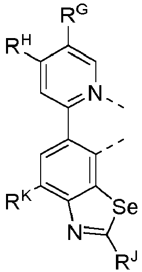 |
| L_{B52}(R^{G})(R^{H})(R^{J})( R^{K}), wherein L_{B52}(R1)(R1)(R1) (R1) to L_{B52}(R115)(R115) (R115)(R115) have the structure | 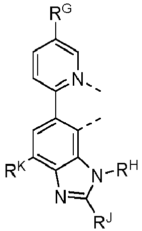 | L_{B53}(R^{G})(R^{H})(R^{J})( R^{K}), wherein L_{B53}(R1)(R1)(R1) (R1) to L_{B53}(R115)(R115) (R115)(R115) have the structure | 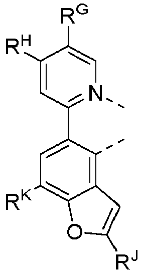 | L_{B54}(R^{G})(R^{H})(R^{J})( R^{K}), wherein L_{B54}(R1)(R1)(R1) (R1) to L_{B54}(R115)(R115) (R115)(R115) have the structure | 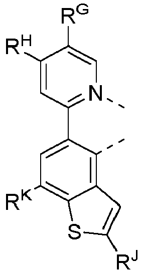 |
| L_{B55}(R^{G})(R^{H})(R^{J})( R^{K}), wherein L_{B55}(R1)(R1)(R1) (R1) to L_{B55}(R115)(R115) (R115)(R115) have the structure | 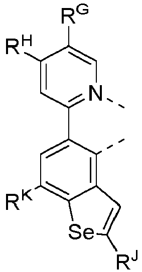 | L_{B56}(R^{G})(R^{H})(R^{J})( R^{K}), wherein L_{B56}(R1)(R1)(R1) (R1) to L_{B56}(R115)(R115) (R115)(R115) have the structure | 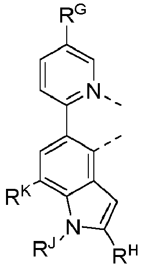 | L_{B57}(R^{G})(R^{H})(R^{J})( R^{K}), wherein L_{B57}(R1)(R1)(R1) (R1) to L_{B57}(R115)(R115) (R115)(R115) have the structure | 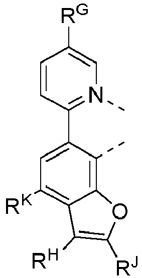 |
| L_{B58}(R^{G})(R^{H})(R^{J})( R^{K}), wherein L_{B58}(R1)(R1)(R1) (R1) to L_{B58}(R115)(R115) (R115)(R115) have the structure | 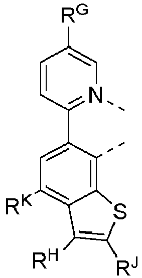 | L_{B59}(R^{G})(R^{H})(R^{J})( R^{K}), wherein L_{B59}(R1)(R1)(R1) (R1) to L_{B59}(R115)(R115) (R115)(R115) have the structure | 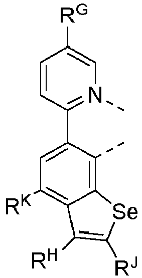 | L_{B60}(R^{G})(R^{H})(R^{J})( R^{K}), wherein L_{B60}(R1)(R1)(R1) (R1) to L_{B60}(R115)(R115) (R115)(R115) have the structure | 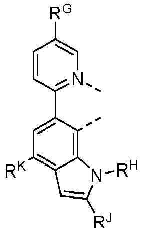 |
| L_{B61}(R^{G})(R^{H})(R^{J})( R^{K}), wherein L_{B61}(R1)(R1)(R1) (R1) to L_{B61}(R115)(R115) (R115)(R115) have the structure | 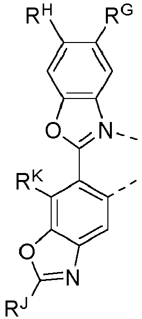 | L_{B62}(R^{G})(R^{H})(R^{J})( R^{K}), wherein L_{B62}(R1)(R1)(R1) (R1) to L_{B62}(R115)(R115) (R115)(R115) have the structure | 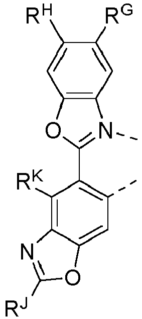 | L_{B63}(R^{G})(R^{H})(R^{J})( R^{K}), wherein L_{B63}(R1)(R1)(R1) (R1) to L_{B63}(R115)(R115) (R115)(R115) have the structure | 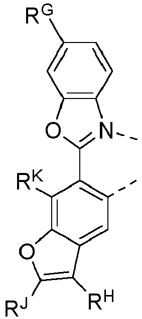 |
| L_{B64}(R^{G})(R^{H})(R^{J})( R^{K}), wherein L_{B64}(R1)(R1)(R1) (R1) to L_{B64}(R115)(R115) (R115)(R115) have the structure | 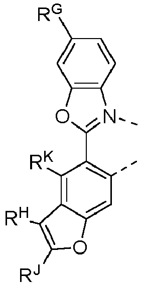 | L_{B65}(R^{G})(R^{H})(R^{J})( R^{K}), wherein L_{B65}(R1)(R1)(R1) (R1) to L_{B65}(R115)(R115) (R115)(R115) have the structure | 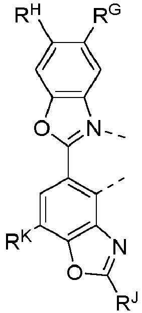 | L_{B66}(R^{G})(R^{H})(R^{J})( R^{K}), wherein L_{B66}(R1)(R1)(R1) (R1) to L_{B66}(R115)(R115) (R115)(R115) have the structure | 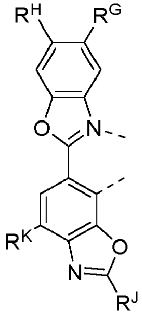 |
| L_{B67}(R^{G})(R^{H})(R^{J})( R^{K}), wherein L_{B67}(R1)(R1)(R1) (R1) to L_{B67}(R115)(R115) (R115)(R115) have the structure | 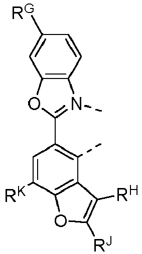 | L_{B68}(R^{G})(R^{H})(R^{J})( R^{K}), wherein L_{B68}(R1)(R1)(R1) (R1) to L_{B68}(R115)(R115) (R115)(R115) have the structure | 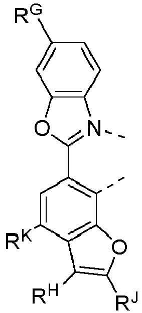 | L_{B69}(R^{G})(R^{H})(R^{J})( R^{K}), wherein L_{B69}(R1)(R1)(R1) (R1) to L_{B69}(R115)(R115) (R115)(R115) have the structure | 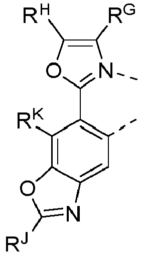 |
| L_{B70}(R^{G})(R^{H})(R^{J})( R^{K}), wherein L_{B70}(R1)(R1)(R1) (R1) to L_{B70}(R115)(R115) (R115)(R115) have the structure | 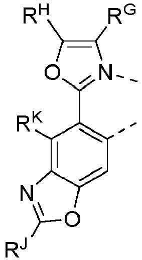 | L_{B71}(R^{G})(R^{H})(R^{J})( R^{K}), wherein L_{B71}(R1)(R1)(R1) (R1) to L_{B71}(R115)(R115) (R115)(R115) have the structure | 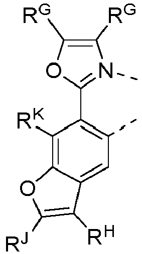 | L_{B72}(R^{G})(R^{H})(R^{J})( R^{K}), wherein L_{B72}(R1)(R1)(R1) (R1) to L_{B72}(R115)(R115) (R115)(R115) have the structure | 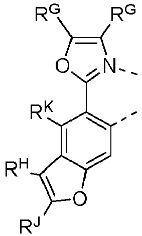 |
| L_{B73}(R^{G})(R^{H})(R^{J})( R^{K}), wherein L_{B73}(R1)(R1)(R1) (R1) to L_{B73}(R115)(R115) (R115)(R115) have the structure | 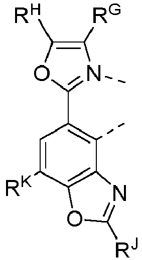 | L_{B74}(R^{G})(R^{H})(R^{J})( R^{K}), wherein L_{B74}(R1)(R1)(R1) (R1) to L_{B74}(R115)(R115) (R115)(R115) have the structure | 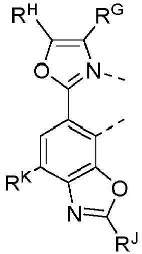 | L_{B75}(R^{G})(R^{H})(R^{J})( R^{K}), wherein L_{B75}(R1)(R1)(R1) (R1) to L_{B75}(R115)(R115) (R115)(R115) have the structure | 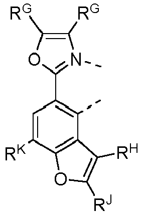 |
| L_{B76}(R^{G})(R^{H})(R^{J})( R^{K}), wherein L_{B76}(R1)(R1)(R1) (R1) to L_{B76}(R115)(R115) (R115)(R115) have the structure | 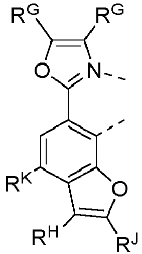 | L_{B77}(R^{G})(R^{H})(R^{J})( R^{K}), wherein L_{B77}(R1)(R1)(R1) (R1) to L_{B77}(R115)(R115) (R115)(R115) have the structure | 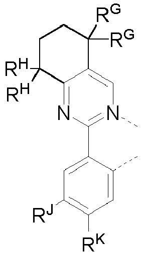 | L_{B78}(R^{G})(R^{H})(R^{J})( R^{K}), wherein L_{B78}(R1)(R1)(R1) (R1) to L_{B78}(R115)(R115) (R115)(R115) have the structure | 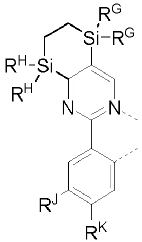 |
| L_{B79}(R^{G})(R^{H})(R^{J})( R^{K}), wherein L_{B79}(R1)(R1)(R1) (R1) to L_{B79}(R115)(R115) (R115)(R115) have the structure | 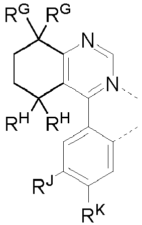 | L_{B80}(R^{G})(R^{H})(R^{J})( R^{K}), wherein L_{B80}(R1)(R1)(R1) (R1) to L_{B80}(R115)(R115) (R115)(R115) have the structure | 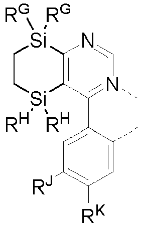 | L_{B81}(R^{G})(R^{H})(R^{J})( R^{K}), wherein L_{B81}(R1)(R1)(R1) (R1) to L_{B81}(R115)(R115) (R115)(R115) have the structure | 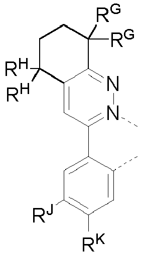 |
| L_{B82}(R^{G})(R^{H})(R^{J})( R^{K}), wherein L_{B82}(R1)(R1)(R1) (R1) to L_{B82}(R115)(R115) (R115)(R115) have the structure | 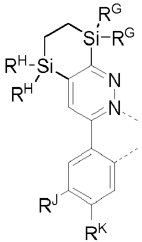 | L_{B83}(R^{G})(R^{H})(R^{J})( R^{K}), wherein L_{B83}(R1)(R1)(R1) (R1) to L_{B83}(R115)(R115) (R115)(R115) have the structure | 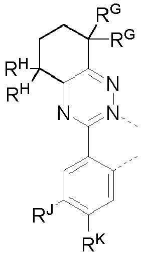 | L_{B84}(R^{G})(R^{H})(R^{J})( R^{K}), wherein L_{B84}(R1)(R1)(R1) (R1) to L_{B84}(R115)(R115) (R115)(R115) have the structure | 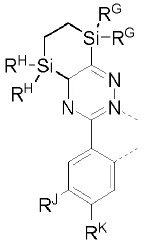 |
| L_{B85}(R^{G})(R^{H})(R^{J})( R^{K}), wherein L_{B85}(R1)(R1)(R1) (R1) to L_{B85}(R115)(R115) (R115)(R115) have the structure | 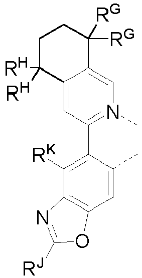 | L_{B86}(R^{G})(R^{H})(R^{J})( R^{K}), wherein L_{B86}(R1)(R1)(R1) (R1) to L_{B86}(R115)(R115) (R115)(R115) have the structure | 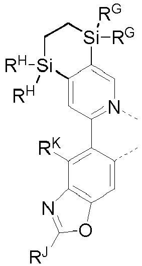 | L_{B87}(R^{G})(R^{H})(R^{J})( R^{K}), wherein L_{B87}(R1)(R1)(R1) (R1) to L_{B87}(R115)(R115) (R115)(R115) have the structure | 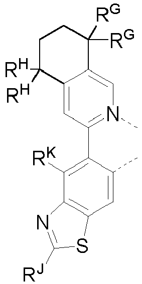 |
| L_{B88}(R^{G})(R^{H})(R^{J})( R^{K}), wherein L_{B88}(R1)(R1)(R1) (R1) to L_{B88}(R115)(R115) (R115)(R115) have the structure | 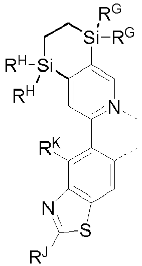 | L_{B89}(R^{G})(R^{H})(R^{J})( R^{K}), wherein L_{B89}(R1)(R1)(R1) (R1) to L_{B89}(R115)(R115) (R115)(R115) have the structure | 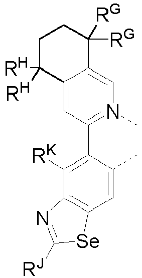 | L_{B90}(R^{G})(R^{H})(R^{J})( R^{K}), wherein L_{B90}(R1)(R1)(R1) (R1) to L_{B90}(R115)(R115) (R115)(R115) have the structure | 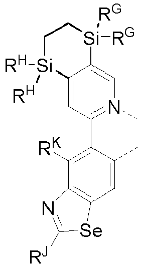 |
| L_{B91}(R^{G})(R^{H})(R^{J})( R^{K}), wherein L_{B91}(R1)(R1)(R1) (R1) to L_{B91}(R115)(R115) (R115)(R115) have the structure | 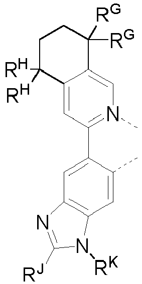 | L_{B92}(R^{G})(R^{H})(R^{J})( R^{K}), wherein L_{B92}(R1)(R1)(R1) (R1) to L_{B92}(R115)(R115) (R115)(R115) have the structure | 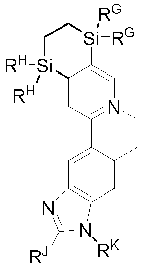 | | |

wherein R1 to R115 have the structures defined in LIST 4 defined herein.

In some embodiments, the compound has a formula selected from the group consisting of Ir(L_{A})(L_{B})₂, Ir(L_{A})₂(L_{B}), and Ir(L_{A})(L_{B})(L_{C}).

In some embodiments, Lc has a structure selected from the group consisting of the structures of the following LIST 8: 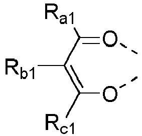 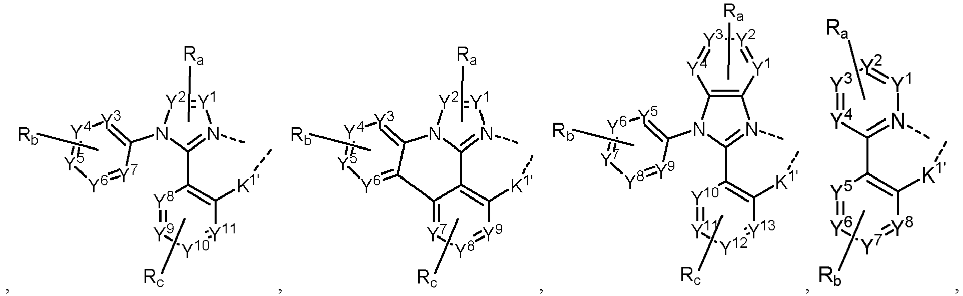 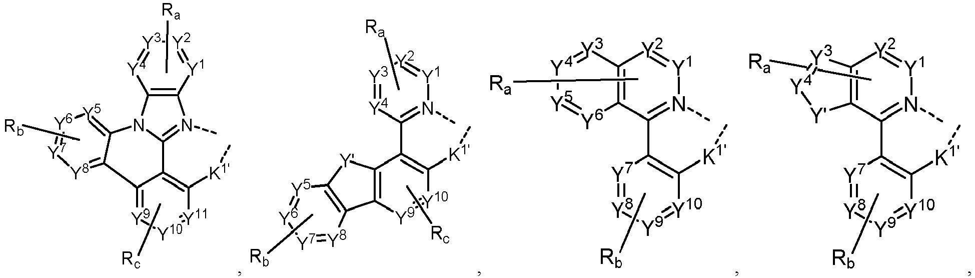 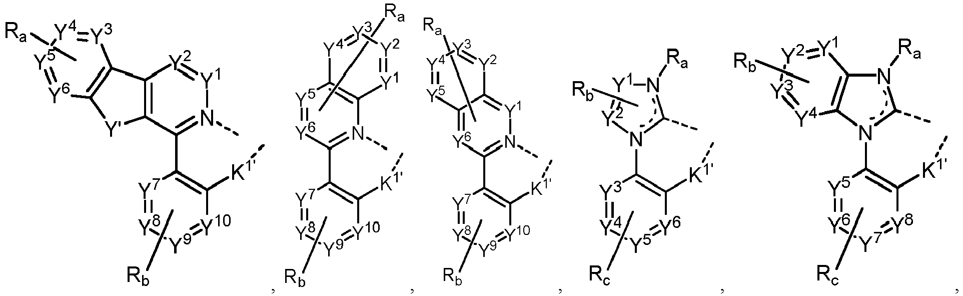 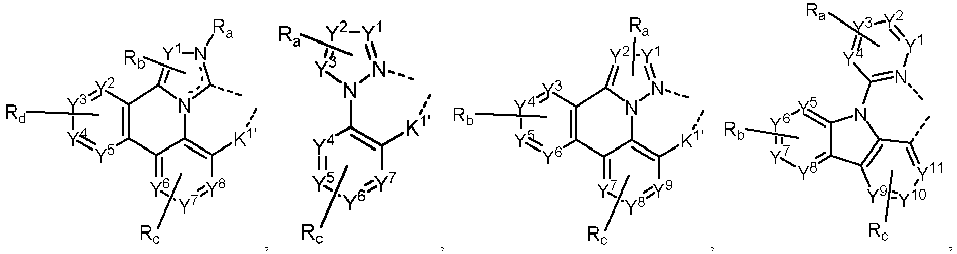 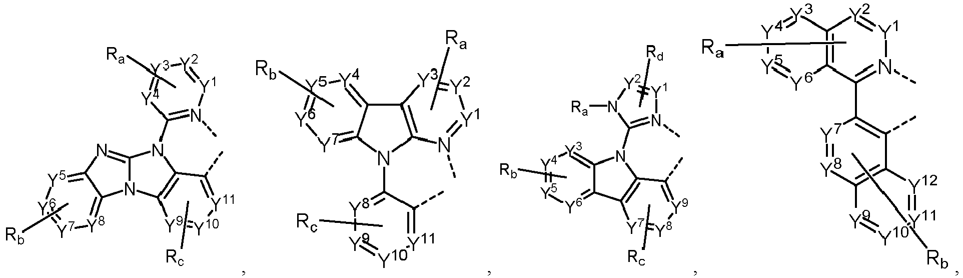 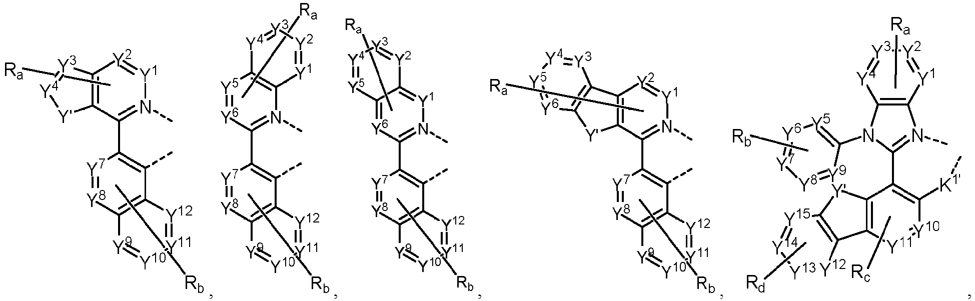 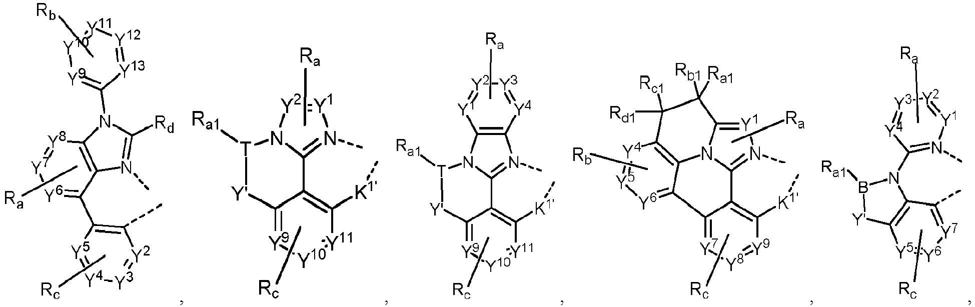 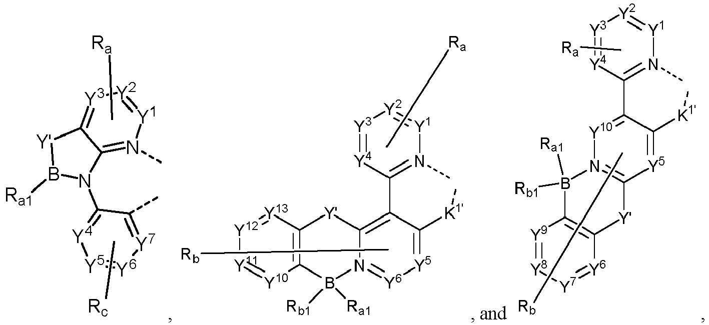 wherein:
T is selected from the group consisting of B, Al, Ga, and In;
K^{1'} is selected from the group consisting of a single bond, O, S, NRₑ, PRₑ, BRₑ, CRₑR_{f}, and SiRₑR_{f};
each of Y¹ to Y¹³ is independently selected from the group consisting of C and N;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and Rε can be fused or joined to form a ring;
each Rₐ, R_{b}, R_{c}, and R_{d} independently represents from mono to the maximum allowed number of substitutions, or no substitution;
each of Rₐ₁, R_{b1}, R_{c1}, R_{d1}, Rₐ, R_{b}, R_{c}, R_{d}, Rₑ, and Rε is independently a hydrogen or a subsituent selected from the group consisting of the General Substituents defined herein; and
any two substituents of Rₐ₁, R_{b1}, R_{c1}, R_{d1}, Rₐ, R_{b}, R_{c}, and R_{d} can be fused or joined to form a ring or form a multidentate ligand.

In some embodiments, Lc is selected from the group consisting of the structures of the following LIST 9: 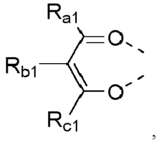 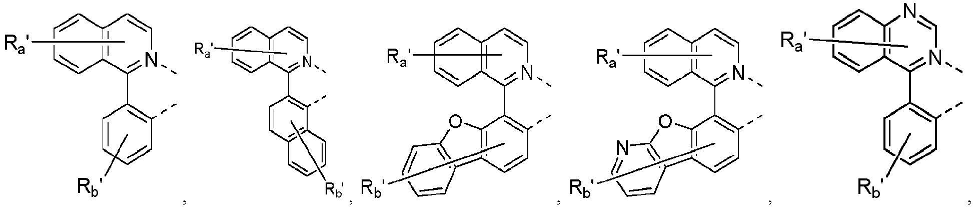 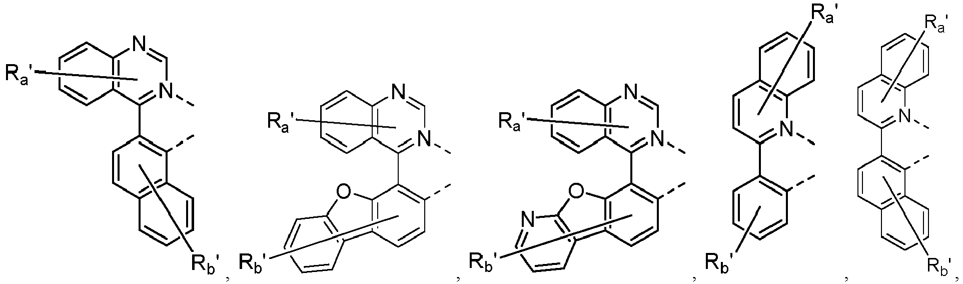 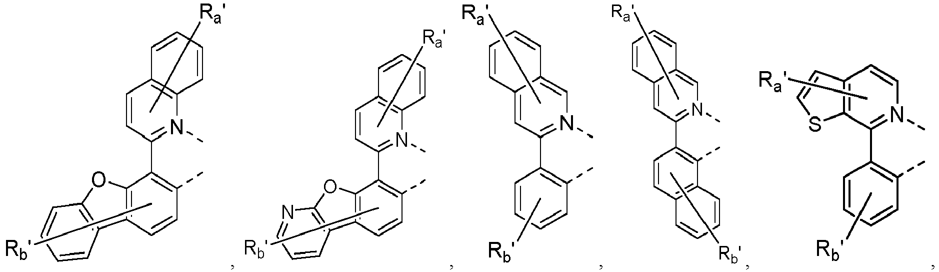 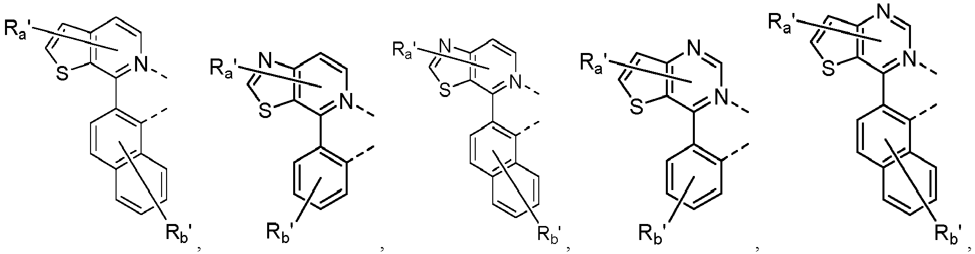 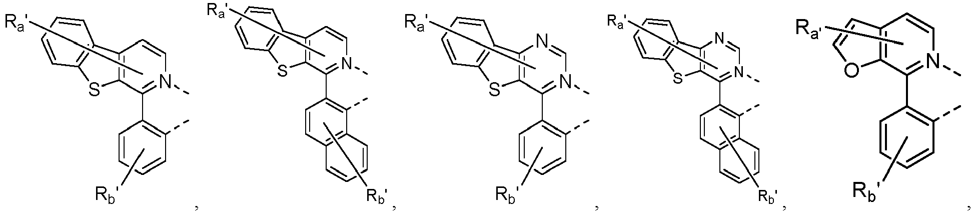 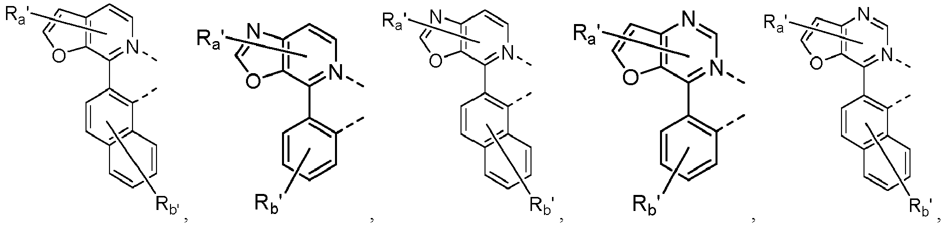 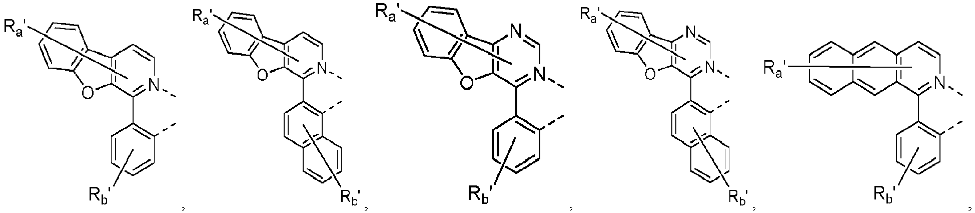 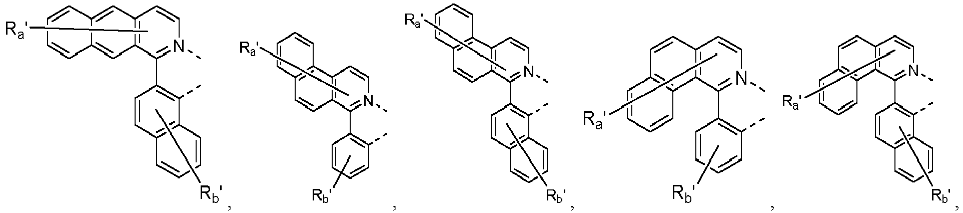 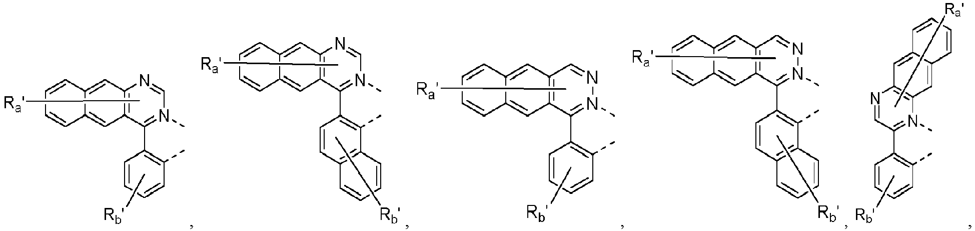 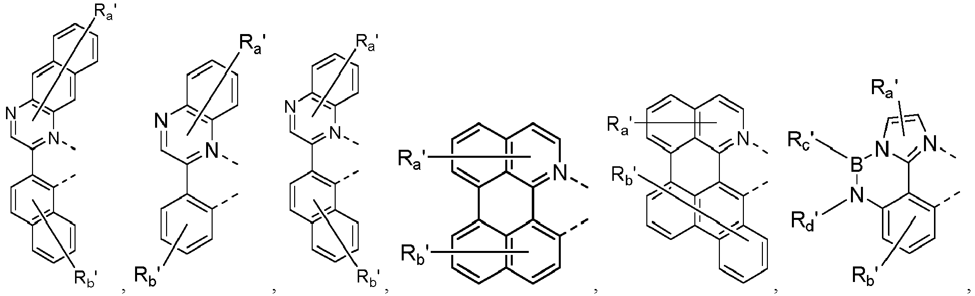 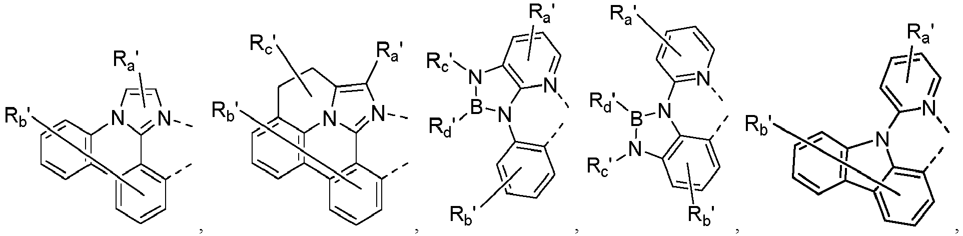 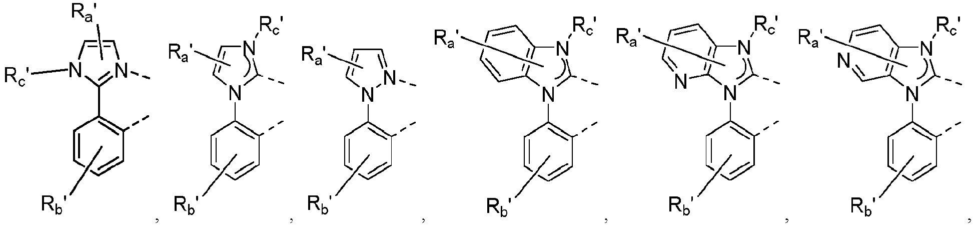 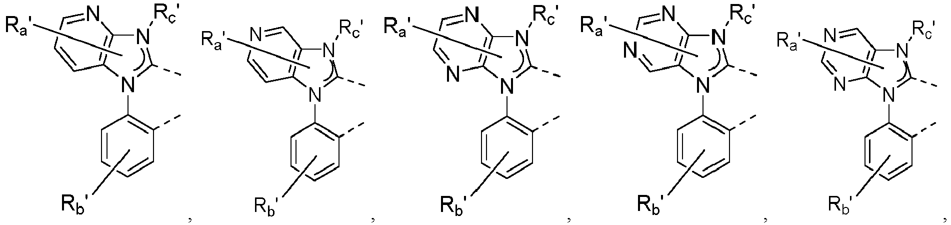 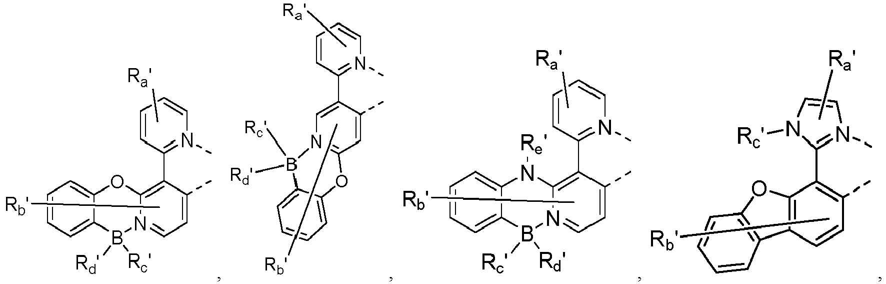 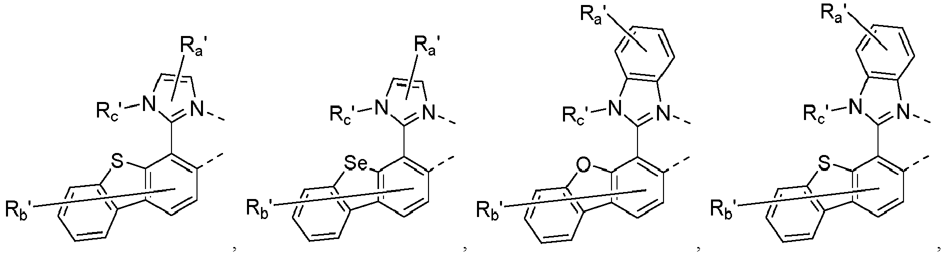 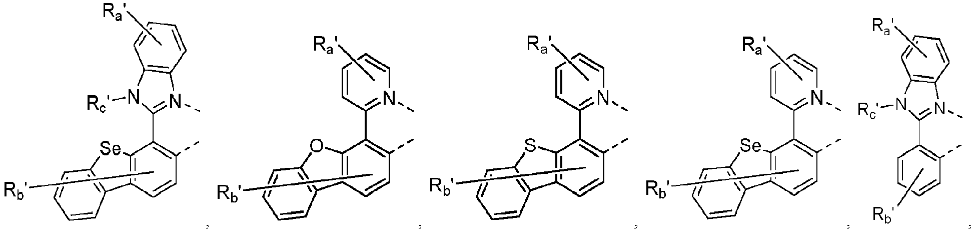 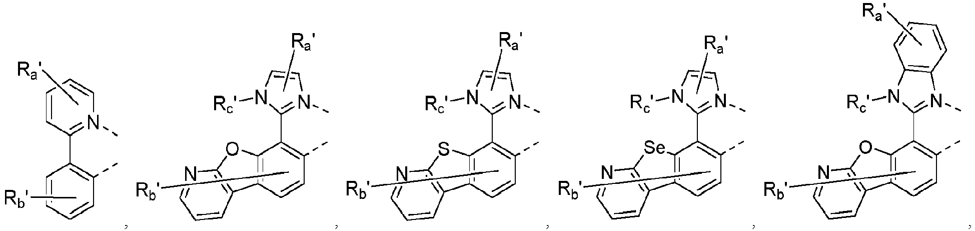 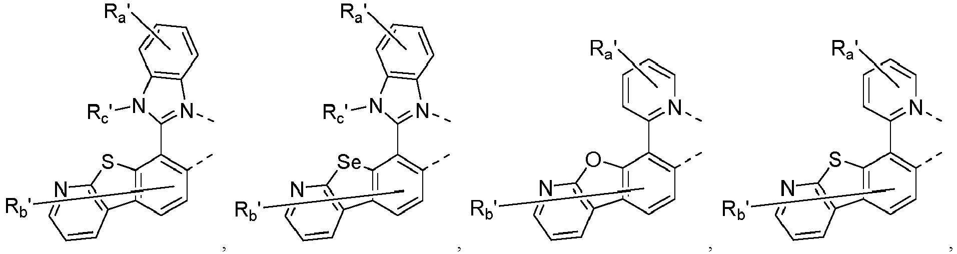 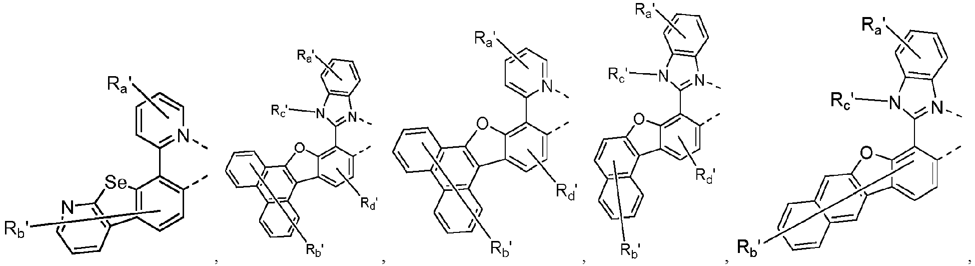 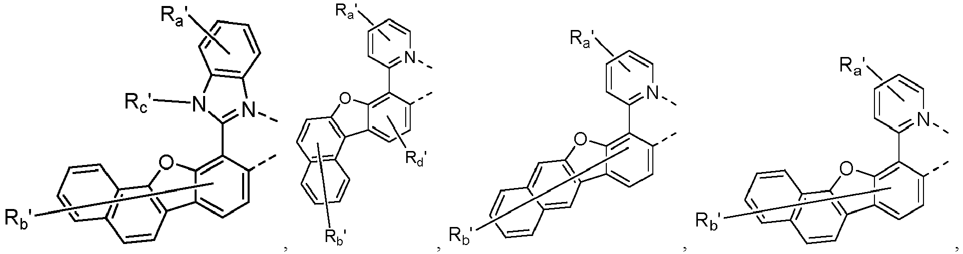 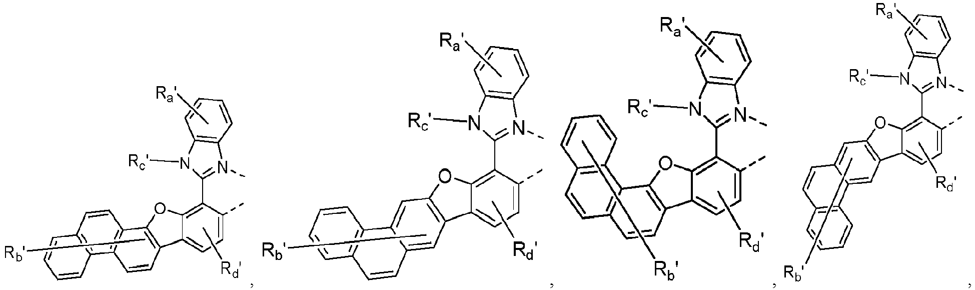 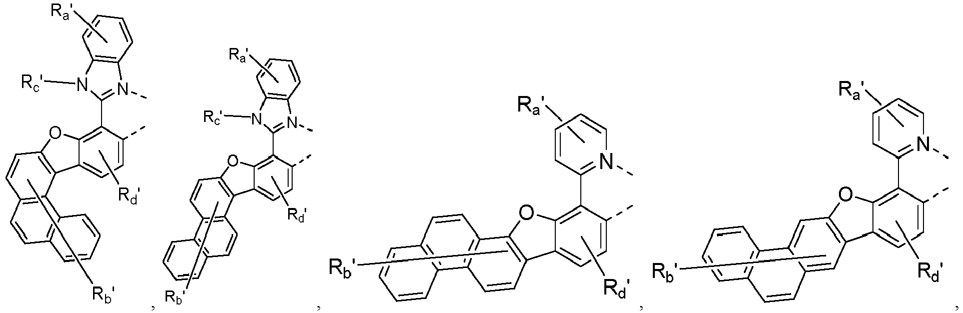 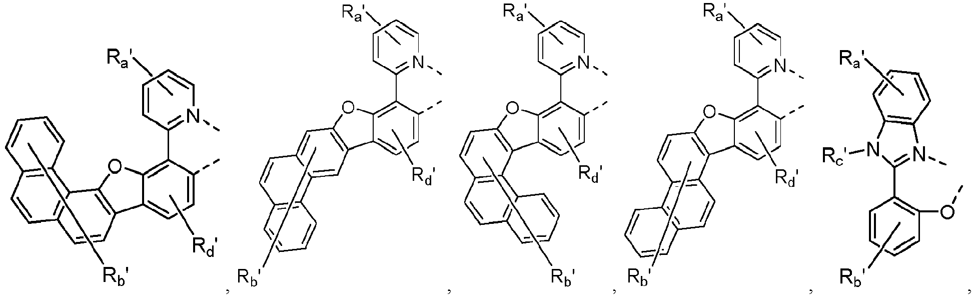 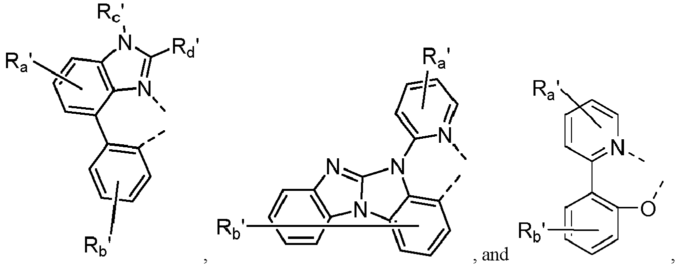 wherein:
Rₐ', R_{b}', R_{c}', R_{d}', and Rₑ' each independently represents zero, mono, or up to a maximum allowed number of substitution to its associated ring;
Rₐ', R_{b}', R_{c}', R_{d}', and Rₑ' each independently hydrogen or a substituent selected from the group consisting of the General Substituents defined herein; and
two substituents of Rₐ', R_{b}', R_{c}', R_{d}', and Rₑ' can be fused or joined to form a ring or form a multidentate ligand.

In some embodiments, the compound has formula Ir(L_{Ai}(R*m*)(R*n*)(R*o*)(R*p*))(L_{Bw}(R^{G})(R^{H})(R^{J})(R^{K}))₂, the compound is selected from the group consisting of Ir(L_{A1}(R1)(R1)(R1)(R1))(L_{B1}(R1)(R1)(R1)(R1))₂ to Ir(L_{A114}(R115)(R115)(R115)(R115))(L_{B92}(R115)(R115)(R115)(R115))₂;
when the compound has formula Ir(L_{Ai}(R*m*)(R*n*)(R*o*)(R*p*))₂(L_{Bw}(R^{G})(R^{H})(R¹)(R^{K})), the compound is selected from the group consisting of Ir(L_{A1}(R1)(R1)(R1)(R1))₂(L_{B1}(R1)(R1)(R1)(R1)) to Ir(L_{A114}(R115)(R115)(R115)(R115))₂(L_{B92}(R115)(R115)(R115)(R115));
when the compound has formula Ir(L_{Ai}(R*m*)(R*n*)(R*o*)(R*p*))(L_{Bw}(R^{G})(R^{H})(R^{J})(R^{K}))(L_{Cj-I}), *j* is an integer from 1 to 1416, wherein the compound is selected from the group consisting of Ir(L_{A1}(R1)(R1)(R1)(R1))(L_{B1}(R1)(R1)(R1)(R1))(L_{C1-I}) to Ir(L_{A114}(R115)(R115)(R115)(R115))(L_{B92}(R115)(R115)(R115)(R115))(L_{C1416-I}); and
when the compound has formula Ir(L_{Ai}(R*m*)(R*n*)(R*o*)(R*p*))(L_{Bw}(R(^{G})(R^{H})(R^{J})(R^{K}))(L_{Cj-II}), j is an integer from 1 to 1416, wherein the compound is selected from the group consisting of Ir(L_{A1}(R1)(R1)(R1)(R1))(L_{B1}(R1)(R1)(R1)(R1))(L_{C1-II}) to Ir(L_{A114}(R115)(R115)(R115)(R115))(L_{B92}(R115)(R115)(R115)(R115))(L_{C1416-II});
wherein each L_{C*j*-I} has a structure based on formula 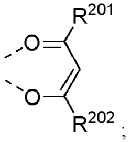 and
each L_{C*j*-II} has a structure based on formula 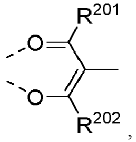 wherein for each L_{C*j*} in L_{C*j*-I} and L_{C*j*-II}, R²⁰¹ and R²⁰² are each independently defined in the following LIST 10:

| **L_{C*j*}** | **R²⁰¹** | **R²⁰²** | **L_{C*j*}** | **R²⁰¹** | **R²⁰²** | **L_{C*j*}** | **R²⁰¹** | **R²⁰²** | **L_{C*j*}** | **R²⁰¹** | **R²⁰²** |
|---|---|---|---|---|---|---|---|---|---|---|---|
| L_{C1} | R^{D1} | R^{D1} | L_{C193} | R^{D1} | R^{D3} | L_{C385} | R^{D17} | R^{D40} | L_{C577} | R^{D143} | R^{D120} |
| L_{C2} | R^{D2} | R^{D2} | L_{C194} | R^{D1} | R^{D4} | L_{C386} | R^{D17} | R^{D41} | L_{C578} | R^{D143} | R^{D133} |
| L_{C3} | R^{D3} | R^{D3} | L_{C195} | R^{D1} | R^{D5} | L_{C387} | R^{D17} | R^{D42} | L_{C579} | R^{D143} | R^{D134} |
| L_{C4} | R^{D4} | R^{D4} | L_{C196} | R^{D1} | R^{D9} | L_{C388} | R^{D17} | R^{D43} | L_{C580} | R^{D143} | R^{D135} |
| L_{C5} | R^{D5} | R^{D5} | L_{C197} | R^{D1} | R^{D10} | L_{C389} | R^{D17} | R^{D48} | L_{C581} | R^{D143} | R^{D136} |
| L_{C6} | R^{D6} | R^{D6} | L_{C198} | R^{D1} | R^{D17} | L_{C390} | R^{D17} | R^{D49} | L_{C582} | R^{D143} | R^{D144} |
| L_{C7} | R^{D7} | R^{D7} | L_{C199} | R^{D1} | R^{D18} | L_{C391} | R^{D17} | R^{D50} | L_{C583} | R^{D143} | R^{D145} |
| L_{C8} | R^{D8} | R^{D8} | L_{C200} | R^{D1} | R^{D20} | L_{C392} | R^{D17} | R^{D54} | L_{C584} | R^{D143} | R^{D146} |
| L_{C9} | R^{D9} | R^{D9} | L_{C201} | R^{D1} | R^{D22} | L_{C393} | R^{D17} | R^{D55} | L_{C585} | R^{D143} | R^{D147} |
| L_{C10} | R^{D10} | R^{D10} | L_{C202} | R^{D1} | R^{D37} | L_{C394} | R^{D17} | R^{D58} | L_{C586} | R^{D143} | R^{D149} |
| L_{C11} | R^{D11} | R^{D11} | L_{C203} | R^{D1} | R^{D40} | L_{C395} | R^{D17} | R^{DS9} | L_{C587} | R^{D143} | R^{D151} |
| L_{C12} | R^{D12} | R^{D12} | L_{C204} | R^{D1} | R^{D41} | L_{C396} | R^{D17} | R^{D78} | L_{C588} | R^{D143} | R^{D154} |
| L_{C13} | R^{D13} | R^{D13} | L_{C205} | R^{D1} | R^{D42} | L_{C397} | R^{D17} | R^{D79} | L_{C589} | R^{D143} | R^{D155} |
| L_{C14} | R^{D14} | R^{D14} | L_{C206} | R^{D1} | R^{D43} | L_{C398} | R^{D17} | R^{D81} | L_{C590} | R^{D143} | R^{D161} |
| L_{C15} | R^{D15} | R^{D15} | L_{C207} | R^{D1} | R^{D48} | L_{C399} | R^{D17} | R^{D87} | L_{C591} | R^{D143} | R^{D175} |
| L_{C16} | R^{D16} | R^{D16} | L_{C208} | R^{D1} | R^{D49} | L_{C400} | R^{D17} | R^{D88} | L_{C592} | R^{D144} | R^{D3} |
| L_{C17} | R^{D17} | R^{D17} | L_{C209} | R^{D1} | R^{D50} | L_{C401} | R^{D17} | R^{D89} | L_{C593} | R^{D144} | R^{D5} |
| L_{C18} | R^{D18} | R^{D18} | L_{C210} | R^{D1} | R^{D54} | L_{C402} | R^{D17} | R^{D93} | L_{C594} | R^{D144} | R^{D17} |
| L_{C19} | R^{D19} | R^{D19} | L_{C211} | R^{D1} | R^{D55} | L_{C403} | R^{D17} | R^{D116} | L_{C595} | R^{D144} | R^{D18} |
| L_{C20} | R^{D20} | R^{D20} | L_{C212} | R^{D1} | R^{D58} | L_{C404} | R^{D17} | R^{D117} | L_{C596} | R^{D144} | R^{D20} |
| L_{C21} | R^{D21} | R^{D21} | L_{C213} | R^{D1} | R^{D59} | L_{C405} | R^{D17} | R^{D118} | L_{C597} | R^{D144} | R^{D22} |
| L_{C22} | R^{D22} | R^{D22} | L_{C214} | R^{D1} | R^{D78} | L_{C406} | R^{D17} | R^{D119} | L_{C598} | R^{D144} | R^{D37} |
| L_{C23} | R^{D23} | R^{D23} | L_{C215} | R^{D1} | R^{D79} | L_{C407} | R^{D17} | R^{D120} | L_{C599} | R^{D144} | R^{D40} |
| L_{C24} | R^{D24} | R^{D24} | L_{C216} | R^{D1} | R^{D81} | L_{C408} | R^{D17} | R^{D133} | L_{C600} | R^{D144} | R^{D41} |
| L_{C25} | R^{D25} | R^{D25} | L_{C217} | R^{D1} | R^{D87} | L_{C409} | R^{D17} | R^{D134} | L_{C601} | R^{D144} | R^{D42} |
| L_{C26} | R^{D26} | R^{D26} | L_{C218} | R^{D1} | R^{D88} | L_{C410} | R^{D17} | R^{D135} | L_{C602} | R^{D144} | R^{D43} |
| L_{C27} | R^{D27} | R^{D27} | L_{C219} | R^{D1} | R^{D89} | L_{C411} | R^{D17} | R^{D136} | L_{C603} | R^{D144} | R^{D48} |
| L_{C28} | R^{D28} | R^{D28} | L_{C220} | R^{D1} | R^{D93} | L_{C412} | R^{D17} | R^{D143} | L_{C604} | R^{D144} | R^{D49} |
| L_{C29} | R^{D29} | R^{D29} | L_{C221} | R^{D1} | R^{D116} | L_{C413} | R^{D17} | R^{D144} | L_{C605} | R^{D144} | R^{D54} |
| L_{C30} | R^{D30} | R^{D30} | L_{C222} | R^{D1} | R^{D117} | L_{C414} | R^{D17} | R^{D145} | L_{C606} | R^{D144} | R^{D58} |
| L_{C31} | R^{D31} | R^{D31} | L_{C223} | R^{D1} | R^{D118} | L_{C415} | R^{D17} | R^{D146} | L_{C607} | R^{D144} | R^{D59} |
| L_{C32} | R^{D32} | R^{D32} | L_{C224} | R^{D1} | R^{D119} | L_{C416} | R^{D17} | R^{D147} | L_{C608} | R^{D144} | R^{D78} |
| L_{C33} | R^{D33} | R^{D33} | L_{C225} | R^{D1} | R^{D120} | L_{C417} | R^{D17} | R^{D149} | L_{C609} | R^{D144} | R^{D79} |
| L_{C34} | R^{D34} | R^{D34} | L_{C226} | R^{D1} | R^{D133} | L_{C418} | R^{D17} | R^{D151} | L_{C610} | R^{D144} | R^{D81} |
| L_{C35} | R^{D35} | R^{D35} | L_{C227} | R^{D1} | R^{D134} | L_{C419} | R^{D17} | R^{D154} | L_{C611} | R^{D144} | R^{D87} |
| L_{C36} | R^{D36} | R^{D36} | L_{C228} | R^{D1} | R^{D135} | L_{C420} | R^{D17} | R^{D155} | L_{C612} | R^{D144} | R^{D88} |
| L_{C37} | R^{D37} | R^{D37} | L_{C229} | R^{D1} | R^{D136} | L_{C421} | R^{D17} | R^{D161} | L_{C613} | R^{D144} | R^{D89} |
| L_{C38} | R^{D38} | R^{D38} | L_{C230} | R^{D1} | R^{D143} | L_{C422} | R^{D17} | R^{D175} | L_{C614} | R^{D144} | R^{D93} |
| L_{C39} | R^{D39} | R^{D39} | L_{C231} | R^{D1} | R^{D144} | L_{C423} | R^{D50} | R^{D3} | L_{C615} | R^{D144} | R^{D116} |
| L_{C40} | R^{D40} | R^{D40} | L_{C232} | R^{D1} | R^{D145} | L_{C424} | R^{D50} | R^{D5} | L_{C616} | R^{D144} | R^{D117} |
| L_{C41} | R^{D41} | R^{D41} | L_{C233} | R^{D1} | R^{D146} | L_{C425} | R^{D50} | R^{D18} | L_{C617} | R^{D144} | R^{D118} |
| L_{C42} | R^{D42} | R^{D42} | L_{C234} | R^{D1} | R^{D147} | L_{C426} | R^{D50} | R^{D20} | L_{C618} | R^{D144} | R^{D119} |
| L_{C43} | R^{D43} | R^{D43} | L_{C235} | R^{D1} | R^{D149} | L_{C427} | R^{D50} | R^{D22} | L_{C619} | R^{D144} | R^{D120} |
| L_{C44} | R^{D44} | R^{D44} | L_{C236} | R^{D1} | R^{D151} | L_{C428} | R^{D50} | R^{D37} | L_{C620} | R^{D144} | R^{D133} |
| L_{C45} | R^{D45} | R^{D45} | L_{C237} | R^{D1} | R^{D154} | L_{C429} | R^{D50} | R^{D40} | L_{C621} | R^{D144} | R^{D134} |
| L_{C46} | R^{D46} | R^{D46} | L_{C238} | R^{D1} | R^{D155} | L_{C430} | R^{D50} | R^{D41} | L_{C622} | R^{D144} | R^{D135} |
| L_{C47} | R^{D47} | R^{D47} | L_{C239} | R^{D1} | R^{D161} | L_{C431} | R^{D50} | R^{D42} | L_{C623} | R^{D144} | R^{D136} |
| L_{C48} | R^{D48} | R^{D48} | L_{C240} | R^{D1} | R^{D175} | L_{C432} | R^{D50} | R^{D43} | L_{C624} | R^{D144} | R^{D145} |
| L_{C49} | R^{D49} | R^{D49} | L_{C241} | R^{D4} | R^{D3} | L_{C433} | R^{D50} | R^{D48} | L_{C625} | R^{D144} | R^{D146} |
| L_{C50} | R^{D50} | R^{D50} | L_{C242} | R^{D4} | R^{D5} | L_{C434} | R^{D50} | R^{D49} | L_{C626} | R^{D144} | R^{D147} |
| L_{C51} | R^{D51} | R^{D51} | L_{C243} | R^{D4} | R^{D9} | L_{C435} | R^{D50} | R^{D54} | L_{C627} | R^{D144} | R^{D149} |
| L_{C52} | R^{D52} | R^{D52} | L_{C244} | R^{D4} | R^{D10} | L_{C436} | R^{D50} | R^{D55} | L_{C628} | R^{D144} | R^{D151} |
| L_{C53} | R^{D53} | R^{D53} | L_{C245} | R^{D4} | R^{D17} | L_{C437} | R^{D50} | R^{D58} | L_{C629} | R^{D144} | R^{D154} |
| L_{C54} | R^{D54} | R^{D54} | L_{C246} | R^{D4} | R^{D18} | L_{C438} | R^{D50} | R^{DS9} | L_{C630} | R^{D144} | R^{D155} |
| L_{C55} | R^{D55} | R^{D55} | L_{C247} | R^{D4} | R^{D20} | L_{C439} | R^{D50} | R^{D78} | L_{C631} | R^{D144} | R^{D161} |
| L_{C56} | R^{DS6} | R^{DS6} | L_{C248} | R^{D4} | R^{D22} | L_{C440} | R^{D50} | R^{D79} | L_{C632} | R^{D144} | R^{D175} |
| L_{C57} | R^{D57} | R^{D57} | L_{C249} | R^{D4} | R^{D37} | L_{C441} | R^{D50} | R^{D81} | L_{C633} | R^{D145} | R^{D3} |
| L_{C58} | R^{D58} | R^{D58} | L_{C250} | R^{D4} | R^{D40} | L_{C442} | R^{D50} | R^{D87} | L_{C634} | R^{D145} | R^{D5} |
| L_{C59} | R^{DS9} | ^{RDS9} | L_{C251} | R^{D4} | R^{D41} | L_{C443} | R^{D50} | R^{D88} | L_{C635} | R^{D145} | R^{D17} |
| L_{C60} | R^{D60} | R^{D60} | L_{C252} | R^{D4} | R^{D42} | L_{C444} | R^{D50} | R^{D89} | L_{C636} | R^{D145} | R^{D18} |
| L_{C61} | R^{D61} | R^{D61} | L_{C253} | R^{D4} | R^{D43} | L_{C445} | R^{D50} | R^{D93} | L_{C637} | R^{D145} | R^{D20} |
| L_{C62} | R^{D62} | R^{D62} | L_{C254} | R^{D4} | R^{D48} | L_{C446} | R^{D50} | R^{D116} | L_{C638} | R^{D145} | R^{D22} |
| L_{C63} | R^{D63} | R^{D63} | L_{C255} | R^{D4} | R^{D49} | L_{C447} | R^{D50} | R^{D117} | L_{C639} | R^{D145} | R^{D37} |
| L_{C64} | R^{D64} | R^{D64} | L_{C256} | R^{D4} | R^{D50} | L_{C448} | R^{D50} | R^{D118} | L_{C640} | R^{D145} | R^{D40} |
| L_{C65} | R^{D65} | R^{D65} | L_{C257} | R^{D4} | R^{D54} | L_{C449} | R^{D50} | R^{D119} | L_{C641} | R^{D145} | R^{D41} |
| L_{C66} | R^{D66} | R^{D66} | L_{C258} | R^{D4} | R^{D55} | L_{C450} | R^{D50} | R^{D120} | L_{C642} | R^{D145} | R^{D42} |
| L_{C67} | R^{D67} | R^{D67} | L_{C259} | R^{D4} | R^{D58} | L_{C451} | R^{D50} | R^{D133} | L_{C643} | R^{D145} | R^{D43} |
| L_{C68} | R^{D68} | R^{D68} | L_{C260} | R^{D4} | R^{D59} | L_{C452} | R^{D50} | R^{D134} | L_{C644} | R^{D145} | R^{D48} |
| L_{C69} | R^{D69} | R^{D69} | L_{C261} | R^{D4} | R^{D78} | L_{C453} | R^{D50} | R^{D135} | L_{C645} | R^{D145} | R^{D49} |
| L_{C70} | R^{D70} | R^{D70} | L_{C262} | R^{D4} | R^{D79} | L_{C454} | R^{D50} | R^{D136} | L_{C646} | R^{D145} | R^{D54} |
| L_{C71} | R^{D71} | R^{D71} | L_{C263} | R^{D4} | R^{D81} | L_{C455} | R^{D50} | R^{D143} | L_{C647} | R^{D145} | R^{D58} |
| L_{C72} | R^{D72} | R^{D72} | L_{C264} | R^{D4} | R^{D87} | L_{C456} | R^{D50} | R^{D144} | L_{C648} | R^{D145} | R^{D59} |
| L_{C73} | R^{D73} | R^{D73} | L_{C265} | R^{D4} | R^{D88} | L_{C457} | R^{D50} | R^{D145} | L_{C649} | R^{D145} | R^{D78} |
| L_{C74} | R^{D74} | R^{D74} | L_{C266} | R^{D4} | R^{D89} | L_{C458} | R^{D50} | R^{D146} | L_{C650} | R^{D145} | R^{D79} |
| L_{C75} | R^{D75} | R^{D75} | L_{C267} | R^{D4} | R^{D93} | L_{C459} | R^{D50} | R^{D147} | L_{C651} | R^{D145} | R^{D81} |
| L_{C76} | R^{D76} | R^{D76} | L_{C268} | R^{D4} | R^{D116} | L_{C460} | R^{D50} | R^{D149} | L_{C652} | R^{D145} | R^{D87} |
| L_{C77} | R^{D77} | R^{D77} | L_{C269} | R^{D4} | R^{D117} | L_{C461} | R^{D50} | R^{D151} | L_{C653} | R^{D145} | R^{D88} |
| L_{C78} | R^{D78} | R^{D78} | L_{C270} | R^{D4} | R^{D118} | L_{C462} | R^{D50} | R^{D154} | L_{C654} | R^{D145} | R^{D89} |
| L_{C79} | R^{D79} | R^{D79} | L_{C271} | R^{D4} | R^{D119} | L_{C463} | R^{D50} | R^{D155} | L_{C655} | R^{D145} | R^{D93} |
| L_{C80} | R^{D80} | R^{D80} | L_{C272} | R^{D4} | R^{D120} | L_{C464} | R^{D50} | R^{D161} | L_{C656} | R^{D145} | R^{D116} |
| L_{C81} | R^{D81} | R^{D81} | L_{C273} | R^{D4} | R^{D133} | L_{C465} | R^{D50} | R^{D175} | L_{C657} | R^{D145} | R^{D117} |
| L_{C82} | R^{D82} | R^{D82} | L_{C274} | R^{D4} | R^{D134} | L_{C466} | R^{D55} | R^{D3} | L_{C658} | R^{D145} | R^{D118} |
| L_{C83} | R^{D83} | R^{D83} | L_{C275} | R^{D4} | R^{D135} | L_{C467} | R^{D55} | R^{D5} | L_{C659} | R^{D145} | R^{D119} |
| L_{C84} | R^{D84} | R^{D84} | L_{C276} | R^{D4} | R^{D136} | L_{C468} | R^{D55} | R^{D18} | L_{C660} | R^{D145} | R^{D120} |
| L_{C85} | R^{D85} | R^{D85} | L_{C277} | R^{D4} | R^{D143} | L_{C469} | R^{D55} | R^{D20} | L_{C661} | R^{D145} | R^{D133} |
| L_{C86} | R^{D86} | R^{D86} | L_{C278} | R^{D4} | R^{D144} | L_{C470} | R^{D55} | R^{D22} | L_{C662} | R^{D145} | R^{D134} |
| L_{C87} | R^{D87} | R^{D87} | L_{C279} | R^{D4} | R^{D145} | L_{C471} | R^{D55} | R^{D37} | L_{C663} | R^{D145} | R^{D135} |
| L_{C88} | R^{D88} | R^{D88} | L_{C280} | R^{D4} | R^{D146} | L_{C472} | R^{D55} | R^{D40} | L_{C664} | R^{D145} | R^{D136} |
| L_{C89} | R^{D89} | R^{D89} | L_{C281} | R^{D4} | R^{D147} | L_{C473} | R^{D55} | R^{D41} | L_{C665} | R^{D145} | R^{D146} |
| L_{C90} | R^{D90} | R^{D90} | L_{C282} | R^{D4} | R^{D149} | L_{C474} | R^{D55} | R^{D42} | L_{C666} | R^{D145} | R^{D147} |
| L_{C91} | R^{D91} | R^{D91} | L_{C283} | R^{D4} | R^{D151} | L_{C475} | R^{D55} | R^{D43} | L_{C667} | R^{D145} | R^{D149} |
| L_{C92} | R^{D92} | R^{D92} | L_{C284} | R^{D4} | R^{D154} | L_{C476} | R^{D55} | R^{D48} | L_{C668} | R^{D145} | R^{D151} |
| L_{C93} | R^{D93} | R^{D93} | L_{C285} | R^{D4} | R^{D155} | L_{C477} | R^{D55} | R^{D49} | L_{C669} | R^{D145} | R^{D154} |
| L_{C94} | R^{D94} | R^{D94} | L_{C286} | R^{D4} | R^{D161} | L_{C478} | R^{D55} | R^{D54} | L_{C670} | R^{D145} | R^{D155} |
| L_{C95} | R^{D95} | R^{D95} | L_{C287} | R^{D4} | R^{D175} | L_{C479} | R^{D55} | R^{D58} | L_{C671} | R^{D145} | R^{D161} |
| L_{C96} | R^{D96} | R^{D96} | L_{C288} | R^{D9} | R^{D3} | L_{C480} | R^{D55} | R^{D59} | L_{C672} | R^{D145} | R^{D175} |
| L_{C97} | R^{D97} | R^{D97} | L_{C289} | R^{D9} | R^{D5} | L_{C481} | R^{D55} | R^{D78} | L_{C673} | R^{D146} | R^{D3} |
| L_{C98} | R^{D98} | R^{D98} | L_{C290} | R^{D9} | R^{D10} | L_{C482} | R^{D55} | R^{D79} | L_{C674} | R^{D146} | R^{D5} |
| L_{C99} | R^{D99} | R^{D99} | L_{C291} | R^{D9} | R^{D17} | L_{C483} | R^{D55} | R^{D81} | L_{C675} | R^{D146} | R^{D17} |
| L_{C100} | R^{D100} | R^{D100} | L_{C292} | R^{D9} | R^{D18} | L_{C484} | R^{D55} | R^{D87} | L_{C676} | R^{D146} | R^{D18} |
| L_{C101} | R^{D101} | R^{D101} | L_{C293} | R^{D9} | R^{D20} | L_{C485} | R^{D55} | R^{D88} | L_{C677} | R^{D146} | R^{D20} |
| L_{C205} | R^{D102} | R^{D102} | L_{C294} | R^{D9} | R^{D22} | L_{C486} | R^{D55} | R^{D89} | L_{C678} | R^{D146} | R^{D22} |
| L_{C103} | R^{D103} | R^{D103} | L_{C295} | R^{D9} | R^{D37} | L_{C487} | R^{D55} | R^{D93} | L_{C679} | R^{D146} | R^{D37} |
| L_{C104} | R^{D104} | R^{D104} | L_{C296} | R^{D9} | R^{D40} | L_{C488} | R^{D55} | R^{D116} | L_{C680} | R^{D146} | R^{D40} |
| L_{C105} | R^{D105} | R^{D105} | L_{C297} | R^{D9} | R^{D41} | L_{C489} | R^{D55} | R^{D117} | L_{C681} | R^{D146} | R^{D41} |
| L_{C106} | R^{D106} | R^{D106} | L_{C298} | R^{D9} | R^{D42} | L_{C490} | R^{D55} | R^{D118} | L_{C682} | R^{D146} | R^{D42} |
| L_{C107} | R^{D107} | R^{D107} | L_{C299} | R^{D9} | R^{D43} | L_{C491} | R^{D55} | R^{D119} | L_{C683} | R^{D146} | R^{D43} |
| L_{C108} | R^{D108} | R^{D108} | L_{C300} | R^{D9} | R^{D48} | L_{C492} | R^{D55} | R^{D120} | L_{C684} | R^{D146} | R^{D48} |
| L_{C109} | R^{D109} | R^{D109} | L_{C301} | R^{D9} | R^{D49} | L_{C493} | R^{D55} | R^{D133} | L_{C685} | R^{D146} | R^{D49} |
| L_{C110} | R^{D110} | R^{D110} | L_{C302} | R^{D9} | R^{D50} | L_{C494} | R^{D55} | R^{D134} | L_{C686} | R^{D146} | R^{DS4} |
| L_{C111} | R^{D111} | R^{D111} | L_{C303} | R^{D9} | R^{D54} | L_{c495} | R^{D55} | R^{D135} | L_{C687} | R^{D146} | R^{D58} |
| L_{C112} | R^{D112} | R^{D112} | L_{C304} | R^{D9} | R^{D55} | L_{C496} | R^{D55} | R^{D136} | L_{C688} | R^{D146} | R^{D59} |
| L_{C113} | R^{D113} | R^{D113} | L_{C305} | R^{D9} | R^{D58} | L_{C497} | R^{D55} | R^{D143} | L_{C689} | R^{D146} | R^{D78} |
| L_{C114} | R^{D114} | R^{D114} | L_{C306} | R^{D9} | R^{DS9} | L_{C498} | R^{D55} | R^{D144} | L_{C690} | R^{D146} | R^{D79} |
| L_{C115} | R^{D115} | R^{D115} | L_{C307} | R^{D9} | R^{D78} | L_{C499} | R^{D55} | R^{D145} | L_{C691} | R^{D146} | R^{D81} |
| L_{C116} | R^{D116} | R^{D116} | L_{C308} | R^{D9} | R^{D79} | L_{C500} | R^{D55} | R^{D146} | L_{C692} | R^{D146} | R^{D87} |
| L_{C117} | R^{D117} | R^{D117} | L_{C309} | R^{D9} | R^{D81} | L_{C501} | R^{D55} | R^{D147} | L_{C693} | R^{D146} | R^{D88} |
| L_{C118} | R^{D118} | R^{D118} | L_{C310} | R^{D9} | R^{D87} | L_{C502} | R^{D55} | R^{D149} | L_{C694} | R^{D146} | R^{D89} |
| L_{C119} | R^{D119} | R^{D119} | L_{C311} | R^{D9} | R^{D88} | L_{C503} | R^{D55} | R^{D151} | L_{C695} | R^{D146} | R^{D93} |
| L_{C120} | R^{D120} | R^{D120} | L_{C312} | R^{D9} | R^{D89} | L_{C504} | R^{D55} | R^{D154} | L_{C696} | R^{D146} | R^{D117} |
| L_{C121} | R^{D121} | R^{D121} | L_{C313} | R^{D9} | R^{D93} | L_{C505} | R^{D55} | R^{D155} | L_{C697} | R^{D146} | R^{D118} |
| L_{C122} | R^{D122} | R^{D122} | L_{C314} | R^{D9} | R^{D116} | L_{C506} | R^{D55} | R^{D161} | L_{C698} | R^{D146} | R^{D119} |
| L_{C123} | R^{D123} | R^{D123} | L_{C315} | R^{D9} | R^{D117} | L_{C507} | R^{D55} | R^{D175} | L_{C699} | R^{D146} | R^{D120} |
| L_{C124} | R^{D124} | R^{D124} | L_{C316} | R^{D9} | R^{D118} | L_{C508} | R^{D116} | R^{D3} | L_{C700} | R^{D146} | R^{D133} |
| L_{C125} | R^{D125} | R^{D125} | L_{C317} | R^{D9} | R^{D119} | L_{C509} | R^{D116} | R^{D5} | L_{C701} | R^{D146} | R^{D134} |
| L_{C126} | R^{D126} | R^{D126} | L_{C318} | R^{D9} | R^{D120} | L_{C510} | R^{D116} | R^{D17} | L_{C702} | R^{D146} | R^{D135} |
| L_{C127} | R^{D127} | R^{D127} | L_{C319} | R^{D9} | R^{D133} | L_{C511} | R^{D116} | R^{D18} | L_{C703} | R^{D146} | R^{D136} |
| L_{C128} | R^{D128} | R^{D128} | L_{C320} | R^{D9} | R^{D134} | L_{C512} | R^{D116} | R^{D20} | L_{C704} | R^{D146} | R^{D146} |
| L_{C129} | R^{D129} | R^{D129} | L_{C321} | R^{D9} | R^{D135} | L_{C513} | R^{D116} | R^{D22} | L_{C705} | R^{D146} | R^{D147} |
| L_{C130} | R^{D130} | R^{D130} | L_{C322} | R^{D9} | R^{D136} | L_{C514} | R^{D116} | R^{D37} | L_{C706} | R^{D146} | R^{D149} |
| L_{C131} | R^{D131} | R^{D131} | L_{C323} | R^{D9} | R^{D143} | L_{C515} | R^{D116} | R^{D40} | L_{C707} | R^{D146} | R^{D151} |
| L_{C132} | R^{D132} | R^{D132} | L_{C324} | R^{D9} | R^{D144} | L_{C516} | R^{D116} | R^{D41} | L_{C708} | R^{D146} | R^{D154} |
| L_{C133} | R^{D133} | R^{D133} | L_{C325} | R^{D9} | R^{D145} | L_{C517} | R^{D116} | R^{D42} | L_{C709} | R^{D146} | R^{D155} |
| L_{C134} | R^{D134} | R^{D134} | L_{C326} | R^{D9} | R^{D146} | L_{C518} | R^{D116} | R^{D43} | L_{C710} | R^{D146} | R^{D161} |
| L_{C135} | R^{D135} | R^{D135} | L_{C327} | R^{D9} | R^{D147} | L_{C519} | R^{D116} | R^{D48} | L_{C711} | R^{D146} | R^{D175} |
| L_{C136} | R^{D136} | R^{D136} | L_{C328} | R^{D9} | R^{D149} | L_{C520} | R^{D116} | R^{D49} | L_{C712} | R^{D133} | R^{D3} |
| L_{C137} | R^{D137} | R^{D137} | L_{C329} | R^{D9} | R^{D151} | L_{C521} | R^{D116} | R^{D54} | L_{C713} | R^{D133} | R^{D5} |
| L_{C138} | R^{D138} | R^{D138} | L_{C330} | R^{D9} | R^{D154} | L_{C522} | R^{D116} | R^{D58} | L_{C714} | R^{D133} | R^{D3} |
| L_{C139} | R^{D139} | R^{D139} | L_{C331} | R^{D9} | R^{D155} | L_{C523} | R^{D116} | R^{D59} | L_{C715} | R^{D133} | R^{D18} |
| L_{C140} | R^{D140} | R^{D140} | L_{C332} | R^{D9} | R^{D161} | L_{C524} | R^{D116} | R^{D78} | L_{C716} | R^{D133} | R^{D20} |
| L_{C141} | R^{D141} | R^{D141} | L_{C333} | R^{D9} | R^{D175} | L_{C525} | R^{D116} | R^{D79} | L_{C717} | R^{D133} | R^{D22} |
| L_{C142} | R^{D142} | R^{D142} | L_{C334} | R^{D10} | R^{D3} | L_{C526} | R^{D116} | R^{D81} | L_{C718} | R^{D133} | R^{D37} |
| L_{C143} | R^{D143} | R^{D143} | L_{C335} | R^{D10} | R^{D5} | L_{C527} | R^{D116} | R^{D87} | L_{C719} | R^{D133} | R^{D40} |
| L_{C144} | R^{D144} | R^{D144} | L_{C336} | R^{D10} | R^{D17} | L_{C528} | R^{D116} | R^{D88} | L_{C720} | R^{D133} | R^{D41} |
| L_{C145} | R^{D145} | R^{D145} | L_{C337} | R^{D10} | R^{D18} | L_{C529} | R^{D116} | R^{D89} | L_{C721} | R^{D133} | R^{D42} |
| L_{C146} | R^{D146} | R^{D146} | L_{C338} | R^{D10} | R^{D20} | L_{C530} | R^{D116} | R^{D93} | L_{C722} | R^{D133} | R^{D43} |
| L_{C147} | R^{D147} | R^{D147} | L_{C339} | R^{D10} | R^{D22} | L_{C531} | R^{D116} | R^{D117} | L_{C723} | R^{D133} | R^{D48} |
| L_{C148} | R^{D148} | R^{D148} | L_{C340} | R^{D10} | R^{D37} | L_{C532} | R^{D116} | R^{D118} | L_{C724} | R^{D133} | R^{D49} |
| L_{C149} | R^{D149} | R^{D149} | L_{C341} | R^{D10} | R^{D40} | L_{C533} | R^{D116} | R^{D119} | L_{C725} | R^{D133} | R^{D54} |
| L_{C150} | R^{D150} | R^{D150} | L_{C342} | R^{D10} | R^{D41} | L_{C534} | R^{D116} | R^{D120} | L_{C726} | R^{D133} | R^{D58} |
| L_{C151} | R^{D151} | R^{D151} | L_{C343} | R^{D10} | R^{D42} | L_{C535} | R^{D116} | R^{D133} | L_{C727} | R^{D133} | R^{DS9} |
| L_{C152} | R^{D152} | R^{D152} | L_{C344} | R^{D10} | R^{D43} | L_{C536} | R^{D116} | R^{D134} | L_{C728} | R^{D133} | R^{D78} |
| L_{C153} | R^{D153} | R^{D153} | L_{C345} | R^{D10} | R^{D48} | L_{C537} | R^{D116} | R^{D135} | L_{C729} | R^{D133} | R^{D79} |
| L_{C154} | R^{D154} | R^{D154} | L_{C346} | R^{D10} | R^{D49} | L_{C538} | R^{D116} | R^{D136} | L_{C730} | R^{D133} | R^{D81} |
| L_{C155} | R^{D155} | R^{D155} | L_{C347} | R^{D10} | R^{D50} | L_{C539} | R^{D116} | R^{D143} | L_{C731} | R^{D133} | R^{D87} |
| L_{C156} | R^{D156} | R^{D156} | L_{C348} | R^{D10} | R^{D54} | L_{C540} | R^{D116} | R^{D144} | L_{C732} | R^{D133} | R^{D88} |
| L_{C157} | R^{D157} | R^{D157} | L_{C349} | R^{D10} | R^{D55} | L_{C541} | R^{D116} | R^{D145} | L_{C733} | R^{D133} | R^{D89} |
| L_{C158} | R^{D158} | R^{D158} | L_{C350} | R^{D10} | R^{D58} | L_{C542} | R^{D116} | R^{D146} | L_{C734} | R^{D133} | R^{D93} |
| L_{C159} | R^{D159} | R^{D159} | L_{C351} | R^{D10} | R^{DS9} | L_{C543} | R^{D116} | R^{D147} | L_{C735} | R^{D133} | R^{D117} |
| L_{C160} | R^{D160} | R^{D160} | L_{C352} | R^{D10} | R^{D78} | L_{C544} | R^{D116} | R^{D149} | L_{C736} | R^{D133} | R^{D118} |
| L_{C161} | R^{D161} | R^{D161} | L_{C353} | R^{D10} | R^{D79} | L_{C545} | R^{D116} | R^{D151} | L_{C737} | R^{D133} | R^{D119} |
| L_{C162} | R^{D162} | R^{D162} | L_{C354} | R^{D10} | R^{D81} | L_{C546} | R^{D116} | R^{D154} | L_{C738} | R^{D133} | R^{D120} |
| L_{C163} | R^{D163} | R^{D163} | L_{C355} | R^{D10} | R^{D87} | L_{C547} | R^{D116} | R^{D155} | L_{C739} | R^{D133} | R^{D133} |
| L_{C164} | R^{D164} | R^{D164} | L_{C356} | R^{D10} | R^{D88} | L_{C548} | R^{D116} | R^{D161} | L_{C740} | R^{D133} | R^{D134} |
| L_{C165} | R^{D165} | R^{D165} | L_{C357} | R^{D10} | R^{D89} | L_{C549} | R^{D116} | R^{D175} | L_{C741} | R^{D133} | R^{D135} |
| L_{C166} | R^{D166} | R^{D166} | L_{C358} | R^{D10} | R^{D93} | L_{C550} | R^{D143} | R^{D3} | L_{C742} | R^{D133} | R^{D136} |
| L_{C167} | R^{D167} | R^{D167} | L_{C359} | R^{D10} | R^{D116} | L_{C551} | R^{D143} | R^{D5} | L_{C743} | R^{D133} | R^{D146} |
| L_{C168} | R^{D168} | R^{D168} | L_{C360} | R^{D10} | R^{D117} | L_{C552} | R^{D143} | R^{D17} | L_{C744} | R^{D133} | R^{D147} |
| L_{C169} | R^{D169} | R^{D169} | L_{C361} | R^{D10} | R^{D118} | L_{C553} | R^{D143} | R^{D18} | L_{C745} | R^{D133} | R^{D149} |
| L_{C170} | R^{D170} | R^{D170} | L_{C362} | R^{D10} | R^{D119} | L_{C554} | R^{D143} | R^{D20} | L_{C746} | R^{D133} | R^{D151} |
| L_{C171} | R^{D171} | R^{D171} | L_{C363} | R^{D10} | R^{D120} | L_{C555} | R^{D143} | R^{D22} | L_{C747} | R^{D133} | R^{D154} |
| L_{C172} | R^{D172} | R^{D172} | L_{C364} | R^{D10} | R^{D133} | L_{C556} | R^{D143} | R^{D37} | L_{C748} | R^{D133} | R^{D155} |
| L_{C173} | R^{D173} | R^{D173} | L_{C365} | R^{D10} | R^{D134} | L_{C557} | R^{D143} | R^{D40} | L_{C749} | R^{D133} | R^{D161} |
| L_{C174} | R^{D174} | R^{D174} | L_{C366} | R^{D10} | R^{D135} | L_{C558} | R^{D143} | R^{D41} | L_{C750} | R^{D133} | R^{D175} |
| L_{C175} | R^{D175} | R^{D175} | L_{C367} | R^{D10} | R^{D136} | L_{C559} | R^{D143} | R^{D42} | L_{C751} | R^{D175} | R^{D3} |
| L_{C176} | R^{D176} | R^{D176} | L_{C368} | R^{D10} | R^{D143} | L_{C560} | R^{D143} | R^{D43} | L_{C752} | R^{D175} | R^{D5} |
| L_{C177} | R^{D177} | R^{D177} | L_{C369} | R^{D10} | R^{D144} | L_{C561} | R^{D143} | R^{D48} | L_{C753} | R^{D175} | R^{D18} |
| L_{C178} | R^{D178} | R^{D178} | L_{C370} | R^{D10} | R^{D145} | L_{C562} | R^{D143} | R^{D49} | L_{C754} | R^{D175} | R^{D20} |
| L_{C179} | R^{D179} | R^{D179} | L_{C371} | R^{D10} | R^{D146} | L_{C563} | R^{D143} | R^{D54} | L_{C755} | R^{D175} | R^{D22} |
| L_{C180} | R^{D180} | R^{D180} | L_{C372} | R^{D10} | R^{D147} | L_{C564} | R^{D143} | R^{D58} | L_{C756} | R^{D175} | R^{D37} |
| L_{C181} | R^{D181} | R^{D181} | L_{C373} | R^{D10} | R^{D149} | L_{C565} | R^{D143} | R^{DS9} | L_{C757} | R^{D175} | R^{D40} |
| L_{C182} | R^{D182} | R^{D182} | L_{C374} | R^{D10} | R^{D151} | L_{C566} | R^{D143} | R^{D78} | L_{C758} | R^{D175} | R^{D41} |
| L_{C183} | R^{D183} | R^{D183} | L_{C375} | R^{D10} | R^{D154} | L_{C567} | R^{D143} | R^{D79} | L_{C759} | R^{D175} | R^{D42} |
| L_{C184} | R^{D184} | R^{D184} | L_{C376} | R^{D10} | R^{D155} | L_{C568} | R^{D143} | R^{D81} | L_{C760} | R^{D175} | R^{D43} |
| L_{C185} | R^{D185} | R^{D185} | L_{C377} | R^{D10} | R^{D161} | L_{C569} | R^{D143} | R^{D87} | L_{C761} | R^{D175} | R^{D48} |
| L_{C186} | R^{D186} | R^{D186} | L_{C378} | R^{D10} | R^{D175} | L_{C570} | R^{D143} | R^{D88} | L_{C762} | R^{D175} | R^{D49} |
| L_{C187} | R^{D187} | R^{D187} | L_{C379} | R^{D17} | R^{D3} | L_{C571} | R^{D143} | R^{D89} | L_{C763} | R^{D175} | R^{D54} |
| L_{C188} | R^{D188} | R^{D188} | L_{C380} | R^{D17} | R^{D5} | L_{C572} | R^{D143} | R^{D93} | L_{C764} | R^{D175} | R^{D58} |
| L_{C189} | R^{D189} | R^{D189} | L_{C381} | R^{D17} | R^{D18} | L_{C573} | R^{D143} | R^{D116} | L_{C765} | R^{D175} | R^{D59} |
| L_{C190} | R^{D190} | R^{D190} | L_{C382} | R^{D17} | R^{D20} | L_{C574} | R^{D143} | R^{D117} | L_{C766} | R^{D175} | R^{D78} |
| L_{C191} | R^{D191} | R^{D191} | L_{C383} | R^{D17} | R^{D22} | L_{C575} | R^{D143} | R^{D118} | L_{C767} | R^{D175} | R^{D79} |
| L_{C192} | R^{D192} | R^{D192} | L_{C384} | R^{D17} | R^{D37} | L_{C576} | R^{D143} | R^{D119} | L_{C768} | R^{D175} | R^{D81} |
| L_{C769} | R^{D193} | R^{D193} | L_{C877} | R^{D1} | R^{D193} | L_{C985} | R^{D4} | R^{D193} | L_{C1093} | R^{D9} | R^{D193} |
| L_{C770} | R^{D194} | R^{D194} | L_{C878} | R^{D1} | R^{D194} | L_{C986} | R^{D4} | R^{D194} | L_{C1094} | R^{D9} | R^{D194} |
| L_{C771} | R^{D195} | R^{D195} | L_{C879} | R^{D1} | R^{D195} | L_{C987} | R^{D4} | R^{D195} | L_{C1095} | R^{D9} | R^{D195} |
| L_{C772} | R^{D196} | R^{D196} | L_{C880} | R^{D1} | R^{D196} | L_{C988} | R^{D4} | R^{D196} | L_{C1096} | R^{D9} | R^{D196} |
| L_{C773} | R^{D197} | R^{D197} | L_{C881} | R^{D1} | R^{D197} | L_{C989} | R^{D4} | R^{D197} | L_{C1097} | R^{D9} | R^{D197} |
| L_{C774} | R^{D198} | R^{D198} | L_{C882} | R^{D1} | R^{D198} | L_{C990} | R^{D4} | R^{D198} | L_{C1098} | R^{D9} | R^{D198} |
| L_{C775} | R^{D199} | R^{D199} | L_{C883} | R^{D1} | R^{D199} | L_{C991} | R^{D4} | R^{D199} | L_{C1099} | R^{D9} | R^{D199} |
| L_{C776} | R^{D200} | R^{D200} | L_{C884} | R^{D1} | R^{D200} | L_{C992} | R^{D4} | R^{D200} | L_{C1100} | R^{D9} | R^{D200} |
| L_{C777} | R^{D201} | R^{D201} | L_{C885} | R^{D1} | R^{D201} | L_{C993} | R^{D4} | R^{D201} | L_{C1101} | R^{D9} | R^{D201} |
| L_{C778} | R^{D202} | R^{D202} | L_{C886} | R^{D1} | R^{D202} | L_{C994} | R^{D4} | R^{D202} | L_{C1102} | R^{D9} | R^{D202} |
| L_{C779} | R^{D203} | R^{D203} | L_{C887} | R^{D1} | R^{D203} | L_{C995} | R^{D4} | R^{D203} | L_{C1103} | R^{D9} | R^{D203} |
| L_{C780} | R^{D204} | R^{D204} | L_{C888} | R^{D1} | R^{D204} | L_{C996} | R^{D4} | R^{D204} | L_{C1104} | R^{D9} | R^{D204} |
| L_{C781} | R^{D205} | R^{D205} | L_{C889} | R^{D1} | R^{D205} | L_{C997} | R^{D4} | R^{D205} | L_{C1105} | R^{D9} | R^{D205} |
| L_{C782} | R^{D206} | R^{D206} | L_{C890} | R^{D1} | R^{D206} | L_{C998} | R^{D4} | R^{D206} | L_{C1106} | R^{D9} | R^{D206} |
| L_{C783} | R^{D207} | R^{D207} | L_{C891} | R^{D1} | R^{D207} | L_{C999} | R^{D4} | R^{D207} | L_{C1107} | R^{D9} | R^{D207} |
| L_{C784} | R^{D208} | R^{D208} | L_{C892} | R^{D1} | R^{D208} | L_{C1000} | R^{D4} | R^{D208} | L_{C1108} | R^{D9} | R^{D208} |
| L_{C785} | R^{D209} | R^{D209} | L_{C893} | R^{D1} | R^{D209} | L_{C1001} | R^{D4} | R^{D209} | L_{C1109} | R^{D9} | R^{D209} |
| L_{C786} | R^{D210} | R^{D210} | L_{C894} | R^{D1} | R^{D210} | L_{C1002} | R^{D4} | R^{D210} | L_{C1110} | R^{D9} | R^{D210} |
| L_{C787} | R^{D211} | R^{D211} | L_{C895} | R^{D1} | R^{D211} | L_{C1003} | R^{D4} | R^{D211} | L_{C111} | R^{D9} | R^{D211} |
| L_{C788} | R^{D212} | R^{D212} | L_{C896} | R^{D1} | R^{D212} | L_{C1004} | R^{D4} | R^{D212} | L_{C1112} | R^{D9} | R^{D212} |
| L_{C789} | R^{D213} | R^{D213} | L_{C897} | R^{D1} | R^{D213} | L_{C1005} | R^{D4} | R^{D213} | L_{C1113} | R^{D9} | R^{D213} |
| L_{C790} | R^{D214} | R^{D214} | L_{C898} | R^{D1} | R^{D214} | L_{C1006} | R^{D4} | R^{D214} | L_{C1114} | R^{D9} | R^{D214} |
| L_{C791} | R^{D215} | R^{D215} | L_{C899} | R^{D1} | R^{D215} | L_{C1007} | R^{D4} | R^{D215} | L_{C1115} | R^{D9} | R^{D215} |
| L_{C792} | R^{D216} | R^{D216} | L_{C900} | R^{D1} | R^{D216} | L_{C1008} | R^{D4} | R^{D216} | L_{C1116} | R^{D9} | R^{D216} |
| L_{C793} | R^{D217} | R^{D217} | L_{C901} | R^{D1} | R^{D217} | L_{C1009} | R^{D4} | R^{D217} | L_{C1117} | R^{D9} | R^{D217} |
| L_{C794} | R^{D218} | R^{D218} | L_{C902} | R^{D1} | R^{D218} | L_{C1010} | R^{D4} | R^{D218} | L_{C1118} | R^{D9} | R^{D218} |
| L_{C795} | R^{D219} | R^{D219} | L_{C903} | R^{D1} | R^{D219} | L_{C1011} | R^{D4} | R^{D219} | L_{C1119} | R^{D9} | R^{D219} |
| L_{C796} | R^{D220} | R^{D220} | L_{C904} | R^{D1} | R^{D220} | L_{C1012} | R^{D4} | R^{D220} | L_{C1120} | R^{D9} | R^{D220} |
| L_{C797} | R^{D221} | R^{D221} | L_{C905} | R^{D1} | R^{D221} | L_{C1013} | R^{D4} | R^{D221} | L_{C1121} | R^{D9} | R^{D221} |
| L_{C798} | R^{D222} | R^{D222} | L_{C906} | R^{D1} | R^{D222} | L_{C1014} | R^{D4} | R^{D222} | L_{C1122} | R^{D9} | R^{D222} |
| L_{C799} | R^{D223} | R^{D223} | L_{C907} | R^{D1} | R^{D223} | L_{C1015} | R^{D4} | R^{D223} | L_{C1123} | R^{D9} | R^{D223} |
| L_{C800} | R^{D224} | R^{D224} | L_{C908} | R^{D1} | R^{D224} | L_{C1016} | R^{D4} | R^{D224} | L_{C1124} | R^{D9} | R^{D224} |
| L_{C801} | R^{D225} | R^{D225} | L_{C909} | R^{D1} | R^{D225} | L_{C1017} | R^{D4} | R^{D225} | L_{C1125} | R^{D9} | R^{D225} |
| L_{C802} | R^{D226} | R^{D226} | L_{C910} | R^{D1} | R^{D226} | L_{C1018} | R^{D4} | R^{D226} | L_{C1126} | R^{D9} | R^{D226} |
| L_{C803} | R^{D227} | R^{D227} | L_{C911} | R^{D1} | R^{D227} | L_{C1019} | R^{D4} | R^{D227} | L_{C1127} | R^{D9} | R^{D227} |
| L_{C804} | R^{D228} | R^{D228} | L_{C912} | R^{D1} | R^{D228} | L_{C1020} | R^{D4} | R^{D228} | L_{C1128} | R^{D9} | R^{D228} |
| L_{C805} | R^{D229} | R^{D229} | L_{C913} | R^{D1} | R^{D229} | L_{C1021} | R^{D4} | R^{D229} | L_{C1129} | R^{D9} | R^{D229} |
| L_{C806} | R^{D230} | R^{D230} | L_{C914} | R^{D1} | R^{D230} | L_{C1022} | R^{D4} | R^{D230} | L_{C1130} | R^{D9} | R^{D230} |
| L_{C807} | R^{D231} | R^{D231} | L_{C915} | R^{D1} | R^{D231} | L_{C1023} | R^{D4} | R^{D231} | L_{C1131} | R^{D9} | R^{D231} |
| L_{C808} | R^{D232} | R^{D232} | L_{C916} | R^{D1} | R^{D232} | L_{C1024} | R^{D4} | R^{D232} | L_{C1132} | R^{D9} | R^{D232} |
| L_{C809} | R^{D233} | R^{D233} | L_{C917} | R^{D1} | R^{D233} | L_{C1025} | R^{D4} | R^{D233} | L_{C1133} | R^{D9} | R^{D233} |
| L_{C810} | R^{D234} | R^{D234} | L_{C918} | R^{D1} | R^{D234} | L_{C1026} | R^{D4} | R^{D234} | L_{C1134} | R^{D9} | R^{D234} |
| L_{C811} | R^{D235} | R^{D235} | L_{C919} | R^{D1} | R^{D235} | L_{C1027} | R^{D4} | R^{D235} | L_{C1135} | R^{D9} | R^{D235} |
| L_{C812} | R^{D236} | R^{D236} | L_{C920} | R^{D1} | R^{D236} | L_{C1028} | R^{D4} | R^{D236} | L_{C1136} | R^{D9} | R^{D236} |
| L_{C813} | R^{D237} | R^{D237} | L_{C921} | R^{D1} | R^{D237} | L_{C1029} | R^{D4} | R^{D237} | L_{C1137} | R^{D9} | R^{D237} |
| L_{C814} | R^{D238} | R^{D238} | L_{C922} | R^{D1} | R^{D238} | L_{C1030} | R^{D4} | R^{D238} | L_{C1138} | R^{D9} | R^{D238} |
| L_{C815} | R^{D239} | R^{D239} | L_{C923} | R^{D1} | R^{D239} | L_{C1031} | R^{D4} | R^{D239} | L_{C1139} | R^{D9} | R^{D239} |
| L_{C816} | R^{D240} | R^{D240} | L_{C924} | R^{D1} | R^{D240} | L_{C1032} | R^{D4} | R^{D240} | L_{C1140} | R^{D9} | R^{D240} |
| L_{C817} | R^{D241} | R^{D241} | L_{C925} | R^{D1} | R^{D241} | L_{C1033} | R^{D4} | R^{D241} | L_{C1141} | R^{D9} | R^{D241} |
| L_{C818} | R^{D242} | R^{D242} | L_{C926} | R^{D1} | R^{D242} | L_{C1034} | R^{D4} | R^{D242} | L_{C1142} | R^{D9} | R^{D242} |
| L_{C819} | R^{D243} | R^{D243} | L_{C927} | R^{D1} | R^{D243} | L_{C1035} | R^{D4} | R^{D243} | L_{C1143} | R^{D9} | R^{D243} |
| L_{C820} | R^{D244} | R^{D244} | L_{C928} | R^{D1} | R^{D244} | L_{C1036} | R^{D4} | R^{D244} | L_{C1144} | R^{D9} | R^{D244} |
| L_{C8211} | R^{D245} | R^{D245} | L_{C929} | R^{D1} | R^{D245} | L_{C1037} | R^{D4} | R^{D245} | L_{C1145} | R^{D9} | R^{D245} |
| L_{C822} | R^{D246} | R^{D246} | L_{C930} | R^{D1} | R^{D246} | L_{C1038} | R^{D4} | R^{D246} | L_{C1146} | R^{D9} | R^{D246} |
| L_{C823} | R^{D17} | R^{D193} | L_{C931} | R⁵⁰ | R^{D193} | L_{C1039} | R^{D145} | R^{D193} | L_{C1147} | R^{D168} | R^{D193} |
| L_{C824} | R^{D17} | R^{D194} | L_{C932} | R⁵⁰ | R^{D194} | L_{C1040} | R^{D145} | R^{D194} | L_{C1148} | R^{D168} | R^{D194} |
| L_{C825} | R^{D17} | R^{D195} | L_{C933} | R⁵⁰ | R^{D195} | L_{C1041} | R^{D145} | R^{D195} | L_{C1149} | R^{D168} | R^{D195} |
| L_{C826} | R^{D17} | R^{D196} | L_{C934} | R⁵⁰ | R^{D196} | L_{C1042} | R^{D145} | R^{D196} | L_{C1150} | R^{D168} | R^{D196} |
| L_{C827} | R^{D17} | R^{D197} | L_{C935} | R⁵⁰ | R^{D197} | L_{C1043} | R^{D145} | R^{D197} | L_{C1151} | R^{D168} | R^{D197} |
| L_{C828} | R^{D17} | R^{D198} | L_{C936} | R⁵⁰ | R^{D198} | L_{C1044} | R^{D145} | R^{D198} | L_{C1152} | R^{D168} | R^{D198} |
| L_{C829} | R^{D17} | R^{D199} | L_{C937} | R⁵⁰ | R^{D199} | L_{C1045} | R^{D145} | R^{D199} | L_{C1153} | R^{D168} | R^{D199} |
| L_{C830} | R^{D17} | R^{D200} | L_{C938} | R⁵⁰ | R^{D200} | L_{C1046} | R^{D145} | R^{D200} | L_{C1154} | R^{D168} | R^{D200} |
| L_{C831} | R^{D17} | R^{D201} | L_{C939} | R⁵⁰ | R^{D201} | L_{C1047} | R^{D145} | R^{D201} | L_{C1155} | R^{D168} | R^{D201} |
| L_{C832} | R^{D17} | R^{D202} | L_{C940} | R⁵⁰ | R^{D202} | L_{C1048} | R^{D145} | R^{D202} | L_{C1156} | R^{D168} | R^{D202} |
| L_{C833} | R^{D17} | R^{D203} | L_{C941} | R⁵⁰ | R^{D203} | L_{C1049} | R^{D145} | R^{D203} | L_{C1157} | R^{D168} | R^{D203} |
| L_{C834} | R^{D17} | R^{D204} | L_{C942} | R⁵⁰ | R^{D204} | L_{C1050} | R^{D145} | R^{D204} | L_{C1158} | R^{D168} | R^{D204} |
| L_{C835} | R^{D17} | R^{D205} | L_{C943} | R⁵⁰ | R^{D205} | L_{C1051} | R^{D145} | R^{D205} | L_{C1159} | R^{D168} | R^{D205} |
| L_{C836} | R^{D17} | R^{D206} | L_{C944} | R⁵⁰ | R^{D206} | L_{C1051} | R^{D145} | R^{D206} | L_{C1160} | R^{D168} | R^{D206} |
| L_{C837} | R^{D17} | R^{D207} | L_{C945} | R^{D50} | R^{D207} | L_{C1053} | R^{D145} | R^{D207} | L_{C1161} | R^{D168} | R^{D207} |
| L_{C838} | R^{D17} | R^{D208} | L_{C946} | R^{D50} | R^{D208} | L_{C1054} | R^{D145} | R^{D208} | L_{C1162} | R^{D168} | R^{D208} |
| L_{C839} | R^{D17} | R^{D209} | L_{C947} | R^{D50} | R^{D209} | L_{C1055} | R^{D145} | R^{D209} | L_{C1163} | R^{D168} | R^{D209} |
| L_{C840} | R^{D17} | R^{D210} | L_{C948} | R^{D50} | R^{D210} | L_{C1056} | R^{D145} | R^{D210} | L_{C1164} | R^{D168} | R^{D210} |
| L_{C841} | R^{D17} | R^{D211} | L_{C949} | R^{D50} | R^{D211} | L_{C1057} | R^{D145} | R^{D211} | L_{C1165} | R^{D168} | R^{D211} |
| L_{C842} | R^{D17} | R^{D212} | L_{C950} | R^{D50} | R^{D212} | L_{C1058} | R^{D145} | R^{D212} | L_{C1166} | R^{D168} | R^{D212} |
| L_{C843} | R^{D17} | R^{D213} | L_{C951} | R^{D50} | R^{D213} | L_{C1059} | R^{D145} | R^{D213} | L_{C1167} | R^{D168} | R^{D213} |
| L_{C844} | R^{D17} | R^{D214} | L_{C952} | R^{D50} | R^{D214} | L_{C1060} | R^{D145} | R^{D214} | L_{C1168} | R^{D168} | R^{D214} |
| L_{C845} | R^{D17} | R^{D215} | L_{C953} | R^{D50} | R^{D215} | L_{C1061} | R^{D145} | R^{D215} | L_{C1169} | R^{D168} | R^{D215} |
| L_{C846} | R^{D17} | R^{D216} | L_{C954} | R^{D50} | R^{D216} | L_{C1062} | R^{D145} | R^{D216} | L_{C1170} | R^{D168} | R^{D216} |
| L_{C847} | R^{D17} | R^{D217} | L_{C955} | R^{D50} | R^{D217} | L_{C1063} | R^{D145} | R^{D217} | L_{C1171} | R^{D168} | R^{D217} |
| L_{C848} | R^{D17} | R^{D218} | L_{C956} | R^{D50} | R^{D218} | L_{C1064} | R^{D145} | R^{D218} | L_{C1172} | R^{D168} | R^{D218} |
| L_{C849} | R^{D17} | R^{D219} | L_{C957} | R^{D50} | R^{D219} | L_{C1065} | R^{D145} | R^{D219} | L_{C1173} | R^{D168} | R^{D219} |
| L_{C850} | R^{D17} | R^{D220} | L_{C958} | R^{D50} | R^{D220} | L_{C1066} | R^{D145} | R^{D220} | L_{C1174} | R^{D168} | R^{D220} |
| L_{C851} | R^{D17} | R^{D221} | L_{C959} | R^{D50} | R^{D221} | L_{C1067} | R^{D145} | R^{D221} | L_{C1175} | R^{D168} | R^{D221} |
| L_{C852} | R^{D17} | R^{D222} | L_{C960} | R^{D50} | R^{D222} | L_{C1068} | R^{D145} | R^{D222} | L_{C1176} | R^{D168} | R^{D222} |
| L_{C853} | R^{D17} | R^{D223} | L_{C961} | R^{D50} | R^{D223} | L_{C1069} | R^{D145} | R^{D223} | L_{C1177} | R^{D168} | R^{D223} |
| L_{C854} | R^{D17} | R^{D224} | L_{C962} | R^{D50} | R^{D224} | L_{C1070} | R^{D145} | R^{D224} | L_{C1178} | R^{D168} | R^{D224} |
| L_{C855} | R^{D17} | R^{D225} | L_{C963} | R^{D50} | R^{D225} | L_{C1071} | R^{D145} | R^{D225} | L_{C1179} | R^{D168} | R^{D225} |
| L_{C856} | R^{D17} | R^{D226} | L_{C964} | R^{D50} | R^{D226} | L_{C1072} | R^{D145} | R^{D226} | L_{C1180} | R^{D168} | R^{D226} |
| L_{C857} | R^{D17} | R^{D227} | L_{C965} | R^{D50} | R^{D227} | L_{C1073} | R^{D145} | R^{D227} | L_{C1181} | R^{D168} | R^{D227} |
| L_{C858} | R^{D17} | R^{D228} | L_{C966} | R^{D50} | R^{D228} | L_{C1074} | R^{D145} | R^{D228} | L_{C1182} | R^{D168} | R^{D228} |
| L_{C859} | R^{D17} | R^{D229} | L_{C967} | R^{D50} | R^{D229} | L_{C1075} | R^{D145} | R^{D229} | L_{C1183} | R^{D168} | R^{D229} |
| L_{C860} | R^{D17} | R^{D230} | L_{C968} | R^{D50} | R^{D230} | L_{c1076} | R^{D145} | R^{D230} | L_{c1184} | R^{D168} | R^{D230} |
| L_{C861} | R^{D17} | R^{D231} | L_{C969} | R^{D50} | R^{D231} | L_{C1077} | R^{D145} | R^{D231} | L_{C1185} | R^{D168} | R^{D231} |
| L_{C862} | R^{D17} | R^{D232} | L_{C970} | R^{D50} | R^{D232} | L_{C1078} | R^{D145} | R^{D232} | L_{C1186} | R^{D168} | R^{D232} |
| L_{C863} | R^{D17} | R^{D233} | L_{C971} | R^{D50} | R^{D233} | L_{C1079} | R^{D145} | R^{D233} | L_{C1187} | R^{D168} | R^{D233} |
| L_{C864} | R^{D17} | R^{D234} | L_{C972} | R^{D50} | R^{D234} | L_{C1080} | R^{D145} | R^{D234} | L_{C1188} | R^{D168} | R^{D234} |
| L_{C865} | R^{D17} | R^{D235} | L_{C973} | R^{D50} | R^{D235} | L_{C1081} | R^{D145} | R^{D235} | L_{c1189} | R^{D168} | R^{D235} |
| L_{C866} | R^{D17} | R^{D236} | L_{C974} | R^{D50} | R^{D236} | L_{C1082} | R^{D145} | R^{D236} | L_{C1190} | R^{D168} | R^{D236} |
| L_{C867} | R^{D17} | R^{D237} | L_{C975} | R^{D50} | R^{D237} | L_{C1083} | R^{D145} | R^{D237} | L_{C1191} | R^{D168} | R^{D237} |
| L_{C868} | R^{D17} | R^{D238} | L_{C976} | R^{D50} | R^{D238} | L_{C1084} | R^{D145} | R^{D238} | L_{C1192} | R^{D168} | R^{D238} |
| L_{C869} | R^{D17} | R^{D239} | L_{C977} | R^{D50} | R^{D239} | L_{C1085} | R^{D145} | R^{D239} | L_{C1193} | R^{D168} | R^{D239} |
| L_{C870} | R^{D17} | R^{D240} | L_{C978} | R^{D50} | R^{D240} | L_{C1086} | R^{D145} | R^{D240} | L_{C1194} | R^{D168} | R^{D240} |
| L_{C871} | R^{D17} | R^{D241} | L_{C979} | R^{D50} | R^{D241} | L_{C1087} | R^{D145} | R^{D241} | L_{C1195} | R^{D168} | R^{D241} |
| L_{C872} | R^{D17} | R^{D242} | L_{C980} | R^{D50} | R^{D242} | L_{C1088} | R^{D145} | R^{D242} | L_{C1196} | R^{D168} | R^{D242} |
| L_{C873} | R^{D17} | R^{D243} | L_{C981} | R^{D50} | R^{D243} | L_{C1089} | R^{D145} | R^{D243} | L_{C1197} | R^{D168} | R^{D243} |
| L_{C874} | R^{D17} | R^{D244} | L_{C982} | R^{D50} | R^{D244} | L_{C1090} | R^{D145} | R^{D244} | L_{C1198} | R^{D168} | R^{D244} |
| L_{C875} | R^{D17} | R^{D245} | L_{C983} | R^{D50} | R^{D245} | L_{C1091} | R^{D145} | R^{D245} | L_{C1199} | R^{D168} | R^{D245} |
| L_{C876} | R^{D17} | R^{D246} | L_{C984} | R^{D50} | R^{D246} | L_{C1092} | R^{D145} | R^{D246} | L_{C1200} | R^{D168} | R^{D246} |
| L_{C1201} | R^{D10} | R^{D193} | L_{C1255} | R^{D55} | R^{D193} | L_{C1309} | R^{D37} | R^{D193} | L_{C1363} | R^{D143} | R^{D193} |
| L_{C1202} | R^{D10} | R^{D194} | L_{C1256} | R^{D55} | R^{D194} | L_{C1310} | R^{D37} | R^{D194} | L_{C1364} | R^{D143} | R^{D194} |
| L_{C1203} | R^{D10} | R^{D195} | L_{C1257} | R^{D55} | R^{D195} | L_{C1311} | R^{D37} | R^{D195} | L_{C1365} | R^{D143} | R^{D195} |
| L_{C1204} | R^{D10} | R^{D196} | L_{C1258} | R^{D55} | R^{D196} | L_{C1312} | R^{D37} | R^{D196} | L_{C1366} | R^{D143} | R^{D196} |
| L_{C1205} | R^{D10} | R^{D197} | L_{C1259} | R^{D55} | R^{D197} | L_{C1313} | R^{D37} | R^{D197} | L_{C1367} | R^{D143} | R^{D197} |
| L_{C1206} | R^{D10} | R^{D198} | L_{C1260} | R^{D55} | R^{D198} | L_{C1314} | R^{D37} | R^{D198} | L_{C1368} | R^{D143} | R^{D198} |
| L_{C1207} | R^{D10} | R^{D199} | L_{C1261} | R^{D55} | R^{D199} | L_{C1315} | R^{D37} | R^{D199} | L_{C1369} | R^{D143} | R^{D199} |
| L_{C1208} | R^{D10} | R^{D200} | L_{C1262} | R^{D55} | R^{D200} | L_{C1316} | R^{D37} | R^{D200} | L_{C1370} | R^{D143} | R^{D200} |
| L_{C1209} | R^{D10} | R^{D201} | L_{C1263} | R^{D55} | R^{D201} | L_{C1317} | R^{D37} | R^{D201} | L_{C1371} | R^{D143} | R^{D201} |
| L_{C1210} | R^{D10} | R^{D202} | L_{C1264} | R^{D55} | R^{D202} | L_{C1318} | R^{D37} | R^{D202} | L_{C1372} | R^{D143} | R^{D202} |
| L_{C1211} | R^{D10} | R^{D203} | L_{C1265} | R^{D55} | R^{D203} | L_{C1319} | R^{D37} | R^{D203} | L_{C1373} | R^{D143} | R^{D203} |
| L_{C1212} | R^{D10} | R^{D204} | L_{C1266} | R^{D55} | R^{D204} | L_{C1320} | R^{D37} | R^{D204} | L_{C1374} | R^{D143} | R^{D204} |
| L_{C1213} | R^{D10} | R^{D205} | L_{C1267} | R^{D55} | R^{D205} | L_{C1321} | R^{D37} | R^{D205} | L_{C1375} | R^{D143} | R^{D205} |
| L_{C1214} | R^{D10} | R^{D206} | L_{C1268} | R^{D55} | R^{D206} | L_{C1322} | R^{D37} | R^{D206} | L_{C1376} | R^{D143} | R^{D206} |
| L_{C1215} | R^{D10} | R^{D207} | L_{C1269} | R^{D55} | R^{D207} | L_{C1323} | R^{D37} | R^{D207} | L_{C1377} | R^{D143} | R^{D207} |
| L_{C1216} | R^{D10} | R^{D208} | L_{C1270} | R^{D55} | R^{D208} | L_{C1324} | R^{D37} | R^{D208} | L_{C1378} | R^{D143} | R^{D208} |
| L_{C1217} | R^{D10} | R^{D209} | L_{C1271} | R^{D55} | R^{D209} | L_{C1325} | R^{D37} | R^{D209} | L_{C1379} | R^{D143} | R^{D209} |
| L_{C1218} | R^{D10} | R^{D210} | L_{C1272} | R^{D55} | R^{D210} | L_{C1326} | R^{D37} | R^{D210} | L_{C1380} | R^{D143} | R^{D210} |
| L_{C1219} | R^{D10} | R^{D211} | L_{C1273} | R^{D55} | R^{D211} | L_{C1327} | R^{D37} | R^{D211} | L_{C1381} | R^{D143} | R^{D211} |
| L_{C1220} | R^{D10} | R^{D212} | L_{C1274} | R^{D55} | R^{D212} | L_{C1328} | R^{D37} | R^{D212} | L_{C1382} | R^{D143} | R^{D212} |
| L_{C1221} | R^{D10} | R^{D213} | L_{C1275} | R^{D55} | R^{D213} | L_{C1329} | R^{D37} | R^{D213} | L_{C1383} | R^{D143} | R^{D213} |
| L_{C1222} | R^{D10} | R^{D214} | L_{C1276} | R^{D55} | R^{D214} | L_{C1330} | R^{D37} | R^{D214} | L_{C1384} | R^{D143} | R^{D214} |
| L_{C1223} | R^{D10} | R^{D215} | L_{C1277} | R^{D55} | R^{D215} | L_{C1331} | R^{D37} | R^{D215} | L_{C1385} | R^{D143} | R^{D215} |
| L_{C1224} | R^{D10} | R^{D216} | L_{C1278} | R^{D55} | R^{D216} | L_{C1332} | R^{D37} | R^{D216} | L_{C1386} | R^{D143} | R^{D216} |
| L_{C1225} | R^{D10} | R^{D217} | L_{C1279} | R^{D55} | R^{D217} | L_{C1333} | R^{D37} | R^{D217} | L_{C1387} | R^{D143} | R^{D217} |
| L_{C1226} | R^{D10} | R^{D218} | L_{C1280} | R^{D55} | R^{D218} | L_{C1334} | R^{D37} | R^{D218} | L_{C1388} | R^{D143} | R^{D218} |
| L_{C1227} | R^{D10} | R^{D219} | L_{C1281} | R^{D55} | R^{D219} | L_{C1335} | R^{D37} | R^{D219} | L_{C1389} | R^{D143} | R^{D219} |
| L_{C1228} | R^{D10} | R^{D220} | L_{C1282} | R^{D55} | R^{D220} | L_{C1336} | R^{D37} | R^{D220} | L_{C1390} | R^{D143} | R^{D220} |
| L_{C1229} | R^{D10} | R^{D221} | L_{C1283} | R^{D55} | R^{D221} | L_{C1337} | R^{D37} | R^{D221} | L_{C1391} | R^{D143} | R^{D221} |
| L_{C1230} | R^{D10} | R^{D222} | L_{C1284} | R^{D55} | R^{D222} | L_{C1338} | R^{D37} | R^{D222} | L_{C1392} | R^{D143} | R^{D222} |
| L_{C1231} | R^{D10} | R^{D223} | L_{C1285} | R^{D55} | R^{D223} | L_{C1339} | R^{D37} | R^{D223} | L_{C1393} | R^{D143} | R^{D223} |
| L_{C1232} | R^{D10} | R^{D224} | L_{C1286} | R^{D55} | R^{D224} | L_{C1340} | R^{D37} | R^{D224} | L_{C1394} | R^{D143} | R^{D224} |
| L_{C1233} | R^{D10} | R^{D225} | L_{C1287} | R^{D55} | R^{D225} | L_{C1341} | R^{D37} | R^{D225} | L_{C1395} | R^{D143} | R^{D225} |
| L_{C1234} | R^{D10} | R^{D226} | L_{C1288} | R^{D55} | R^{D226} | L_{C1342} | R^{D37} | R^{D226} | L_{C1396} | R^{D143} | R^{D226} |
| L_{C1235} | R^{D10} | R^{D227} | L_{C1289} | R^{D55} | R^{D227} | L_{C1343} | R^{D37} | R^{D227} | L_{C1397} | R^{D143} | R^{D227} |
| L_{C1236} | R^{D10} | R^{D228} | L_{C1290} | R^{D55} | R^{D228} | L_{C1344} | R^{D37} | R^{D228} | L_{C1398} | R^{D143} | R^{D228} |
| L_{C1237} | R^{D10} | R^{D229} | L_{C1291} | R^{D55} | R^{D229} | L_{C1345} | R^{D37} | R^{D229} | L_{C1399} | R^{D143} | R^{D229} |
| L_{C1238} | R^{D10} | R^{D230} | L_{C1292} | R^{D55} | R^{D230} | L_{C1346} | R^{D37} | R^{D230} | L_{C1400} | R^{D143} | R^{D230} |
| L_{C1239} | R^{D10} | R^{D231} | L_{C1293} | R^{D55} | R^{D231} | L_{C1347} | R^{D37} | R^{D231} | L_{C1401} | R^{D143} | R^{D231} |
| L_{C1240} | R^{D10} | R^{D232} | L_{C1294} | R^{D55} | R^{D232} | L_{C1348} | R^{D37} | R^{D232} | L_{C1402} | R^{D143} | R^{D232} |
| L_{C1241} | R^{D10} | R^{D233} | L_{C1295} | R^{D55} | R^{D233} | L_{C1349} | R^{D37} | R^{D233} | L_{C1403} | R^{D143} | R^{D233} |
| L_{C1242} | R^{D10} | R^{D234} | L_{C1296} | R^{D55} | R^{D234} | L_{C1350} | R^{D37} | R^{D234} | L_{C1404} | R^{D143} | R^{D234} |
| L_{C1243} | R^{D10} | R^{D235} | L_{C1297} | R^{D55} | R^{D235} | L_{C1351} | R^{D37} | R^{D235} | L_{C1405} | R^{D143} | R^{D235} |
| L_{C1244} | R^{D10} | R^{D236} | L_{C1298} | R^{D55} | R^{D236} | L_{C1352} | R^{D37} | R^{D236} | L_{C1406} | R^{D143} | R^{D236} |
| L_{C1245} | R^{D10} | R^{D237} | L_{C1299} | R^{D55} | R^{D237} | L_{C1353} | R^{D37} | R^{D237} | L_{C1407} | R^{D143} | R^{D237} |
| L_{C1246} | R^{D10} | R^{D238} | L_{C1300} | R^{D55} | R^{D238} | L_{C1354} | R^{D37} | R^{D238} | L_{C1408} | R^{D143} | R^{D238} |
| L_{C1247} | R^{D10} | R^{D239} | L_{C1301} | R^{D55} | R^{D239} | L_{C1355} | R^{D37} | R^{D239} | L_{C1409} | R^{D143} | R^{D239} |
| L_{C1248} | R^{D10} | R^{D240} | L_{C1302} | R^{D55} | R^{D240} | L_{C1356} | R^{D37} | R^{D240} | L_{C1410} | R^{D143} | R^{D240} |
| L_{C1249} | R^{D10} | R^{D241} | L_{C1303} | R^{D55} | R^{D241} | L_{C1357} | R^{D37} | R^{D241} | L_{C1411} | R^{D143} | R^{D241} |
| L_{C1250} | R^{D10} | R^{D242} | L_{C1304} | R^{D55} | R^{D242} | L_{C1358} | R^{D37} | R^{D242} | L_{C1412} | R^{D143} | R^{D242} |
| L_{C1251} | R^{D10} | R^{D243} | L_{C1305} | R^{D55} | R^{D243} | L_{C1359} | R^{D37} | R^{D243} | L_{C1413} | R^{D143} | R^{D243} |
| L_{C1252} | R^{D10} | R^{D244} | L_{C1306} | R^{D55} | R^{D244} | L_{C1360} | R^{D37} | R^{D244} | L_{C1414} | R^{D143} | R^{D244} |
| L_{C1253} | R^{D10} | R^{D245} | L_{C1307} | R^{D55} | R^{D245} | L_{C1361} | R^{D37} | R^{D245} | L_{C1415} | R^{D143} | R^{D245} |
| L_{C1254} | R^{D10} | R^{D246} | L_{C1308} | R^{D55} | R^{D246} | L_{C1362} | R^{D37} | R^{D246} | L_{C1416} | R^{D143} | R^{D246} |

wherein R^{D1} to R^{D246} have the structures defined in the following LIST 11: 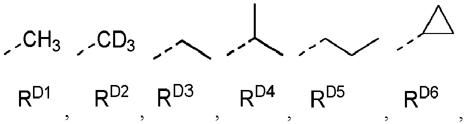 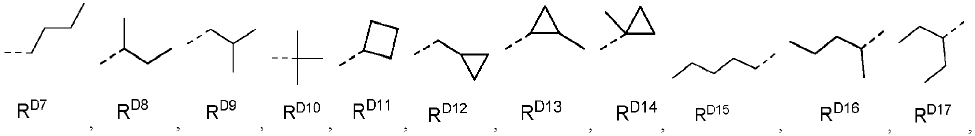 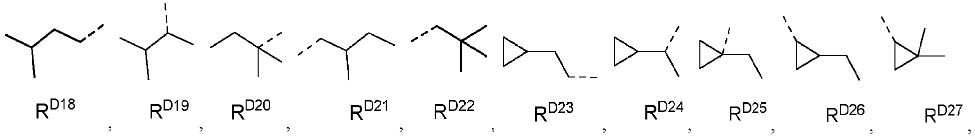 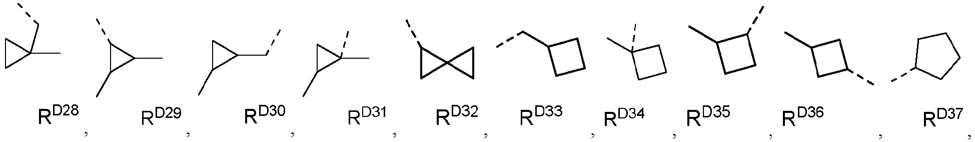 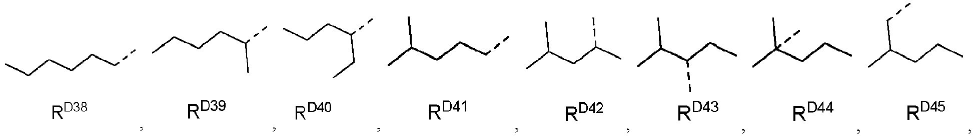 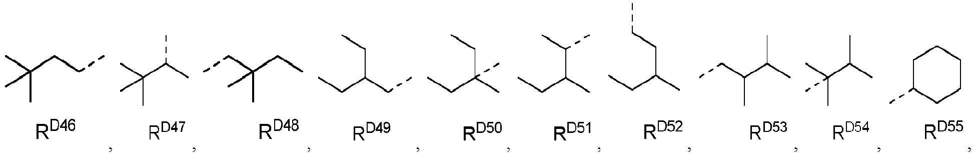 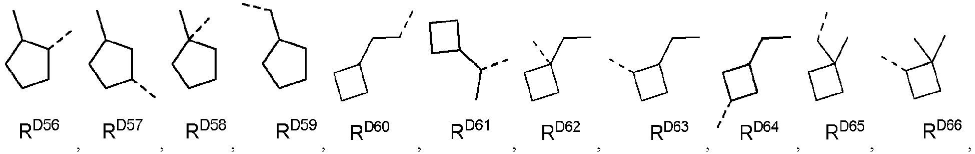 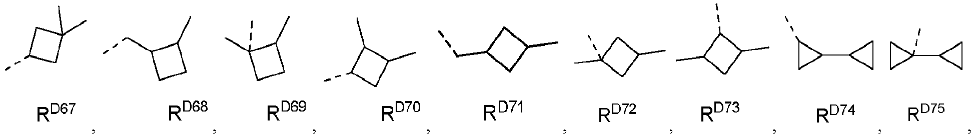 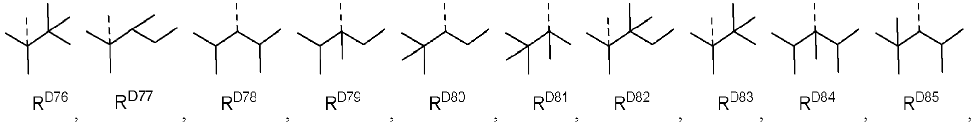 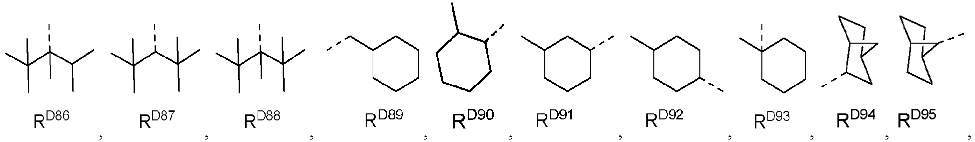 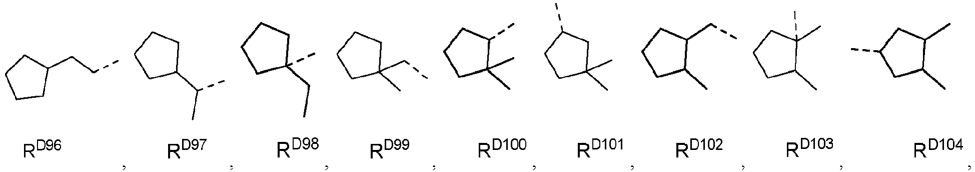 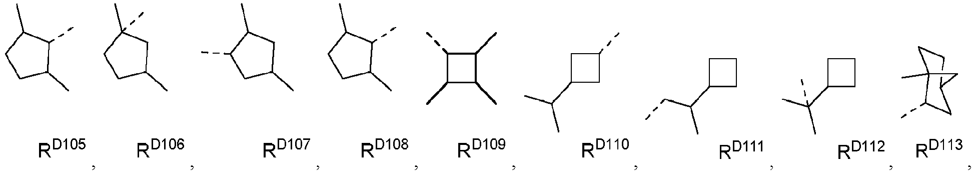 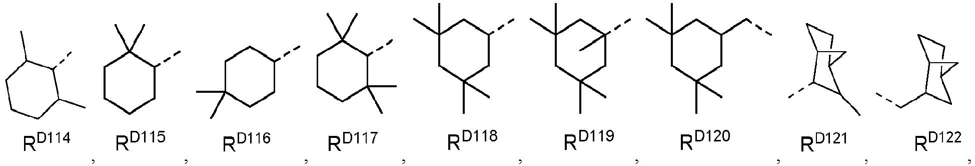 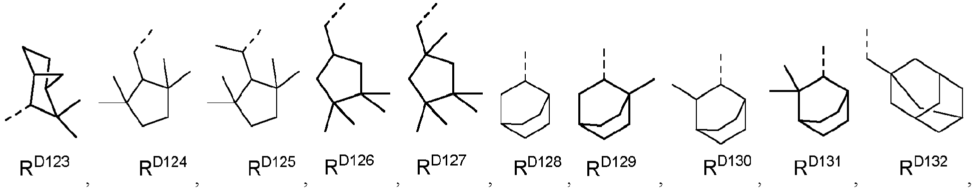 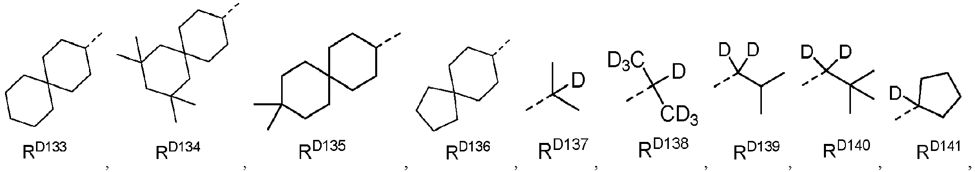 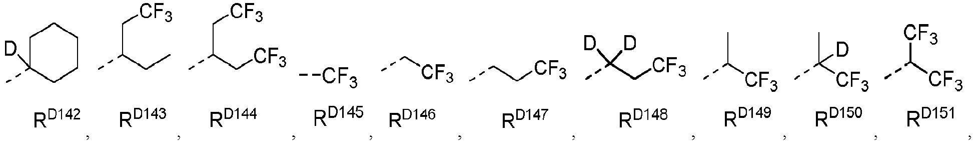 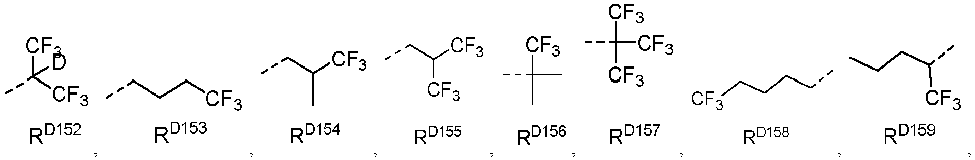 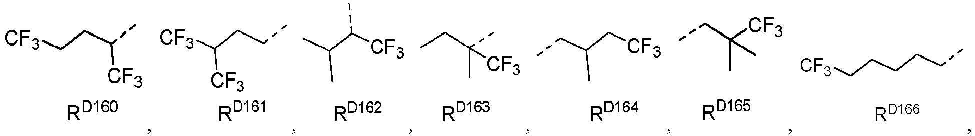 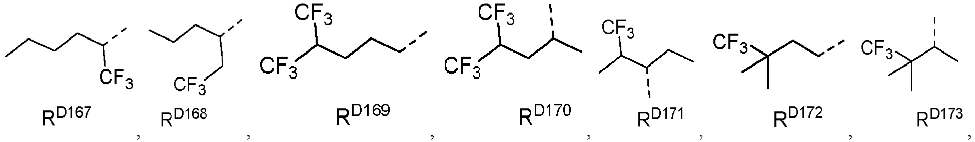 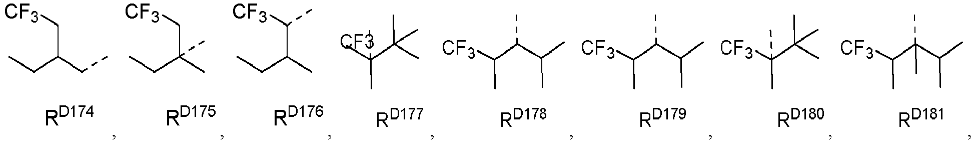 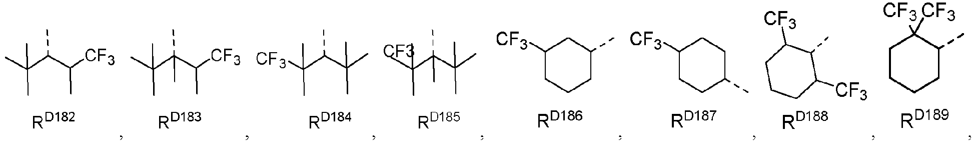 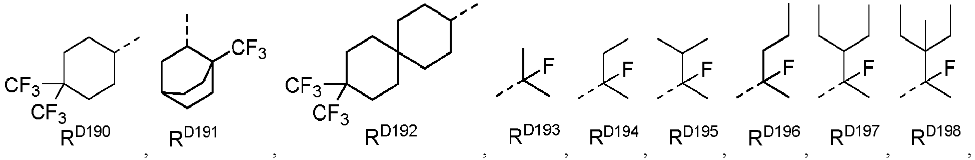 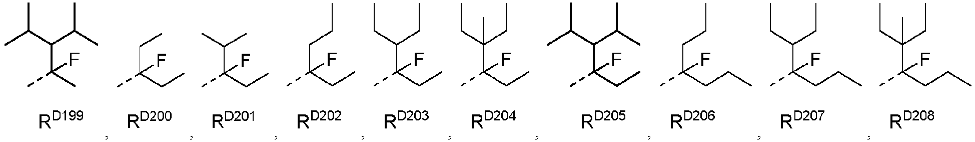 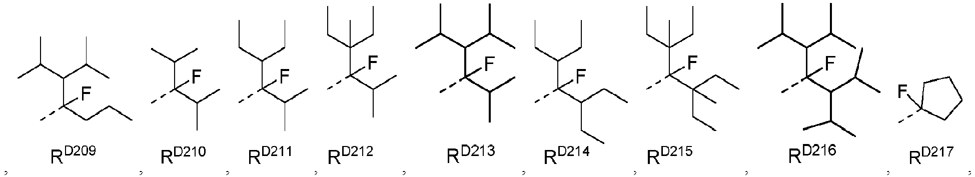 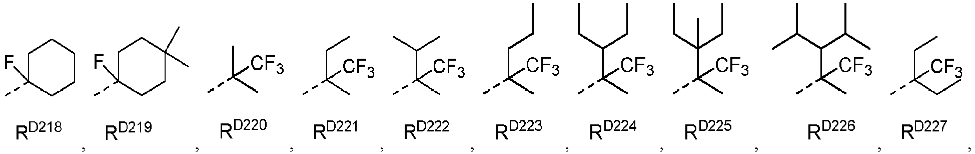 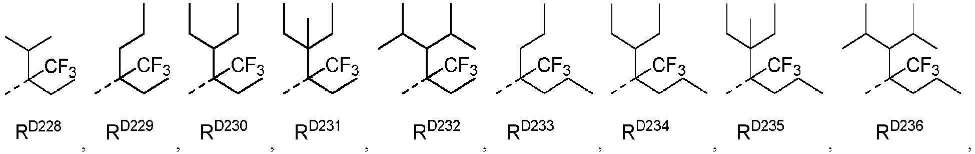 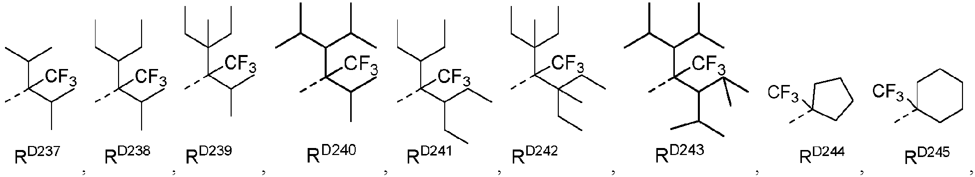 and

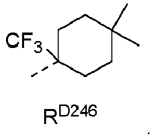

In some embodiments, the compound is selected from the group consisting of only those compounds having L_{C*j*-I} or L_{C*j*-II} ligand whose corresponding R²⁰¹ and R²⁰² are defined to be one of the following structures: R^{D1}, R^{D3}, R^{D4}, R^{D5}, R^{D9}, R^{D10}, R^{D17}, R^{D18}, R^{D20}, R^{D22}, R^{D37}, R^{D40},

R^{D41}, R^{D42} R^{D43}, R^{D48}, R^{D49} R^{D50} R^{D54}, R^{D55}, R^{D58} R^{D59} R^{D78}, R^{D79}, R^{D81} R^{D87}, R^{D88}, R^{D89} R^{D93}, R^{D116}, R^{D117}, R^{D118}, R^{D119}, R^{D120}, R^{D133}, R^{D134}, R^{D135}, R^{D136}, R^{D143}, R^{D144}, R^{D145}, R^{D146}, R^{D147}, R^{D149}, R^{D151}, R^{D154}, R^{D155}, R^{D161}, R^{D175}, R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having L_{C*j*-I} or L_{C*j*-II} ligand whose corresponding R²⁰¹ and R²⁰² are defined to be one of selected from the following structures: R^{D1}, R^{D3}, R^{D4}, R^{D5}, R^{D9}, R^{D10}, R^{D17}, R^{D22}, R^{D43}, R^{D50}, R^{D78}, R^{D116}, R^{D118}, R^{D133}, R^{D134}, R^{D135}, R^{D136}, R^{D143}, R^{D144}, R^{D145}, R^{D146}, R^{D149}, R^{D151}, R^{D154}, R^{D155}, R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having one of the structures of the following LIST 12 for the L_{C*j*-I} ligand:

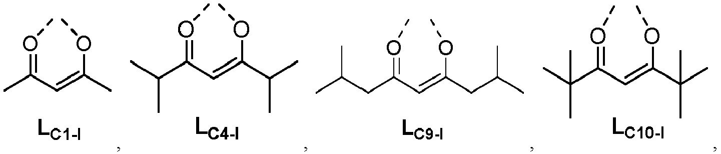

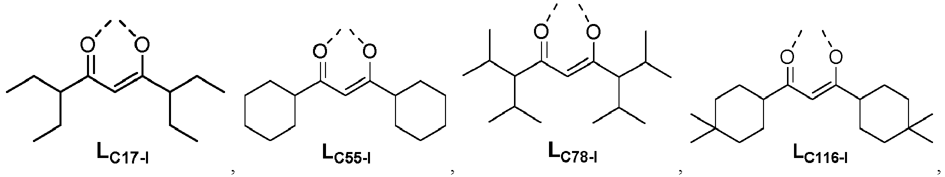

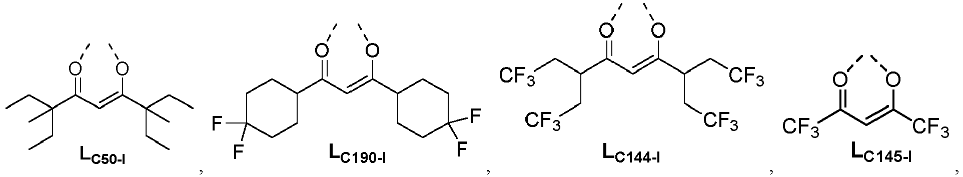

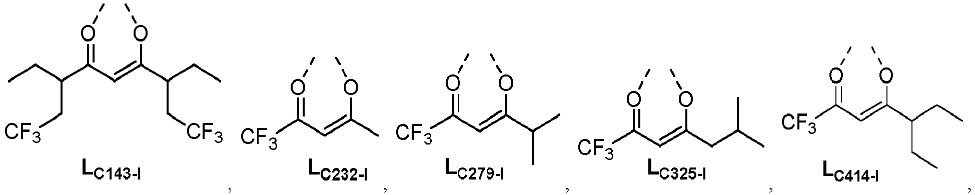

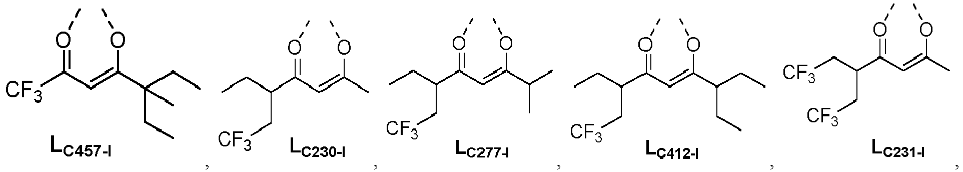

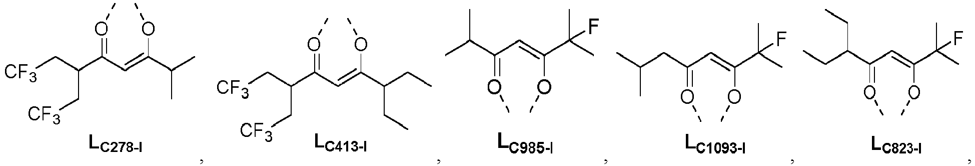

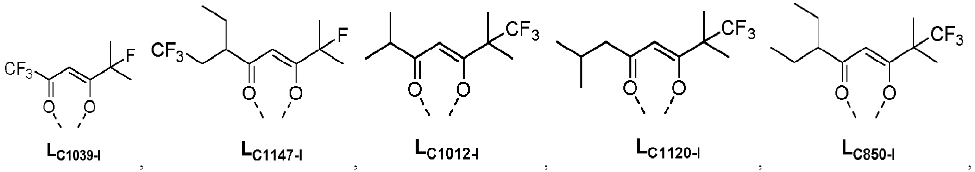

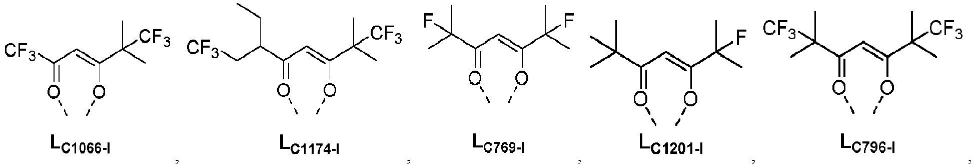

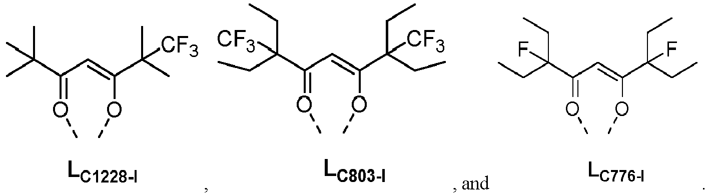

In some embodiments, L_{A} is selected from the group consisting of the structures of LIST 1, LIST 2, and LIST 3. In some embodiments, L_{B} is selected from the group consisting of the structures of LIST 5, LIST 6, and LIST 7. In some embodiments, L_{A} is selected from the group consisting of the structures of LIST 3 of L_{Ai}(R*m*)(R*n*)(R*o*)(R*p*) consisting of L_{A1}(R1)(R1)(R1)(R1) to L_{A114}(R115)(R115)(R115)(R115) defined herein and L_{B} is selected from the group consisting of LIST 7 of L_{Bw}(R*G*)(R*H*)(R*J*)(R*K*) consisting of L_{B1}(R1)(R1)(R1)(R1) to L_{B92}(R115)(R115)(R115)(R115) as defined herein.

In some embodiments, the compound can be Ir(L_{A})₂(L_{B}), Ir(L_{A})(L_{B})₂, or Ir(L_{A})(L_{B})(L_{C}). In some of these embodiments, L_{A} can have a Formula I as defined herein. In some of these embodiments, L_{B} can have a Formula IIA or Formula IIB as defined herein.

In another aspect, the present disclosure provides a compound comprising a structure selected from the group consisting of: 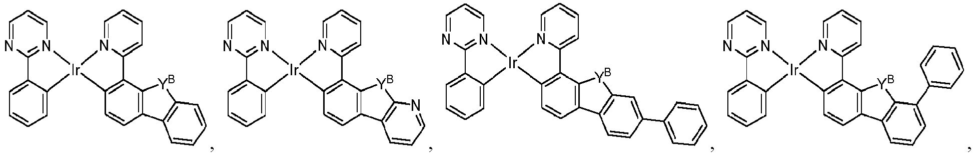 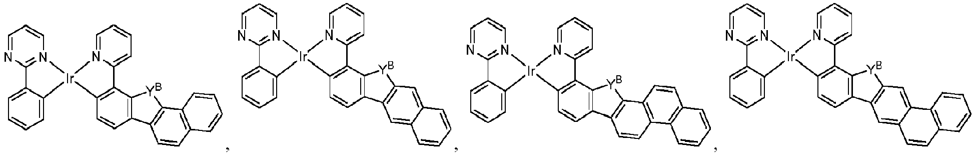 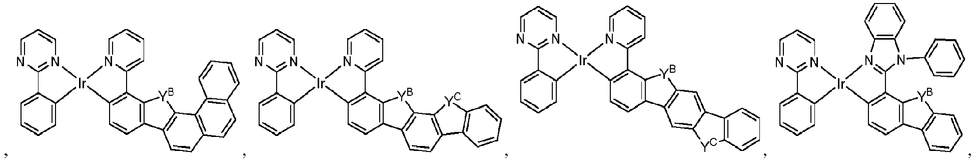 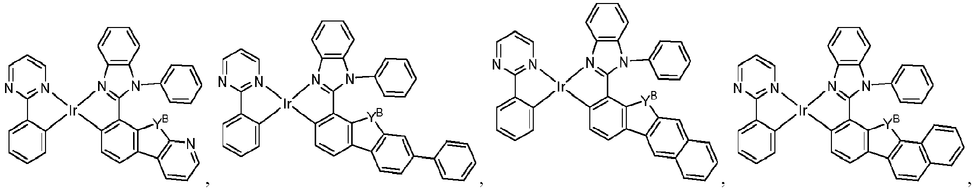 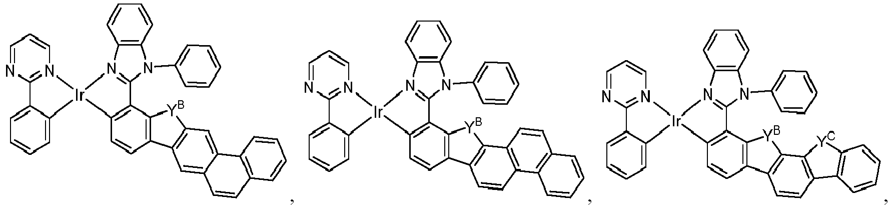 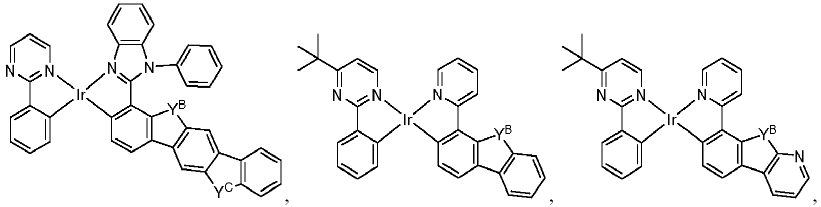 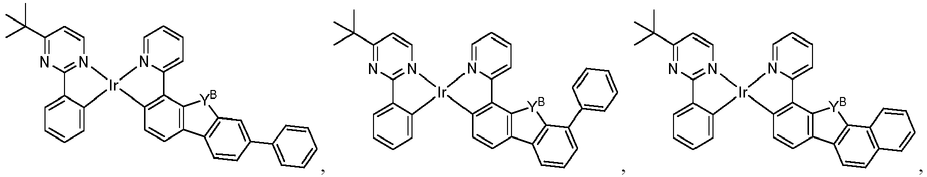 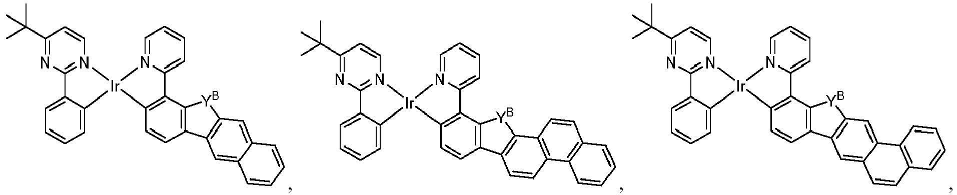 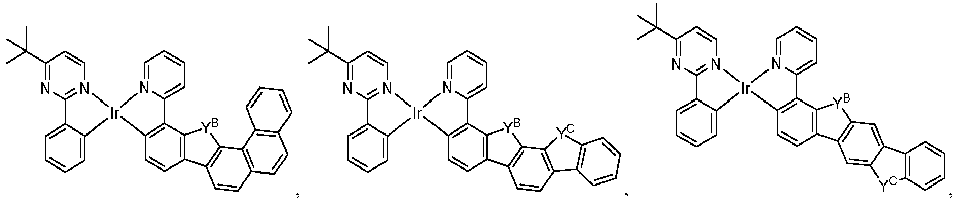 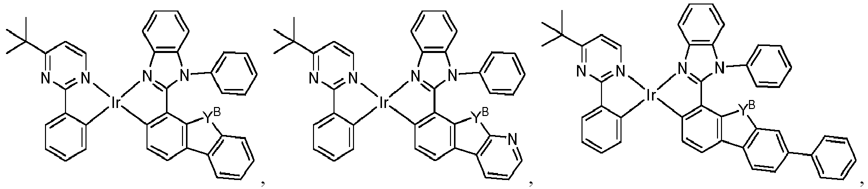 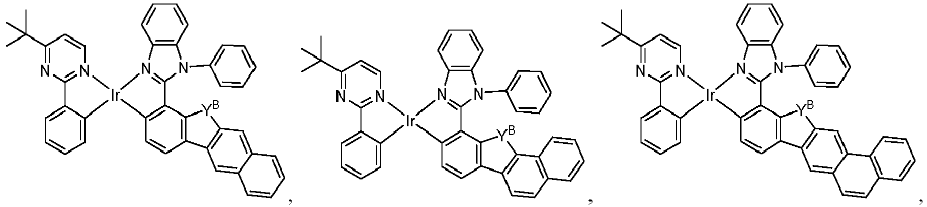 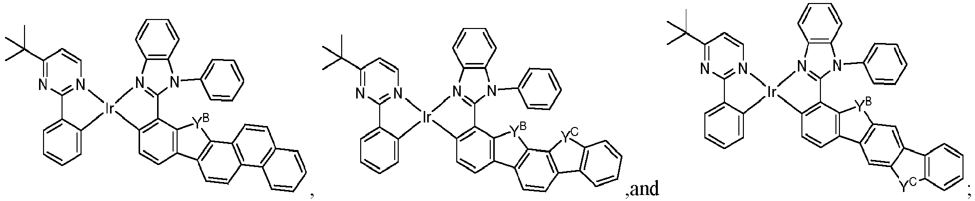 wherein each Y^{B} and Y^{C} is independently as defined previously. In some embodiments, each Y^{B} and Y^{C} is independently selected from the group consisting of O, S, Se, and C(CH₃)₂. In some embodiments, each Y^{B} and Y^{C} is independently selected from the group consisting of O, and C(CH₃)₂.

In some of these embodiments, the compound can be Ir(L_{Ai})₂(L_{B}), Ir(L_{Ai})(L_{B})₂, Ir(L_{A})₂(L_{Bk}(R*^{G}*)(R*^{H}*)(T)(E*^{A}*)), Ir(L_{A})( L_{Bk}(R*^{G}*)(R*^{H}*)(T)(E*^{A}*))₂, Ir(L_{Ai}(R*m*)(R*n*)(R*o*)(R*p*))₂(L_{Bw}(R*G*)(R*H*)(R*J*)(R*K*)) consisting of the compounds from Ir(L_{A1}(R1)(R1)(R1)(R1))₂(L_{B1}(R1)(R1)(R1)(R1)) to Ir(L_{A114}(R115)(R115)(R115)(R115))₂(L_{B92}(R115)(R115)(R115)(R115)), Ir(L_{Ai}(R*m*)(R*n*)(R*o*)(R*p*))(L_{Bw}(R*G*)(R*H*)(R*J*)(R*K*))₂ consisting of the compounds from Ir(L_{A1}(R1)(R1)(R1)(R1))(L_{B1}(R1)(R1)(R1)(R1))₂ to Ir(L_{A114}(R115)(R115)(R115)(R115)) (L_{B92}(R115)(R115)(R115)(R115))₂, Ir(L_{Ai}(R*m*)(R*n*)(R*o*)(R*p*))(L_{Bw}(R*G*)(R*H*)(R*J*)(R*K*)(L_{Cj-I}) consisting of the compounds of Ir(L_{A1}(R1)(R1)(R1)(R1))(L_{B1}(R1)(R1)(R1)(R1))(L_{C1-I}) to Ir(L_{A114}(R115)(R115)(R115)(R115))( L_{B92}(R115)(R115)(R115)(R115))(L_{C1416-I}), or Ir(L_{Ai}(R*m*)(R*n*)(R*o*)(R*p*))(L_{Bw}(R*G*)(R*H*)(R*J*)(R*K*))(L_{Cj-II}) consisting of the compounds of Ir(L_{A1}(R1)(R1)(R1)(R1))(L_{B1}(R1)(R1)(R1)(R1))(L_{C1-II}) to Ir(L_{A114}(R115)(R115)(R115)(R115))(L_{B92}(R115)(R115)(R115)(R115))(L_{C1416-II}). In some embodiments, the compound is selected from the group consisting of the structures of the following LIST 13:

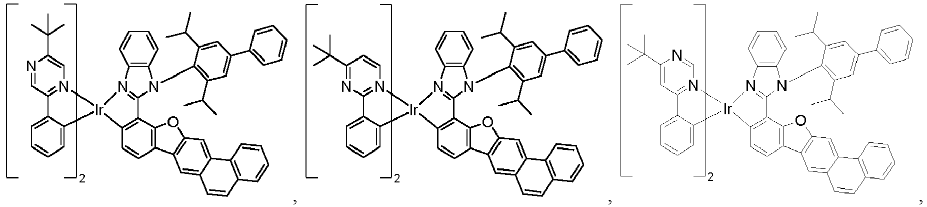

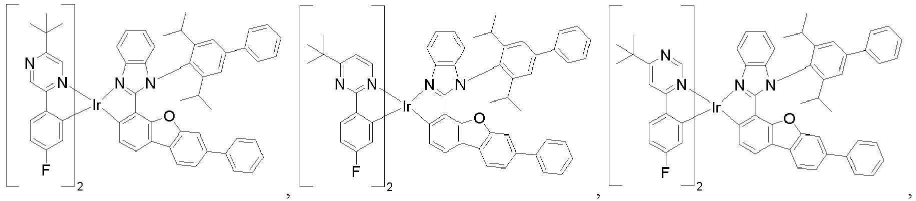

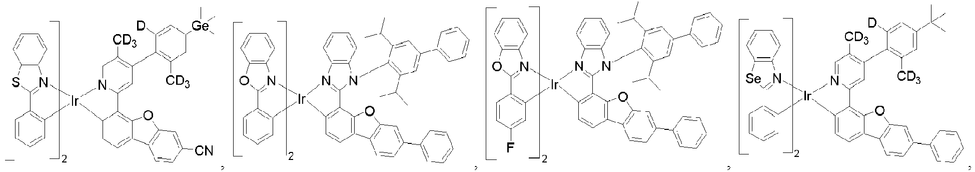

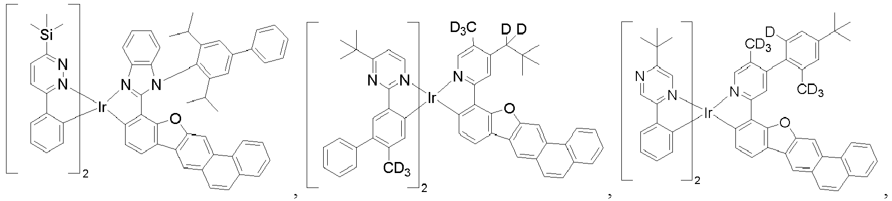

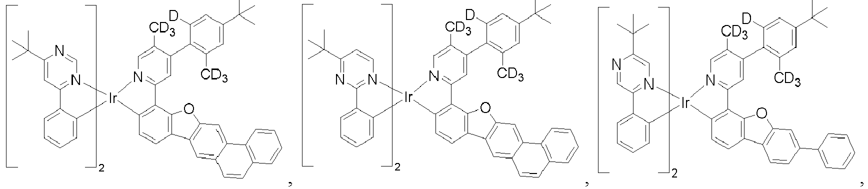

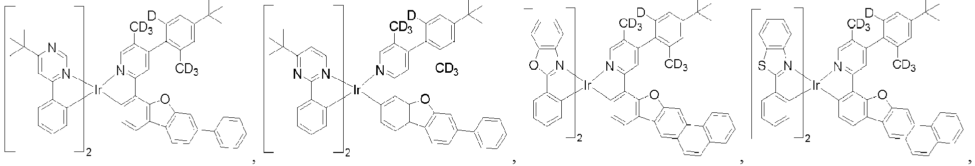

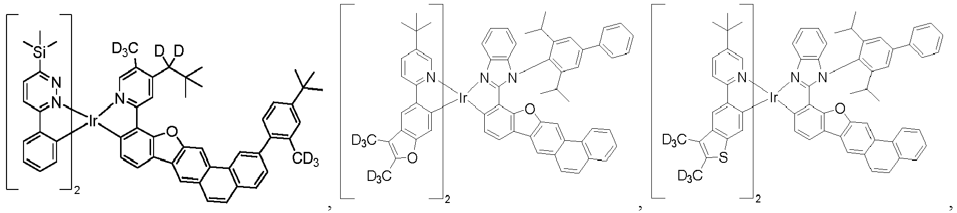

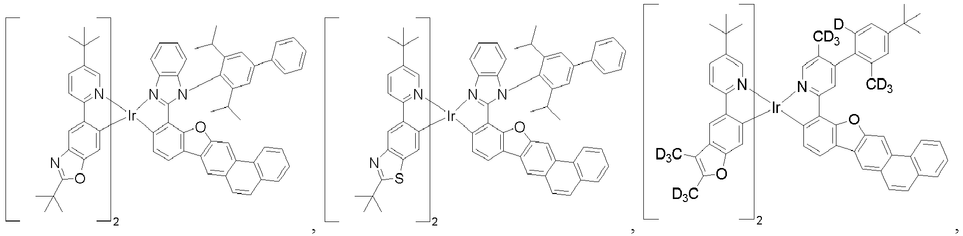

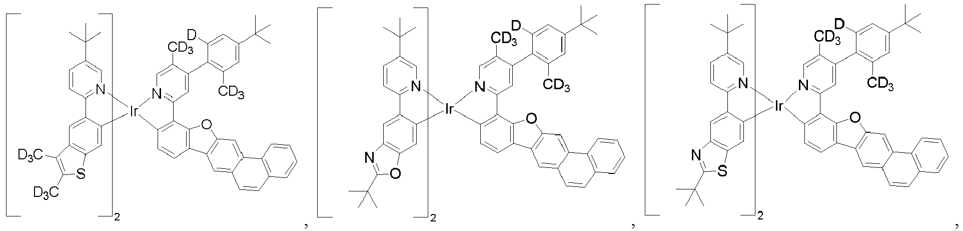

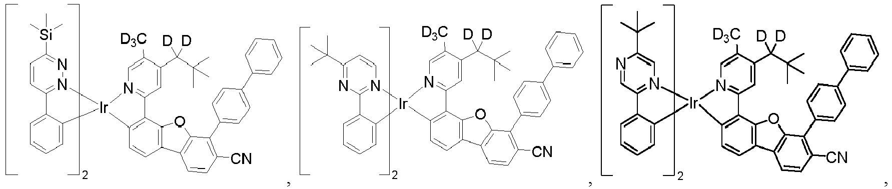

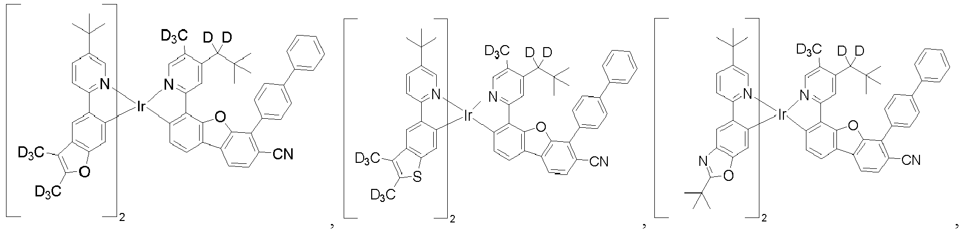

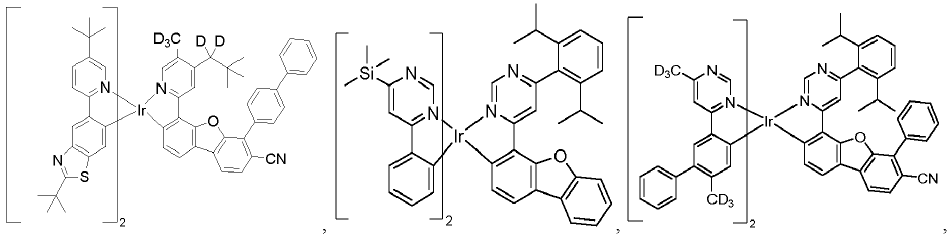

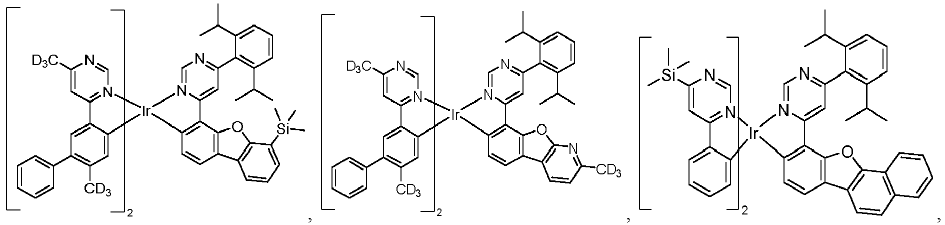

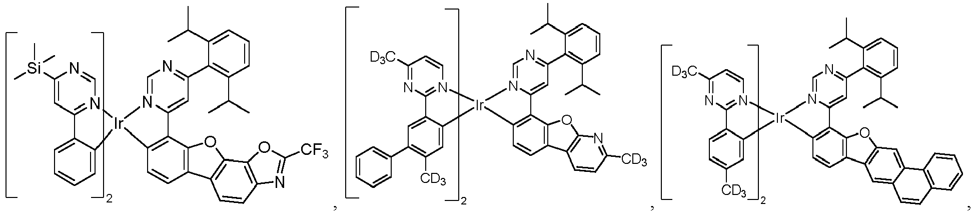

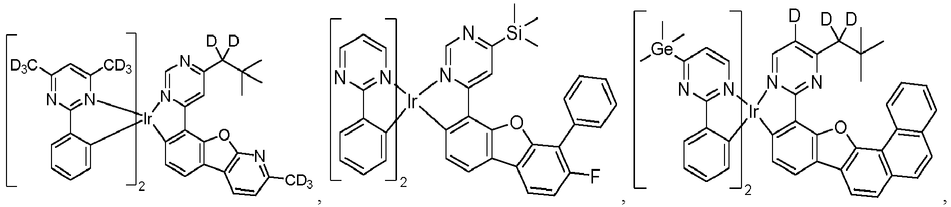

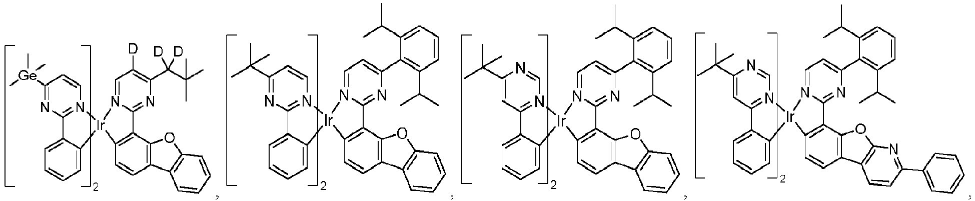

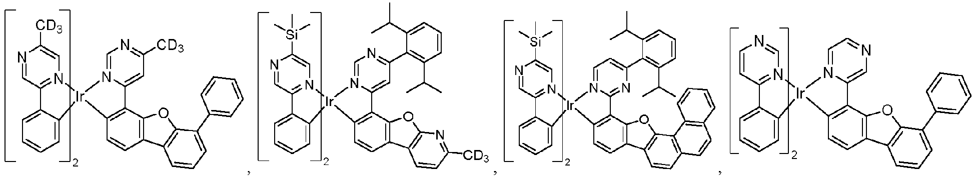

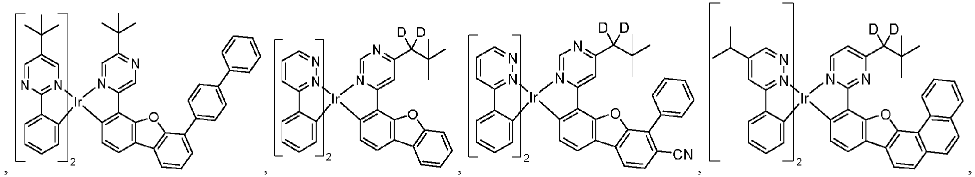

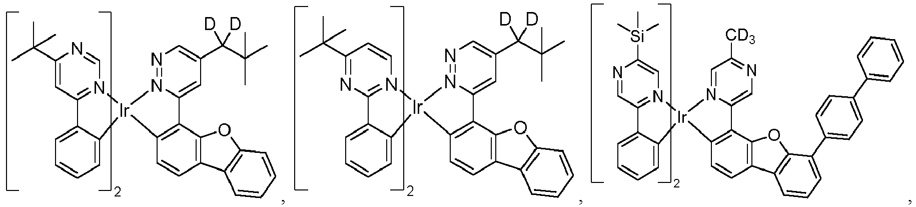

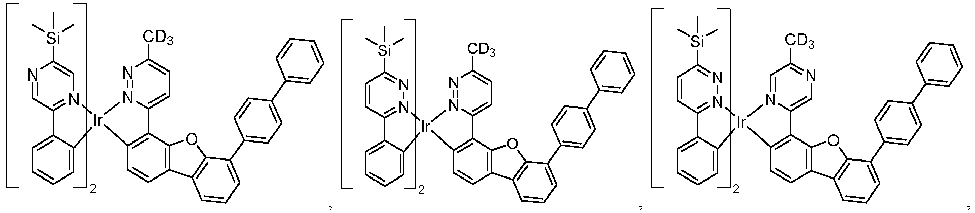

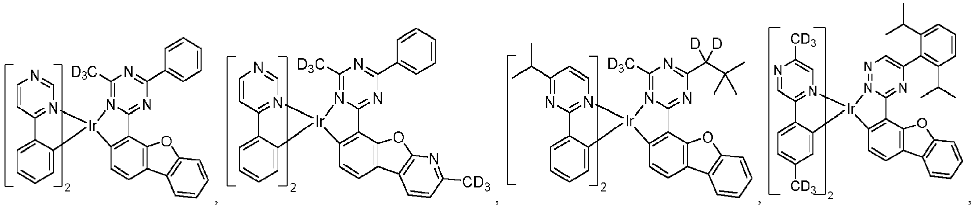

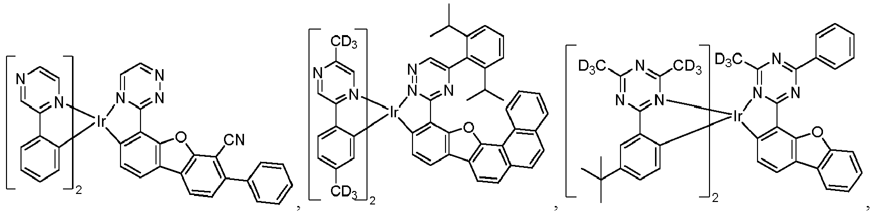

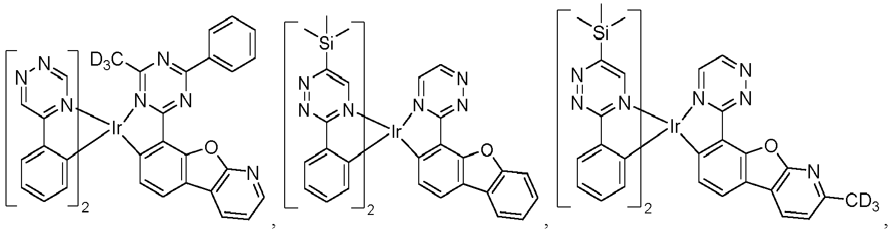

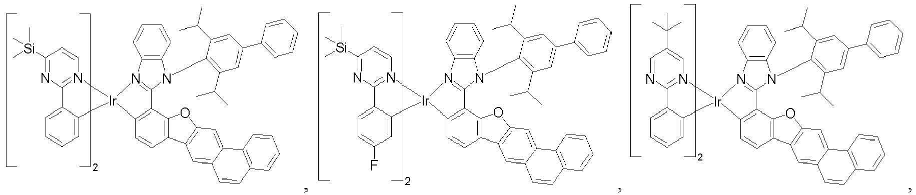

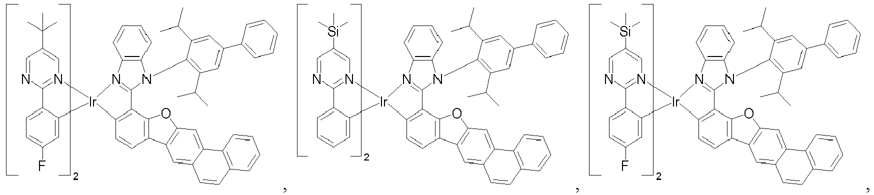

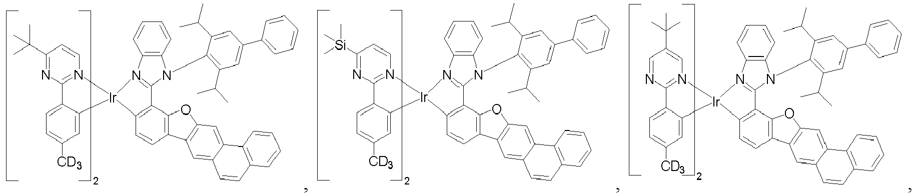

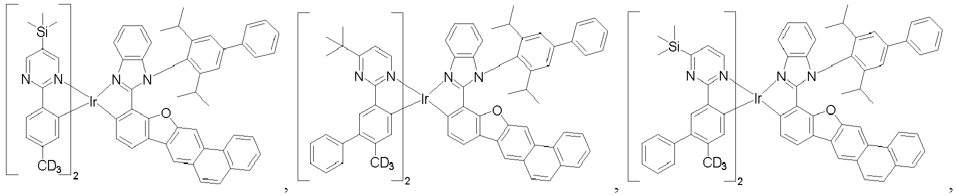

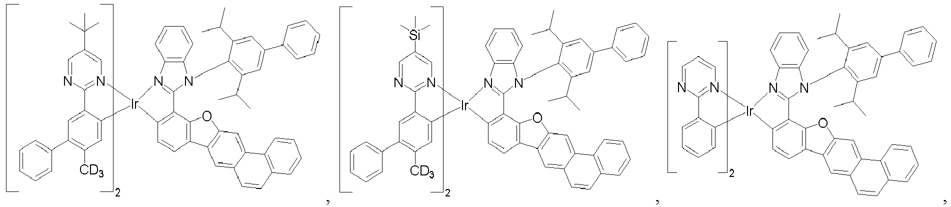

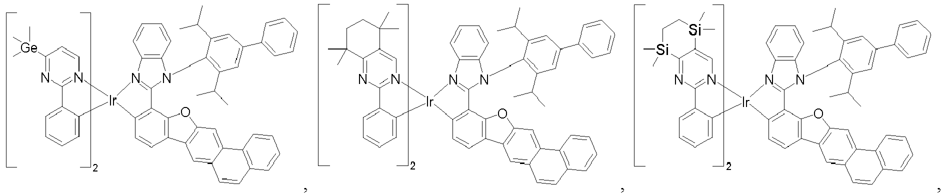

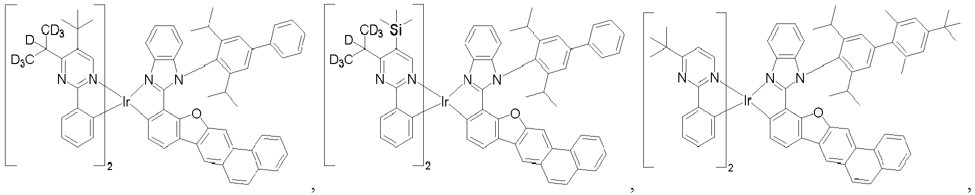

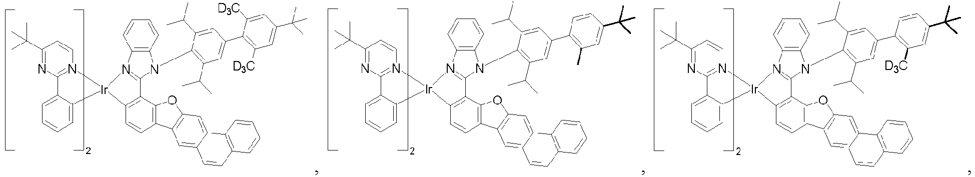

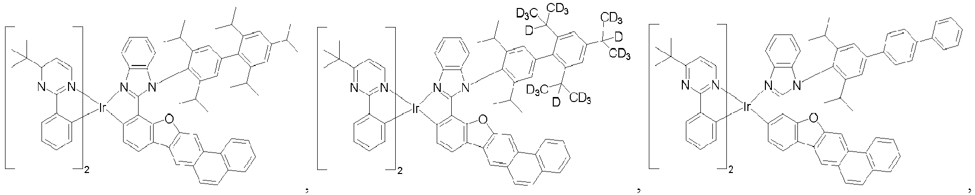

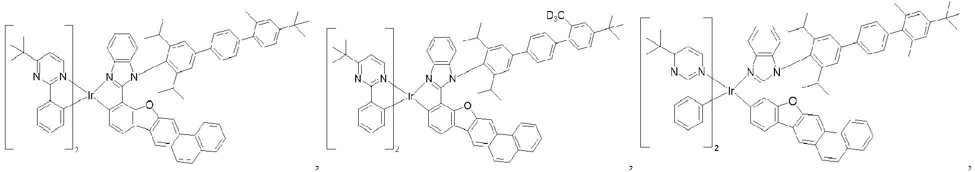

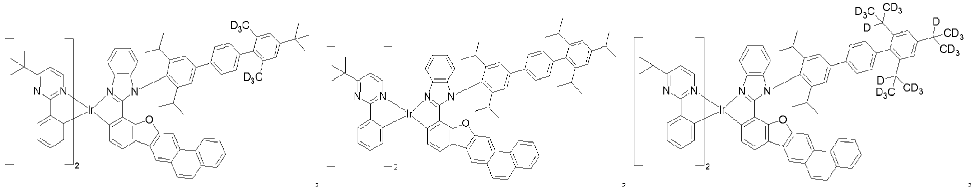

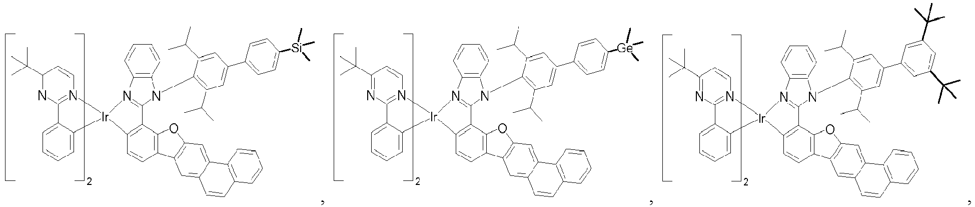

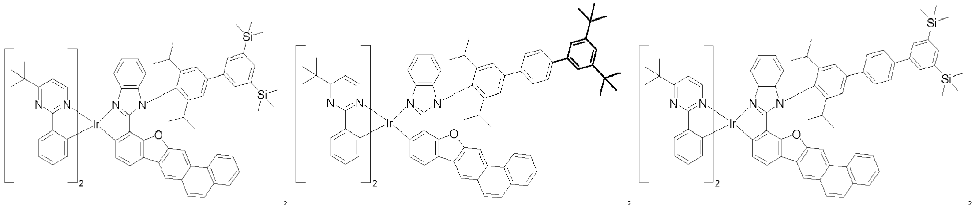

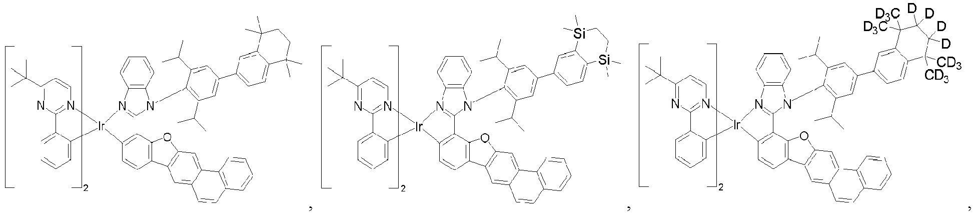

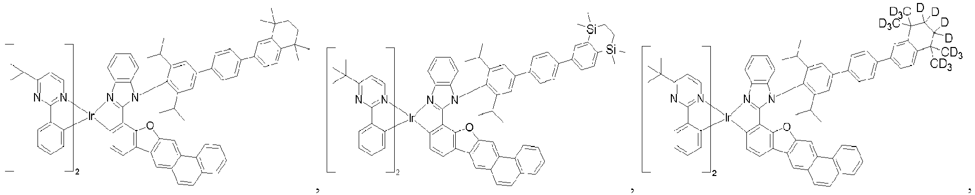

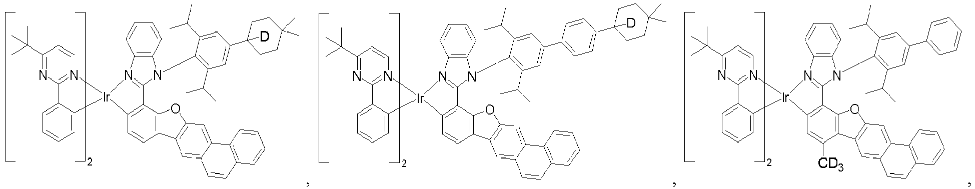

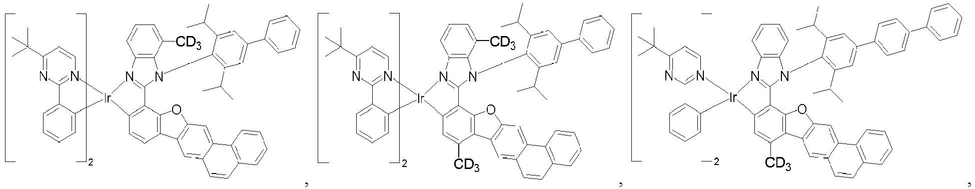

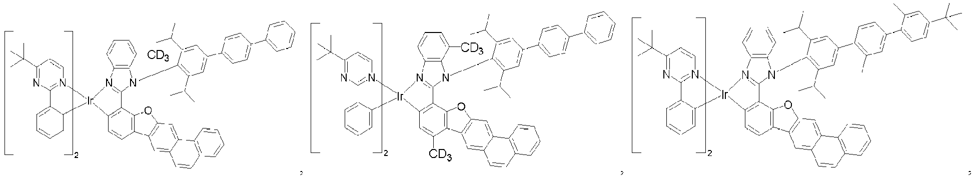

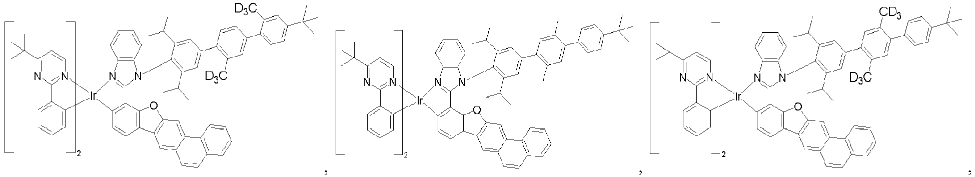

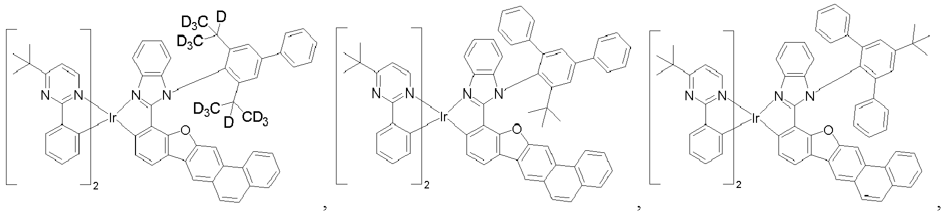

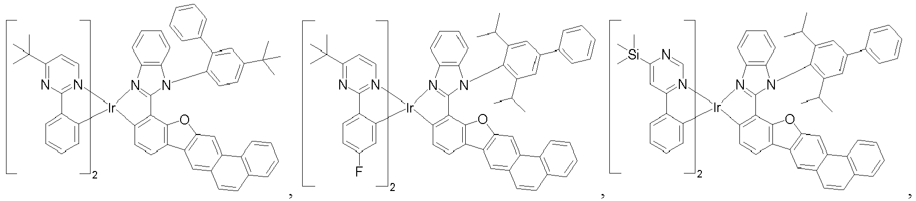

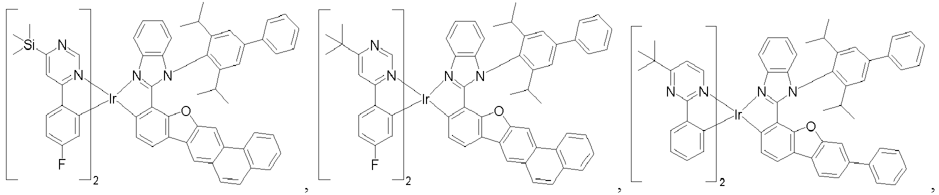

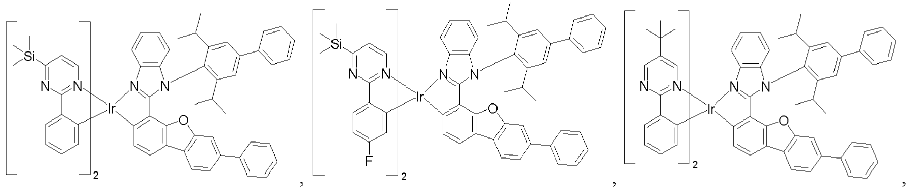

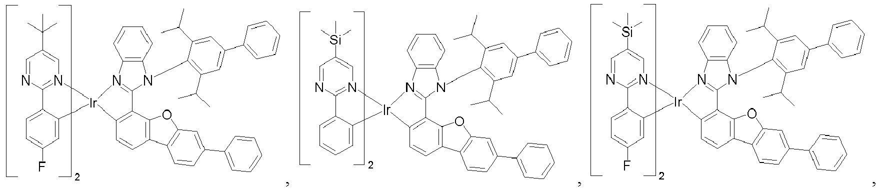

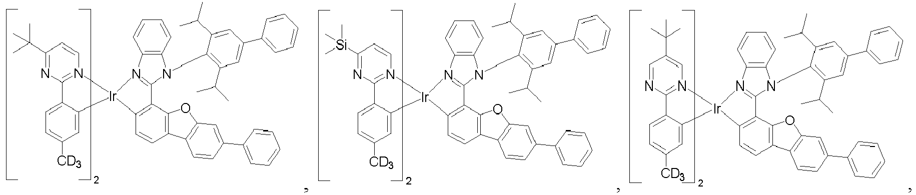

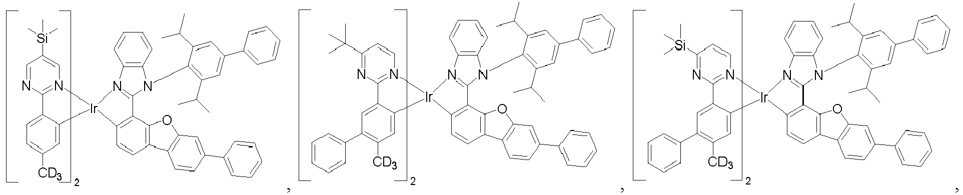

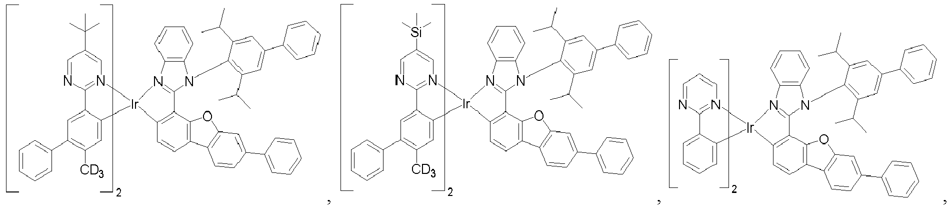

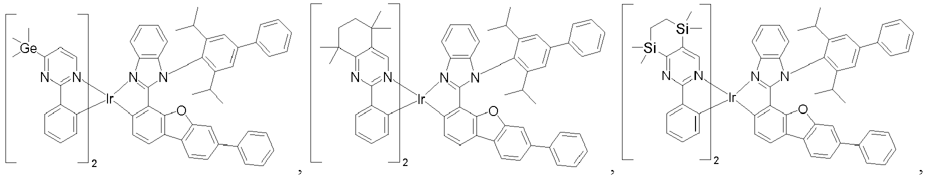

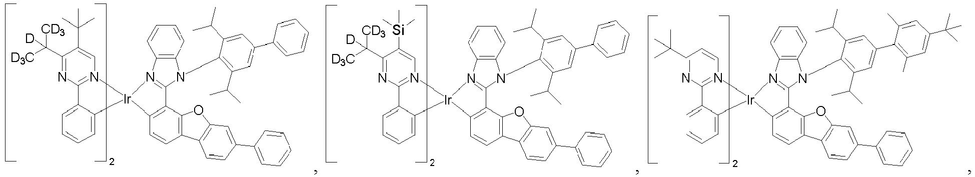

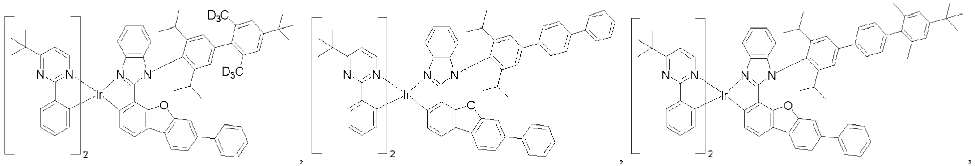

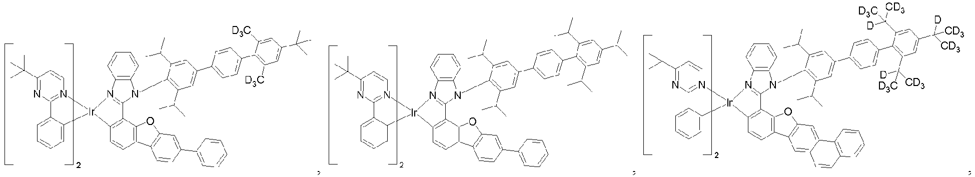

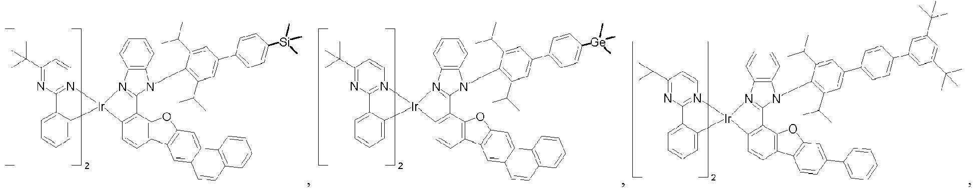

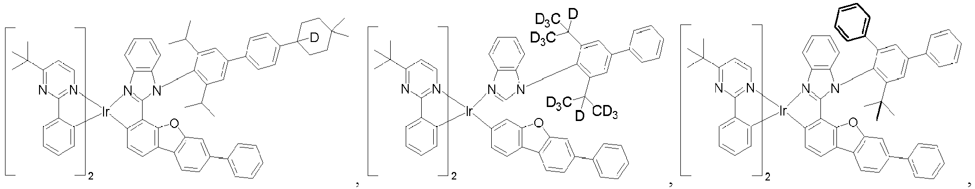

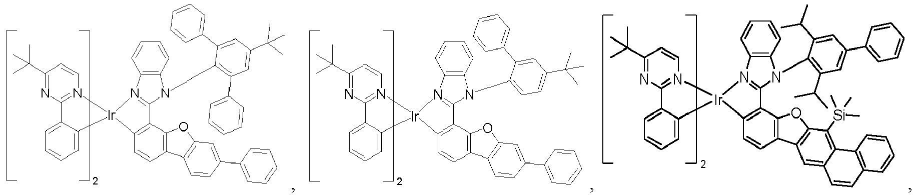

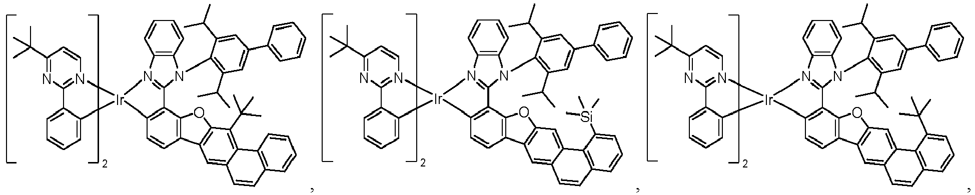

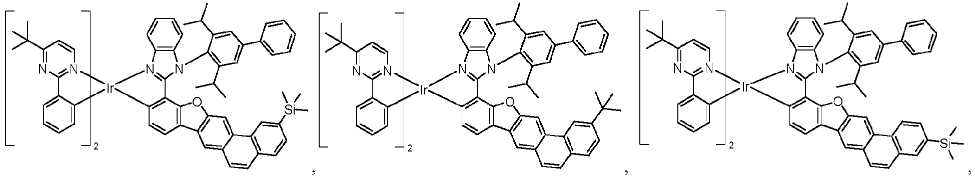

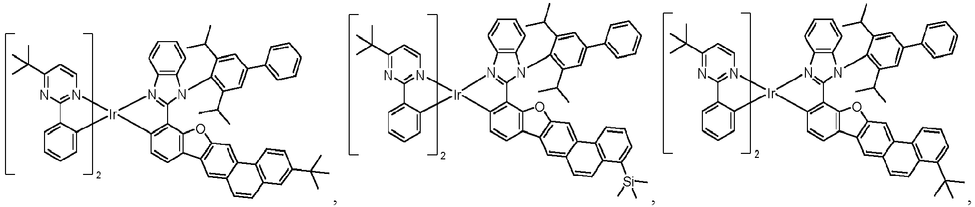

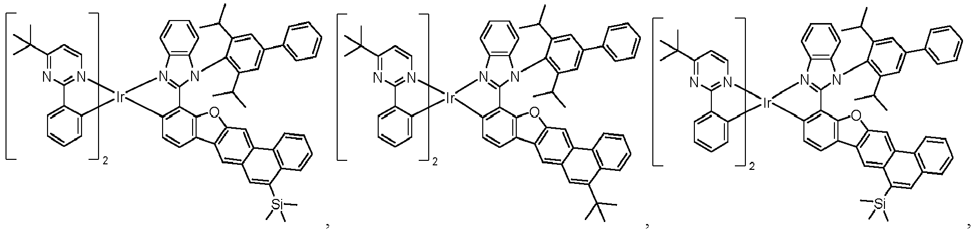

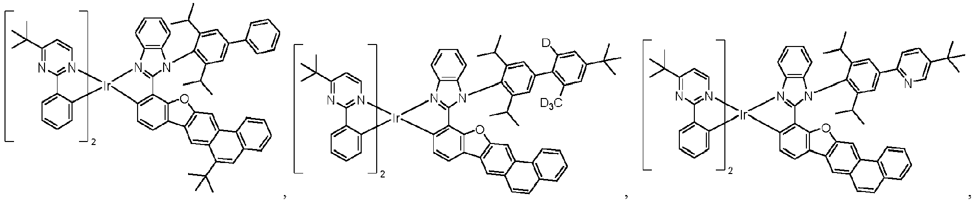

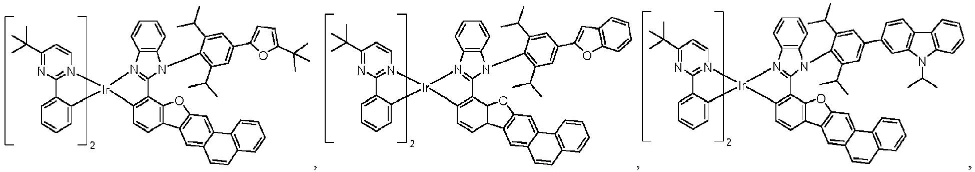

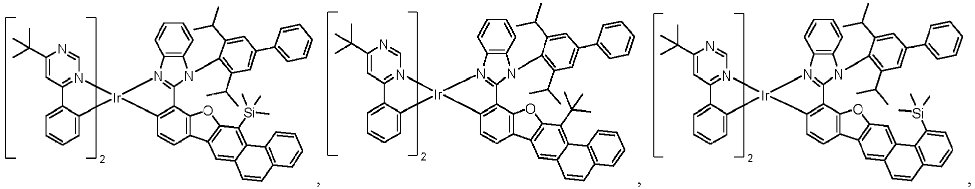

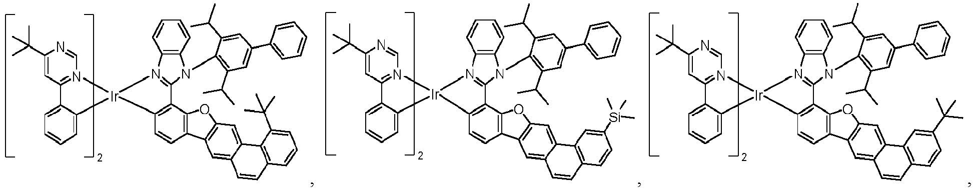

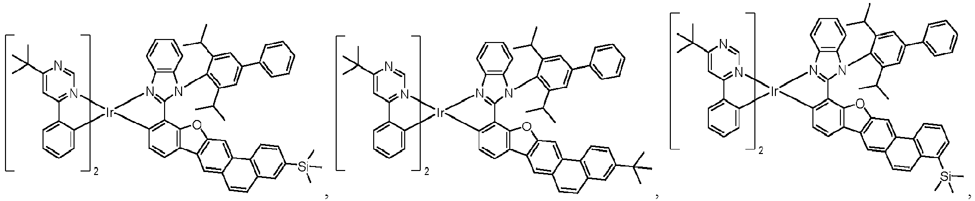

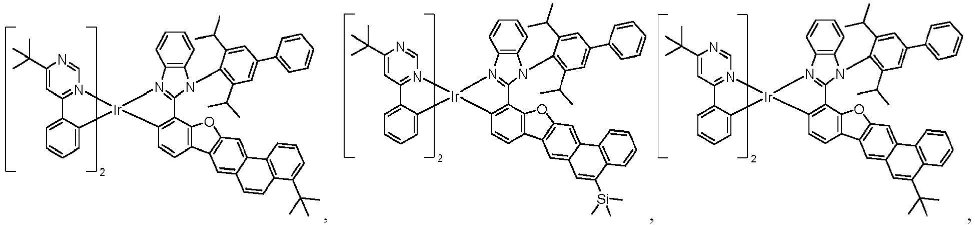

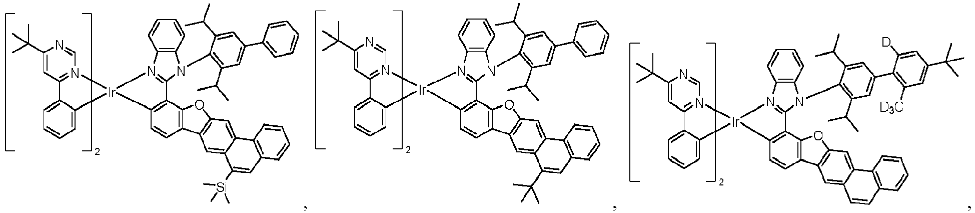

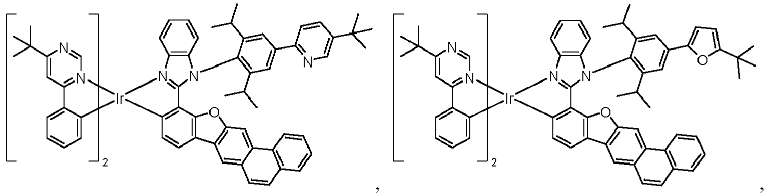

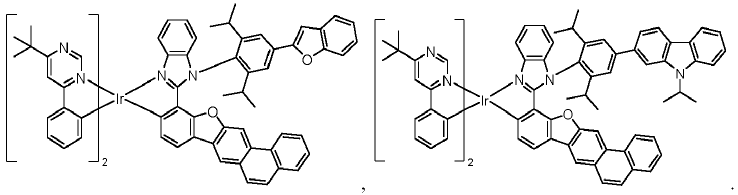

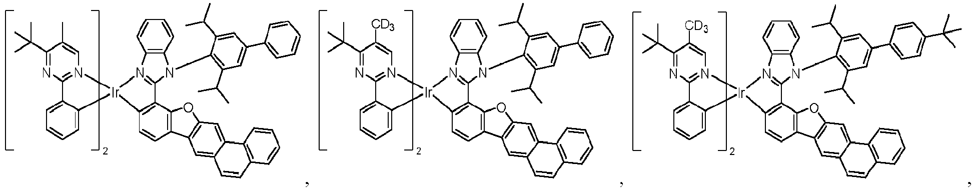

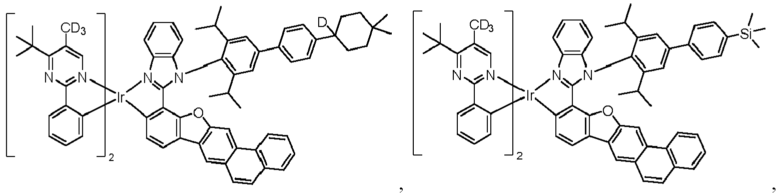

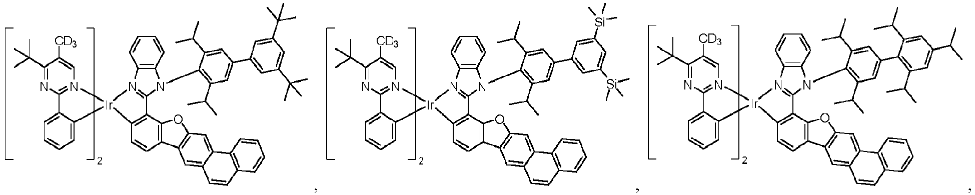

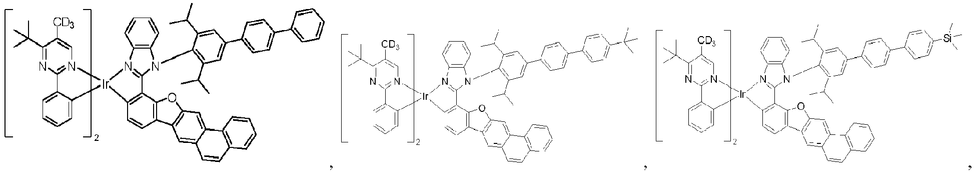

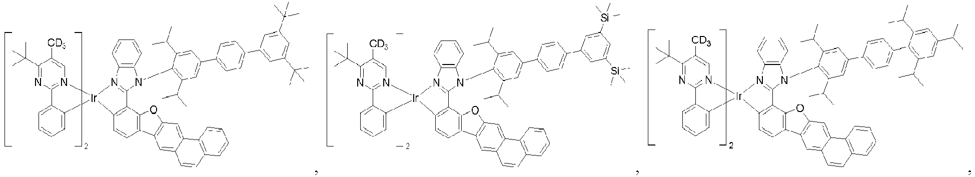

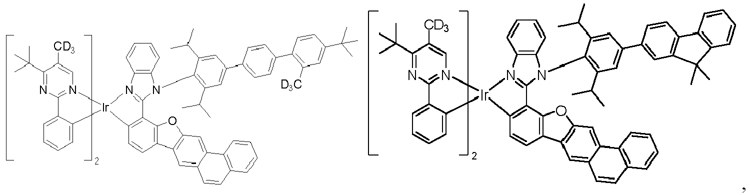

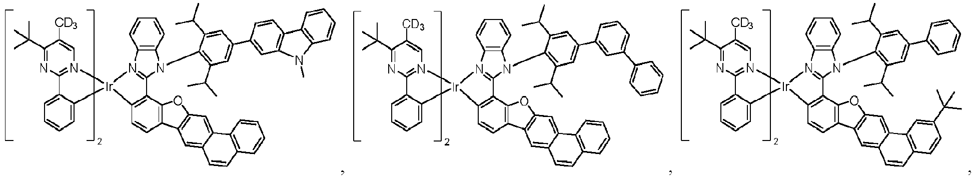

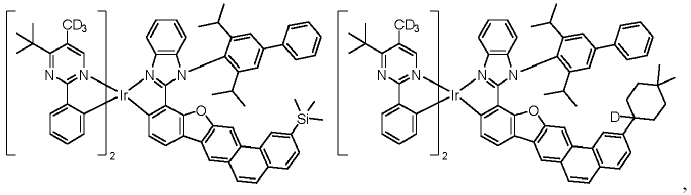

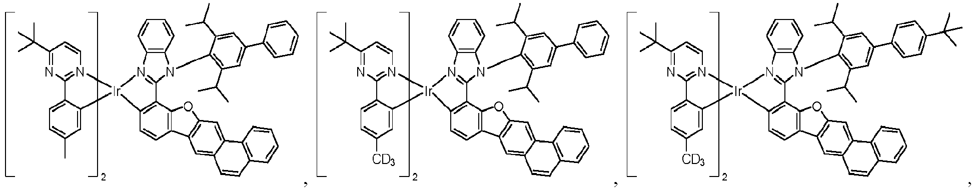

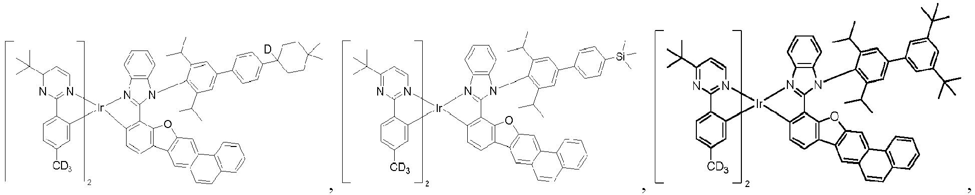

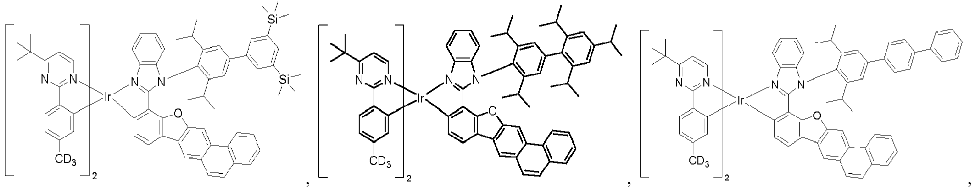

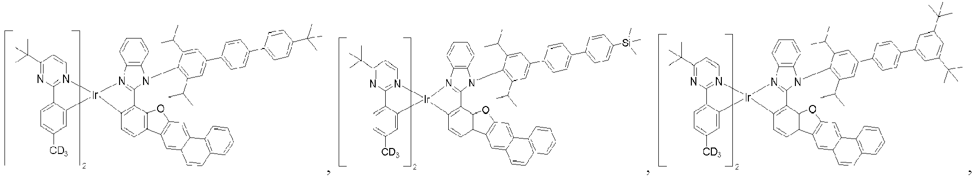

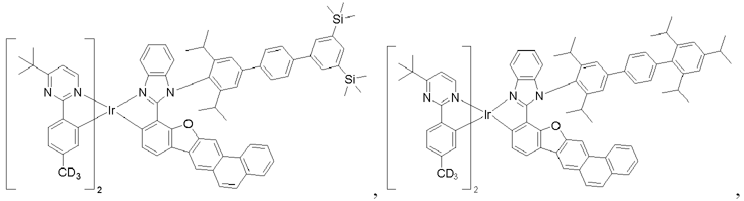

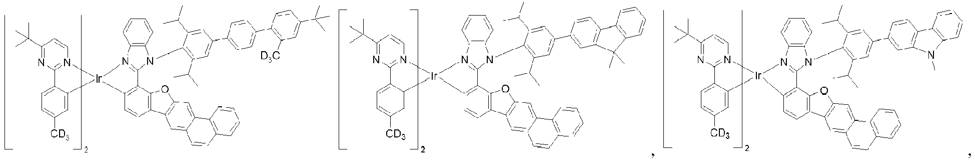

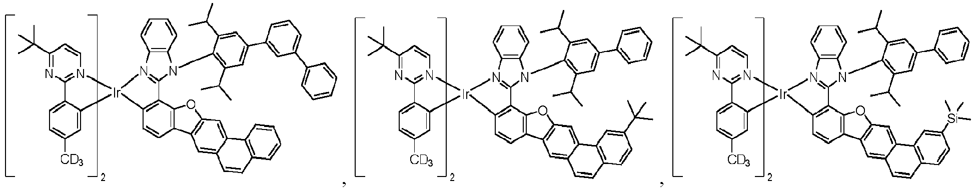

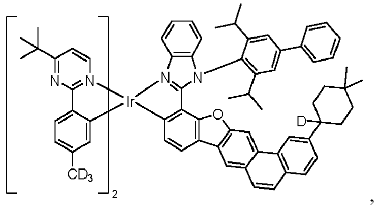

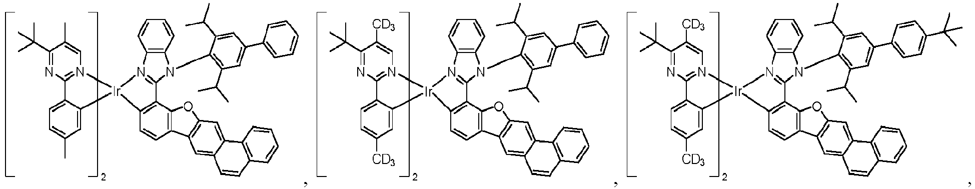

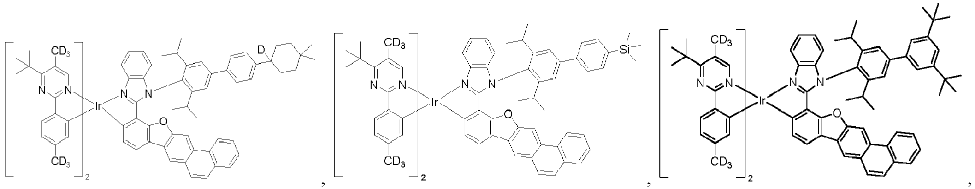

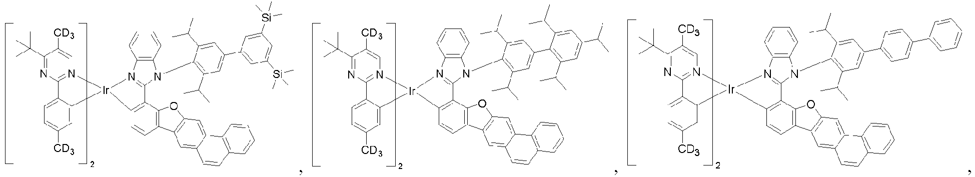

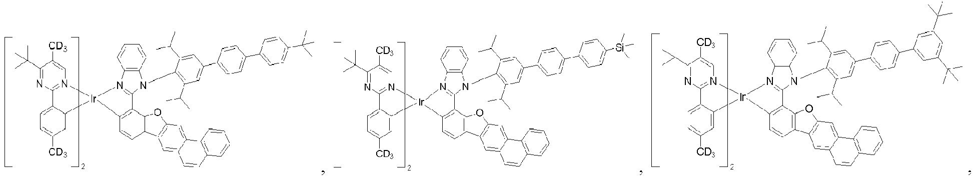

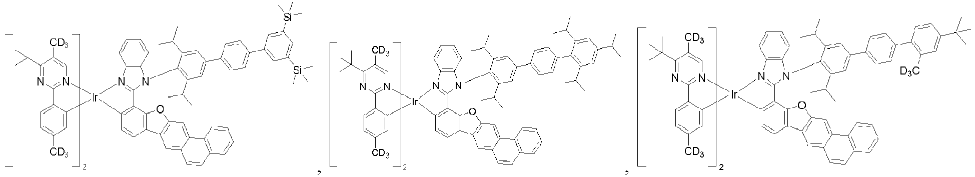

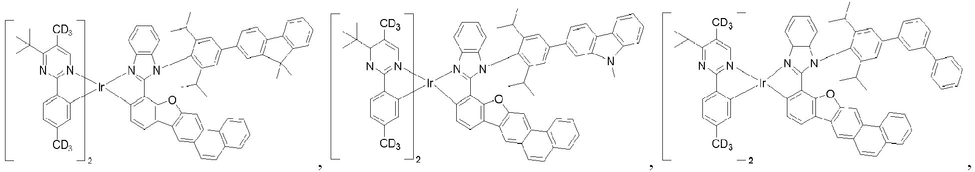

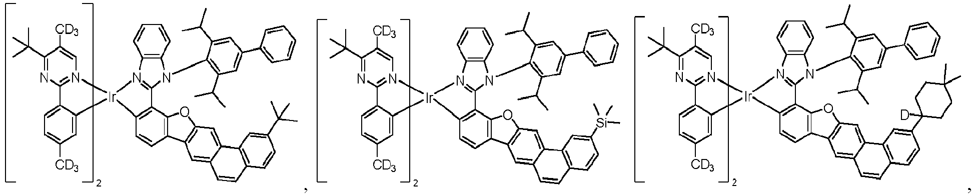

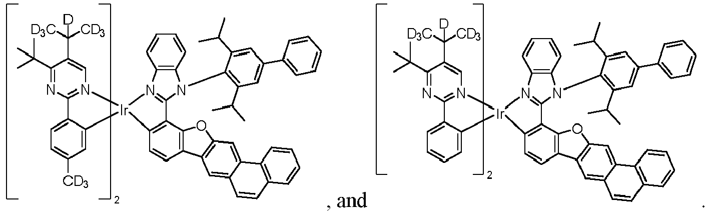

In some embodiments, the compound having a first ligand L_{A} of Formula I described herein can be at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of all possible hydrogen atoms in the compound (e.g., positions that are hydrogen or deuterium) that are occupied by deuterium atoms. In some embodiments, carbon atoms comprised the ring coordinated to the metal M are fully or partially deuterated. In some embodiments, carbon atoms comprised by a polycyclic ring system coordinated to the metal M are fully or partially deuterated. In some embodiments, a substituent attached to a monocyclic or fused polycyclic ring system coordinated to the metal M is fully or partially deuterated.

In some embodiments, the compound of formula I has an emission at room temperature with a full width at half maximum (FWHM) of equal to or less than 50, 45, 40, 35, 30, 25, 20, 15, 10, or 5 nm. Narrower FWHM means better color purity for the OLED display application.

In some embodiments of heteroleptic compound having the formula of Ir(L_{A})ₙ(L_{B})ₘ(L_{C})ₒ as defined above, the ligand L_{A} has a first substituent R^{I}, where the first substituent R^{I} has a first atom a-I that is the farthest away from the metal M among all atoms in the ligand L_{A}. Additionally, the ligand L_{B}, if present, has a second substituent R^{II}, where the second substituent R^{II} has a first atom a-II that is the farthest away from the metal M among all atoms in the ligand L_{B}. Furthermore, the ligand L_{C}, if present, has a third substituent R^{III}, where the third substituent R^{III} has a first atom a-III that is the farthest away from the metal M among all atoms in the ligand L_{C}.

In such heteroleptic compounds, vectors V_{D1}, V_{D2}, and V_{D3} can be defined as follows. V_{D1} represents the direction from the metal M to the first atom a-I and the vector V_{D1} has a value D¹ that represents the straight line distance between the metal M and the first atom a-I in the first substituent R¹. V_{D2} represents the direction from the metal M to the first atom a-II and the vector V_{D2} has a value D² that represents the straight line distance between the metal M and the first atom a-II in the second substituent R^{II}. V_{D3} represents the direction from the metal M to the first atom a-III and the vector V_{D3} has a value D³ that represents the straight line distance between the metal M and the first atom a-III in the third substituent R^{III}.

In such heteroleptic compounds, a sphere having a radius *r* is defined whose center is the metal M and the radius r is the smallest radius that will allow the sphere to enclose all atoms in the compound that are not part of the substituents R^{I}, R^{II} and R^{III}; and where at least one of D¹, D², and D³ is greater than the radius *r* by at least 1.5 Å. In some embodiments, at least one of D¹, D², and D³ is greater than the radius r by at least 2.9, 3.0, 4.3, 4.4, 5.2, 5.9, 7.3, 8.8, 10.3, 13.1, 17.6, or 19.1 Å. In some embodiments, at least two of D¹, D², and D³ is greater than the radius *r* by at least 1.5, 2.9, 3.0, 4.3, 4.4, 5.2, 5.9, 7.3, 8.8, 10.3, 13.1, 17.6, or 19.1 Å.

In some embodiments of such heteroleptic compound, the compound has a transition dipole moment axis and angles are defined between the transition dipole moment axis and the vectors V_{D1}, V_{D2}, and V_{D3}, where at least one of the angles between the transition dipole moment axis and the vectors V_{D1}, V_{D2}, and V_{D3} is less than 40°. In some embodiments, at least one of the angles between the transition dipole moment axis and the vectors V_{D1}, V_{D2}, and V_{D3} is less than 30°, 20°, 15°, or 10°. In some embodiments, at least two of the angles between the transition dipole moment axis and the vectors V_{D1}, V_{D2}, and V_{D3} are less than 20°. In some embodiments, at least two of the angles between the transition dipole moment axis and the vectors V_{D1}, V_{D2}, and V_{D3} are less than 15° or 10°.

In some embodiments, all three angles between the transition dipole moment axis and the vectors V_{D1}, V_{D2}, and V_{D3} are less than 20°. In some embodiments, all three angles between the transition dipole moment axis and the vectors V_{D1}, V_{D2}, and V_{D3} are less than 15° or 10°.

In some embodiments of such heteroleptic compounds, the compound has a vertical dipole ratio (VDR) of 0.33 or less. In some embodiments of such heteroleptic compounds, the compound has a VDR of 0.30, 0.25, 0.20, or 0.15 or less.

One of ordinary skill in the art would readily understand the meaning of the terms transition dipole moment axis of a compound and vertical dipole ratio of a compound. Nevertheless, the meaning of these terms can be found in U.S. pat. No. 10,672,997 whose disclosure is incorporated herein by reference in its entirety. In U.S. pat. No. 10,672,997, horizontal dipole ratio (HDR) of a compound, rather than VDR, is discussed. However, one skilled in the art readily understands that VDR = 1 - HDR.

In some embodiments, the compound can be an emissive dopant. In some embodiments, the compound can produce emissions via phosphorescence, fluorescence, thermally activated delayed fluorescence, triplet-triplet annihilation, or combinations of these processes. In some embodiments, the emissive dopant can be a racemic mixture, or can be enriched in one enantiomer. In some embodiments, the present compounds can have different stereoisomers, such as *fac* and *mer.* The current compound relates both to individual isomers and to mixtures of various isomers in any mixing ratio. In some embodiments, the compound can be homoleptic (each ligand is the same). In some embodiments, the compound can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from every other ligand. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In yet another aspect of the present disclosure, a formulation that comprises the novel compound disclosed herein is described. The formulation can include one or more components selected from the group consisting of a solvent, an emitter, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds. As used in this context, the description that a structure A comprises a moiety B means that the structure A includes the structure of moiety B not including the H or D atoms that can be attached to the moiety B. This is because at least one H or D on a given moiety structure has to be replaced to become a substituent so that the moiety B can be part of the structure A, and one or more of the H or D on a given moiety B structure can be further substituted once it becomes a part of structure A.

### C. The OLEDs and the Devices of the Present Disclosure

In another aspect, the present disclosure also provides an OLED device comprising a first organic layer that contains a compound as disclosed in the above compounds section of the present disclosure.

In some embodiments, the OLED comprises: an anode; a cathode; and an organic layer disposed between the anode and the cathode, where the organic layer comprises a compound having a first ligand L_{A} comprising a structure of Formula I as described herein.

In some embodiments, the organic layer is selected from the group consisting of HIL, HTL, EBL, EML, HBL, ETL, and EIL. In some embodiments, the organic layer may be an emissive layer and the compound as described herein may be an emissive dopant or a non-emissive dopant.

In some embodiments, the organic layer may further comprise a host, wherein host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

In some embodiments, the host can be selected from the group consisting of the structures of the following HOST Group 1: 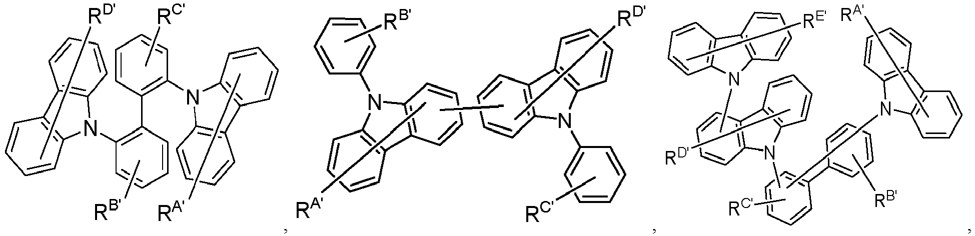 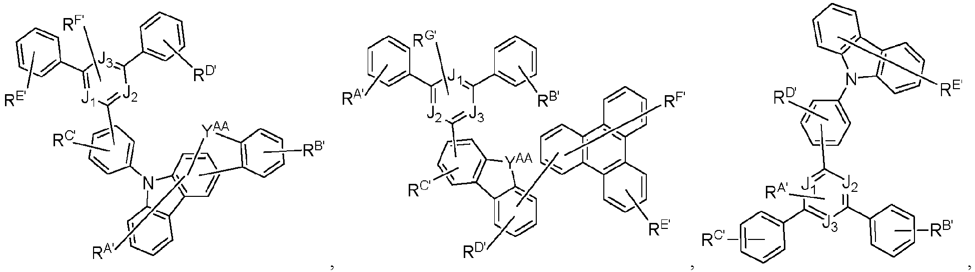 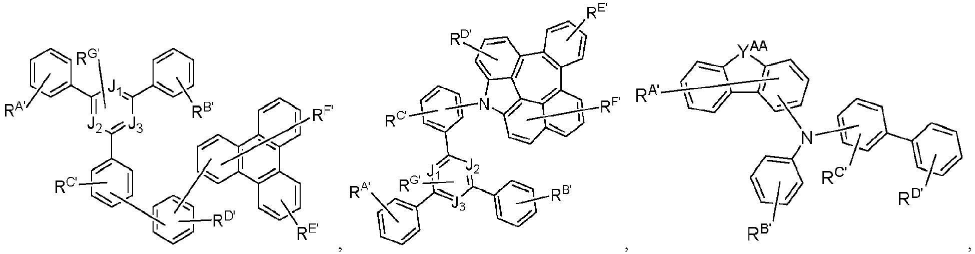 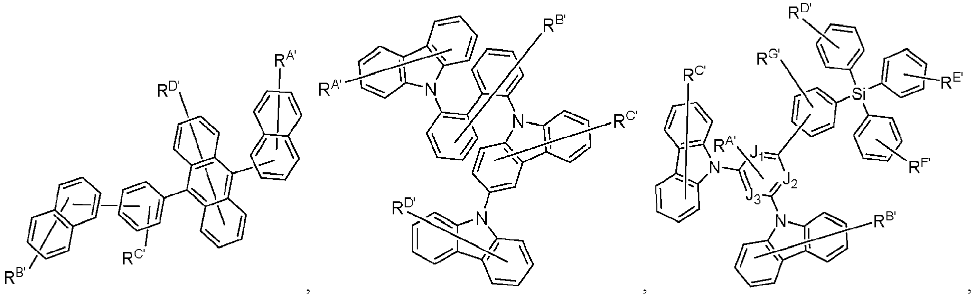 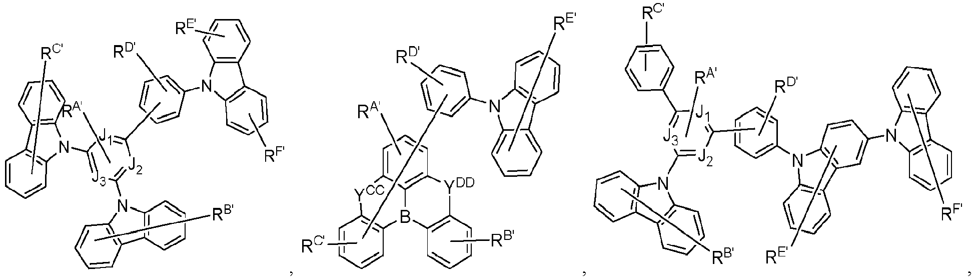 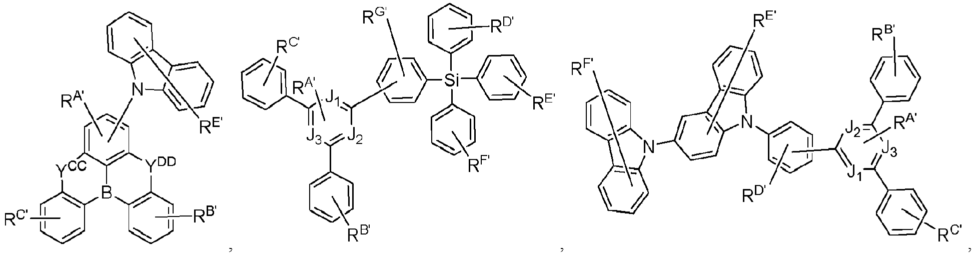 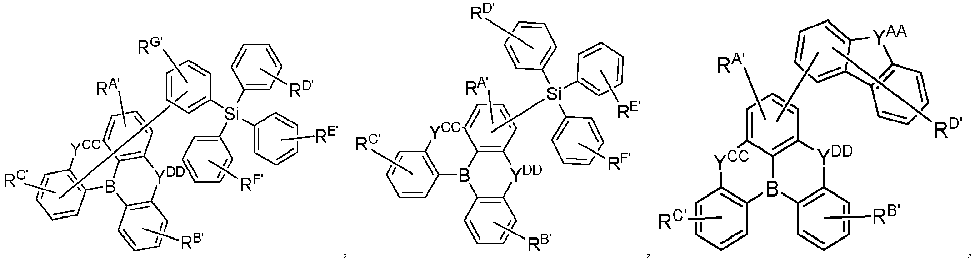 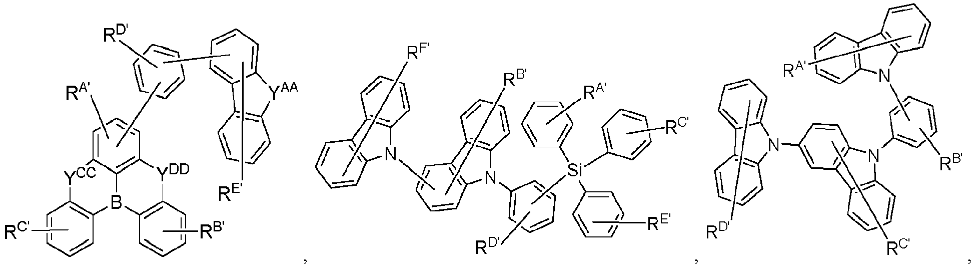 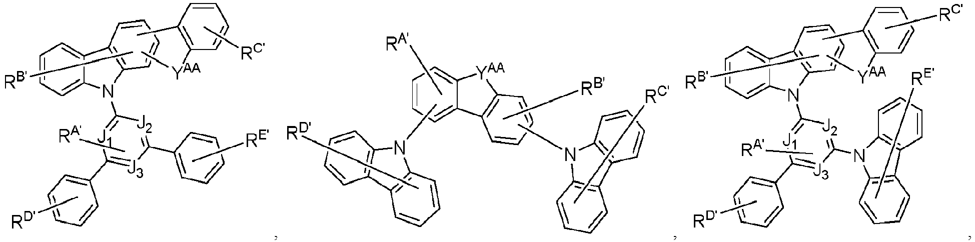 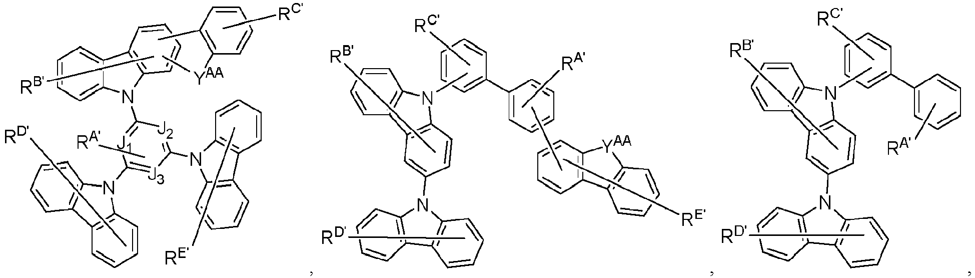 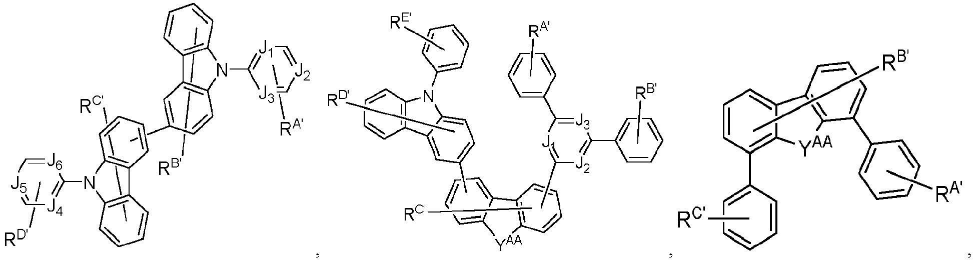 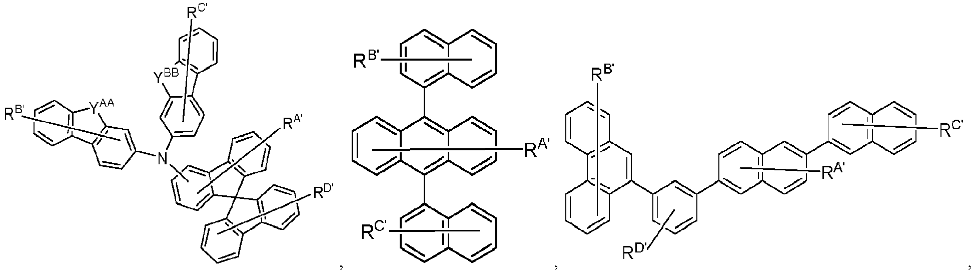 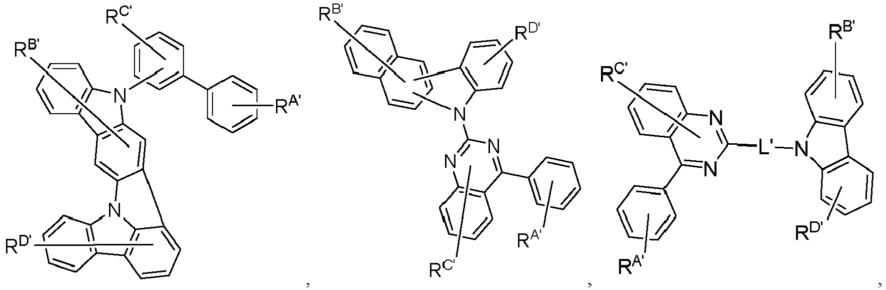 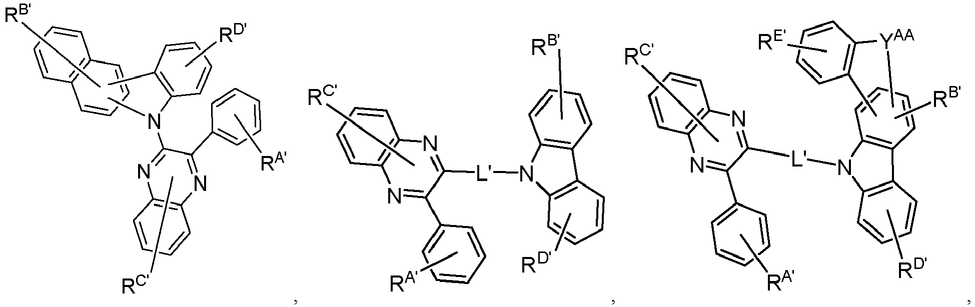 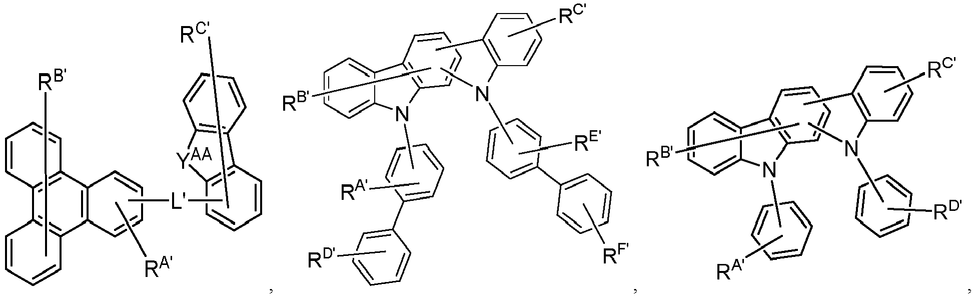 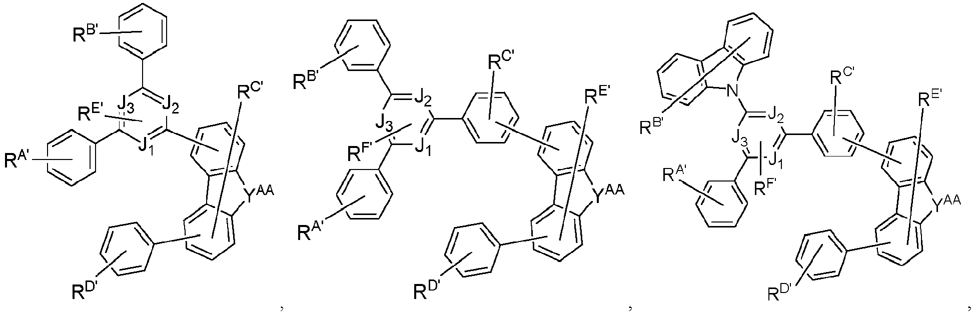 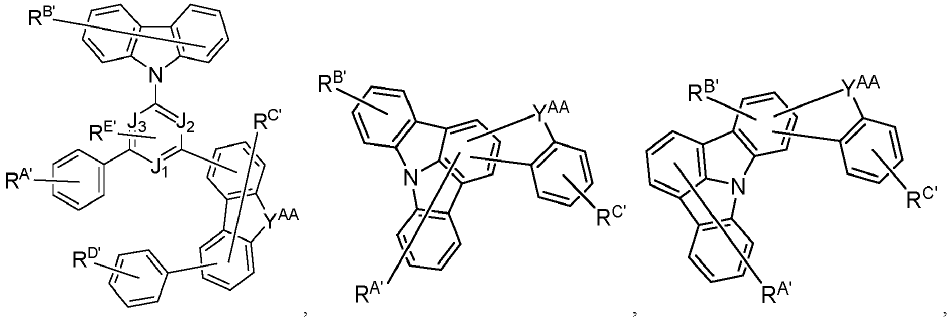 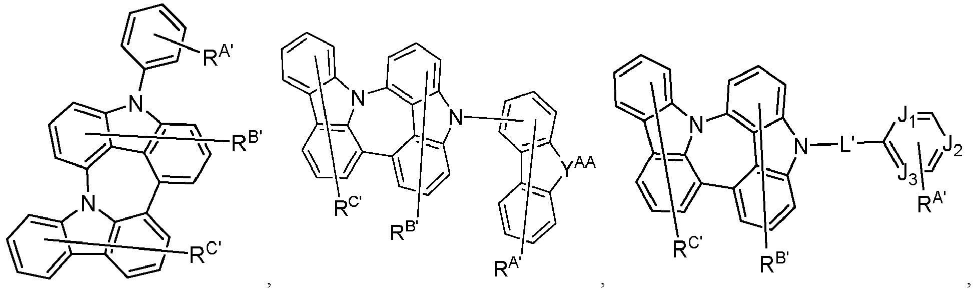 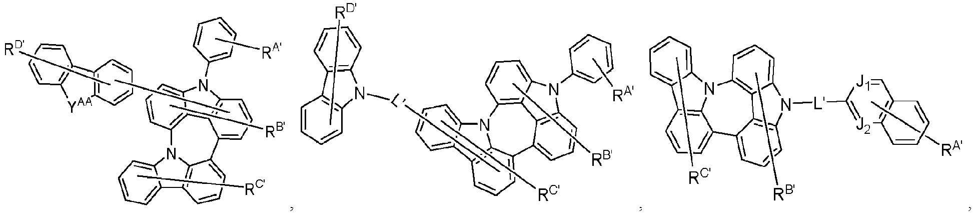 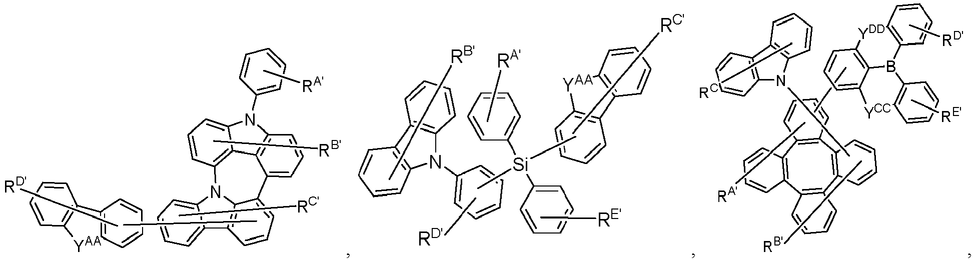 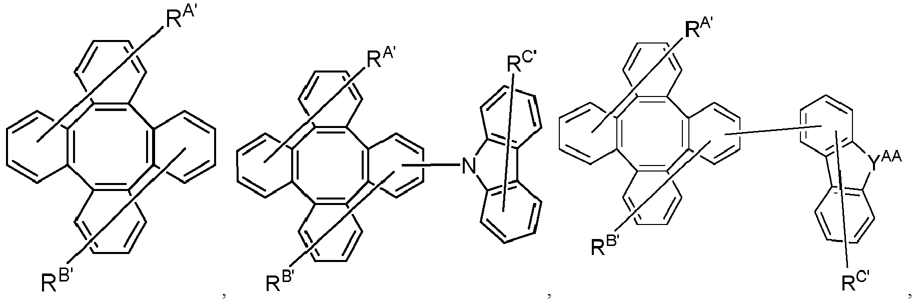 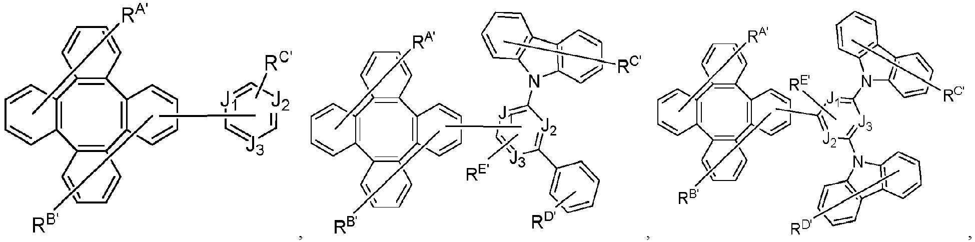 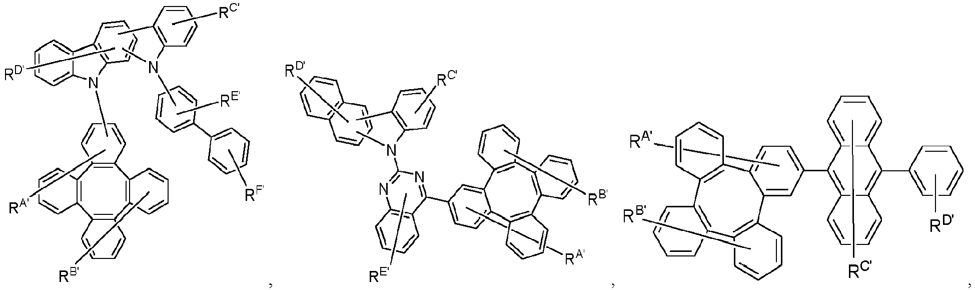 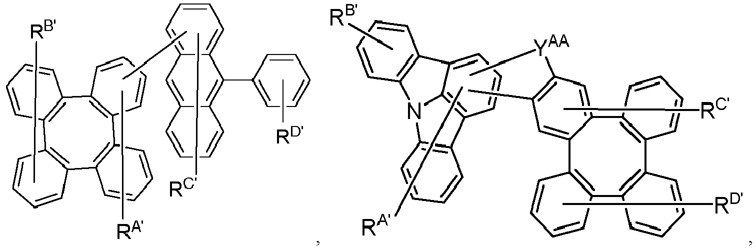 and 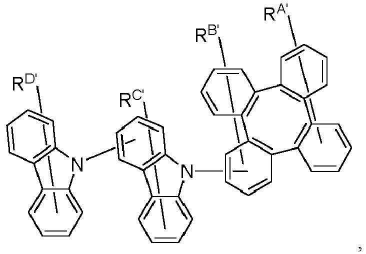 wherein:
each of J₁ to J₆ is independently C or N;
L' is a direct bond or an organic linker;
each Y^{AA}, Y^{BB}, Y^{CC}, and Y^{DD} is independently selected from the group consisting of absent a bond, direct bond, O, S, Se, CRR', SiRR', GeRR', NR, BR, BRR';
each of R^{A}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of the General Substituents as defined herein; any two substituents can be joined or fused to form a ring;
and where possible, each unsubstituted aromatic carbon atom is optionally replaced with N to form an aza-substituted ring.

In some embodiments at least one of J₁ to J₃ is N. In some embodiments at least two of J₁ to J₃ are N. In some embodiments, all three of J₁ to J₃ are N. In some embodiments, each Y^{CC} and Y^{DD} is independently O, S, or SiRR', or more preferably O or S. In some embodiments, at least one unsubstituted aromatic carbon atom is replaced with N to form an aza-ring.

In some embodiments, the host is selected from the group consisting of EG*1*-MG*1*-EG*1* to EG*53*-MG*27*-EG*53* with a formula of EG*a-*MG*b*-EG*c*, or EG*1*-EG*1* to EG*53*-EG*53* with a formula of EG*a*-EG*c* when MG*b* is absent, wherein *a* is an integer from 1 to 53, *b* is an integer from 1 to 27, *c* is an integer from 1 to 53. The structure of EG1 to EG53 is shown below: 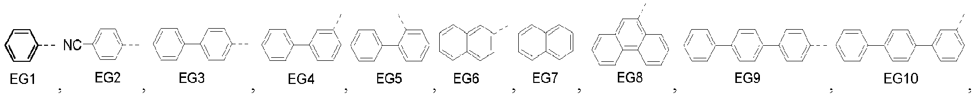 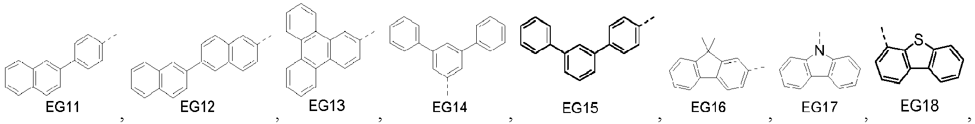 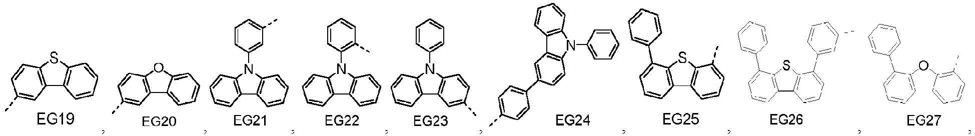 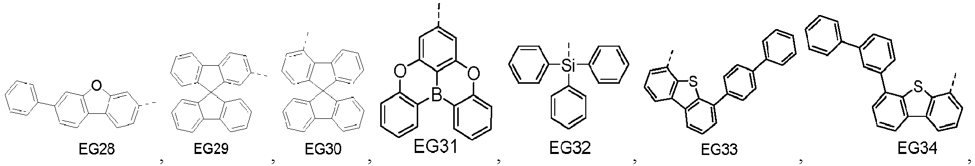 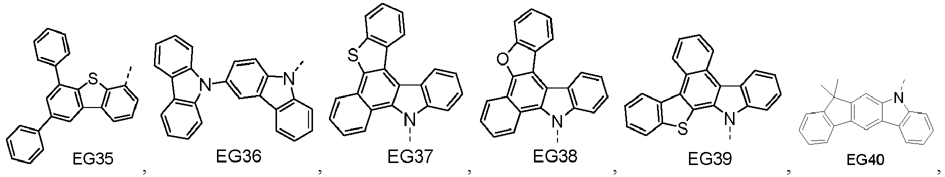 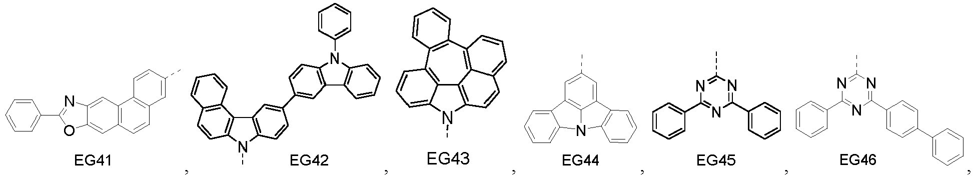 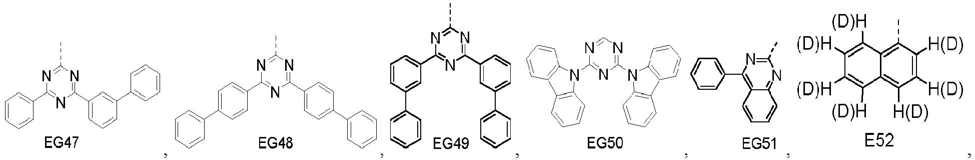 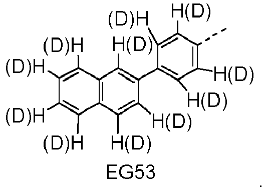 The structure ofMGl to MG27 is shown below: 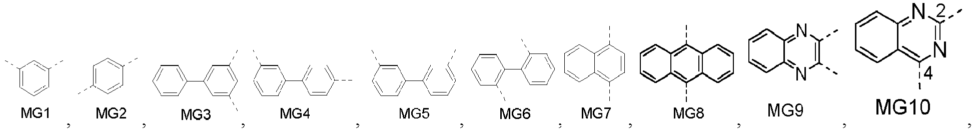 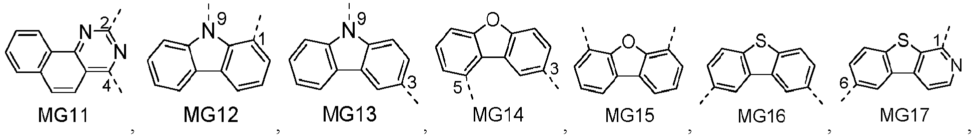 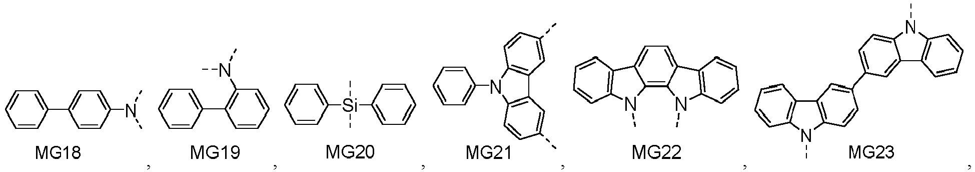 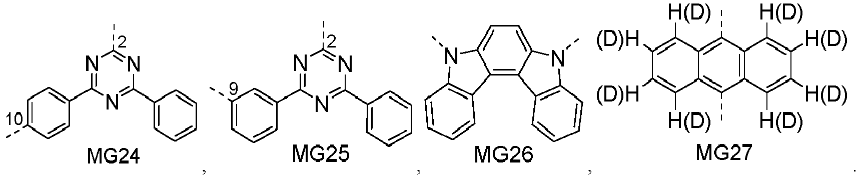 In the MG*b* structures shown above, the two bonding positions in the asymmetric structures MG10, MG11, MG12, MG13, MG14, MG17, MG24, and MG25 are labeled with numbers for identification purposes.

In some embodiments, the host can be any of the aza-substituted variants thereof, fully or partially deuterated variants thereof, and combinations thereof. In some embodiments, the host has formula EG*a*-MG*b*-Eg*c* and is selected from the group consisting of *h1* to *h112* defined in the following HOST Group 2 list, where each of MG*b*, EG*a*, and EG*c* are defined as follows:

| ***h*** | **MG*b*** | **EG*a*** | **EG*c*** | ***h*** | **MG*b*** | **EG*a*** | **EG*c*** | ***h*** | **MG*b*** | **EG*a*** | **EG*c*** |
|---|---|---|---|---|---|---|---|---|---|---|---|
| ***h1*** | MG1 | EG3 | EG36 | ***h39*** | MG13 | *3*-EG17 | *9*-EG4 | ***h77*** | MG23 | EG3 | EG4 |
| ***h2*** | MG1 | EG8 | EG12 | ***h40*** | MG13 | *3*-EG17 | *9*-EG13 | ***h78*** | MG23 | EG3 | EG5 |
| ***h3*** | MG1 | EG13 | EG14 | ***h41*** | MG13 | *3*-EG17 | *9*-EG31 | ***h79*** | MG23 | EG4 | EG4 |
| ***h4*** | MG1 | EG13 | EG18 | ***h42*** | MG13 | *3*-EG17 | *9*-EG45 | ***h80*** | MG23 | EG4 | EG5 |
| ***h5*** | MG1 | EG13 | EG25 | ***h43*** | MG13 | *3*-EG17 | *9*-EG46 | ***h81*** | MG24 | *2*-EG1 | *10*-EG33 |
| ***h6*** | MG1 | EG13 | EG36 | ***h44*** | MG13 | *3*-EG17 | *9*-EG48 | ***h82*** | MG24 | *2*-EG4 | *10*-EG36 |
| **h7** | MG1 | EG22 | EG36 | ***h45*** | MG13 | *3*-EG17 | *9*-EG49 | ***h83*** | MG24 | *2*-EG21 | *10*-EG36 |
| ***h8*** | MG1 | EG25 | EG46 | ***h46*** | MG13 | *3*-EG32 | *9*-EG31 | ***h84*** | MG24 | *2*-EG23 | *10*-EG36 |
| ***h9*** | MG1 | EG27 | EG46 | ***h47*** | MG13 | *3*-EG44 | *9*-EG3 | ***h85*** | MG25 | *2*-EG1 | *9*-EG33 |
| ***h10*** | MG1 | EG27 | EG48 | ***h48*** | MG14 | *3*-EG13 | *5*-EG45 | ***h86*** | MG25 | *2*-EG3 | *9*-EG36 |
| ***h11*** | MG1 | EG32 | EG50 | ***h49*** | MG14 | *3*-EG23 | *5*-EG45 | ***h87*** | MG25 | *2*-EG4 | *9*-EG36 |
| ***h12*** | MG1 | EG35 | EG46 | ***h50*** | MG15 | EG3 | EG48 | ***h88*** | MG25 | *2*-EG17 | *9*-EG27 |
| ***h13*** | MG1 | EG36 | EG45 | ***h51*** | MG15 | EG17 | EG31 | ***h89*** | MG25 | *2*-EG17 | *9*-EG36 |
| ***h14*** | MG1 | EG36 | EG49 | ***h52*** | MG15 | EG31 | EG36 | ***h90*** | MG25 | *2*-EG21 | *9*-EG36 |
| ***h15*** | MG1 | EG40 | EG45 | ***h53*** | MG16 | EG17 | EG17 | ***h91*** | MG25 | *2*-EG23 | *9*-EG27 |
| ***h16*** | MG2 | EG3 | EG36 | ***h54*** | MG17 | EG17 | EG17 | ***h92*** | MG25 | *2*-EG23 | *9*-EG36 |
| ***h17*** | MG2 | EG25 | EG31 | ***h55*** | MG18 | EG16 | EG24 | ***h93*** | MG26 | EG1 | EG9 |
| ***h18*** | MG2 | EG31 | EG33 | ***h56*** | MG18 | EG16 | EG30 | ***h94*** | MG26 | EG1 | EG10 |
| ***h19*** | MG2 | EG36 | EG45 | ***h57*** | MG18 | EG20 | EG41 | ***h95*** | MG26 | EG1 | EG21 |
| ***h20*** | MG2 | EG36 | EG46 | ***h58*** | MG19 | EG16 | EG29 | ***h96*** | MG26 | EG1 | EG23 |
| ***h21*** | MG3 | EG4 | EG36 | ***h59*** | MG20 | EG1 | EG31 | ***h97*** | MG26 | EG1 | EG26 |
| ***h22*** | MG3 | EG34 | EG45 | ***h60*** | MG20 | EG17 | EG18 | ***h98*** | MG26 | EG3 | EG3 |
| ***h23*** | MG4 | EG13 | EG17 | ***h61*** | MG21 | EG23 | EG23 | ***h99*** | MG26 | EG3 | EG9 |
| ***h24*** | MG5 | EG13 | EG45 | ***h62*** | MG22 | EG1 | EG45 | ***h100*** | MG26 | EG3 | EG23 |
| ***h25*** | MG5 | EG17 | EG36 | ***h63*** | MG22 | EG1 | EG46 | ***h101*** | MG26 | EG3 | EG26 |
| ***h26*** | MG5 | EG18 | EG36 | ***h64*** | MG22 | EG3 | EG46 | ***h102*** | MG26 | EG4 | EG10 |
| ***h27*** | MG6 | EG17 | EG17 | ***h65*** | MG22 | EG4 | EG46 | ***h103*** | MG26 | EG5 | EG10 |
| ***h28*** | MG7 | EG43 | EG45 | ***h66*** | MG22 | EG4 | EG47 | ***h104*** | MG26 | EG6 | EG10 |
| ***h29*** | MG8 | EG1 | EG28 | ***h67*** | MG22 | EG9 | EG45 | ***h105*** | MG26 | EG10 | EG10 |
| ***h30*** | MG8 | EG6 | EG7 | ***h68*** | MG23 | EG1 | EG3 | ***h106*** | MG26 | EG10 | EG14 |
| ***h31*** | MG8 | EG7 | EG7 | ***h69*** | MG23 | EG1 | EG6 | ***h107*** | MG26 | EG10 | EG15 |
| ***h32*** | MG8 | EG7 | EG11 | ***h70*** | MG23 | EG1 | EG14 | ***h108*** | MG27 | EG52 | EG53 |
| ***h33*** | MG9 | EG1 | EG43 | ***h71*** | MG23 | EG1 | EG18 | ***h109*** | - | EG13 | EG18 |
| ***h34*** | MG10 | *4*-EG1 | *2*-EG37 | ***h72*** | MG23 | EG1 | EG19 | ***h110*** | - | EG17 | EG31 |
| ***h35*** | MG10 | *4*-EG1 | *2*-EG38 | ***h73*** | MG23 | EG1 | EG23 | ***h111*** | - | EG17 | EG50 |
| ***h36*** | MG10 | EG1 | EG42 | ***h74*** | MG23 | EG1 | EG51 | ***h112*** | - | EG40 | EG45 |
| ***h37*** | MG11 | *4*-EG1 | *2*-EG39 | ***h75*** | MG23 | EG2 | EG18 | | | | |
| ***h38*** | MG12 | *1*-EG17 | *9*-EG31 | ***h76*** | MG23 | EG3 | EG3 | | | | |

In the table above, the EGa and EGc structures that are bonded to one of the asymmetric structures MG10, MG11, MG12, MG13, MG14, MG17, MG24, and MG25, are noted with a numeric prefix identifying their bonding position in the MG*b* structure.

In some embodiments, the organic layer may further comprise a host, wherein the host comprises a metal complex.

In some embodiments, the emissive layer can comprise two hosts, a first host and a second host. In some embodiments, the first host is a hole transporting host, and the second host is an electron transporting host. In some embodiments, the first host is a hole transporting host, and the second host is a bipolar host. In some embodiments, the first host is an electron transporting host, and the second host is a bipolar host. In some embodiments, the first host and the second host can form an exciplex. In some embodiments, the emissive layer can comprise a third host. In some embodiments, the third host is selected from the group consisting of an insulating host (wide band gap host), a hole transporting host, and an electron transporting host. In some embodiments, the third host forms an exciplex with one of the first host and the second host, or with both the first host and the second host. In some embodiments, the emissive layer can comprise a fourth host. In some embodiments, the fourth host is selected from the group consisting of an insulating host (wide band gap host), a hole transporting host, and an electron transporting host. In some embodiments, the fourth host forms an exciplex with one of the first host, the second host, and the third host, with two of the first host, the second host, and the third host, or with each of the first host, the second host, and the third host. In some embodiments, the electron transporting host has a LUMO less than -2.4 eV, less than -2.5 eV, less than -2.6 eV, or less than -2.7 eV In some embodiments, the hole transporting host has a HOMO higher than -5.6 eV, higher than -5.5 eV, higher than -5.4 eV, or higher than -5.35 eV The HOMO and LUMO values can be determined using solution electrochemistry. Solution cyclic voltammetry and differential pulsed voltammetry can be performed using a CH Instruments model 6201B potentiostat using anhydrous dimethylformamide (DMF) solvent and tetrabutylammonium hexafluorophosphate as the supporting electrolyte. Glassy carbon, platinum wire, and silver wire were used as the working, counter and reference electrodes, respectively. Electrochemical potentials can be referenced to an internal ferrocene-ferroconium redox couple (Fc/Fc+) by measuring the peak potential differences from differential pulsed voltammetry. The corresponding highest occupied molecular orbital (HOMO) and lowest unoccupied molecular orbital (LUMO) energies can be determined by referencing the cationic and anionic redox potentials to ferrocene (4.8 eV vs. vacuum) according to literature ((a) Fink, R.; Heischkel, Y; Thelakkat, M.; Schmidt, H.-W. Chem. Mater. 1998, 10, 3620-3625. (b) Pommerehne, J.; Vestweber, H.; Guss, W-, Mahrt, R. F.; Bassler, H.; Porsch, M.; Daub, J. Adv. Mater. 1995, 7, 551).

In some embodiments, the compound as described herein may be a sensitizer or a component of a sensitizer; wherein the device may further comprise an acceptor that receives the energy from the sensitizer. In some embodiments, the acceptor is an emitter in the device. In some embodiments, the acceptor may be a fluorescent material. In some embodiments, the compound described herein can be used as a phosphorescent sensitizer in an OLED where one or multiple layers in the OLED contain an acceptor in the form of one or more non-delayed fluorescent and/or delayed fluorescence material. In some embodiments, the compound described herein can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 99.9%. The acceptor could be in either the same layer as the phosphorescent sensitizer or in one or more different layers. In some embodiments, the acceptor is a thermally activated delayed fluorescence (TADF) material. In some embodiments, the acceptor is a non-delayed fluorescent material. In some embodiments, the emission can arise from any or all of the sensitizer, acceptor, and final emitter. In some embodiments, the acceptor has an emission at room temperature with a full width at half maximum (FWHM) of equal to or less than 50, 45, 40, 35, 30, 25, 20, 15, 10, or 5 nm. Narrower FWHM means better color purity for the OLED display application.

As used herein, phosphorescence generally refers to emission of a photon with a change in electron spin quantum number, i.e., the initial and final states of the emission have different electron spin quantum numbers, such as from T1 to S0 state. Most of the Ir and Pt complexes currently used in OLED are phosphorescent emitters. In some embodiments, if an exciplex formation involves a triplet emitter, such exciplex can also emit phosphorescent light. On the other hand, fluorescent emitters generally refer to emission of a photon without a change in electron spin quantum number, such as from S1 to S0 state, or from D1 to D0 state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e. P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as TADF. E-type delayed fluorescence characteristics can be found in an exciplex system or in a single compound. Without being bound by theory, it is believed that TADF emissions require a compound or an exciplex having a small singlet-triplet energy gap (ΔE_{S-T}) less than or equal to 400, 350, 300, 250, 200, 150, 100, or 50 meV There are two major types of TADF emitters, one is called donor-acceptor type TADF, the other one is called multiple resonance (MR) TADF. Often, single compound donor-acceptor TADF compounds are constructed by connecting an electron donor moiety such as amino- or carbazole-derivatives and an electron acceptor moiety such as N-containing six-membered aromatic rings or cyano-substituted aromatic rings. Donor-acceptor exciplexes can be formed between a hole transporting compound and an electron transporting compound. Examples of MR-TADF materials include highly conjugated fused ring systems. In some embodiments, MR-TADF materials comprises boron, carbon, and nitrogen atoms. Such materials may comprise other atoms, such as oxygen, as well. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments, the OLED may comprise an additional compound selected from the group consisting of a non-delayed fluorescence material, a delayed fluorescence material, a phosphorescent material, and combination thereof.

In some embodiments, the inventive compound described herein is a phosphorescent material.

In some embodiments, the phosphorescent material is an emitter which emits light within the OLED. In some embodiments, the phosphorescent material does not emit light within the OLED. In some embodiments, the phosphorescent material energy transfers its excited state to another material within the OLED. In some embodiments, the phosphorescent material participates in charge transport within the OLED. In some embodiments, the phosphorescent material is a sensitizer or a component of a sensitizer, and the OLED further comprises an acceptor. In some embodiments, the phosphorescent material forms an exciplex with another material within the OLED, for example a host material, an emitter material.

In some embodiments, the non-delayed fluorescence material or the delayed fluorescence material is an emitter which emits light within the OLED. In some embodiments, the non-delayed fluorescence material or the delayed fluorescence material does not emit light within the OLED. In some embodiments, the non-delayed fluorescence material or the delayed fluorescence material energy transfers its excited state to another material within the OLED. In some embodiments, the non-delayed fluorescence material or the delayed fluorescence material participates in charge transport within the OLED. In some embodiments, the non-delayed fluorescence material or the delayed fluorescence material is an acceptor, and the OLED further comprises a sensitizer

In some embodiments of the OLED, the delayed fluorescence material comprises at least one donor group and at least one acceptor group. In some embodiments, the delayed fluorescence material is a metal complex. In some embodiments, the delayed fluorescence material is a non-metal complex. In some embodiments, the delayed fluorescence material is a Pt, Pd, Zn, Cu, Ag, or Au complex (some of them are also called metal-assisted (MA) TADF). In some embodiments, the metal-assisted delayed fluorescence material comprises a metal-carbene bond. In some embodiments, the non-delayed fluorescence material or delayed fluorescence material comprises at least one chemical group selected from the group consisting of aryl-amine, aryloxy, arylthio, triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, 5λ²,9λ²-diaza-13b-boranaphtho[2,3,4-de]anthracene, 5-oxa-9λ²-aza-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, amino, silyl, aza-variants thereof, and combinations thereof. In some embodiments, non-delayed the fluorescence material or delayed fluorescence material comprises a tri(aryl/heteroaryl)borane with one or more pairs of the substituents from the aryl/heteroaryl being joined to form a ring. In some embodiments, the fluorescence material comprises at least one chemical group selected from the group consisting of naphthalene, anthracene, phenalene, phenanthrene, fluorene, pyrene, chrysene, perylene, and azulene.

In yet another aspect, the OLED of the present disclosure may also comprise an emissive region containing a compound or a formulation of the compound as disclosed in the above compounds section of the present disclosure. In some embodiments, the emissive region can comprise a compound or a formulation of the compound having a first ligand L_{A} comprising a structure of Formula I as described herein. In some embodiments, the emissive region consists of one or more organic layers, wherein at least one of the one or more organic layers has a minimum thickness selected from the group consisting of 350, 400, 450, 500, 550, 600, 650 and 700 Å. In some embodiments, the at least one of the one or more organic layers are formed from an Emissive System that has a figure of merit (FOM) value equal to or larger than the number selected from the group consisting of 2.50, 2.55, 2.60, 2.65, 2.70, 2.75, 2.80, 2.85, 2.90, 2.95, 3.00, 5.00, 10.0, 15.0, and 20.0. The definition of FOM is available in U.S. patent Application Publication No. 2023/0292605, and its entire contents are incorporated herein by reference. In some embodiments, the at least one of the one or more organic layers comprises a compound or a formulation of the compound as disclosed in Sections A and D of the present disclosure.

In some embodiments, the OLED or the emissive region comprising the inventive compound disclosed herein can be incorporated into a full-color pixel arrangement of a device. The full-color pixel arrangement of such a device comprises at least one pixel, wherein the at least one pixel comprises a first subpixel and a second subpixel. The first subpixel includes a first OLED comprising a first emissive region. The second subpixel includes a second OLED comprising a second emissive region. In some embodiments, the first and/or second OLED, the first and/or second emissive region can be the same or different and each can independently have the various device characteristics and the various embodiments of the inventive compounds included therein, and various combinations and subcombinations of the various device characteristics and the various embodiments of the inventive compounds included therein, as disclosed herein.

In some embodiments, the first emissive region is configured to emit a light having a peak wavelength λₘₐₓ₁; the second emissive region is configured to emit a light having a peak wavelength λₘₐₓ₂. In some embodiments, the difference between the peak wavelengths λₘₐₓ₁ and λₘₐₓ₂ is at least 4 nm but within the same color. For example, a light blue and a deep blue light as described above. In some embodiments, a first emissive region is configured to emit a light having a peak wavelength λₘₐₓ₁ in one region of the visible spectrum of 400-500 nm, 500-600 nm, 600-700 nm; and a second emissive region is configured to emit light having a peak wavelength λₘₐₓ₂ in one of the remaining regions of the visible spectrum of 400-500 nm, 500-600 nm, 600-700 nm. In some embodiments, the first emissive region comprises a first number of emissive layers that are deposited one over the other if more than one; and the second emissive region comprises a second number of emissive layers that is deposited one over the other if more than one; and the first number is different from the second number. In some embodiments, both the first emissive region and the second emissive region comprise a phosphorescent materials, which may be the same or different. In some embodiments, the first emissive region comprises a phosphorescent material, while the second emissive region comprises a fluorescent material. In some embodiments, both the first emissive region and the second emissive region comprise a fluorescent materials, which may be the same or different.

In some embodiments, the at least one pixel of the OLED or emissive regions includes a total of *N* subpixels; wherein the *N* subpixels comprises the first subpixel and the second subpixel; wherein each of the N subpixels comprises an emissive region; wherein the total number of the emissive regions within the at least one pixel is equal to or less than *N-1.* In some embodiments, the second emissive region is exactly the same as the first emissive region; and each subpixel of the at least one pixel comprises the same one emissive region as the first emissive region. In some embodiments, the full-color pixel arrangements can have a plurality of pixels comprising a first pixel region and a second pixel region; wherein at least one display characteristic in the first pixel region is different from the corresponding display characteristic of the second pixel region, and wherein the at least one display characteristic is selected from the group consisting of resolution, cavity mode, color, outcoupling, and color filter.

In some embodiments, the OLED is a stacked OLED comprising one or more charge generation layers (CGLs). In some embodiments, the OLED comprises a first electrode, a first emissive region disposed over the first electrode, a first CGL disposed over the first emissive region, a second emissive region disposed over the first CGL, and a second electrode disposed over the second emissive region. In some embodiments, the first and/or the second emissive regions can have the various device characteristics as described above for the pixelated device. In some embodiments, the stacked OLED is configured to emit white color. In some embodiments, one or more of the emissive regions in a pixelated or in a stacked OLED comprises a sensitizer and an acceptor with the various sensitizing device characteristics and the various embodiments of the inventive compounds disclosed herein. For example, the first emissive region is comprised in a sensitizing device, while the second emissive region is not comprised in a sensitizing device; in some instances, both the first and the second emissive regions are comprised in sensitizing devices.

In some embodiments, the OLED can emit light having at least 1%, 5%, 10, 30%, 50%, 70%, 80%, 90%, 95%, 99%, or 100% from the plasmonic mode. In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. In some embodiments, the enhancement layer is provided no more than a threshold distance away from the organic emissive layer, wherein the emitter material has a total non-radiative decay rate constant and a total radiative decay rate constant due to the presence of the enhancement layer. A threshold distance is where the total non-radiative decay rate constant is equal to the total radiative decay rate constant. Another threshold distance is the distance at which the total radiative decay rate constant divided by the sum of the total non-radiative decay rate constant and total radiative decay rate constant is equal to the photoluminescent yield of the emissive material without the enhancement layer present.

In some embodiments, the OLED further comprises an outcoupling layer. In some embodiments, the outcoupling layer is disposed over the enhancement layer on a side opposite the organic emissive layer The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and a reduced efficiency roll-off of the OLED device. Placement of the enhancement layer on the cathode side, anode side, or on both sides, or the enhancement layer itself being as the CGL, results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

In some embodiments, the enhancement layer can be comprised of plasmonic materials, optically active metamaterials, or hyperbolic metamaterials. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, or Ca, alloys or mixtures of these materials, and stacks of these materials. In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly.

In some embodiments, the outcoupling layer has wavelength-sized or sub-wavelength sized features that are arranged periodically, quasi-periodically, or randomly. In some embodiments, the outcoupling layer may be composed of a plurality of nanoparticles. In some embodiments, the outcoupling layer is composed of a plurality of nanoparticles disposed over a material. In these embodiments the outcoupling layer may be tunable by at least one of: varying a size of the plurality of nanoparticles, varying a shape of the plurality of nanoparticles, changing a material of the plurality of nanoparticles, adjusting a thickness of the material, changing the refractive index of the material, adding an additional layer disposed on the plurality of nanoparticles, varying a thickness of the enhancement layer, or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting ofAg, Al, Au, Ir, Pt, Ni, Cu, W, Ta, Fe, Cr, Mg, Ga, Rh, Ti, Ru, Pd, In, Bi, and Ca, alloys or mixtures of these materials, and stacks of these materials. In some embodiments the outcoupling layer is formed by lithography.

In some embodiments of a plasmonic device, the emitter, and/or host compounds used in the emissive layer has a vertical dipole ratio (VDR) of 0.33 or more. In some such embodiments, the emitter, and/or host compounds have a VDR of 0.40, 0.50, 0.60, 0.70, or more.

In yet another aspect, the present disclosure also provides a consumer product comprising an organic light-emitting device (OLED) having an anode; a cathode; and an organic layer disposed between the anode and the cathode, wherein the organic layer may comprise a compound or a formulation of the compound as disclosed in the above compounds section of the present disclosure.

In some embodiments, the consumer product comprises an OLED having an anode; a cathode; and an organic layer disposed between the anode and the cathode, wherein the organic layer may comprise a compound having a first ligand L_{A} comprising a structure of Formula I as described herein.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, and an "exciton," which is a localized electron-hole pair having an excited energy state, is formed. Light is emitted when the exciton relaxes via a photoemissive mechanism. In some cases, the exciton may be localized as an excimer or an exciplex. Non-radiative mechanisms, such as thermal relaxation, may also occur, but are generally considered undesirable.

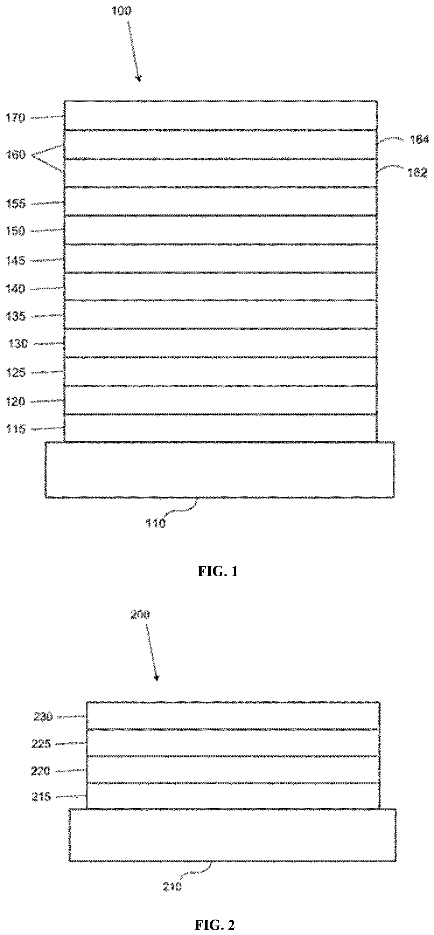

FIG. 1 shows an organic light emitting device 100. The figures are not necessarily drawn to scale. Device 100 may include a substrate 110, an anode 115, a hole injection layer (HIL) 120, a hole transport layer (HTL) 125, an electron blocking layer (EBL) 130, an emissive layer (EML) 135, a hole blocking layer (HBL) 140, an electron transport layer (ETL) 145, an electron injection layer (EIL) 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation, sputtering, chemical vapor deposition, atomic layer deposition, and electron beam deposition. Preferred patterning methods include deposition through a mask, photolithography, and cold welding such as described in U.S. Pat. Nos. 6,294,398 and 6,468,819, which are incorporated by reference in their entireties, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a plurality of alternative layers of polymeric material and non-polymeric material; organic material and inorganic material; or a mixture of a polymeric material and a non-polymeric material as one example described in U.S. Pat. No. 7,968,146, PCT Pat. Application Nos. PCT/US2007/023098 and PCT/US2009/042829, which are herein incorporated by reference in their entireties.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes. In some embodiments, the OLED further comprises one or more quantum dots. Such quantum dots can be in the emissive layer, or in other functional layers, such as a down conversion layer

In some embodiments, the OLED comprises a RGB pixel arrangement or white plus color filter pixel arrangement. In some embodiments, the OLED is a mobile device, a handheld device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

### D. Other Materials Used in the OLED

The materials described herein are as various examples useful for a particular layer in an OLED. They may also be used in combination with a wide variety of other materials present in the device. For example, emissive dopants disclosed herein may be used by themselves in the EML, or in conjunction with a wide variety of other emitters, hosts, transport layers, blocking layers, injection layers, electrodes and other layers that may be present. The materials described or referred to below are non-limiting examples of materials that may be useful in combination with the compounds and the devices disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer. In some embodiments, conductivity dopants comprises at least one chemical moiety selected from the group consisting of cyano, fluorinated aryl or heteroaryl, fluorinated alkyl or cycloalkyl, alkylene, heteroaryl, amide, benzodithiophene, and highly conjugated heteroaryl groups extended by non-ring double bonds.

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

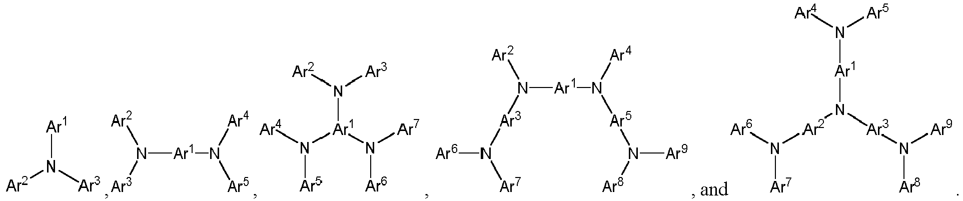

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each of Ar¹ to Ar⁹ may be unsubstituted or may be substituted by a general substituent as described above, any two substituents can be joined or fused into a ring.

In some embodiments, each Ar¹ to Ar⁹ independently comprises a moiety selected from the group consisting of: 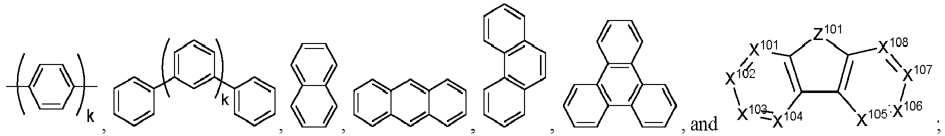 wherein k is an integer from 1 to 20; X¹⁰¹ to X¹⁰⁸ is C or N; Z¹⁰¹ is C, N, O, or S.

Examples of metal complexes used in HIL or HTL include, but are not limited to the following general formula: 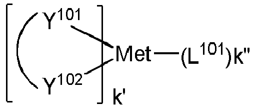 wherein Met is a metal, which can have an atomic weight greater than 40; (Y¹⁰¹-Y¹⁰²) is a bidentate ligand, the coordinating atoms of Y¹⁰¹ and Y¹⁰² are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In some embodiments, (Y¹⁰¹-Y¹⁰²) is a 2-phenylpyridine or 2-phenylimidazole derivative. In some embodiments, (Y¹⁰¹-Y¹⁰²) is a carbene ligand. In some embodiments, Met is selected from Ir, Pt, Pd, Os, Cu, and Zn. In some embodiments, the metal complex has a smallest oxidation potential in solution vs. Fc⁺/Fc couple less than about 0.6 V.

In some embodiments, the HIL/HTL material is selected from the group consisting of phthalocyanine and porphryin compounds, starburst triarylamines, CFₓ fluorohydrocarbon polymer, conducting polymers (e.g., PEDOT:PSS, polyaniline, polypthiophene), phosphonic acid and silane SAMs, triarylamine or polythiophene polymers with conductivity dopants, Organic compounds with conductive inorganic compounds (such as molybdenum and tungsten oxides), n-type semiconducting organic complexes, metal organometallic complexes, cross-linkable compounds, polythiophene based polymers and copolymers, triarylamines, triaylamine with spirofluorene core, arylamine carbazole compounds, triarylamine with (di)benzothiophene/(di)benzofuran, indolocarbazoles, isoindole compounds, and metal carbene complexes.

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than one or more emitters closest to the EBL interface. In some embodiments, the compound used in EBL contains at least one carbazole group and/or at least one arylamine group. In some embodiments the HOMO level of the compound used in the EBL is shallower than the HOMO level of one or more of the hosts in the EML. In some embodiments, the compound used in EBL contains the same molecule or the same functional groups used as one of the hosts described herein.

### d) Hosts:

The light emitting layer of the organic EL device of the present disclosure preferably contains at least a light emitting material as the dopant, and a host material. Examples of the host material are not particularly limited, and any metal complexes or organic compounds may be used as long as the host won't fully quench the emission of the dopant.

Examples of metal complexes used as host are preferred to have the following general formula: 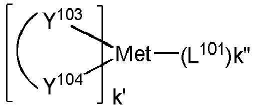 wherein Met is a metal; (Y¹⁰³-Y¹⁰⁴) is a bidentate ligand, the coordinating atoms of Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In some embodiments, the metal complexes are: 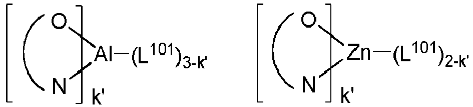 wherein (O-N) is a bidentate ligand, having metal coordinated to atoms O and N.

In some embodiments, Met is selected from Ir and Pt. In a further embodiments, (Y¹⁰³-Y¹⁰⁴) is a carbene ligand.

In some embodiments, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, aza-dibenzothiophene, aza-dibenzofuran, aza-dibenzoselenophene, aza-carbazole, aza-indolocarbazole, aza-triphenylene, aza-tetraphenylene, 5λ²-benzo[d]benzo[4,5]imidazo[3,2-a]imidazole, 5,9-dioxa-13b-boranaphtho[3,2,1-de]anthracene,; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by the general substituents as described herein or may be further fused.

In some embodiments, the host compound comprises at least one of the moieties selected from the group consisting of: 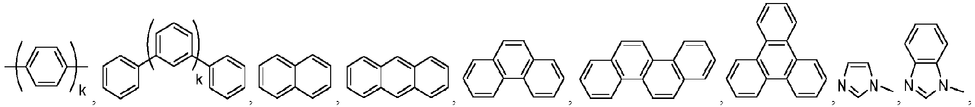 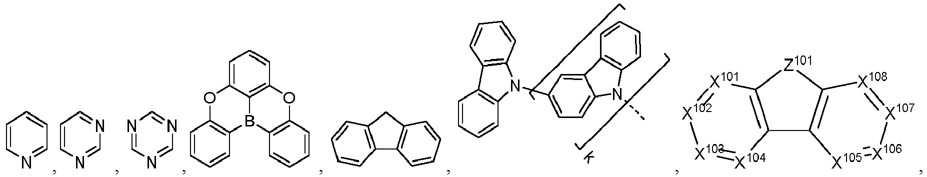 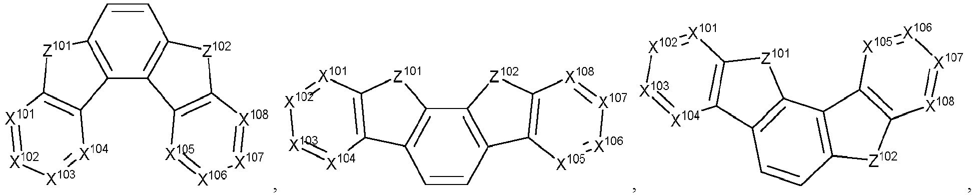 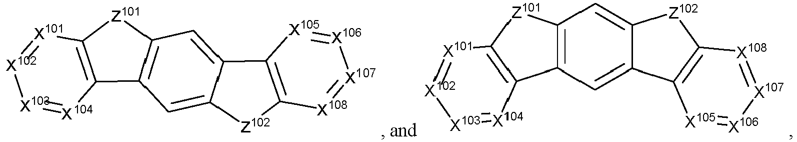 wherein k is an integer from 0 to 20 or 1 to 20. X¹⁰¹ to X¹⁰⁸ are independently selected from C or N. Z¹⁰¹ and Z¹⁰² are independently selected from C, N, O, or S.

In some embodiments, the host material is selected from the group consisting of arylcarbazoles, metal 8-hydroxyquinolates, (e.g., alq3, balq), metal phenoxybenzothiazole compounds, conjugated oligomers and polymers (e.g., polyfluorene), aromatic fused rings, zinc complexes, chrysene based compounds, aryltriphenylene compounds, poly-fused heteroaryl compounds, donor acceptor type molecules, dibenzofuran/dibenzothiophene compounds, polymers (e.g., pvk), spiro fluorene compounds, spiro fluorene-carbazole compounds, indolocabazoles, 5-member ring electron deficient heterocycles (e.g., triazole, oxadiazole), tetraphenylene complexes, metal phenoxypyridine compounds, metal coordination complexes (e.g., Zn, Al with N^N ligands), dibenzothiophene/dibenzofuran-carbazole compounds, silicon/germanium aryl compounds, aryl benzoyl esters, carbazole linked by non-conjugated groups, aza-carbazole/dibenzofuran/dibenzothiophene compounds, and high triplet metal organometallic complexes (e.g., metal-carbene complexes).

### e) Emitter Materials in EML:

One or more emitter materials may be used in conjunction with the compound or device of the present disclosure. The emitter material can be emissive or non-emissive in the current device as described herein. Examples of the emitter materials are not particularly limited, and any compounds may be used as long as the compounds are capable of producing emissions in a regular OLED device. Examples of suitable emitter materials include, but are not limited to, compounds which are capable of producing emissions via phosphorescence, non-delayed fluorescence, delayed fluorescence, especially the thermally activated delayed fluorescence, i.e., TADF (also referred to as E-type delayed fluorescence), triplet-triplet annihilation, or combinations of these processes.

In some embodiments, the emitter material has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of LIGAND LIST: 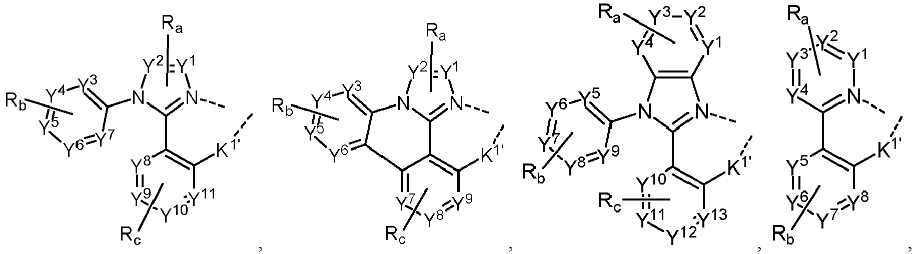 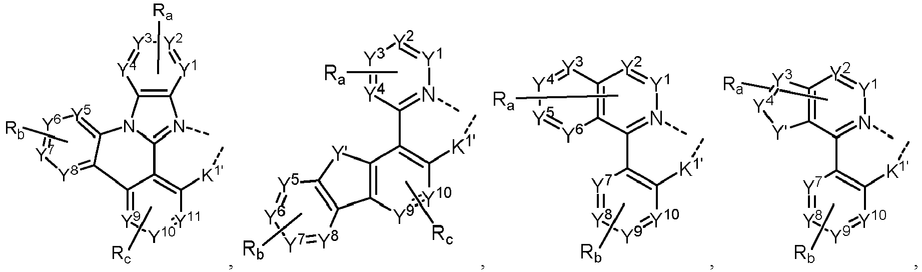 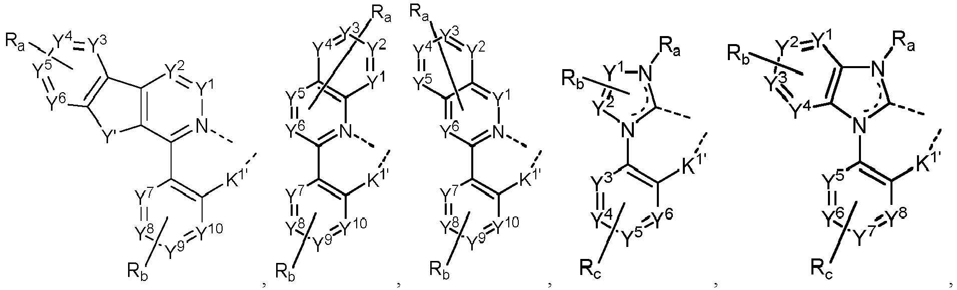 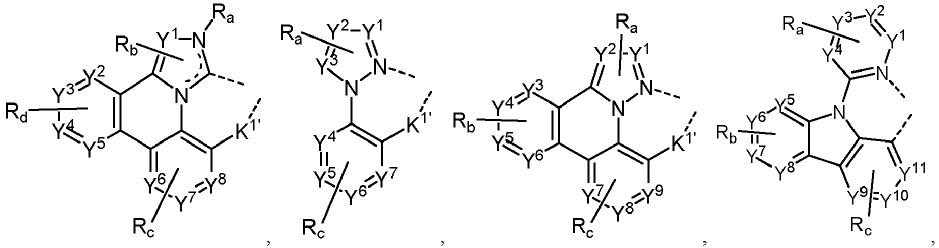 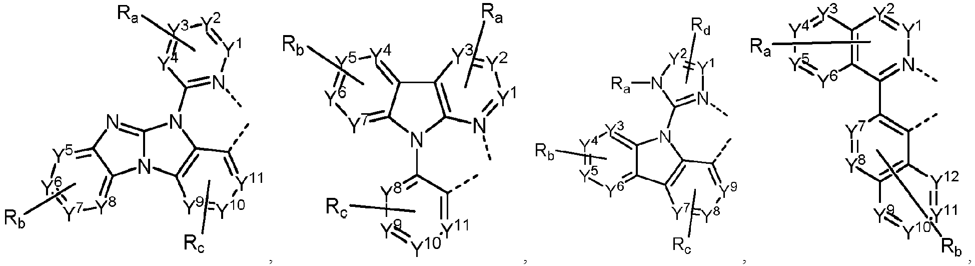 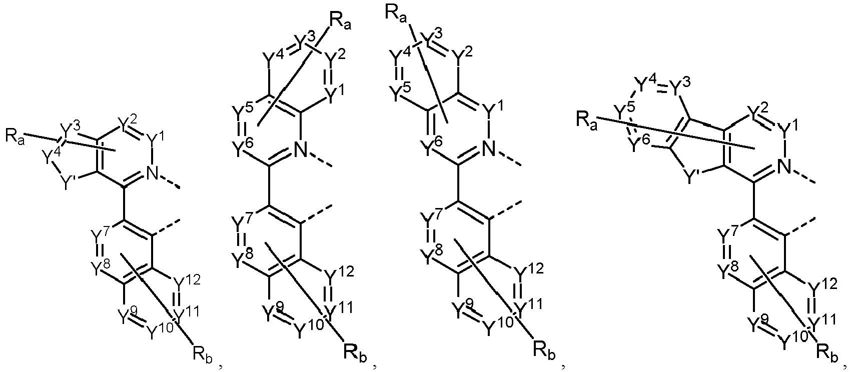 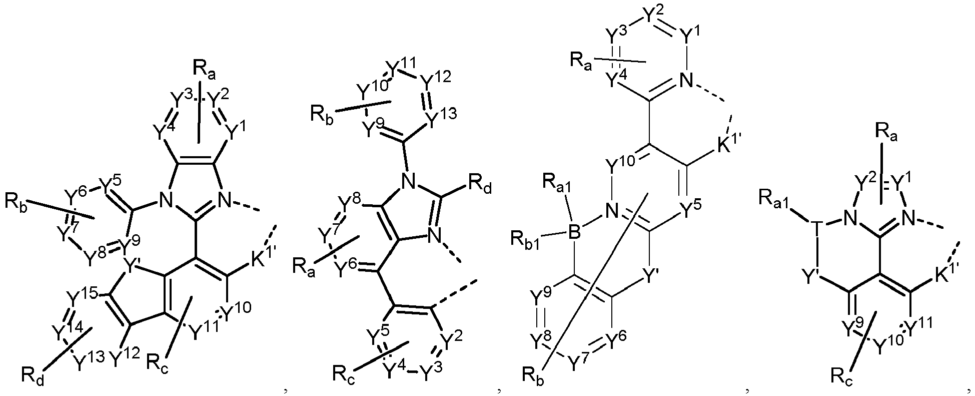 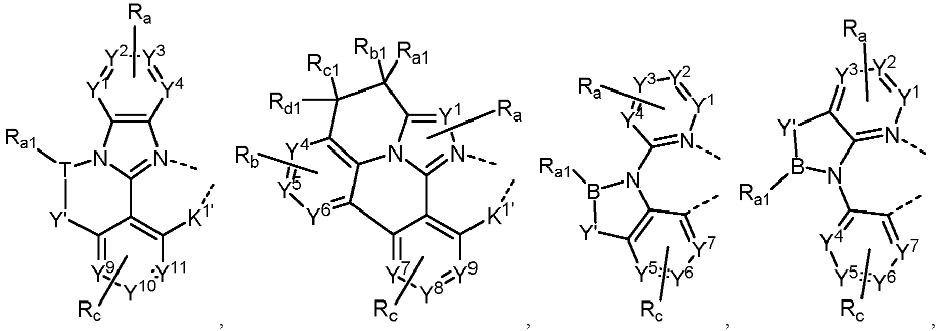 and

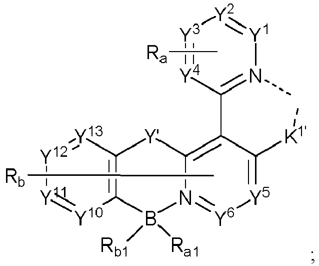

wherein each L² and L³ are independently selected from the group consisting of 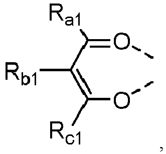 and the structures of LIGAND LIST;
wherein:
   M is selected from the group consisting of Ir, Rh, Re, Ru, Os, Pt, Pd, Zn, Au, Ag, and Cu;
   T is selected from the group consisting of B, Al, Ga, and In;
   K^{1'} is a direct bond or is selected from the group consisting of NRₑ, PRₑ, O, S, and Se;
   each Y¹ to Y¹⁵ are independently selected from the group consisting of carbon and nitrogen;
   Y' is selected from the group consisting of BRₑ, NRₑ, PRₑ, O, S, Se, C=O, S=O, SO₂, CRₑR_{f}, SiRₑR_{f}, and GeRₑR_{f'},
   each Rₐ, R_{b}, R_{c}, and R_{d} can independently represent from mono to the maximum possible number of substitutions, or no substitution;
   each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the general substituents as defined herein; and
wherein any two substituents can be fused or joined to form a ring or form a multidentate ligand.

In some embodiments, the emitter material is selected from the group consisting of the following Dopant Group 1: 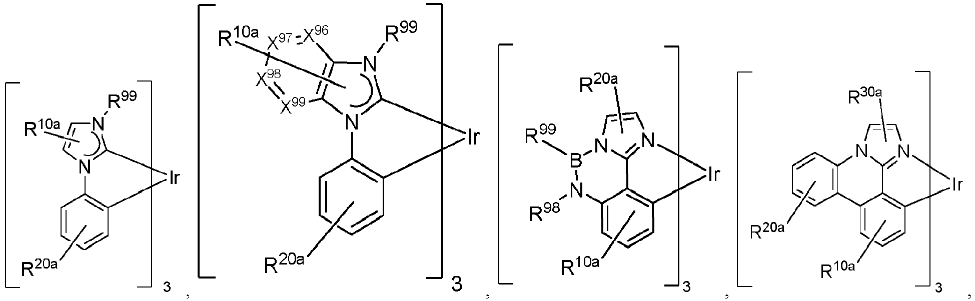 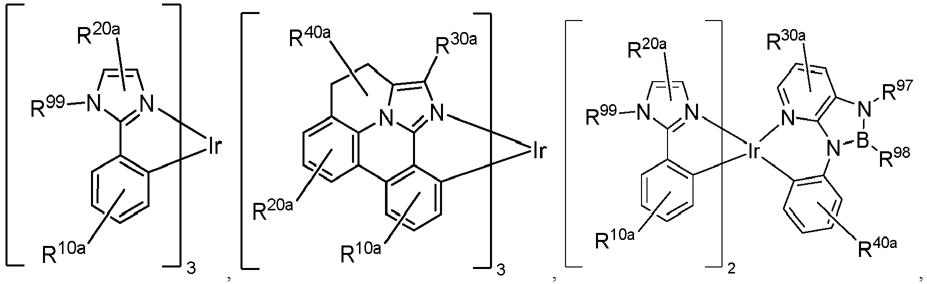 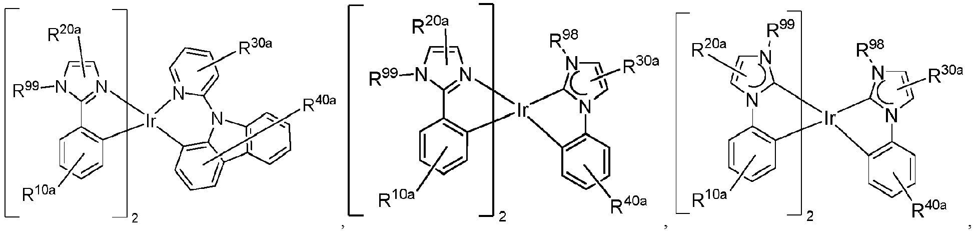 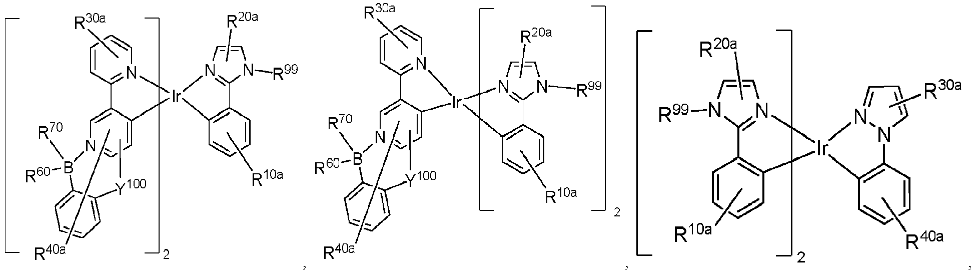 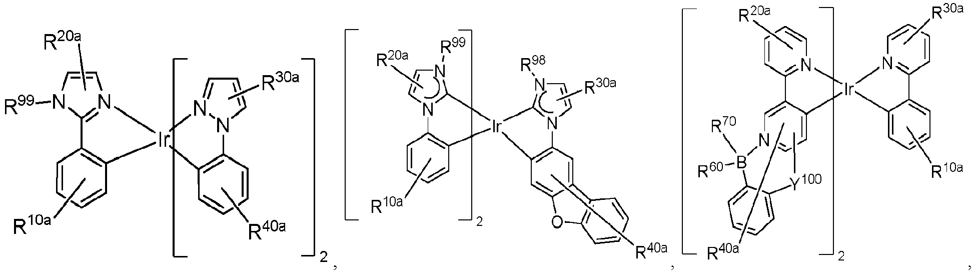 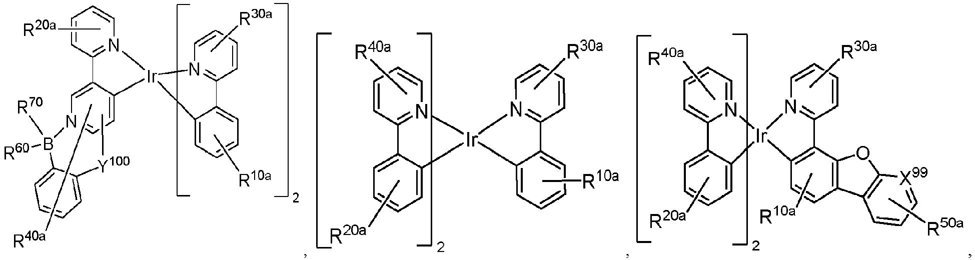 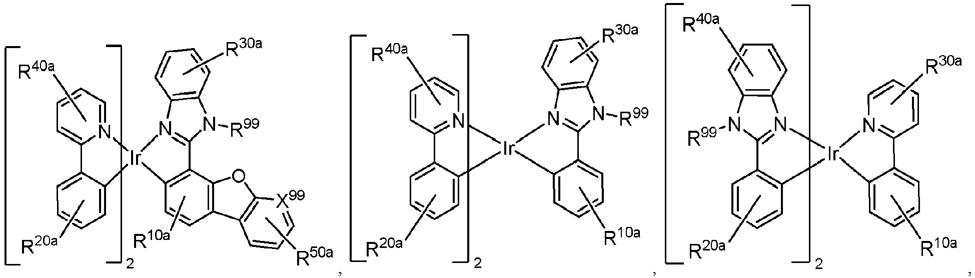 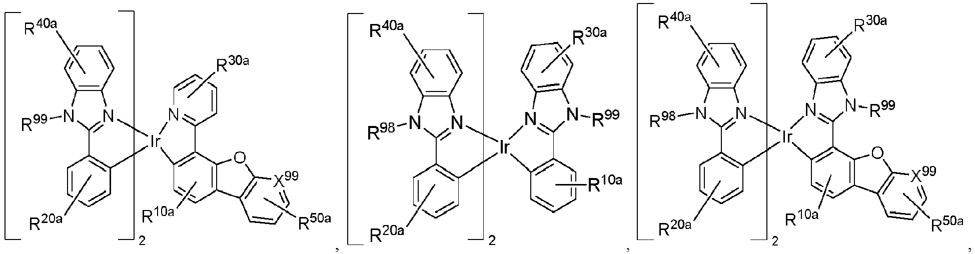 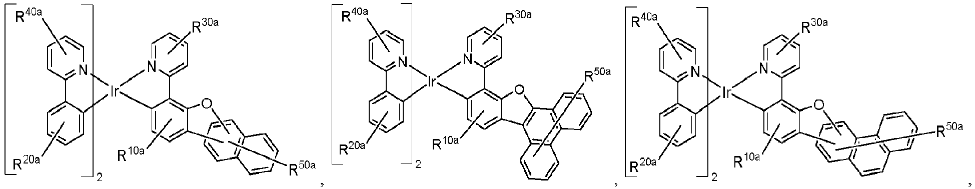 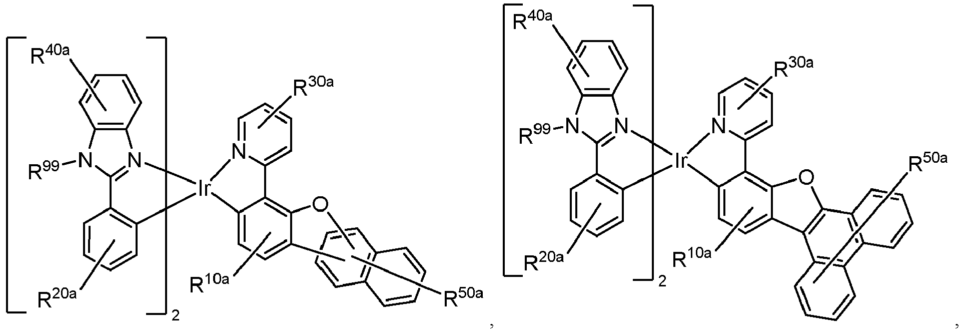 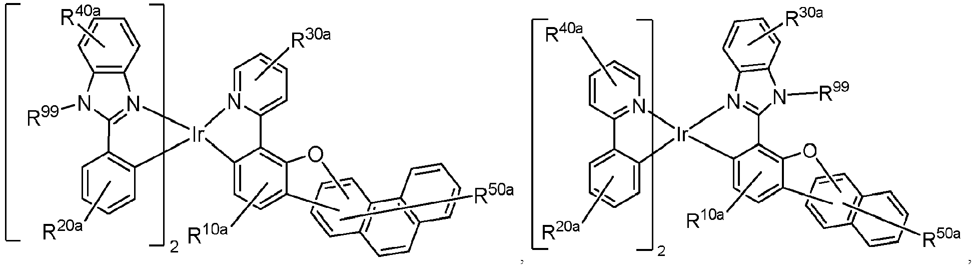 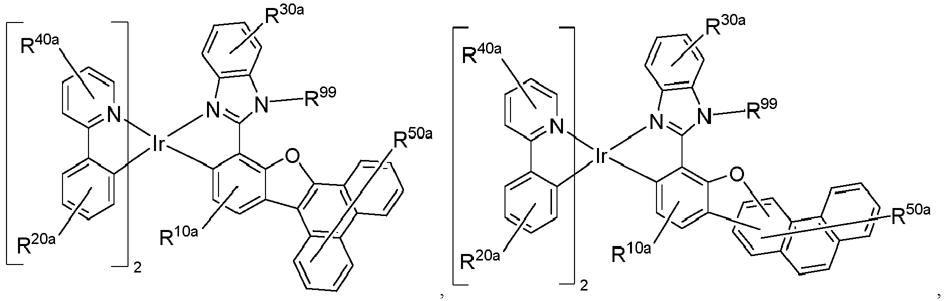 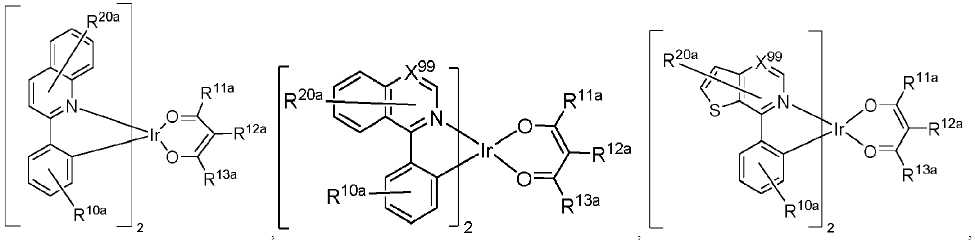 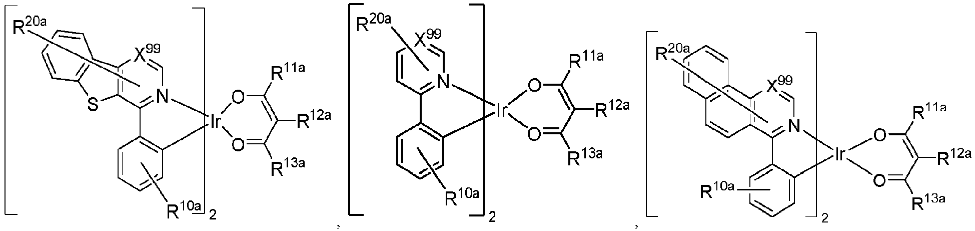 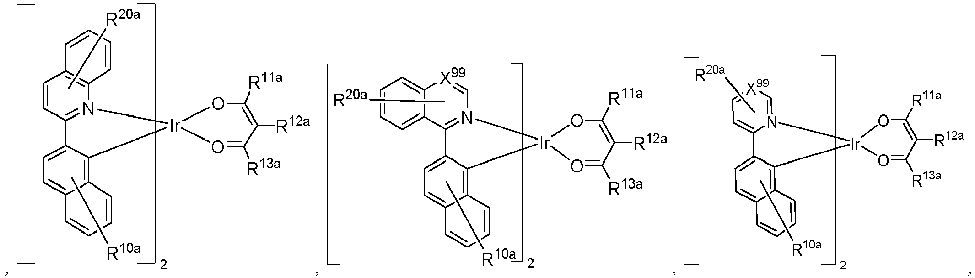 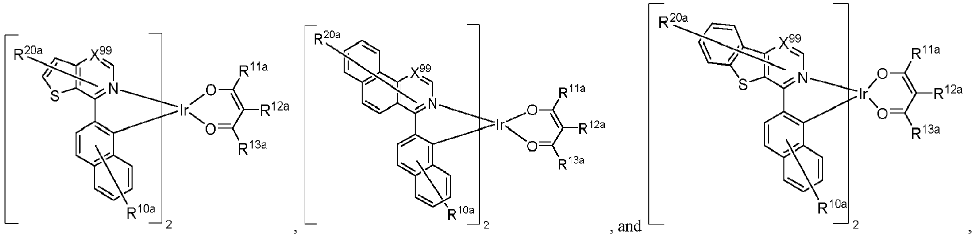
wherein
   each of X⁹⁶ to X⁹⁹ is independently C or N;
   each Y¹⁰⁰ is independently selected from the group consisting of a NR", O, S, and Se;
   each of R^{10a}, R^{20a}, R^{30a}, R^{40a}, and R^{50a} independently represents mono substitution, up to the maximum substitutions, or no substitution;
   each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of the general substituents as defined herein; any two substituents can be joined or fused to form a ring.

In some embodiments, the emitter material is selected from the group consisting of the following Dopant Group 2: 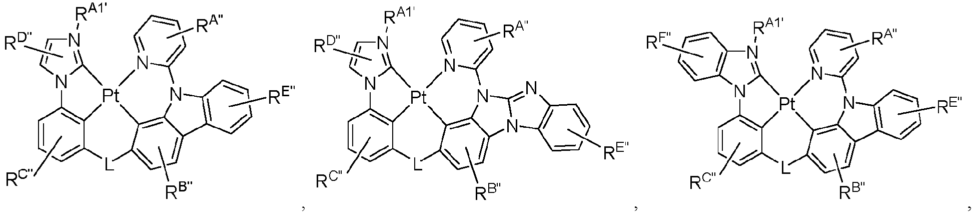 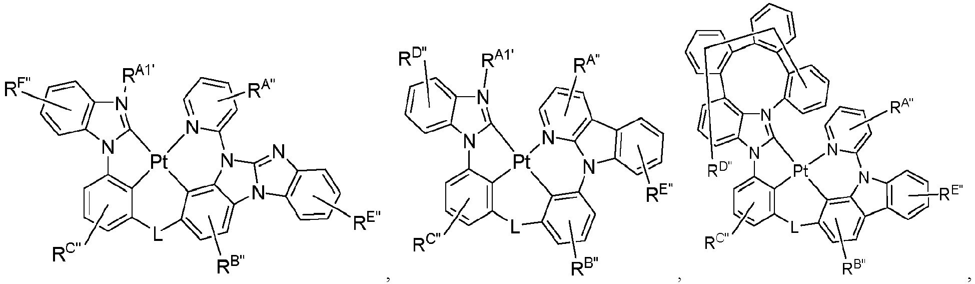 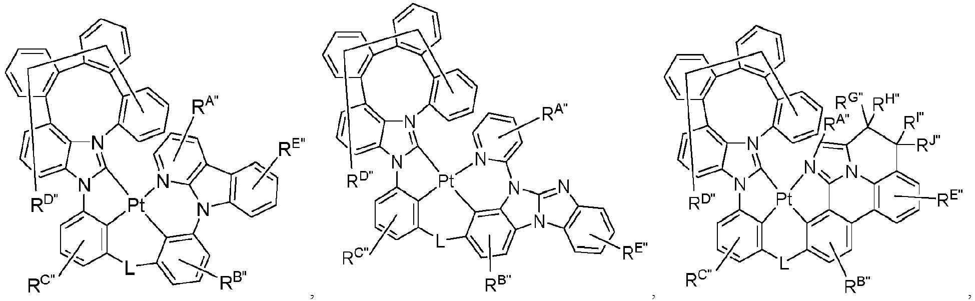 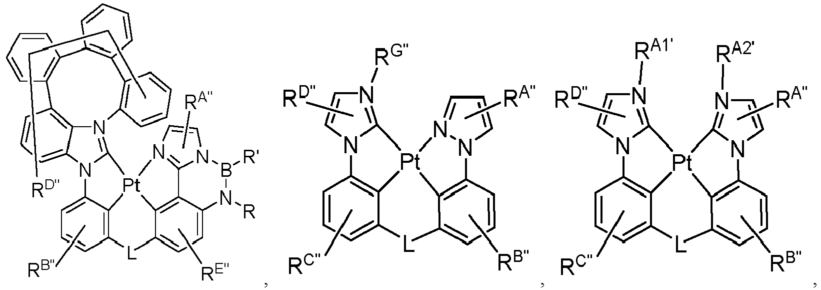 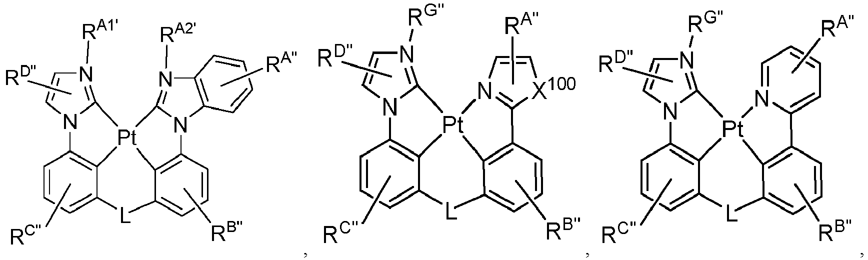 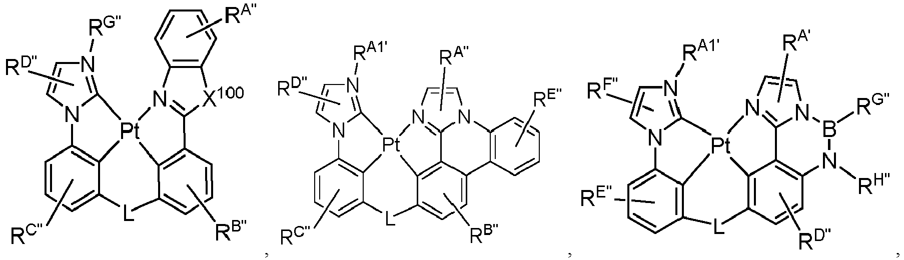 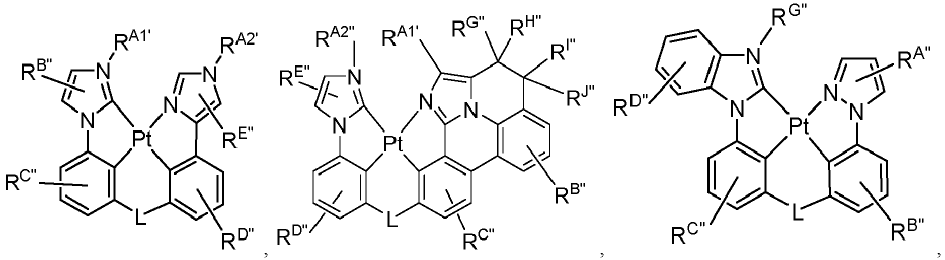 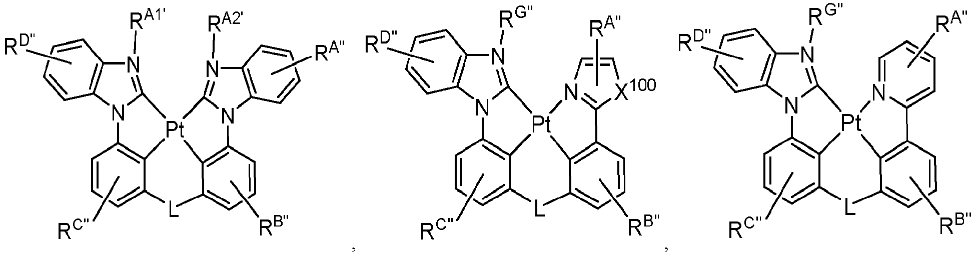 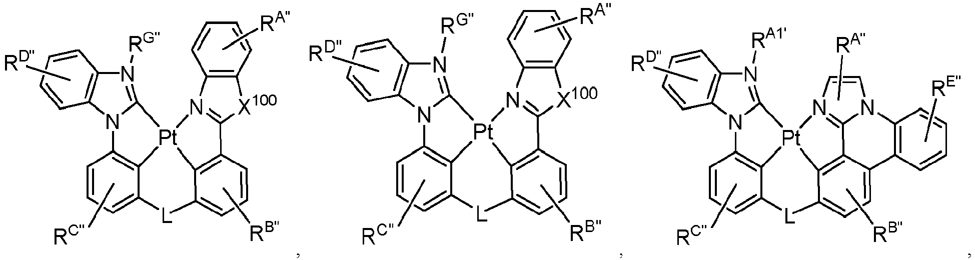 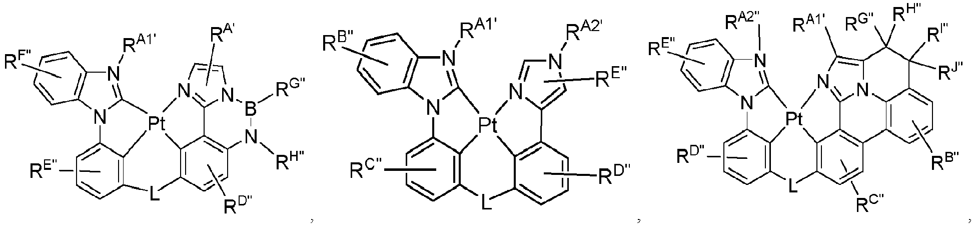 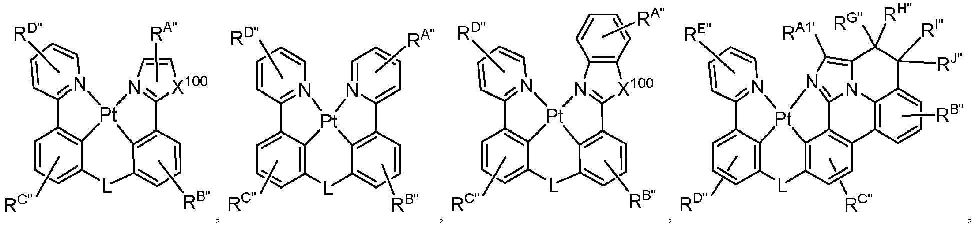 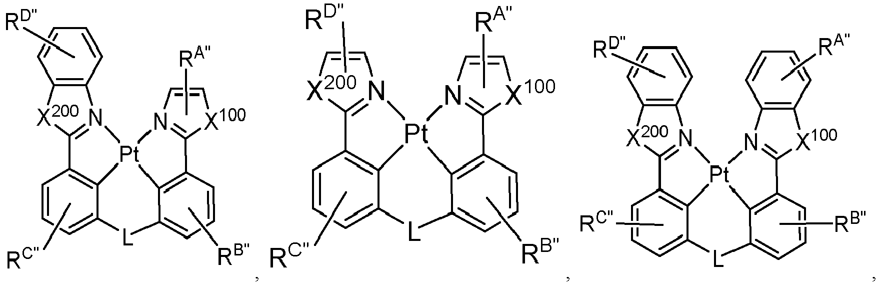 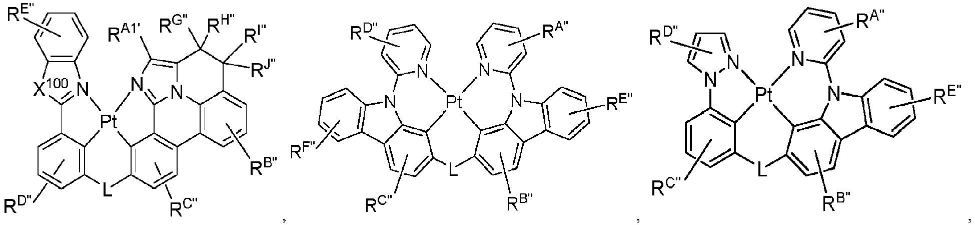 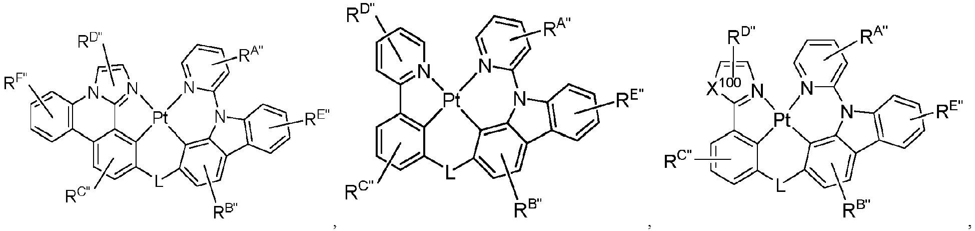 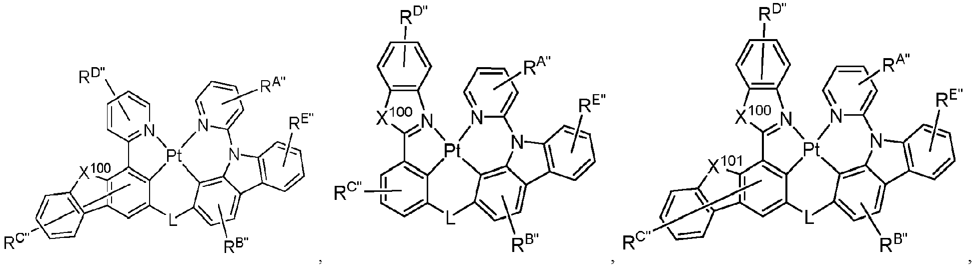 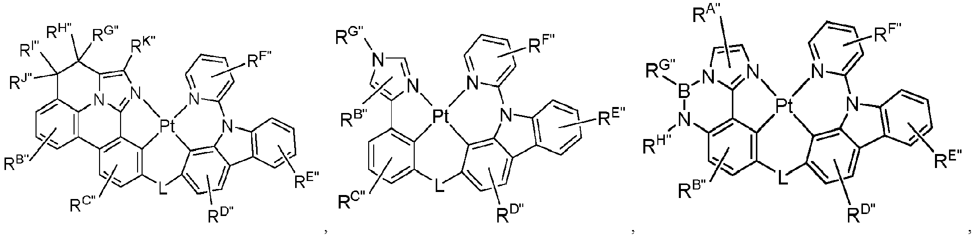 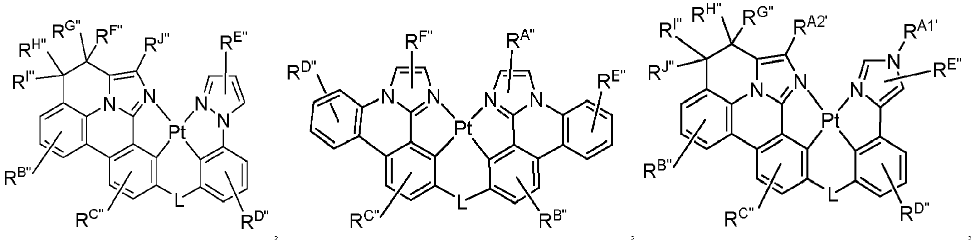 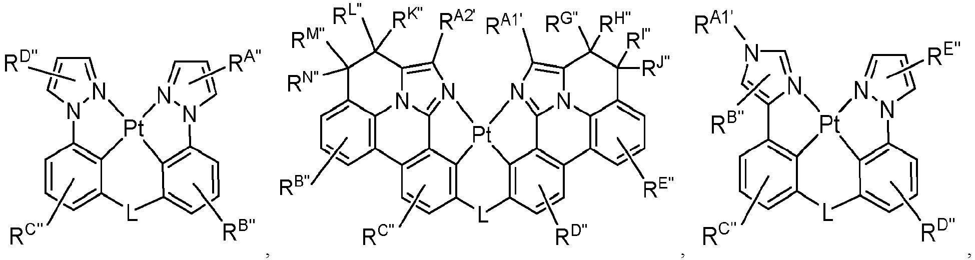 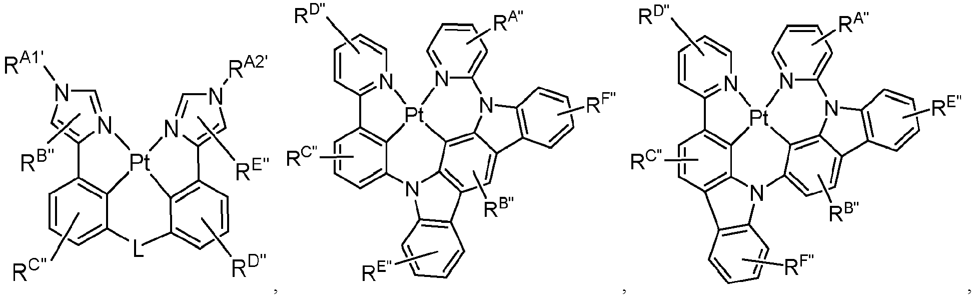 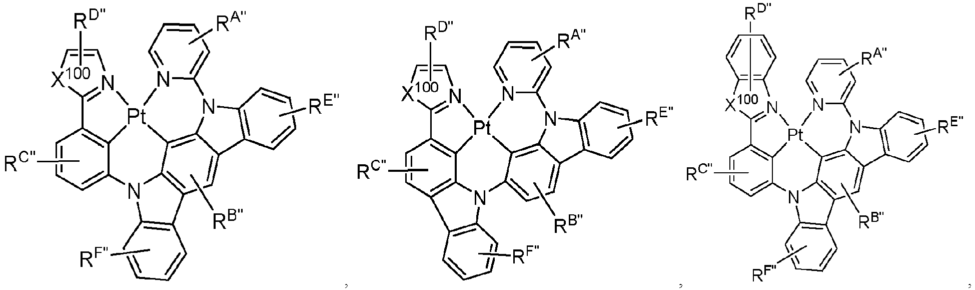 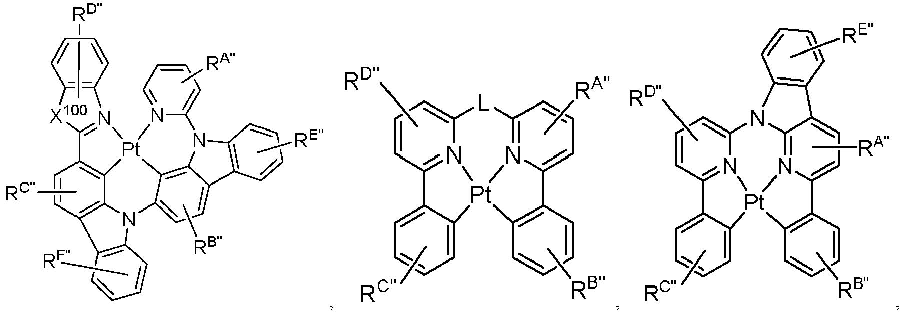 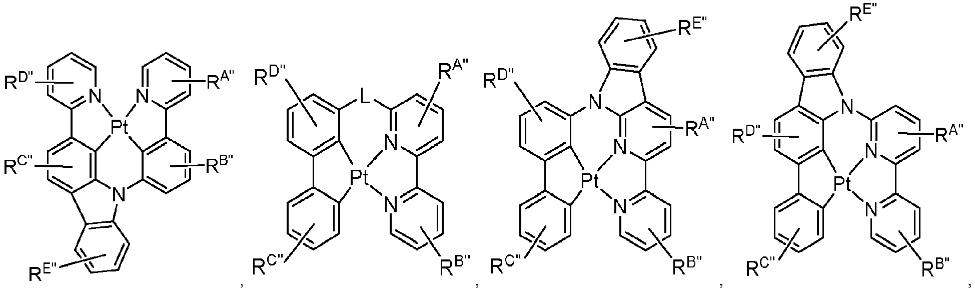 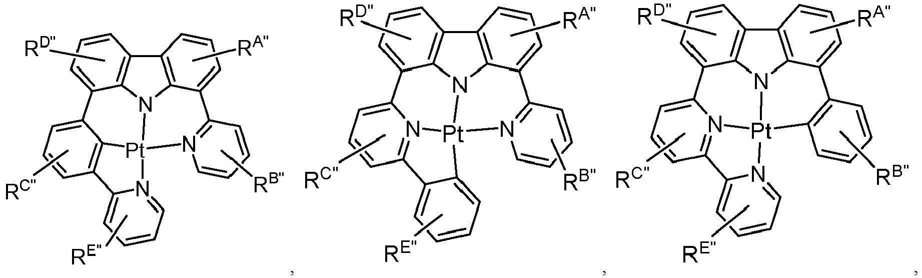 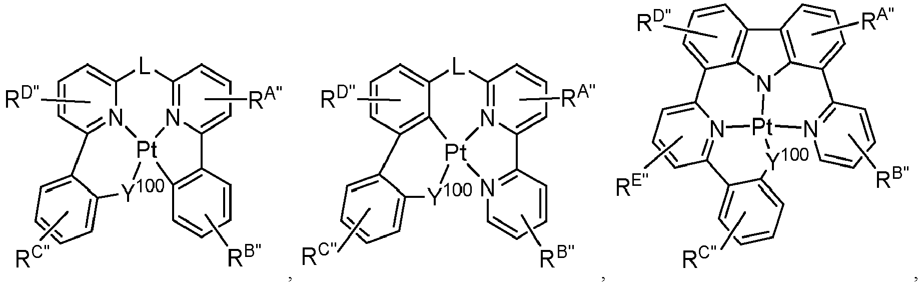 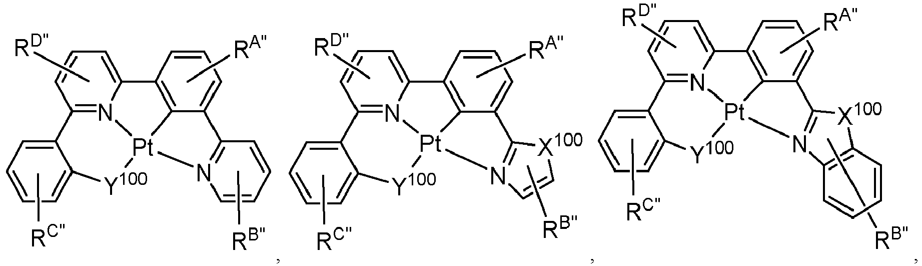 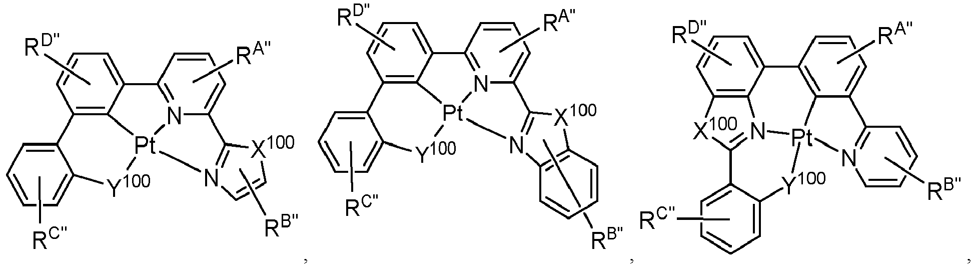 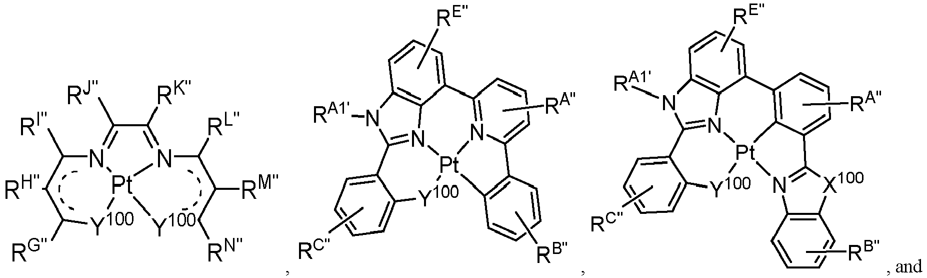 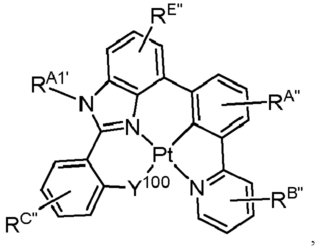
wherein:
   each Y¹⁰⁰ is independently selected from the group consisting of a NR", O, S, and Se;
   L is independently selected from the group consisting of a direct bond, BR", BR"R"', NR", PR", O, S, Se, C=O, C=S, C=Se, C=NR", C=CR"R"', S=O, SO₂, CR", CR"R"', SiR"R"', GeR"R"', alkyl, cycloalkyl, aryl, heteroaryl, and combinations thereof;
   X¹⁰⁰ and X²⁰⁰ for each occurrence is selected from the group consisting of O, S, Se, NR", and CR"R‴;
   each R^{A"}, R^{B"}, R^{C"}, R^{D"}, R^{E"}, and R^{F"} independently represents mono-, up to the maximum substitutions, or no substitutions,
each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of the general substituents as defined herein; any two substituents can be joined or fused to form a ring;

In some embodiments of the above Dopant Groups 1 and 2, each unsubstituted aromatic carbon atom can be replaced with N to form an aza-ring. In some embodiments, the maximum number of N atom in one ring is 1 or 2. In some embodiments of the above Dopant Groups 2, Pt atom in each formula can be replaced by Pd atom.

In some embodiments of the OLED, the delayed fluorescence material comprises at least one donor group and at least one acceptor group. In some embodiments, the delayed fluorescence material is a metal complex. In some embodiments, the delayed fluorescence material is a non-metal complex. In some embodiments, the delayed fluorescence material is a Zn, Cu, Ag, or Au complex.

In some embodiments of the OLED, the delayed fluorescence material has the formula of M(L⁵)(L⁶), wherein M is Cu, Ag, or Au, L⁵ and L⁶ are different, and L⁵ and L⁶ are independently selected from the group consisting of: 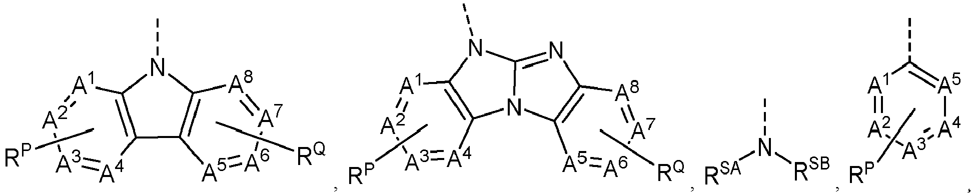 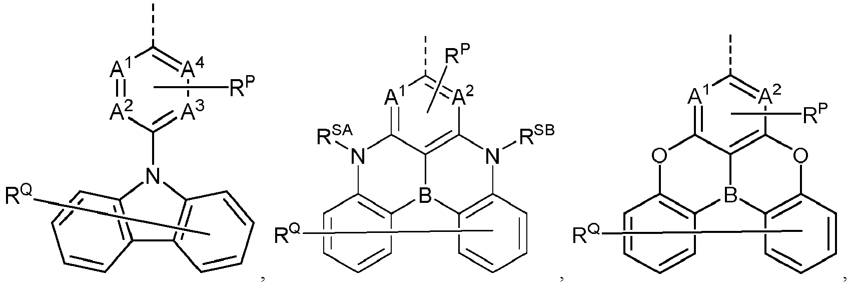 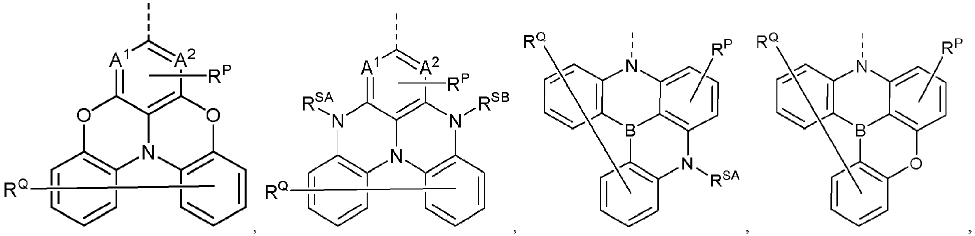 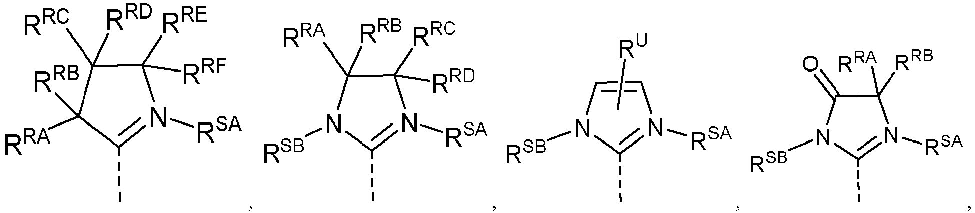 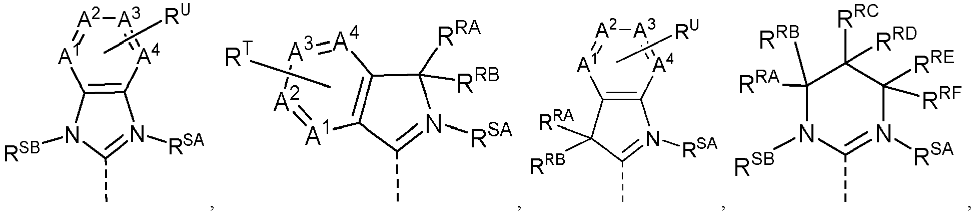 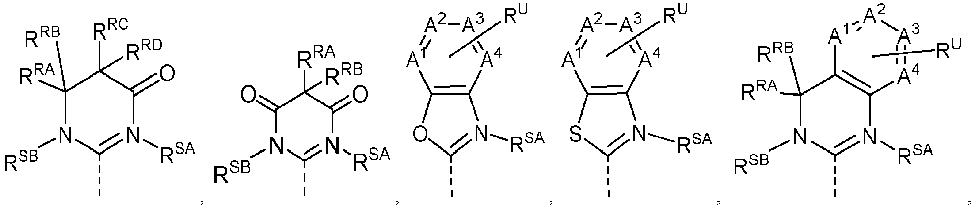 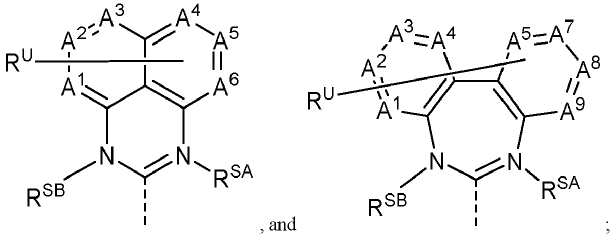
wherein A¹ - A⁹ are each independently selected from C or N;
each R^{P}, R^{Q}, and R^{U} independently represents mono-, up to the maximum substitutions, or no substitutions;
wherein each R^{P}, R^{P}, R^{U}, R^{SA}, R^{SB}, R^{RA}, R^{RB}, R^{RC}, R^{RD}, R^{RE}, and R^{RF} is independently a hydrogen or a substituent selected from the group consisting of the general substituents as defined herein; any two substituents can be joined or fused to form a ring.

In some embodiments of the OLED, the delayed fluorescence material comprises at least one of the donor moieties selected from the group consisting of: 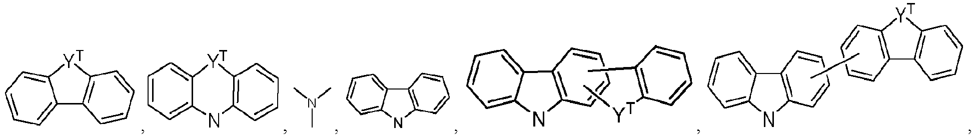 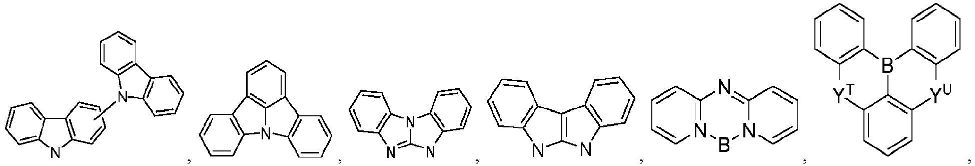 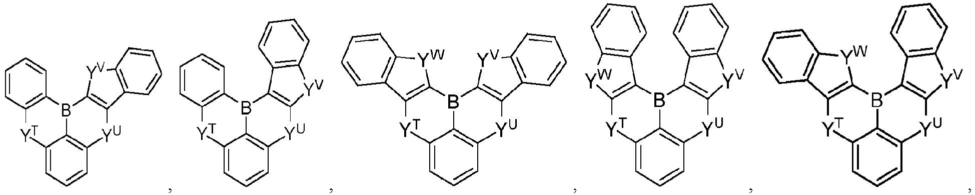 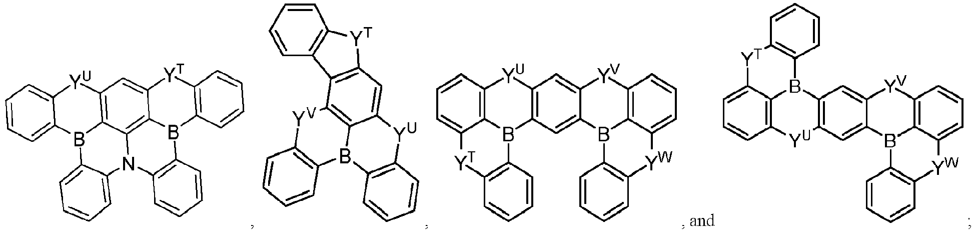 wherein Y^{T}, Y^{U}, Y^{V}, and Y^{W} are each independently selected from the group consisting of B, C, Si, Ge, N, P, O, S, Se, C=O, S=O, and SO₂.

In some of the above embodiments, any carbon ring atoms up to maximum of a total number of three, together with their substituents, in each phenyl ring of any of above structures can be replaced with N.

In some embodiments, the delayed fluorescence material comprises at least one of the acceptor moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole. In some embodiments, the acceptor moieties and the donor moieties as described herein can be connected directly, through a conjugated linker, or a non-conjugated linker, such as a sp³ carbon or silicon atom.

In some embodiments, the fluorescent material comprises at least one of the chemical moieties selected from the group consisting of: 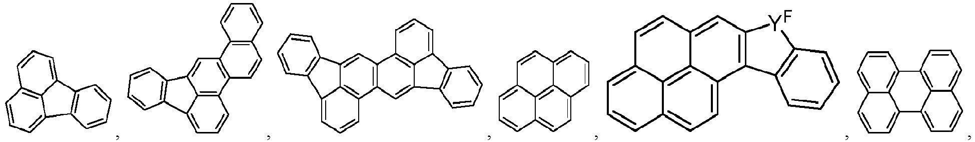 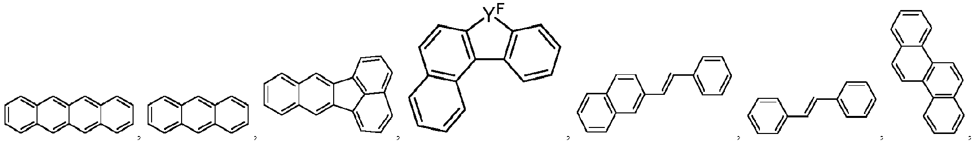 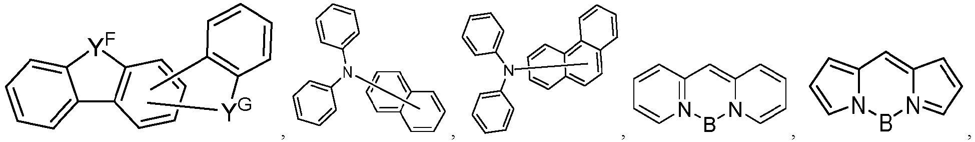 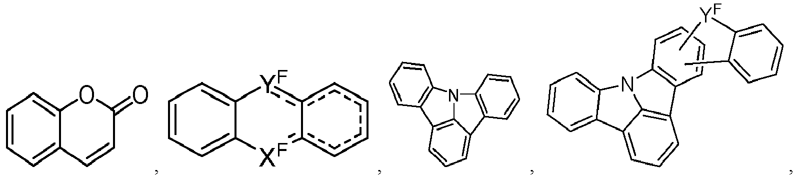 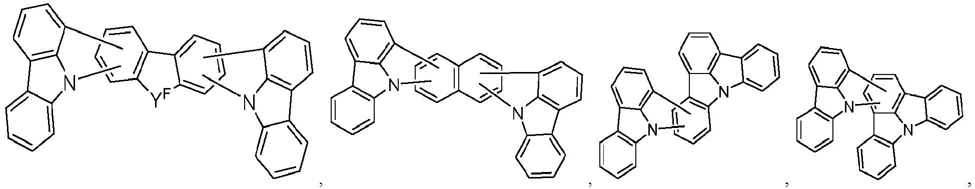 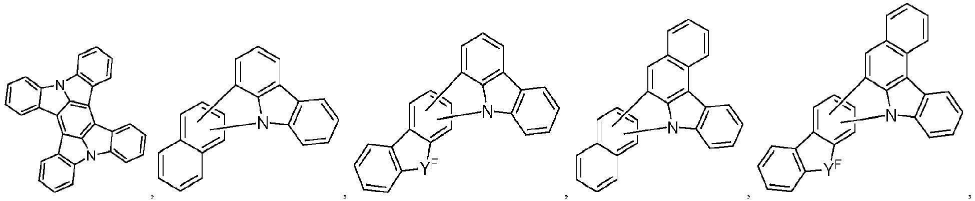 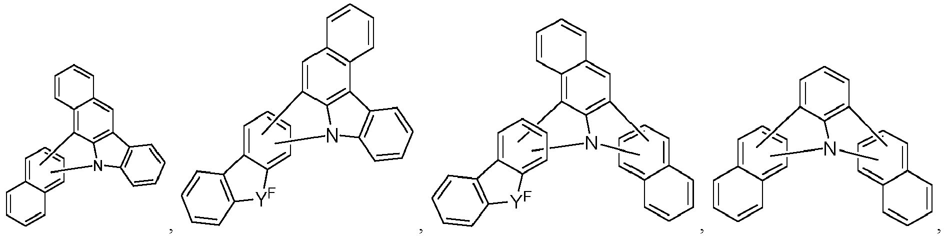 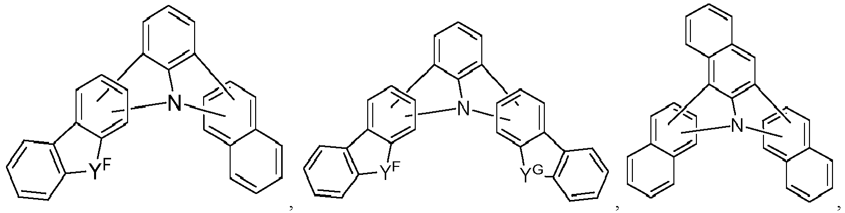 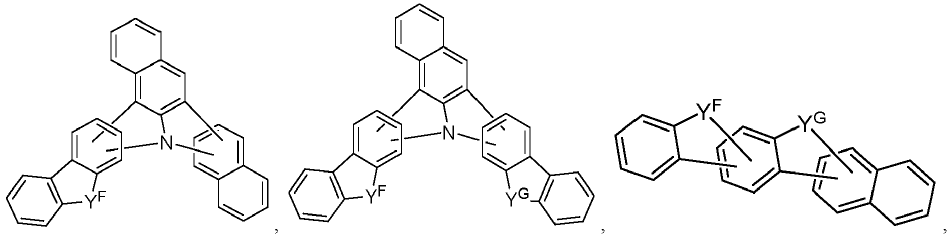 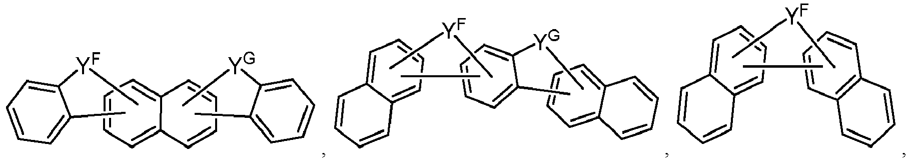 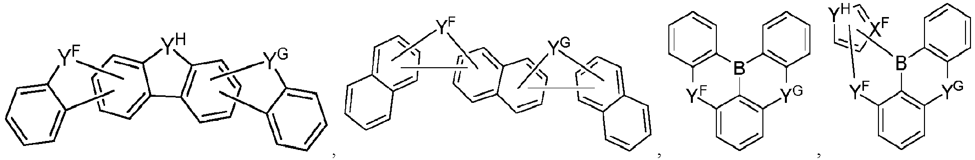 and 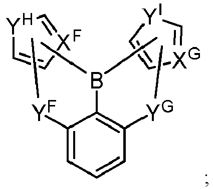 wherein Y^{F}, Y^{G}, Y^{H}, and Y¹ are each independently selected from the group consisting of B, C, Si, Ge, N, P, O, S, Se, C=O, S=O, and SO₂; wherein X^{F} and X^{G} are each independently selected from the group consisting of C and N.

In some of the above embodiments, any carbon ring atoms up to maximum of a total number of three, together with their substituents, in each phenyl ring of any of above structures can be replaced with N.

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further away from the vacuum level) and/or higher triplet energy than one or more of the emitters closest to the HBL interface.

In some embodiments, compound used in HBL contains the same molecule or the same functional groups used as host described above.

In some embodiments, compound used in HBL comprises at least one of the following moieties selected from the group consisting of: 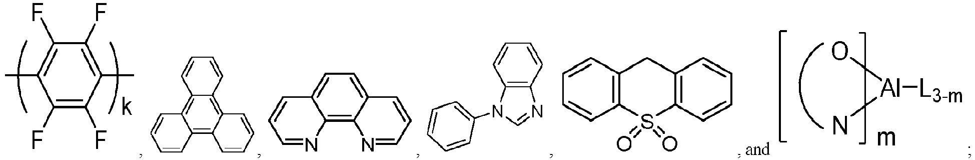 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped) or doped. Doping may be used to enhance conductivity. Examples of the ETL material are not particularly limited, and any metal complexes or organic compounds may be used as long as they are typically used to transport electrons.

In some embodiments, compound used in ETL comprises at least one of the following moieties in the molecule: 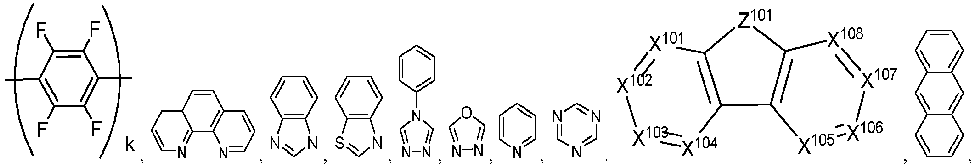 and fullerenes; wherein k is an integer from 1 to 20, X¹⁰¹ to X¹⁰⁸ is selected from C or N; Z¹⁰¹ is selected from the group consisting of C, N, O, and S.

In some embodiments, the metal complexes used in ETL contains, but not limit to the following general formula: 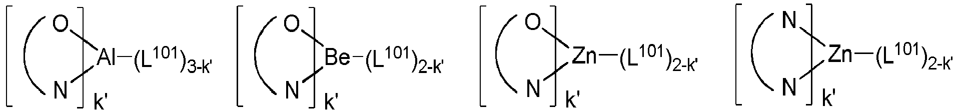 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

In some embodiments, the ETL material is selected from the group consisting of anthracene-benzoimidazole compounds, aza triphenylene derivatives, anthracene-benzothiazole compounds, metal 8-hydroxyquinolates, metal hydroxybenoquinolates, bathocuprine compounds, 5-member ring electron deficient heterocycles (e.g., triazole, oxadiazole, imidazole, benzoimidazole), silole compounds, arylborane compounds, fluorinated aromatic compounds, fullerene (e.g., C60), triazine complexes, and Zn (N^N) complexes.

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any compounds disclosed herein, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. As used herein, percent deuteration has its ordinary meaning and includes the percent of all possible hydrogen and deuterium atoms that are replaced by deuterium atoms. In some embodiments, the deuterium atoms are attached to an aromatic ring. In some embodiments, the deuterium atoms are attached to a saturated carbon atom, such as an alkyl or cycloalkyl carbon atom. In some other embodiments, the deuterium atoms are attached to a heteroatom, such as Si, or Ge atom.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

### Experimental Data

### Synthesis of Materials

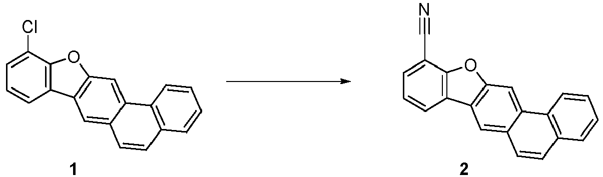

### Synthesis of phenanthro[3,2-b]benzofuran-ll-carbonitrile (2)

In a 1 L 3 neck round bottom flask (RBF) equipped with an air-condenser, 11-chlorophenanthro[3,2-b]benzofuran (1) (10.00 g, 33.03 mmol), potassium hexacyanoferrate(II) trihydrate (27.90 g, 66.06 mmol), potassium acetate (6.483 g, 66.06 mmol), 2-(dicyclohexylphosphanyl)-2',4',6'-tris(isopropyl)biphenyl (Xphos) (2.362 g, 4.95 mmol), Xphos-Pd-G2 (1 g, 1.18 mmol) were dissolved in 1,4-dioxane (400 mL) and water (150 mL) and degassed with nitrogen for 15 minutes. The resulting slurry was stirred at 115 °C for 48 hours. The resulting mixture was allowed to cool down to room temperature, filtered off through Celite (diatomaceous earth), then the dioxane layer was removed under vacuum and the resulting aqueous layer was extracted from DCM (1 L) and Chloroform (2 L). This was added to the solid layer settled on the celite pad, and both were concentrated, dried under high vacuum pump for overnight to afford 2 (10.50 g, 33 mmol, 100 %), as beige solid.

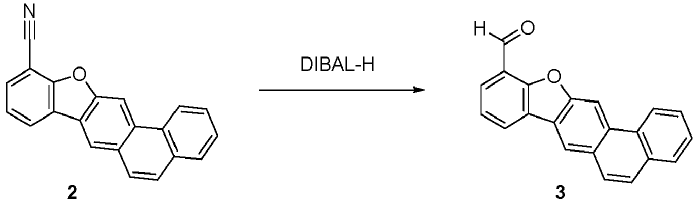

### Synthesis of phenanthro[3,2-b]benzofuran-ll-carbaldehyde (3)

Phenanthro[3,2-b]benzofuran-11-carbonitrile (10.50 g, 1.0 Eq, 35.80 mmol) was dissolved in dry DCM (700 mL) under nitrogen in a 2L 3 neck RB flask. The resulting mixture was cooled down to 0 °C, purged with nitrogen for 15 min, and then DIBAL-H (6.618 g, 46.53 mL, 1.0 M, 1.3 Eq, 46.53 mmol) was added in one portion via a syringe. The reaction was allowed to stir at 0 °C for 3 hours. The reaction turned to cloudy white suspension. The reaction was diluted with DCM (200 mL) and THF (100 mL). The reaction was quenched by adding 2 mL of water, 5 mL of 10% NaOH and 2 mL of water with stirring to finally allow to stir at room temperature for 1 hour. Then the reaction mixture was concentrated to half volume, around 500 mL, then 200 mL of water and 40 mL of 10% NaOH solution were added and stirred for additional 1 hour at room temperature. The resulting white precipitate was filtered, washed with water, methanol and diethyl ether, dried overnight under high vacuum pump at 42°C to afford (**3**) as a beige solid (11.00 g, 33 mmol, 93 %).

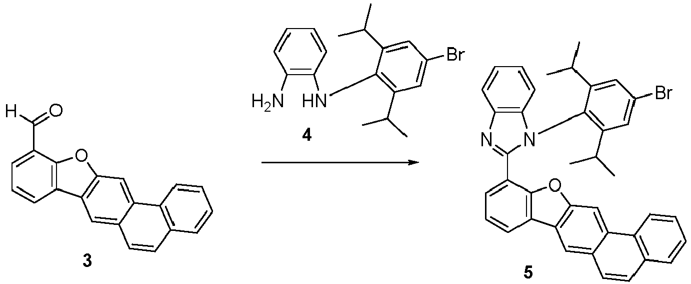

### Synthesis of 1-(4-bromo-2,6-diisopropylphenyl)-2-(phenanthro[3,2-b]benzofuran-11-yl)-1H-benzo[d]imidazole (5)

N1-(4-bromo-2,6-diisopropylphenyl)benzene-1,2-diamine (8.70 g, 25.05 mmol) (4), phenanthro[3,2-b]benzofuran-11-carbaldehyde (3) (9.9 g, 90% Wt, 30.06 mmol) and sodium bisulfite (6.0 g, 57.62 mmol) were dissolved in DMF (350 mL) in a 1L-RBF topped with an air condenser. The resulting mixture was allowed to stir at 130 °C for 38 hours. The crude mixture was cooled down to room temperature and 2/3 of the DMF was removed under vacuum. Then, the mixture was poured onto ice and the resulting solid was collected by filtration, washed with water and diethyl ether to afford 15 g of a pale brown solid. The solid was dissolved in DCM (700 mL) with a small portion of DMF (10 mL) to facilitate complete solvation and then mixture was washed with water (200 mL), dried over MgSO₄. The crude material was purified by silica gel chromatography, eluting with iso-hexane / DCM from 0% to 100% and then, DCM / THF at 5%. Fractions containing desired product were collected and solvents removed to afford a pale-brown solid (8.07 g, 12.59 mmol, 50% yield).

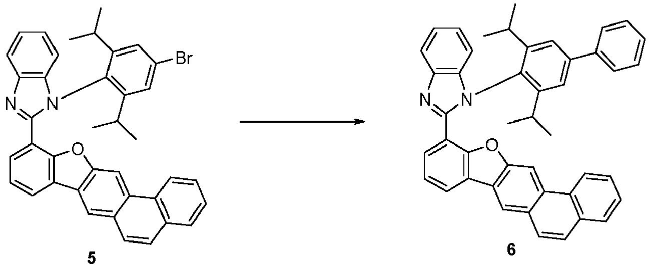

### Synthesis of 1-(3,5-diisopropyl-[1,1'-biphenyl]-4-yl)-2-(phenanthro[3,2-b]benzofuran-11-yl)-1H-benzo[d]imidazole (6)

To a 250 mL flask was added potassium carbonate (3.590 g, 1.521 mL, 2 Eq, 25.98 mmol), 1-(4-bromo-2,6-diisopropylphenyl)-2-(phenanthro[3,2-b]benzofuran-11-yl)-1H-benzo[d]imidazole (**5**) (8.100 g, 1 Eq, 12.99 mmol), and phenylboronic acid (1.901 g, 1.2 Eq, 15.59 mmol) in 1,4-Dioxane (130 mL) and Water (32 mL). The mixture was sparged for a few minutes before tetrakis(triphenylphosphine)palladium (1.201 g, 0.08 Eq, 1.039 mmol) was added. The mixture was heated to 88 °C for 18 hours. The reaction was filtered through Celite (20 g), rinsed with ethyl acetate (300 mL). The aqueous layer was removed, and the remaining organic layer was washed with brine (1 × 50 mL), dried with sodium sulfate, filtered, and concentrated to give a dark brown semi-solid. The crude material was purified by silica gel chromatography, eluting with 20-60% ethyl acetate in hexanes. Fractions containing desired product were collected and solvents removed to afford a pale-brown solid (6.50 g, 12.89 mmol, 81% yield).

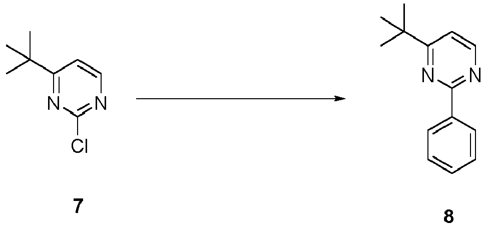

### Synthesis of 4-(tert-butyl)-2-phenylpyrimidine

4-(tert-butyl)-2-chloropyrimidine (**7**) (5.000 g, 1 Eq, 29.30 mmol) and phenylboronic acid (4.287 g, 1.2 Eq, 35.16 mmol) were charged into the reaction flask with 100mL of dioxane. potassium carbonate (14.17 g, 3.5 Eq, 102.6 mmol) was then dissolved in 25mL of water and charged into the reaction mixture. Tetrakis(triphenylphosphine)palladium(0) (1.354 g, .04 Eq, 1.172 mmol) was then added to the reaction mixture. This mixture was degassed with nitrogen and was stirred at 100 °C for 20 hours. The reaction mixture was diluted with water and extracted 3 × 100mL DCM. These extracts were dried over magnesium sulfate then filtered and concentrated under vacuum. The crude product was purified by silica gel chromatography to afford 4-(tert-butyl)-2-phenylpyrimidine (5.280 g, 24.87 mmol, 85%) as a liquid.

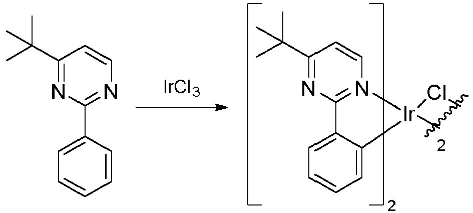

### Synthesis of di-µ-chloro-tetrakis[κ2(C2,N)-4-(tert-butyl)-2-(phenyl-2'-yl)pyrimidin-1-yl]diiridium(III)

A mixture of 4-(*tert*-butyl)-2-phenylpyrimidine (23.94 g, 112.8 mmol, 2.1 equiv) and iridium(III) chloride hydrate (17 g, 53.7 mmol, 1.0 equiv) in 2-ethoxyethanol (300 mL) and DIUF water (100 mL) was heated 91 hours at 103 °C. After cooling to room temperature, methanol (500 mL) was added, and the suspension filtered. The solid was washed with methanol (3 × 50 mL) then dried a few hours in a vacuum oven at ~50 °C to give di-*µ*-chloro-tetrakis[k2(C2,N)-4-(*tert*-butyl)-2-(phenyl-2'-yl)pyrimidin-1-yl]diiridium(III) (29.5 g, 85% yield) as a yellow solid

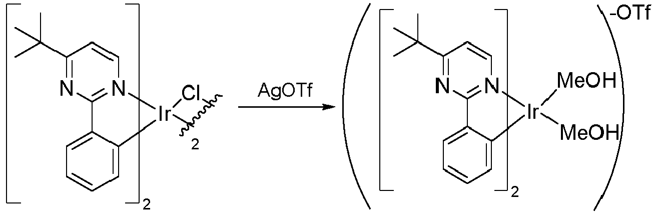

### Synthesis of [Ir(4-(tert-butyl)-(2-phenyl-2'-yl)pyrimidin-1-yl(-1H))₂(MeOH)₂] trifluoro-methanesulfonate

A solution of silver trifluoromethane- sulfonate (12.52 g, 48.72 mmol, 2.2 equiv) in methanol (90 mL) was added in one portion to a solution of di-*µ*-chloro-tetrakis[k2(C2,N)-4-(*tert*-butyl)-2-(phenyl-2'-yl)pyrimidin-1-yl]diiridium(III) (28.8 g, 22.14 mmol, 1.0 equiv) in dichloromethane (450 mL) and the flask wrapped with foil to exclude light. The reaction mixture was stirred overnight at room temperature under nitrogen. The reaction mixture was filtered through a short pad of silica gel (90 g), rinsing with 10% methanol in dichloromethane (3 × 100 mL). The filtrate was concentrated under reduced pressure and the residue dried overnight in a vacuum oven at 50 °C to give [Ir(4-(*tert*-butyl)-(2-phenyl-2'-yl)pyrimidin-1-yl(-1H))₂(MeOH)₂] trifluoromethanesulfonate (36 g, 98% yield) as a yellow solid.

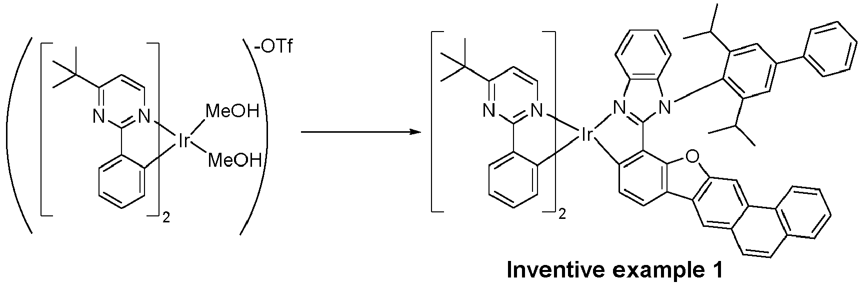

### Synthesis of Inventive Example 1

A 500 mL 4-neck flask equipped with stir bar, thermocouple, and condenser, was charged with [Ir(4-(*tert*-butyl)-(2-phenyl-2'-yl)pyrimidin-1-yl(-1H))₂(MeOH)₂] trifluoromethane-sulfonate (4.20 g, 5.50 mmol, 1.0 equiv), 1-(3,5-diisopropyl-[1,1'-biphenyl]-4-yl)-2-(phenanthro[3,2-b]benzofuran-11-yl)-1*H*-benzo[*d*]imidazole (3.58 g, 5.77 mmol, 1.05 equiv), a base (0.270 g, 2.75 mmol, 0.50 equiv), and 1-propanol (275 mL). The reaction mixture was sparged with nitrogen for several minutes then heated overnight at 97 °C. After cooling to room temperature, the reaction mixture was filtered, and the yellow-orange solid rinsed with methanol (20 mL). The crude material was purified on a silica gel chromatography system, eluting with a gradient of 0-30% dichloromethane in hexanes. Fractions containing product were concentrated under reduced pressure. The solid was dried 3 hours in a vacuum oven at 50 °C to give Inventive example (3.48 g, 51% yield) as a yellow solid.

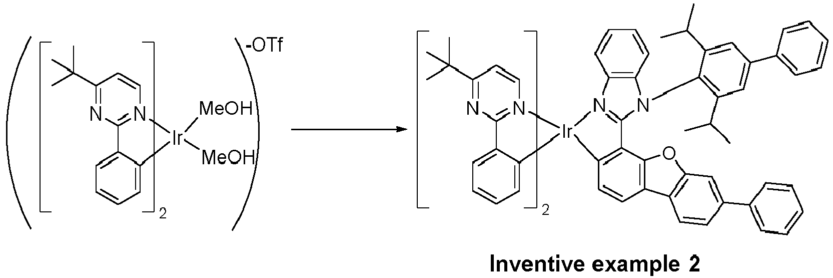

### Synthesis of Inventive Example 2: The Inventive example 2 was synthesized using the same procedure (0.6 g, 22% yield).

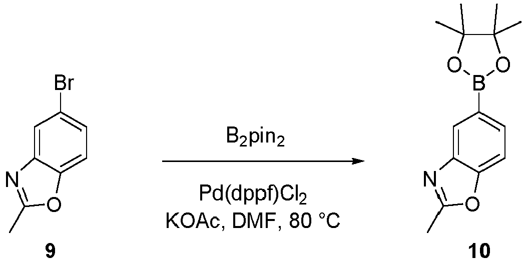

**Synthesis of 2-Methyl-5-(4,4,5,5-tetramethyl-1,3,2-dioxaborolan-2-yl)benzo[d]oxazole** (**10**)A mixture of 5-bromo-2-methylbenzo[d]oxazole (10.0 g, 1 eq, 47.16 mmol), bis(pinacolato)diboron (13.2 g, 1.1 eq, 51.87 mmol) and potassium acetate (13.9 g, 3.0 eq, 141.5 mmol) in DMF (140 mL) was degassed with N₂ for 30 minutes. Pd(dppf)Cl₂.DCM (2.00 g, 0.052 eq, 2.45 mmol) was added and mixture was heated to 100 °C for 24 hours. After cooling to room temperature, H2O (800 mL) was added, and the mixture extracted with EtOAc (3 × 300 mL). The combined organics were washed with brine, dried over Na2SO4, filtered, and concentrated. The crude product was purified by column chromatography (silica gel, 120 g cartridge, DCM dry load, 0-10% EtOAc/isohexane) to give 2-methyl-5-(4,4,5,5-tetramethyl-1,3,2-dioxaborolan-2-yl)benzo[d]oxazole (**10**) (7.75 g, 28 mmol, 60%) as a pale green liquid which solidified on standing.

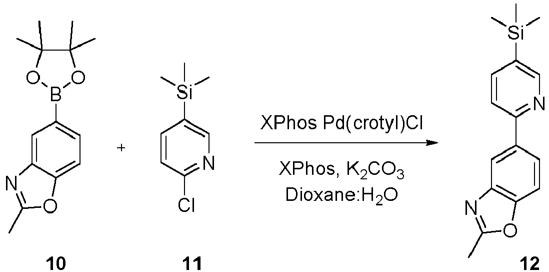

### Synthesis of 2-Methyl-5-(5-(trimethylsilyl)pyridin-2-yl)benzo[d]oxazole (TMS -BzOx ppy) (12)

A mixture of 2-chloro-5-(trimethylsilyl)pyridine (**11**) (4.20 g, 96% wt, 1 eq, 21.71 mmol), 2-methyl-5-(4,4,5,5-tetramethyl-1,3,2-dioxaborolan-2-yl)benzo[d]oxazole (**11**) (7.75 g, 95% wt, 1.31 eq, 28.41 mmol) and potassium carbonate (9.0 g, 3.0 eq, 65.12 mmol) in dioxane (80 mL) and H₂O (20 mL) was degassed with N₂ for 30 minutes. XPhos (520 mg, 0.05 eq, 1.091 mmol) and XPhos Pd(crotyl)Cl (735 mg, 0.05 eq, 1.091 mmol) were added and mixture stirred at 80 °C for 24 hours. After cooling to room temperature, H₂O (500 mL) was added, and the mixture extracted with EtOAc (3 × 250 mL). The combined organics were washed with brine, dried over Na₂SO₄, filtered, and concentrated. The crude product was purified by silica gel column chromatography, eluting with 0-30% EtOAc/isohexane to give 2-methyl-5-(5-(trimethylsilyl)pyridin-2-yl)benzo[d]oxazole (**12**) (4.57 g, 17 mmol, 77%) as an off-white solid.

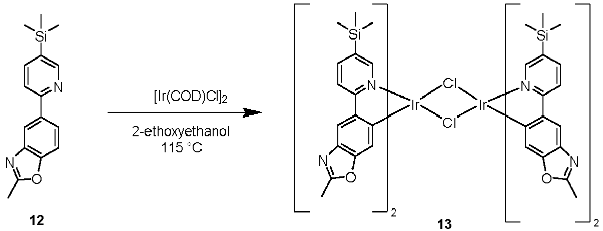

### Synthesis of Compound 13

[Ir(COD)Cl]₂ (270 mg, 1 Eq, 402 µmol) and TMS -BzOx ppy (**12**) (0.500 g, 4.4 Eq, 1.77 mmol) were added to an oven-dried schlenk tube charged with a stir bar. The reaction flask was evacuated then back-filled with N₂ three times then 2-ethoxyethanol (50.00 mL) was added and the reaction was purged with N₂ for 15 minutes. The purged solution was then heated to 115 °C in an oil bath under N₂ for 20 hours. Upon heating the reaction mixture became bright yellow after heating, the reaction was allowed to cool to room temperature, concentrated under reduced pressure, then precipitated by sonicating in a small amount of 9:1 methanol:water as a yellow solid. The precipitate was isolated via filtration then dried for 18 hours at 50 °C (0.567, 0.402 mmol).

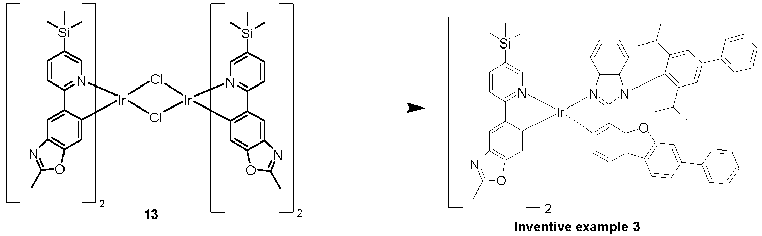

### Synthesis of Inventive Example 3

**Compound 13** (0.100 g, 1 Eq, 63.3 µmol), 1-(3,5-diisopropyl-[1,1'-biphenyl]-4-yl)-2-(7-phenyldibenzo[b,d]furan-4-yl)-1H-benzo[d]imidazole (90.6 mg, 2.4 Eq, 152 µmol), and potassium acetate (24.8 mg, 4 Eq, 253 µmol) were added to schlenk tube charge with a stir bar. The vessel was evacuated then back-filled with nitrogen 3 times then a mixture of DMF (2.500 mL) and 2-ethoxy ethanol (2.500 mL) was added. The reaction was purged with nitrogen for 10 minutes then heated for 2 days at 135 °C under nitrogen. The crude product was diluted in ethyl acetate then passed through a pad of Celite. The filtrate was concentrated under reduced pressure then dissolved in 1,4-Dioxane (5.000 mL), purged with N₂ for 10 minutes then heated to 85 °C while being irradiated with 405 nm light for 40 hours. After photoisomerization, the product was concentrated under reduced pressure then purified on silica gel, eluting with a gradient of 2-10% acetone in toluene. The desired product was isolated by precipitation from heptanes and dried as a yellow powder (13.5 mg, 16%).

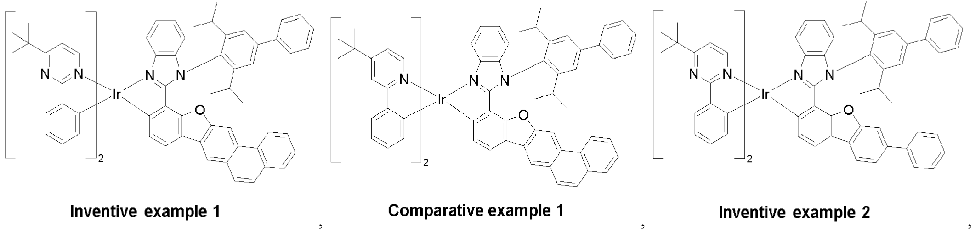

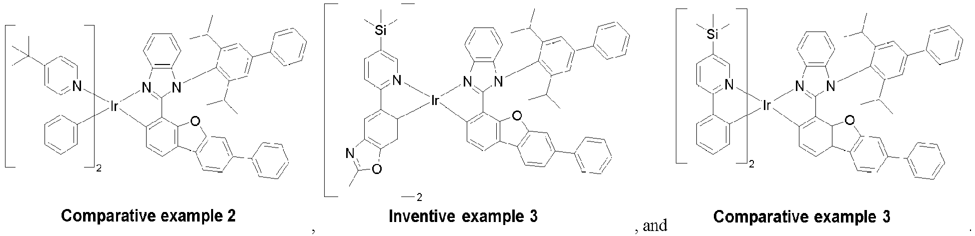

Photoluminescence (PL) spectra of the inventive compounds and comparative compounds were taken in 2-methylTHF at room temperature. Table 1 provides a summary of photoluminescence data of the inventive compounds and comparative compounds. The emission maximum of the inventive example 1 and inventive example 2 are 522 nm and 521 nm, which are blue-shifted 6~7 nm from the emission maximum of the comparative example 1 and comparative example 2 (528 nm for both). Similarly, the emission maximum of the inventive example 3 is 508 nm, which is blue-shifted 17 nm from the emission maximum of the comparative example 3 (525 nm). Furthermore, the inventive example 1~3 all show deeper HOMO level compared to the comparative example 1~3. The blue-shifted colors and deep HOMO level are critical to achieve the saturated color and fit into the current state of the art OLED device structures. In order to prove this advantage, the OLED devices with Inventive example 1 and its comparative example have been tested and the results are shown in the next section. Without being bound by any theory, the improvement of photoluminescence properties of the inventive examples is believed to be due to the extra nitrogen on the top of phenylpyridine ancillary ligand or the heteroaryl fused to the phenylpyridine ancillary ligand. The improvement of these values is above any value that could be attributed to experimental error and the observed improvements are significant. The performance improvement observed in the above data was unexpected.

**TABLE 1. Photoluminescence (PL) data**

| **Compound** | **λ max (nm)** | **HOMO (eV)** | **LUMO (eV)** |
|---|---|---|---|
| Inventive example 1 | 522 | -5.22 | -2.26 |
| Comparative example 1 | 528 | -5.10 | -2.17 |
| Inventive example 2 | 521 | -5.21 | -2.37 |
| Comparative example 2 | 528 | -5.08 | -2.13 |
| Inventive example 3 | 508 | -5.15 | -2.18 |
| Comparative example 3 | 525 | -5.14 | -2.19 |

### Device Examples

All example devices were fabricated by high vacuum (<10⁻⁷ Torr) thermal evaporation. The anode electrode was 800 Å of indium tin oxide (ITO). The cathode consisted of 10 Å of Liq (8-hydroxyquinoline lithium) followed by 1,000 Å of Al. All devices were encapsulated with a glass lid sealed with an epoxy resin in a nitrogen glove box (<1 ppm of H₂O and O₂) immediately after fabrication with a moisture getter incorporated inside the package. The organic stack of the device examples consisted of sequentially, from the ITO Surface: 100Å of LG101 (purchased from LG Chem) as the hole injection layer (HIL); 400 Å of HTM as a hole transporting layer (HTL); emissive layer (EML) with thickness 400 .4; 50 Å of EBM as an electron blocking layer (EBL); Emissive layer containing H-host (Hl): E-host (H2) in 6:4 ratio and 5 weight % of green emitter; 50 Å of H2 as an hole blocking layer (HBL); 300 Å of Liq (8-hydroxyquinoline lithium) doped with 35% of ETM as the ETL. The device structure is shown in Table 2. The chemical structures of the device materials are shown below.

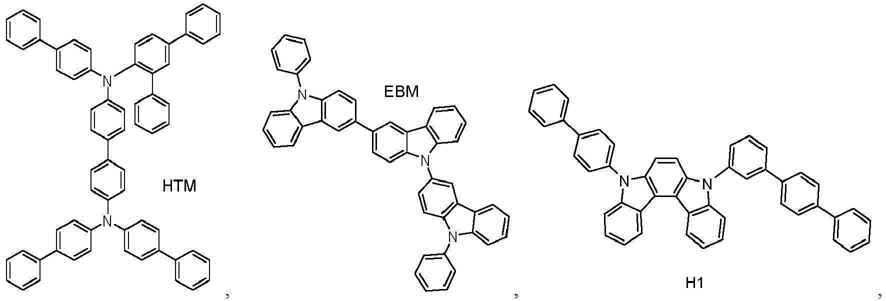

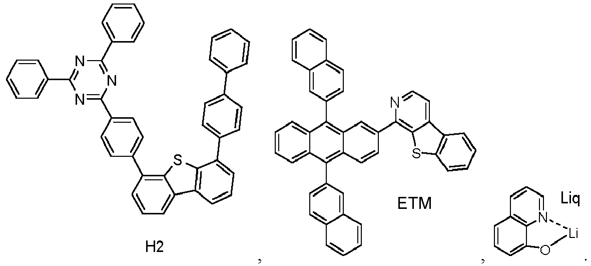

**Table 2. Device layer materials and thicknesses**

| Layer | Material | Thickness [Å] |
|---|---|---|
| Anode | ITO | 800 |
| HIL | LG-101 | 100 |
| HTL | HTM | 400 |
| EBL | EBM | 50 |
| EML | H1 : H2 : Emitter 5% | 400 |
| HBL | H2 | 50 |
| ETL | Liq: ETM 35% | 300 |
| EIL | Liq | 10 |
| Cathode | Al | 1,000 |

Upon fabrication, the device was tested to measure EL and JVL. For this purpose, the samples were energized by the 2 channel Keysight B2902A SMU at a current density of 10 mA/cm² and measured by the Photo Research PR735 Spectroradiometer. Radiance (W/str/cm²) from 380 nm to 1080 nm, and total integrated photon count were collected. The devices were then placed under a large area silicon photodiode for the JVL sweep. The integrated photon count of the device at 10 mA/cm² is used to convert the photodiode current to photon count. The voltage is swept from 0 to a voltage equating to 200 mA/cm². The EQE of the device is calculated using the total integrated photon count. All device results are summarized in Table 3. Voltage, LE, EQE, and LT_{97%} of inventive example 1 (Device 1) are reported as relative numbers normalized to the results of the comparative example 1 (Device 2).

**Table 3. device results**

| **Device** | **Emitter** | **1931 CIE** | | | | **At 10mA/cm²** | | |
|---|---|---|---|---|---|---|---|---|
| | | **x** | **y** | **λ max [nm]** | **FWHM [nm]** | **Voltage** | **LE** | **EQE** |
| Device 1 | Inventive Example 1 | 0.335 | 0.635 | 525 | 28 | 0.92 | 1.02 | 1.01 |
| Device 2 | Comparative Example 1 | 0.365 | 0.615 | 530 | 53 | 1.00 | 1.00 | 1.00 |

Table 3 provides a summary of performance of electroluminescence device of the materials. The inventive device (device 1) shows more saturated green emission at 525 nm, lower turn on voltage, higher LE and EQE. This is consistent with the deeper LUMO energy described above, which has resulted in better charge balance. Moreover, the inventive device (device 1) shows a remarkable much narrower lineshape with FWHM of 28 nm compared to the comparative device (device 2). In general, the FWHM for a phosphorescent emitter complex is broad, normally above 50 nm as shown in the comparative example here. It has been a long-sought goal to achieve the narrow FWHM. The narrower FWHM, the better color purity for the display application. As background information, the ideal line shape is a single wavelength (single line). As can be seen here, the current inventive compounds with extra nitrogen on the top ring of the phenylpyridine ancillary ligand can cut down the FWHM number from the comparative one to nearly half. The improvements described here were above the any value that could be attributed to experimental error and the observed improvements are significant. The performance improvement observed in the above data was unexpected. All results show the significance of the inventive compounds for applications in organic light emitting diodes (OLED).

The invention is further defined by the following numbered paragraphs:
1. A compound having a formula of Ir(L_{A})ₙ(L_{B})ₘ(L_{C})ₒ, wherein:
   n is 1 or 2, m is 1 or 2, o is 0 or 1, and m + n + o = 3;
   L_{A} comprises a structure of Formula I, 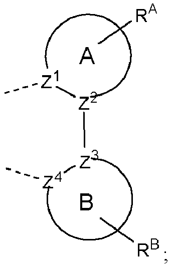
   L_{B} comprises a structure of Formula IIA, 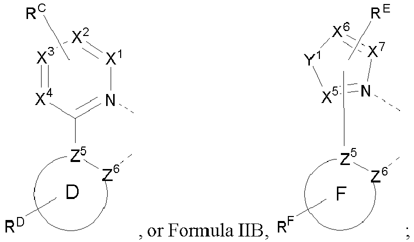
   Lc is a bidentate ligand;
   each of moiety A, moiety D, and moiety F is independently a monocyclic ring or a polycyclic fused ring system, wherein the monocyclic ring or each ring of the polycyclic fused ring system is independently a 5-membered to 10-membered carbocyclic or heterocyclic ring;
   moiety B is a polycyclic fused ring system, wherein each ring of moiety B is independently a 5-membered to 10-membered carbocyclic or heterocyclic ring;
   each of Z¹ to Z⁶ and X¹ to X⁷ is independently C or N;
   Y¹ is selected from the group consisting of O, S, Se, Te, P, Si, and Ge;
   each of R^{A}, R^{B}, R^{C}, R^{D}, R^{E}, and R^{F} independently represents mono to the maximum allowable substitutions, or no substitutions;
   each R^{A}, R^{B}, R^{C}, R^{D}, R^{E}, and R^{F} is independently hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
   any two substituents may be joined or fused to form a ring; provided that

   (1) when L_{B} has a structure of Formula IIA and moiety D is a monocyclic 6-membered aromatic ring, then at least one of X¹, X², X³, and X⁴ is N; and
   (2) the compound is not 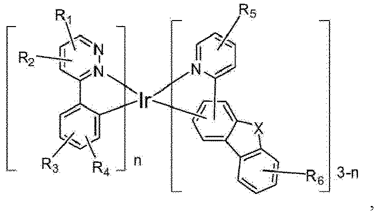 where each of R₁ to R₈ is independently H, alkyl, or aryl; X is N, O, S, or C₁ to C₄-alkyl; and no two of R₁ to R₈ are joined or fused to form a ring.
2. The compound of paragraph 1, wherein each R^{A}, R^{B}, R^{C}, R^{D}, R^{E}, and R^{F} is independently hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.
3. The compound of paragraph 1, wherein each of moiety A, moiety D, and moiety F is independently selected from the group consisting of the following Cyclic Moiety List: benzene, pyridine, pyrimidine, pyridazine, pyrazine, triazine, imidazole, imidazole derived carbene, pyrazole, pyrrole, oxazole, furan, thiophene, thiazole, triazole, naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene; and/or wherein moiety B is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.
4. The compound of paragraph 1, wherein L_{B} comprises a structure of Formula IIA; and/or wherein moiety D is selected from the group consisting of: benzene, pyridine, pyrimidine, pyridazine, pyrazine, triazine, imidazole, imidazole derived carbene, pyrazole, pyrrole, oxazole, furan, thiophene, thiazole, triazole, naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene; and/or wherein moiety B is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.
5. The compound of paragraph 1, wherein at least one of X¹, X², X³, or X⁴ is N or each of X¹ , X², X³, or X⁴ is independently carbon; and/or wherein at least one R^{A} comprises a substituent selected from the group consisting of alkyl, cycloalkyl, aryl, heteroaryl, an electron-withdrawing group, and combinations thereof; and/or wherein the ring containing Z¹ has at least 2 nitrogen ring atoms; and/or wherein each of X⁵ to X⁷ is independently carbon or one of them is N; and/or wherein Y¹ is O, S, or Se.
6. The compound of paragraph 1, wherein at least one R^{A} comprises a substituent selected from the group consisting of alkyl, cycloalkyl, aryl, heteroaryl, and combinations thereof; and/or wherein at least one R^{B} comprises a substituent selected from the group consisting of alkyl, cycloalkyl, aryl, heteroaryl, an electron-withdrawing group, and combinations thereof; and/or wherein at least one R^{C} comprises a substituent selected from the group consisting of alkyl, cycloalkyl, aryl, heteroaryl, an electron-withdrawing group, and combinations thereof; wherein at least one R^{D} comprises a substituent selected from the group consisting of alkyl, cycloalkyl, aryl, heteroaryl, an electron-withdrawing group, and combinations thereof; wherein at least one R^{F} comprises a substituent selected from the group consisting of alkyl, cycloalkyl, aryl, heteroaryl, an electron-withdrawing group, and combinations thereof.
7. The compound of paragraph 1, wherein ligand L_{A} is selected from the group consisting of the structures of LIST 1 as previously defined herein;
   wherein:
   each of X₁ to X₁₉ is independently C or N;
   each of Y₁, Y^{A}, Y^{B}, and Y^{C} is independently selected from the group consisting of BRₑ, NRₑ, PRₑ, O, S, Se, C=O, S=O, SO₂, CRₑR_{f}, SiRₑR_{f}, and GeRₑR_{f'},
   each of R^{A1}, R^{B1}, R^{B2}, and R^{B3} independently represents from mono to the maximum possible number of substitutions, or no substitutions;
   each R^{A1}, R^{B1}, R^{B2}, R^{B3}, Rₑ, and R_{f} is independently a hydrogen or a substituent selected from the group consisting of the General Substituents defined herein; and
   any two substituents can be joined or fused to form a ring.
8. The compound of paragraph 1, wherein the ligand L_{A} is selected from the group consisting of the structures of LIST 2 as previously defined herein;
   wherein:
   each of Y^{A}, Y^{B}, and Y^{C} is independently selected from the group consisting of BRₑ, NRₑ, PRₑ, O, S, Se, C=O, S=O, SO₂, CRₑR_{f}, SiRₑR_{f}, and GeRₑR_{f'},
   each R^{A1}, R^{B1}, R^{B2}, and R^{B3} independently represent from mono to the maximum possible number of substitutions, or no substitution;
   each R^{A1}, R^{B1}, R^{B2}, R^{B3}, Rₑ, and R_{f} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof; and
   any two substituents can be joined or fused to form a ring.
9. The compound of paragraph 1, wherein the ligand L_{A} is selected from L_{Ai}(R*m*)(R*n*)(R*o*)(R*p*), wherein i is an integer from 1 to 114, and each R*m*, R*n,* R*o,* and R*p* is independently selected from the group consisting of R1 to R115; wherein each of L_{A1}(R1)(R1)(R1)(R1) to L_{A114}(R115)(R115)(R115)(R115) is as previously defined in LIST 3;
   wherein R1 to R115 each have the structures previously defined in the LIST 4.
10. The compound of paragraph 1, wherein ligand L_{B} is selected from the group consisting of the structures as defined previously in LIST 5, wherein:
   each of X₂₀ to X₂₉ is independently C or N;
   each of Y^{D}, Y^{E}, and Y^{F} is independently selected from the group consisting of BRₑ, NRₑ, PRₑ, O, S, Se, C=O, S=O, SO₂, CRₑR_{f}, SiRₑR_{f}, and GeRₑR_{f'},
   each of R^{C1}, R^{D1}, R^{E1}, and R^{F1} independently represents from mono to the maximum possible number of substitutions, or no substitutions;
   each R^{C1}, R^{D1}, R^{E1}, R^{F1}, Rₑ, and R_{f} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof; and
   any two substituents can be joined or fused to form a ring.
11. The compound of paragraph 1, wherein the ligand L_{B} is selected from the group consisting of the structure of LIST 6 as previously defined herein, wherein:
   each of Y^{D}, Y^{E}, and Y^{F} is independently selected from the group consisting of BRₑ, NRₑ, PRₑ, O, S, Se, C=O, S=O, SO₂, CRₑR_{f}, SiRₑR_{f}, and GeRₑR_{f'},
   each of R^{C1}, R^{D1}, R^{E1}, and R^{F1} independently represents from mono to the maximum possible number of substitutions, or no substitutions;
   each R^{C1}, R^{D1}, R^{E1}, R^{F1}, Rₑ, and R_{f} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof; and
   any two substituents can be joined or fused to form a ring.
12. The compound of paragraph 1, wherein the ligand L_{B} is selected from L_{Bw}(R*G*)(R*H*)(R*J*)(R*K*), wherein w is an integer from 1 to 92, and each R^{G}, R^{H}, R^{J}, and R^{K} is independently selected from the group consisting of R1 to R115; wherein each of L_{B1}(R1)(R1)(R1)(R1) to L_{B92}(R115)(R115)(R115)(R115) is defined as previously defined in LIST 7;
   wherein R1 to R115 have the structures as previously defined in LIST 4.
13. The compound of paragraph 1, wherein the compound has a formula selected from the group consisting of Ir(L_{A})(L_{B})₂, Ir(L_{A})₂(L_{B}), and Ir(L_{A})(L_{B})(L_{C}).
14. The compound of paragraph 1, wherein Lc has a structure selected from the group consisting of the structures of LIST 8 as previously defined herein, wherein:
   T is selected from the group consisting of B, Ga, and In;
   K^{1'} is selected from the group consisting of a single bond, O, S, NRₑ, PRₑ, BRₑ, CRₑR_{f}, and SiRₑR_{f'},
   each of Y¹ to Y¹³ is independently selected from the group consisting of C and N;
   Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f'},
   Rₑ and R_{f} can be fused or joined to form a ring;
   each Rₐ, R_{b}, R_{c}, and R_{d} independently represents from mono to the maximum allowed number of substitutions, or no substitution;
   each of Rₐ₁, R_{b1}, R_{c1}, R_{d1}, Rₐ, R_{b}, R_{c}, R_{d}, Rₑ, and R_{f} is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and
   any two substituents of Rₐ₁, R_{b1}, R_{c1}, R_{d1}, Rₐ, R_{b}, R_{c}, and R_{d} can be fused or joined to form a ring or form a multidentate ligand.
15. The compound of paragraph 9, when the compound has formula Ir(L_{Ai}(R*m*)(R*n*)(R*o*)(R*p*)) (L_{Bw}(R^{G})(R^{H})(R^{J})(R^{K}))₂, the compound is selected from the group consisting of Ir(L_{A1}(R1)(R1)(R1)(R1)) (L_{B1}(R1)(R1)(R1)(R1))₂ to Ir(L_{A114}(R115)(R115)(R115)(R115))(L_{B92}(R115)(R115)(R115)(R115))₂,
   when the compound has formula Ir(L_{Ai}(R*m*)(R*n*)(R*a*)(R*p*))₂(L_{Bw}(R^{G})(R^{H})(R^{J})(R^{K})), the compound is selected from the group consisting of Ir(L_{Ai}(R1)(R1)(R1)(R1))₂(L_{B1}(R1)(R1)(R1)(R1)) to Ir(L_{A114}(R115)(R115)(R115)(R115))₂(L_{B92}(R115)(R115)(R115)(R115));
   when the compound has formula Ir(L_{Ai}(R*m*)(R*n*)(R*o*)(R*p*))(L_{Bw}(R^{G})(R^{H})(R^{J})(R^{K}))(L_{Cj-I}), *j* is an integer from 1 to 1416, wherein the compound is selected from the group consisting of Ir(L_{A1}(R1)(R1)(R1)(R1)) (L_{B1}(R1)(R1)(R1)(R1))(L_{Cl-I}) to Ir(L_{A114}(R115)(R115)(R115)(R115))(L_{B92}(R115)(R115)(R115)(R115))(Lc_{1416-I}), and
   when the compound has formula Ir(L_{Ai}(R*m*)(R*n*)(R*o*)(R*p*))(L_{Bw}(R^{G})(R^{H})(R^{J})(R^{K}))(L_{Cj-II}), j is an integer from 1 to 1416, wherein the compound is selected from the group consisting of Ir(L_{A1}(R1)(R1)(R1)(R1)) (L_{B1}(R1)(R1)(R1)(R1))(L_{C1-II}) to Ir(L_{A114}(R115)(R115)(R115)(R115))(L_{B92}(R115)(R115)(R115)(R115))(L_{C1416-II});
   wherein each L_{C*j*-I} has a structure based on formula 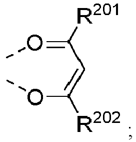 and
   each L_{C*j*-II} has a structure based on formula 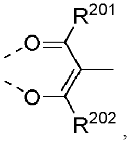 wherein for each L*_{Cj}* in L_{*Cj*-I} and L_{C*j*-II}, R²⁰¹ and R²⁰² are defined as in LIST 10 previously defined herein; wherein R^{D1} to R^{D246} have the structures defined previously in the LIST 11.
16. The compound of paragraph 1, wherein the compound is selected from the group consisting of the structures of LIST 13 as previously defined herein.
17. An organic light emitting device (OLED) comprising:
   an anode;
   a cathode; and
   an organic layer disposed between the anode and the cathode, wherein the organic layer comprises a compound according to any one of paragraphs 1 to 16.
18. The OLED of paragraph 17, wherein the organic layer further comprises a host, wherein the host is selected from the group consisting of the structures of HOST Group 1 as previously defined herein,
   wherein:
   each of J₁ to J₆ is independently C or N;
   L' is a direct bond or an organic linker;
   each Y^{AA}, Y^{BB}, Y^{CC}, and Y^{DD} is independently selected from the group consisting of absent a bond, direct bond, O, S, Se, CRR', SiRR', GeRR', NR, BR, BRR';
   each of R^{A'}, R^{B'}, R^{C'}, R^{D'}, R^{E'}, R^{F'}, and R^{G'} independently represents mono, up to the maximum substitutions, or no substitutions;
   each R, R', R^{A'}, R^{B'}, R^{C'}, R^{D'}, R^{E'}, R^{F'}, and R^{G'} is independently a hydrogen or a substituent selected from the group consisting of: deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof;
   any two substituents can be joined or fused to form a ring; and where possible, each unsubstituted aromatic carbon atom can be replaced with N to form an aza-substituted ring.
19. The OLED of paragraph 17, wherein the compound is a sensitizer, and the OLED further comprises an acceptor selected from the group consisting of a fluorescent emitter, a delayed fluorescence emitter, and combination thereof.
20. A consumer product comprising an organic light-emitting device comprising:
   an anode;
   a cathode; and
   an organic layer disposed between the anode and the cathode, wherein the organic layer comprises a compound according to any one of paragraphs 1 to 16.

## Claims

1. A compound having a formula of Ir(L_{A})ₙ(L_{B})ₘ(L_{C})ₒ, wherein:
n is 1 or 2, m is 1 or 2, o is 0 or 1, and m + n + o = 3;
L_{A} comprises a structure of Formula I, 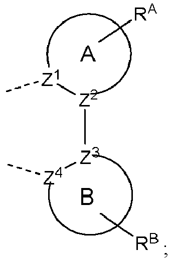
L_{B} comprises a structure of Formula IIA, 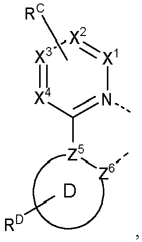 or Formula IIB, 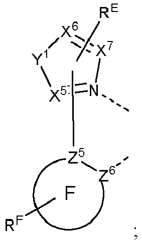 Lc is a bidentate ligand;
each of moiety A, moiety D, and moiety F is independently a monocyclic ring or a polycyclic fused ring system, wherein the monocyclic ring or each ring of the polycyclic fused ring system is independently a 5-membered to 10-membered carbocyclic or heterocyclic ring;
moiety B is a polycyclic fused ring system, wherein each ring of moiety B is independently a 5-membered to 10-membered carbocyclic or heterocyclic ring;
each of Z¹ to Z⁶ and X¹ to X⁷ is independently C or N;
Y¹ is selected from the group consisting of O, S, Se, Te, P, Si, and Ge;
each of R^{A}, R^{B}, R^{C}, R^{D}, R^{E}, and R^{F} independently represents mono to the maximum allowable substitutions, or no substitutions;
each R^{A}, R^{B}, R^{C}, R^{D}, R^{E}, and R^{F} is independently hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents may be joined or fused to form a ring; provided that
(1) when L_{B} has a structure of Formula IIA and moiety D is a monocyclic 6-membered aromatic ring, then at least one of X¹, X², X³, and X⁴ is N; and
(2) the compound is not 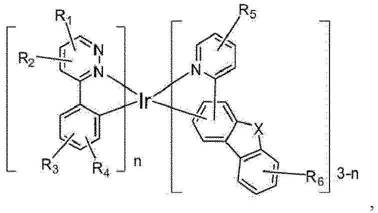 where each of R₁ to R₈ is independently H, alkyl, or aryl; X is N, O, S, or C₁ to C₄-alkyl; and no two of R₁ to R₈ are joined or fused to form a ring.

2. The compound of claim 1, wherein each of moiety A, moiety D, and moiety F is independently selected from the group consisting of the following Cyclic Moiety List: benzene, pyridine, pyrimidine, pyridazine, pyrazine, triazine, imidazole, imidazole derived carbene, pyrazole, pyrrole, oxazole, furan, thiophene, thiazole, triazole, naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene; and/or wherein moiety B is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

3. The compound of claim 1 or 2, wherein L_{B} comprises a structure of Formula IIA; and/or wherein moiety D is selected from the group consisting of: benzene, pyridine, pyrimidine, pyridazine, pyrazine, triazine, imidazole, imidazole derived carbene, pyrazole, pyrrole, oxazole, furan, thiophene, thiazole, triazole, naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene; and/or wherein moiety B is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, benzimidazole derived carbene, aza-benzimidazole derived carbene, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene; and/or
wherein at least one of X¹ , X², X³, or X⁴ is N or each of X¹, X², X³, or X⁴ is independently carbon; and/or
wherein at least one R^{A} comprises a substituent selected from the group consisting of alkyl, cycloalkyl, aryl, heteroaryl, an electron-withdrawing group, and combinations thereof; and/or
wherein the ring containing Z¹ has at least 2 nitrogen ring atoms; and/or wherein each of X⁵ to X⁷ is independently carbon or one of them is N; and/or wherein Y¹ is O, S, or Se; and/or
wherein at least one R^{A} comprises a substituent selected from the group consisting of alkyl, cycloalkyl, aryl, heteroaryl, and combinations thereof; and/or wherein at least one R^{B} comprises a substituent selected from the group consisting of alkyl, cycloalkyl, aryl, heteroaryl, an electron-withdrawing group, and combinations thereof; and/or
wherein at least one R^{C} comprises a substituent selected from the group consisting of alkyl, cycloalkyl, aryl, heteroaryl, an electron-withdrawing group, and combinations thereof wherein at least one R^{D} comprises a substituent selected from the group consisting of alkyl, cycloalkyl, aryl, heteroaryl, an electron-withdrawing group, and combinations thereof; wherein at least one R^{F} comprises a substituent selected from the group consisting of alkyl, cycloalkyl, aryl, heteroaryl, an electron-withdrawing group, and combinations thereof.

4. The compound of any one of claims 1 to 3, wherein ligand L_{A} is selected from the group consisting of: 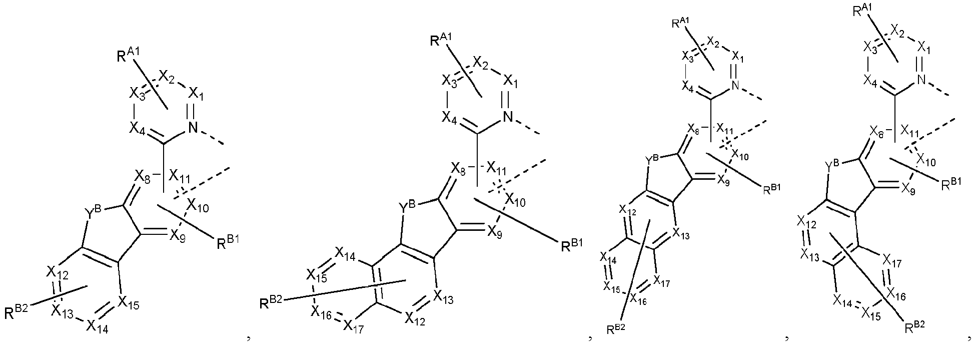 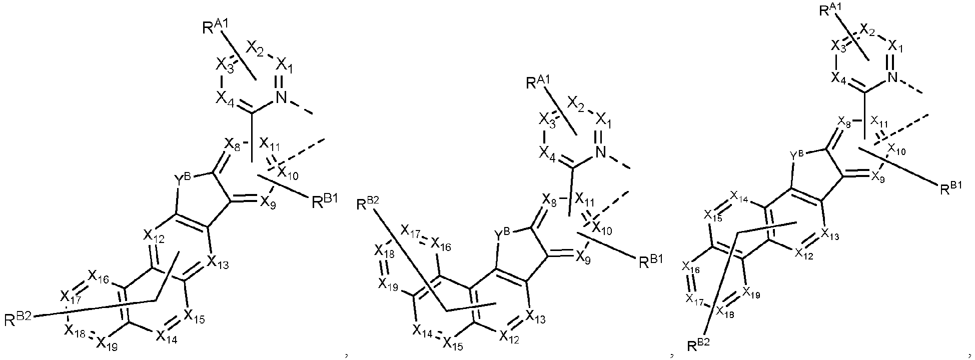 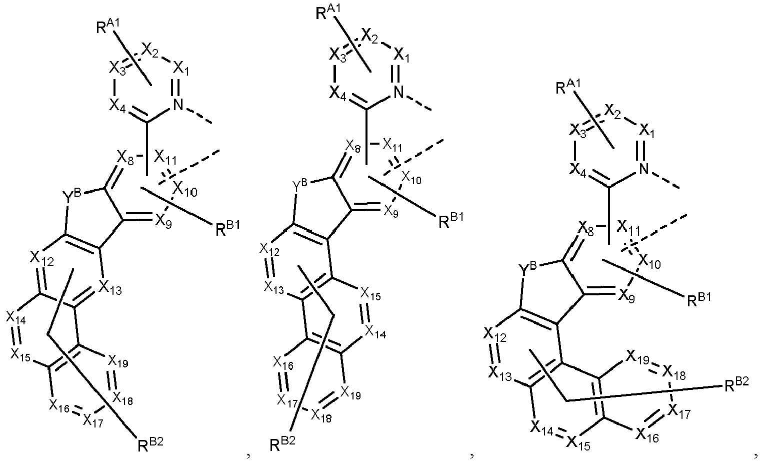 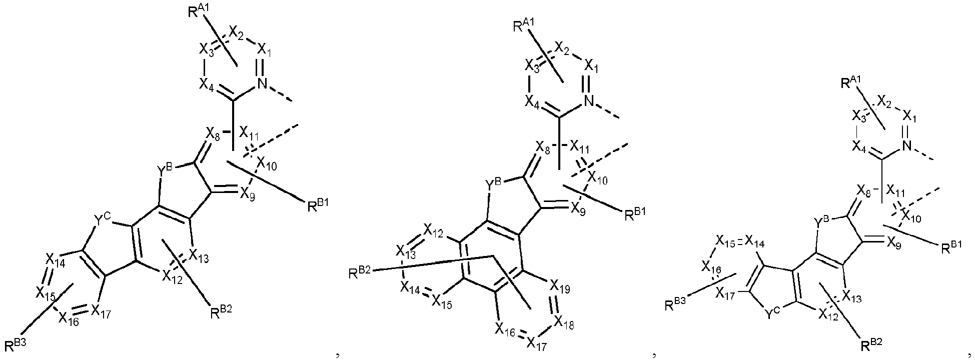 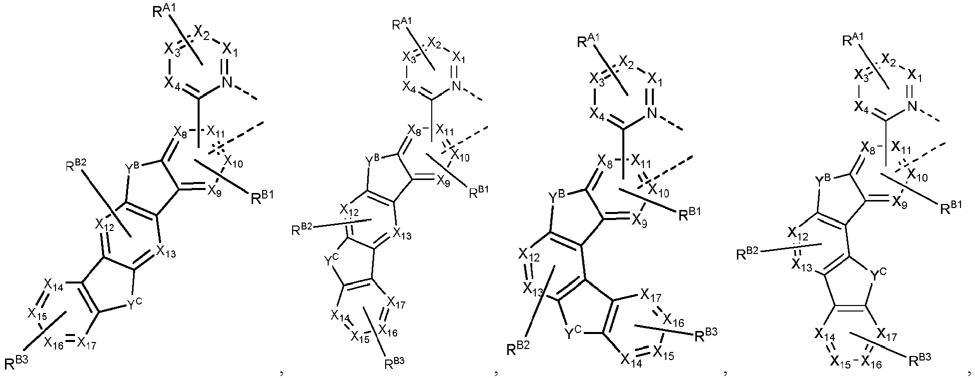 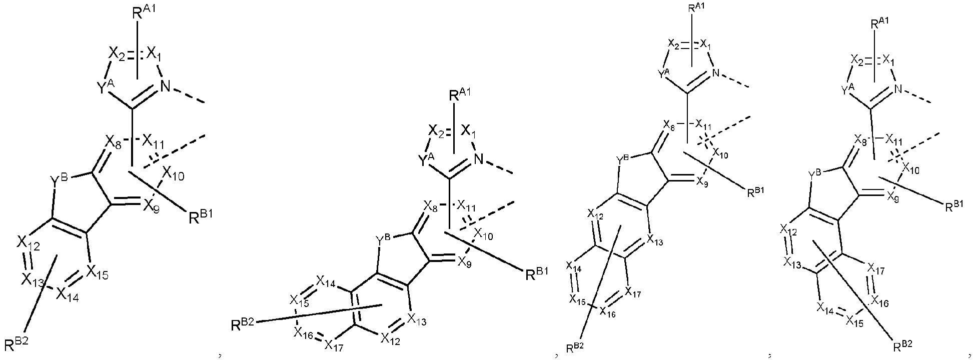 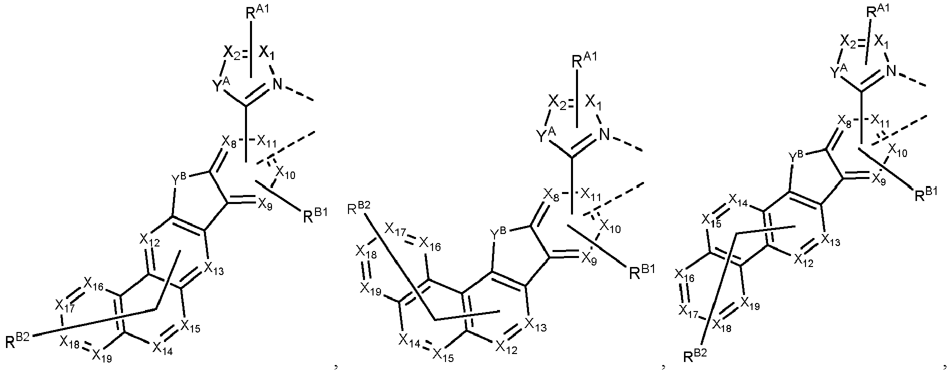 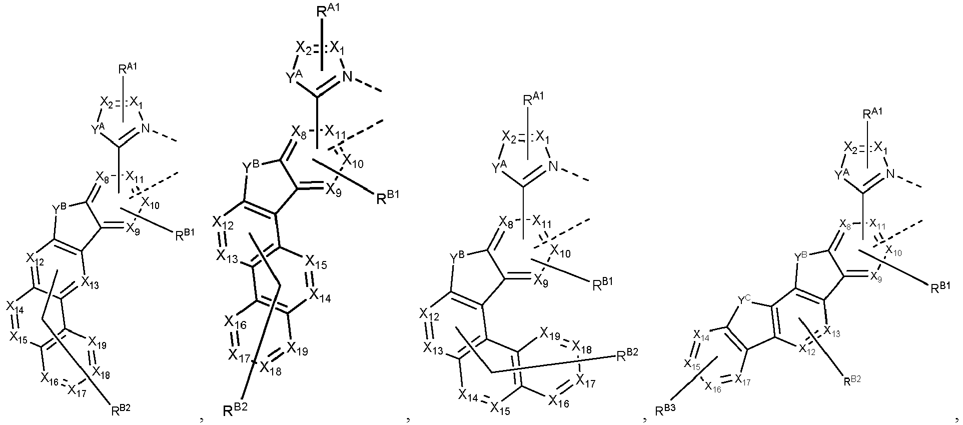 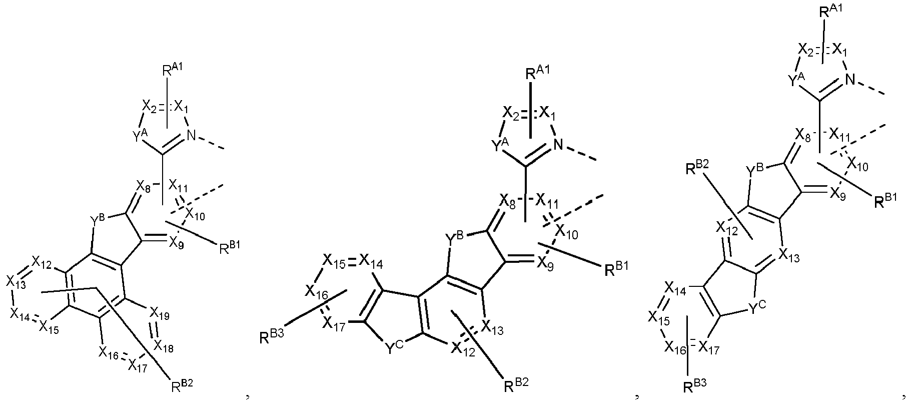 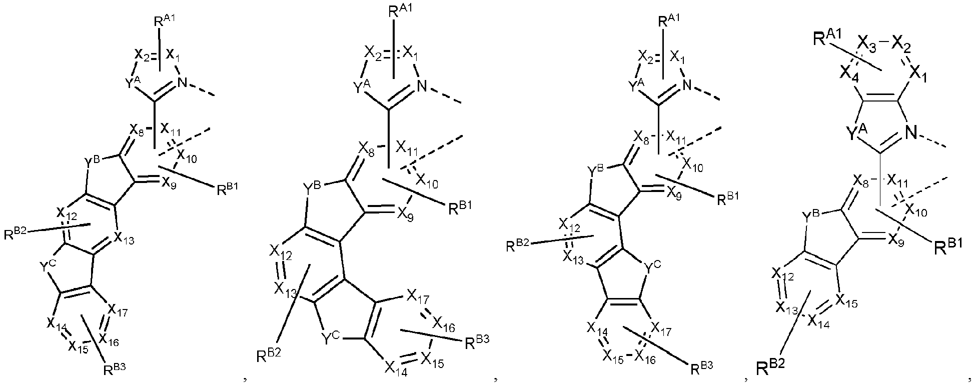 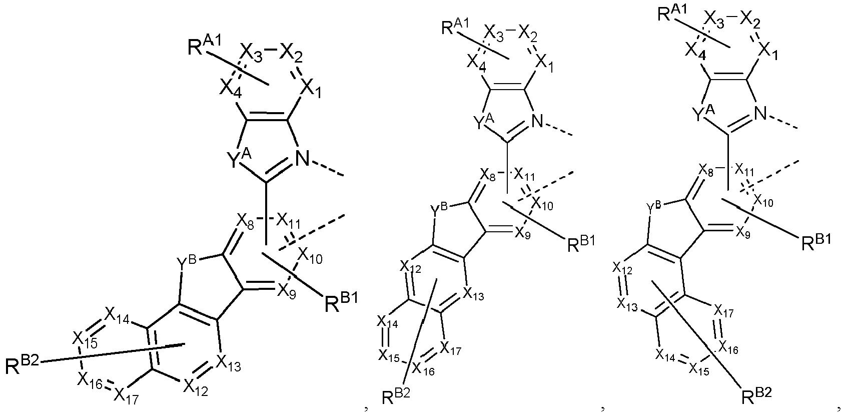 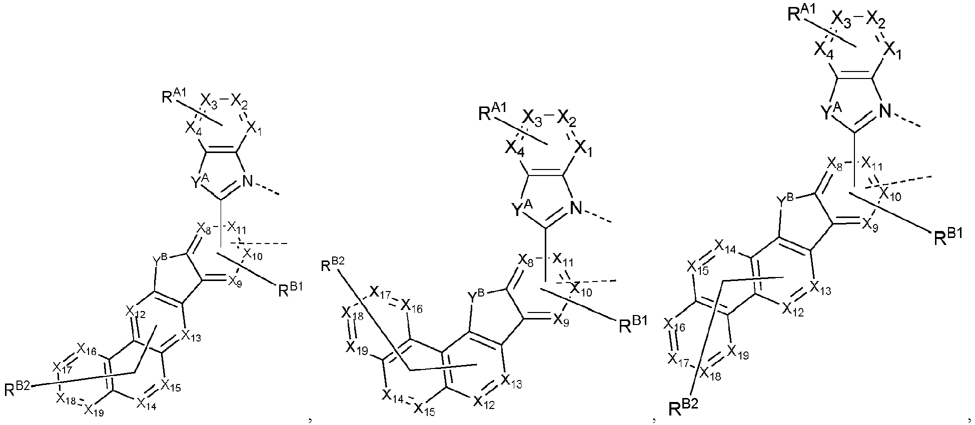 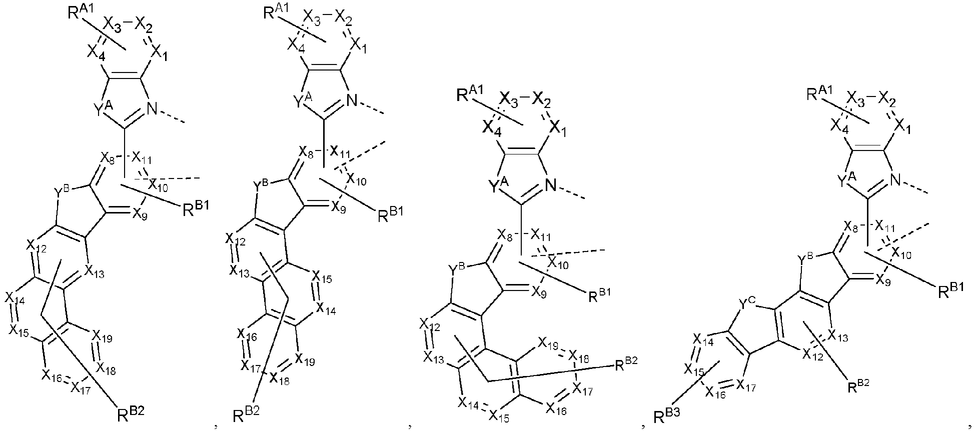 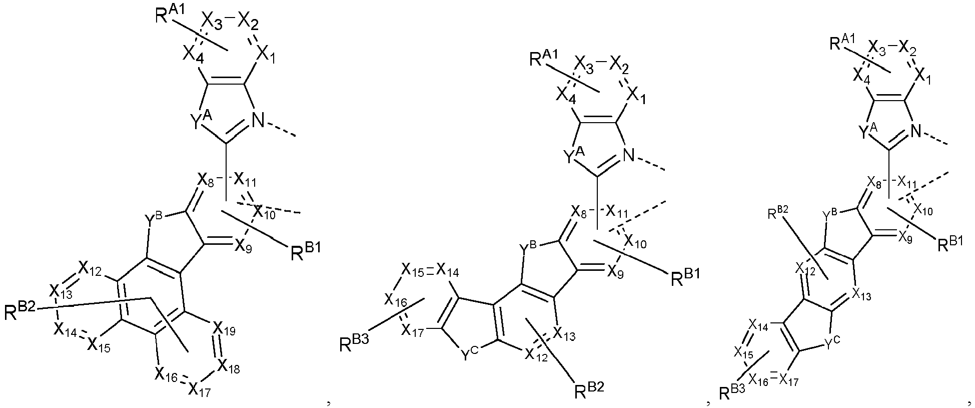 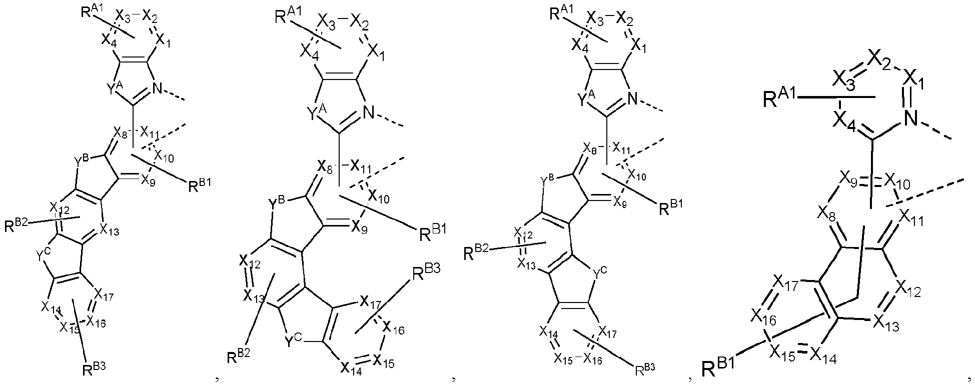 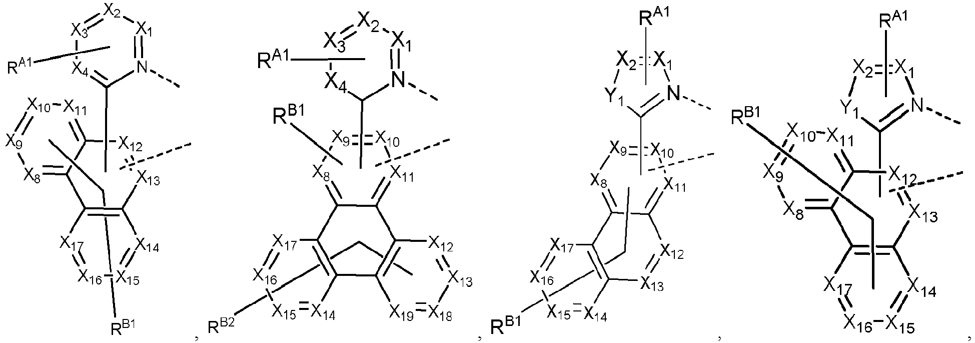 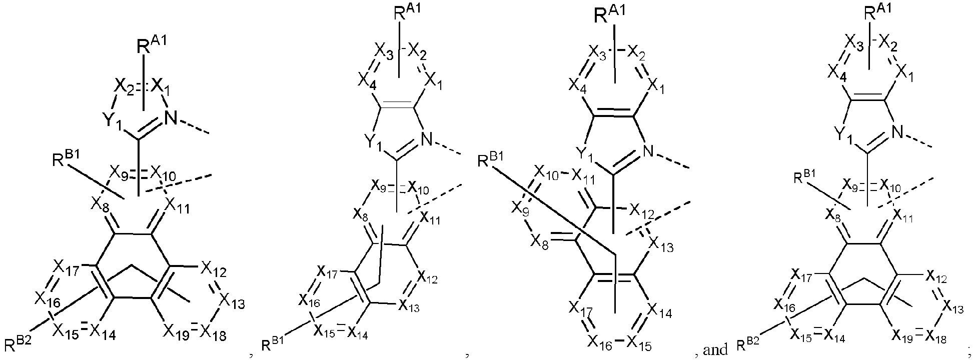 wherein:
each of X₁ to X₁₉ is independently C or N;
each of Y₁, Y^{A}, Y^{B}, and Y^{C} is independently selected from the group consisting of BRₑ, NRₑ, PRₑ, O, S, Se, C=O, S=O, SO₂, CRₑR_{f}, SiRₑR_{f}, and GeRₑR_{f'},
each of R^{A1}, R^{B1}, R^{B2}, and R^{B3} independently represents from mono to the maximum possible number of substitutions, or no substitutions;
each R^{A1}, R^{B1}, R^{B2}, R^{B3}, Rₑ, and R_{f} is independently a hydrogen or a substituent selected from the group consisting of the General Substituents defined herein; and
any two substituents can be joined or fused to form a ring.

5. The compound of any one of claims 1 to 4, wherein the ligand L_{A} is selected from the group consisting of: 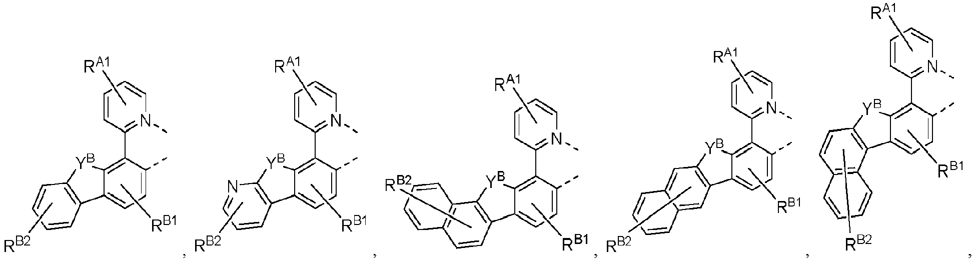 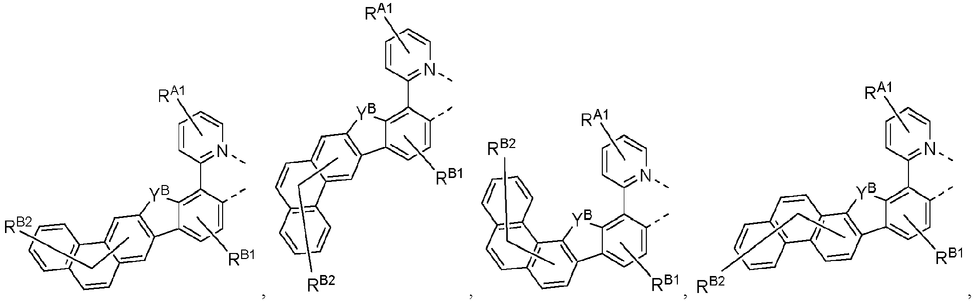 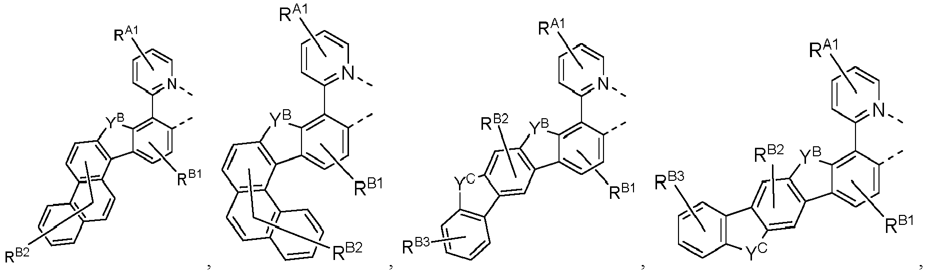 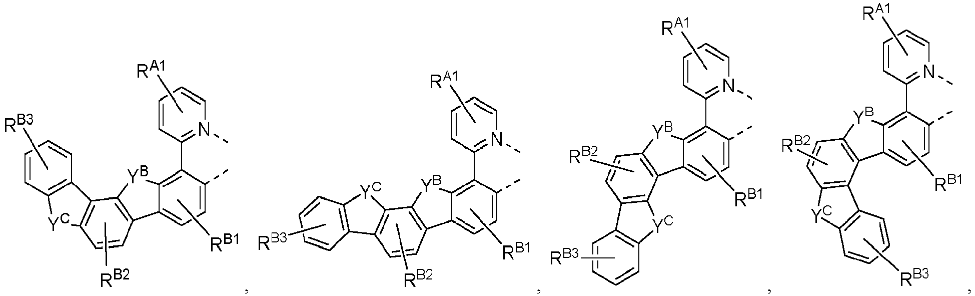 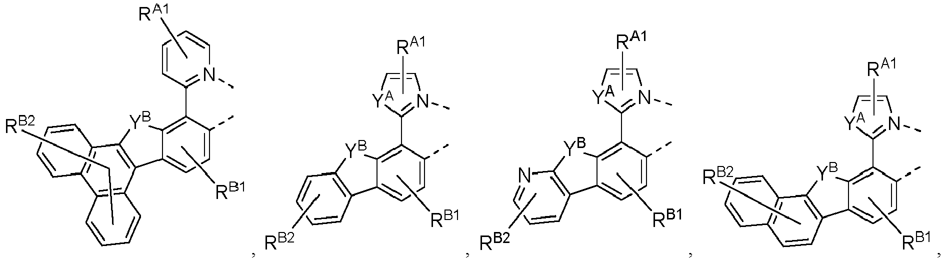 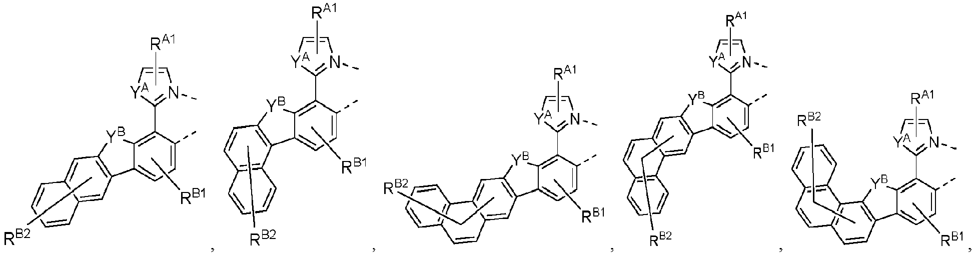 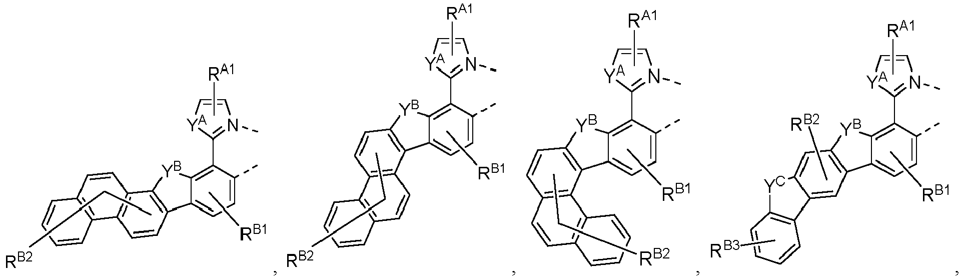 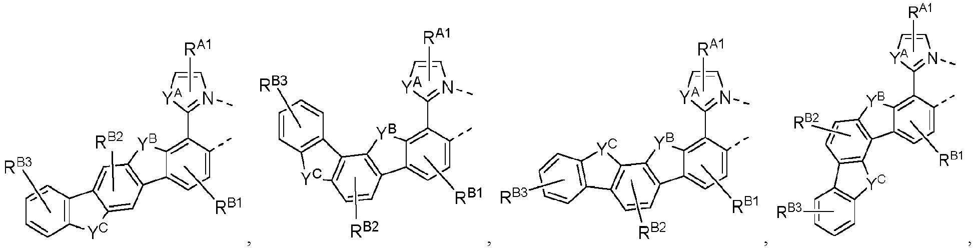 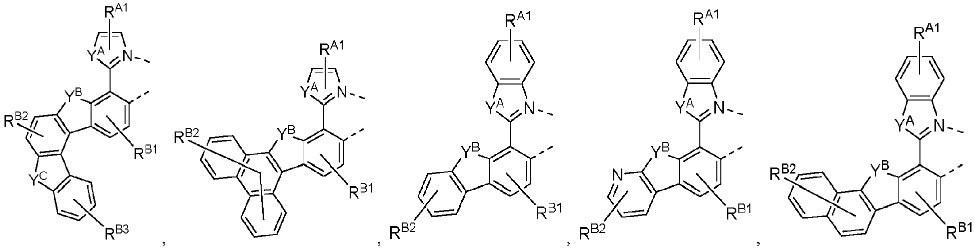 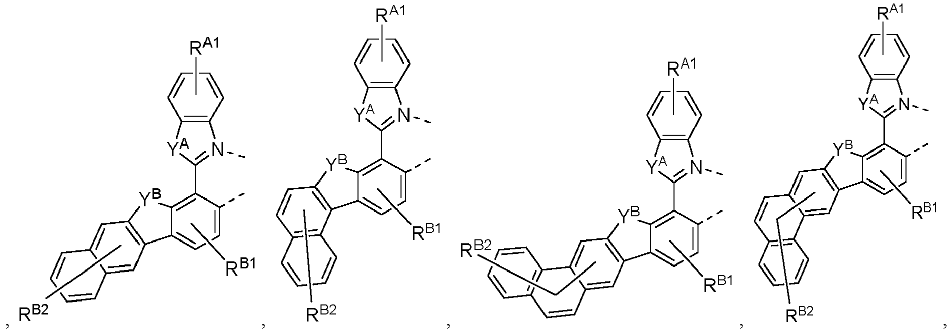 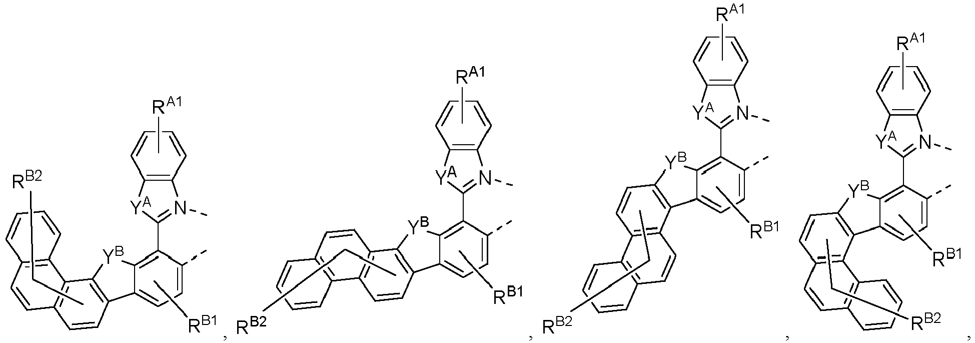 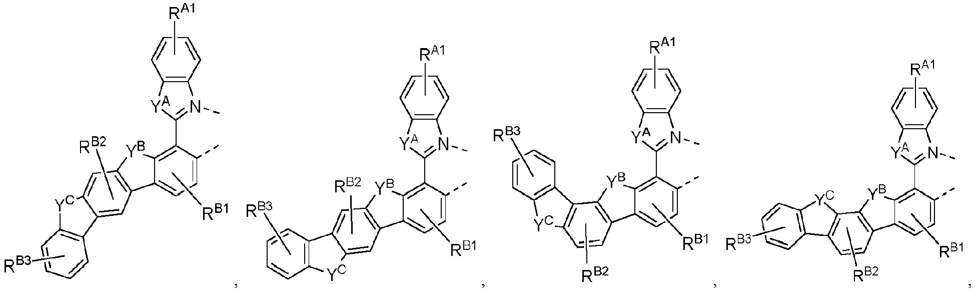 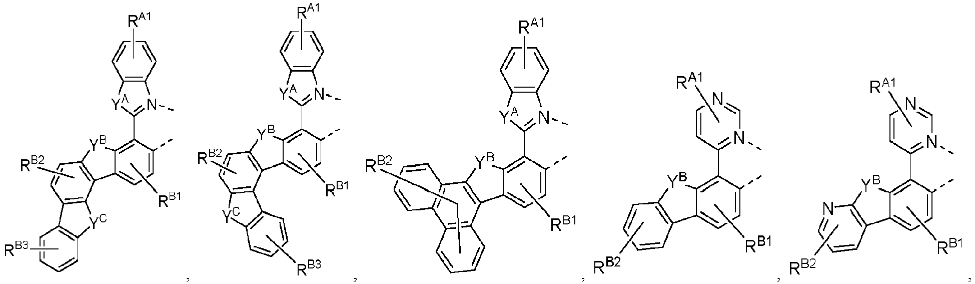 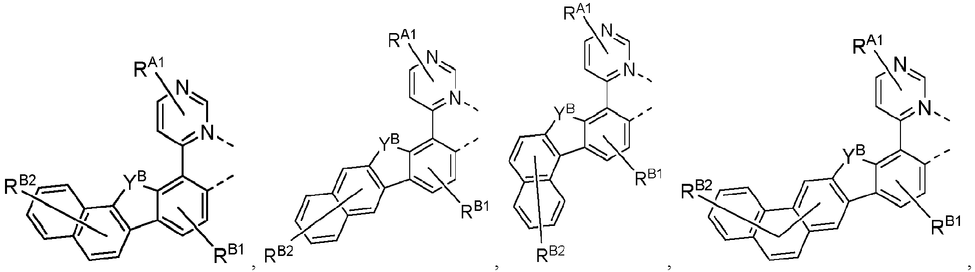 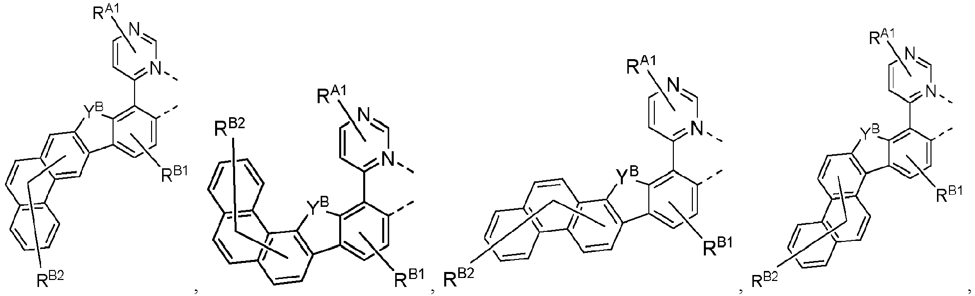 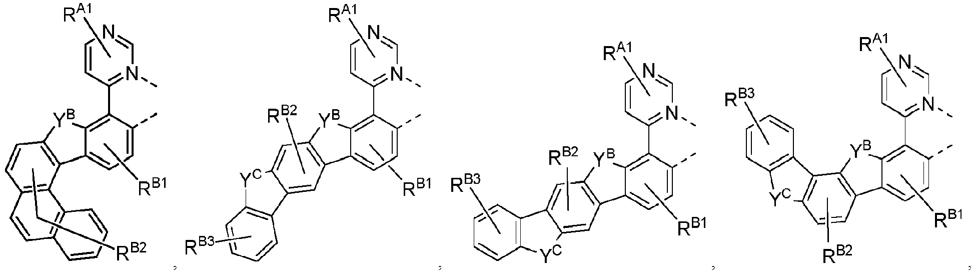 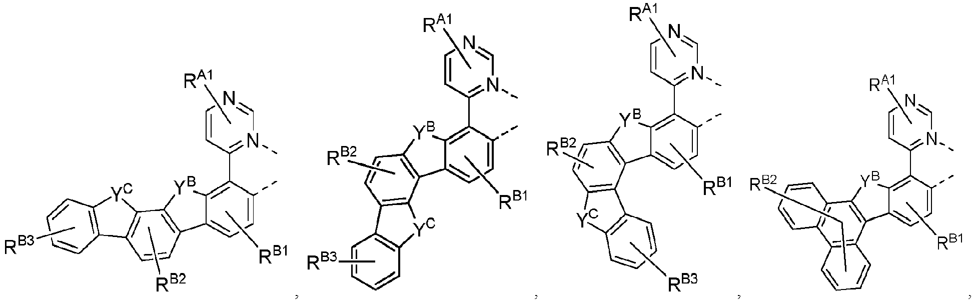 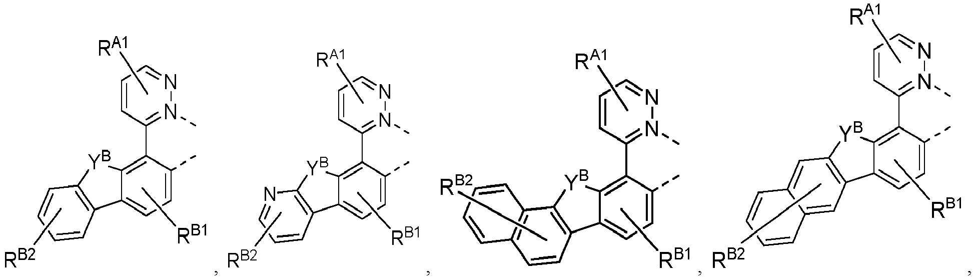 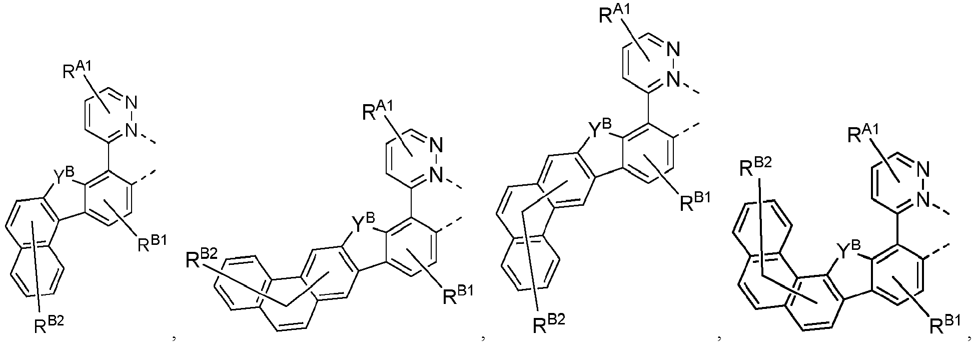 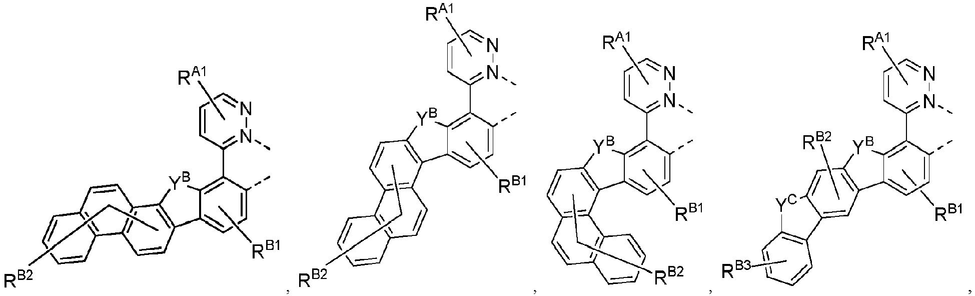 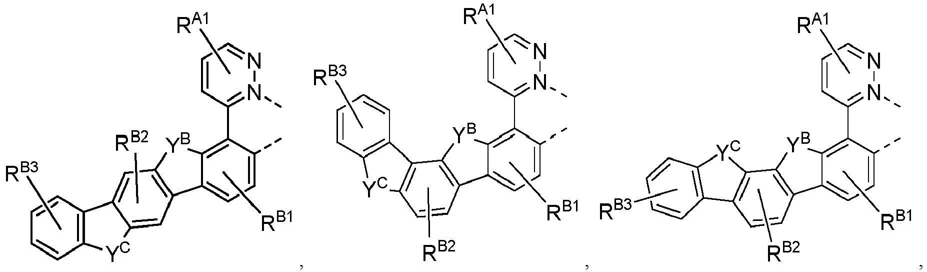 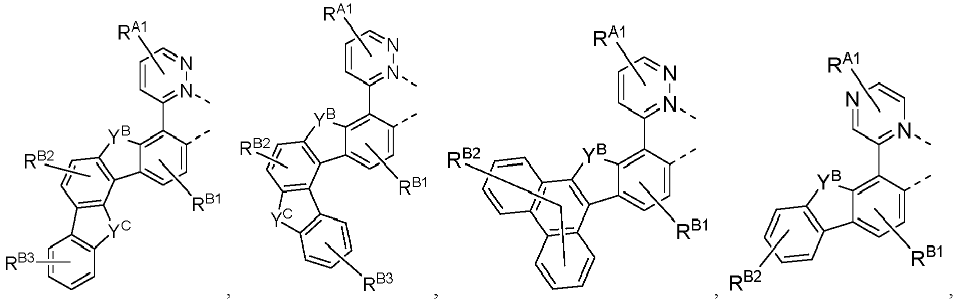 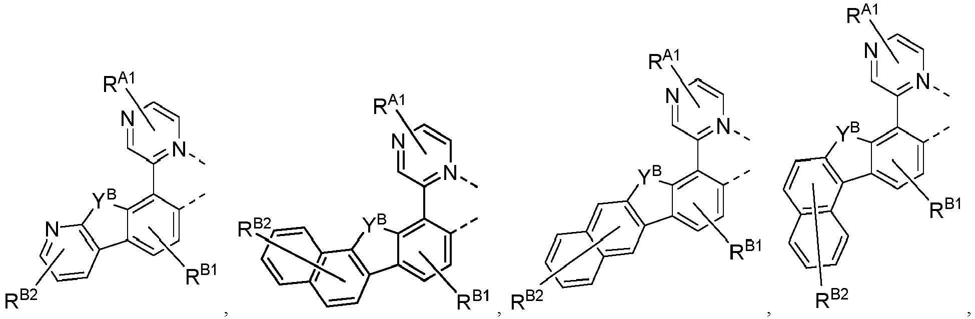 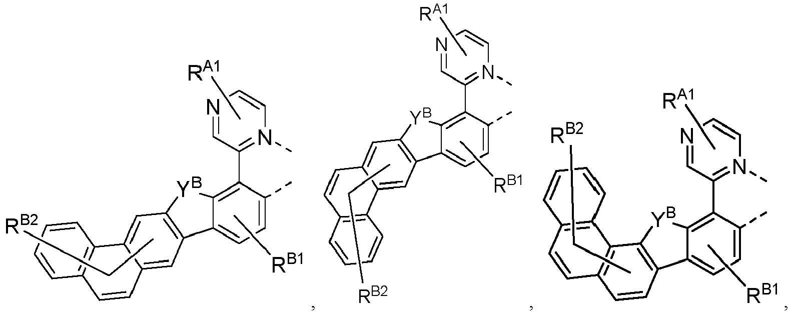 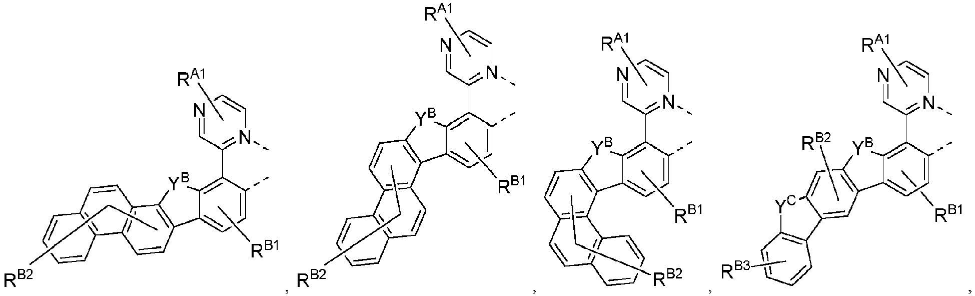 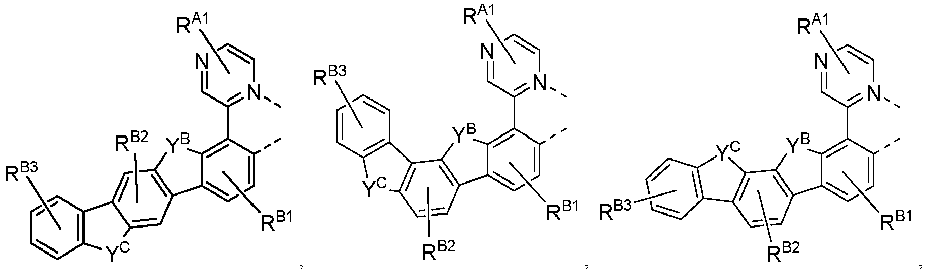 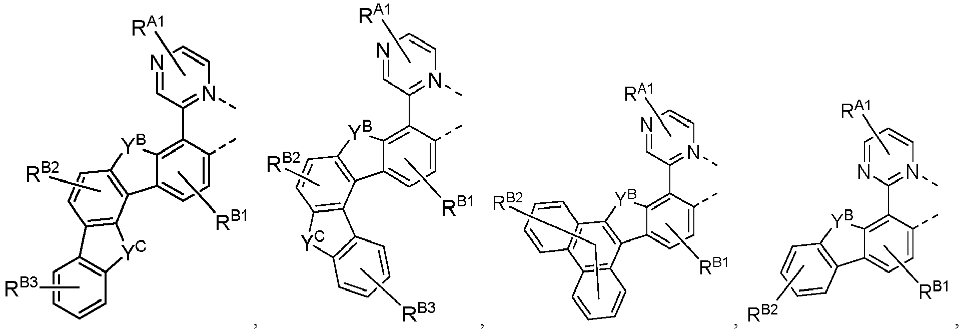 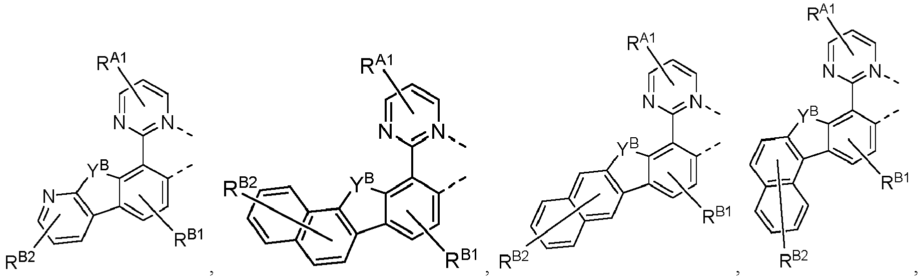 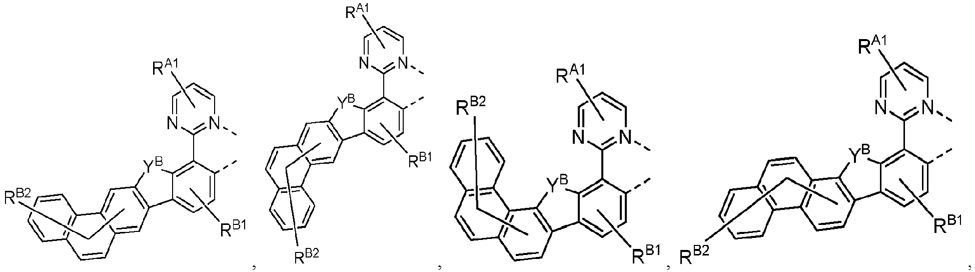 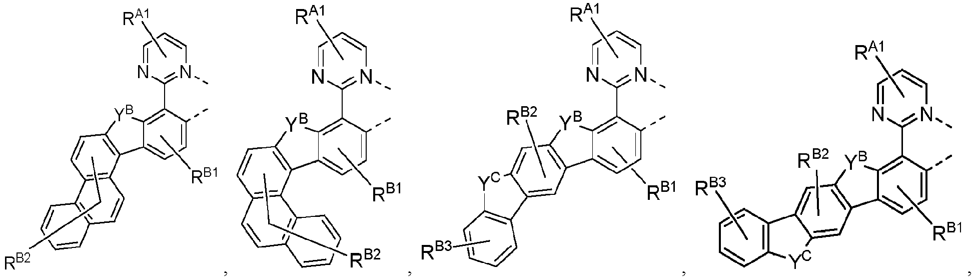 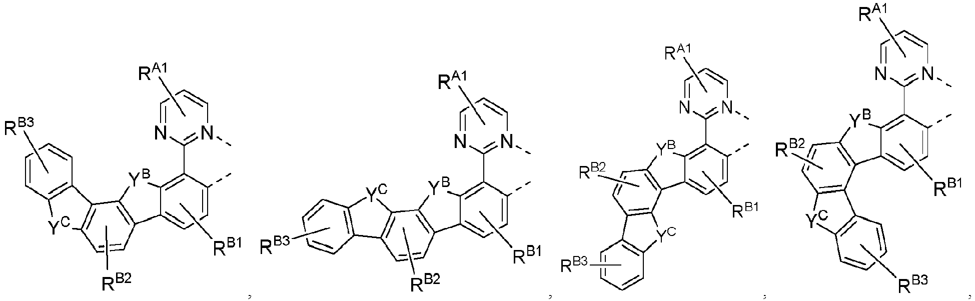 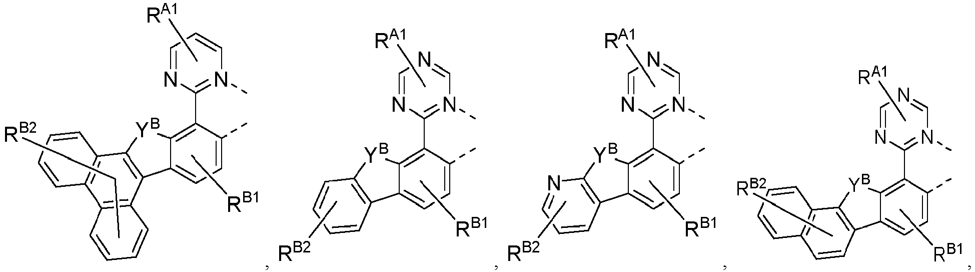 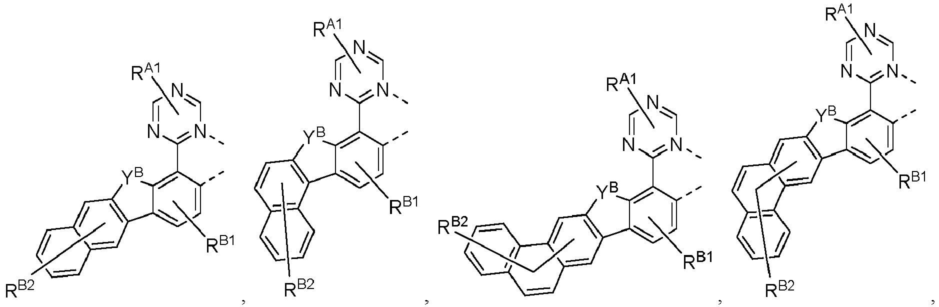 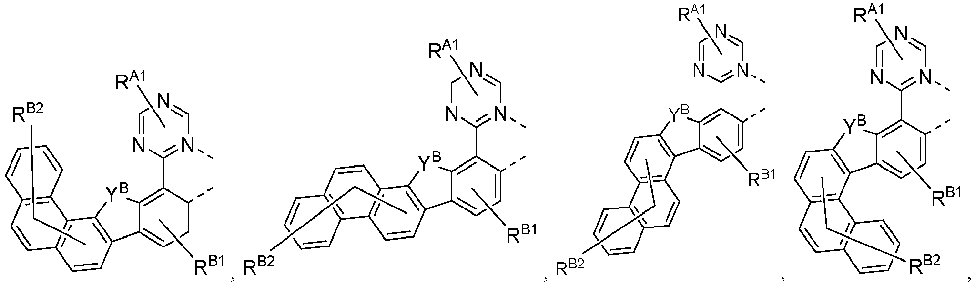 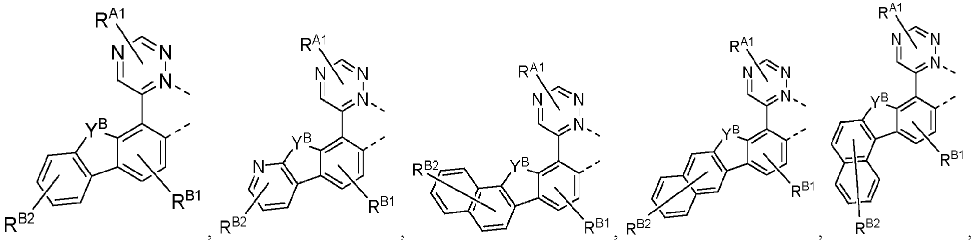 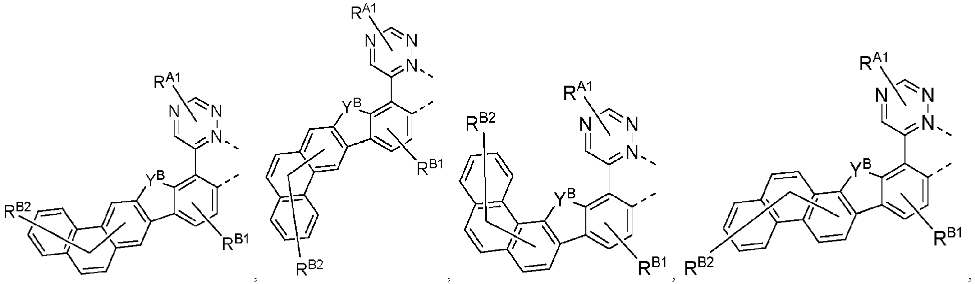 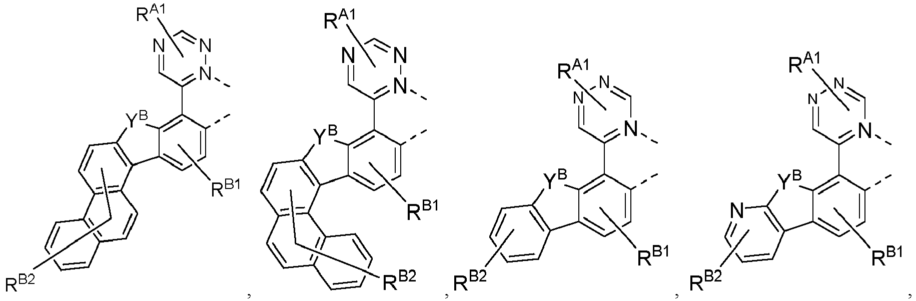 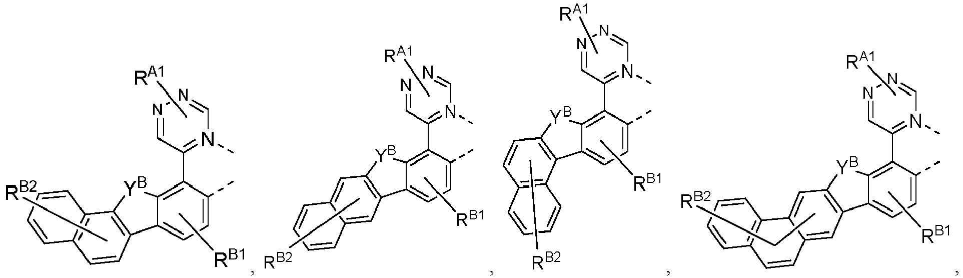 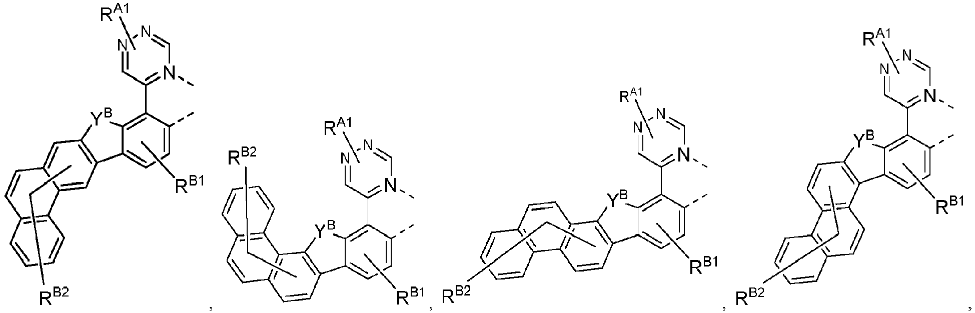 and 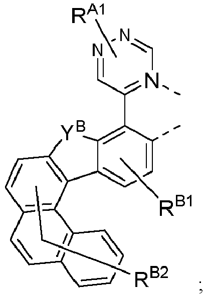 wherein:
each of Y^{A}, Y^{B}, and Y^{C} is independently selected from the group consisting of BRₑ, NRₑ, PRₑ, O, S, Se, C=O, S=O, SO₂, CRₑR_{f}, SiRₑR_{f}, and GeRₑR_{f'},
each R^{A1}, R^{B1}, R^{B2}, and R^{B3} independently represent from mono to the maximum possible number of substitutions, or no substitution;
each R^{A1}, R^{B1}, R^{B2}, R^{B3}, Rₑ, and R_{f} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof; and
any two substituents can be joined or fused to form a ring.

6. The compound of claim 1, wherein the ligand L_{A} is selected from L_{Ai}(R*m*)(R*n*)(R*o*)(R*p*), wherein *i* is an integer from 1 to 114, and each R*m*, R*n*, R*o*, and R*p* is independently selected from the group consisting of R1 to R115; wherein each of L_{A1}(R1)(R1)(R1)(R1) to L_{A114}(R115)(R115)(R115)(R115) is defined as follows:
| Compound | Structure of compound | Compound | Structure of compound |
|---|---|---|---|
| L_{A1}(R*m*)(R*n*)(R*o*)(R*p*), wherein L_{A1}(R1)(R1)(R1)(R1) to L_{A1}(R115)(R115)(R11 5)(R115) have the structure | 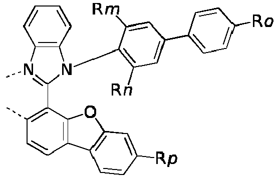 | L_{A2}(R*m*)(R*n*)(R*o*)( R*p*), wherein L_{A2}(R1)(R1)(R1)(R 1) to L_{A2}(R115)(R115)(R 115)(R115) have the structure | 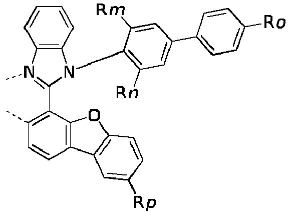 |
| L_{A3}(R*m*)(R*n*)(R*o*)(R*p*), wherein L_{A3}(R1)(R1)(R1)(R1) to L_{A3}(R115)(R115)(R11 5)(R115) have the structure | 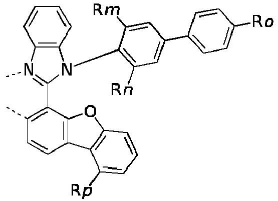 | L_{A4}(R*m*)(R*n*)(R*o*)( R*p*), wherein L_{A4}(R1)(R1)(R1)(R 1) to L_{A4}(R115)(R115)(R 115)(R115) have the structure | 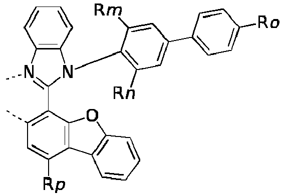 |
| L_{A5}(R*m*)(R*n*)(R*o*)(R*p*), wherein L_{A5}(R1)(R1)(R1)(R1) to L_{A5}(R115)(R115)(R11 5)(R115) have the structure | 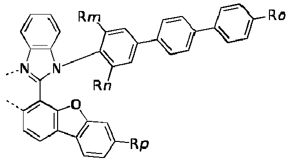 | L_{A6}(R*m*)(R*n*)(R*o*)( R*p*), wherein L_{A6}(R1)(R1)(R1)(R 1) to L_{A6}(R115)(R115)(R 115)(R115) have the structure | 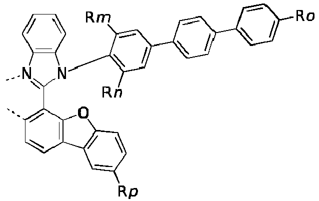 |
| L_{A7}(R*m*)(R*n*)(R*o*)(R*p*), wherein L_{A7}(R1)(R1)(R1)(R1) to L_{A7}(R115)(R115)(R11 5)(R115) have the structure | 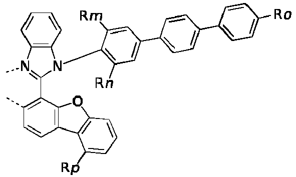 | L_{A8}(R*m*)(R*n*)(R*o*)( R*p*), wherein L_{A8}(R1)(R1)(R1)(R 1) to L_{A8}(R115)(R115)(R 115)(R115) have the structure | 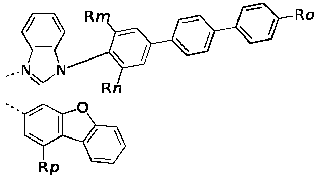 |
| L_{A9}(R*m*)(R*n*)(R*o*)(R*p*), wherein L_{A9}(R1)(R1)(R1)(R1) to L_{A9}(R115)(R115)(R11 5)(R115) have the structure | 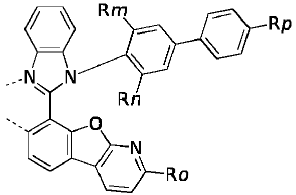 | L_{A10}(R*m*)(R*n*)(R*o*)( R*p*), wherein L_{A10}(R1)(R1)(R1)( R1) to L_{A10}(R115)(R115)( R115)(R115) have the structure | 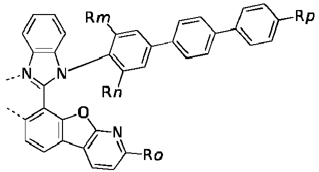 |
| L_{A11}(R*m*)(R*n*)(R*o*)(R*p*) , wherein L_{A11}(R1)(R1XR1)(R1) to L_{A11}(R115XR115XR11 5)(R115) have the structure | 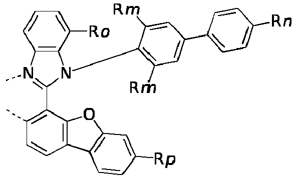 | L_{A12}(R*m*)(R*n*)(R*o*)( R*p*), wherein L_{A12}(R1)(R1)(R1)( R1) to L_{A12}(R115)(R115)( R115)(R115) have the structure | 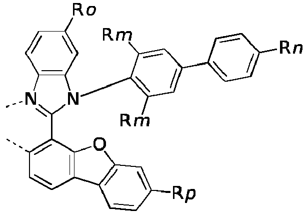 |
| L_{A13}(R*m*)(R*n*)(R*o*)(R*p* ), wherein L_{A13}(R1)(R1)(R1)(R1) to L_{A13}(R115)(R115)(R1 15)(R115) have the structure | 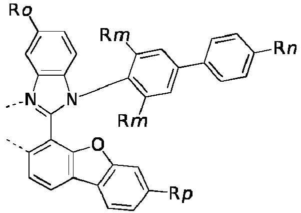 | L_{A14}(R*m*)(R*n*)(R*o*)( R*p*), wherein L_{A14}(R1)(R1)(R1)( R1) to L_{A14}(R115)(R115)( R115)(R115) have the structure | 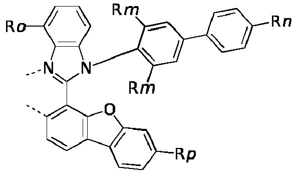 |
| L_{A15}(R*m*)(R*n*)(R*o*)(R*p* ), wherein L_{A15}(R1)(R1)(R1)(R1) to L_{A15}(R115)(R115)(R1 15)(R115) have the structure | 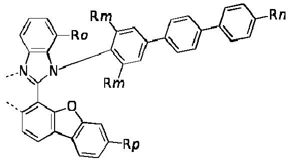 | L_{A16}(R*m*)(R*n*)(R*o*)( R*p*), wherein L_{A16}(R1)(R1)(R1)( R1) to L_{A16}(R115)(R115)( R115)(R115) have the structure | 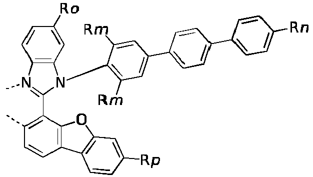 |
| L_{A17}(R*m*)(R*n*)(R*o*)(R*p* ), wherein L_{A17}(R1)(R1)(R1)(R1) to L_{A17}(R115)(R115)(R1 15)(R115) have the structure | 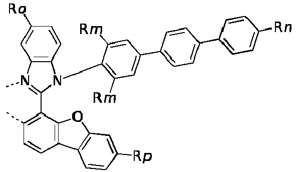 | L_{A18}(R*m*)(R*n*)(R*o*)( R*p*), wherein L_{A18}(R1)(R1)(R1)( R1) to L_{A18}(R115)(R115)( R115)(R115) have the structure | 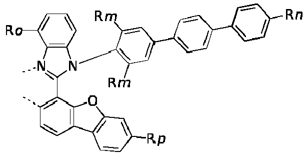 |
| L_{A19}(R*m*)(R*n*)(R*o*)(R*p* ), wherein L_{A19}(R1)(R1)(R1)(R1) to L_{A19}(R115)(R115)(R1 15)(R115) have the structure | 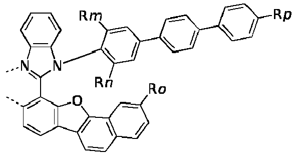 | L_{A20}(R*m*)(R*n*)(R*o*)( R*p*), wherein L_{A20}(R1)(R1)(R1)( R1) to L_{A20}(R115)(R115)( R115)(R115) have the structure | 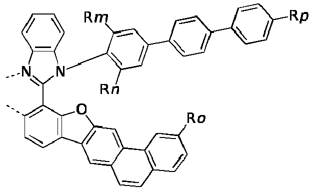 |
| L_{A21}(R*m*)(R*n*)(R*o*)(R*p* ), wherein L_{A21}(R1)(R1)(R1)(R1) to L_{A21}(R115)(R115)(R1 15)(R115) have the structure | 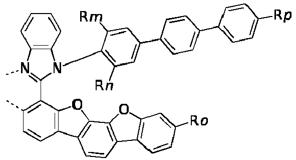 | L_{A22}(R*m*)(R*n*)(R*o*)( R*p*), wherein L_{A22}(R1)(R1)(R1)( R1) to L_{A22}(R115)(R115)( R115)(R115) have the structure | 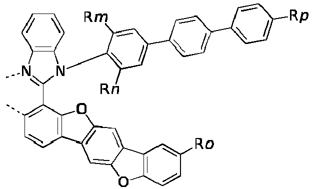 |
| L_{A23}(R*m*)(R*n*)(R*o*)(R*p* ), wherein L_{A23}(R1)(R1)(R1)(R1) to L_{A23}(R115)(R115)(R1 15)(R115) have the structure | 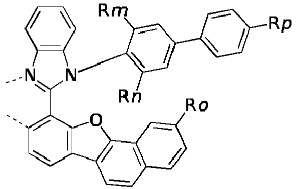 | L_{A24}(R*m*)(R*n*)(R*o*)( R*p*), wherein L_{A24}(R1)(R1)(R1)( R1) to L_{A24}(R115)(R115)( R115)(R115) have the structure | 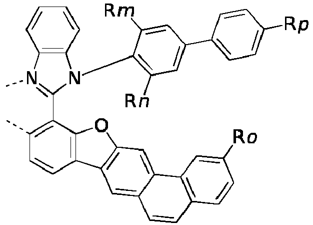 |
| L_{A25}(R*m*)(R*n*)(R*o*)(R*p* ), wherein L_{A25}(R1)(R1)(R1)(R1) to L_{A25}(R115)(R115)(R1 15)(R115) have the structure | 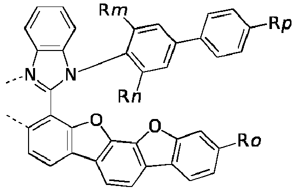 | L_{A26}(R*m*)(R*n*)(R*o*)( R*p*), wherein L_{A26}(R1)(R1)(R1)( R1) to L_{A26}(R115)(R115)( R115)(R115) have the structure | 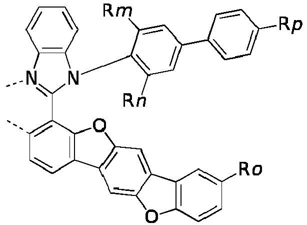 |
| L_{A27}(R*m*)(R*n*)(R*o*)(R*p* ), wherein L_{A27}(R1)(R1)(R1)(R1) to L_{A27}(R115)(R115)(R1 15)(R115) have the structure | 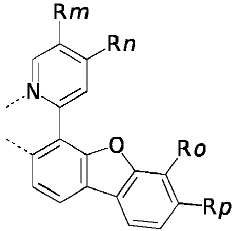 | L_{A28}(R*m*)(R*n*)(R*o*)( R*p*), wherein L_{A28}(R1)(R1)(R1)( R1) to L_{A28}(R115)(R115)( R115)(R115) have the structure | 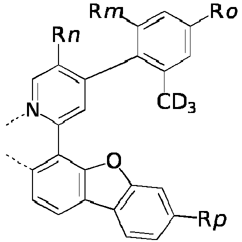 |
| L_{A29}(R*m*)(R*n*)(R*o*)(R*p* ), wherein L_{A29}(R1)(R1)(R1)(R1) to L_{A29}(R115)(R115)(R1 15)(R115) have the structure | 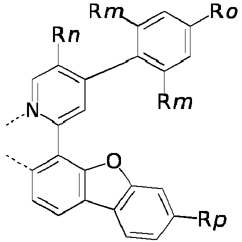 | L_{A30}(R*m*)(R*n*)(R*o*)( R*p*), wherein L_{A30}(R1)(R1)(R1)( R1) to L_{A30}(R115)(R115)( R115)(R115) have the structure | 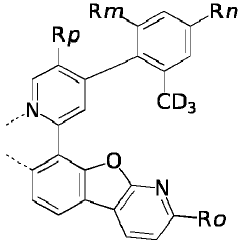 |
| L_{A31}(R*m*)(R*n*)(R*o*)(R*p* ), wherein L_{A31}(R1)(R1)(R1)(R1) to L_{A31}(R115)(R115)(R1 15)(R115) have the structure | 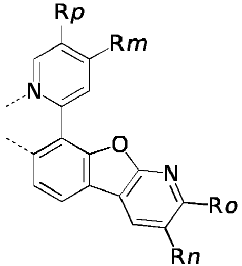 | L_{A32}(R*m*)(R*n*)(R*o*)( R*p*), wherein L_{A32}(R1)(R1)(R1)( R1) to L_{A32}(R115)(R115)( R115)(R115) have the structure | 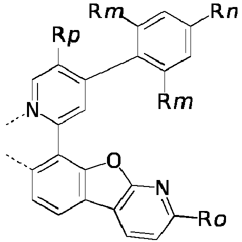 |
| L_{A33}(R*m*)(R*n*)(R*o*)(R*p* ), wherein L_{A33}(R1)(R1)(R1)(R1) to L_{A33}(R115)(R115)(R1 15)(R115) have the structure | 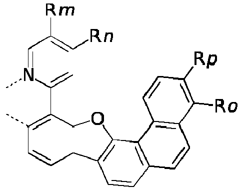 | L_{A34}(R*m*)(R*n*)(R*o*)( R*p*), wherein L_{A34}(R1)(R1)(R1)( R1) to L_{A34}(R115)(R115)( R115)(R115) have the structure | 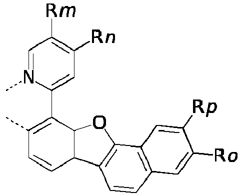 |
| L_{A35}(R*m*)(R*n*)(R*o*)(R*p* ), wherein L_{A35}(R1)(R1)(R1)(R1) to L_{A35}(R115)(R115)(R1 15)(R115) have the structure | 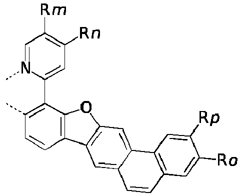 | L_{A36}(R*m*)(R*n*)(R*o*)( R*p*), wherein L_{A36}(R1)(R1)(R1)( R1) to L_{A36}(R115)(R115)( R115)(R115) have the structure | 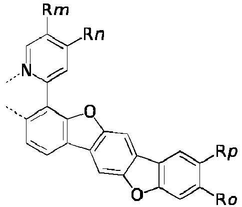 |
| L_{A37}(R*m*)(R*n*)(R*o*)(R*p* ), wherein L_{A37}(R1)(R1)(R1)(R1) to L_{A37}(R115)(R115)(R1 15)(R115) have the structure | 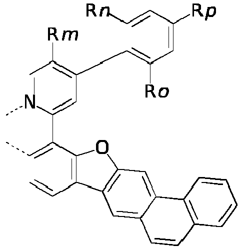 | L_{A38}(R*m*)(R*n*)(R*o*)( R*p*), wherein L_{A38}(R1)(R1)(R1)( R1) to L_{A38}(R115)(R115)( R115)(R115) have the structure | 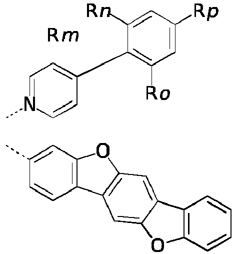 |
| L_{A39}(R*m*)(R*n*)(R*o*)(R*p* ), wherein L_{A39}(R1)(R1)(R1)(R1) to L_{A39}(R115)(R115)(R1 15)(R115) have the structure | 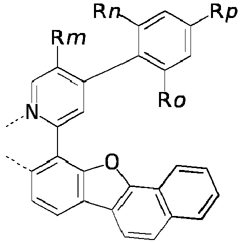 | L_{A40}(R*m*)(R*n*)(R*o*)( R*p*), wherein L_{A40}(R1)(R1)(R1)( R1) to L_{A40}(R115)(R115)( R115)(R115) have the structure | 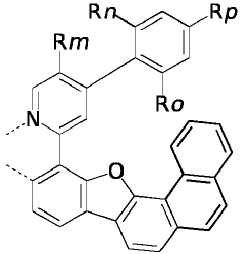 |
| L_{A41}(R*m*)(R*n*)(R*o*)(R*p* ), wherein L_{A41}(R1)(R1)(R1)(R1) to L_{A41}(R115)(R115)(R1 15)(R115) have the structure | 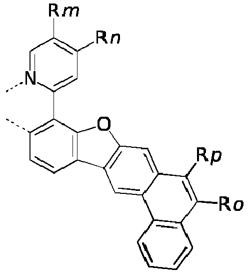 | L_{A42}(R*m*)(R*n*)(R*o*)( R*p*), wherein L_{A42}(R1)(R1)(R1)( R1) to L_{A42}(R115)(R115)( R115)(R115) have the structure | 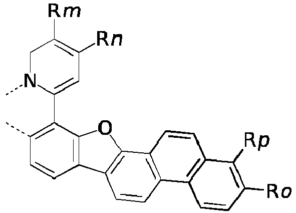 |
| L_{A43}(R*m*)(R*n*)(R*o*)(R*p* ), wherein L_{A43}(R1)(R1)(R1)(R1) to L_{A43}(R115)(R115)(R1 15)(R115) have the structure | 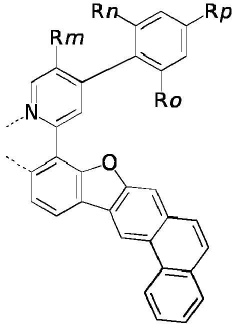 | L_{A44}(R*m*)(R*n*)(R*o*)( R*p*), wherein L_{A44}(R1)(R1)(R1)( R1) to L_{A44}(R115)(R115)( R115)(R115) have the structure | 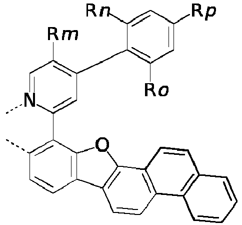 |
| L_{A44}(R*m*)(R*n*)(R*o*)(R*p* ), wherein L_{A45}(R1)(R1)(R1)(R1) to L_{A45}(R115)(R115)(R1 15)(R115) have the structure | 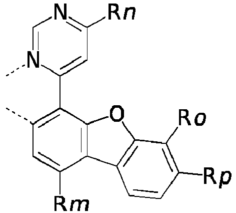 | L_{A46}(R*m*)(R*n*)(R*o*)( R*p*), wherein L_{A46}(R1)(R1)(R1)( R1) to L_{A46}(R115)(R115)( R115)(R115) have the structure | 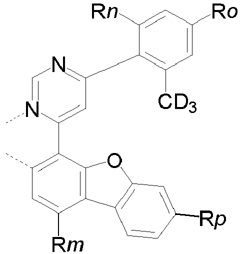 |
| L_{A47}(R*m*)(R*n*)(R*o*)(R*p* ), wherein L_{A47}(R1)(R1)(R1)(R1) to L_{A47}(R115)(R115)(R1 15)(R115) have the structure | 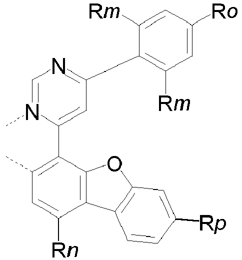 | L_{A48}(R*m*)(R*n*)(R*o*)( R*p*), wherein L_{A48}(R1)(R1)(R1)( R1) to L_{A48}(R115)(R115)( R115)(R115) have the structure | 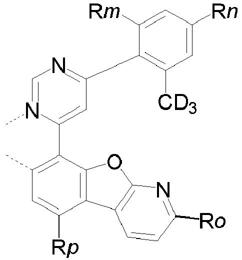 |
| L_{A49}(R*m*)(R*n*)(R*o*) (Rp), wherein L_{A49}(R1)(R1)(R1)(R1) to L_{A49}(R115)(R115)(R1 15)(R115) have the structure | 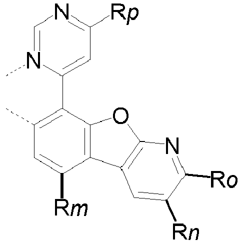 | L_{A50}(R*m*)(R*n*)(R*o*)( R*p*), wherein L_{A50}(R1)(R1)(R1)( R1) to L_{A50}(R115)(R115)( R115)(R115) have the structure | 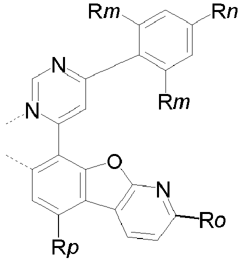 |
| L_{A51}(R*m*)(R*n*)(R*o*)(R*p* ), wherein L_{A51}(R1)(R1)(R1)(R1) to L_{A51}(R115)(R115)(R1 15)(R115) have the structure | 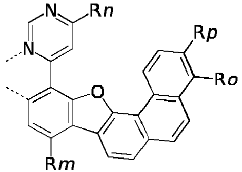 | L_{A52}(R*m*)(R*n*)(R*o*)( R*p*), wherein L_{A52}(R1)(R1)(R1)( R1) to L_{A52}(R115)(R115)( R115)(R115) have the structure | 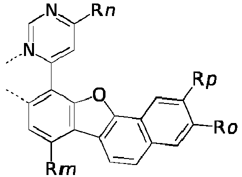 |
| L_{A53}(R*m*)(R*n*)(R*o*)(R*p* ), wherein L_{A53}(R1)(R1)(R1)(R1) to L_{A53}(R115)(R115)(R1 15)(R115) have the structure | 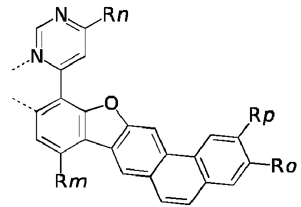 | L_{A54}(R*m*)(R*n*)(R*o*)( R*p*), wherein L_{A54}(R1)(R1)(R1)( R1) to L_{A54}(R115)(R115)( R115)(R115) have the structure | 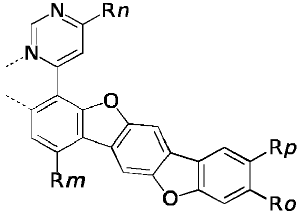 |
| L_{A55}(R*m*)(R*n*)(R*o*)(R*p* ), wherein L_{A55}(R1)(R1)(R1)(R1) to L_{A55}(R115)(R115)(R1 15)(R115) have the structure | 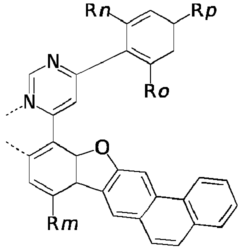 | L_{A56}(R*m*)(R*n*)(R*o*)( R*p*), wherein L_{A36}(R1)(R1)(R1)( R1) to L_{A56}(R115)(R115)( R115)(R115) have the structure | 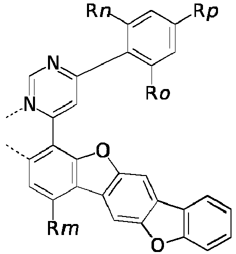 |
| L_{A57}(R*m*)(R*n*)(R*o*)(R*p* ), wherein L_{A57}(R1)(R1)(R1)(R1) to L_{A57}(R115)(R115)(R1 15)(R115) have the structure | 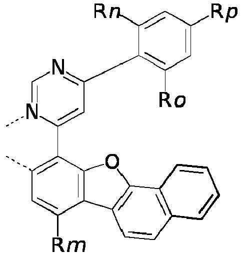 | L_{A58}(R*m*)(R*n*)(R*o*)( R*p*), wherein L_{A58}(R1)(R1)(R1)( R1) to L_{A58}(R115)(R115)( R115)(R115) have the structure | 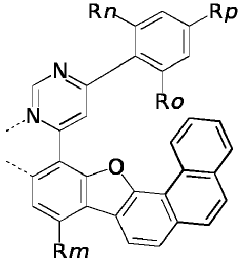 |
| L_{A59}(R*m*)(R*n*)(R*o*)(R*p* ), wherein L_{A59}(R1)(R1)(R1)(R1) to L_{A59}(R115)(R115)(R1 15)(R115) have the structure | 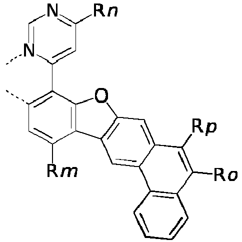 | L_{A60}(R*m*)(R*n*)(R*o*)( R*p*), wherein L_{A60}(R1)(R1)(R1)( R1) to L_{A60}(R115)(R115)( R115)(R115) have the structure | 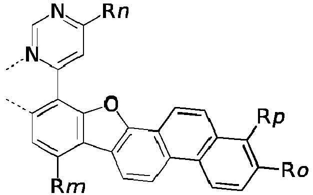 |
| L_{A61}(R*m*)(R*n*)(R*o*)(R*p* ), wherein L_{A61}(R1)(R1)(R1)(R1) to L_{A61}(R115)(R115)(R1 15)(R115) have the structure | 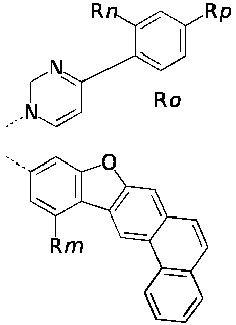 | L_{A62}(R*m*)(R*n*)(R*o*)( R*p*), wherein L_{A62}(R1)(R1)(R1)( R1) to L_{A62}(R115)(R115)( R115)(R115) have the structure | 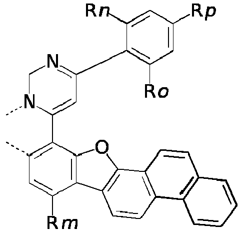 |
| L_{A63}(R*m*)(R*n*)(R*o*)(R*p* ), wherein L_{A63}(R1)(R1)(R1)(R1) to L_{A63}(R115)(R115)(R1 15)(R115) have the structure | 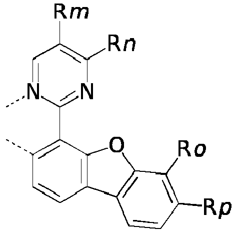 | L_{A64}(R*m*)(R*n*)(R*o*)( R*p*), wherein L_{A64}(R1)(R1)(R1)( R1) to L_{A64}(R115)(R115)( R115)(R115) have the structure | 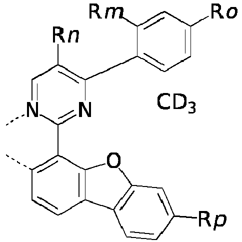 |
| L_{A65}(R*m*)(R*n*)(R*o*)(R*p* ), wherein L_{A65}(R1)(R1)(R1)(R1) to L_{A65}(R115)(R115)(R1 15)(R115) have the structure | 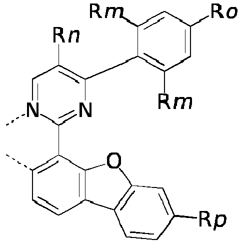 | L_{A66}(R*m*)(R*n*)(R*o*)( R*p*), wherein L_{A66}(R1)(R1)(R1)( R1) to L_{A66}(R115)(R1 15)( R115)(R115) have the structure | 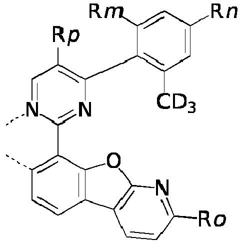 |
| L_{A67}(R*m*)(R*n*)(R*o*)(R*p* ), wherein L_{A67}(R1)(R1)(R1)(R1) to L_{A67}(R115)(R115)(R1 15)(R115) have the structure | 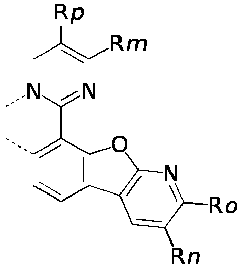 | L_{A68}(R*m*)(R*n*)(R*o*)( R*p*), wherein L_{A68}(R1)(R1)(R1)( R1) to L_{A68}(R115)(R115)( R115)(R115) have the structure | 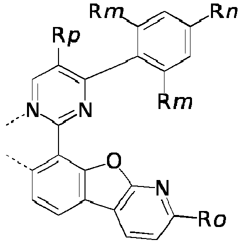 |
| L_{A69}(R*m*)(R*n*)(R*o*)(R*p* ), wherein L_{A69}(R1)(R1)(R1)(R1) to L_{A69}(R115)(R115)(R1 15)(R115) have the structure | 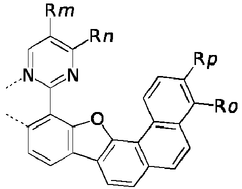 | L_{A70}(R*m*)(R*n*)(R*o*)( R*p*), wherein L_{A70}(R1)(R1)(R1)( R1) to L_{A70}(R115)(R115)( R115)(R115) have the structure | 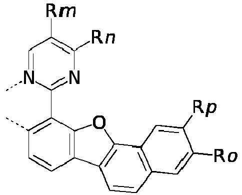 |
| L_{A71}(R*m*)(R*n*)(R*o*)(R*p* ), wherein L_{A71}(R1)(R1)(R1)(R1) to L_{A71}(R115)(R115)(R1 15)(R115) have the structure | 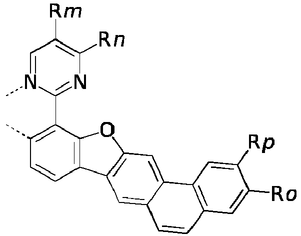 | L_{A72}(R*m*)(R*n*)(R*o*)( R*p*), wherein L_{A72}(R1)(R1)(R1)( R1) to L_{A72}(R115)(R1 15)( R115)(R115) have the structure | 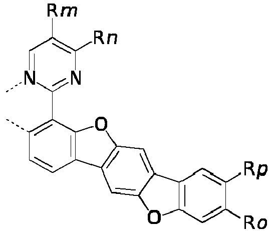 |
| L_{A73}(R*m*)(R*n*)(R*o*)(R*p* ), wherein L_{A73}(R1)(R1)(R1)(R1) to L_{A73}(R115)(R115)(R1 15)(R115) have the structure | 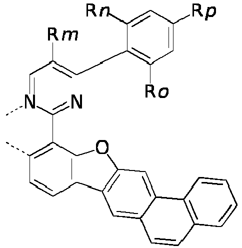 | L_{A74}(R*m*)(R*n*)(R*o*)( R*p*), wherein L_{A74}(R1)(R1)(R1)( R1) to L_{A74}(R115)(R115)( R115)(R115) have the structure | 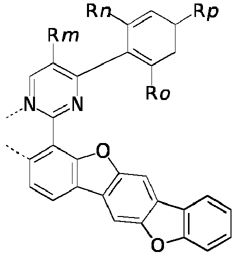 |
| L_{A75}(R*m*)(R*n*)(R*o*)(R*p* ), wherein L_{A75}(R1)(R1)(R1)(R1) to L_{A75}(R115)(R115)(R1 15)(R115) have the structure | 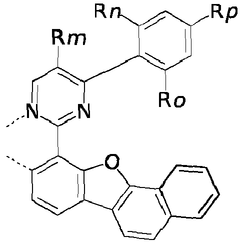 | L_{A76}(R*m*)(R*n*)(R*o*)( R*p*), wherein L_{A76}(R1)(R1)(R1)( R1) to L_{A76}(R115)(R115)( R115)(R115) have the structure | 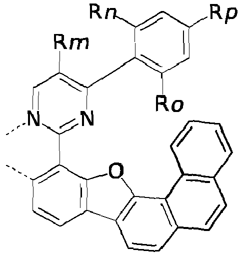 |
| L_{A77}(R*m*)(R*n*)(R*o*)(R*p* ), wherein L_{A77}(R1)(R1)(R1)(R1) to L_{A77}(R115)(R115)(R1 15)(R115) have the structure | 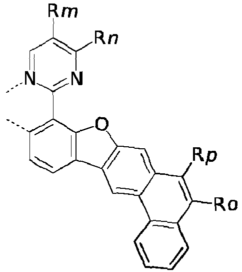 | L_{A78}(R*m*)(R*n*)(R*o*)( R*p*), wherein L_{A78}(R1)(R1)(R1)( R1) to 15)(R115)( R115)(R115) have the structure | 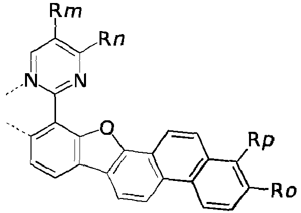 |
| L_{A79}(R*m*)(R*n*)(R*o*)(R*p* ), wherein L_{A79}(R1)(R1)(R1)(R1) to L_{A79}(R115)(R115)(R1 15)(R115) have the structure | 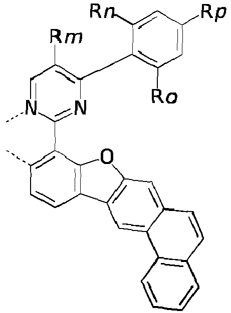 | L_{A80}(R*m*)(R*n*)(R*o*)( R*p*), wherein L_{A80}(R1)(R1)(R1)( R1) to L_{A80}(R115)(R115)( R115XR115) have the structure | 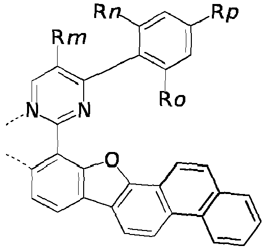 |
| L_{A81}(R*m*)(R*n*)(R*o*)(R*p* ), wherein L_{A81}(R1)(R1)(R1)(R1) to L_{A81}(R115)(R115)(R1 15)(R115) have the structure | 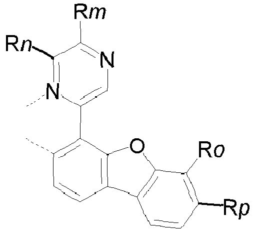 | L_{A82}(R*m*)(R*n*)(R*o*)( R*p*), wherein L_{A82}(R1)(R1)(R1)( R1) to L_{A82}(R115)(R115)( R115)(R115) have the structure | 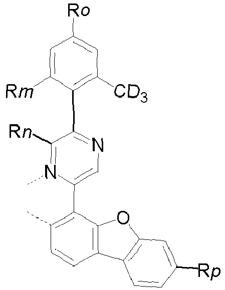 |
| L_{A83}(R*m*)(R*n*)(R*o*)(R*p* ), wherein L_{A83}(R1)(R1)(R1XR1) to L_{A83}(R115)(R115)(R1 15)(R115) have the structure | 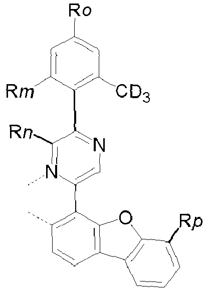 | L_{A84}(R*m*)(R*n*)(R*o*)( R*p*), wherein L_{A84}(R1)(R1)(R1)( Rl) to L_{A84}(R115)(R115)( R115)(R115) have the structure | 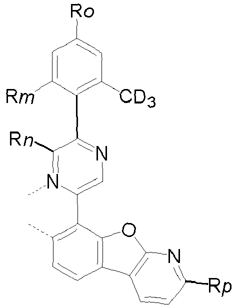 |
| L_{A85}(R*m*)(R*n*)(R*o*)(R*p* ), wherein L_{A85}(R1)(R1)(R1)(R1) to L_{A85}(R115)(R115)(R1 15)(R115) have the structure | 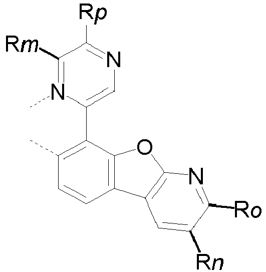 | L_{A86}(R*m*)(R*n*)(R*o*)( R*p*), wherein L_{A36}(R1)(R1)(R1)( R1) to L_{A86}(R115)(R115)( R115)(R115) have the structure | 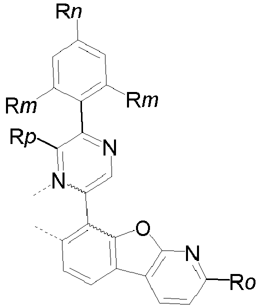 |
| L_{A87}(R*m*)(R*n*)(R*o*)(R*p* ), wherein L_{A87}(R1)(R1)(R1)(R1) to L_{A87}(R115)(R115)(R1 15)(R115) have the structure | 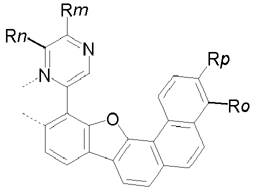 | L_{A88}(R*m*)(R*n*)(R*o*)( R*p*), wherein L_{A88}(R1)(R1)(R1)( R1) to L_{A88}(R115)(R115)( R115)(R115) have the structure | 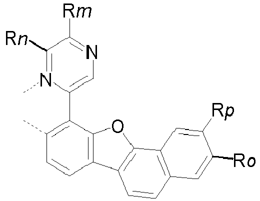 |
| L_{A89}(R*m*)(R*n*)(R*o*)(R*p* ), wherein L_{A89}(R1)(R1)(R1)(R1) to L_{A89}(R115)(R115)(R1 15)(R115) have the structure | 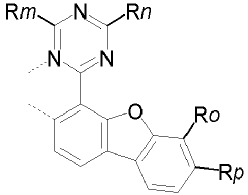 | L_{A90}(R*m*)(R*n*)(R*o*)( R*p*), wherein L_{A90}(R1)(R1)(R1)( R1) to L_{A90}(R115)(R115)( R115)(R115) have the structure | 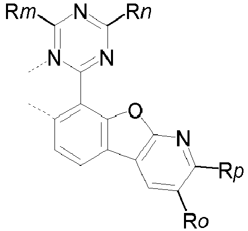 |
| L_{A91}(R*m*)(R*n*)(R*o*)(R*p* ), wherein L_{A91}(R1)(R1)(R1)(R1) to L_{A91}(R115)(R115)(R1 15)(R115) have the structure | 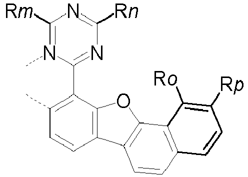 | L_{A92}(R*m*)(R*n*)(R*o*)( R*p*), wherein L_{A92}(R1)(R1)(R1)( R1) to L_{A92}(R115)(R115)( R115)(R115) have the structure | 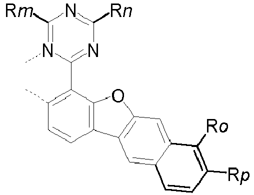 |
| L_{A93}(R*m*)(R*n*)(R*o*)(R*p* ), wherein L_{A93}(R1)(R1)(R1)(R1) to L_{A93}(R115)(R115)(R1 15)(R115) have the structure | 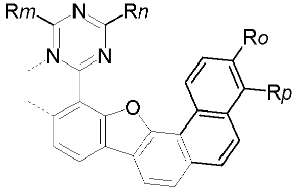 | L_{A94}(R*m*)(R*n*)(R*o*)( R*p*), wherein L_{A94}(R1)(R1)(R1)( R1) to L_{A94}(R115)(R115)( R115)(R115) have the structure | 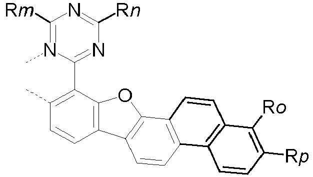 |
| L_{A95}(R*m*)(R*n*)(R*o*)(R*p* ), wherein L_{A95}(R1)(R1)(R1)(R1) to L_{A95}(R115)(R115)(R1 15)(R115) have the structure | 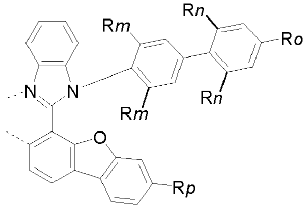 | L_{A96}(R*m*)(R*n*)(R*o*)( R*p*), wherein L_{A96}(R1)(R1)(R1)( R1) to L_{A96}(R115)(R115)( R115)(R115) have the structure | 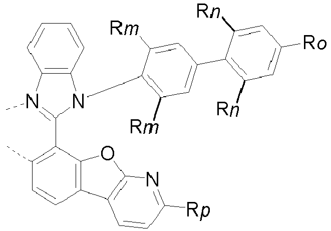 |
| L_{A97}(R*m*)(R*n*)(R*o*)(R*p* ), wherein L_{A97}(R1)(R1)(R1)(R1) to L_{A97}(R115)(R115)(R1 15)(R115) have the structure | 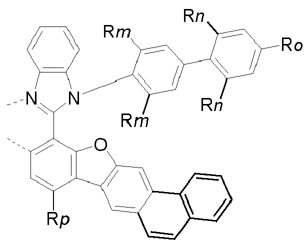 | L_{A98}(R*m*)(R*n*)(R*o*)( R*p*), wherein L_{A98}(R1)(R1)(R1)( R1) to L_{A98}(R115)(R115)( R115)(R115) have the structure | 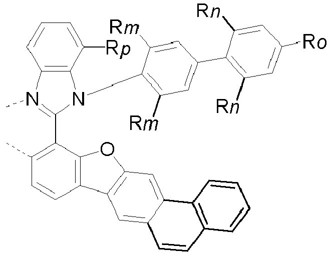 |
| L_{A99}(R*m*)(R*n*)(R*o*)(R*p* ), wherein L_{A99}(R1)(R1)(R1)(R1) to L_{A99}(R115)(R115)(R1 15)(R115) have the structure | 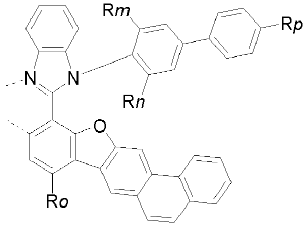 | L_{A100}(R*m*)(R*n*)(R*o*)( (R*p*), wherein L_{A100}(R1)(R1)(R1)( R1) to L_{A100}(R115)(R115)( R115)(R115) have the structure | 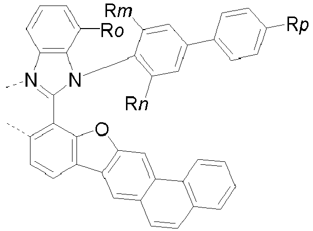 |
| L_{A101}(R*m*)(R*n*)(R*o*)(R p), wherein L_{A101}(R1)(R1)(R1)(R1 ) to L_{A101}(R115)(R115)(R1 15)(R115) have the structure | 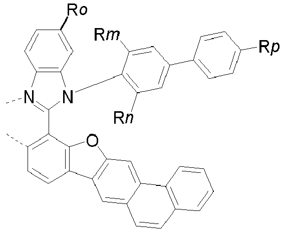 | L_{A102}(R*m*)(R*n*)(R*o*) (R*p*), wherein L_{A102}(R1)(R1)(R1)( R1) to L_{A102}(R115)(R115)( R115)(R115) have the structure | 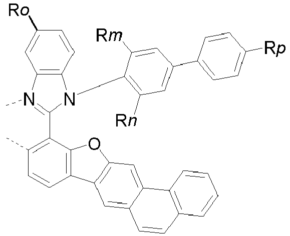 |
| L_{A103}(R*m*)(R*n*)(R*o*)(R p), wherein L_{A103}(R1)(R1)(R1)(R1 ) to L_{A103}(R115)(R115)(R1 15)(R115) have the structure | 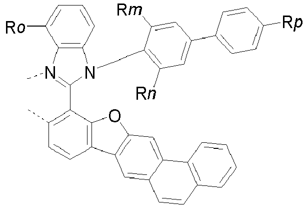 | L_{A104}(R*m*)(R*n*)(R*o*) (R*p*), wherein L_{A104}(R1)(R1)(R1)( R1) to L_{A104}(R115)(R115)( R115)(R115) have the structure | 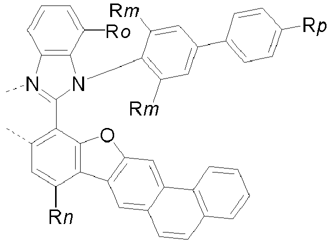 |
| L_{A105}(R*m*)(R*n*)(R*o*)(R p), wherein L_{A105}(R1)(R1)(R1)(R1 ) to L_{A105}(R115)(R115)(R1 15)(R115) have the structure | 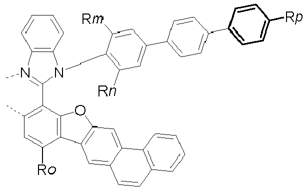 | L_{A106}(R*m*)(R*n*)(R*o*) (R*p*), wherein L_{A106}(R1)(R1)(R1)( R1) to L_{A106}(R115)(R115)( R115)(R115) have the structure | 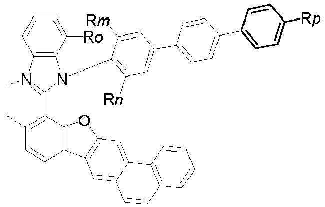 |
| L_{A107}(R*m*)(R*n*)(R*o*)(R p), wherein L_{A107}(R1)(R1)(R1)(R1 ) to L_{A107}(R115)(R115)(R1 15)(R115) have the structure | 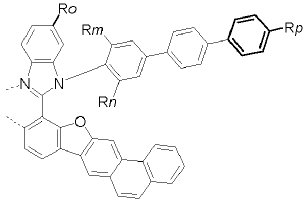 | L_{A108}(R*m*)(R*n*)(R*o*) (R*p*), wherein L_{A108}(R1)(R1)(R1)( R1) to L_{A108}(R115)(R115)( R115)(R115) have the structure | 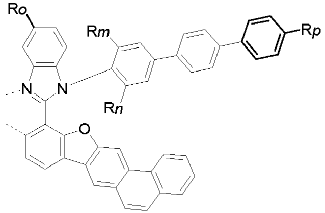 |
| L_{A109}(R*m*)(R*n*)(R*o*)(R p), wherein L_{A109}(R1)(R1)(R1)(R1 ) to L_{A109}(R115)(R115)(R1 15)(R115) have the structure | 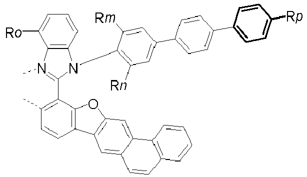 | L_{A110}(R*m*)(R*n*)(R*o*) (R*p*), wherein L_{A110}(R1)(R1)(R1)( R1) to L_{A110}(R115)(R115)( R115)(R115) have the structure | 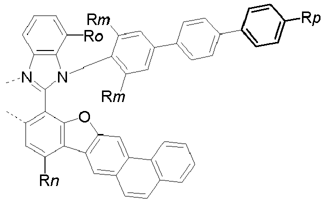 |
| L_{A111}(R*m*)(R*n*)(R*o*)(R*p* ), wherein L_{A111}(R1)(R1)(R1)(R1 ) to L_{A111}(R115)(R115)(R1 15)(R115) have the structure | 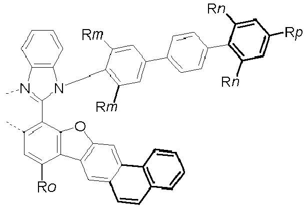 | L_{A112}(R*m*)(R*n*)(R*o*) (R*p*), wherein L_{A112}(R1)(R1)(R1)( R1) to L_{A112}(R115)(R115)( R115)(R115) have the structure | 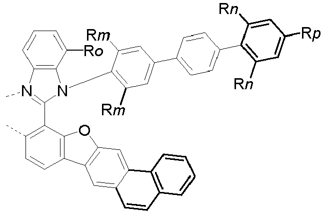 |
| L_{A113}(R*m*)(R*n*)(R*o*)(R*p* ), wherein L_{A113}(R1)(R1)(R1)(R1 ) to L_{A113}(R115)(R115)(R1 15)(R115) have the structure | 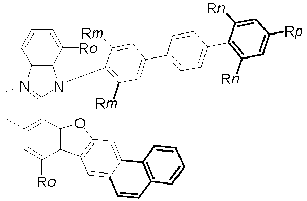 | L_{A114}(R*m*)(R*n*)(R*o*) (R*p*), wherein L_{A114}(R1)(R1)(R1)( R1) to L_{A114}(R115)(R115)( R115)(R115) have the structure | 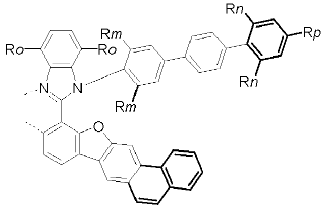 |
wherein R1 to R115 each have the structures defined in the following LIST 4:

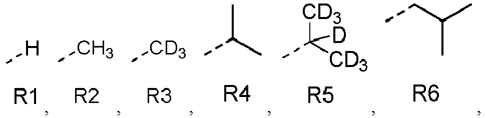

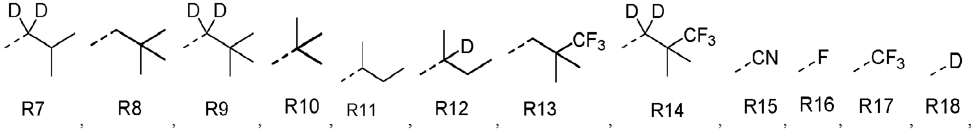

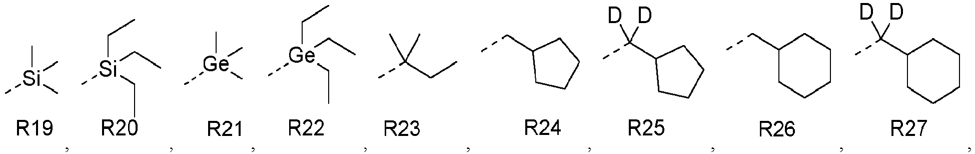

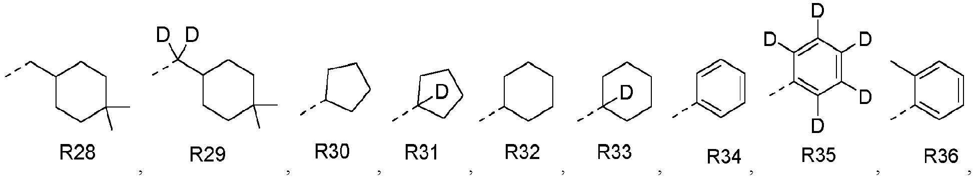

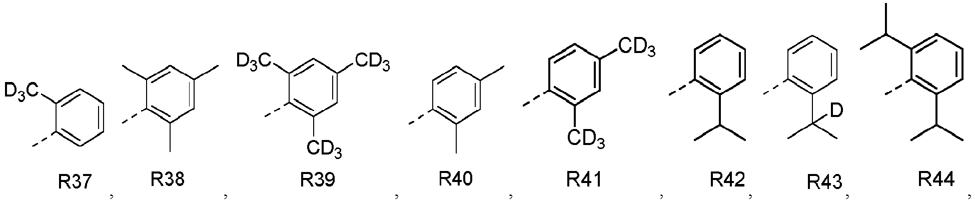

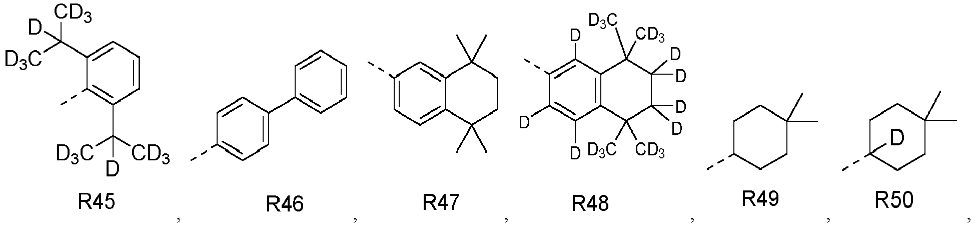

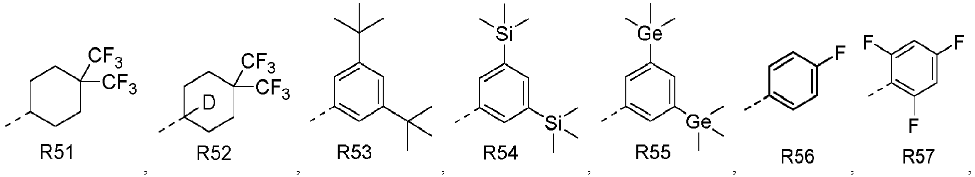

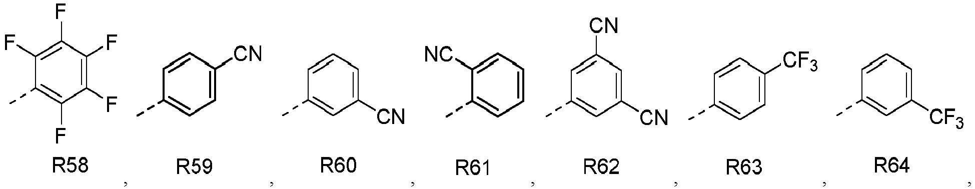

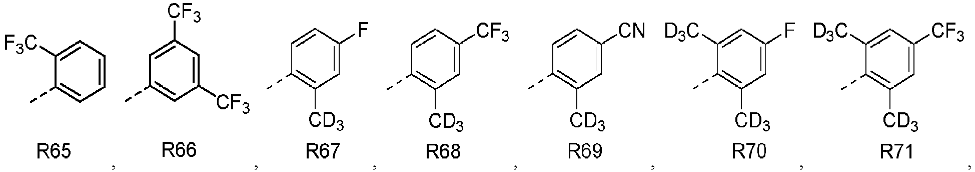

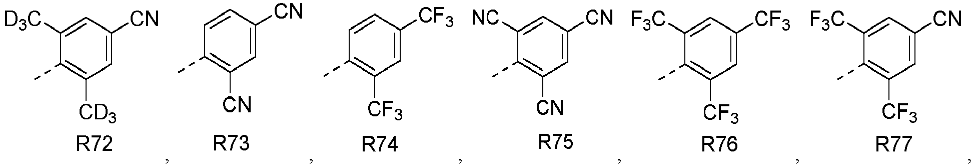

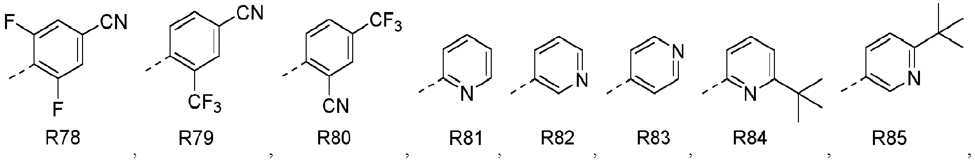

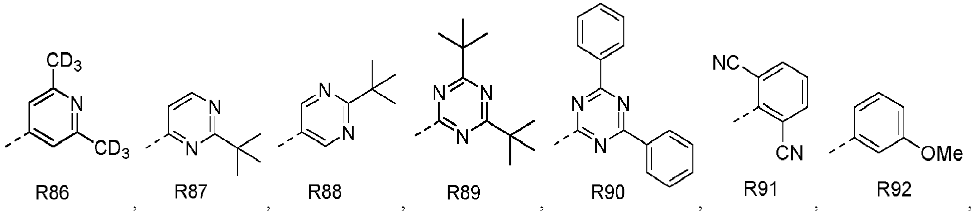

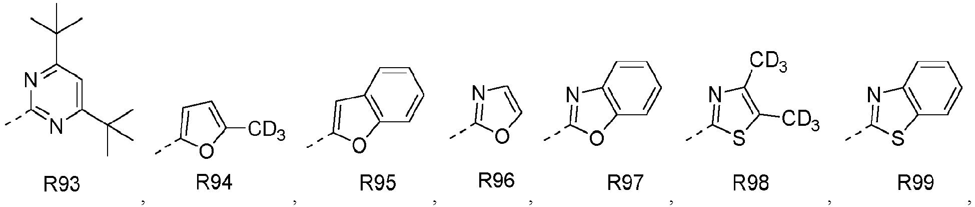

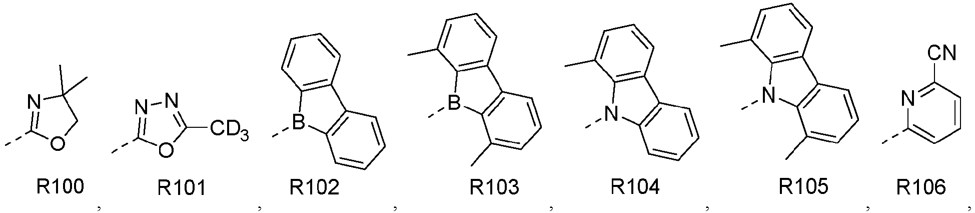

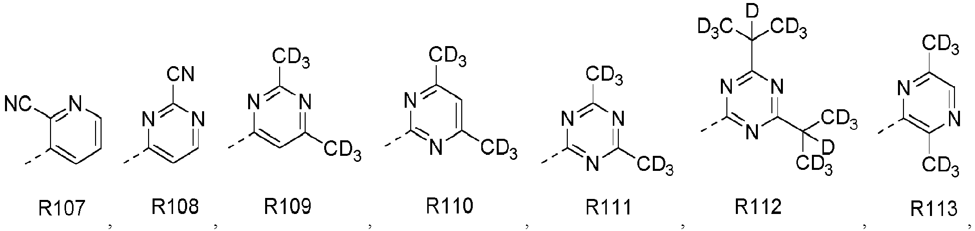

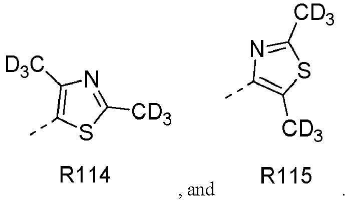

7. The compound of any one of claims 1 to 6, wherein ligand L_{B} is selected from the group consisting of 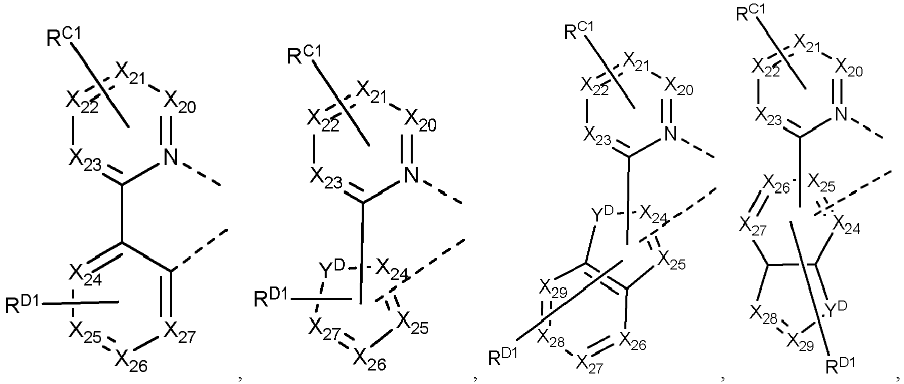 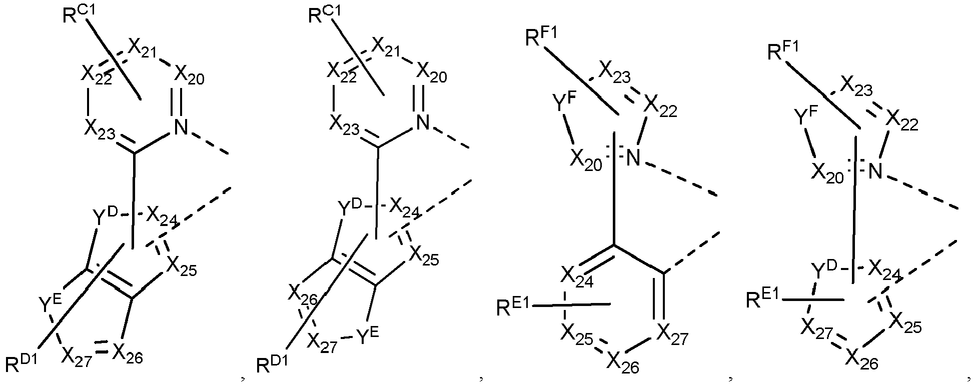 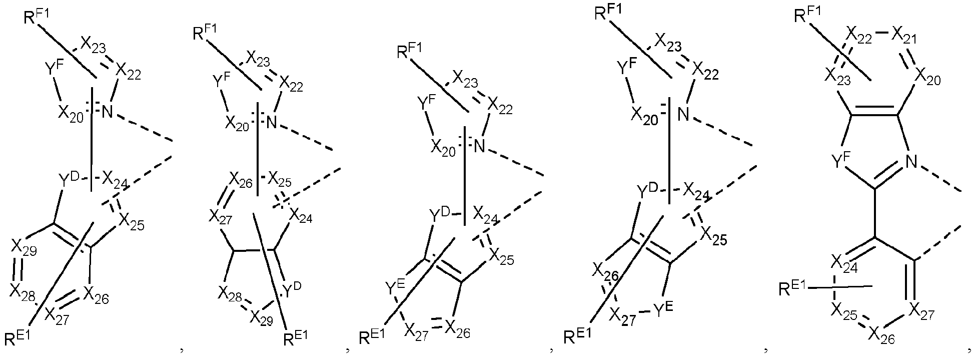 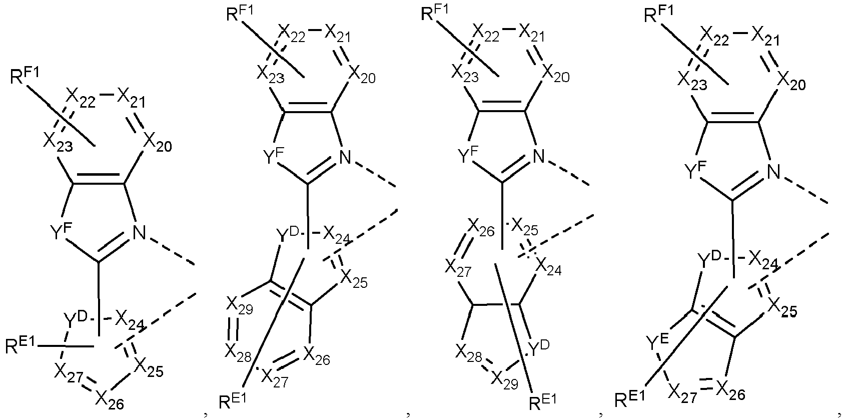 and 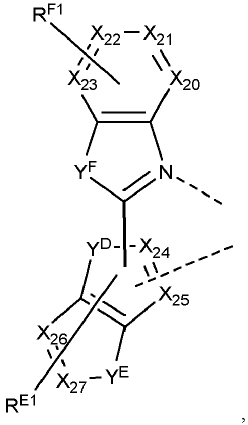 wherein:
each of X₂₀ to X₂₉ is independently C or N;
each of Y^{D}, Y^{E}, and Y^{F} is independently selected from the group consisting of BRₑ, NRₑ, PRₑ, O, S, Se, C=O, S=O, SO₂, CRₑR_{f}, SiRₑR_{f}, and GeRₑR_{f};
each of R^{C1}, R^{D1}, R^{E1}, and R^{E1} independently represents from mono to the maximum possible number of substitutions, or no substitutions;
each R^{C1}, R^{D1}, R^{E1}, R^{F1}, Rₑ, and Rf is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof; and
any two substituents can be joined or fused to form a ring.

8. The compound of any one of claims 1 to 7, wherein the ligand L_{B} is selected from the group consisting of 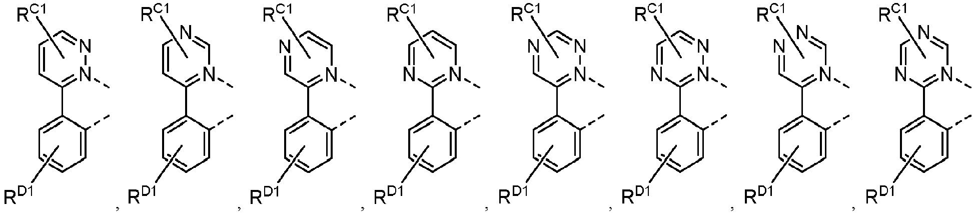 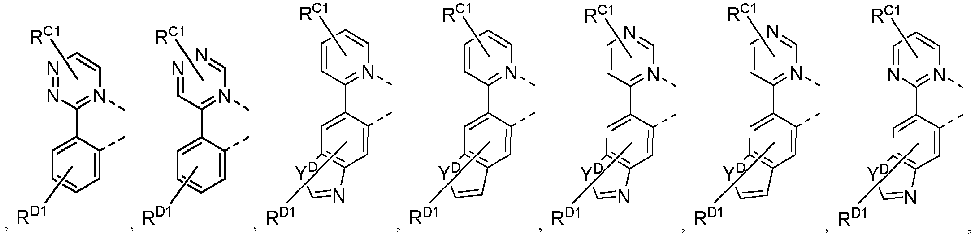 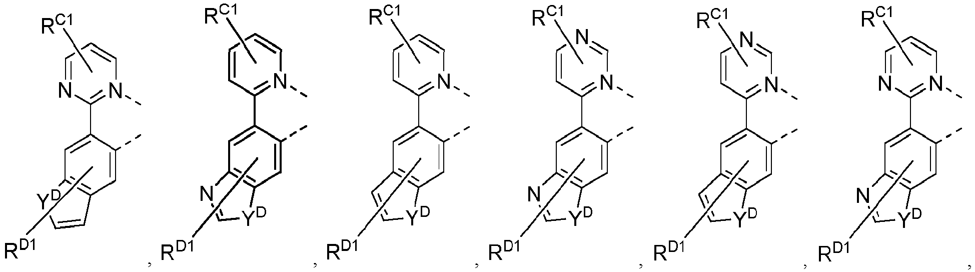 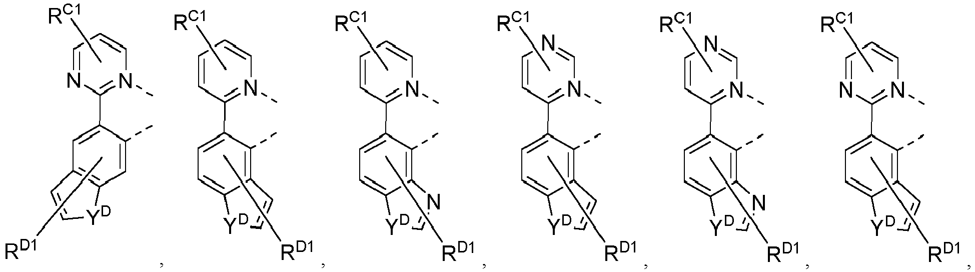 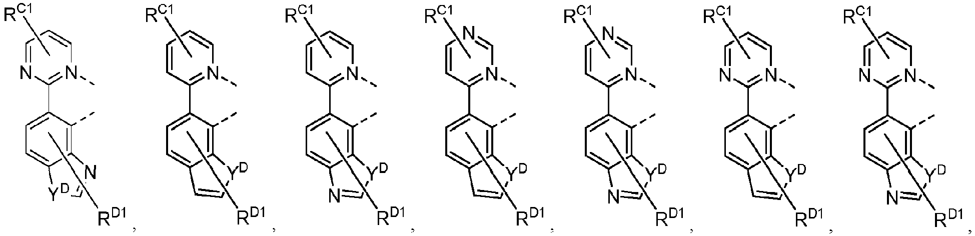 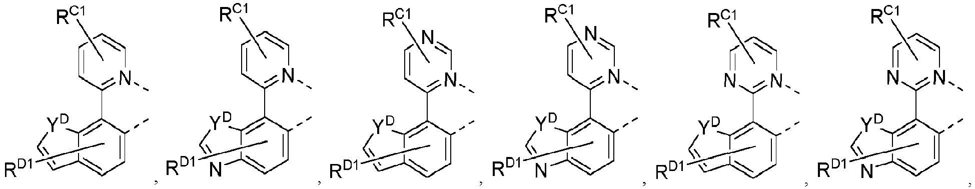 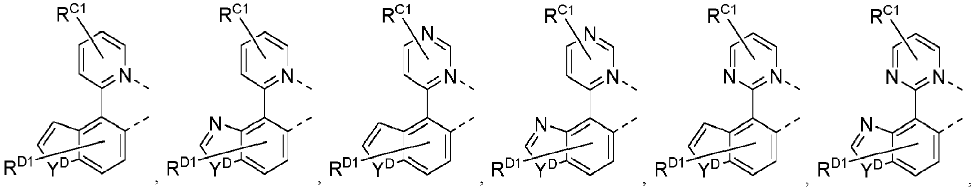 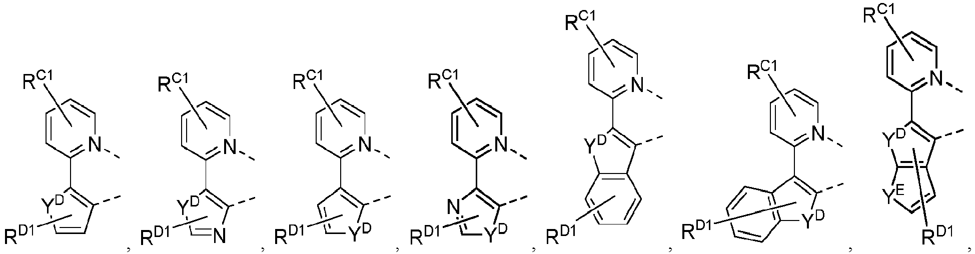 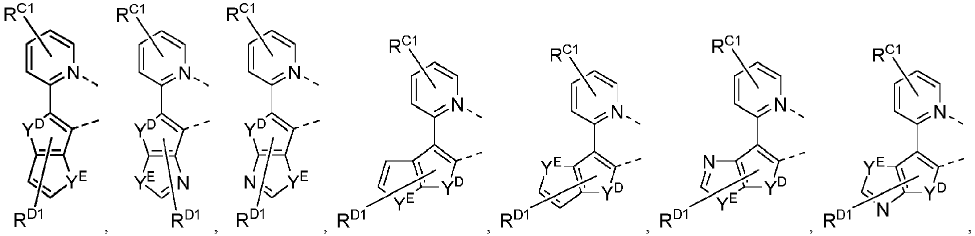 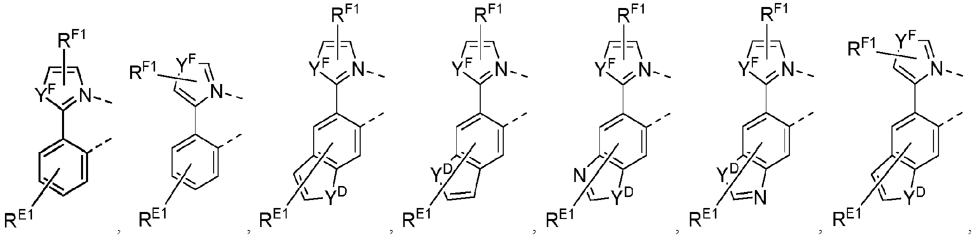 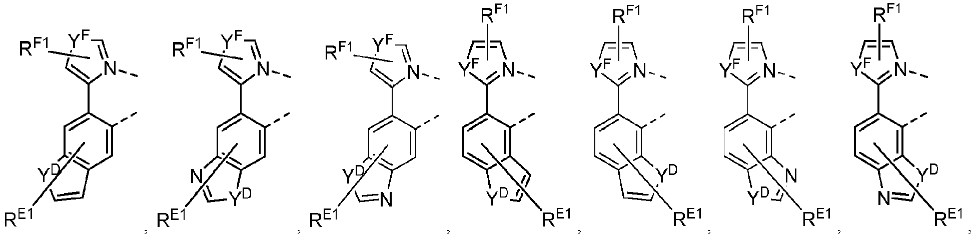 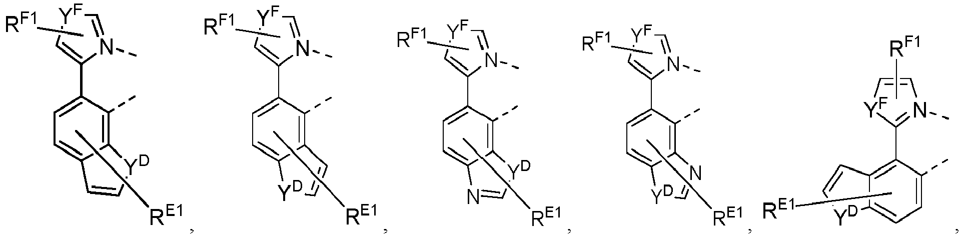 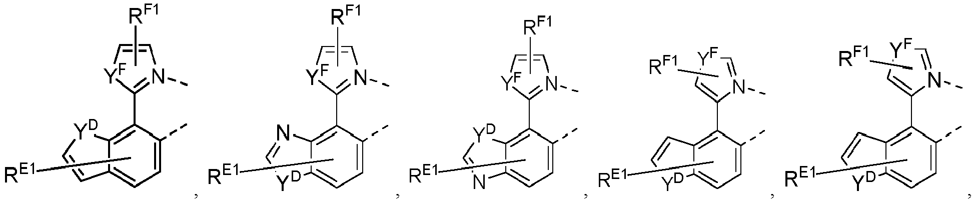 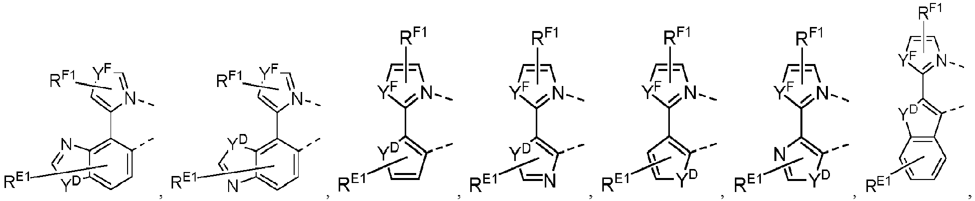 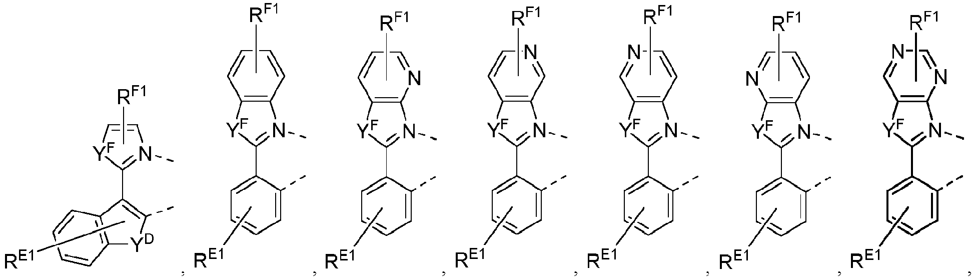 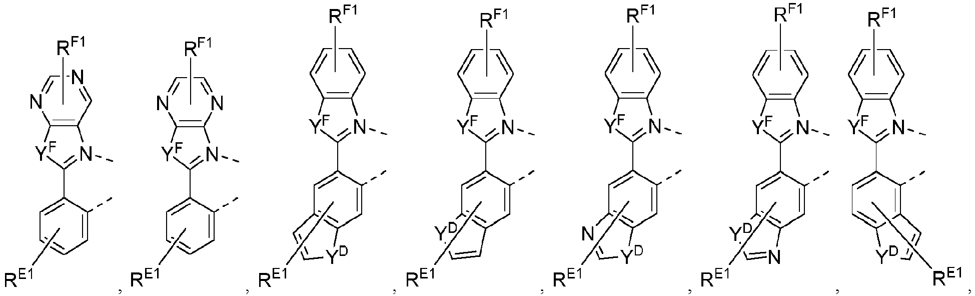 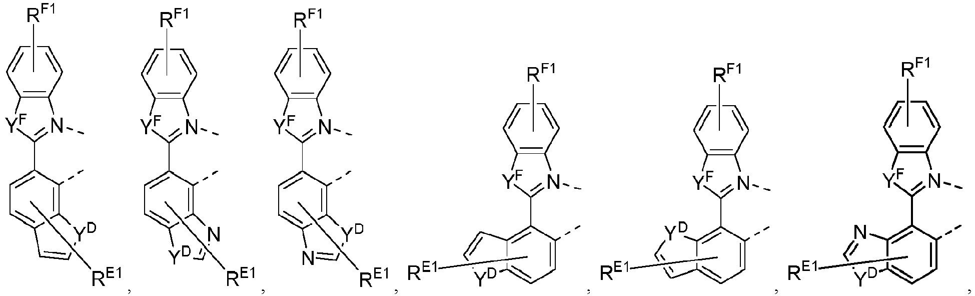 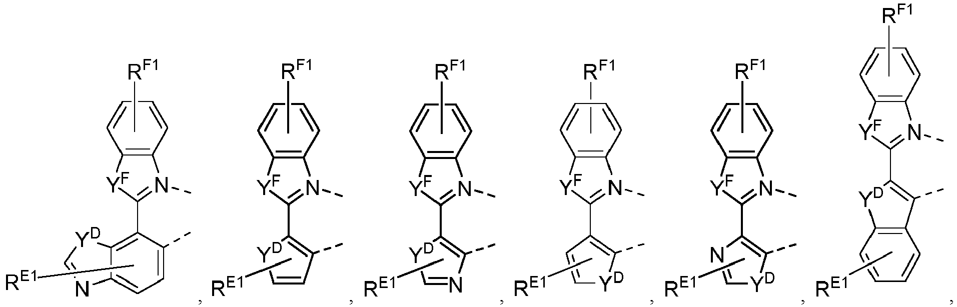 and 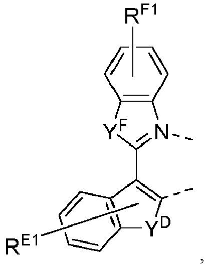 wherein:
each of Y^{D}, Y^{E}, and Y^{F} is independently selected from the group consisting of BRₑ, NRₑ, PRₑ, O, S, Se, C=O, S=O, SO₂, CRₑR_{f}, SiRₑR_{f}, and GeRₑR_{f};
each of R^{C1}, R^{D1}, R^{E1}, and R^{E1} independently represents from mono to the maximum possible number of substitutions, or no substitutions;
each R^{C1}, R^{D1}, R^{E1}, R^{F1}, Rₑ, and R_{f} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof; and
any two substituents can be joined or fused to form a ring.

9. The compound of any one of claims 1 to 8, wherein the ligand L_{B} is selected from L_{Bw}(R*G*)(R*H*)(R*J*)(R*K*), wherein w is an integer from 1 to 92, and each R^{G}, R^{H}, R^{J}, and R^{K} is independently selected from the group consisting of R1 to R115; wherein each of L_{B1}(R1)(R1)(R1)(R1) to L_{B92}(R115)(R115)(R115)(R115) is defined as follows:
| L_{B} | Structure of L_{B} | L_{B} | Structure of L_{B} | L_{B} | Structure of L_{B} |
|---|---|---|---|---|---|
| L_{B1}(R^{G})(R^{H})(R^{J})( R^{K}), wherein L_{B1}(R1)(R1)(R1)( R1) to L_{B1}(R115)(R115)( R115)(R115) have the structure | 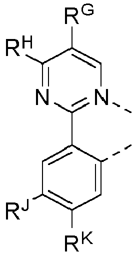 | L_{B2}(R^{G})(R^{H})(R^{J})( R^{K}), wherein L_{B2}(R1)(R1)(R1)( R1) to L_{B2}(R115)(R115)( R115)(R115) have the structure | 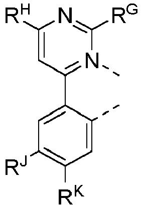 | L_{B3}(R^{G})(R^{H})(R^{J})( R^{K}), wherein L_{B3}(R1)(R1)(R1)( R1) to L_{B3}(R115)(R115)( R115)(R115) have the structure | 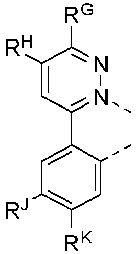 |
| L_{B4}(R^{G})(R^{H})(R^{J})( R^{K}), wherein L_{B4}(R1)(R1)(R1)( R1) to L_{B4}(R115)(R115)( R115)(R115) have the structure | 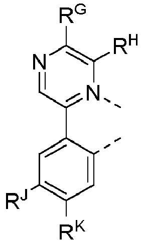 | L_{B5}(R^{G})(R^{H})(R^{J})( R^{K}), wherein L_{B5}(R1)(R1)(R1)( R1) to L_{B5}(R115)(R115)( R115)(R115) have the structure | 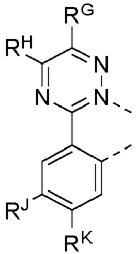 | L_{B6}(R^{G})(R^{H})(R^{J})( R^{K}), wherein L_{B6}(R1)(R1)(R1)( R1) to L_{B6}(R115)(R115)( R115)(R115) have the structure | 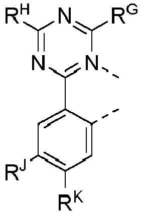 |
| L_{B7}(R^{G})(R^{H})(R^{J})( R^{K}), wherein L_{B7}(R1)(R1)(R1)( R1) to L_{B7}(R115)(R115)( R115)(R115) have the structure | 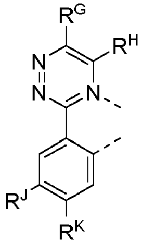 | L_{B8}(R^{G})(R^{H})(R^{J})( R^{K}), wherein L_{B8}(R1)(R1)(R1)( R1) to L_{B8}(R115)(R115)( R115)(R115) have the structure | 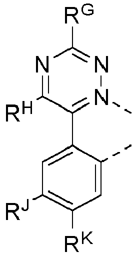 | L_{B9}(R^{G})(R^{H})(R^{J})( R^{K}), wherein L_{B9}(R1)(R1)(R1)( R1) to L_{B9}(R115)(R115)( R115)(R115) have the structure | 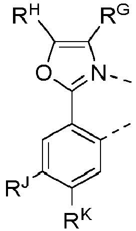 |
| L_{B10}(R^{G})(R^{H})(R^{J})( R^{K}), wherein L_{B10}(R1)(R1)(R1) (R1) to L_{B10}(R115)(R115) (R115)(R115) have the structure | 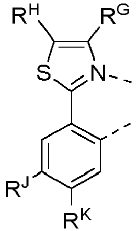 | L_{B11}(R^{G})(R^{H})(R^{J})( R^{K}), wherein L_{B11}(R1)(R1)(R1) (R1) to L_{B11}(R115)(R115) (R115)(R115) have the structure | 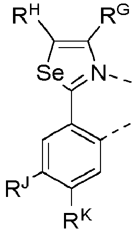 | L_{B12}(R^{G})(R^{H})(R^{J})( R^{K}), wherein L_{B12}(R1)(R1)(R1) (R1) to L_{B12}(R115)(R115) (R115)(R115) have the structure | 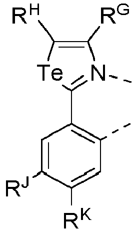 |
| L_{B13}(R^{G})(R^{H})(R^{J})( R^{K}), wherein L_{B13}(R1)(R1)(R1) (R1) to L_{B13}(R115)(R115) (R115)(R115) have the structure | 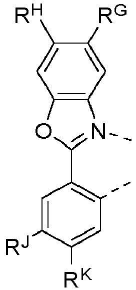 | L_{B14}(R^{G})(R^{H})(R^{J})( R^{K}), wherein L_{B14}(R1)(R1)(R1) (R1) to L_{B14}(R115)(R115) (R115)(R115) have the structure | 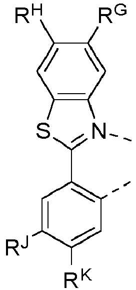 | L_{B15}(R^{G})(R^{H})(R^{J})( R^{K}), wherein L_{B15}(R1)(R1)(R1) (R1) to L_{B15}(R115)(R115) (R115)(R115) have the structure | 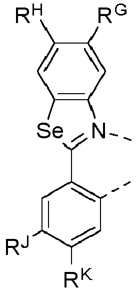 |
| L_{B16}(R^{G})(R^{H})(R^{J})( R^{K}), wherein L_{B16}(R1)(R1)(R1) (R1) to L_{B16}(R115)(R115) (R115)(R115) have the structure | 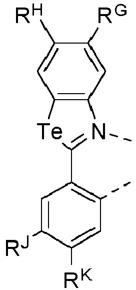 | L_{B17}(R^{G})(R^{H})(R^{J})( R^{K}), wherein L_{B17}(R1)(R1)(R1) (R1) to L_{B17}(R115)(R115) (R115)(R115) have the structure | 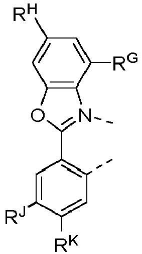 | L_{B18}(R^{G})(R^{H})(R^{J})( R^{K}), wherein L_{B18}(R1)(R1)(R1) (R1) to L_{B18}(R115)(R115) (R115)(R115) have the structure | 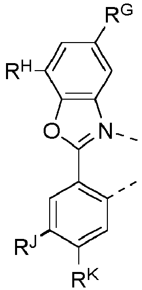 |
| L_{B19}(R^{G})(R^{H})(R^{J})( R^{K}), wherein L_{B19}(R1)(R1)(R1) (R1) to L_{B19}(R115)(R115) (R115)(R115) have the structure | 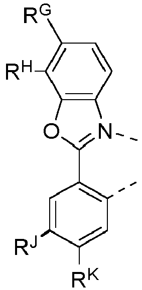 | L_{B20}(R^{G})(R^{H})(R^{J})( R^{K}), wherein L_{B20}(R1)(R1)(R1) (R1) to L_{B20}(R115)(R115) (R115)(R115) have the structure | 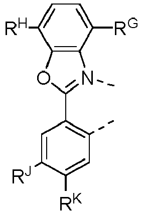 | L_{B21}(R^{G})(R^{H})(R^{J})( R^{K}), wherein L_{B21}(R1)(R1)(R1) (R1) to L_{B21}(R115)(R115) (R115)(R115) have the structure | 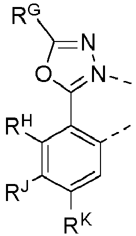 |
| L_{B22}(R^{G})(R^{H})(R^{J})( R^{K}), wherein L_{B22}(R1)(R1)(R1) (R1) to L_{B22}(R115)(R115) (R115)(R115) have the structure | 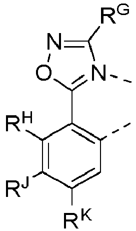 | L_{B23}(R^{G})(R^{H})(R^{J})( R^{K}), wherein L_{B23}(R1)(R1)(R1) (R1) to L_{B23}(R115)(R115) (R115)(R115) have the structure | 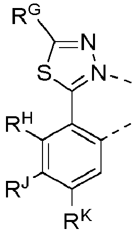 | L_{B24}(R^{G})(R^{H})(R^{J})( R^{K}), wherein L_{B24}(R1)(R1)(R1) (R1) to L_{B24}(R115)(R115) (R115)(R115) have the structure | 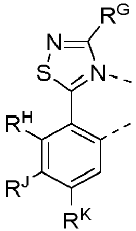 |
| L_{B25}(R^{G})(R^{H})(R^{J})( R^{K}), wherein L_{B25}(R1)(R1)(R1) (R1) to L_{B25}(R115)(R115) (R115)(R115) have the structure | 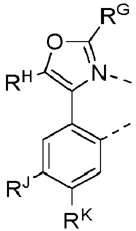 | L_{B26}(R^{G})(R^{H})(R^{J})( R^{K}), wherein L_{B26}(R1)(R1)(R1) (R1) to L_{B26}(R115)(R115) (R115)(R115) have the structure | 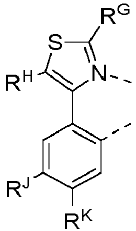 | L_{B27}(R^{G})(R^{H})(R^{J})( R^{K}), wherein L_{B27}(R1)(R1)(R1) (R1) to L_{B27}(R115)(R115) (R115)(R115) have the structure | 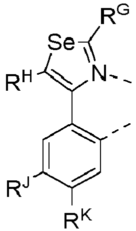 |
| L_{B28}(R^{G})(R^{H})(R^{J})( R^{K}), wherein L_{B28}(R1)(R1)(R1) (R1) to L_{B28}(R115)(R115) (R115)(R115) have the structure | 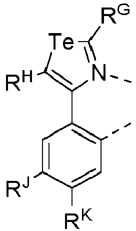 | L_{B29}(R^{G})(R^{H})(R^{J})( R^{K}), wherein L_{B29}(R1)(R1)(R1) (R1) to L_{B29}(R115)(R115) (R115)(R115) have the structure | 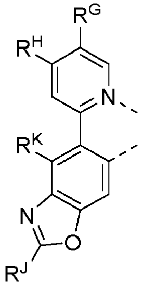 | L_{B30}(R^{G})(R^{H})(R^{J})( R^{K}), wherein L_{B30}(R1)(R1)(R1) (R1) to L_{B30}(R115)(R115) (R115)(R115) have the structure | 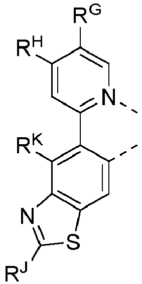 |
| L_{B31}(R^{G})(R^{H})(R^{J})( R^{K}), wherein L_{B31}(R1)(R1)(R1) (R1) to L_{B31}(R115)(R115) (R115)(R115) have the structure | 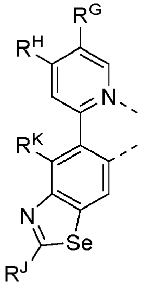 | L_{B32}(R^{G})(R^{H})(R^{J})( R^{K}), wherein L_{B32}(R1)(R1)(R1) (R1) to L_{B32}(R115)(R115) (R115)(R115) have the structure | 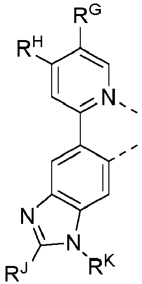 | L_{B33}(R^{G})(R^{H})(R^{J})( R^{K}), wherein L_{B33}(R1)(R1)(R1) (R1) to L_{B33}(R115)(R115) (R115)(R115) have the structure | 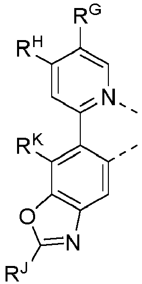 |
| L_{B34}(R^{G})(R^{H})(R^{J})( R^{K}), wherein L_{B34}(R1)(R1)(R1) (R1) to L_{B34}(R115)(R115) (R115)(R115) have the structure | 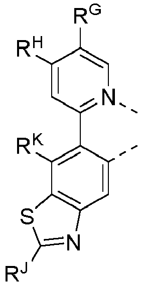 | L_{B35}(R^{G})(R^{H})(R^{J})( R^{K}), wherein L_{B35}(R1)(R1)(R1) (R1) to L_{B35}(R115)(R115) (R115)(R115) have the structure | 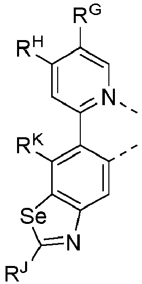 | L_{B36}(R^{G})(R^{H})(R^{J})( R^{K}), wherein L_{B36}(R1)(R1)(R1) (R1) to L_{B36}(R115)(R115) (R115)(R115) have the structure | 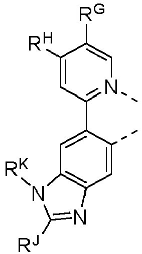 |
| L_{B37}(R^{G})(R^{H})(R^{J})( R^{K}), wherein L_{B37}(R1)(R1)(R1) (R1) to L_{B37}(R115)(R115) (R115)(R115) have the structure | 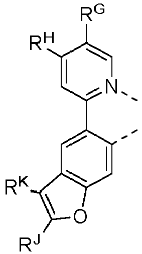 | L_{B38}(R^{G})(R^{H})(R^{J})( R^{K}), wherein L_{B38}(R1)(R1)(R1) (R1) to L_{B38}(R115)(R115) (R115)(R115) have the structure | 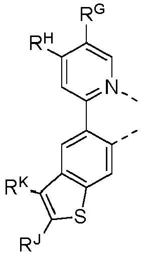 | L_{B39}(R^{G})(R^{H})(R^{J})( R^{K}), wherein L_{B39}(R1)(R1)(R1) (R1) to L_{B39}(R115)(R115) (R115)(R115) have the structure | 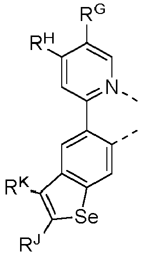 |
| L_{B40}(R^{G})(R^{H})(R^{J})( R^{K}), wherein L_{B40}(R1)(R1)(R1) (R1) to L_{B40}(R115)(R115) (R115)(R115) have the structure | 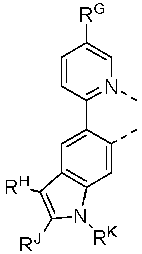 | L_{B41}(R^{G})(R^{H})(R^{J})( R^{K}), wherein L_{B41}(R1)(R1)(R1) (R1) to L_{B41}(R115)(R115) (R115)(R115) have the structure | 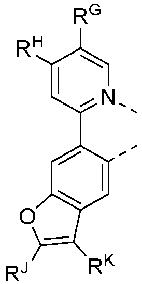 | L_{B42}(R^{G})(R^{H})(R^{J})( R^{K}), wherein L_{B42}(R1)(R1)(R1) (R1) to L_{B42}(R115)(R115) (R115)(R115) have the structure | 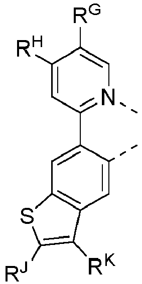 |
| L_{B43}(R^{G})(R^{H})(R^{J})( R^{K}), wherein L_{B43}(R1)(R1)(R1) (R1) to L_{B43}(R115)(R115) (R115)(R115) have the structure | 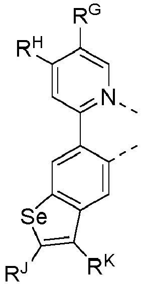 | L_{B44}(R^{G})(R^{H})(R^{J})( R^{K}), wherein L_{B44}(R1)(R1)(R1) (R1) to L_{B44}(R115)(R115) (R115)(R115) have the structure | 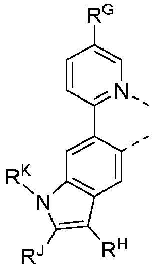 | L_{B45}(R^{G})(R^{H})(R^{J})( R^{K}), wherein L_{B45}(R1)(R1)(R1) (R1) to L_{B45}(R115)(R115) (R115)(R115) have the structure | 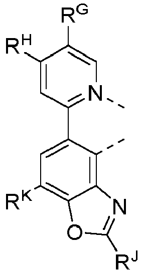 |
| L_{B46}(R^{G})(R^{H})(R^{J})( R^{K}), wherein L_{B46}(R1)(R1)(R1) (R1) to L_{B46}(R115)(R115) (R115)(R115) have the structure | 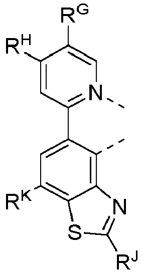 | L_{B47}(R^{G})(R^{H})(R^{J})( R^{K}), wherein L_{B47}(R1)(R1)(R1) (R1) to L_{B47}(R115)(R115) (R115)(R115) have the structure | 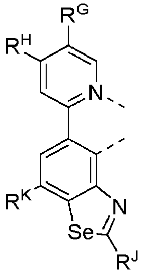 | L_{B48}(R^{G})(R^{H})(R^{J})( R^{K}), wherein L_{B48}(R1)(R1)(R1) (R1) to L_{B48}(R115)(R115) (R115)(R115) have the structure | 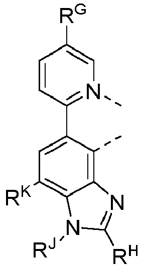 |
| L_{B49}(R^{G})(R^{H})(R^{J})( R^{K}), wherein L_{B49}(R1)(R1)(R1) (R1) to L_{B49}(R115)(R115) (R115)(R115) have the structure | 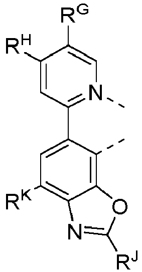 | L_{B5O}(R^{G})(R^{H})(R^{J})( R^{K}), wherein L_{B50}(R1)(R1)(R1) (R1) to L_{B50}(R115)(R115) (R115)(R115) have the structure | 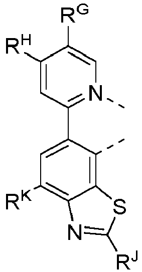 | L_{B51}(R^{G})(R^{H})(R^{J})( R^{K}), wherein L_{B51}(R1)(R1)(R1) (R1) to L_{B51}(R115)(R115) (R115)(R115) have the structure | 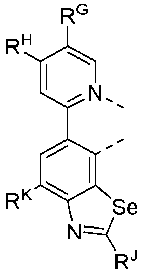 |
| L_{B52}(R^{G})(R^{H})(R^{J})( R^{K}), wherein L_{B52}(R1)(R1)(R1) (R1) to L_{B52}(R115)(R115) (R115)(R115) have the structure | 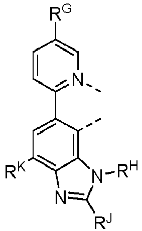 | L_{B53}(R^{G})(R^{H})(R^{J})( R^{K}), wherein L_{B53}(R1)(R1)(R1) (R1) to L_{B53}(R115)(R115) (R115)(R115) have the structure | 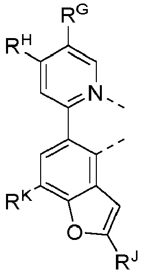 | L_{B54}(R^{G})(R^{H})(R^{J})( R^{K}), wherein L_{B54}(R1)(R1)(R1) (R1) to L_{B54}(R115)(R115) (R115)(R115) have the structure | 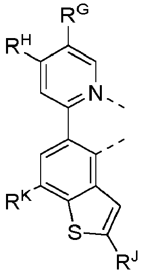 |
| L_{B55}(R^{G})(R^{H})(R^{J})( R^{K}), wherein L_{B55}(R1)(R1)(R1) (R1) to L_{B55}(R115)(R115) (R115)(R115) have the structure | 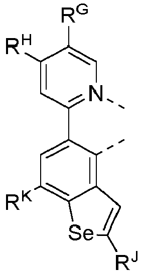 | L_{B56}(R^{G})(R^{H})(R^{J})( R^{K}), wherein L_{B56}(R1)(R1)(R1) (R1) to L_{B56}(R115)(R115) (R115)(R115) have the structure | 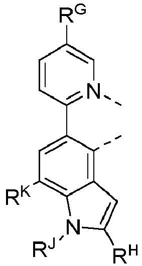 | L_{B57}(R^{G})(R^{H})(R^{J})( R^{K}), wherein L_{B57}(R1)(R1)(R1) (R1) to L_{B57}(R115)(R115) (R115)(R115) have the structure | 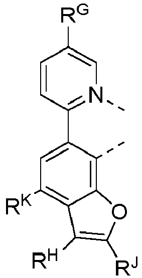 |
| L_{B58}(R^{G})(R^{H})(R^{J})( R^{K}), wherein L_{B58}(R1)(R1)(R1) (R1) to L_{B58}(R115)(R115) (R115)(R115) have the structure | 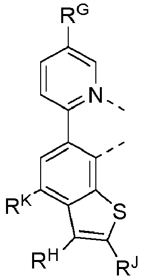 | L_{B59}(R^{G})(R^{H})(R^{J})( R^{K}), wherein L_{B59}(R1)(R1)(R1) (R1) to L_{B59}(R115)(R115) (R115)(R115) have the structure | 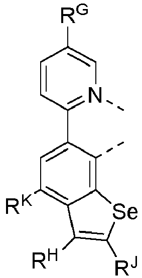 | L_{B60}(R^{G})(R^{H})(R^{J})( R^{K}), wherein L_{B60}(R1)(R1)(R1) (R1) to L_{B6O}(R115)(R115) (R115)(R115) have the structure | 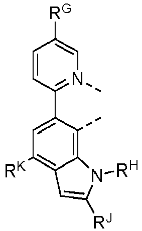 |
| L_{B61}(R^{G})(R^{H})(R^{J})( R^{K}), wherein L_{B61}(R1)(R1)(R1) (R1) to L_{B61}(R115)(R115) (R115)(R115) have the structure | 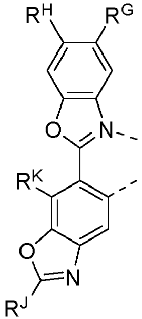 | L_{B62}(R^{G})(R^{H})(R^{J})( R^{K}), wherein L_{B62}(R1)(R1)(R1) (R1) to L_{B62}(R115)(R115) (R115)(R115) have the structure | 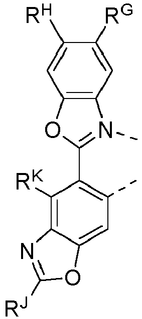 | L_{B63}(R^{G})(R^{H})(R^{J})( R^{K}), wherein L_{B63}(R1)(R1)(R1) (R1) to L_{B63}(R115)(R115) (R115)(R115) have the structure | 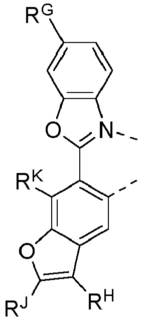 |
| L_{B64}(R^{G})(R^{H})(R^{J})( R^{K}), wherein L_{B64}(R1)(R1)(R1) (R1) to L_{B64}(R115)(R115) (R115)(R115) have the structure | 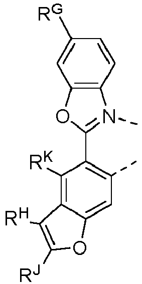 | L_{B65}(R^{G})(R^{H})(R^{J})( R^{K}), wherein L_{B65}(R1)(R1)(R1) (R1) to L_{B65}(R115)(R115) (R115)(R115) have the structure | 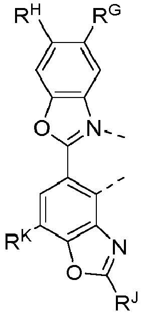 | L_{B66}(R^{G})(R^{H})(R^{J})( R^{K}), wherein L_{B66}(R1)(R1)(R1) (R1) to L_{B66}(R115)(R115) (R115)(R115) have the structure | 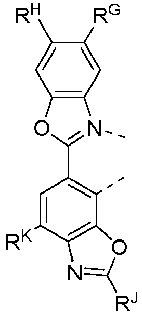 |
| L_{B67}(R^{G})(R^{H})(R^{J})( R^{K}), wherein L_{B67}(R1)(R1)(R1) (R1) to L_{B67}(R115)(R115) (R115)(R115) have the structure | 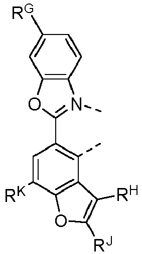 | L_{B68}(R^{G})(R^{H})(R^{J})( R^{K}), wherein L_{B68}(R1)(R1)(R1) (R1) to L_{B68}(R115)(R115) (R115)(R115) have the structure | 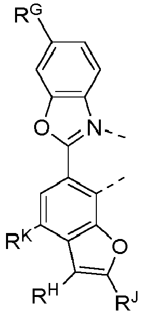 | L_{B69}(R^{G})(R^{H})(R^{J})( R^{K}), wherein L_{B69}(R1)(R1)(R1) (R1) to L_{B69}(R115)(R115) (R115)(R115) have the structure | 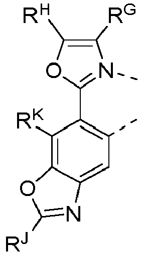 |
| L_{B70}(R^{G})(R^{H})(R^{J})( R^{K}), wherein L_{B70}(R1)(R1)(R1) (R1) to L_{B70}(R115)(R115) (R115)(R115) have the structure | 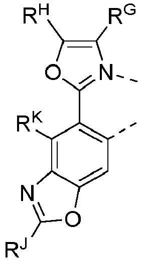 | L_{B71}(R^{G})(R^{H})(R^{J})( R^{K}), wherein L_{B71}(R1)(R1)(R1) (R1) to L_{B71}(R115)(R115) (R115)(R115) have the structure | 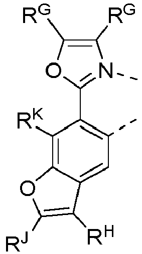 | L_{B72}(R^{G})(R^{H})(R^{J})( R^{K}), wherein L_{B72}(R1)(R1)(R1) (R1) to L_{B72}(R115)(R115) (R115)(R115) have the structure | 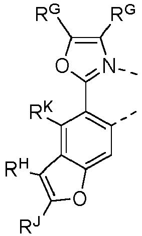 |
| L_{B73}(R^{G})(R^{H})(R^{J})( R^{K}), wherein L_{B73}(R1)(R1)(R1) (R1) to L_{B73}(R115)(R115) (R115)(R115) have the structure | 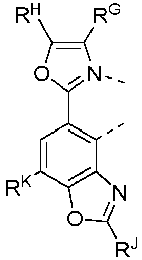 | L_{B74}(R^{G})(R^{H})(^{RJ})( R^{K}), wherein L_{B74}(R1)(R1)(R1) (R1) to L_{B74}(R115)(R115) (R115)(R115) have the structure | 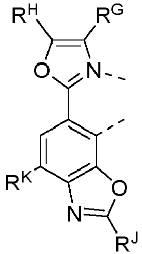 | L_{B75}(R^{G})(R^{H})(R^{J})( R^{K}), wherein L_{B75}(R1)(R1)(R1) (R1) to L_{B75}(R115)(R115) (R115)(R115) have the structure | 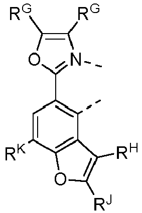 |
| L_{B76}(R^{G})(R^{H})(R^{J})( R^{K}), wherein L_{B76}(R1)(R1)(R1) (R1) to L_{B76}(R115)(R115) (R115)(R115) have the structure | 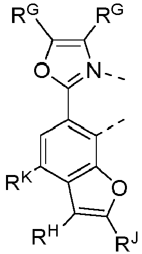 | L_{B77}(R^{G})(R^{H})(R^{J})( R^{K}), wherein L_{B77}(R1)(R1)(R1) (R1) to L_{B77}(R115)(R115) (R115)(R115) have the structure | 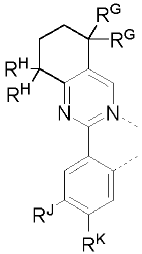 | L_{B78}(R^{G})(R^{H})(R^{J})( R^{K}), wherein L_{B78}(R1)(R1)(R1) (R1) to L_{B78}(R115)(R115) (R115)(R115) have the structure | 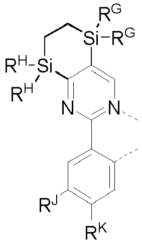 |
| L_{B79}(R^{G})(R^{H})(R^{J})( R^{K}), wherein L_{B79}(R1)(R1)(R1) (R1) to L_{B79}(R115)(R115) (R115)(R115) have the structure | 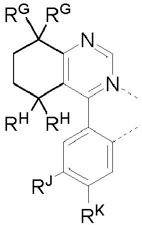 | L_{B80}(R^{G})(R^{H})(R^{J})( R^{K}), wherein L_{B80}(R1)(R1)(R1) (R1) to L_{B80}(R115)(R115) (R115)(R115) have the structure | 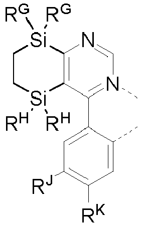 | L_{B81}(R^{G})(R^{H})(R^{J})( R^{K}), wherein L_{B81}(R1)(R1)(R1) (R1) to L_{B81}(R115)(R115) (R115)(R115) have the structure | 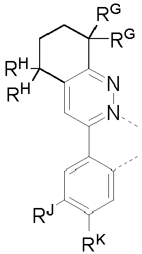 |
| L_{B82}(R^{G})(R^{H})(R^{J})( R^{K}), wherein L_{B82}(R1)(R1)(R1) (R1) to L_{B82}(R115)(R115) (R115)(R115) have the structure | 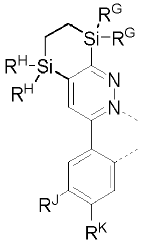 | L_{B83}(R^{G})(R^{H})(R^{J})( R^{K}), wherein L_{B83}(R1)(R1)(R1) (R1) to L_{B83}(R115)(R115) (R115)(R115) have the structure | 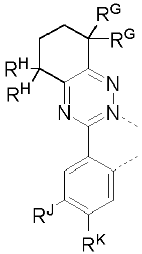 | L_{B84}(R^{G})(R^{H})(R^{J})( R^{K}), wherein L_{B84}(R1)(R1)(R1) (R1) to L_{B84}(R115)(R115) (R115)(R115) have the structure | 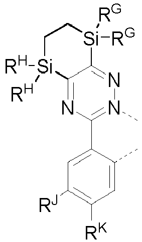 |
| L_{B85}(R^{G})(R^{H})(R^{J})( R^{K}), wherein L_{B85}(R1)(R1)(R1) (R1) to L_{B85}(R115)(R115) (R115)(R115) have the structure | 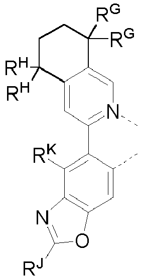 | L_{B86}(R^{G})(R^{H})(R^{J})( R^{K}), wherein L_{B86}(R1)(R1)(R1) (R1) to L_{B86}(R115)(R115) (R115)(R115) have the structure | 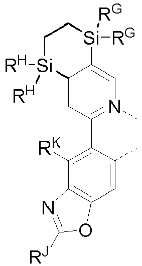 | L_{B87}(R^{G})(R^{H})(R^{J})( R^{K}), wherein L_{B87}(R1)(R1)(R1) (R1) to L_{B87}(R115)(R115) (R115)(R115) have the structure | 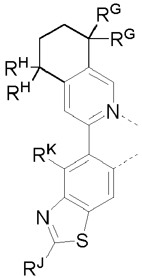 |
| L_{B88}(R^{G})(R^{H})(R^{J})( R^{K}), wherein L_{B88}(R1)(R1)(R1) (R1) to L_{B88}(R115)(R115) (R115)(R115) have the structure | 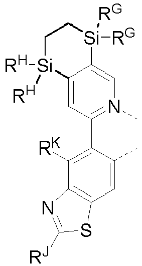 | L_{B89}(R^{G})(R^{H})(R^{J})( R^{K}), wherein L_{B89}(R1)(R1)(R1) (R1) to L_{B89}(R115)(R115) (R115)(R115) have the structure | 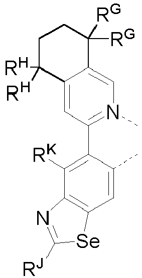 | L_{B90}(R^{G})(R^{H})(R^{J})( R^{K}), wherein L_{B90}(R1)(R1)(R1) (R1) to L_{B90}(R115)(R115) (R115)(R115) have the structure | 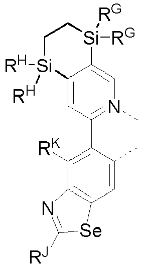 |
| L_{B91}(R^{G})(R^{H})(R^{J})( R^{K}), wherein L_{B91}(R1)(R1)(R1) (R1) to L_{B91}(R115)(R115) (R115)(R115) have the structure | 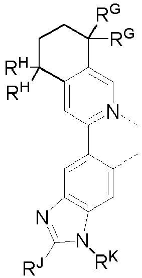 | L_{B92}(R^{G})(R^{H})(R^{J})( R^{K}), wherein L_{B92}(R1)(R1)(R1) (R1) to L_{B92}(R115)(R115) (R115)(R115) have the structure | 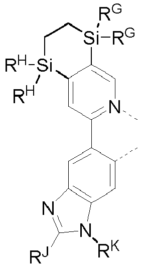 | | |
wherein R1 to R115 have the following structures: 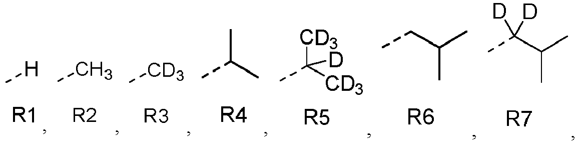 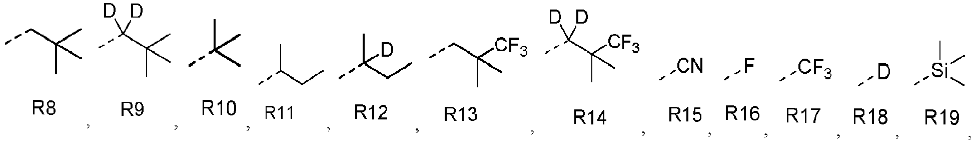 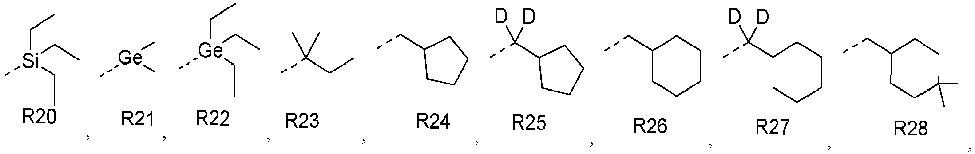 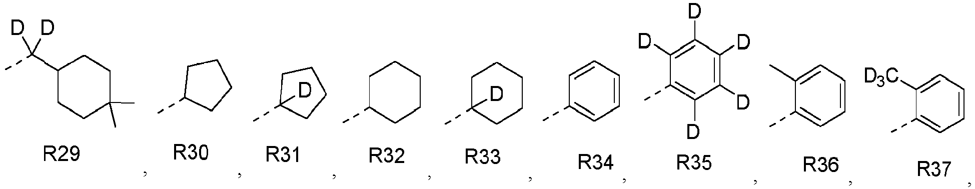 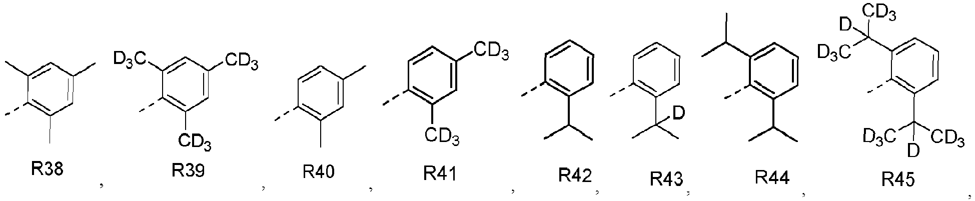 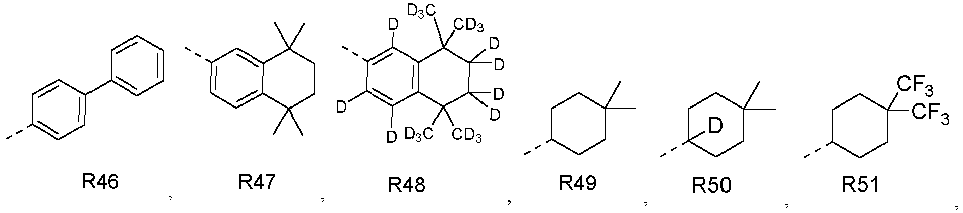 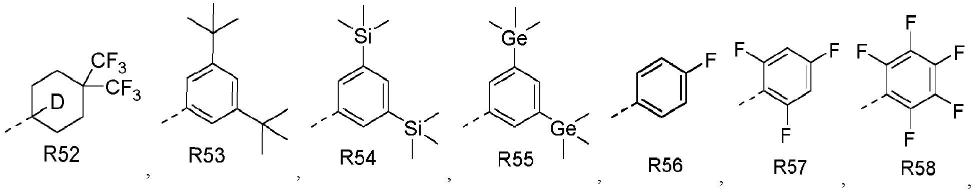 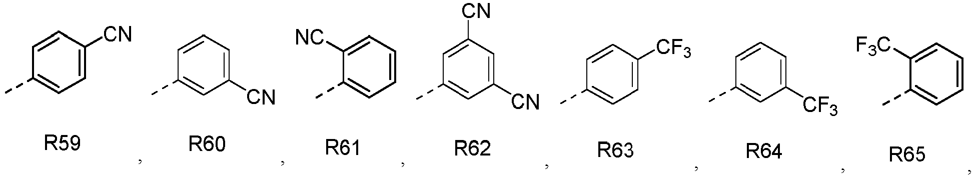 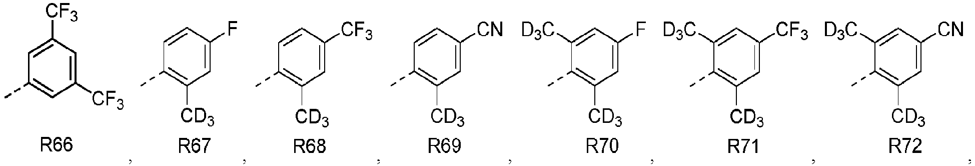 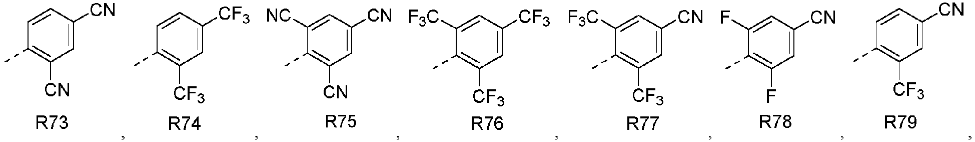 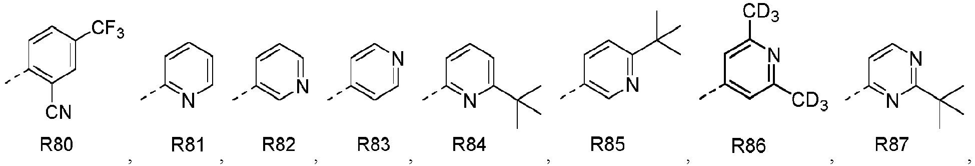 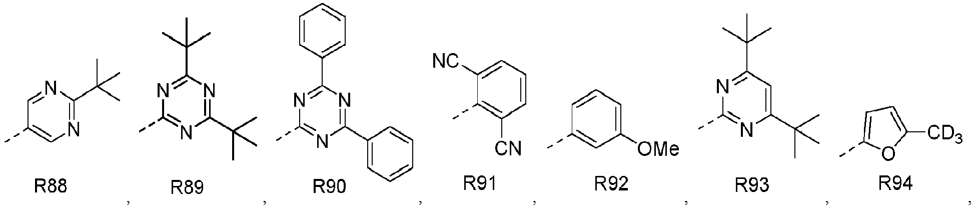 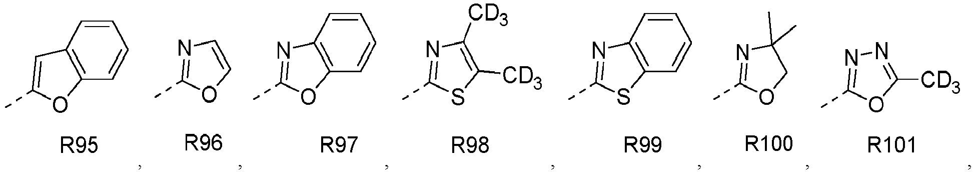 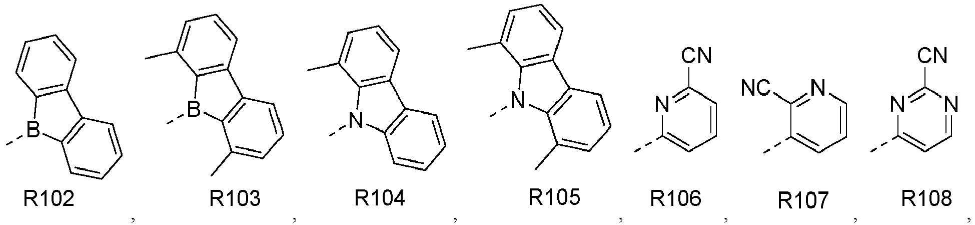 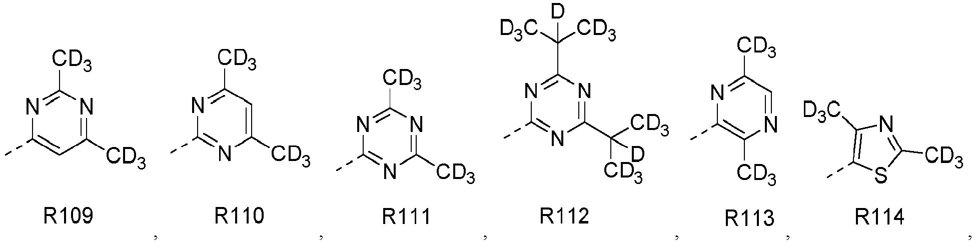 and

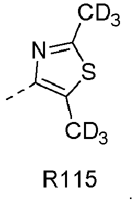

10. The compound of any one of claims 1 to 9, wherein the compound has a formula selected from the group consisting of Ir(L_{A})(L_{B})₂, Ir(L_{A})₂(L_{B}), and Ir(L_{A})(L_{B})(L_{C}).

11. The compound of any one of claims 1 to 10, wherein Lc has a structure selected from the group consisting of: 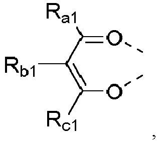 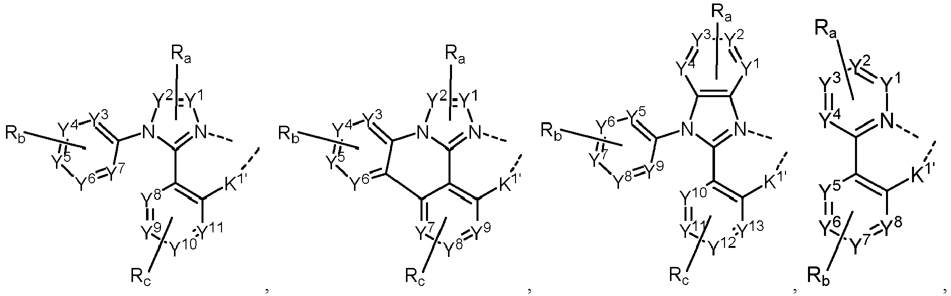 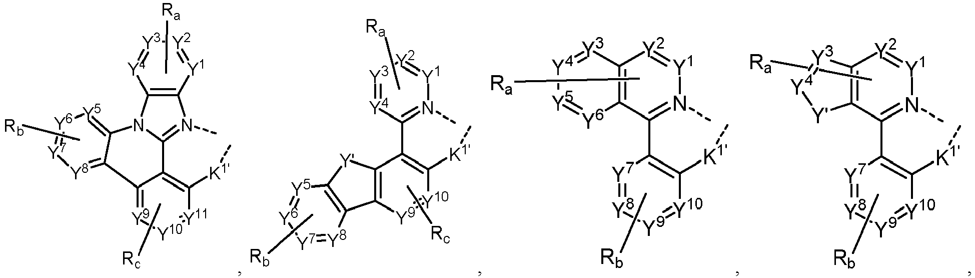 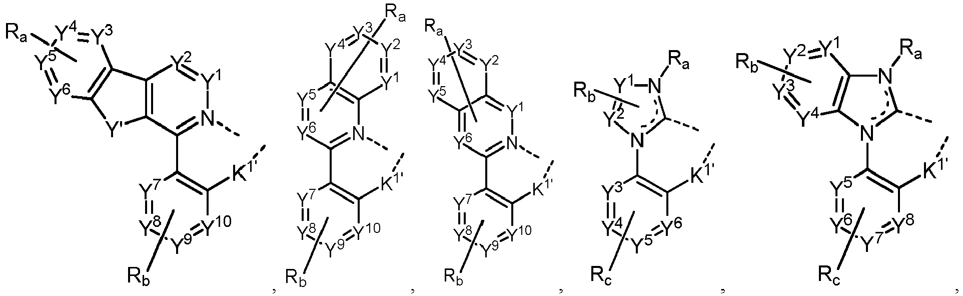 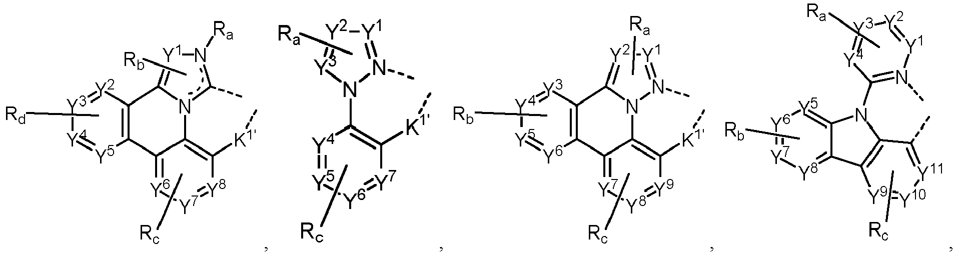 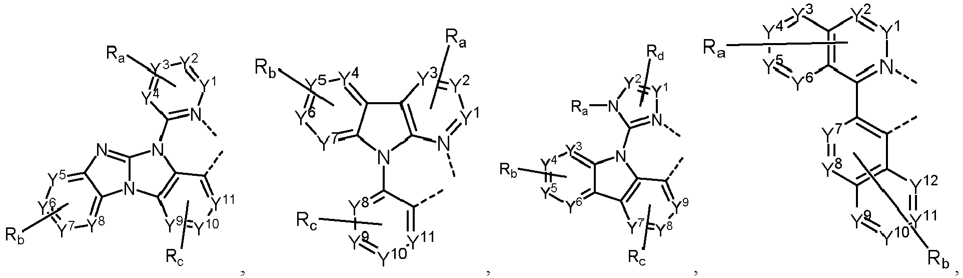 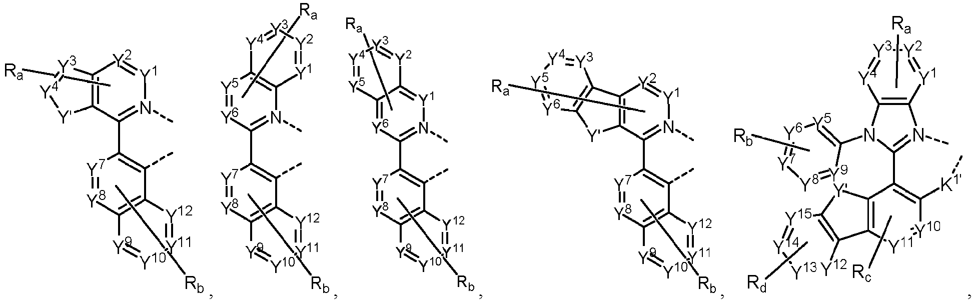 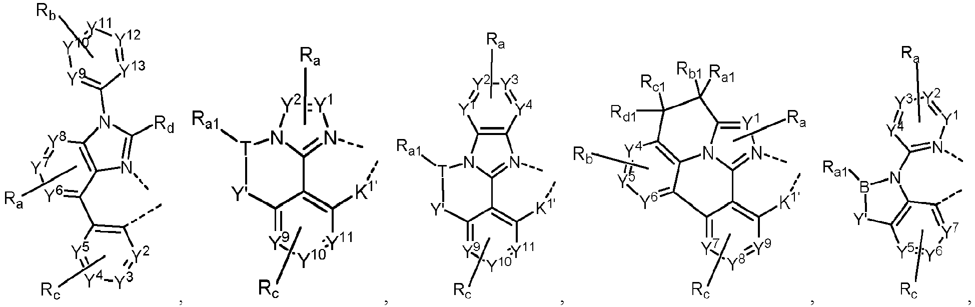 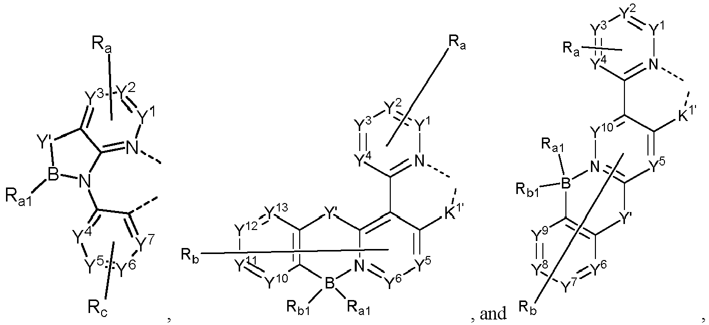 wherein:
T is selected from the group consisting of B, Al, Ga, and In;
K^{1'} is selected from the group consisting of a single bond, O, S, NRₑ, PRₑ, BRₑ, CRₑR_{f}, and SiRₑR_{f};
each of Y¹ to Y¹³ is independently selected from the group consisting of C and N;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents from mono to the maximum allowed number of substitutions, or no substitution;
each of Rₐ₁, R_{b1}, R_{c1}, R_{d1}, Rₐ, R_{b}, R_{c}, R_{d}, Rₑ, and R_{f} is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and
any two substituents of Rₐ₁, R_{b1}, R_{c1}, R_{d1}, Rₐ, R_{b}, R_{c}, and R_{d} can be fused or joined to form a ring or form a multidentate ligand.

12. The compound of claim 6, when the compound has formula Ir(L_{Ai}(R*m*)(R*n*)(R*o*)(R*p*)) (L_{Bw}(R^{G})(R^{H})(R^{J})(R^{K}))₂, the compound is selected from the group consisting of Ir(L_{A1}(R1)(R1)(R1)(R1)) (L_{B1}(R1)(R1)(R1)(R1))₂ to lr(L_{A114}(R115)(R115)(R115)(R115))(L_{B92}(R115)(R115)(R115)(R115))₂;
when the compound has formula Ir(L_{A1}(R*m*)(R*n*)(R*o*)(R*p*))₂(L_{Bw}(R^{G})(R^{H})(R^{J})(R^{K})), the compound is selected from the group consisting of Ir(L_{A1}(R1)(R1)(R1)(R1))₂(L_{B1}(R1)(R1)(R1)(R1)) to Ir(L_{A114}(R115)(R115)(R115)(R115))₂(L_{B92}(R115)(R115)(R115)(R115));
when the compound has formula Ir(L_{A1}(R*m*)(R*n*)(R*o*)(R*p*))(L_{Bw}(R^{G})(R^{H})(R^{J})(R^{K}))(L_{Cj-I}), j is an integer from 1 to 1416, wherein the compound is selected from the group consisting of Ir(L_{A1}(R1)(R1)(R1)(R1)) (L_{B1}(R1)(R1)(R1)(R1))(L_{C1-I}) to Ir(L_{A114}(R115)(R115)(R115)(R115))(L_{B92}(R115)(R115)(R115)(R115))(L_{C1416-I}); and
when the compound has formula Ir(L_{Ai}(R*m*)(R*n*)(R*o*)(R*p*))(L_{Bw}(R^{G})(R^{H})(R^{J})(R^{K}))(L_{Cj-II}), j is an integer from 1 to 1416, wherein the compound is selected from the group consisting of Ir(L_{A1}(R1)(R1)(R1)(R1)) (L_{B1}(R1)(R1)(R1)(R1))(L_{C1-II}) to Ir(L_{A114}(R115)(R115)(R115)(R115))(L_{B92}(R115)(R115)(R115)(R115))(L_{C1416-II}),
wherein each L_{C*j*-I} has a structure based on formula 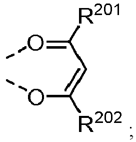 and
each L_{C*j*-II} has a structure based on formula 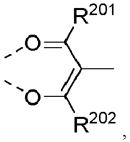 wherein for each L_{C*j*} in L_{C*j*-I} and L_{C*j*-II}, R²⁰¹ and R²⁰² are defined as follows:
| **L_{C*j*}** | **R²⁰¹** | **R²⁰²** | **L_{C*j*}** | **R²⁰¹** | **R²⁰²** | **L_{C*j*}** | **R²⁰¹** | **R²⁰²** | **L_{C*j*}** | **R²⁰¹** | **R²⁰²** |
|---|---|---|---|---|---|---|---|---|---|---|---|
| L_{C1} | R^{D1} | R^{D1} | L_{C193} | R^{D1} | R^{D3} | L_{C385} | R^{D17} | R^{D40} | L_{C577} | R^{D143} | R^{D120} |
| L_{C2} | R^{D2} | R^{D2} | L_{C194} | R^{D1} | R^{D4} | L_{C386} | R^{D17} | R^{D41} | L_{C578} | R^{D143} | R^{D133} |
| L_{C3} | R^{D3} | R^{D3} | L_{C195} | R^{D1} | R^{D5} | L_{C387} | R^{D17} | R^{D42} | L_{C579} | R^{D143} | R^{D134} |
| L_{C4} | R^{D4} | R^{D4} | L_{C196} | R^{D1} | R^{D9} | L_{C388} | R^{D17} | R^{D43} | L_{C580} | R^{D143} | R^{D135} |
| L_{C5} | R^{D5} | R^{D5} | L_{C197} | R^{D1} | R^{D10} | L_{C389} | R^{D17} | R^{D48} | L_{C581} | R^{D143} | R^{D136} |
| L_{C6} | R^{D6} | R^{D6} | L_{C198} | R^{D1} | R^{D17} | L_{C390} | R^{D17} | R^{D49} | L_{C582} | R^{D143} | R^{D144} |
| L_{C7} | R^{D7} | R^{D7} | L_{C199} | R^{D1} | R^{D18} | L_{C391} | R^{D17} | R^{D50} | L_{C583} | R^{D143} | R^{D145} |
| L_{C8} | R^{D8} | R^{D8} | L_{C200} | R^{D1} | R^{D20} | L_{C392} | R^{D17} | R^{D54} | L_{C584} | R^{D143} | R^{D146} |
| L_{C9} | R^{D9} | R^{D9} | L_{C201} | R^{D1} | R^{D22} | L_{C393} | R^{D17} | R^{D55} | L_{C585} | R^{D143} | R^{D147} |
| L_{C10} | R^{D10} | R^{D10} | L_{C202} | R^{D1} | R^{D37} | L_{C394} | R^{D17} | R^{D58} | L_{C586} | R^{D143} | R^{D149} |
| L_{C11} | R^{D11} | R^{D11} | L_{C203} | R^{D1} | R^{D40} | L_{C395} | R^{D17} | R^{D59} | L_{C587} | R^{D143} | R^{D151} |
| L_{C12} | R^{D12} | R^{D12} | L_{C204} | R^{D1} | R^{D41} | L_{C396} | R^{D17} | R^{D78} | L_{C588} | R^{D143} | R^{D154} |
| L_{C13} | R^{D13} | R^{D13} | L_{C205} | R^{D1} | R^{D42} | L_{C397} | R^{D17} | R^{D79} | L_{C589} | R^{D143} | R^{D155} |
| L_{C14} | R^{D14} | R^{D14} | L_{C206} | R^{D1} | R^{D43} | L_{C398} | R^{D17} | R^{D81} | L_{C590} | R^{D143} | R^{D161} |
| L_{C15} | R^{D15} | R^{D15} | L_{C207} | R^{D1} | R^{D48} | L_{C399} | R^{D17} | R^{D87} | L_{C591} | R^{D143} | R^{D175} |
| L_{C16} | R^{D16} | R^{D16} | L_{C208} | R^{D1} | R^{D49} | L_{C400} | R^{D17} | R^{D88} | L_{C592} | R^{D144} | R^{D3} |
| L_{C17} | R^{D17} | R^{D17} | L_{C209} | R^{D1} | R^{D50} | L_{C401} | R^{D17} | R^{D89} | L_{C593} | R^{D144} | R^{D5} |
| L_{C18} | R^{D18} | R^{D18} | L_{C210} | R^{D1} | R^{D54} | L_{C402} | R^{D17} | R^{D93} | L_{C594} | R^{D144} | R^{D17} |
| L_{C19} | R^{D19} | R^{D19} | L_{C211} | R^{D1} | R^{D55} | L_{C403} | R^{D17} | R^{D116} | L_{C595} | R^{D144} | R^{D18} |
| L_{C20} | R^{D20} | R^{D20} | L_{C212} | R^{D1} | R^{D58} | L_{C404} | R^{D17} | R^{D117} | L_{C596} | R^{D144} | R^{D20} |
| L_{C21} | R^{D21} | R^{D21} | L_{C213} | R^{D1} | R^{D59} | L_{C405} | R^{D17} | R^{D118} | L_{C597} | R^{D144} | R^{D22} |
| L_{C22} | R^{D22} | R^{D22} | L_{C214} | R^{D1} | R^{D78} | L_{C406} | R^{D17} | R^{D119} | L_{C598} | R^{D144} | R^{D37} |
| L_{C23} | R^{D23} | R^{D23} | L_{C215} | R^{D1} | R^{D79} | L_{C407} | R^{D17} | R^{D120} | L_{C599} | R^{D144} | R^{D40} |
| L_{C24} | R^{D24} | R^{D24} | L_{C216} | R^{D1} | R^{D81} | L_{C408} | R^{D17} | R^{D133} | L_{C600} | R^{D144} | R^{D41} |
| L_{C25} | R^{D25} | R^{D25} | L_{C217} | R^{D1} | R^{D87} | L_{C409} | R^{D17} | R^{D134} | L_{C601} | R^{D144} | R^{D42} |
| L_{C26} | R^{D26} | R^{D26} | L_{C218} | R^{D1} | R^{D88} | L_{C410} | R^{D17} | R^{D135} | L_{C602} | R^{D144} | R^{D43} |
| L_{C27} | R^{D27} | R^{D27} | L_{C219} | R^{D1} | R^{D89} | L_{C411} | R^{D17} | R^{D136} | L_{C603} | R^{D144} | R^{D48} |
| L_{C28} | R^{D28} | R^{D28} | L_{C220} | R^{D1} | R^{D93} | L_{C412} | R^{D17} | R^{D143} | L_{C604} | R^{D144} | R^{D49} |
| L_{C29} | R^{D29} | R^{D29} | L_{C221} | R^{D1} | R^{D116} | L_{C413} | R^{D17} | R^{D144} | L_{C605} | R^{D144} | R^{D54} |
| L_{C30} | R^{D30} | R^{D30} | L_{C222} | R^{D1} | R^{D117} | L_{C414} | R^{D17} | R^{D145} | L_{C606} | R^{D144} | R^{D58} |
| L_{C31} | R^{D31} | R^{D31} | L_{C223} | R^{D1} | R^{D118} | L_{C415} | R^{D17} | R^{D146} | L_{C607} | R^{D144} | R^{D59} |
| L_{C32} | R^{D32} | R^{D32} | L_{C224} | R^{D1} | R^{D119} | L_{C416} | R^{D17} | R^{D147} | L_{C608} | R^{D144} | R^{D78} |
| L_{C33} | R^{D33} | R^{D33} | L_{C225} | R^{D1} | R^{D120} | L_{C417} | R^{D17} | R^{D149} | L_{C609} | R^{D144} | R^{D79} |
| L_{C34} | R^{D34} | R^{D34} | L_{C226} | R^{D1} | R^{D133} | L_{C418} | R^{D17} | R^{D151} | L_{C610} | R^{D144} | R^{D81} |
| L_{C35} | R^{D35} | R^{D35} | L_{C227} | R^{D1} | R^{D134} | L_{C419} | R^{D17} | R^{D154} | L_{C611} | R^{D144} | R^{D87} |
| L_{C36} | R^{D36} | R^{D36} | L_{C228} | R^{D1} | R^{D135} | L_{C420} | R^{D17} | R^{D155} | L_{C612} | R^{D144} | R^{D88} |
| L_{C37} | R^{D37} | R^{D37} | L_{C229} | R^{D1} | R^{D136} | L_{C421} | R^{D17} | R^{D161} | L_{C613} | R^{D144} | R^{D89} |
| L_{C38} | R^{D38} | R^{D38} | L_{C230} | R^{D1} | R^{D143} | L_{C422} | R^{D17} | R^{D175} | L_{C614} | R^{D144} | R^{D93} |
| L_{C39} | R^{D39} | R^{D39} | L_{C231} | R^{D1} | R^{D144} | L_{C423} | R^{D50} | R^{D3} | L_{C615} | R^{D144} | R^{D116} |
| L_{C40} | R^{D40} | R^{D40} | L_{C232} | R^{D1} | R^{D145} | L_{C424} | R^{D50} | R^{D5} | L_{C616} | R^{D144} | R^{D117} |
| L_{C41} | R^{D41} | R^{D41} | L_{C233} | R^{D1} | R^{D146} | L_{C425} | R^{D50} | R^{D18} | L_{C617} | R^{D144} | R^{D118} |
| L_{C42} | R^{D42} | R^{D42} | L_{C234} | R^{D1} | R^{D147} | L_{C426} | R^{D50} | R^{D20} | L_{C618} | R^{D144} | R^{D119} |
| L_{C43} | R^{D43} | R^{D43} | L_{C235} | R^{D1} | R^{D149} | L_{C427} | R^{D50} | R^{D22} | L_{C619} | R^{D144} | R^{D120} |
| L_{C44} | R^{D44} | R^{D44} | L_{C236} | R^{D1} | R^{D151} | L_{C428} | R^{D50} | R^{D37} | L_{C620} | R^{D144} | R^{D133} |
| L_{C45} | R^{D45} | R^{D45} | L_{C237} | R^{D1} | R^{D154} | L_{C429} | R^{D50} | R^{D40} | L_{C621} | R^{D144} | R^{D134} |
| L_{C46} | R^{D46} | R^{D46} | L_{C238} | R^{D1} | R^{D155} | L_{C430} | R^{D50} | R^{D41} | L_{C622} | R^{D144} | R^{D135} |
| L_{C47} | R^{D47} | R^{D47} | L_{C239} | R^{D1} | R^{D161} | L_{C431} | R^{D50} | R^{D42} | L_{C623} | R^{D144} | R^{D136} |
| L_{C48} | R^{D48} | R^{D48} | L_{C240} | R^{D1} | R^{D175} | L_{C432} | R^{D50} | R^{D43} | L_{C624} | R^{D144} | R^{D145} |
| L_{C49} | R^{D49} | R^{D49} | L_{C241} | R^{D4} | R^{D3} | L_{C433} | R^{D50} | R^{D48} | L_{C625} | R^{D144} | R^{D146} |
| L_{C50} | R^{D50} | R^{D50} | L_{C242} | R^{D4} | R^{D5} | L_{C434} | R^{D50} | R^{D49} | L_{C626} | R^{D144} | R^{D147} |
| L_{C51} | R^{D51} | R^{D51} | L_{C243} | R^{D4} | R^{D9} | L_{C435} | R^{D50} | R^{D54} | L_{C627} | R^{D144} | R^{D149} |
| L_{C52} | R^{D52} | R^{D52} | L_{C244} | R^{D4} | R^{D10} | L_{C436} | R^{D50} | R^{D55} | L_{C628} | R^{D144} | R^{D151} |
| L_{C53} | R^{D53} | R^{D53} | L_{C245} | R^{D4} | R^{D17} | L_{C437} | R^{D50} | R^{D58} | L_{C629} | R^{D144} | R^{D154} |
| L_{C54} | R^{D54} | R^{D54} | L_{C246} | R^{D4} | R^{D18} | L_{C438} | R^{D50} | R^{DS9} | L_{C630} | R^{D144} | R^{D155} |
| L_{C55} | R^{D55} | R^{D55} | L_{C247} | R^{D4} | R^{D20} | L_{C439} | R^{D50} | R^{D78} | L_{C631} | R^{D144} | R^{D161} |
| L_{C56} | R^{D56} | R^{D56} | L_{C248} | R^{D4} | R^{D22} | L_{C440} | R^{D50} | R^{D79} | L_{C632} | R^{D144} | R^{D175} |
| L_{C57} | R^{D57} | R^{D57} | L_{C249} | R^{D4} | R^{D37} | L_{C441} | R^{D50} | R^{D81} | L_{C633} | R^{D145} | R^{D3} |
| L_{C58} | R^{D58} | R^{D58} | L_{C250} | R^{D4} | R^{D40} | L_{C442} | R^{D50} | R^{D87} | L_{C634} | R^{D145} | R^{D5} |
| L_{C59} | R^{D59} | R^{D59} | L_{C251} | R^{D4} | R^{D41} | L_{C443} | R^{D50} | R^{D88} | L_{C635} | R^{D145} | R^{D17} |
| L_{C60} | R^{D60} | R^{D60} | L_{C252} | R^{D4} | R^{D42} | L_{C444} | R^{D50} | R^{D89} | L_{C636} | R^{D145} | R^{D18} |
| L_{C61} | R^{D61} | R^{D61} | L_{C253} | R^{D4} | R^{D43} | L_{C445} | R^{D50} | R^{D93} | L_{C637} | R^{D145} | R^{D20} |
| L_{C62} | R^{D62} | R^{D62} | L_{C254} | R^{D4} | R^{D48} | L_{C446} | R^{D50} | R^{D116} | L_{C638} | R^{D145} | R^{D22} |
| L_{C63} | R^{D63} | R^{D63} | L_{C255} | R^{D4} | R^{D49} | L_{C447} | R^{D50} | R^{D117} | L_{C639} | R^{D145} | R^{D37} |
| L_{C64} | R^{D64} | R^{D64} | L_{C256} | R^{D4} | R^{D50} | L_{C448} | R^{D50} | R^{D118} | L_{C640} | R^{D145} | R^{D40} |
| L_{C65} | R^{D65} | R^{D65} | L_{C257} | R^{D4} | R^{D54} | L_{C449} | R^{D50} | R^{D119} | L_{C641} | R^{D145} | R^{D41} |
| L_{C66} | R^{D66} | R^{D66} | L_{C258} | R^{D4} | R^{D55} | L_{C450} | R^{D50} | R^{D120} | L_{C642} | R^{D145} | R^{D42} |
| L_{C67} | R^{D67} | R^{D67} | L_{C259} | R^{D4} | R^{D58} | L_{C451} | R^{D50} | R^{D133} | L_{C643} | R^{D145} | R^{D43} |
| L_{C68} | R^{D68} | R^{D68} | L_{C260} | R^{D4} | R^{D59} | L_{C452} | R^{D50} | R^{D134} | L_{C644} | R^{D145} | R^{D48} |
| L_{C69} | R^{D69} | R^{D69} | L_{C261} | R^{D4} | R^{D78} | L_{C453} | R^{D50} | R^{D135} | L_{C645} | R^{D145} | R^{D49} |
| L_{C70} | R^{D70} | R^{D70} | L_{C262} | R^{D4} | R^{D79} | L_{C454} | R^{D50} | R^{D136} | L_{C646} | R^{D145} | R^{D54} |
| L_{C71} | R^{D71} | R^{D71} | L_{C263} | R^{D4} | R^{D81} | L_{C455} | R^{D50} | R^{D143} | L_{C647} | R^{D145} | R^{D58} |
| L_{C72} | R^{D72} | R^{D72} | L_{C264} | R^{D4} | R^{D87} | L_{C456} | R^{D50} | R^{D144} | L_{C648} | R^{D145} | R^{D59} |
| L_{C73} | R^{D73} | R^{D73} | L_{C265} | R^{D4} | R^{D88} | L_{C457} | R^{D50} | R^{D145} | L_{C649} | R^{D145} | R^{D78} |
| L_{C74} | R^{D74} | R^{D74} | L_{C266} | R^{D4} | R^{D89} | L_{C458} | R^{D50} | R^{D146} | L_{C650} | R^{D145} | R^{D79} |
| L_{C75} | R^{D75} | R^{D75} | L_{C267} | R^{D4} | R^{D93} | L_{C459} | R^{D50} | R^{D147} | L_{C651} | R^{D145} | R^{D81} |
| L_{C76} | R^{D76} | R^{D76} | L_{C268} | R^{D4} | R^{D116} | L_{C460} | R^{D50} | R^{D149} | L_{C652} | R^{D145} | R^{D87} |
| L_{C77} | R^{D77} | R^{D77} | L_{C269} | R^{D4} | R^{D117} | L_{C461} | R^{D50} | R^{D151} | L_{C653} | R^{D145} | R^{D88} |
| L_{C78} | R^{D78} | R^{D78} | L_{C270} | R^{D4} | R^{D118} | L_{C462} | R^{D50} | R^{D154} | L_{C654} | R^{D145} | R^{D89} |
| L_{C79} | R^{D79} | R^{D79} | L_{C271} | R^{D4} | R^{D119} | L_{C463} | R^{D50} | R^{D155} | L_{C655} | R^{D145} | R^{D93} |
| L_{C80} | R^{D80} | R^{D80} | L_{C272} | R^{D4} | R^{D120} | L_{C464} | R^{D50} | R^{D161} | L_{C656} | R^{D145} | R^{D116} |
| L_{C81} | R^{D81} | R^{D81} | L_{C273} | R^{D4} | R^{D133} | L_{C465} | R^{D50} | R^{D175} | L_{C657} | R^{D145} | R^{D117} |
| L_{C82} | R^{D82} | R^{D82} | L_{C274} | R^{D4} | R^{D134} | L_{C466} | R^{D55} | R^{D3} | L_{C658} | R^{D145} | R^{D118} |
| L_{C83} | R^{D83} | R^{D83} | L_{C275} | R^{D4} | R^{D135} | L_{C467} | R^{D55} | R^{D5} | L_{C659} | R^{D145} | R^{D119} |
| L_{C84} | R^{D84} | R^{D84} | L_{C276} | R^{D4} | R^{D136} | L_{C468} | R^{D55} | R^{D18} | L_{C660} | R^{D145} | R^{D120} |
| L_{C85} | R^{D85} | R^{D85} | L_{C277} | R^{D4} | R^{D143} | L_{C469} | R^{D55} | R^{D20} | L_{C661} | R^{D145} | R^{D133} |
| L_{C86} | R^{D86} | R^{D86} | L_{C278} | R^{D4} | R^{D144} | L_{C470} | R^{D55} | R^{D22} | L_{C662} | R^{D145} | R^{D134} |
| L_{C87} | R^{D87} | R^{D87} | L_{C279} | R^{D4} | R^{D145} | L_{C471} | R^{D55} | R^{D37} | L_{C663} | R^{D145} | R^{D135} |
| L_{C88} | R^{D88} | R^{D88} | L_{C280} | R^{D4} | R^{D146} | L_{C472} | R^{D55} | R^{D40} | L_{C664} | R^{D145} | R^{D136} |
| L_{C89} | R^{D89} | R^{D89} | L_{C281} | R^{D4} | R^{D147} | L_{C473} | R^{D55} | R^{D41} | L_{C665} | R^{D145} | R^{D146} |
| L_{C90} | R^{D90} | R^{D90} | L_{C282} | R^{D4} | R^{D149} | L_{C474} | R^{D55} | R^{D42} | L_{C666} | R^{D145} | R^{D147} |
| L_{C91} | R^{D91} | R^{D91} | L_{C283} | R^{D4} | R^{D151} | L_{C475} | R^{D55} | R^{D43} | L_{C667} | R^{D145} | R^{D149} |
| L_{C92} | R^{D92} | R^{D92} | L_{C284} | R^{D4} | R^{D154} | L_{C476} | R^{D55} | R^{D48} | L_{C668} | R^{D145} | R^{D151} |
| L_{C93} | R^{D93} | R^{D93} | L_{C285} | R^{D4} | R^{D155} | L_{C477} | R^{D55} | R^{D49} | L_{C669} | R^{D145} | R^{D154} |
| L_{C94} | R^{D94} | R^{D94} | L_{C286} | R^{D4} | R^{D161} | L_{C478} | R^{D55} | R^{D54} | L_{C670} | R^{D145} | R^{D155} |
| L_{C95} | R^{D95} | R^{D95} | L_{C287} | R^{D4} | R^{D175} | L_{C479} | R^{D55} | R^{D58} | L_{C671} | R^{D145} | R^{D161} |
| L_{C96} | R^{D96} | R^{D96} | L_{C288} | R^{D9} | R^{D3} | L_{C480} | R^{D55} | R^{D59} | L_{C672} | R^{D145} | R^{D175} |
| L_{C97} | R^{D97} | R^{D97} | L_{C289} | R^{D9} | R^{D5} | L_{C481} | R^{D55} | R^{D78} | L_{C673} | R^{D146} | R^{D3} |
| L_{C98} | R^{D98} | R^{D98} | L_{C290} | R^{D9} | R^{D10} | L_{C482} | R^{D55} | R^{D79} | L_{C674} | R^{D146} | R^{D5} |
| L_{C99} | R^{D99} | R^{D99} | L_{C291} | R^{D9} | R^{D17} | L_{C483} | R^{D55} | R^{D81} | L_{C675} | R^{D146} | R^{D17} |
| L_{C100} | R^{D100} | R^{D100} | L_{C292} | R^{D9} | R^{D18} | L_{C484} | R^{D55} | R^{D87} | L_{C676} | R^{D146} | R^{D18} |
| L_{C101} | R^{D101} | R^{D101} | L_{C293} | R^{D9} | R^{D20} | L_{C485} | R^{D55} | R^{D88} | L_{C677} | R^{D146} | R^{D20} |
| L_{C205} | R^{D102} | R^{D102} | L_{C294} | R^{D9} | R^{D22} | L_{C486} | R^{D55} | R^{D89} | L_{C678} | R^{D146} | R^{D22} |
| L_{C103} | R^{D103} | R^{D103} | L_{C295} | R^{D9} | R^{D37} | L_{C487} | R^{D55} | R^{D93} | L_{C679} | R^{D146} | R^{D37} |
| L_{C104} | R^{D104} | R^{D104} | L_{C296} | R^{D9} | R^{D40} | L_{C488} | R^{D55} | R^{D116} | L_{C680} | R^{D146} | R^{D40} |
| L_{C105} | R^{D105} | R^{D105} | L_{C297} | R^{D9} | R^{D41} | L_{C489} | R^{D55} | R^{D117} | L_{C681} | R^{D146} | R^{D41} |
| L_{C106} | R^{D106} | R^{D106} | L_{C298} | R^{D9} | R^{D42} | L_{C490} | R^{D55} | R^{D118} | L_{C682} | R^{D146} | R^{D42} |
| L_{C107} | R^{D107} | R^{D107} | L_{C299} | R^{D9} | R^{D43} | L_{C491} | R^{D55} | R^{D119} | L_{C683} | R^{D146} | R^{D43} |
| L_{C108} | R^{D108} | R^{D108} | L_{C300} | R^{D9} | R^{D48} | L_{C492} | R^{D55} | R^{D120} | L_{C684} | R^{D146} | R^{D48} |
| L_{C109} | R^{D109} | R^{D109} | L_{C301} | R^{D9} | R^{D49} | L_{C493} | R^{D55} | R^{D133} | L_{C685} | R^{D146} | R^{D49} |
| L_{C110} | R^{D110} | R^{D110} | L_{C302} | R^{D9} | R^{D50} | L_{C494} | R^{D55} | R^{D134} | L_{C686} | R^{D146} | R^{D54} |
| L_{C111} | R^{D111} | R^{D111} | L_{C303} | R^{D9} | R^{D54} | L_{C495} | R^{D55} | R^{D135} | L_{C687} | R^{D146} | R^{D58} |
| L_{C112} | R^{D112} | R^{D112} | L_{C304} | R^{D9} | R^{D55} | L_{C496} | R^{D55} | R^{D136} | L_{C688} | R^{D146} | R^{D59} |
| L_{C113} | R^{D113} | R^{D113} | L_{C305} | R^{D9} | R^{D58} | L_{C497} | R^{D55} | R^{D143} | L_{C689} | R^{D146} | R^{D78} |
| L_{C114} | R^{D114} | R^{D114} | L_{C306} | R^{D9} | R^{D59} | L_{C498} | R^{D55} | R^{D144} | L_{C690} | R^{D146} | R^{D79} |
| L_{C115} | R^{D115} | R^{D115} | L_{C307} | R^{D9} | R^{D78} | L_{C499} | R^{D55} | R^{D145} | L_{C691} | R^{D146} | R^{D81} |
| L_{C116} | R^{D116} | R^{D116} | L_{C308} | R^{D9} | R^{D79} | L_{C500} | R^{D55} | R^{D146} | L_{C692} | R^{D146} | R^{D87} |
| L_{C117} | R^{D117} | R^{D117} | L_{C309} | R^{D9} | R^{D81} | L_{C501} | R^{D55} | R^{D147} | L_{C693} | R^{D146} | R^{D88} |
| L_{C118} | R^{D118} | R^{D118} | L_{C310} | R^{D9} | R^{D87} | L_{C502} | R^{D55} | R^{D149} | L_{C694} | R^{D146} | R^{D89} |
| L_{C119} | R^{D119} | R^{D119} | L_{C311} | R^{D9} | R^{D88} | L_{C503} | R^{D55} | R^{D151} | L_{C695} | R^{D146} | R^{D93} |
| L_{C120} | R^{D120} | R^{D120} | L_{C312} | R^{D9} | R^{D89} | L_{C504} | R^{D55} | R^{D154} | L_{C696} | R^{D146} | R^{D117} |
| L_{C121} | R^{D121} | R^{D121} | L_{C313} | R^{D9} | R^{D93} | L_{C505} | R^{D55} | R^{D155} | L_{C697} | R^{D146} | R^{D118} |
| L_{C122} | R^{D122} | R^{D122} | L_{C314} | R^{D9} | R^{D116} | L_{C506} | R^{D55} | R^{D161} | L_{C698} | R^{D146} | R^{D119} |
| L_{C123} | R^{D123} | R^{D123} | L_{C315} | R^{D9} | R^{D117} | L_{C507} | R^{D55} | R^{D175} | L_{C699} | R^{D146} | R^{D120} |
| L_{C124} | R^{D124} | R^{D124} | L_{C316} | R^{D9} | R^{D118} | L_{C508} | R^{D116} | R^{D3} | L_{C700} | R^{D146} | R^{D133} |
| L_{C125} | R^{D125} | R^{D125} | L_{C317} | R^{D9} | R^{D119} | L_{C509} | R^{D116} | R^{D5} | L_{C701} | R^{D146} | R^{D134} |
| L_{C126} | R^{D126} | R^{D116} | L_{C318} | R^{D9} | R^{D120} | L_{C510} | R^{D116} | R^{D17} | L_{C702} | R^{D146} | R^{D135} |
| L_{C127} | R^{D127} | R^{D127} | L_{C319} | R^{D9} | R^{D133} | L_{C511} | R^{D116} | R^{D18} | L_{C703} | R^{D146} | R^{D136} |
| L_{C128} | R^{D128} | R^{D128} | L_{C320} | R^{D9} | R^{D134} | L_{C512} | R^{D116} | R^{D20} | L_{C704} | R^{D146} | R^{D146} |
| L_{C129} | R^{D129} | R^{D129} | L_{C321} | R^{D9} | R^{D135} | L_{C513} | R^{D116} | R^{D22} | L_{C705} | R^{D146} | R^{D147} |
| L_{C130} | R^{D130} | R^{D130} | L_{C322} | R^{D9} | R^{D136} | L_{C514} | R^{D116} | R^{D37} | L_{C706} | R^{D146} | R^{D149} |
| L_{C131} | R^{D131} | R^{D131} | L_{C323} | R^{D9} | R^{D143} | L_{C515} | R^{D116} | R^{D40} | L_{C707} | R^{D146} | R^{D151} |
| L_{C132} | R^{D132} | R^{D132} | L_{C324} | R^{D9} | R^{D144} | L_{C516} | R^{D116} | R^{D41} | L_{C708} | R^{D146} | R^{D154} |
| L_{C133} | R^{D133} | R^{D133} | L_{C325} | R^{D9} | R^{D145} | L_{C517} | R^{D116} | R^{D42} | L_{C709} | R^{D146} | R^{D155} |
| L_{C134} | R^{D134} | R^{D134} | L_{C326} | R^{D9} | R^{D146} | L_{C518} | R^{D116} | R^{D43} | L_{C710} | R^{D146} | R^{D161} |
| L_{C135} | R^{D135} | R^{D135} | L_{C327} | R^{D9} | R^{D147} | L_{C519} | R^{D116} | R^{D48} | L_{C711} | R^{D146} | R^{D175} |
| L_{C136} | R^{D136} | R^{D136} | L_{C328} | R^{D9} | R^{D149} | L_{C520} | R^{D116} | R^{D49} | L_{C712} | R^{D133} | R^{D3} |
| L_{C137} | R^{D137} | R^{D137} | L_{C329} | R^{D9} | R^{D151} | L_{C521} | R^{D116} | R^{D54} | L_{C713} | R^{D133} | R^{D5} |
| L_{C138} | R^{D138} | R^{D138} | L_{C330} | R^{D9} | R^{D154} | L_{C522} | R^{D116} | R^{D58} | L_{C714} | R^{D133} | R^{D3} |
| L_{C139} | R^{D139} | R^{D139} | L_{C331} | R^{D9} | R^{D155} | L_{C523} | R^{D116} | R^{D59} | L_{C715} | R^{D133} | R^{D18} |
| L_{C140} | R^{D140} | R^{D140} | L_{C332} | R^{D9} | R^{D161} | L_{C524} | R^{D116} | R^{D78} | L_{C716} | R^{D133} | R^{D20} |
| L_{C141} | R^{D141} | R^{D141} | L_{C333} | R^{D9} | R^{D175} | L_{C525} | R^{D116} | R^{D79} | L_{C717} | R^{D133} | R^{D22} |
| L_{C142} | R^{D142} | R^{D142} | L_{C334} | R^{D10} | R^{D3} | L_{C526} | R^{D116} | R^{D81} | L_{C718} | R^{D133} | R^{D37} |
| L_{C143} | R^{D143} | R^{D143} | L_{C335} | R^{D10} | R^{D5} | L_{C527} | R^{D116} | R^{D87} | L_{C719} | R^{D133} | R^{D40} |
| L_{C144} | R^{D144} | R^{D144} | L_{C336} | R^{D10} | R^{D17} | L_{C528} | R^{D116} | R^{D88} | L_{C720} | R^{D133} | R^{D41} |
| L_{C145} | R^{D145} | R^{D145} | L_{C337} | R^{D10} | R^{D18} | L_{C529} | R^{D116} | R^{D89} | L_{C721} | R^{D133} | R^{D42} |
| L_{C146} | R^{D146} | R^{D146} | L_{C338} | R^{D10} | R^{D20} | L_{C530} | R^{D116} | R^{D93} | L_{C722} | R^{D133} | R^{D43} |
| L_{C147} | R^{D147} | R^{D147} | L_{C339} | R^{D10} | R^{D22} | L_{C531} | R^{D116} | R^{D117} | L_{C723} | R^{D133} | R^{D48} |
| L_{C148} | R^{D148} | R^{D148} | L_{C340} | R^{D10} | R^{D37} | L_{C532} | R^{D116} | R^{D118} | L_{C724} | R^{D133} | R^{D49} |
| L_{C149} | R^{D149} | R^{D149} | L_{C341} | R^{D10} | R^{D40} | L_{C533} | R^{D116} | R^{D119} | L_{C725} | R^{D133} | R^{D54} |
| L_{C150} | R^{D150} | R^{D150} | L_{C342} | R^{D10} | R^{D41} | L_{C534} | R^{D116} | R^{D120} | L_{C726} | R^{D133} | R^{D58} |
| L_{C151} | R^{D151} | R^{D151} | L_{C343} | R^{D10} | R^{D42} | L_{C535} | R^{D116} | R^{D133} | L_{C727} | R^{D133} | R^{D59} |
| L_{C152} | R^{D152} | R^{D152} | L_{C344} | R^{D10} | R^{D43} | L_{C536} | R^{D116} | R^{D134} | L_{C728} | R^{D133} | R^{D78} |
| L_{C153} | R^{D153} | R^{D153} | L_{C345} | R^{D10} | R^{D48} | L_{C537} | R^{D116} | R^{D135} | L_{C729} | R^{D133} | R^{D79} |
| L_{C154} | R^{D154} | R^{D154} | L_{C346} | R^{D10} | R^{D49} | L_{C538} | R^{D116} | R^{D136} | L_{C730} | R^{D133} | R^{D81} |
| L_{C155} | R^{D155} | R^{D155} | L_{C347} | R^{D10} | R^{D50} | L_{C539} | R^{D116} | R^{D143} | L_{C731} | R^{D133} | R^{D87} |
| L_{C156} | R^{D156} | R^{D156} | L_{C348} | R^{D10} | R^{D54} | L_{C540} | R^{D116} | R^{D144} | L_{C732} | R^{D133} | R^{D88} |
| L_{C157} | R^{D157} | R^{D157} | L_{C349} | R^{D10} | R^{D55} | L_{C541} | R^{D116} | R^{D145} | L_{C733} | R^{D133} | R^{D89} |
| L_{C158} | R^{D158} | R^{D158} | L_{C350} | R^{D10} | R^{D58} | L_{C542} | R^{D116} | R^{D146} | L_{C734} | R^{D133} | R^{D93} |
| L_{C159} | R^{D159} | R^{D159} | L_{C351} | R^{D10} | R^{D59} | L_{C543} | R^{D116} | R^{D147} | L_{C735} | R^{D133} | R^{D117} |
| L_{C160} | R^{D160} | R^{D160} | L_{C352} | R^{D10} | R^{D78} | L_{C544} | R^{D116} | R^{D149} | L_{C736} | R^{D133} | R^{D118} |
| L_{C161} | R^{D161} | R^{D161} | L_{C353} | R^{D10} | R^{D79} | L_{C545} | R^{D116} | R^{D151} | L_{C737} | R^{D133} | R^{D119} |
| L_{C162} | R^{D162} | R^{D162} | L_{C354} | R^{D10} | R^{D81} | L_{C546} | R^{D116} | R^{D154} | L_{C738} | R^{D133} | R^{D120} |
| L_{C163} | R^{D163} | R^{D163} | L_{C355} | R^{D10} | R^{D87} | L_{C547} | R^{D116} | R^{D155} | L_{C739} | R^{D133} | R^{D133} |
| L_{C164} | R^{D164} | R^{D164} | L_{C356} | R^{D10} | R^{D88} | L_{C548} | R^{D116} | R^{D161} | L_{C740} | R^{D133} | R^{D134} |
| L_{C165} | R^{D165} | R^{D165} | L_{C357} | R^{D10} | R^{D89} | L_{C549} | R^{D116} | R^{D175} | L_{C741} | R^{D133} | R^{D135} |
| L_{C166} | R^{D166} | R^{D166} | L_{C358} | R^{D10} | R^{D93} | L_{C550} | R^{D143} | R^{D3} | L_{C742} | R^{D133} | R^{D136} |
| L_{C167} | R^{D167} | R^{D167} | L_{C359} | R^{D10} | R^{D116} | L_{C551} | R^{D143} | R^{D5} | L_{C743} | R^{D133} | R^{D146} |
| L_{C168} | R^{D168} | R^{D168} | L_{C360} | R^{D10} | R^{D117} | L_{C552} | R^{D143} | R^{D17} | L_{C744} | R^{D133} | R^{D147} |
| L_{C169} | R^{D169} | R^{D169} | L_{C361} | R^{D10} | R^{D118} | L_{C553} | R^{D143} | R^{D18} | L_{C745} | R^{D133} | R^{D149} |
| L_{C170} | R^{D170} | R^{D170} | L_{C362} | R^{D10} | R^{D119} | L_{C554} | R^{D143} | R^{D20} | L_{C746} | R^{D133} | R^{D151} |
| L_{C171} | R^{D171} | R^{D171} | L_{C363} | R^{D10} | R^{D120} | L_{C555} | R^{D143} | R^{D22} | L_{C747} | R^{D133} | R^{D154} |
| L_{C172} | R^{D172} | R^{D172} | L_{C364} | R^{D10} | R^{D133} | L_{C556} | R^{D143} | R^{D37} | L_{C748} | R^{D133} | R^{D155} |
| L_{C173} | R^{D173} | R^{D173} | L_{C365} | R^{D10} | R^{D134} | L_{C557} | R^{D143} | R^{D40} | L_{C749} | R^{D133} | R^{D161} |
| L_{C174} | R^{D174} | R^{D174} | L_{C366} | R^{D10} | R^{D135} | L_{C558} | R^{D143} | R^{D41} | L_{C750} | R^{D133} | R^{D175} |
| L_{C175} | R^{D175} | R^{D175} | L_{C367} | R^{D10} | R^{D136} | L_{C559} | R^{D143} | R^{D42} | L_{C751} | R^{D175} | R^{D3} |
| L_{C176} | R^{D176} | R^{D176} | L_{C368} | R^{D10} | R^{D143} | L_{C560} | R^{D143} | R^{D43} | L_{C752} | R^{D175} | R^{D5} |
| L_{C177} | R^{D177} | R^{D177} | L_{C369} | R^{D10} | R^{D144} | L_{C561} | R^{D143} | R^{D48} | L_{C753} | R^{D175} | R^{D18} |
| L_{C178} | R^{D178} | R^{D178} | L_{C370} | R^{D10} | R^{D145} | L_{C562} | R^{D143} | R^{D49} | L_{C754} | R^{D175} | R^{D20} |
| L_{C179} | R^{D179} | R^{D179} | L_{C371} | R^{D10} | R^{D146} | L_{C563} | R^{D143} | R^{D54} | L_{C755} | R^{D175} | R^{D22} |
| L_{C180} | R^{D150} | R^{D150} | L_{C372} | R^{D10} | R^{D147} | L_{C564} | R^{D143} | R^{D58} | L_{C756} | R^{D175} | R^{D37} |
| L_{C181} | R^{D181} | R^{D181} | L_{C373} | R^{D10} | R^{D149} | L_{C565} | R^{D143} | R^{DS9} | L_{C757} | R^{D175} | R^{D40} |
| L_{C182} | R^{D182} | R^{D182} | L_{C374} | R^{D10} | R^{D151} | L_{C566} | R^{D143} | R^{D78} | L_{C758} | R^{D175} | R^{D41} |
| L_{C183} | R^{D183} | R^{D183} | L_{C375} | R^{D10} | R^{D154} | L_{C567} | R^{D143} | R^{D79} | L_{C759} | R^{D175} | R^{D42} |
| L_{C184} | R^{D184} | R^{D184} | L_{C376} | R^{D10} | R^{D155} | L_{C568} | R^{D143} | R^{D81} | L_{C760} | R^{D175} | R^{D43} |
| L_{C185} | R^{D185} | R^{D185} | L_{C377} | R^{D10} | R^{D161} | L_{C569} | R^{D143} | R^{D87} | L_{C761} | R^{D175} | R^{D48} |
| L_{C186} | R^{D186} | R^{D186} | L_{C378} | R^{D10} | R^{D175} | L_{C570} | R^{D143} | R^{D88} | L_{C762} | R^{D175} | R^{D49} |
| L_{C187} | R^{D187} | R^{D187} | L_{C379} | R^{D17} | R^{D3} | L_{C571} | R^{D143} | R^{D89} | L_{C763} | R^{D175} | R^{D54} |
| L_{C188} | R^{D188} | R^{D188} | L_{C380} | R^{D17} | R^{D5} | L_{C572} | R^{D143} | R^{D93} | L_{C764} | R^{D175} | R^{D58} |
| L_{C189} | R^{D189} | R^{D189} | L_{C381} | R^{D17} | R^{D18} | L_{C573} | R^{D143} | R^{D116} | L_{C765} | R^{D175} | R^{D59} |
| L_{C190} | R^{D190} | R^{D190} | L_{C382} | R^{D17} | R^{D20} | L_{C574} | R^{D143} | R^{D117} | L_{C766} | R^{D175} | R^{D78} |
| L_{C191} | R^{D191} | R^{D191} | L_{C383} | R^{D17} | R^{D22} | L_{C575} | R^{D143} | R^{D118} | L_{C767} | R^{D175} | R^{D79} |
| L_{C192} | R^{D192} | R^{D192} | L_{C384} | R^{D17} | R^{D37} | L_{C576} | R^{D143} | R^{D119} | L_{C768} | R^{D175} | R^{D81} |
| L_{C769} | R^{D193} | R^{D193} | L_{C877} | R^{D1} | R^{D193} | L_{C985} | R^{D4} | R^{D193} | L_{C1093} | R^{D9} | R^{D193} |
| L_{C770} | R^{D194} | R^{D194} | L_{C878} | R^{D1} | R^{D194} | L_{C986} | R^{D4} | R^{D194} | L_{C1094} | R^{D9} | R^{D194} |
| L_{C771} | R^{D195} | R^{D195} | L_{C879} | R^{D1} | R^{D195} | L_{C987} | R^{D4} | R^{D195} | L_{C1095} | R^{D9} | R^{D195} |
| L_{C772} | R^{D196} | R^{D196} | L_{C880} | R^{D1} | R^{D196} | L_{C988} | R^{D4} | R^{D196} | L_{C1096} | R^{D9} | R^{D196} |
| L_{C773} | R^{D197} | R^{D197} | L_{C881} | R^{D1} | R^{D197} | L_{C989} | R^{D4} | R^{D197} | L_{C1097} | R^{D9} | R^{D197} |
| L_{C774} | R^{D198} | R^{D198} | L_{C882} | R^{D1} | R^{D198} | L_{C990} | R^{D4} | R^{D198} | L_{C1098} | R^{D9} | R^{D198} |
| L_{C775} | R^{D199} | R^{D199} | L_{C883} | R^{D1} | R^{D199} | L_{C991} | R^{D4} | R^{D199} | L_{C1099} | R^{D9} | R^{D199} |
| L_{C776} | R^{D200} | R^{D200} | L_{C884} | R^{D1} | R^{D200} | L_{C992} | R^{D4} | R^{D200} | L_{C1100} | R^{D9} | R^{D200} |
| L_{C777} | R^{D201} | R^{D201} | L_{C885} | R^{D1} | R^{D201} | L_{C993} | R^{D4} | R^{D201} | L_{C1101} | R^{D9} | R^{D201} |
| L_{C778} | R^{D202} | R^{D202} | L_{C886} | R^{D1} | R^{D202} | L_{C994} | R^{D4} | R^{D202} | L_{C1102} | R^{D9} | R^{D202} |
| L_{C779} | R^{D203} | R^{D203} | L_{C887} | R^{D1} | R^{D203} | L_{C995} | R^{D4} | R^{D203} | L_{C1103} | R^{D9} | R^{D203} |
| L_{C780} | R^{D204} | R^{D204} | L_{C888} | R^{D1} | R^{D204} | L_{C996} | R^{D4} | R^{D204} | L_{C1104} | R^{D9} | R^{D204} |
| L_{C781} | R^{D205} | R^{D205} | L_{C889} | R^{D1} | R^{D205} | L_{C997} | R^{D4} | R^{D205} | L_{C1105} | R^{D9} | R^{D205} |
| L_{C782} | R^{D206} | R^{D206} | L_{C890} | R^{D1} | R^{D206} | L_{C998} | R^{D4} | R^{D206} | L_{C1106} | R^{D9} | R^{D206} |
| L_{C783} | R^{D207} | R^{D207} | L_{C891} | R^{D1} | R^{D207} | L_{C999} | R^{D4} | R^{D207} | L_{C1107} | R^{D9} | R^{D207} |
| L_{C784} | R^{D208} | R^{D208} | L_{C892} | R^{D1} | R^{D208} | L_{C1000} | R^{D4} | R^{D208} | L_{C1108} | R^{D9} | R^{D208} |
| L_{C785} | R^{D209} | R^{D209} | L_{C893} | R^{D1} | R^{D209} | L_{C1001} | R^{D4} | R^{D209} | L_{C1109} | R^{D9} | R^{D209} |
| L_{C786} | R^{D210} | R^{D210} | L_{C894} | R^{D1} | R^{D210} | L_{C1002} | R^{D4} | R^{D210} | L_{C1110} | R^{D9} | R^{D210} |
| L_{C787} | R^{D211} | R^{D211} | L_{C895} | R^{D1} | R^{D211} | L_{C1003} | R^{D4} | R^{D211} | L_{C1111} | R^{D9} | R^{D211} |
| L_{C788} | R^{D212} | R^{D212} | L_{C896} | R^{D1} | R^{D212} | L_{C1004} | R^{D4} | R^{D212} | L_{C1112} | R^{D9} | R^{D212} |
| L_{C789} | R^{D213} | R^{D213} | L_{C897} | R^{D1} | R^{D213} | L_{C1005} | R^{D4} | R^{D213} | L_{C1113} | R^{D9} | R^{D213} |
| L_{C790} | R^{D214} | R^{D214} | L_{C898} | R^{D1} | R^{D214} | L_{C1006} | R^{D4} | R^{D214} | L_{C1114} | R^{D9} | R^{D214} |
| L_{C791} | R^{D215} | R^{D215} | L_{C899} | R^{D1} | R^{D215} | L_{C1007} | R^{D4} | R^{D215} | L_{C1115} | R^{D9} | R^{D215} |
| L_{C792} | R^{D216} | R^{D216} | L_{C900} | R^{D1} | R^{D216} | L_{C1008} | R^{D4} | R^{D216} | L_{C1116} | R^{D9} | R^{D216} |
| L_{C793} | R^{D217} | R^{D217} | L_{C901} | R^{D1} | R^{D217} | L_{C1009} | R^{D4} | R^{D217} | L_{C1117} | R^{D9} | R^{D217} |
| L_{C794} | R^{D218} | R^{D218} | L_{C902} | R^{D1} | R^{D218} | L_{C1010} | R^{D4} | R^{D218} | L_{C1118} | R^{D9} | R^{D218} |
| L_{C795} | R^{D219} | R^{D219} | L_{C903} | R^{D1} | R^{D219} | L_{C1011} | R^{D4} | R^{D219} | L_{C1119} | R^{D9} | R^{D219} |
| L_{C796} | R^{D220} | R^{D220} | L_{C904} | R^{D1} | R^{D220} | L_{C1012} | R^{D4} | R^{D220} | L_{C1120} | R^{D9} | R^{D220} |
| L_{C797} | R^{D221} | R^{D221} | L_{C905} | R^{D1} | R^{D221} | L_{C1013} | R^{D4} | R^{D221} | L_{C1121} | R^{D9} | R^{D221} |
| L_{C798} | R^{D222} | R^{D222} | L_{C906} | R^{D1} | R^{D222} | L_{C1014} | R^{D4} | R^{D222} | L_{C1122} | R^{D9} | R^{D222} |
| L_{C799} | R^{D223} | R^{D223} | L_{C907} | R^{D1} | R^{D223} | L_{C1015} | R^{D4} | R^{D223} | L_{C1123} | R^{D9} | R^{D223} |
| L_{C800} | R^{D224} | R^{D224} | L_{C908} | R^{D1} | R^{D224} | L_{C1016} | R^{D4} | R^{D224} | L_{C1124} | R^{D9} | R^{D224} |
| L_{C801} | R^{D225} | R^{D225} | L_{C909} | R^{D1} | R^{D225} | L_{C1017} | R^{D4} | R^{D225} | L_{C1125} | R^{D9} | R^{D225} |
| L_{C802} | R^{D226} | R^{D226} | L_{C910} | R^{D1} | R^{D226} | L_{C1018} | R^{D4} | R^{D226} | L_{C1126} | R^{D9} | R^{D226} |
| L_{C803} | R^{D227} | R^{D227} | L_{C911} | R^{D1} | R^{D227} | L_{C1019} | R^{D4} | R^{D227} | L_{C1127} | R^{D9} | R^{D227} |
| L_{C804} | R^{D228} | R^{D228} | L_{C912} | R^{D1} | R^{D228} | L_{C1020} | R^{D4} | R^{D228} | L_{C1128} | R^{D9} | R^{D228} |
| L_{C805} | R^{D229} | R^{D229} | L_{C913} | R^{D1} | R^{D229} | L_{C1021} | R^{D4} | R^{D229} | L_{C1129} | R^{D9} | R^{D229} |
| L_{C806} | R^{D230} | R^{D230} | L_{C914} | R^{D1} | R^{D230} | L_{C1022} | R^{D4} | R^{D230} | L_{C1130} | R^{D9} | R^{D230} |
| L_{C807} | R^{D231} | R^{D231} | L_{C915} | R^{D1} | R^{D231} | L_{C1023} | R^{D4} | R^{D231} | L_{C1131} | R^{D9} | R^{D231} |
| L_{C808} | R^{D232} | R^{D232} | L_{C916} | R^{D1} | R^{D232} | L_{C1024} | R^{D4} | R^{D232} | L_{C1132} | R^{D9} | R^{D232} |
| L_{C809} | R^{D233} | R^{D233} | L_{C917} | R^{D1} | R^{D233} | L_{C1025} | R^{D4} | R^{D233} | L_{C1133} | R^{D9} | R^{D233} |
| L_{C810} | R^{D234} | R^{D234} | L_{C918} | R^{D1} | R^{D234} | L_{C1026} | R^{D4} | R^{D234} | L_{C1134} | R^{D9} | R^{D234} |
| L_{C811} | R^{D235} | R^{D235} | L_{C919} | R^{D1} | R^{D235} | L_{C1027} | R^{D4} | R^{D235} | L_{C1135} | R^{D9} | R^{D235} |
| L_{C812} | R^{D236} | R^{D236} | L_{C920} | R^{D1} | R^{D236} | L_{C1028} | R^{D4} | R^{D236} | L_{C1136} | R^{D9} | R^{D236} |
| L_{C813} | R^{D237} | R^{D237} | L_{C921} | R^{D1} | R^{D237} | L_{C1029} | R^{D4} | R^{D237} | L_{C1137} | R^{D9} | R^{D237} |
| L_{C814} | R^{D238} | R^{D238} | L_{C922} | R^{D1} | R^{D238} | L_{C1030} | R^{D4} | R^{D238} | L_{C1138} | R^{D9} | R^{D238} |
| L_{C815} | R^{D239} | R^{D239} | L_{C923} | R^{D1} | R^{D239} | L_{C1031} | R^{D4} | R^{D239} | L_{C1139} | R^{D9} | R^{D239} |
| L_{C816} | R^{D240} | R^{D240} | L_{C924} | R^{D1} | R^{D240} | L_{C1032} | R^{D4} | R^{D240} | L_{C1140} | R^{D9} | R^{D240} |
| L_{C817} | R^{D241} | R^{D241} | L_{C925} | R^{D1} | R^{D241} | L_{C1033} | R^{D4} | R^{D241} | L_{C1141} | R^{D9} | R^{D241} |
| L_{C818} | R^{D242} | R^{D242} | L_{C926} | R^{D1} | R^{D242} | L_{C1034} | R^{D4} | R^{D242} | L_{C1142} | R^{D9} | R^{D242} |
| L_{C819} | R^{D243} | R^{D243} | L_{C927} | R^{D1} | R^{D243} | L_{C1035} | R^{D4} | R^{D243} | L_{C1143} | R^{D9} | R^{D243} |
| L_{C820} | R^{D244} | R^{D244} | L_{C928} | R^{D1} | R^{D244} | L_{C1036} | R^{D4} | R^{D244} | L_{C1144} | R^{D9} | R^{D244} |
| L_{C821} | R^{D245} | R^{D245} | L_{C929} | R^{D1} | R^{D245} | L_{C1037} | R^{D4} | R^{D245} | L_{C1145} | R^{D9} | R^{D245} |
| L_{C822} | R^{D246} | R^{D246} | L_{C930} | R^{D1} | R^{D246} | L_{C1038} | R^{D4} | R^{D246} | L_{C1146} | R^{D9} | R^{D246} |
| L_{C823} | R^{D17} | R^{D193} | L_{C931} | R^{D50} | R^{D193} | L_{C1039} | R^{D145} | R^{D193} | L_{C1147} | R^{D168} | R^{D193} |
| L_{C824} | R^{D17} | R^{D194} | L_{C932} | R^{D50} | R^{D194} | L_{C1040} | R^{D145} | R^{D194} | L_{C1148} | R^{D168} | R^{D194} |
| L_{C825} | R^{D17} | R^{D195} | L_{C933} | R^{D50} | R^{D195} | L_{C1041} | R^{D145} | R^{D195} | L_{C1149} | R^{D168} | R^{D195} |
| L_{C826} | R^{D17} | R^{D196} | L_{C934} | R^{D50} | R^{D196} | L_{C1042} | R^{D145} | R^{D196} | L_{C1150} | R^{D168} | R^{D196} |
| L_{C827} | R^{D17} | R^{D197} | L_{C935} | R^{D50} | R^{D197} | L_{C1043} | R^{D145} | R^{D197} | L_{C1151} | R^{D168} | R^{D197} |
| L_{C828} | R^{D17} | R^{D198} | L_{C936} | R^{D50} | R^{D198} | L_{C1044} | R^{D145} | R^{D198} | L_{C1152} | R^{D168} | R^{D198} |
| L_{C829} | R^{D17} | R^{D199} | L_{C937} | R^{D50} | R^{D199} | L_{C1045} | R^{D145} | R^{D199} | L_{C1153} | R^{D168} | R^{D199} |
| L_{C830} | R^{D17} | R^{D200} | L_{C938} | R^{D50} | R^{D200} | L_{C1046} | R^{D145} | R^{D200} | L_{C1154} | R^{D168} | R^{D200} |
| L_{C831} | R^{D17} | R^{D201} | L_{C939} | R^{D50} | R^{D201} | L_{C1047} | R^{D145} | R^{D201} | L_{C1155} | R^{D168} | R^{D201} |
| L_{C832} | R^{D17} | R^{D202} | L_{C940} | R^{D50} | R^{D202} | L_{C1048} | R^{D145} | R^{D202} | L_{C1156} | R^{D168} | R^{D202} |
| L_{C833} | R^{D17} | R^{D203} | L_{C941} | R^{D50} | R^{D203} | L_{C1049} | R^{D145} | R^{D203} | L_{C1157} | R^{D168} | R^{D203} |
| L_{C834} | R^{D17} | R^{D204} | L_{C942} | R^{D50} | R^{D204} | L_{C1050} | R^{D145} | R^{D204} | L_{C1158} | R^{D168} | R^{D204} |
| L_{C835} | R^{D17} | R^{D205} | L_{C943} | R^{D50} | R^{D205} | L_{C1051} | R^{D145} | R^{D205} | L_{C1159} | R^{D168} | R^{D205} |
| L_{C836} | R^{D17} | R^{D206} | L_{C944} | R^{D50} | R^{D206} | L_{C1052} | R^{D145} | R^{D206} | L_{C1160} | R^{D168} | R^{D206} |
| L_{C837} | R^{D17} | R^{D207} | L_{C945} | R^{D50} | R^{D207} | L_{C1053} | R^{D145} | R^{D207} | L_{C1161} | R^{D168} | R^{D207} |
| L_{C838} | R^{D17} | R^{D208} | L_{C946} | R^{D50} | R^{D208} | L_{C1054} | R^{D145} | R^{D208} | L_{C1162} | R^{D168} | R^{D208} |
| L_{C839} | R^{D17} | R^{D209} | L_{C947} | R^{D50} | R^{D209} | L_{C1055} | R^{D145} | R^{D209} | L_{C1163} | R^{D168} | R^{D209} |
| L_{C840} | R^{D17} | R^{D210} | L_{C948} | R^{D50} | R^{D210} | L_{C1056} | R^{D145} | R^{D210} | L_{C1164} | R^{D168} | R^{D210} |
| L_{C841} | R^{D17} | R^{D211} | L_{C949} | R^{D50} | R^{D211} | L_{C1057} | R^{D145} | R^{D211} | L_{C1165} | R^{D168} | R^{D211} |
| L_{C842} | R^{D17} | R^{D212} | L_{C950} | R^{D50} | R^{D212} | L_{C1058} | R^{D145} | R^{D212} | L_{C1166} | R^{D168} | R^{D212} |
| L_{C843} | R^{D17} | R^{D213} | L_{C951} | R^{D50} | R^{D213} | L_{C1059} | R^{D145} | R^{D213} | L_{C1167} | R^{D168} | R^{D213} |
| L_{C844} | R^{D17} | R^{D214} | L_{C952} | R^{D50} | R^{D214} | L_{C1060} | R^{D145} | R^{D214} | L_{C1168} | R^{D168} | R^{D214} |
| L_{C845} | R^{D17} | R^{D215} | L_{C953} | R^{D50} | R^{D215} | L_{C1061} | R^{D145} | R^{D215} | L_{C1169} | R^{D168} | R^{D215} |
| L_{C846} | R^{D17} | R^{D216} | L_{C954} | R^{D50} | R^{D216} | L_{C1062} | R^{D145} | R^{D216} | L_{C1170} | R^{D168} | R^{D216} |
| L_{C847} | R^{D17} | R^{D217} | L_{C955} | R^{D50} | R^{D217} | L_{C1063} | R^{D145} | R^{D217} | L_{C1171} | R^{D168} | R^{D217} |
| L_{C848} | R^{D17} | R^{D218} | L_{C956} | R^{D50} | R^{D218} | L_{C1064} | R^{D145} | R^{D218} | L_{C1172} | R^{D168} | R^{D218} |
| L_{C849} | R^{D17} | R^{D219} | L_{C957} | R^{D50} | R^{D219} | L_{C1065} | R^{D145} | R^{D219} | L_{C1173} | R^{D168} | R^{D219} |
| L_{C850} | R^{D17} | R^{D220} | L_{C958} | R^{D50} | R^{D220} | L_{C1066} | R^{D145} | R^{D220} | L_{C1174} | R^{D168} | R^{D220} |
| L_{C851} | R^{D17} | R^{D221} | L_{C959} | R^{D50} | R^{D221} | L_{C1067} | R^{D145} | R^{D221} | L_{C1175} | R^{D168} | R^{D221} |
| L_{C852} | R^{D17} | R^{D222} | L_{C960} | R^{D50} | R^{D222} | L_{C1068} | R^{D145} | R^{D222} | L_{C1176} | R^{D168} | R^{D222} |
| L_{C853} | R^{D17} | R^{D223} | L_{C961} | R^{D50} | R^{D223} | L_{C1069} | R^{D145} | R^{D223} | L_{C1177} | R^{D168} | R^{D223} |
| L_{C854} | R^{D17} | R^{D224} | L_{C962} | R^{D50} | R^{D224} | L_{C1070} | R^{D145} | R^{D224} | L_{C1178} | R^{D168} | R^{D224} |
| L_{C855} | R^{D17} | R^{D225} | L_{C963} | R^{D50} | R^{D225} | L_{C1071} | R^{D145} | R^{D225} | L_{C1179} | R^{D168} | R^{D225} |
| L_{C856} | R^{D17} | R^{D226} | L_{C964} | R^{D50} | R^{D226} | L_{C1072} | R^{D145} | R^{D226} | L_{C1180} | R^{D168} | R^{D226} |
| L_{C857} | R^{D17} | R^{D227} | L_{C965} | R^{D50} | R^{D227} | L_{C1073} | R^{D145} | R^{D227} | L_{C1181} | R^{D168} | R^{D227} |
| L_{C858} | R^{D17} | R^{D228} | L_{C966} | R^{D50} | R^{D228} | L_{C1074} | R^{D145} | R^{D228} | L_{C1182} | R^{D168} | R^{D228} |
| L_{C859} | R^{D17} | R^{D229} | L_{C967} | R^{D50} | R^{D229} | L_{C1075} | R^{D145} | R^{D229} | L_{C1183} | R^{D168} | R^{D229} |
| L_{C860} | R^{D17} | R^{D230} | L_{C968} | R^{D50} | R^{D230} | L_{C1076} | R^{D145} | R^{D230} | L_{C1184} | R^{D168} | R^{D230} |
| L_{C861} | R^{D17} | R^{D231} | L_{C969} | R^{D50} | R^{D231} | L_{C1077} | R^{D145} | R^{D231} | L_{C1185} | R^{D168} | R^{D231} |
| L_{C862} | R^{D17} | R^{D232} | L_{C970} | R^{D50} | R^{D232} | L_{C1078} | R^{D145} | R^{D232} | L_{C1186} | R^{D168} | R^{D232} |
| L_{C863} | R^{D17} | R^{D233} | L_{C971} | R^{D50} | R^{D233} | L_{C1079} | R^{D145} | R^{D233} | L_{C1187} | R^{D168} | R^{D233} |
| L_{C864} | R^{D17} | R^{D234} | L_{C972} | R^{D50} | R^{D234} | L_{C1080} | R^{D145} | R^{D234} | L_{C1188} | R^{D168} | R^{D234} |
| L_{C865} | R^{D17} | R^{D235} | L_{C973} | R^{D50} | R^{D235} | L_{C1081} | R^{D145} | R^{D235} | L_{C1189} | R^{D168} | R^{D235} |
| L_{C866} | R^{D17} | R^{D236} | L_{C974} | R^{D50} | R^{D236} | L_{C1082} | R^{D145} | R^{D236} | L_{C1190} | R^{D168} | R^{D236} |
| L_{C867} | R^{D17} | R^{D237} | L_{C975} | R^{D50} | R^{D237} | L_{C1083} | R^{D145} | R^{D237} | L_{C1191} | R^{D168} | R^{D237} |
| L_{C868} | R^{D17} | R^{D238} | L_{C976} | R^{D50} | R^{D238} | L_{C1084} | R^{D145} | R^{D238} | L_{C1192} | R^{D168} | R^{D238} |
| L_{C869} | R^{D17} | R^{D239} | L_{C977} | R^{D50} | R^{D239} | L_{C1085} | R^{D145} | R^{D239} | L_{C1193} | R^{D168} | R^{D239} |
| L_{C870} | R^{D17} | R^{D240} | L_{C978} | R^{D50} | R^{D240} | L_{C1086} | R^{D145} | R^{D240} | L_{C1194} | R^{D168} | R^{D240} |
| L_{C871} | R^{D17} | R^{D241} | L_{C979} | R^{D50} | R^{D241} | L_{C1087} | R^{D145} | R^{D241} | L_{C1195} | R^{D168} | R^{D241} |
| L_{C872} | R^{D17} | R^{D242} | L_{C980} | R^{D50} | R^{D242} | L_{C1088} | R^{D145} | R^{D242} | L_{C1196} | R^{D168} | R^{D242} |
| L_{C873} | R^{D17} | R^{D243} | L_{C981} | R^{D50} | R^{D243} | L_{C1089} | R^{D145} | R^{D243} | L_{C1197} | R^{D168} | R^{D243} |
| L_{C874} | R^{D17} | R^{D244} | L_{C982} | R^{D50} | R^{D244} | L_{C1090} | R^{D145} | R^{D244} | L_{C1198} | R^{D168} | R^{D244} |
| L_{C875} | R^{D17} | R^{D245} | L_{C983} | R^{D50} | R^{D245} | L_{C1091} | R^{D145} | R^{D245} | L_{C1199} | R^{D168} | R^{D245} |
| L_{C876} | R^{D17} | R^{D246} | L_{C984} | R^{D50} | R^{D246} | L_{C1092} | R^{D145} | R^{D246} | L_{C1200} | R^{D168} | R^{D246} |
| L_{C1201} | R^{D10} | R^{D193} | L_{C1255} | R^{D55} | R^{D193} | L_{C1309} | R^{D37} | R^{D193} | L_{C1363} | R^{D143} | R^{D193} |
| L_{C1202} | R^{D10} | R^{D194} | L_{C1256} | R^{D55} | R^{D194} | L_{C1310} | R^{D37} | R^{D194} | L_{C1364} | R^{D143} | R^{D194} |
| L_{C1203} | R^{D10} | R^{D195} | L_{C1257} | R^{D55} | R^{D195} | L_{C1311} | R^{D37} | R^{D195} | L_{C1365} | R^{D143} | R^{D195} |
| L_{C1204} | R^{D10} | R^{D196} | L_{C1258} | R^{D55} | R^{D196} | L_{C1312} | R^{D37} | R^{D196} | L_{C1366} | R^{D143} | R^{D196} |
| L_{C1205} | R^{D10} | R^{D197} | L_{C1259} | R^{D55} | R^{D197} | L_{C1313} | R^{D37} | R^{D197} | L_{C1367} | R^{D143} | R^{D197} |
| L_{C1206} | R^{D10} | R^{D198} | L_{C1260} | R^{D55} | R^{D198} | L_{C1314} | R^{D37} | R^{D198} | L_{C1368} | R^{D143} | R^{D198} |
| L_{C1207} | R^{D10} | R^{D199} | L_{C1261} | R^{D55} | R^{D199} | L_{C1315} | R^{D37} | R^{D199} | L_{C1369} | R^{D143} | R^{D199} |
| L_{C1208} | R^{D10} | R^{D200} | L_{C1262} | R^{D55} | R^{D200} | L_{C1316} | R^{D37} | R^{D200} | L_{C1370} | R^{D143} | R^{D200} |
| L_{C1209} | R^{D10} | R^{D201} | L_{C1263} | R^{D55} | R^{D201} | L_{C1317} | R^{D37} | R^{D201} | L_{C1371} | R^{D143} | R^{D201} |
| L_{C1210} | R^{D10} | R^{D202} | L_{C1264} | R^{D55} | R^{D202} | L_{C1318} | R^{D37} | R^{D202} | L_{C1372} | R^{D143} | R^{D202} |
| L_{C1211} | R^{D10} | R^{D203} | L_{C1265} | R^{D55} | R^{D203} | L_{C1319} | R^{D37} | R^{D203} | L_{C1373} | R^{D143} | R^{D203} |
| L_{C1212} | R^{D10} | R^{D204} | L_{C1266} | R^{D55} | R^{D204} | L_{C1320} | R^{D37} | R^{D204} | L_{C1374} | R^{D143} | R^{D204} |
| L_{C1213} | R^{D10} | R^{D205} | L_{C1267} | R^{D55} | R^{D205} | L_{C1321} | R^{D37} | R^{D205} | L_{C1375} | R^{D143} | R^{D205} |
| L_{C1214} | R^{D10} | R^{D206} | L_{C1268} | R^{D55} | R^{D206} | L_{C1322} | R^{D37} | R^{D206} | L_{C1376} | R^{D143} | R^{D206} |
| L_{C1215} | R^{D10} | R^{D207} | L_{C1269} | R^{D55} | R^{D207} | L_{C1323} | R^{D37} | R^{D207} | L_{C1377} | R^{D143} | R^{D207} |
| L_{C1216} | R^{D10} | R^{D208} | L_{C1270} | R^{D55} | R^{D208} | L_{C1324} | R^{D37} | R^{D208} | L_{C1378} | R^{D143} | R^{D208} |
| L_{C1217} | R^{D10} | R^{D209} | L_{C1271} | R^{D55} | R^{D209} | L_{C1325} | R^{D37} | R^{D209} | L_{C1379} | R^{D143} | R^{D209} |
| L_{C1218} | R^{D10} | R^{D210} | L_{C1272} | R^{D55} | R^{D210} | L_{C1326} | R^{D37} | R^{D210} | L_{C1380} | R^{D143} | R^{D210} |
| L_{C1219} | R^{D10} | R^{D211} | L_{C1273} | R^{D55} | R^{D211} | L_{C1327} | R^{D37} | R^{D211} | L_{C1381} | R^{D143} | R^{D211} |
| L_{C1220} | R^{D10} | R^{D212} | L_{C1274} | R^{D55} | R^{D212} | L_{C1328} | R^{D37} | R^{D212} | L_{C1382} | R^{D143} | R^{D212} |
| L_{C1221} | R^{D10} | R^{D213} | L_{C1275} | R^{D55} | R^{D213} | L_{C1329} | R^{D37} | R^{D213} | L_{C1383} | R^{D143} | R^{D213} |
| L_{C1222} | R^{D10} | R^{D214} | L_{C1276} | R^{D55} | R^{D214} | L_{C1330} | R^{D37} | R^{D214} | L_{C1384} | R^{D143} | R^{D214} |
| L_{C1223} | R^{D10} | R^{D215} | L_{C1277} | R^{D55} | R^{D215} | L_{C1331} | R^{D37} | R^{D215} | L_{C1385} | R^{D143} | R^{D215} |
| L_{C1224} | R^{D10} | R^{D216} | L_{C1278} | R^{D55} | R^{D216} | L_{C1332} | R^{D37} | R^{D216} | L_{C1386} | R^{D143} | R^{D216} |
| L_{C1225} | R^{D10} | R^{D217} | L_{C1279} | R^{D55} | R^{D217} | L_{C1333} | R^{D37} | R^{D217} | L_{C1387} | R^{D143} | R^{D217} |
| L_{C1226} | R^{D10} | R^{D218} | L_{C1280} | R^{D55} | R^{D218} | L_{C1334} | R^{D37} | R^{D218} | L_{C1388} | R^{D143} | R^{D218} |
| L_{C1227} | R^{D10} | R^{D219} | L_{C1281} | R^{D55} | R^{D219} | L_{C1335} | R^{D37} | R^{D219} | L_{C1389} | R^{D143} | R^{D219} |
| L_{C1228} | R^{D10} | R^{D220} | L_{C1282} | R^{D55} | R^{D220} | L_{C1336} | R^{D37} | R^{D220} | L_{C1390} | R^{D143} | R^{D220} |
| L_{C1229} | R^{D10} | R^{D221} | L_{C1283} | R^{D55} | R^{D221} | L_{C1337} | R^{D37} | R^{D221} | L_{C1391} | R^{D143} | R^{D221} |
| L_{C1230} | R^{D10} | R^{D222} | L_{C1284} | R^{D55} | R^{D222} | L_{C1338} | R^{D37} | R^{D222} | L_{C1392} | R^{D143} | R^{D222} |
| L_{C1231} | R^{D10} | R^{D223} | L_{C1285} | R^{D55} | R^{D223} | L_{C1339} | R^{D37} | R^{D223} | L_{C1393} | R^{D143} | R^{D223} |
| L_{C1232} | R^{D10} | R^{D224} | L_{C1286} | R^{D55} | R^{D224} | L_{C1340} | R^{D37} | R^{D224} | L_{C1394} | R^{D143} | R^{D224} |
| L_{C1233} | R^{D10} | R^{D225} | L_{C1287} | R^{D55} | R^{D225} | L_{C1341} | R^{D37} | R^{D225} | L_{C1395} | R^{D143} | R^{D225} |
| L_{C1234} | R^{D10} | R^{D226} | L_{C1288} | R^{D55} | R^{D226} | L_{C1342} | R^{D37} | R^{D226} | L_{C1396} | R^{D143} | R^{D226} |
| L_{C1235} | R^{D10} | R^{D227} | L_{C1289} | R^{D55} | R^{D227} | L_{C1343} | R^{D37} | R^{D227} | L_{C1397} | R^{D143} | R^{D227} |
| L_{C1236} | R^{D10} | R^{D228} | L_{C1290} | R^{D55} | R^{D228} | L_{C1344} | R^{D37} | R^{D228} | L_{C1398} | R^{D143} | R^{D228} |
| L_{C1237} | R^{D10} | R^{D229} | L_{C1291} | R^{D55} | R^{D229} | L_{C1345} | R^{D37} | R^{D229} | L_{C1399} | R^{D143} | R^{D229} |
| L_{C1238} | R^{D10} | R^{D230} | L_{C1292} | R^{D55} | R^{D230} | L_{C1346} | R^{D37} | R^{D230} | L_{C1400} | R^{D143} | R^{D230} |
| L_{C1239} | R^{D10} | R^{D231} | L_{C1293} | R^{D55} | R^{D231} | L_{C1347} | R^{D37} | R^{D231} | L_{C1401} | R^{D143} | R^{D231} |
| L_{C1240} | R^{D10} | R^{D232} | L_{C1294} | R^{D55} | R^{D232} | L_{C1348} | R^{D37} | R^{D232} | L_{C1402} | R^{D143} | R^{D232} |
| L_{C1241} | R^{D10} | R^{D233} | L_{C1295} | R^{D55} | R^{D233} | L_{C1349} | R^{D37} | R^{D233} | L_{C1403} | R^{D143} | R^{D233} |
| L_{C1242} | R^{D10} | R^{D234} | L_{C1296} | R^{D55} | R^{D234} | L_{C1350} | R^{D37} | R^{D234} | L_{C1404} | R^{D143} | R^{D234} |
| L_{C1243} | R^{D10} | R^{D235} | L_{C1297} | R^{D55} | R^{D235} | L_{C1351} | R^{D37} | R^{D235} | L_{C1405} | R^{D143} | R^{D235} |
| L_{C1244} | R^{D10} | R^{D236} | L_{C1298} | R^{D55} | R^{D236} | L_{C1352} | R^{D37} | R^{D236} | L_{C1406} | R^{D143} | R^{D236} |
| L_{C1245} | R^{D10} | R^{D237} | L_{C1299} | R^{D55} | R^{D237} | L_{C1353} | R^{D37} | R^{D237} | L_{C1407} | R^{D143} | R^{D237} |
| L_{C1246} | R^{D10} | R^{D238} | L_{C1300} | R^{D55} | R^{D238} | L_{C1354} | R^{D37} | R^{D238} | L_{C1408} | R^{D143} | R^{D238} |
| L_{C1247} | R^{D10} | R^{D239} | L_{C1301} | R^{D55} | R^{D239} | L_{C1355} | R^{D37} | R^{D239} | L_{C1409} | R^{D143} | R^{D239} |
| L_{C1248} | R^{D10} | R^{D240} | L_{C1302} | R^{D55} | R^{D240} | L_{C1356} | R^{D37} | R^{D240} | L_{C1410} | R^{D143} | R^{D240} |
| L_{C1249} | R^{D10} | R^{D241} | L_{C1303} | R^{D55} | R^{D241} | L_{C1357} | R^{D37} | R^{D241} | L_{C1411} | R^{D143} | R^{D241} |
| L_{C1250} | R^{D10} | R^{D242} | L_{C1304} | R^{D55} | R^{D242} | L_{C1358} | R^{D37} | R^{D242} | L_{C1412} | R^{D143} | R^{D242} |
| L_{C1251} | R^{D10} | R^{D243} | L_{C1305} | R^{D55} | R^{D243} | L_{C1359} | R^{D37} | R^{D243} | L_{C1413} | R^{D143} | R^{D243} |
| L_{C1252} | R^{D10} | R^{D244} | L_{C1306} | R^{D55} | R^{D244} | L_{C1360} | R^{D37} | R^{D244} | L_{C1414} | R^{D143} | R^{D244} |
| L_{C1253} | R^{D10} | R^{D245} | L_{C1307} | R^{D55} | R^{D245} | L_{C1361} | R^{D37} | R^{D245} | L_{C1415} | R^{D143} | R^{D245} |
| L_{C1254} | R^{D10} | R^{D246} | L_{C1308} | R^{D55} | R^{D246} | L_{C1362} | R^{D37} | R^{D246} | L_{C1416} | R^{D143} | R^{D246} |
wherein R^{D1} to R^{D246} have the structures defined in the following LIST 11:

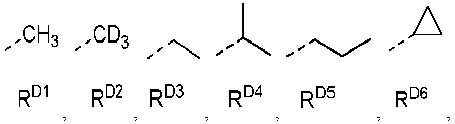

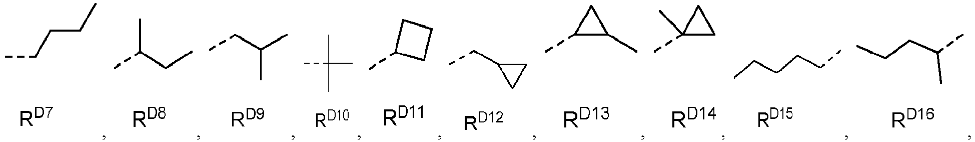

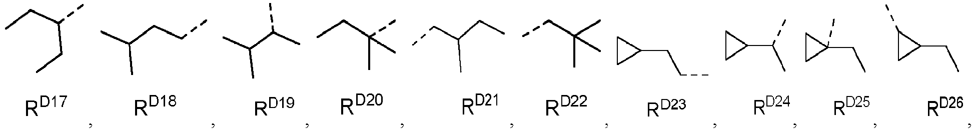

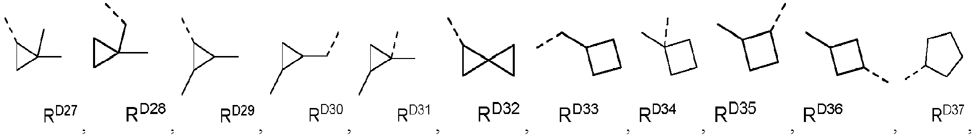

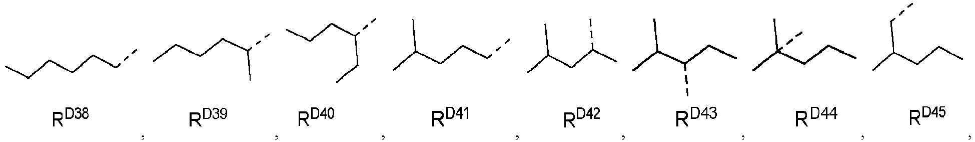

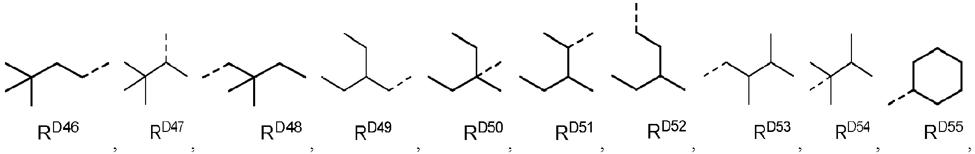

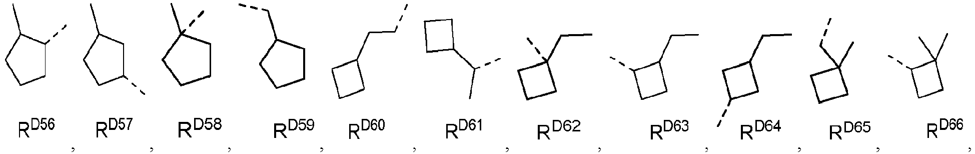

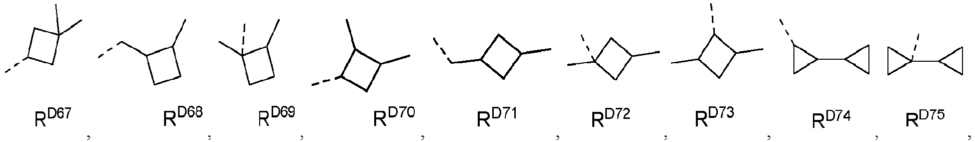

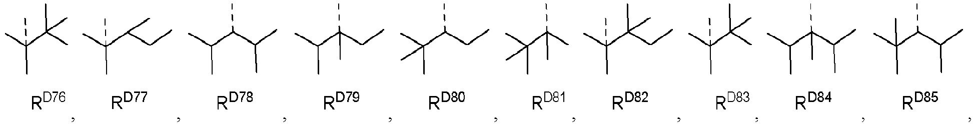

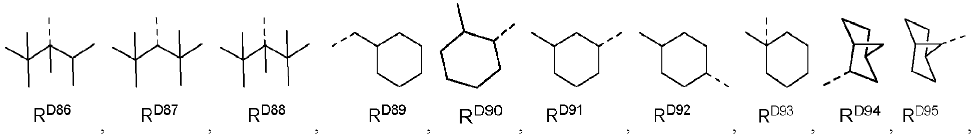

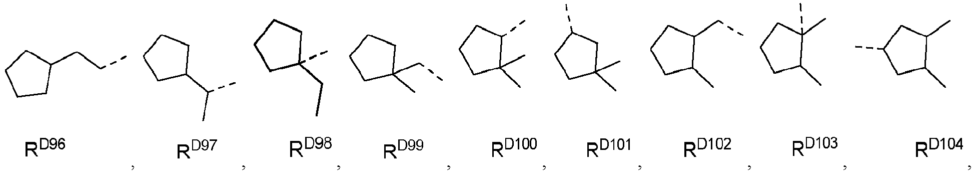

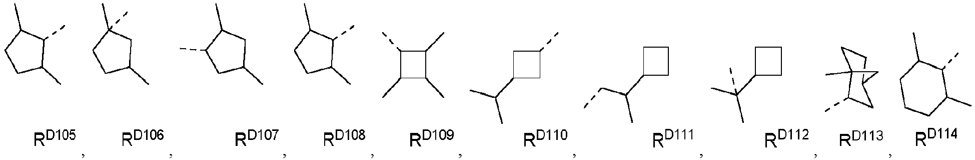

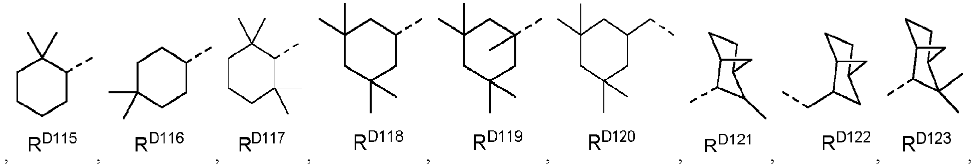

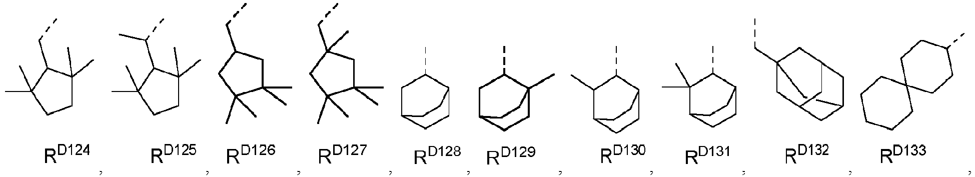

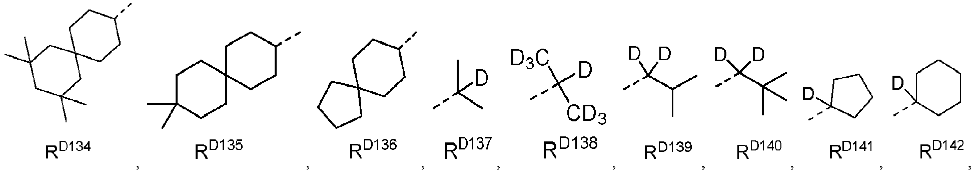

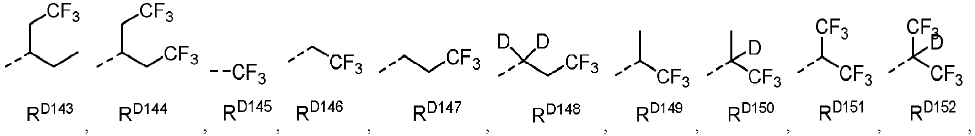

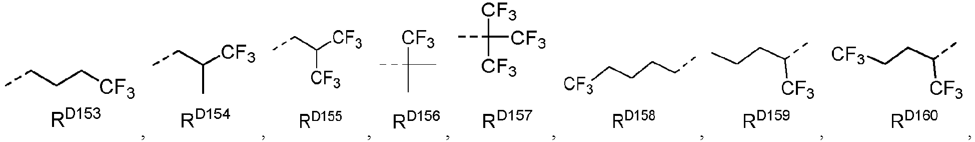

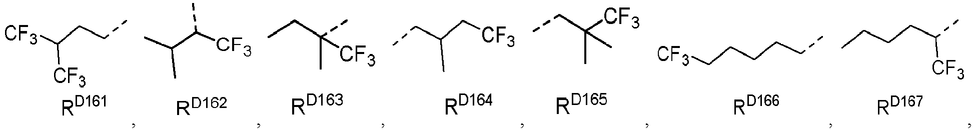

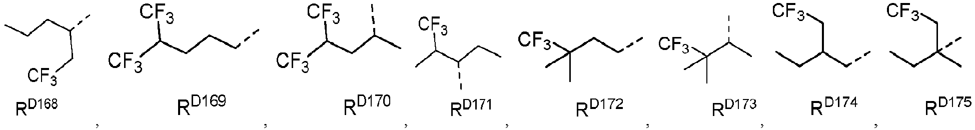

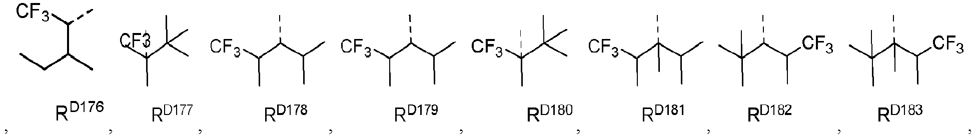

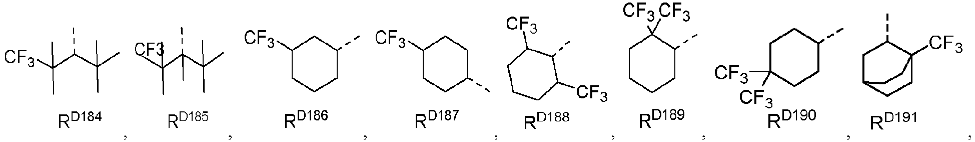

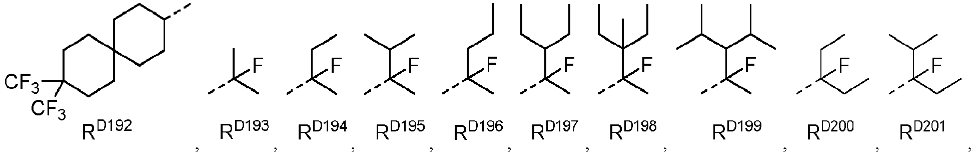

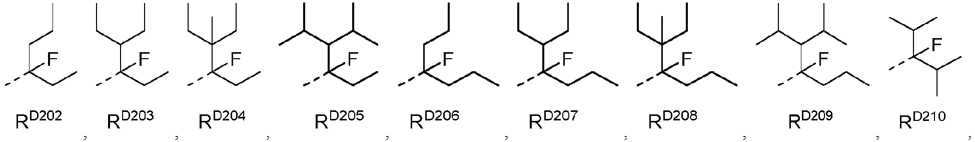

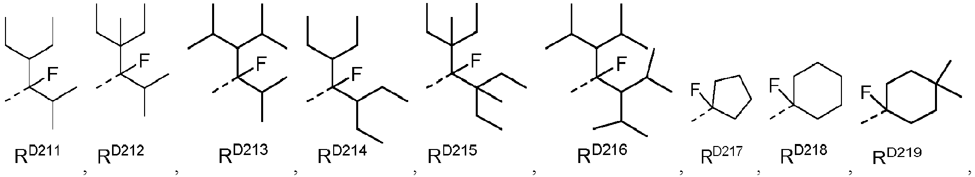

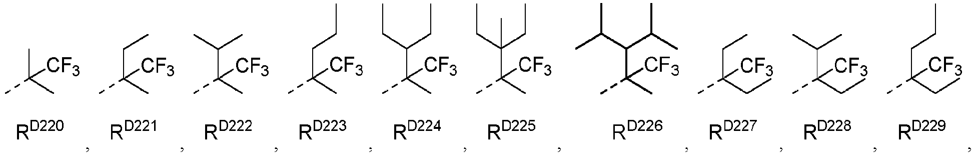

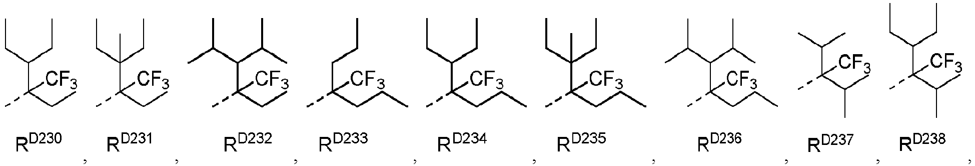

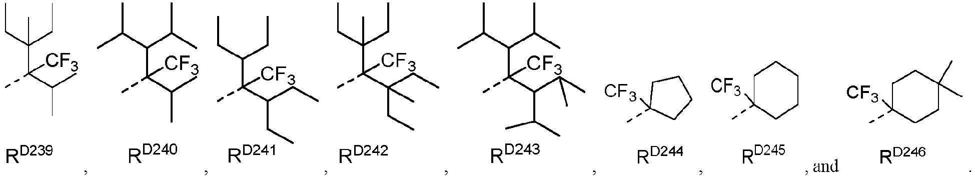

13. The compound of claim 1, wherein the compound is selected from the group consisting of:

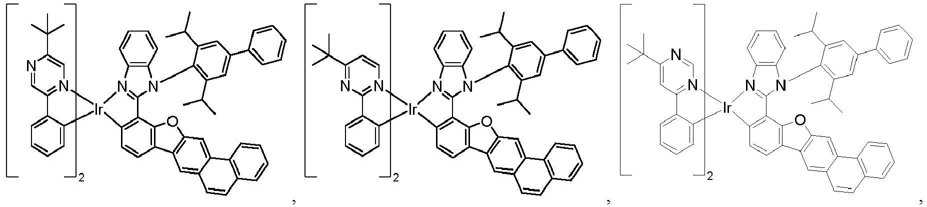

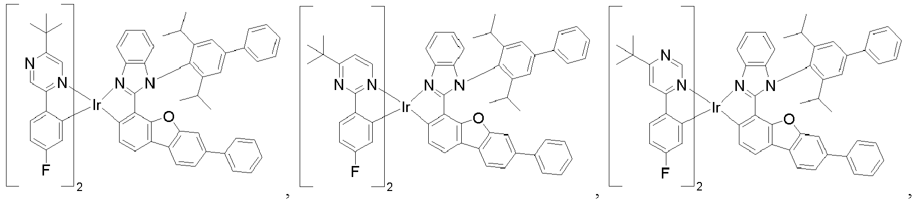

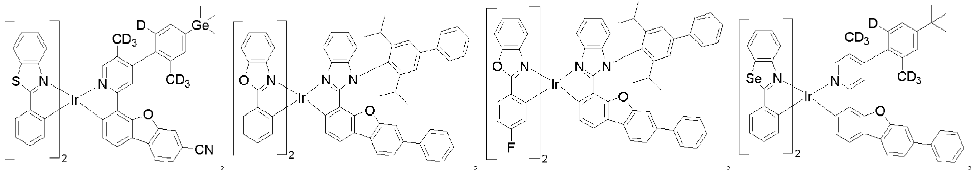

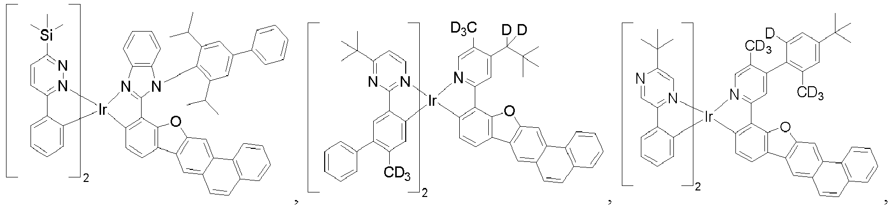

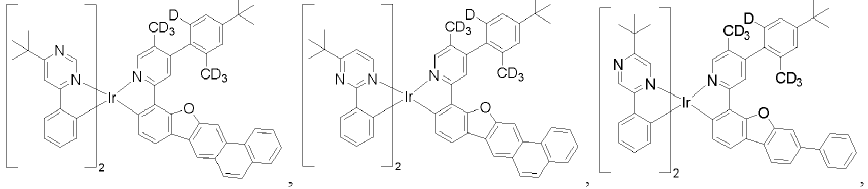

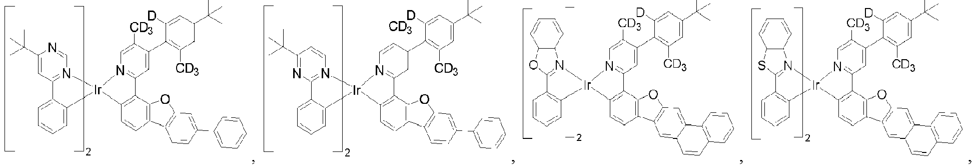

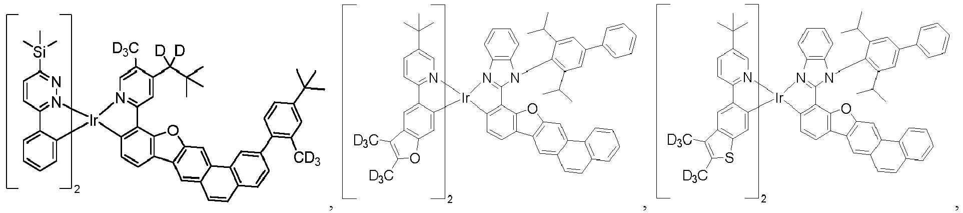

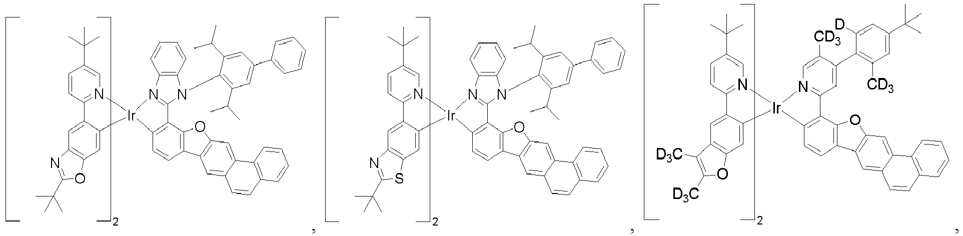

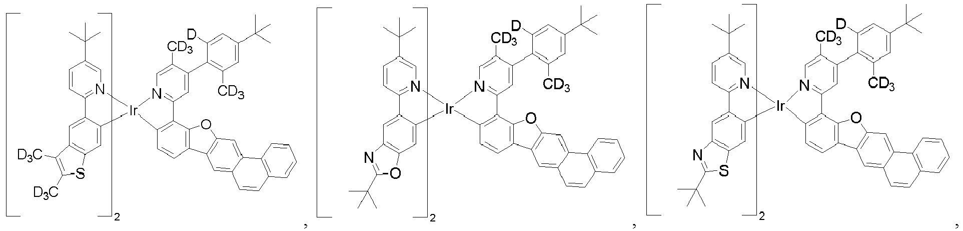

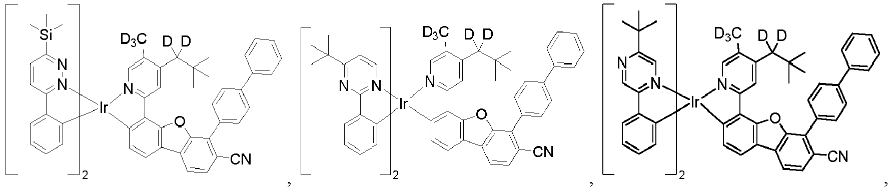

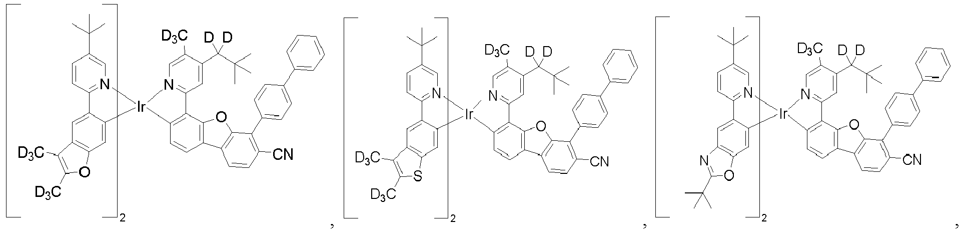

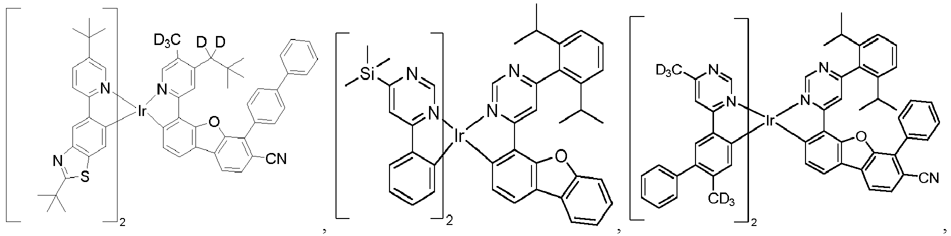

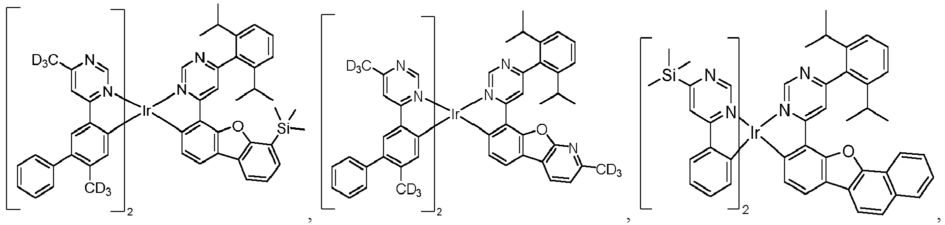

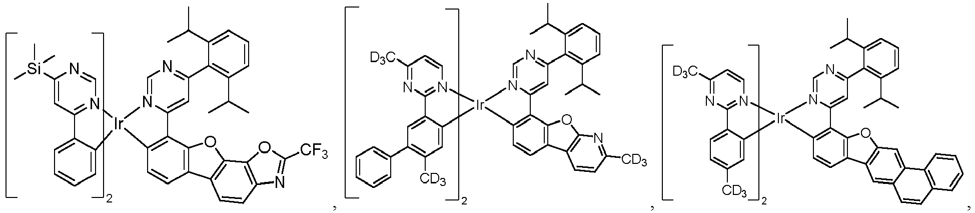

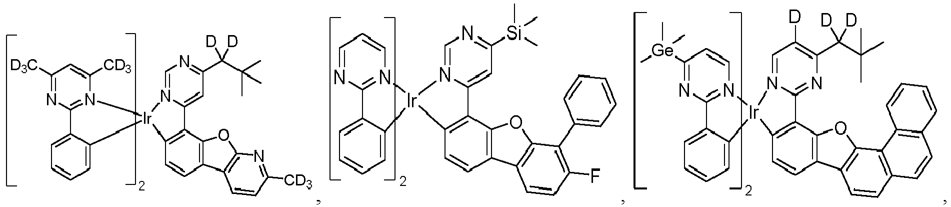

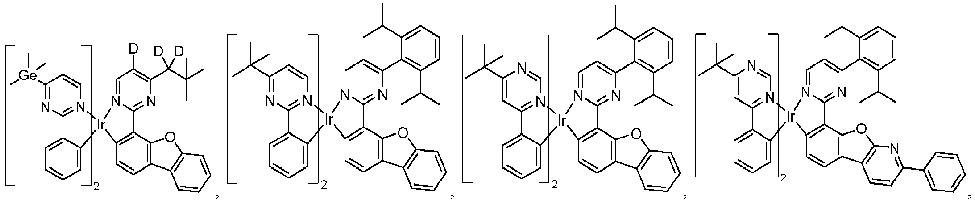

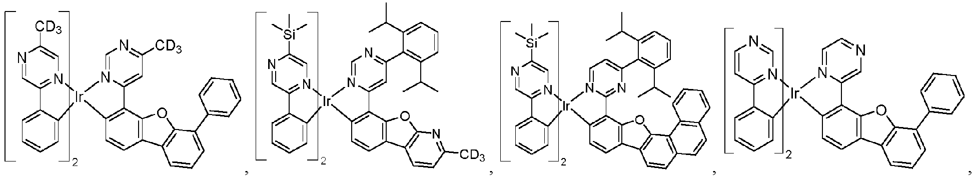

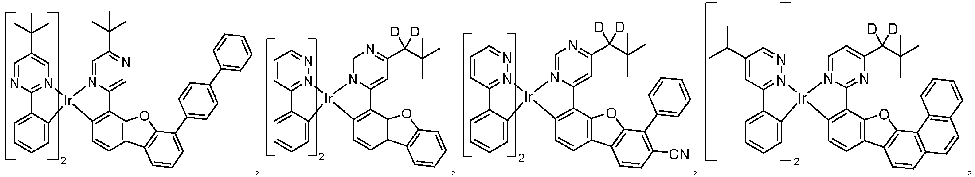

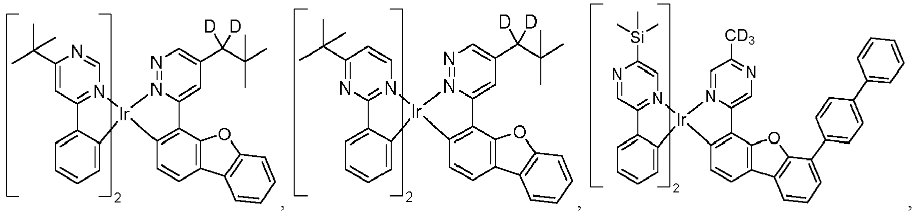

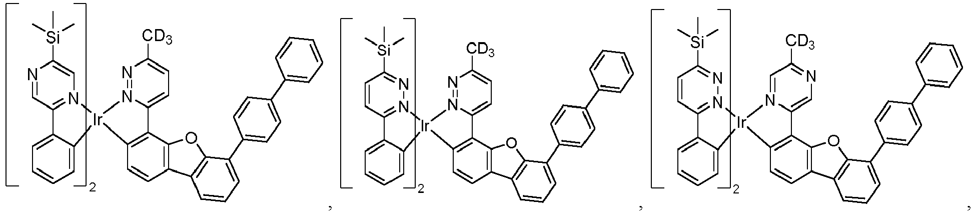

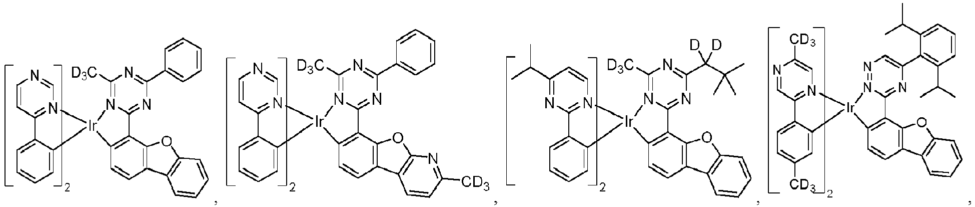

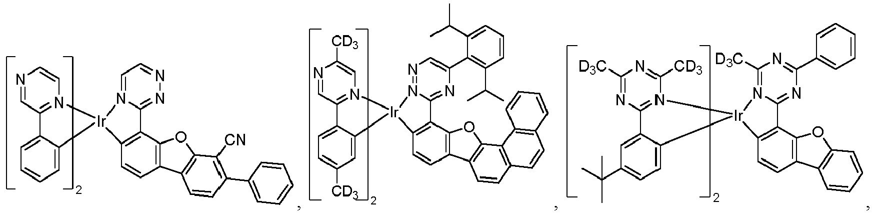

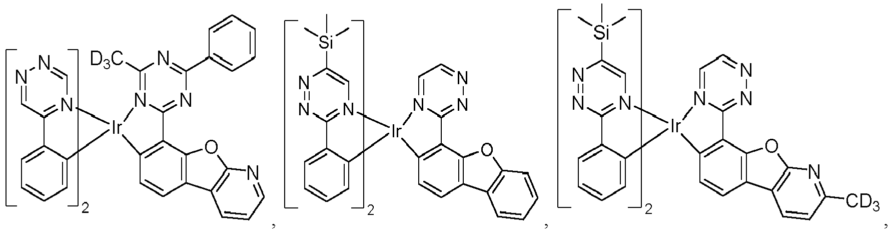

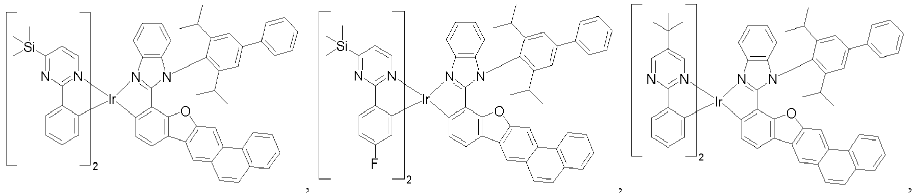

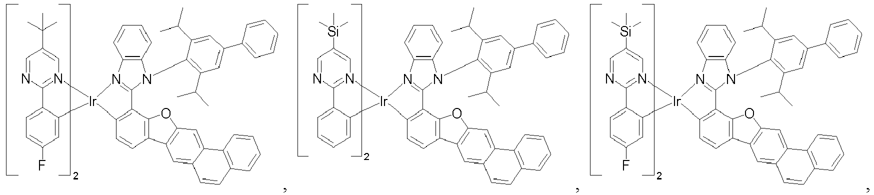

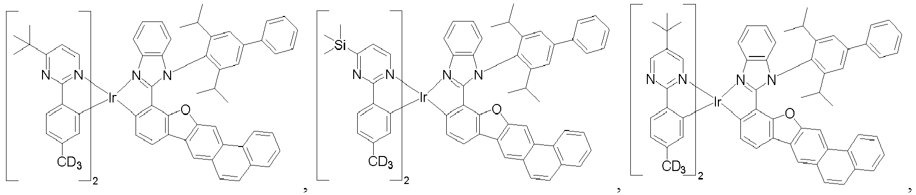

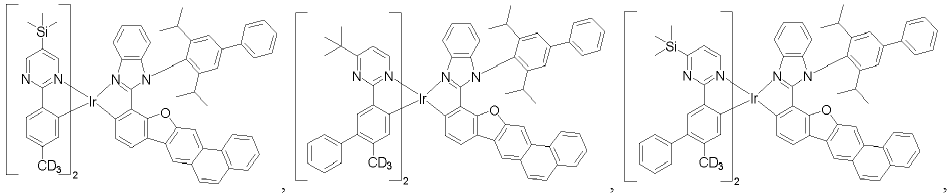

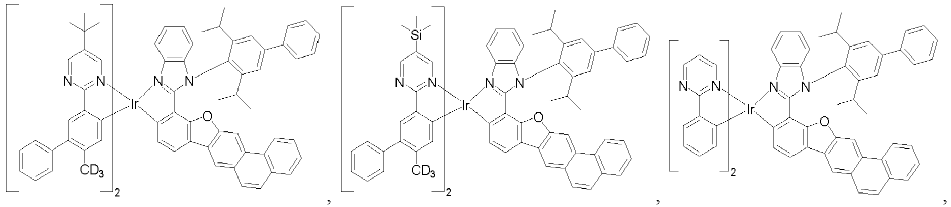

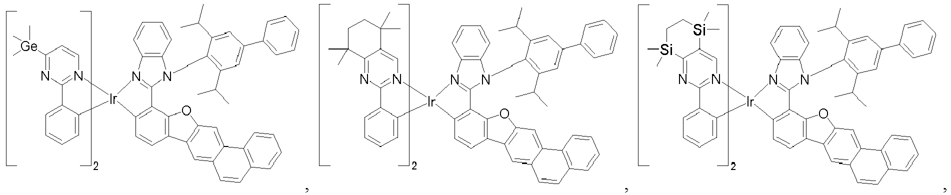

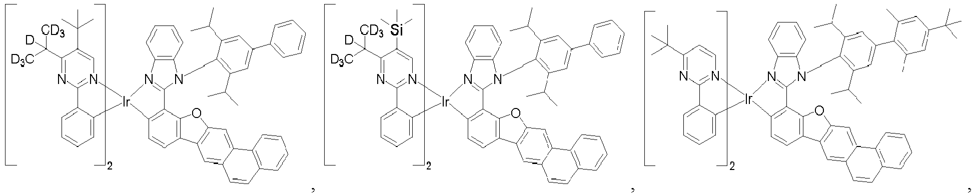

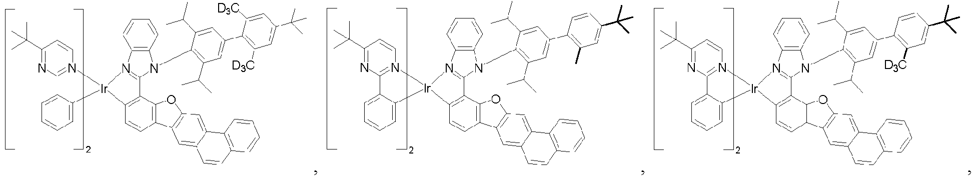

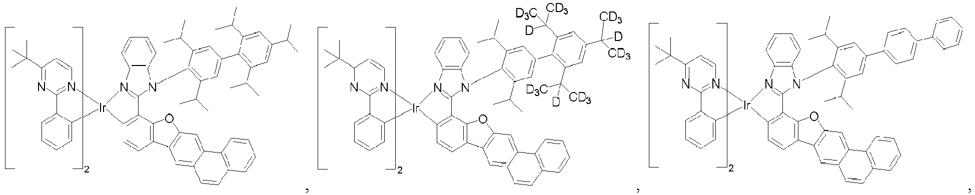

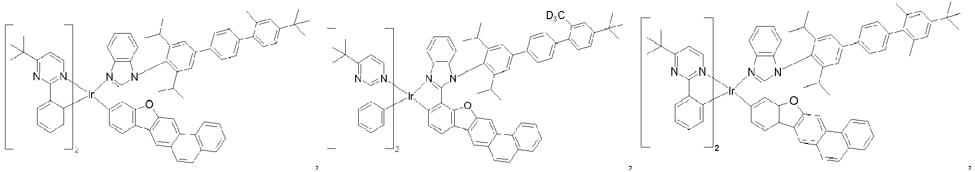

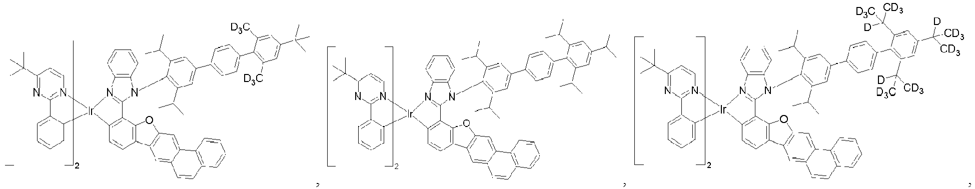

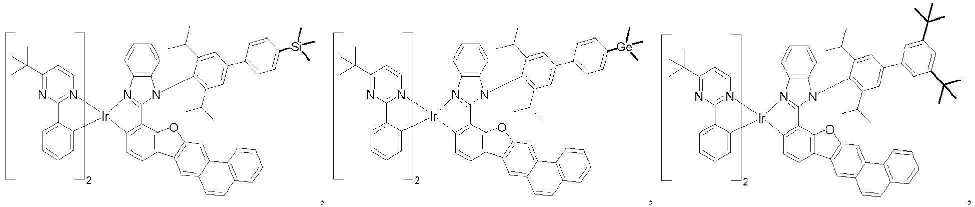

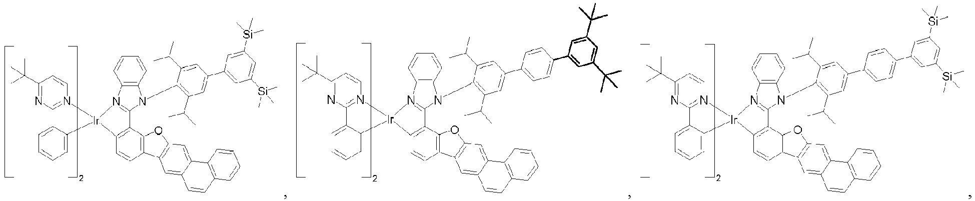

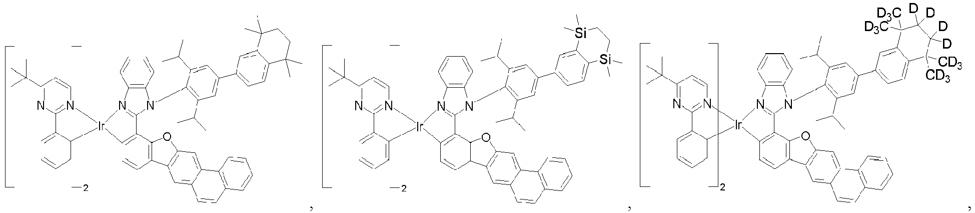

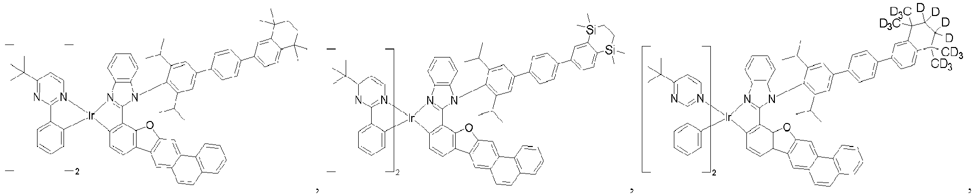

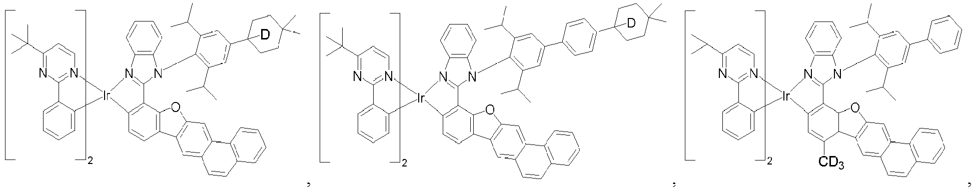

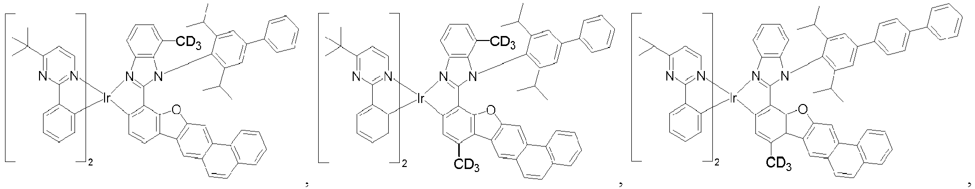

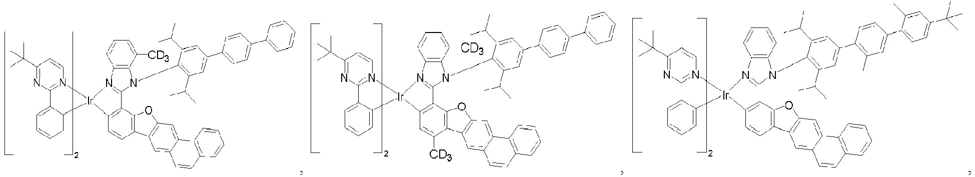

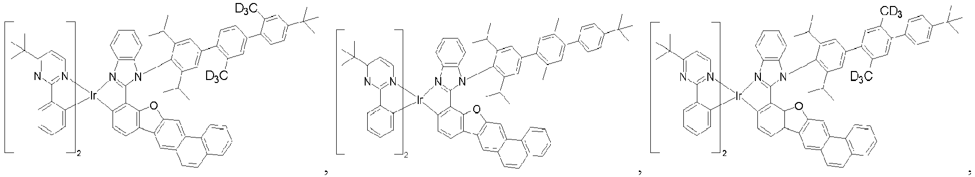

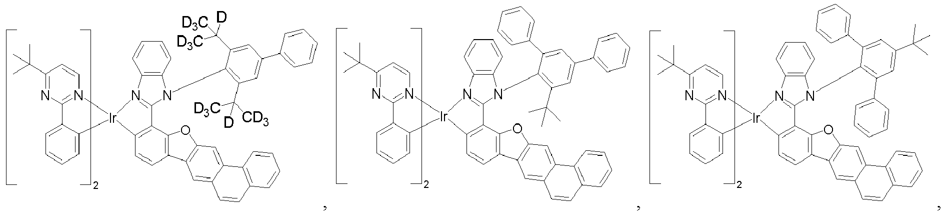

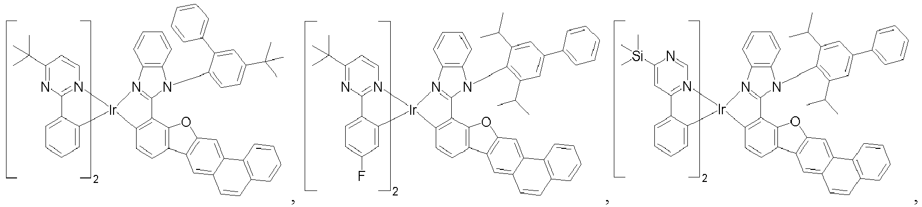

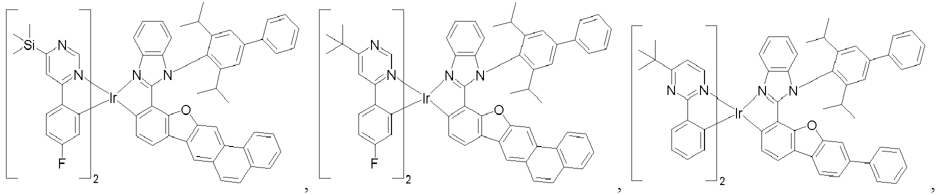

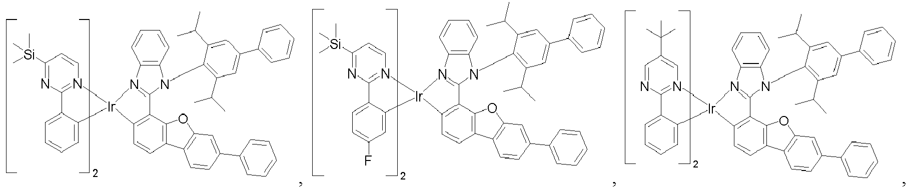

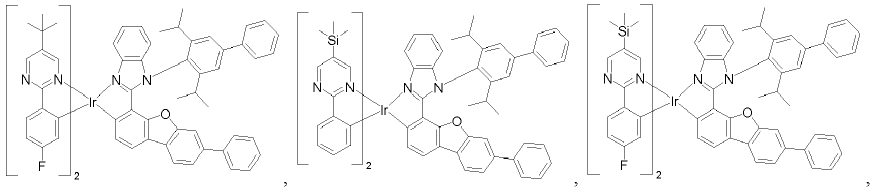

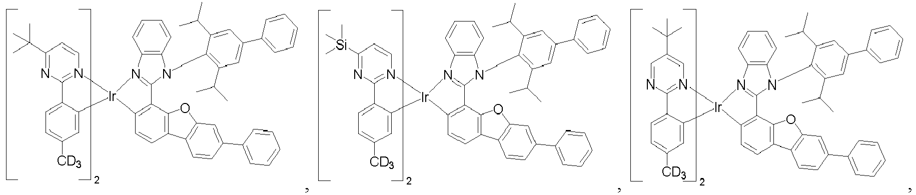

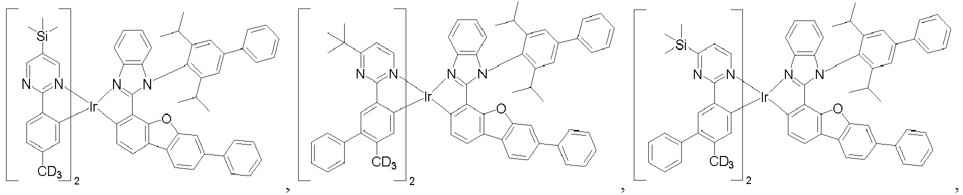

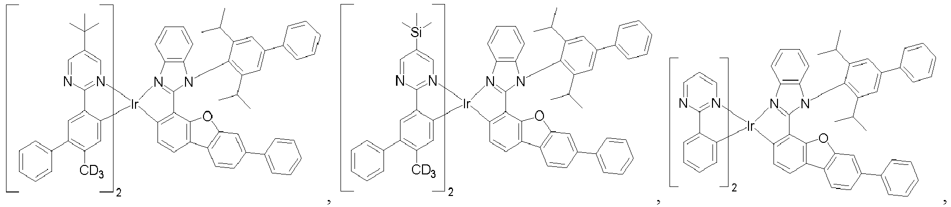

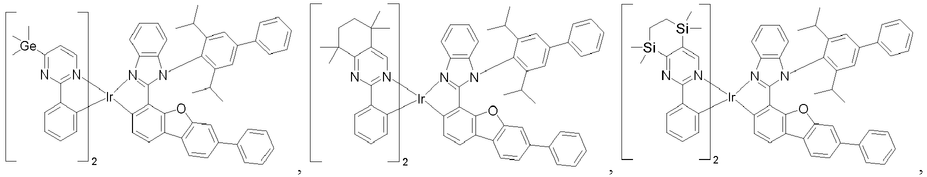

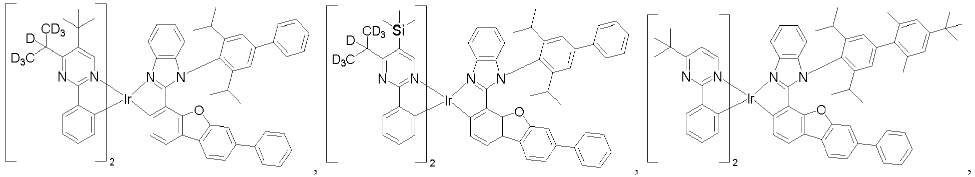

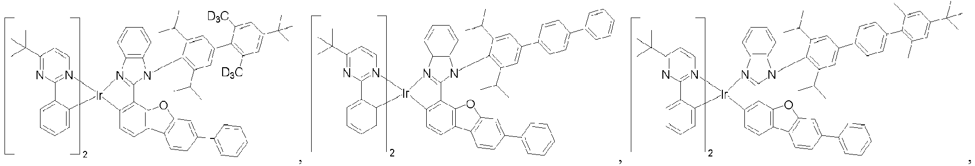

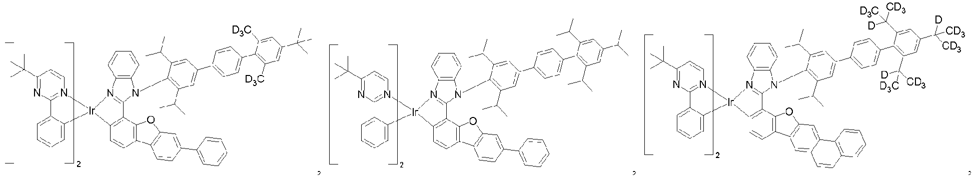

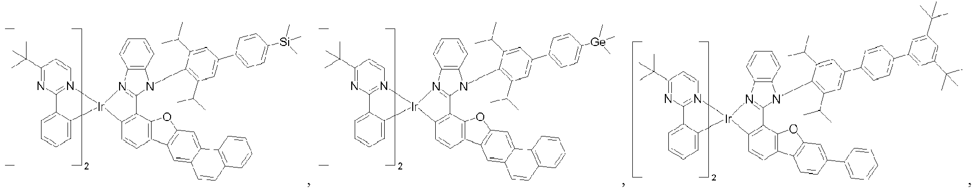

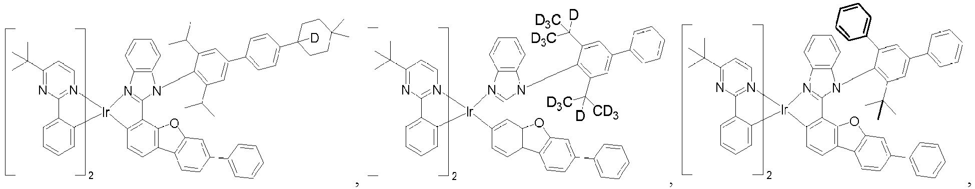

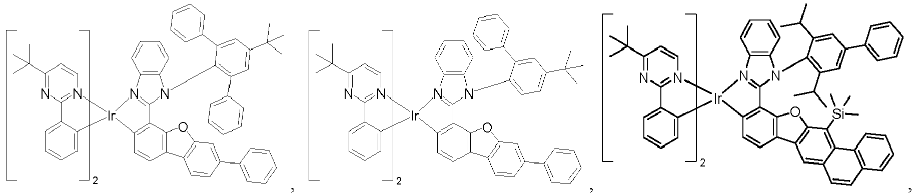

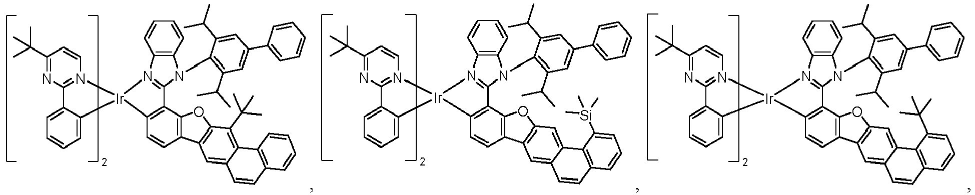

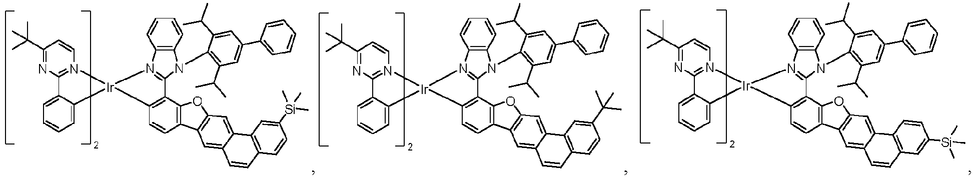

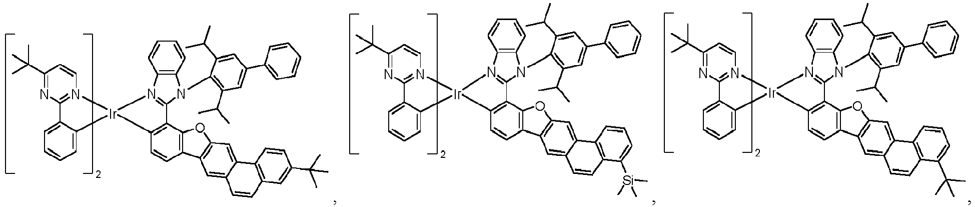

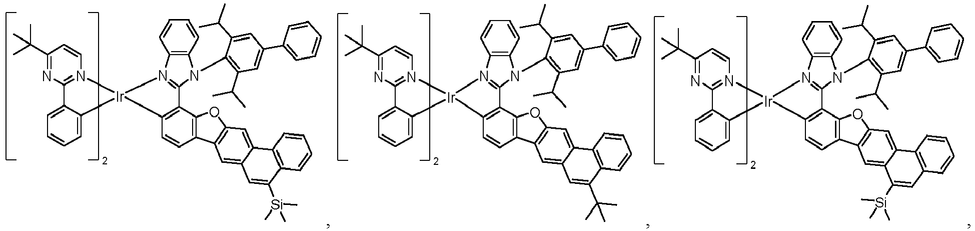

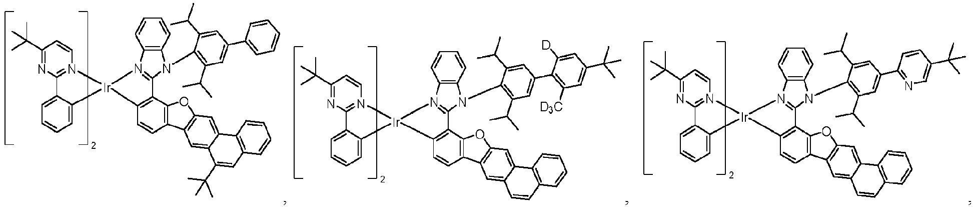

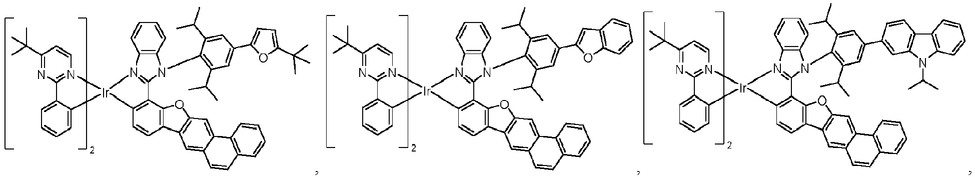

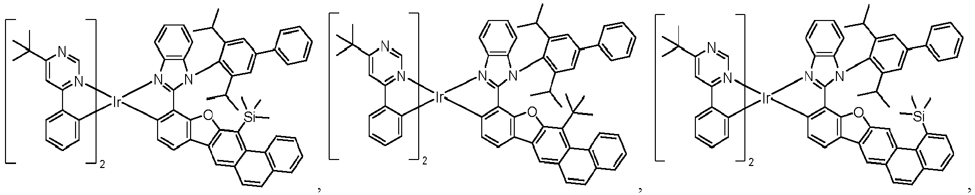

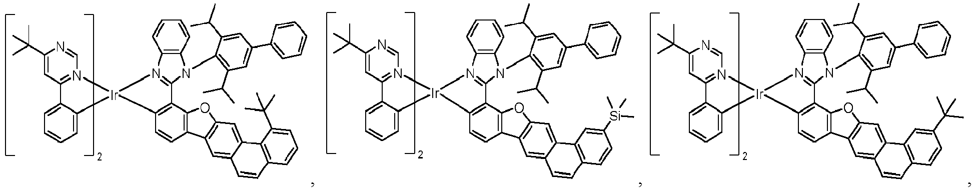

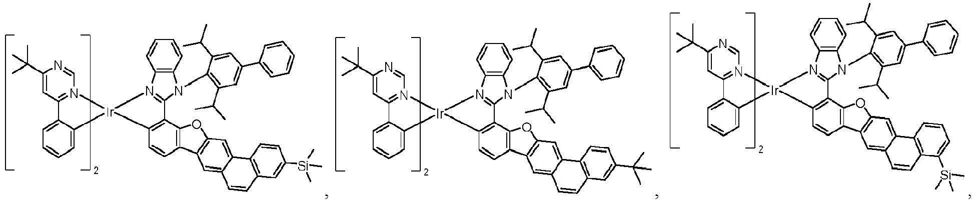

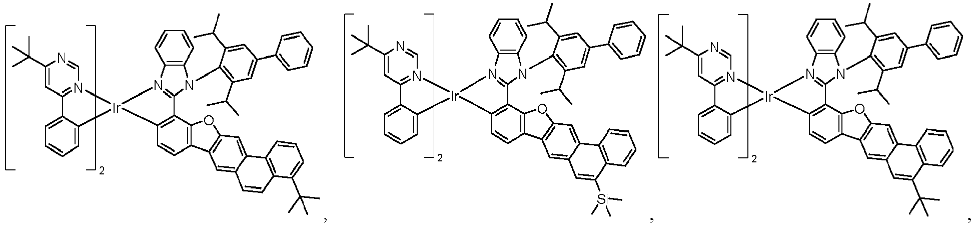

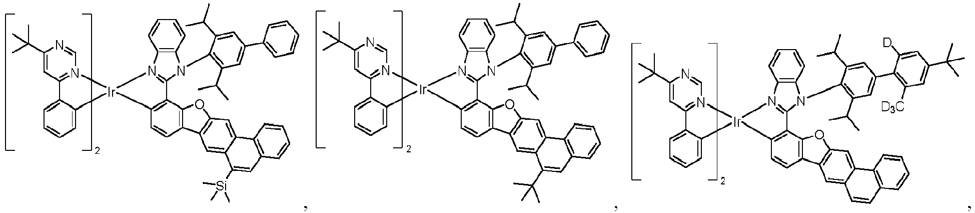

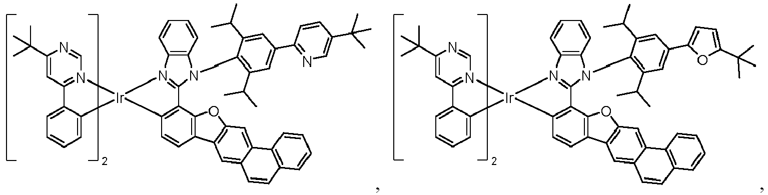

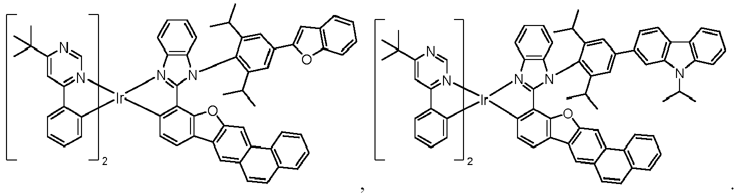

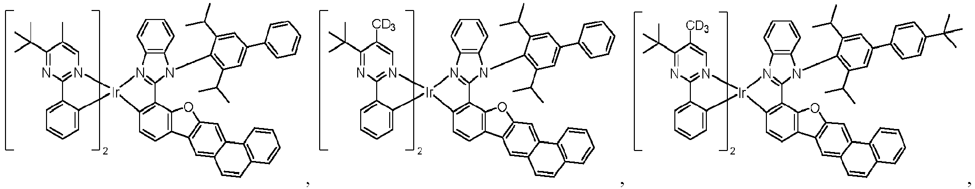

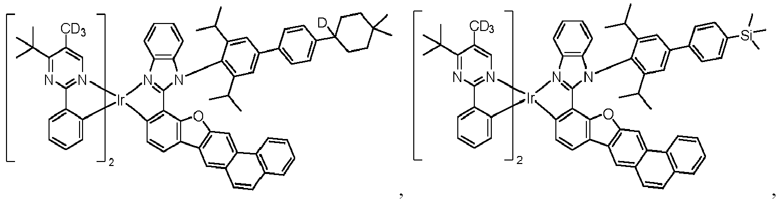

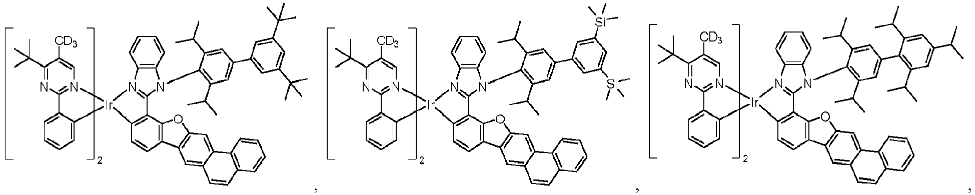

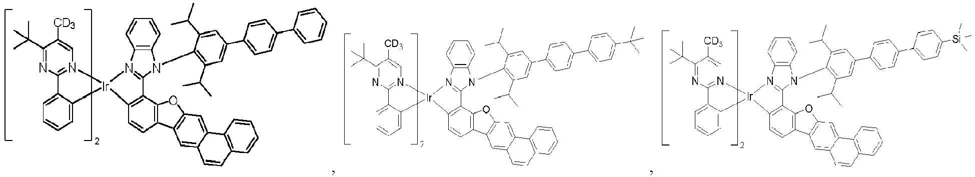

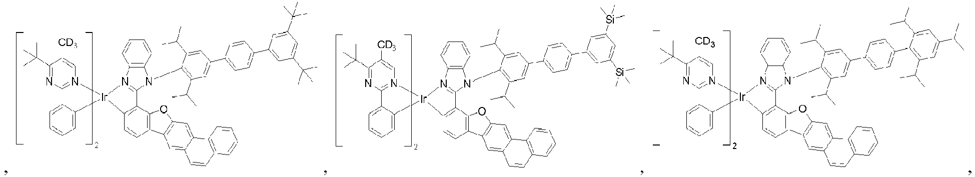

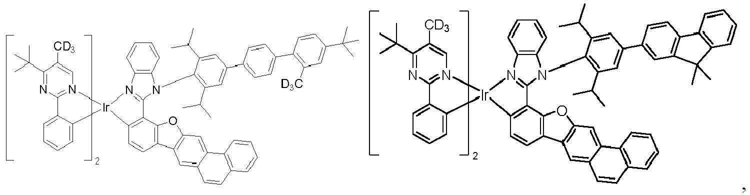

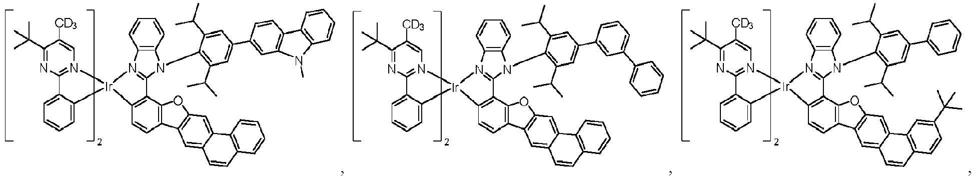

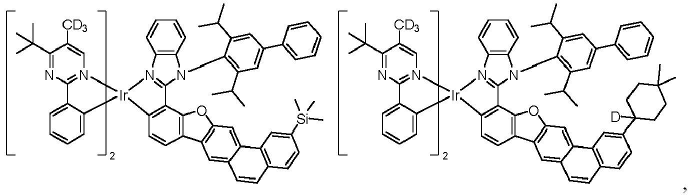

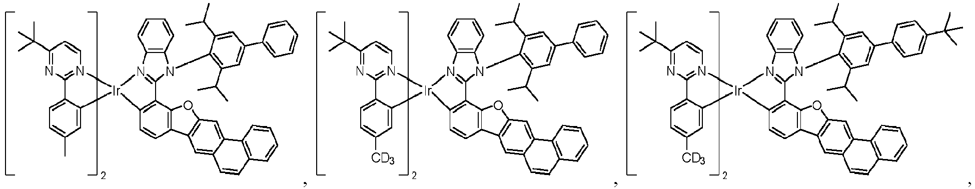

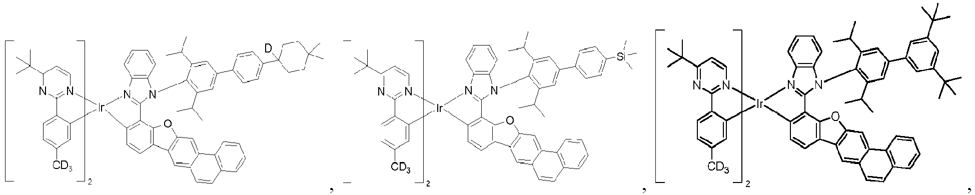

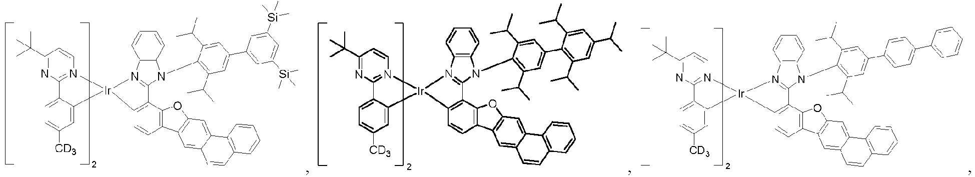

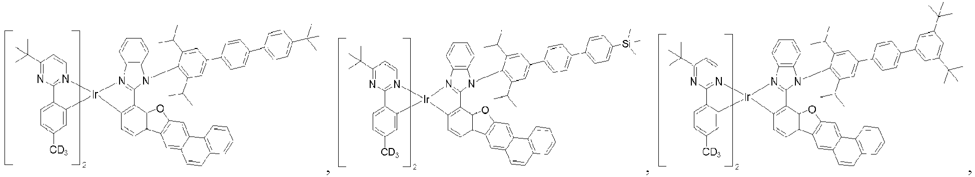

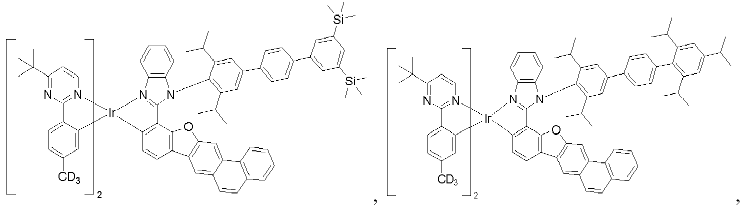

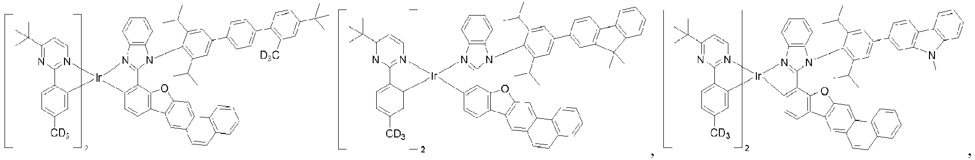

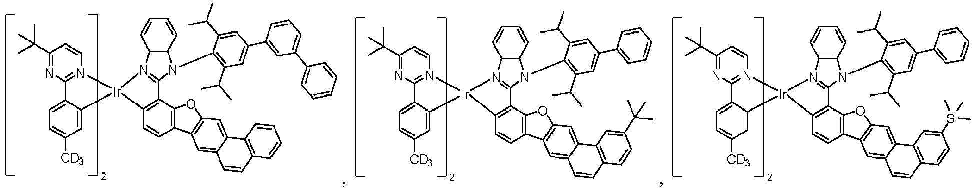

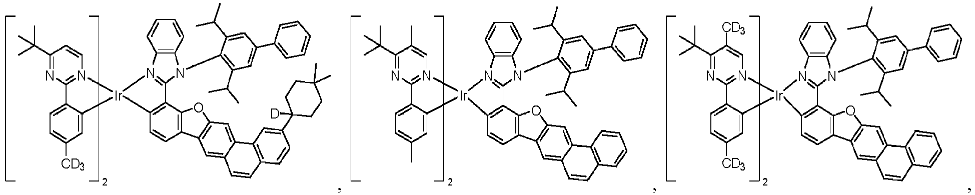

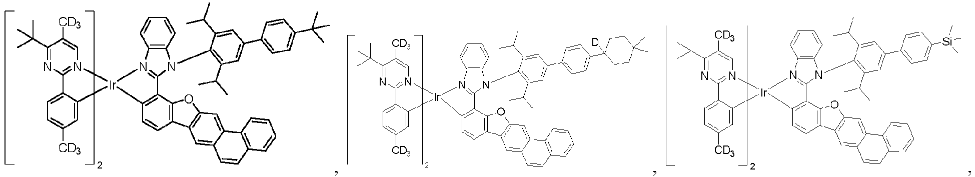

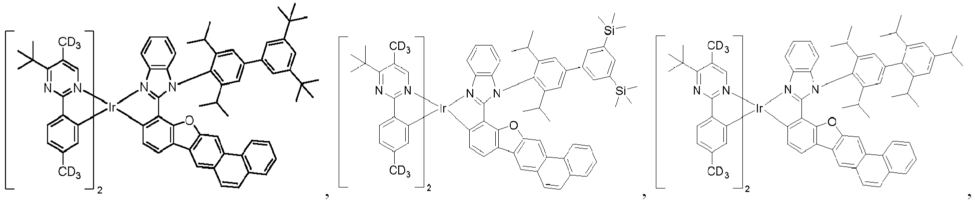

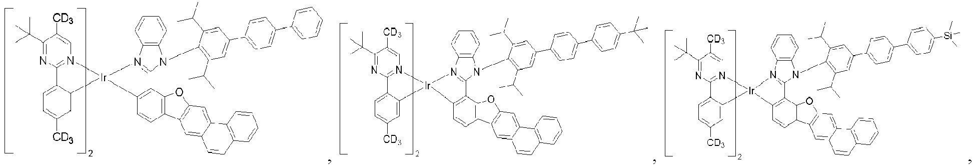

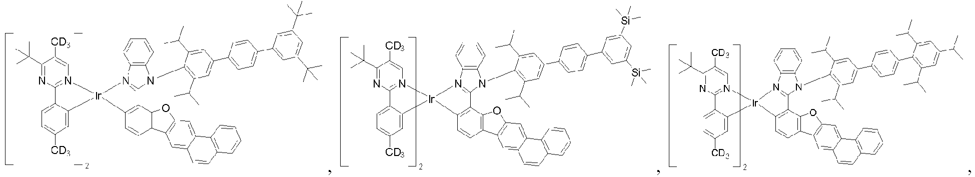

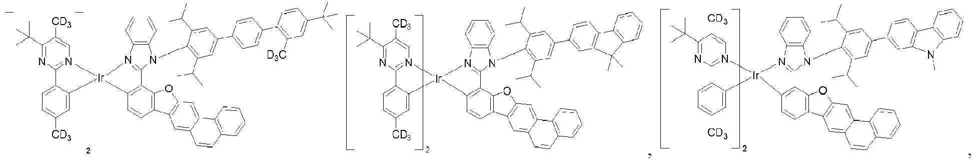

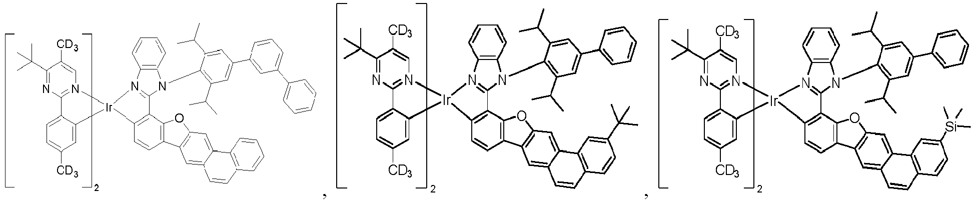

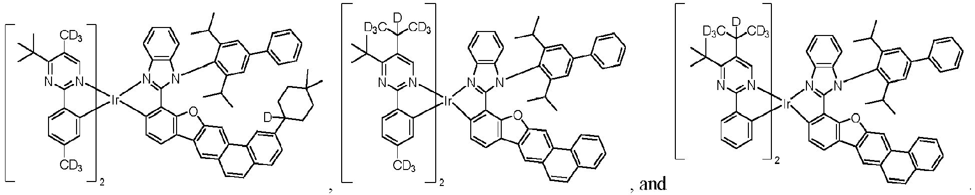

14. An organic light emitting device comprising:
an anode;
a cathode; and
an organic layer disposed between the anode and the cathode, wherein the organic layer comprises a compound according to any one of claims 1 to 13.

15. A consumer product comprising an organic light-emitting device comprising:
an anode;
a cathode; and
an organic layer disposed between the anode and the cathode, wherein the organic layer comprises a compound according to any one of claims 1 to 13.
